(19) Europäisches Patentamt
European Patent Office
Office européen des brevets

(11) EP 4 324 896 B1

(12) # EUROPEAN PATENT SPECIFICATION

(45) Date of publication and mention of the grant of the patent:
**14.05.2025 Bulletin 2025/20**

(21) Application number: **23189592.1**

(22) Date of filing: **03.08.2023**

(51) International Patent Classification (IPC):
***C09K 11/06*** *(2006.01)* ***C07F 15/00*** *(2006.01)*
***H10K 85/30*** *(2023.01)*

(52) Cooperative Patent Classification (CPC):
**C09K 11/06; C07F 15/0086; H10K 85/346;**
C09K 2211/185

(54) **DINUCLEAR PLATINUM(II) EMITTERS FOR RED AND/OR NEAR-INFRARED OLEDS**

DINUKLEARE PLATIN(II)-EMITTER FÜR ROTE UND/ODER NAHINFRAROT-OLED

ÉMETTEURS DE PLATINE(II) DINUCLÉAIRES POUR DIODES ÉLECTROLUMINESCENTES ORGANIQUES (OLED) ROUGES ET/OU DANS LE PROCHE INFRAROUGE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **15.08.2022 US 202263398029 P**

(43) Date of publication of application:
**21.02.2024 Bulletin 2024/08**

(73) Proprietors:
- **The University of Hong Kong**
  **Hong Kong (HK)**
- **Hong Kong Quantum AI Lab Limited**
  **NT Hong Kong (HK)**

(72) Inventors:
- **LO, Kar-Wai**
  **Shamshuipo, Hong Kong (HK)**
- **CHE, Chi-Ming**
  **NT Hong Kong (HK)**
- **CHENG, Gang**
  **NT Hong Kong (HK)**

(74) Representative: **HGF**
**HGF Limited**
**1 City Walk**
**Leeds LS11 9DX (GB)**

(56) References cited:
**WO-A1-2016/079169**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 324 896 B1

**Description**

## CROSS-REFERENCE TO RELATED APPLICATIONS

This application claims the benefit of and priority to U.S. Application No. 63/398,029, filed August 15, 2022.

## FIELD OF THE INVENTION

The disclosed invention is generally in the field of dinuclear platinum (II) complexes and their use in organic electronics, such as organic light-emitting devices (OLEDs), as red and/or NIR emitters.

## BACKGROUND OF THE INVENTION

Transition metal complexes have gained significant interest in commercial and academic settings as molecular probes, catalysts, and luminescent materials. As luminescent materials, transition metal complexes are increasingly being explored as potential alternatives to pure organic-based materials due to their potential for improved luminescence efficiency and device stability, compared to pure organic-based materials.

Currently, commercial red OLED emitters are dominated by iridium phosphors because of their practical operational stability in device. Tremendous efforts have been made to develop phosphorescent emitters based on other metals, such as osmium or platinum, or develop thermally activated delayed fluorescent (TADF) emitters. In particular, high-efficiency platinum(II) red or near-infrared (NIR) emitters with ease of preparation are of practical interest in OLED industry for potential applications such as diagnosis, therapy and biometric sensing. However, there are limited examples showing high performance in OLEDs, and most of them require high dopant concentration or non-doped device system to achieve low-energy emissions.

There remains a need to develop high-efficiency red or NIR emitters for OLED applications.

Therefore, it is an object of the present invention to provide new dinuclear platinum(II) complexes.

It is a further object of the present invention to provide new dinuclear platinum(II) complexes that emit in the red and/or NIR regions.

It is a further object of the present invention to provide devices containing the new dinuclear platinum(II) complexes that emit in the red and/or deep red regions.

It is a further object of the present invention to provide methods for using the new dinuclear platinum(II) complexes that emit in the red and/or deep red regions.

Di-nuclear platinum(II) complexes are disclosed in WO201607916.

## SUMMARY OF THE INVENTION

Dinuclear platinum(II) complexes that can emit in the red, deep red, and/or NIR regions and methods of making and using thereof are described. The disclosed dinuclear platinum(II) complexes contain platinum(II) atoms complexed by 2-hydroxy-pyridine (N^O) bridging ligands. The ligands of the disclosed dinuclear platinum(II) complexes include a phenyl ring and an imidazolyl N-heterocyclic carbene ring. The structure of the disclosed dinuclear platinum(II) complexes allows them to emit light in the red, deep red, and/or NIR regions with high efficiency, including a high emission quantum yield (i.e. $\Phi_{em} \geq 0.60$ measured in thin films, such as about 0.78 or about 0.97), a short emission lifetime (i.e. $\tau_{em} \leq 2.5$ $\mu$s, such as 1.7-1.9 $\mu$s), a fast radiative decay rate (i.e. $k_r \geq 3.5\times10^5$ $s^{-1}$, such as about $4.3\times10^5$ $s^{-1}$ or about $5.5\times10^5$ $s^{-1}$), and/or a slow non-radiative decay rate (i.e. $k_{nr} \leq 6\times10^5$ $s^{-1}$, such as $0.16\times10^5$-$6\times10^5$ $s^{-1}$ or $0.16\times10^5$-$1.4\times10^5$ $s^{-1}$), at room temperature.

Exemplary dinuclear platinum (II) complexes can have a structure as follows:

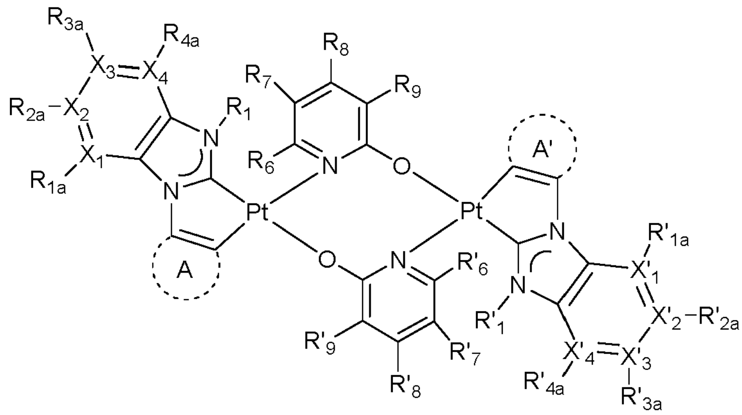

Formula I'

where: (i) the complex is an overall neutral, negative, or positive charge; (ii) $X_1$-$X_4$ and $X'_1$-$X'_4$ are independently carbon, nitrogen, sulfur, or oxygen; (iii) $R_{1a}$-$R_{4a}$, $R'_{1a}$-$R'_{4a}$, $R_1$, $R'_1$, $R_6$-$R_9$, and $R'_6$-$R'_9$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, unsubstituted $C_2$-$C_{20}$ heterocyclyl, borenium cation, phosphonyl, sulfinyl, or sulfonyl, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof; (iv) A and A' are independently a substituted cycloalkyl, an unsubstituted cycloalkyl, a substituted cycloalkenyl, an unsubstituted cycloalkenyl, a substituted cycloalkynyl, an unsubstituted cycloalkynyl, a substituted heterocyclyl, an unsubstituted heterocyclyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, or fused combinations thereof; preferably A and A' are independently a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof; and (v) each substituent is independently a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a carbonyl, an alkoxy, a halogen, a hydroxyl, a phenoxy, a thiol, an alkylthio, a phenylthio, an arylthio, a cyano, an isocyano, a nitro, a carboxyl, an amino, an amido, an oxo, a silyl, a sulfinyl, a sulfonyl, a sulfonic acid, a phosphonium, a phosphanyl, a phosphoryl, or a phosphonyl.

In some forms, the complex can have a structure:

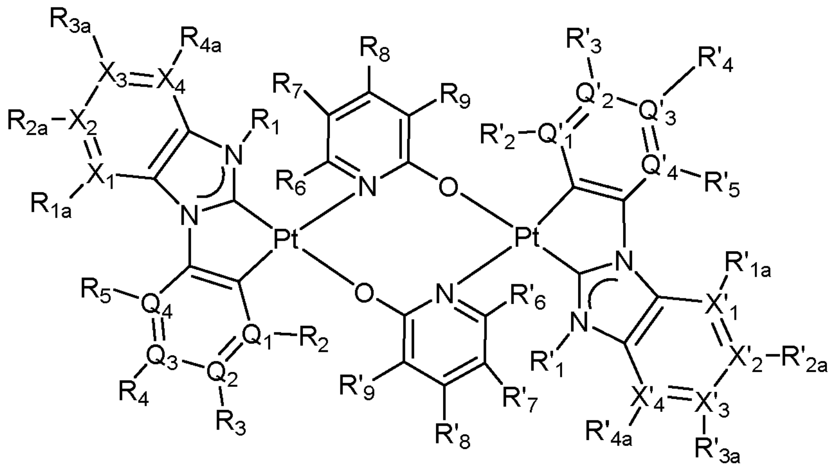

Formula I

where: (i) the complex can have an overall neutral, negative, or positive charge; (ii) $X_1$-$X_4$, $X'_1$-$X'_4$, $R_{1a}$-$R_{4a}$, $R'_{1a}$-$R'_{4a}$, $R_1$, $R_6$-$R_9$, $R'_1$, and $R'_6$-$R'_9$ can be as defined above for Formula I'; (iii) $Q_1$-$Q_4$ and $Q'_1$-$Q'_4$ can be independently carbon, nitrogen, sulfur, or oxygen; (iv) $R_2$-$R_5$ and $R'_2$-$R'_5$ can be independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, unsubstituted $C_2$-$C_{20}$ heterocyclyl, borenium cation, phosphonyl, sulfinyl, or sulfonyl, or $R_2$ and $R_3$ together, $R_3$ and $R_4$ together, $R_4$ and $R_5$ together, $R'_2$ and $R'_3$ together, $R'_3$ and $R'_4$ together, and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, fused combinations thereof, or $R_2$ and $R_3$ together, $R_3$ and $R_4$ together, $R_4$ and $R_5$ together, $R'_2$ and $R'_3$ together, $R'_3$ and $R'_4$ together, and/or $R'_4$ and $R'_5$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof; and (v) each substituent can be as defined above for Formula I'.

In some forms, the complex can have a structure:

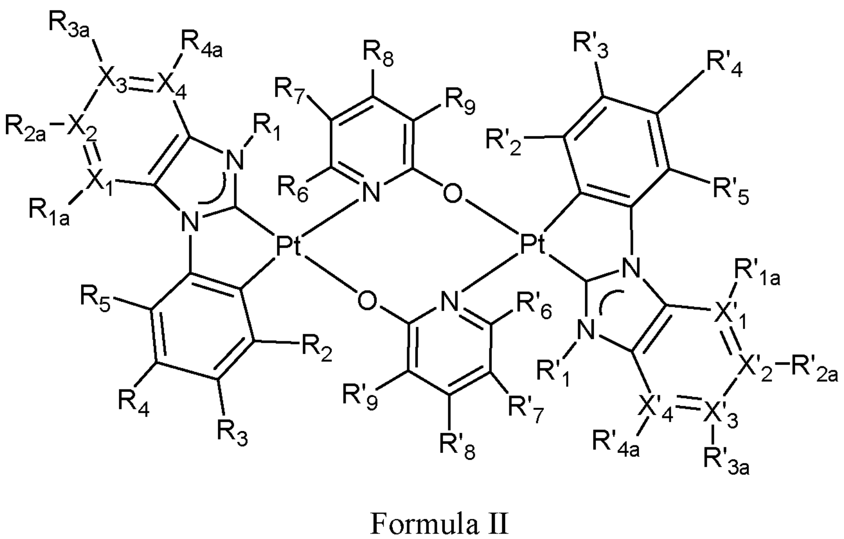

or

Formula II

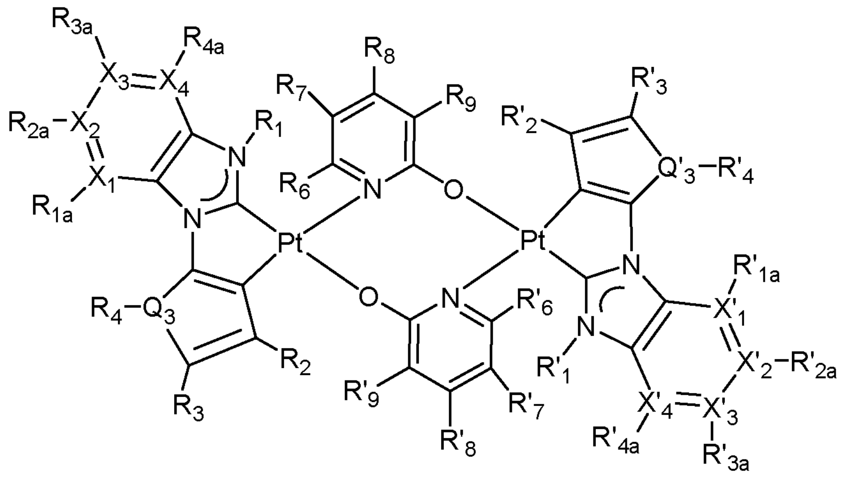

Formula IIa

where the complex can have an overall neutral, negative, or positive charge; and $X_1$-$X_4$, $X'_1$-$X'_4$, $Q_3$, $Q'_3$, $R_{1a}$-$R_{4a}$, $R'_{1a}$-$R'_{4a}$, $R_1$-$R_9$, $R'_1$-$R'_9$ and the substituents can be as defined above for Formula I.

In some forms, the complex can have a structure:

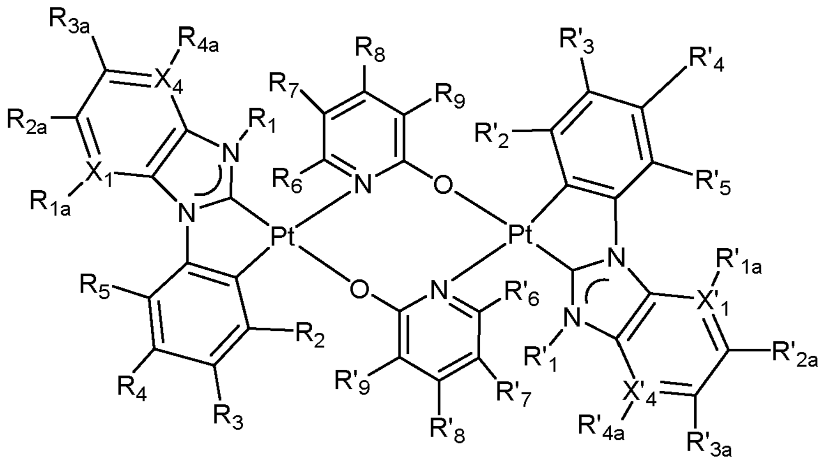

or

Formula III

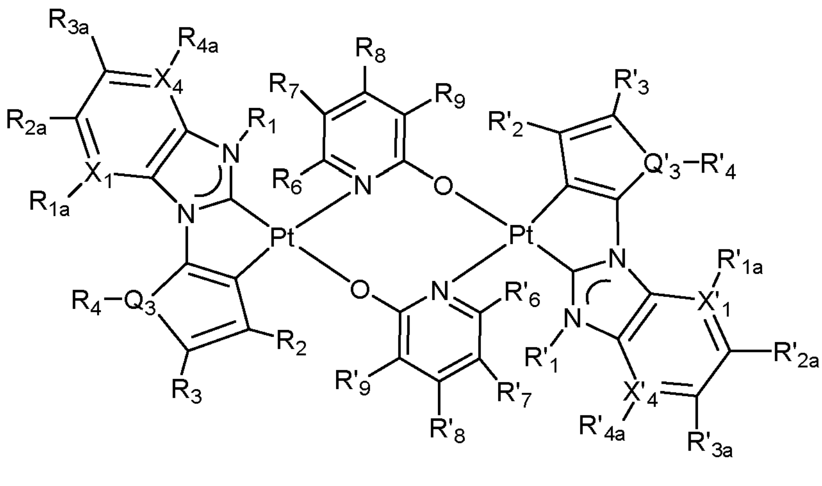

Formula IIIa

where the complex can have an overall neutral, negative, or positive charge; and $X_1$, $X_4$, $X'_1$, $X'_4$, $Q_3$, $Q'_3$, $R_{1a}$-$R_{4a}$,

$R'_{1a}$-$R'_{4a}$, $R_1$-$R_9$, $R'_1$-$R'_9$ and the substituents can be as defined above for Formula I.

In some forms of Formulae III and/or IIIa, $X_1$, $X_4$, $X'_1$, and $X'_4$ are carbon. In some forms of Formulae III and/or IIIa, $X_1$, $X_4$, $X'_1$, and $X'_4$ are carbon; and $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, and/or $R'_{3a}$ and $R'_{4a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl.

In some forms of Formulae III and/or IIIa, $X_1$, $X_4$, $X'_1$, and $X'_4$ are nitrogen; and $R_{2a}$ and $R_{3a}$ together and/or $R'_{2a}$ and $R'_{3a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl.

In some forms, the complex can have a structure:

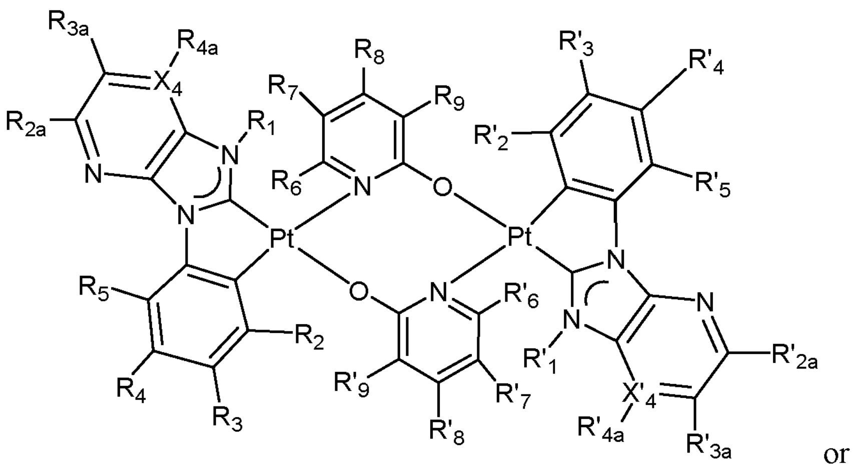

or

Formula IV

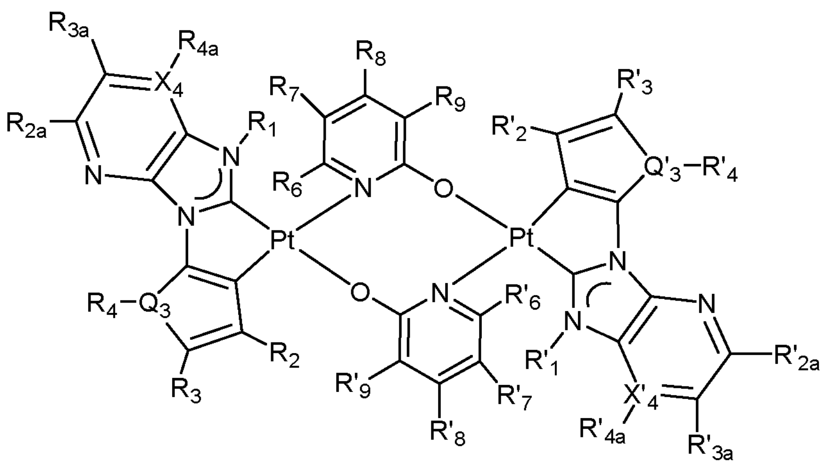

Formula IVa

where the complex can have an overall neutral, negative, or positive charge; and $X_4$, $X'_4$, $Q_3$, $Q'_3$, $R_{1a}$-$R_{4a}$, $R'_{1a}$-$R'_{4a}$, $R_1$-$R_9$, $R'_1$-$R'_9$, and the substituents can be as defined above for Formula I.

In some forms, for any one of Formulae I-IV and Ia-IVa, $X_4$ and $X'_4$ can be carbon; and $R_{4a}$ and $R'_{4a}$ can be independently hydrogen, substituted alkyl, unsubstituted alkyl, substituted aryl, unsubstituted aryl, hydroxyl, unsubstituted heteroaryl, substituted heteroaryl, unsubstituted polyaryl, substituted polyaryl, unsubstituted polyheteroaryl, substituted polyheteroaryl, substituted $C_2$-$C_{20}$ heterocyclyl, or unsubstituted $C_2$-$C_{20}$ heterocyclyl.

In some forms, for any one of Formulae I-IV and Ia-IVa, $X_4$ and $X'_4$ can be carbon; and $R_{4a}$ and $R'_{4a}$ can be independently hydrogen, unsubstituted alkyl, unsubstituted aryl, unsubstituted polyaryl, hydroxyl, unsubstituted heteroaryl, unsubstituted polyheteroaryl, unsubstituted $C_2$-$C_{20}$ heterocyclyl, or unsubstituted alkylaryl.

In some forms, for any one of Formulae I-IV and Ia-IVa, $X_4$ and $X'_4$ can be nitrogen; and $R_{4a}$ and $R'_{4a}$ are absent.

In some forms, for any one of Formulae I-IV and Ia-IVa, $R_1$-$R_9$ and $R'_1$-$R'_9$ can be independently hydrogen, halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), unsubstituted polyaryl, substituted polyaryl, hydroxyl, unsubstituted heteroaryl, substituted heteroaryl, unsubstituted polyheteroaryl, substituted polyheteroaryl, unsubstituted $C_2$-$C_{20}$ heterocyclyl, substituted $C_2$-$C_{20}$ heterocyclyl, unsubstituted alkylaryl, substituted alkylaryl, alkoxy (e.g., -O-alkyl, -O-aryl, -O-polyaryl, etc.), borenium cation (e.g., $-B(Mes)_2$), phosphonyl (e.g., $-P(=O)(Ph)_2$, $-P(=O)(alkyl)_2$, etc.), sulfinyl (e.g., $-S(=O)(Ph)_2$, $-S(=O)(alkyl)_2$, etc.), or sulfonyl - $S(=O)_2(Ph)_2$, $-S(=O)_2(alkyl)_2$, etc.).

In some forms, for any one of Formulae I-IV and Ia-IVa, one or more of $R_1$-$R_9$ and $R'_1$-$R'_9$ can be an aryl, heteroaryl, or polyaryl having the structure of

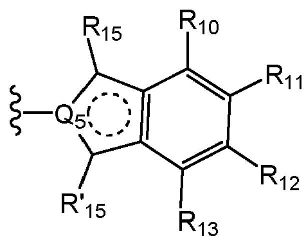

or

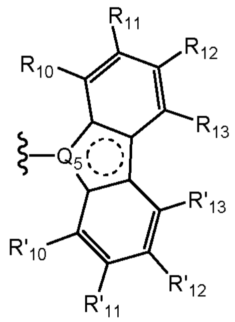

,

where $Q_5$ can be nitrogen or carbon; and $R_{10}$-$R_{13}$, $R_{15}$, $R'_{15}$, and $R'_{10}$-$R'_{13}$ can be independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl. In some forms, $Q_5$ can be nitrogen; and $R_{10}$-$R_{13}$, $R_{15}$, $R'_{15}$, and $R'_{10}$-$R'_{13}$ can be independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen.

In some forms, for any one of Formulae I-IV and Ia-IVa, at least one of $R_2$-$R_5$ and at least one of $R'_2$-$R'_5$, such as one or two of $R_2$-$R_5$ and/or one or two of $R'_2$-$R'_5$, can be independently halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., $-B(Mes)_2$), phosphonyl (e.g., $-P(=O)(Ph)_2$, $-P(=O)(alkyl)_2$, etc.), or an aryl, heteroaryl, or polyaryl described in the paragraph above, such as carbazolyl, fluorenyl, indenyl, or indolyl.

In some forms, for any one of Formulae I-IV and Ia-IVa, at least one of $R_6$-$R_9$ and at least one of $R'_6$-$R'_9$, such as one or two of $R_6$-$R_9$ and/or one or two of $R'_6$-$R'_9$, can be independently halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., $-B(Mes)_2$), phosphonyl (e.g., $-P(=O)(Ph)_2$, $-P(=O)(alkyl)_2$, etc.), or an aryl, heteroaryl, or polyaryl described in the paragraph above, such as carbazolyl, fluorenyl, indenyl, or indolyl; or $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or an unsubstituted aryl.

In some forms, for any one of Formulae I-IV and Ia-IVa, (i) $R_2$ and $R_3$ together and/or $R'_2$ and $R'_3$ together, or (ii) $R_3$ and $R_4$ together and/or $R'_3$ and $R'_4$ together, or (iii) $R_4$ and $R_5$ together and/or $R'_4$ and $R'_5$ together, with the atom to which they are attached, can form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl. For example, (i) $R_2$ and $R_3$ together and/or $R'_2$ and $R'_3$ together, or (ii) $R_3$ and $R_4$ together and/or $R'_3$ and $R'_4$ together, or (iii) $R_4$ and $R_5$ together and/or $R'_4$ and $R'_5$ together, can form

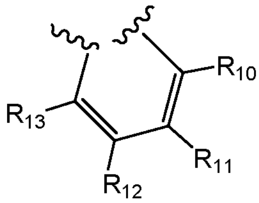 or 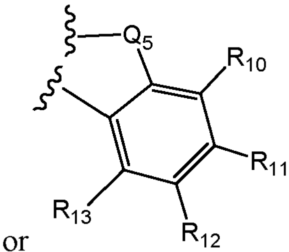 ,

wherein $Q_5$ can be $NR_{14}$, $CR_{16}R_{17}$, or sulfur, or oxygen; and $R_{10}$-$R_{14}$, $R_{16}$, and $R_{17}$ can be independently absent, hydrogen, substituted alkyl, unsubstituted alkyl (e.g., methyl, ethyl, n-propyl, iso-propyl, n-butyl, iso-butyl, tert-butyl, etc.), substituted alkenyl, unsubstituted alkenyl, substituted alkynyl, unsubstituted alkynyl, substituted aryl (e.g., substituted phenyl), unsubstituted aryl (e.g., unsubstituted phenyl), halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl. In some forms, $Q_5$ can be $NR_{14}$, sulfur, or oxygen, such as oxygen; and $R_{10}$-$R_{14}$ can be independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen. In some forms, $Q_5$ can be $CR_{16}R_{17}$; and $R_{16}$ and $R_{17}$ can be independently hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen or unsubstituted alkyl (e.g., methyl, ethyl, n-propyl, iso-propyl, n-butyl, iso-butyl, tert-butyl, etc.).

In some forms, for any one of Formula Ia-IVa, $Q_3$ and $Q'_3$ can be independently sulfur or oxygen.

In some forms, for any one of Formulae I-IV and Ia-IVa, $R_2$-$R_5$, $R'_2$-$R'_5$, $R_7$, $R_8$, $R'_7$, and $R'_8$ can be hydrogen; and $R_1$, $R_6$, $R_9$, $R'_1$, $R'_6$, and $R'_9$ can be independently hydrogen, halogen, unsubstituted alkyl, unsubstituted aryl, substituted aryl (e.g., aryl substituted with one or more alkyls, such as methyl, ethyl, n-propyl, isopropyl, n-butyl, sec-butyl, isobutyl, tert-butyl, etc.), hydroxyl, unsubstituted heteroaryl (e.g., carbazolyl, fluorenyl, indenyl, indolyl, etc.), unsubstituted polyheteroaryl, unsubstituted $C_2$-$C_{20}$ heterocyclyl, unsubstituted alkylaryl, alkoxy (e.g., -O-alkyl such as methoxy, ethoxy, and phenoxy, -O-aryl, -O-polyaryl, etc.), borenium cation (e.g., $-B(Mes)_2$), phosphonyl (e.g. - $P(=O)(Ph)_2$), sulfinyl (e.g., $-S(=O)(Ph)_2$, $-S(=O)(alkyl)_2$, etc.), or sulfonyl ($-S(=O)_2(Ph)_2$, $-S(=O)_2(alkyl)_2$, etc.). In some forms, for any one of Formulae I-IV and Ia-IVa, $R_2$-$R_5$, $R'_2$-$R'_5$, $R_7$, $R_8$, $R'_7$, and $R'_8$ can be hydrogen; and $R_1$, $R_6$, $R_9$, $R'_1$, $R'_6$, and $R'_9$ can be independently unsubstituted alkyl, unsubstituted aryl, or substituted aryl (e.g., aryl substituted with one or more alkyls, such as methyl, ethyl, n-propyl, isopropyl, n-butyl, sec-butyl, isobutyl, tert-butyl, etc.).

In some forms, the complex can have any one of the following structures:

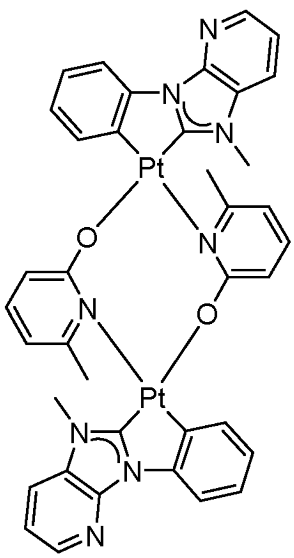

**Pt-R1** ,

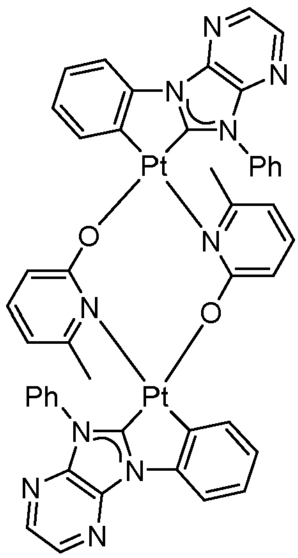

**Pt-R2** ,

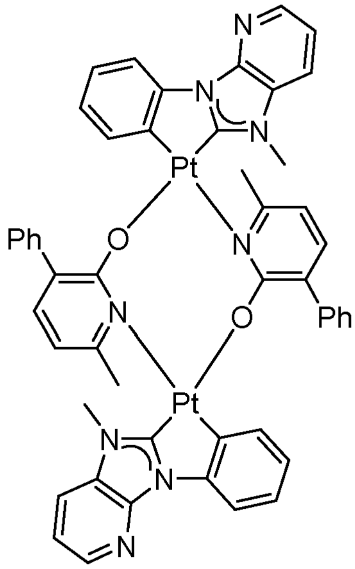

**Pt-R3** ,

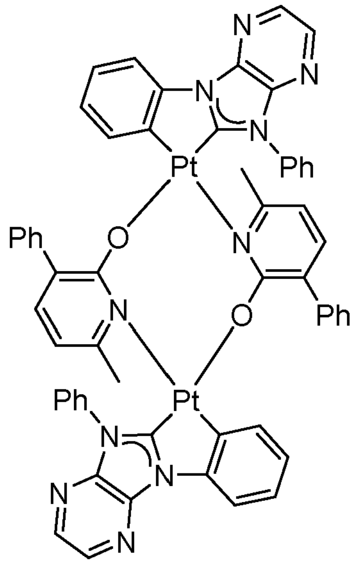

**Pt-R4** ,

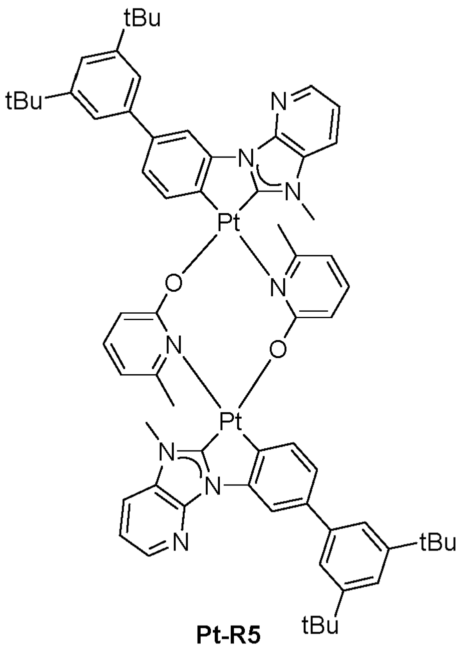

**Pt-R5** ,

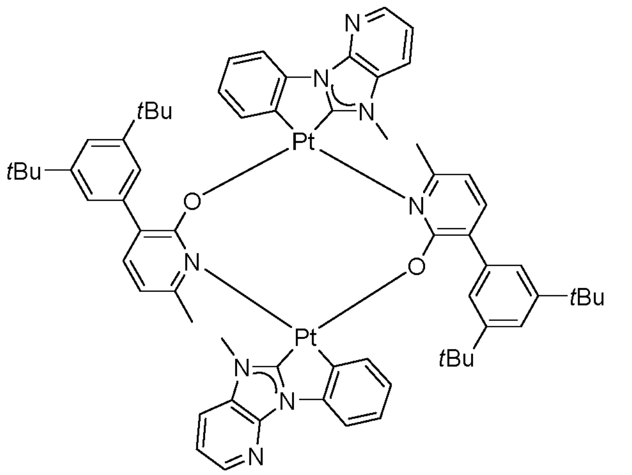

**Pt-R6** ,

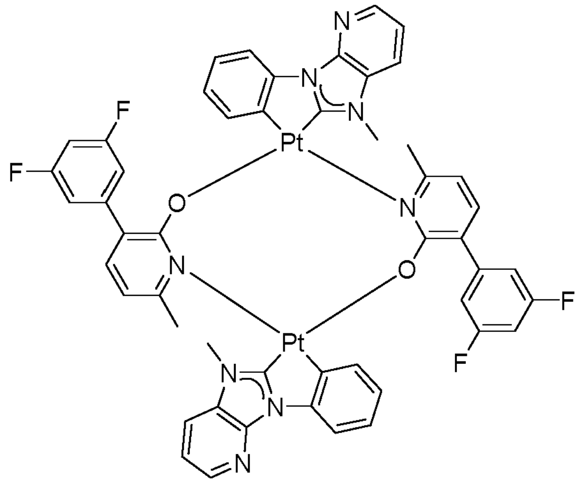

**Pt-R7**

,

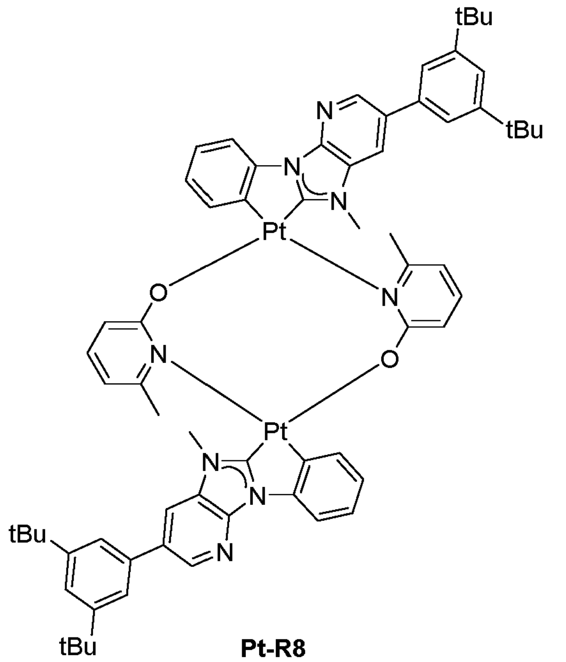

**Pt-R8**

,

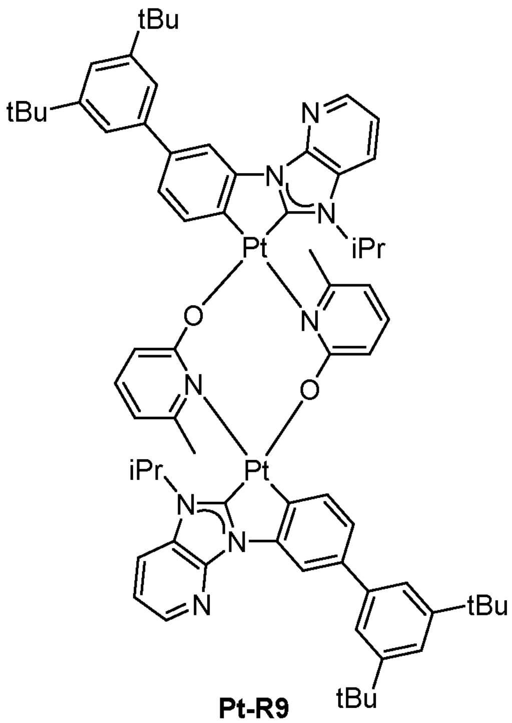

**Pt-R9**

,

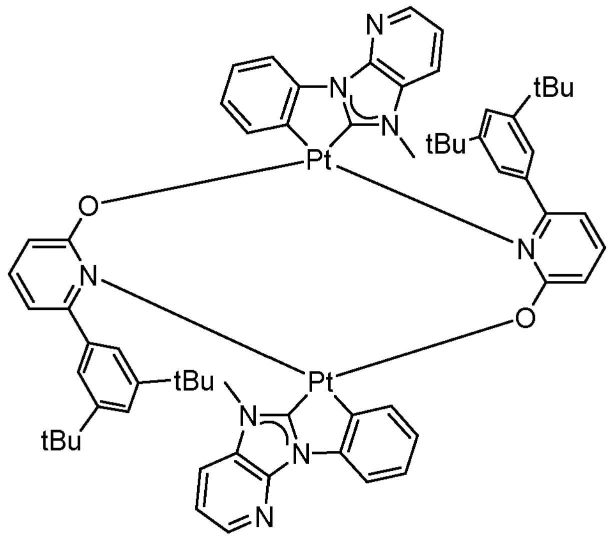

**Pt-R10**

,

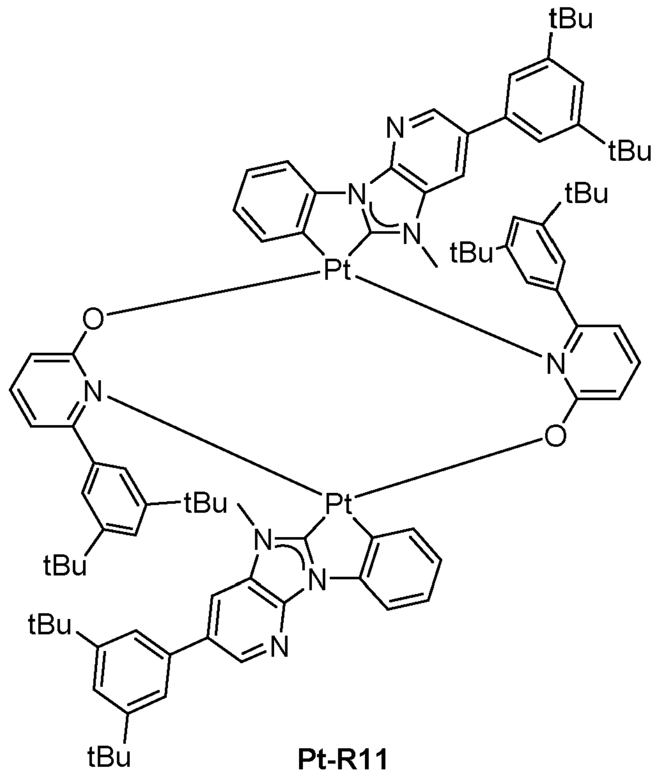

**Pt-R11**

,

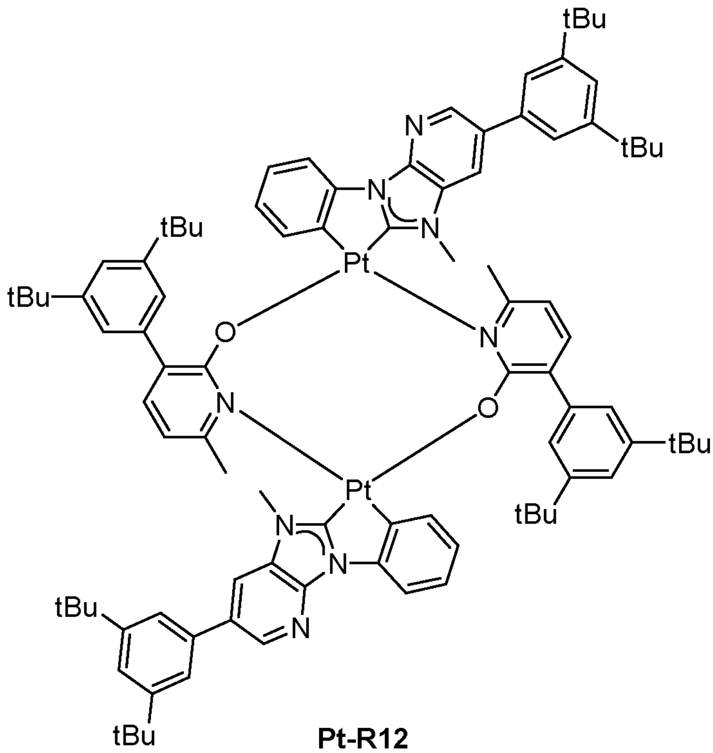

**Pt-R12**

,

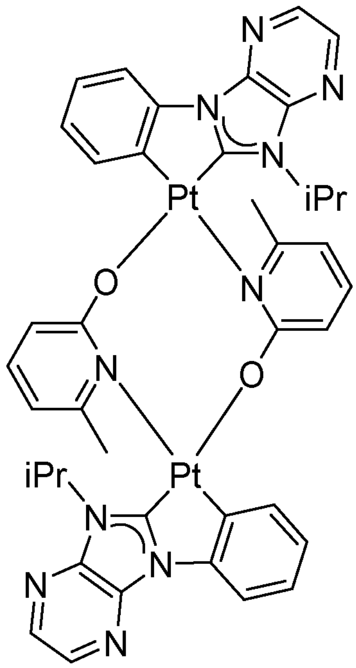

**Pt-R13**

,

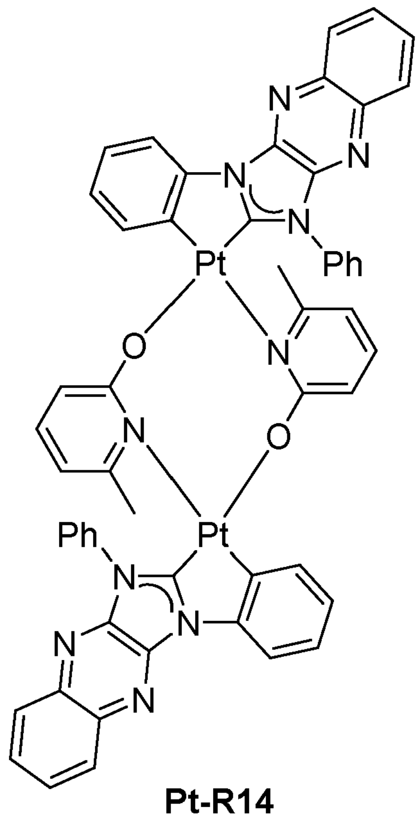

**Pt-R14**

,

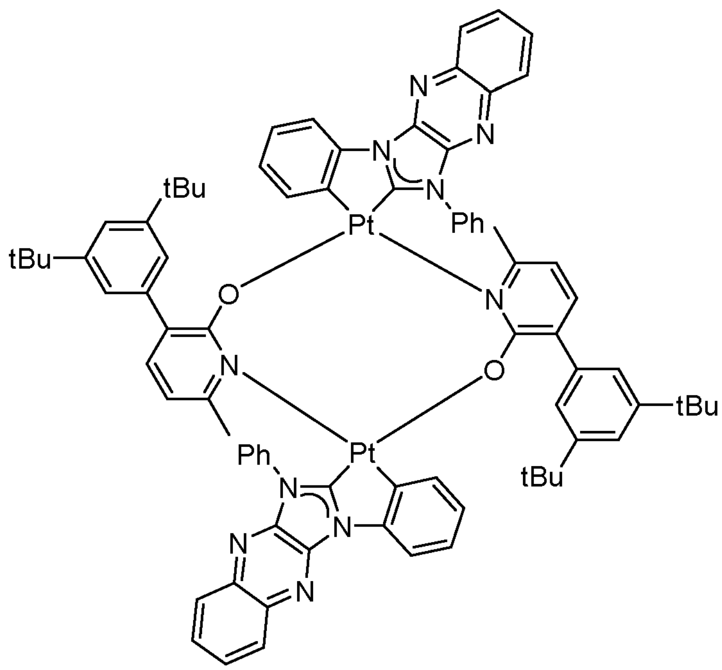

**Pt-R15**

,

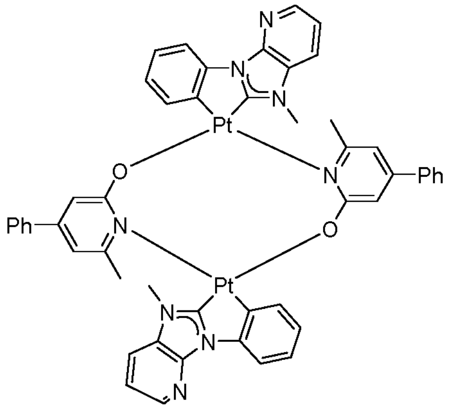

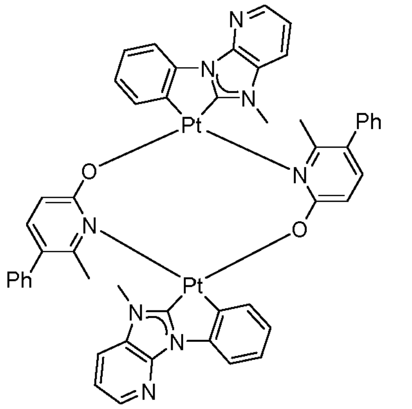

,

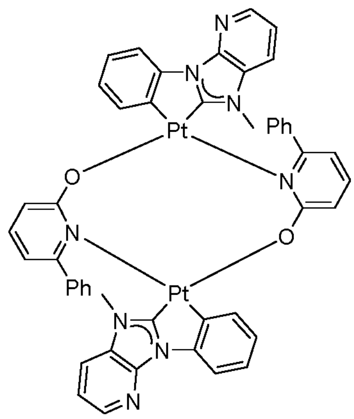

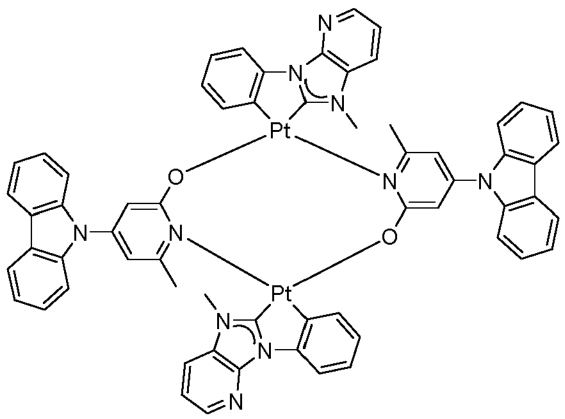

,

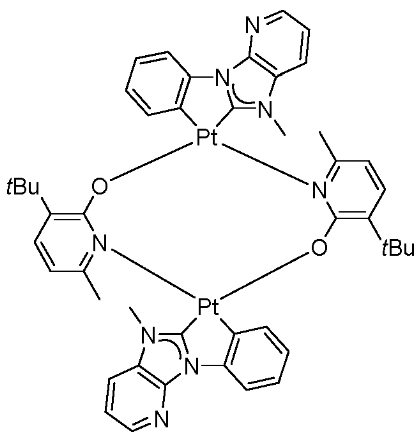

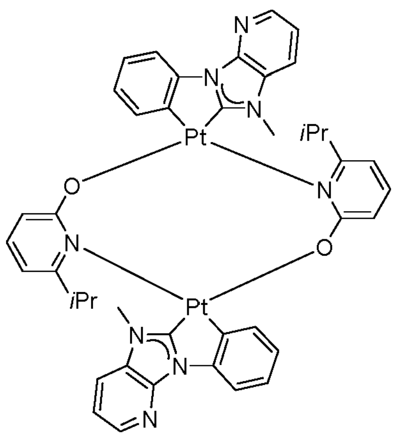

,

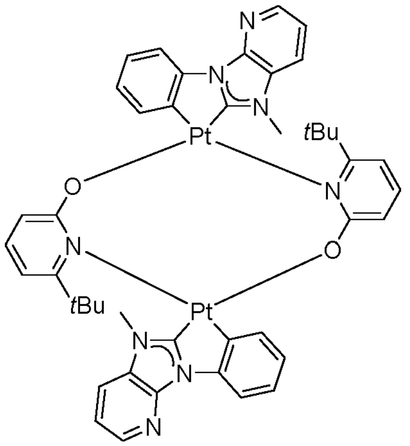

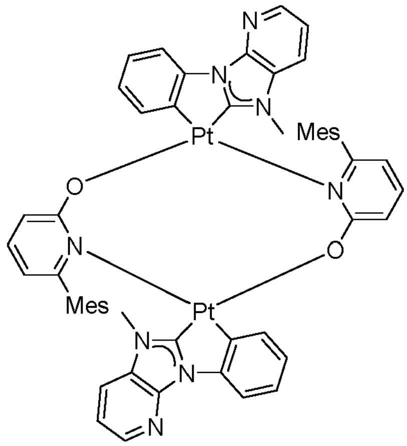

,

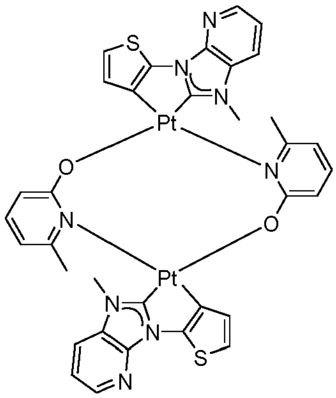

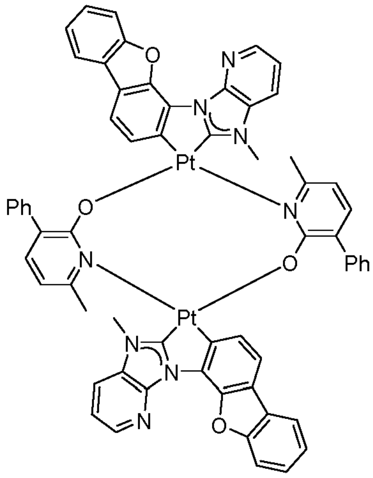

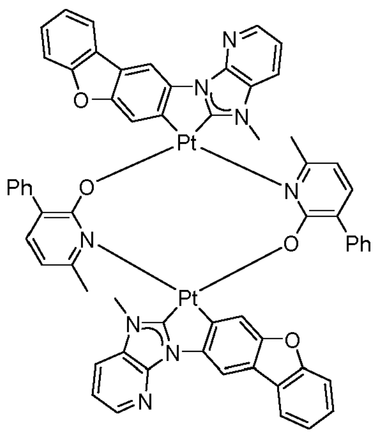

,

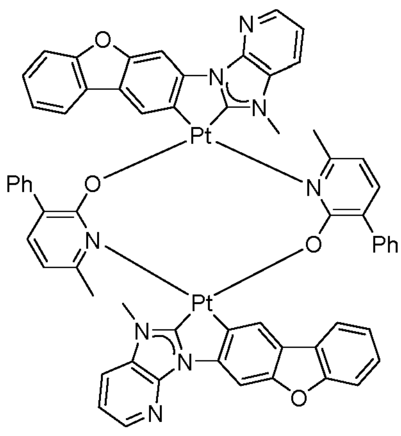

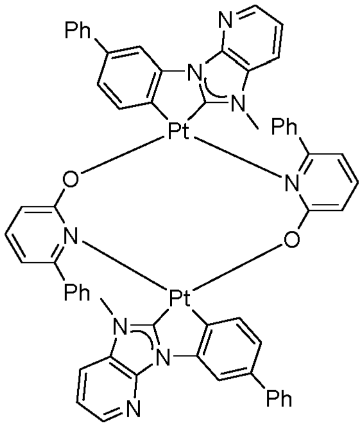

,

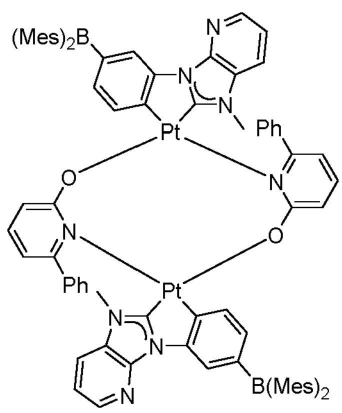
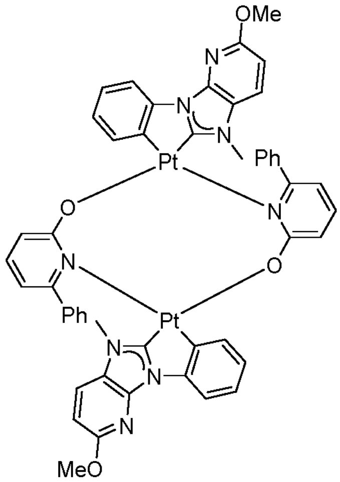
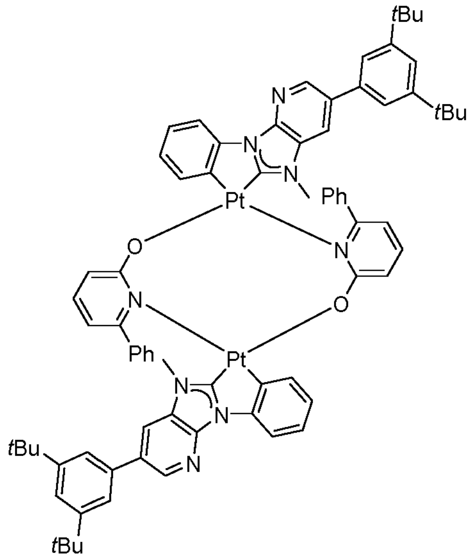

,

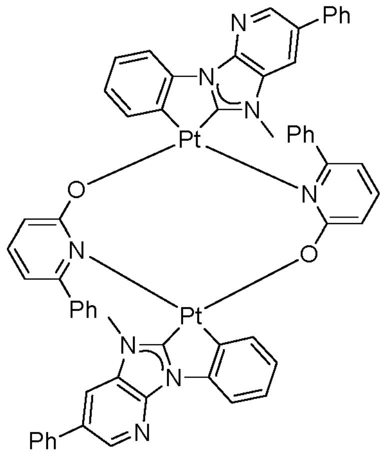
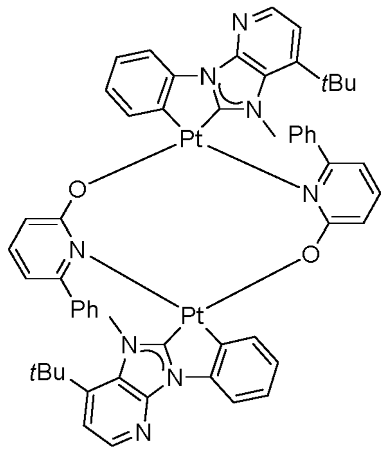

,

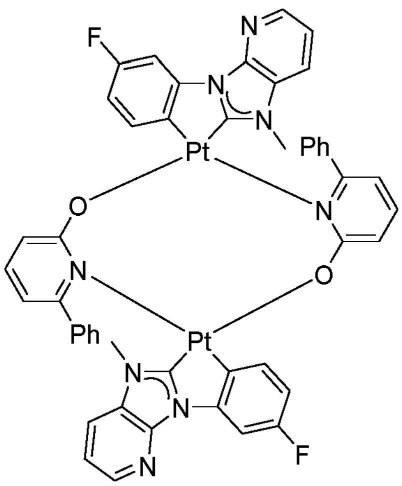
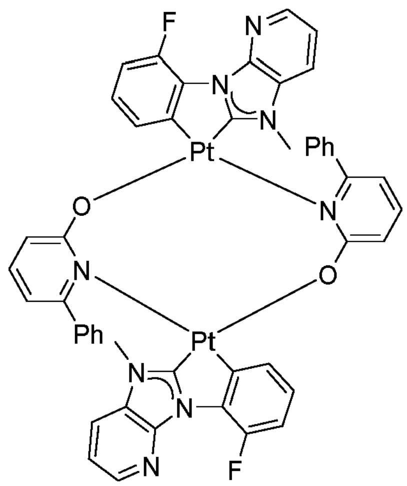

,

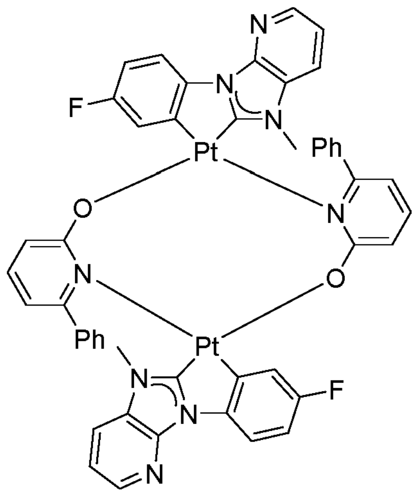

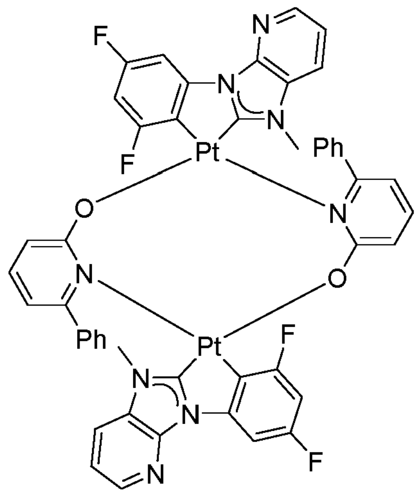

,

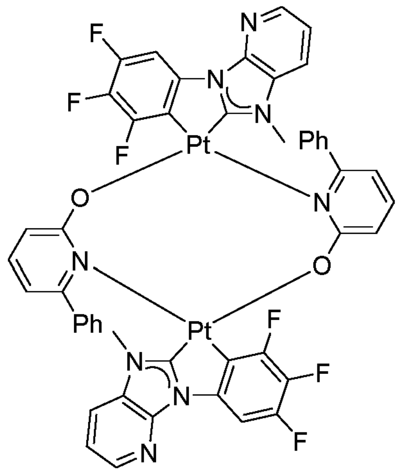

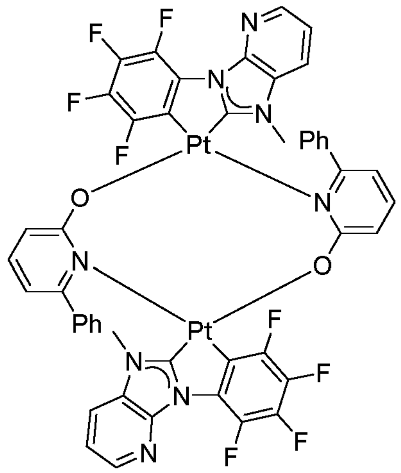

,

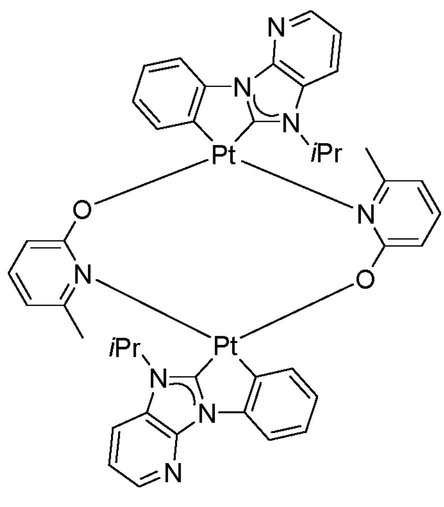

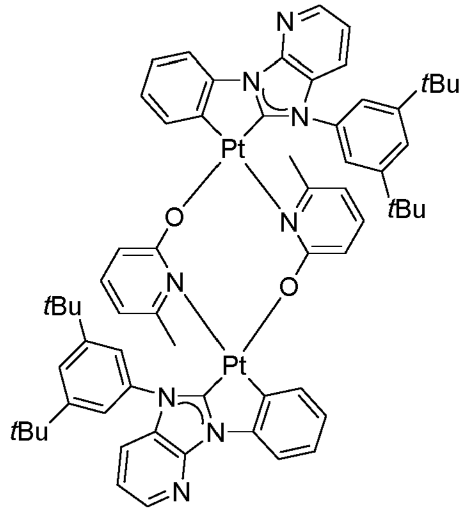

,

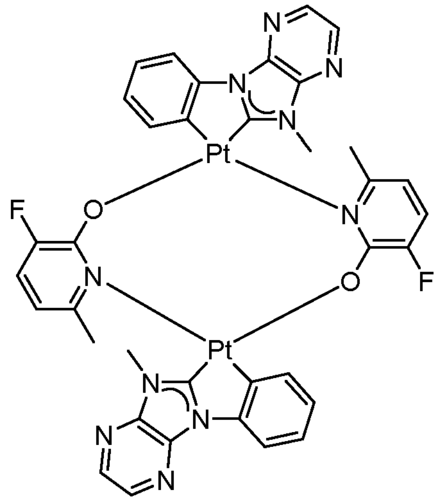

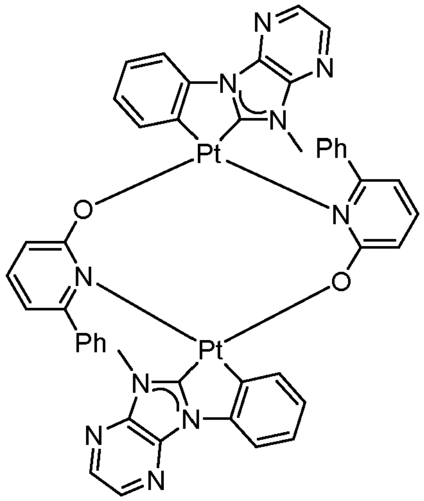

,

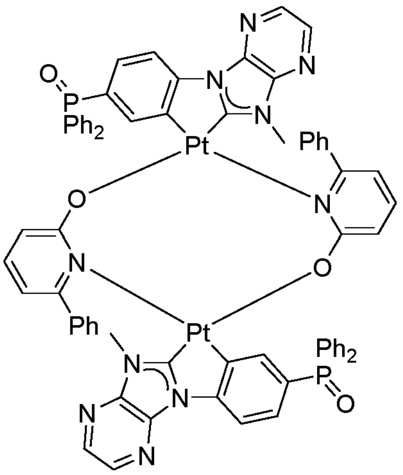

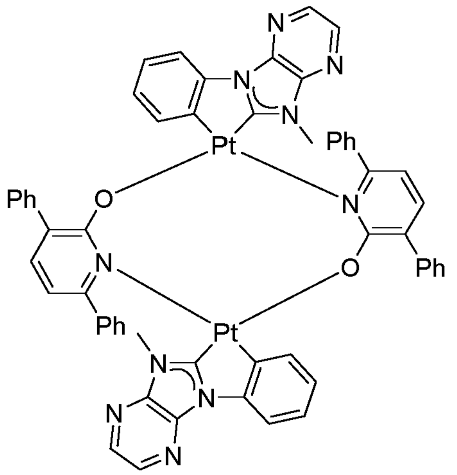

,

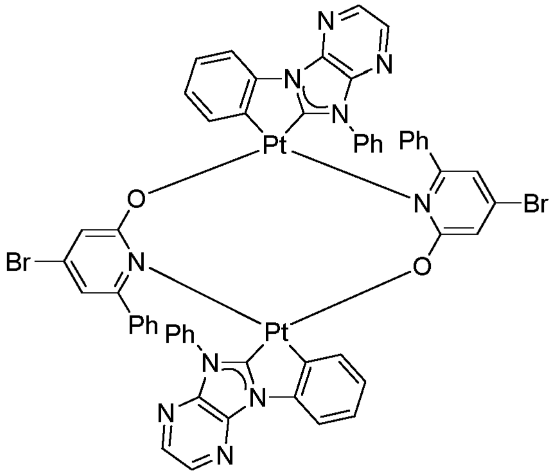

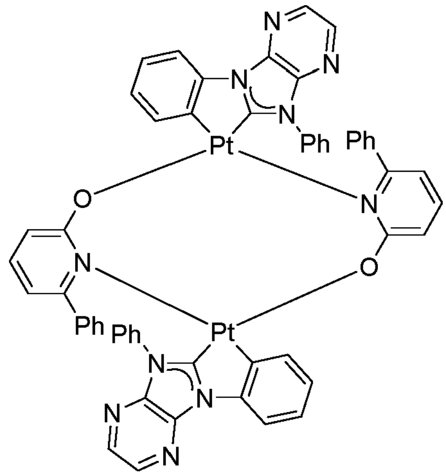

,

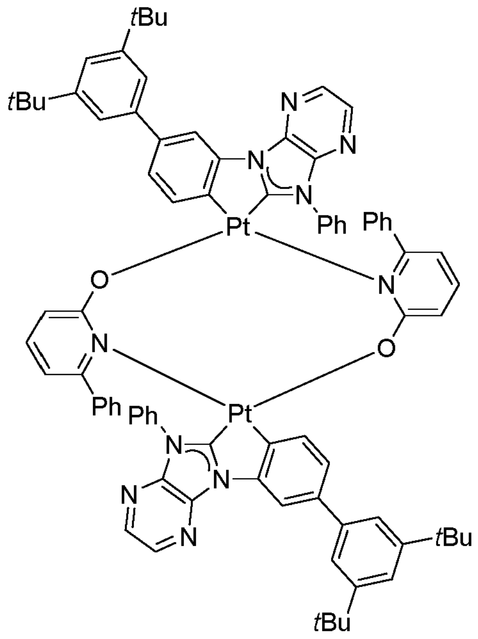

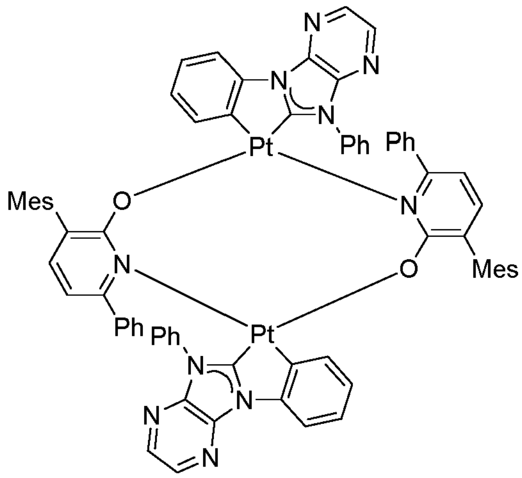

,

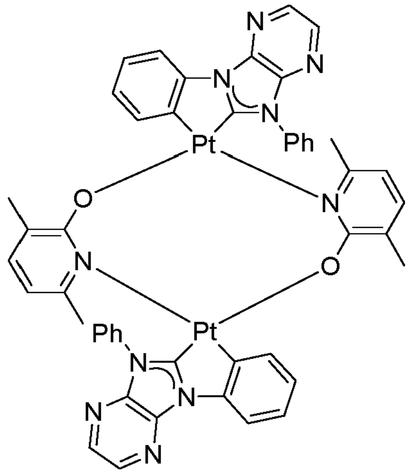

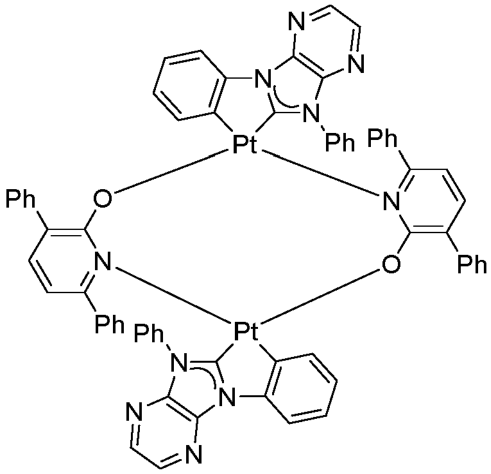

,

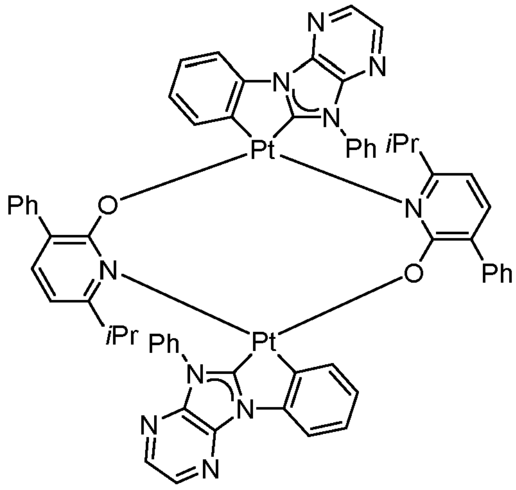

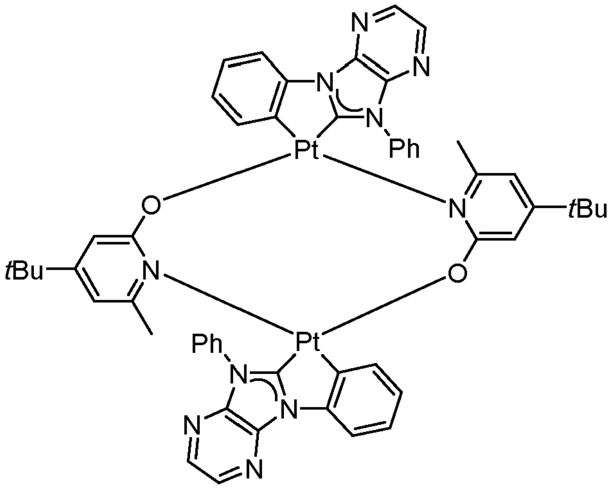

,

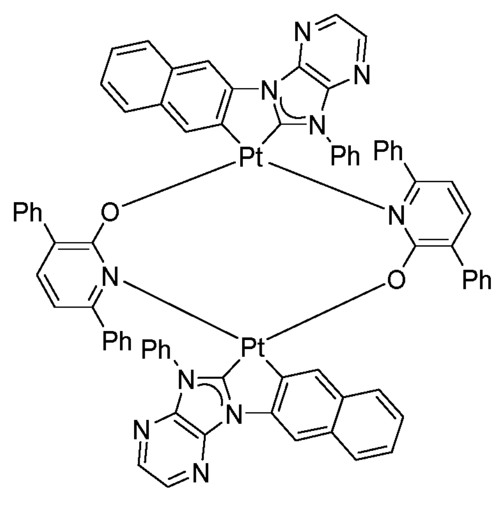

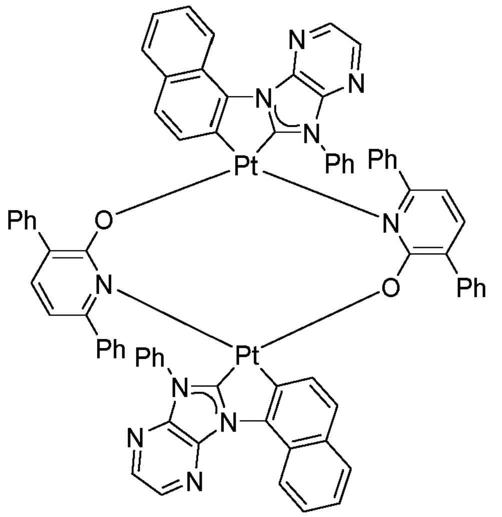

,

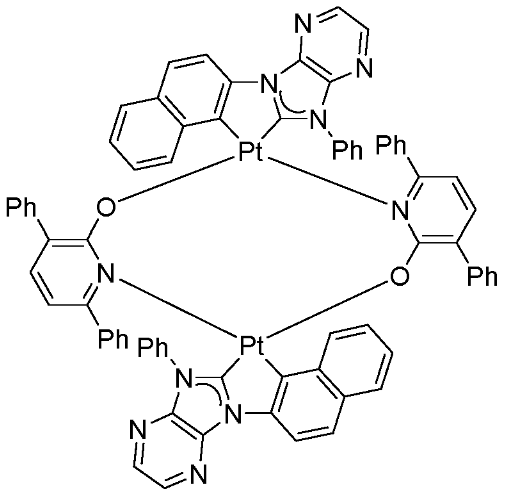

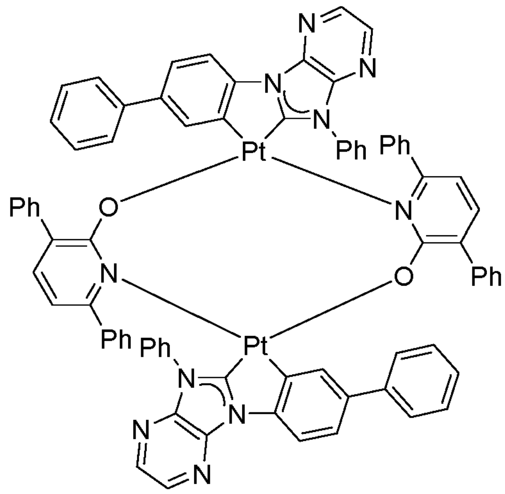

,

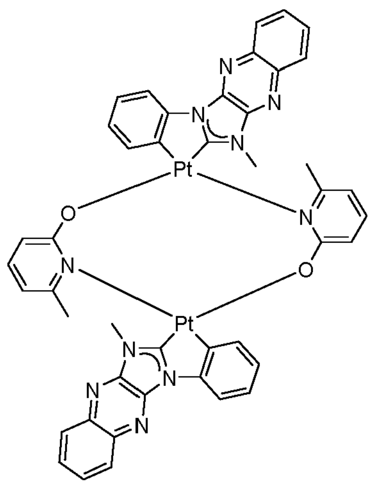

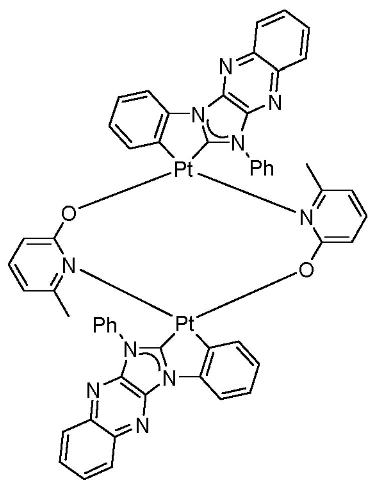

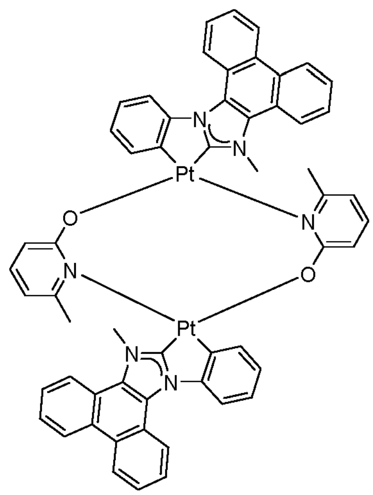

,

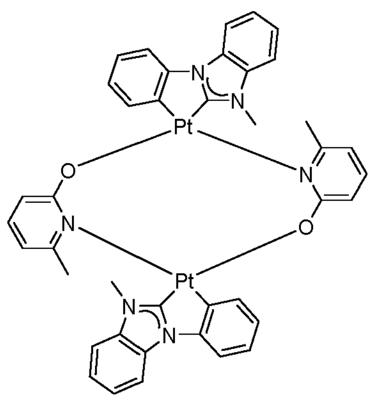

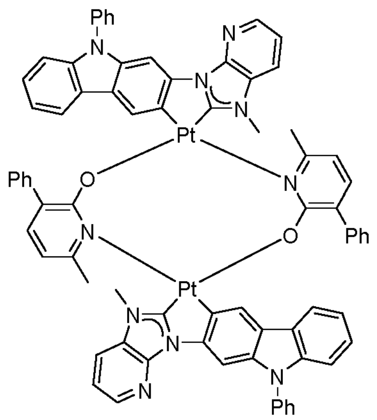

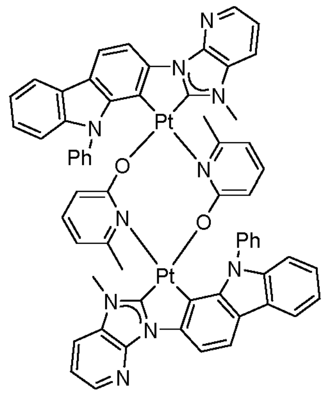

,

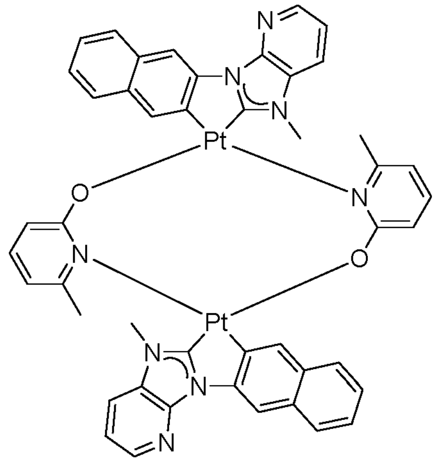

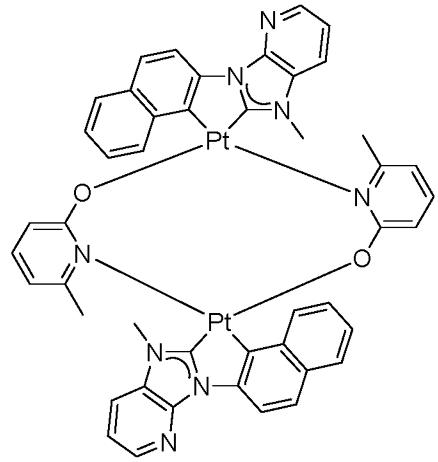

,

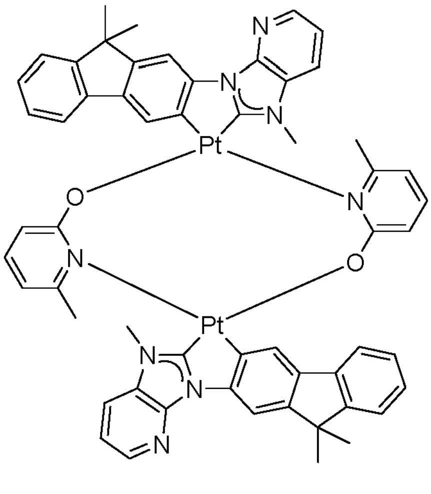

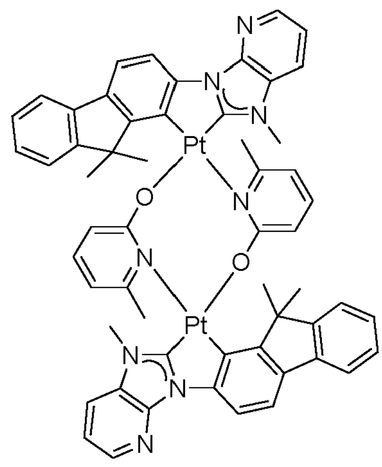

,

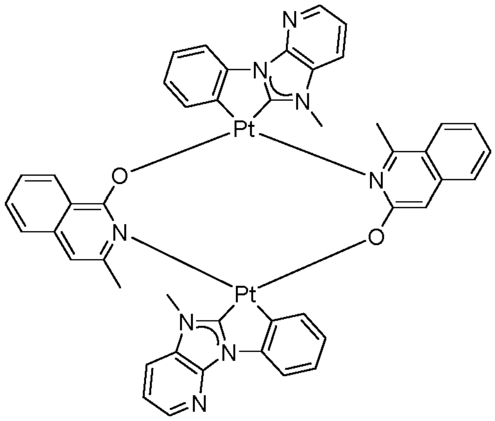

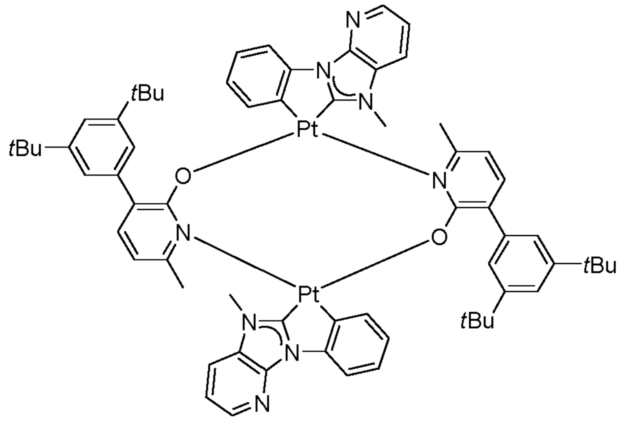

,

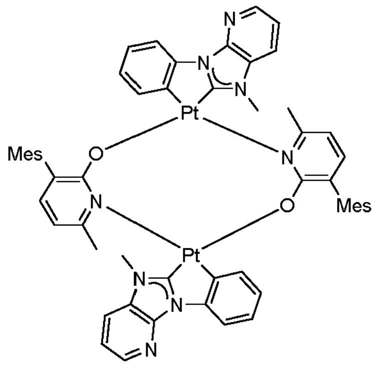

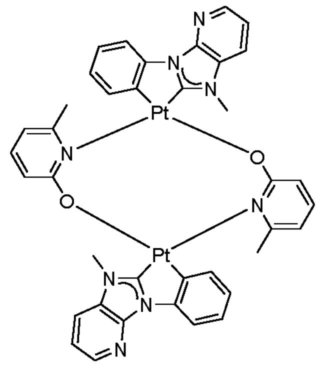

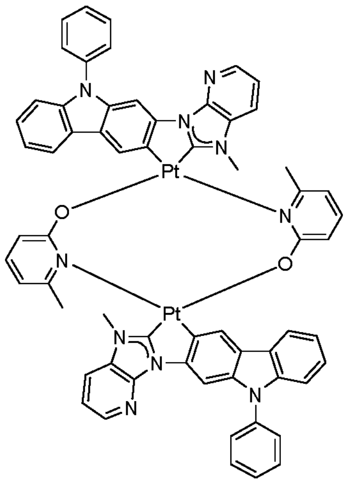

,

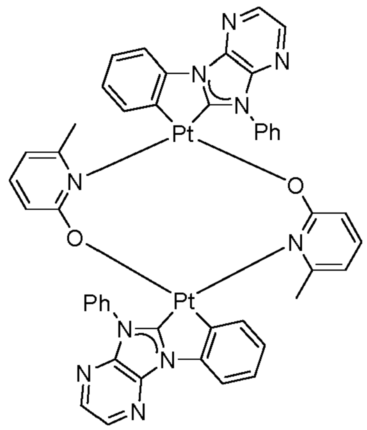

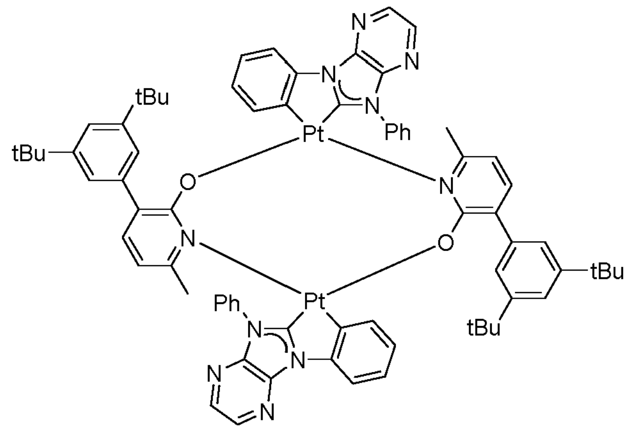

,

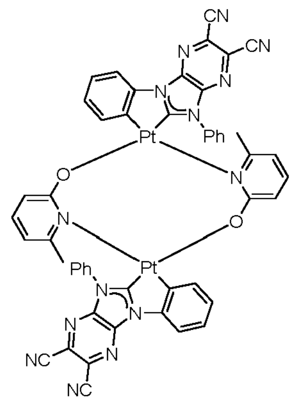
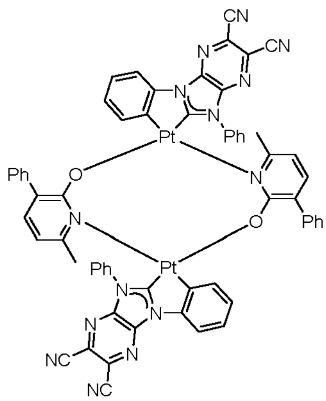
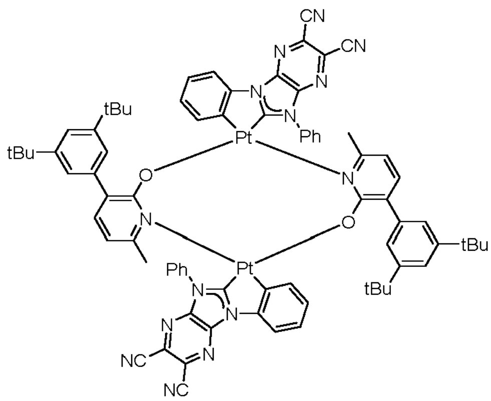

,

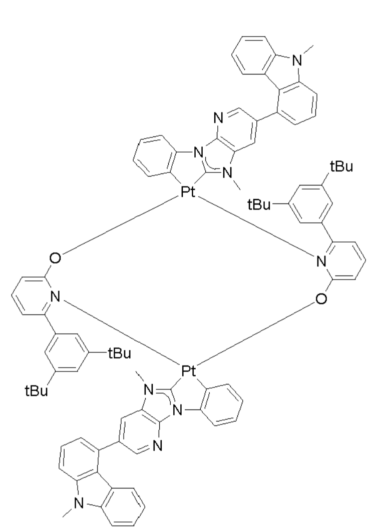
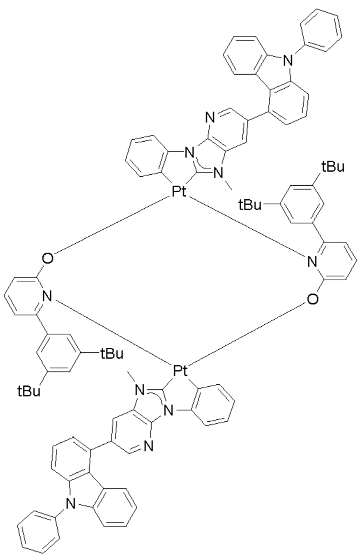
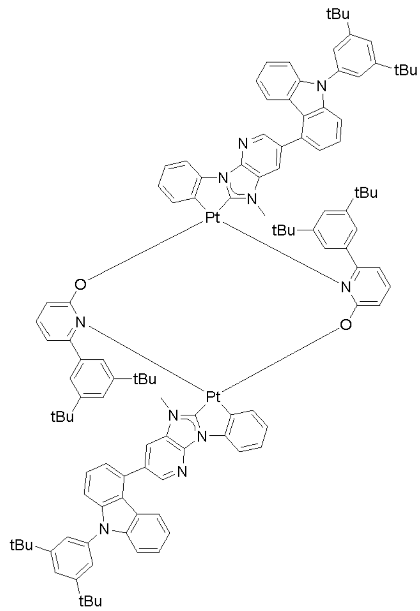

,

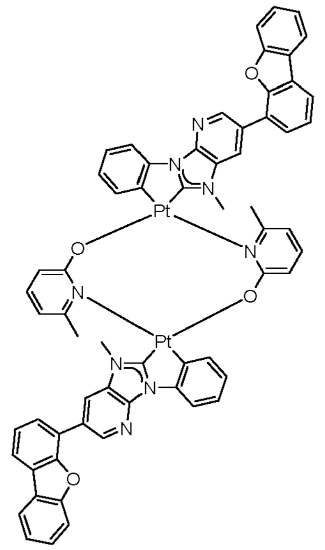
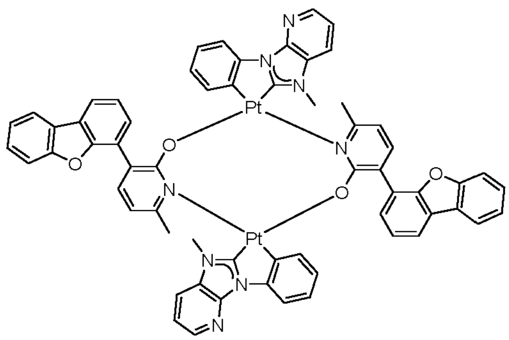
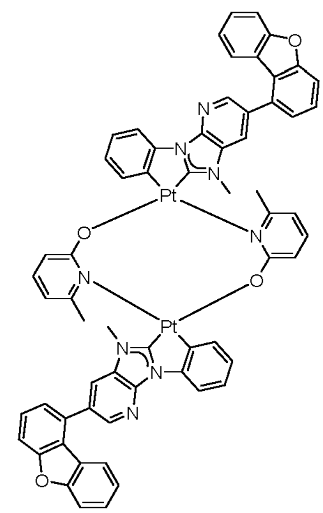

,

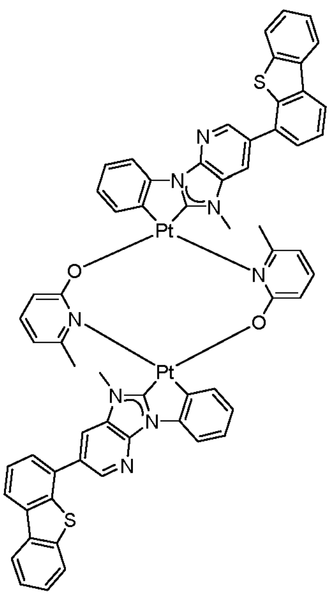

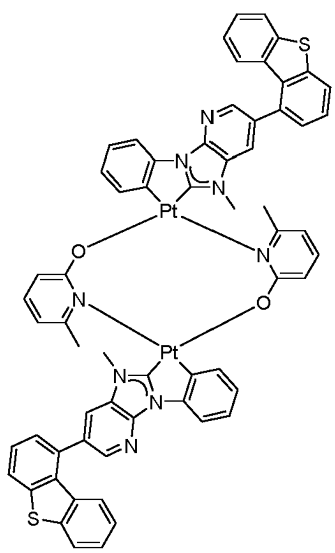

,

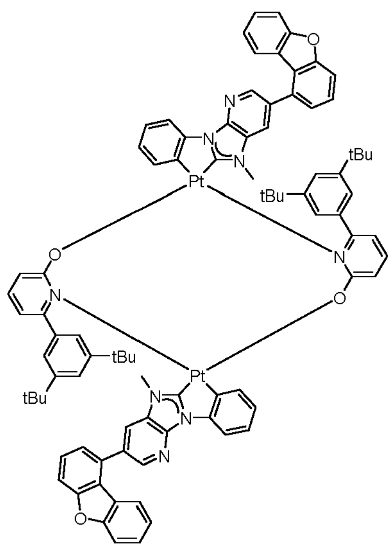

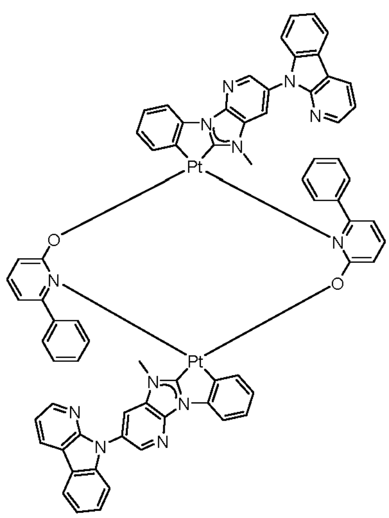

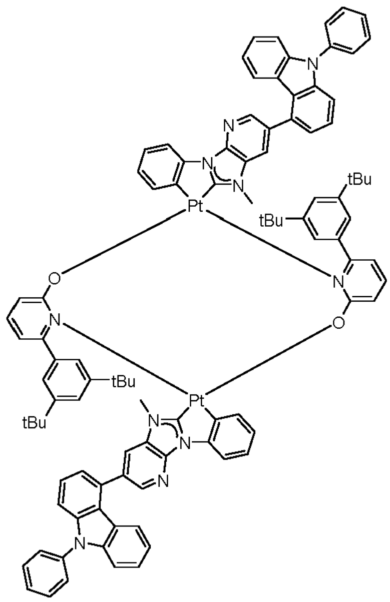

,

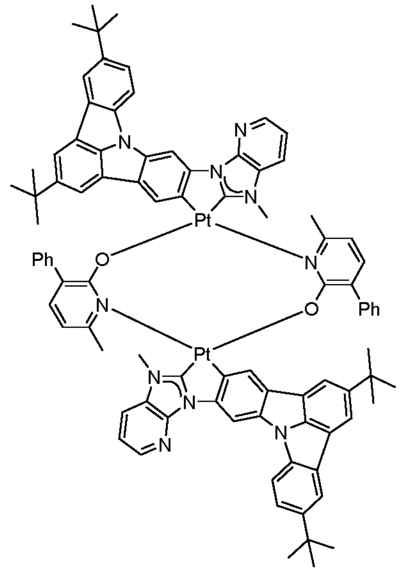

,

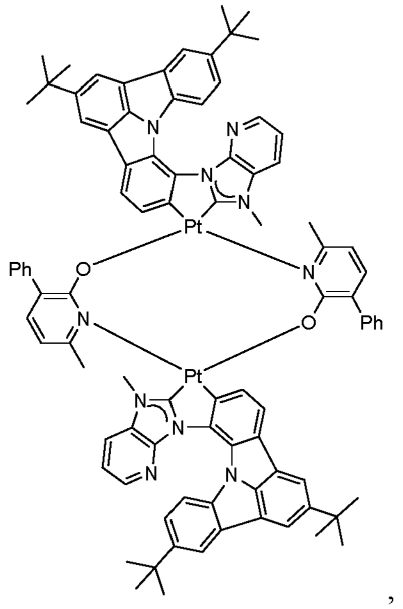

,

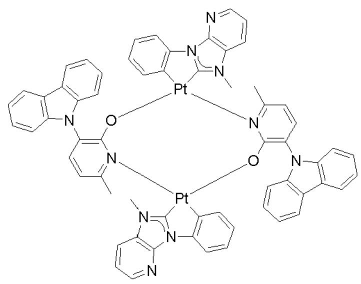

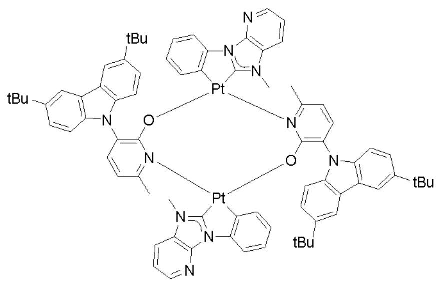

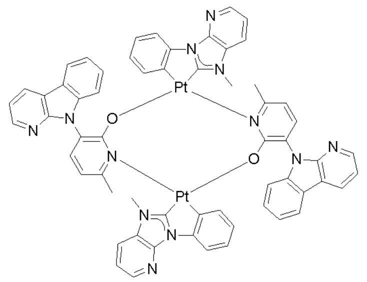

,

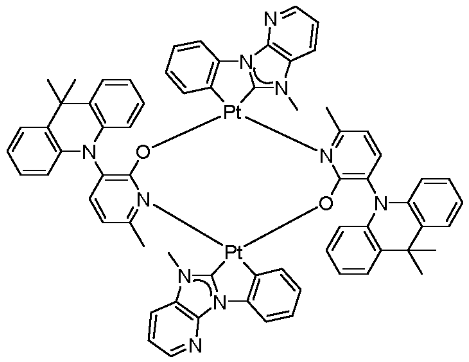

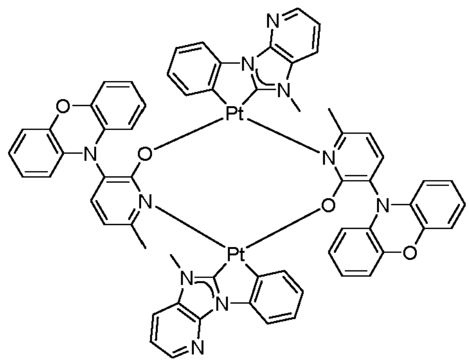

,

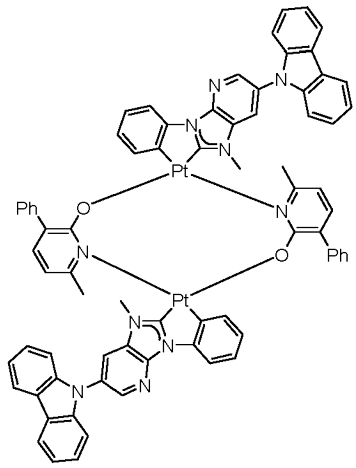
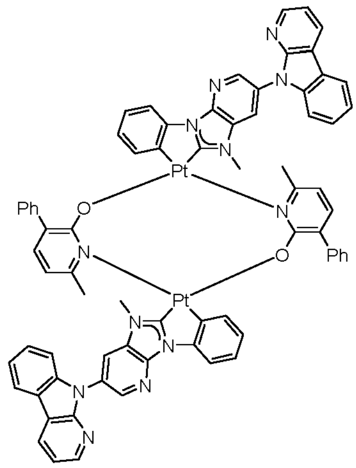
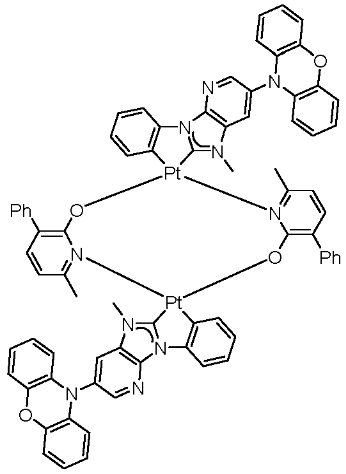

,

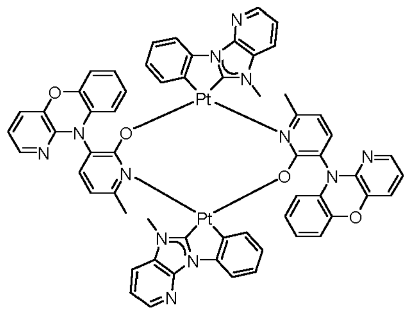
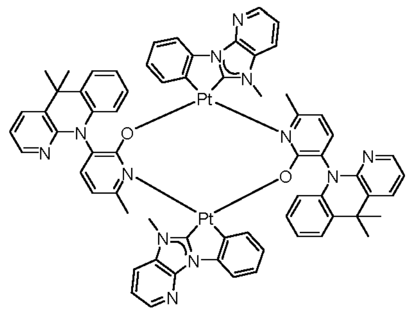
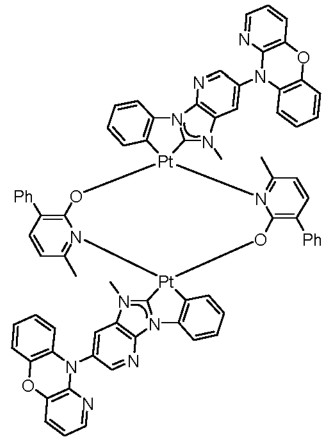

,

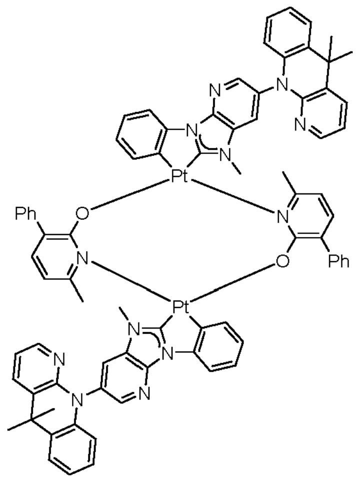
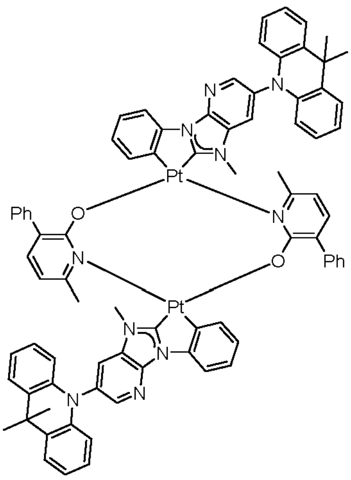
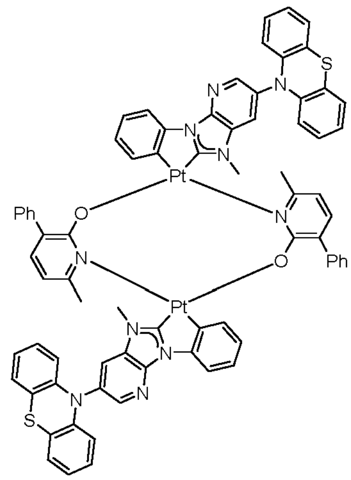

,

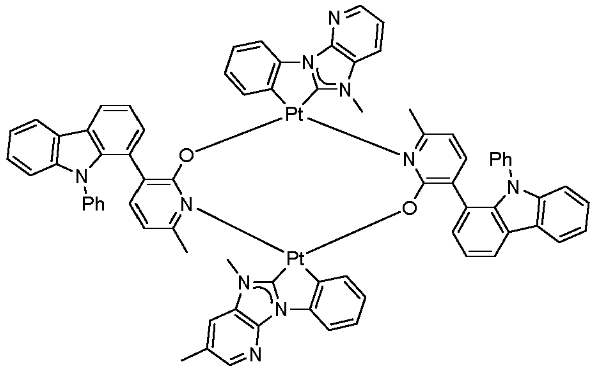 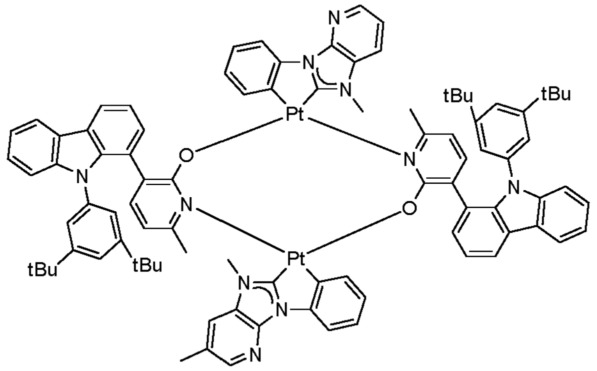,

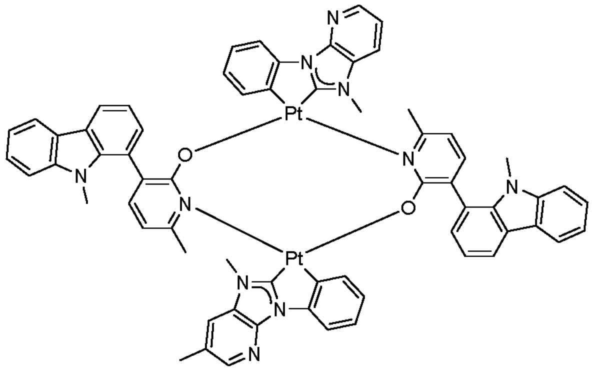 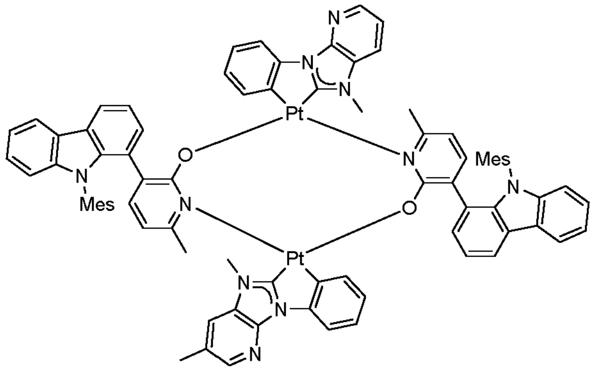.

Typically, the complex emits in the red-deep red or NIR region with a maximum emission wavelength ($\lambda_{max}$) in a range from 600 nm to 1000 nm, from 600 nm to 900 nm, from 600 nm to 800 nm, from 600 nm to 700 nm, from 600 nm to 680 nm, from 620 nm to 710 nm, or from 612 nm to 685 nm.

In some forms, the complex can have an emission lifetime ($\tau_{ern}$) of up to 2.5 $\mu$s, up to 2.0 $\mu$s, up to 1.9 $\mu$s, up to 1.8 $\mu$s, in a range from 0.5 $\mu$s to 2.0 $\mu$s, from 0.8 $\mu$s to 2.0 $\mu$s, from 1.0 $\mu$s to 2.0 $\mu$s, from 0.5 $\mu$s to 1.9 $\mu$s, from 0.8 $\mu$s to 1.9 $\mu$s, from 1.0 $\mu$s to 1.9 $\mu$s, from 1.2 $\mu$s to 1.9 $\mu$s, such as from 1.7 $\mu$s to 1.9 $\mu$s; a radiative decay rate ($k_r$) of at least $4.0 \times 10^5$ $s^{-1}$, in a range from $4.0 \times 10^5$ $s^{-1}$ to 10.0 x$10^5$ $s^{-1}$, from $4.0 \times 10^5$ $s^{-1}$ to 8.0 x$10^5$ $s^{-1}$, from $4.0 \times 10^5$ $s^{-1}$ to 6.0 x$10^5$ $s^{-1}$, from $4.0 \times 10^5$ $s^{-1}$ to 5.5 x$10^5$ $s^{-1}$, from $4.2 \times 10^5$ $s^{-1}$ to 10.0 x$10^5$ $s^{-1}$, from $4.2 \times 10^5$ $s^{-1}$ to 8.0 x$10^5$ $s^{-1}$, from $4.2 \times 10^5$ $s^{-1}$ to 6.0 x$10^5$ $s^{-1}$, from $4.2 \times 10^5$ $s^{-1}$ to 5.5 x$10^5$ $s^{-1}$, or from $4.3 \times 10^5$ $s^{-1}$ to 5.5 x$10^5$ $s^{-1}$; a non-radiative decay rate ($k_{nr}$) of less than $2.0 \times 10^5$ $s^{-1}$, less than $1.8 \times 10^5$ $s^{-1}$, less than $1.5 \times 10^5$ $s^{-1}$, down to $0.15 \times 10^5$ $s^{-1}$, in a range from $0.15 \times 10^5$ $s^{-1}$ to 2.0 x$10^5$ $s^{-1}$, from $0.16 \times 10^5$ $s^{-1}$ to 2.0 x$10^5$ $s^{-1}$, from $0.15 \times 10^5$ $s^{-1}$ to 1.8 x$10^5$ $s^{-1}$, from $0.16 \times 10^5$ $s^{-1}$ to 1.8 x$10^5$ $s^{-1}$, from $0.15 \times 10^5$ $s^{-1}$ to 1.6 x$10^5$ $s^{-1}$, from $0.16 \times 10^5$ $s^{-1}$ to 1.6 x$10^5$ $s^{-1}$, from $0.15 \times 10^5$ $s^{-1}$ to 1.5 x$10^5$ $s^{-1}$, or from $0.16 \times 10^5$ $s^{-1}$ to 1.4 x$10^5$ $s^{-1}$; and/or an emission quantum yield ($\Phi_{em}$) of at least 60%, at least 65%, at least 70%, at least 75%, in a range from 60% to 97%, from 65% to 97%, from 70% to 97%, from 75% to 97%, or from 78% to 97%, measured in solution or films, at room temperature.

Organic light-emitting components, such as organic light-emitting diode ("OLED") or light-emitting electrochemical cell ("LEEC"), containing one or more light-emitting layer or two or more light-emitting layers formed using the disclosed dinuclear platinum(II) complexes are also disclosed. Generally, the total concentration of the dinuclear platinum(II) complexes in the light-emitting layer or each light-emitting layer of the two or more light-emitting layers in the organic light-emitting component is up to 50 wt%, such as in a range from about 1 wt% to about 16 wt%, for example, about 4 wt%, about 8 wt%, or about 12 wt%. These organic light-emitting components can emit light in the red to deep red region or in the NIR region, with high efficiency at room temperature.

For examples, the organic light-emitting component can emit light in the red to deep red region with a maximum brightness (L) of at least 20000 cd $m^{-2}$, at least 25000 cd $m^{-2}$, at least 30000 cd $m^{-2}$, at least 35000 cd $m^{-2}$, at least 40000 cd $m^{-2}$, in a range from 20000 cd $m^{-2}$ to 100000 cd $m^{-2}$, from 30000 cd $m^{-2}$ to 100000 cd $m^{-2}$, from 20000 cd $m^{-2}$ to 80000 cd $m^{-2}$, from 30000 cd $m^{-2}$ to 80000 cd $m^{-2}$, from 20000 cd $m^{-2}$ to 60000 cd $m^{-2}$, from 30000 cd $m^{-2}$ to 60000 cd $m^{-2}$, from 20000 cd $m^{-2}$ to 50000 cd $m^{-2}$ from 30000 cd $m^{-2}$ to 100000 cd $m^{-2}$, from 20000 cd $m^{-2}$ to 50000 cd $m^{-2}$, from 30000 cd $m^{-2}$ to 50000 cd $m^{-2}$, from 35000 cd $m^{-2}$ to 100000 cd $m^{-2}$, from 40000 cd $m^{-2}$ to 100000 cd $m^{-2}$, from 35000 cd $m^{-2}$ to 80000 cd $m^{-2}$, from 40000 cd $m^{-2}$ to 80000 cd $m^{-2}$, from 35000 cd $m^{-2}$ to 60000 cd $m^{-2}$, from 40000 cd $m^{-2}$ to 60000 cd $m^{-2}$, from 35000 cd $m^{-2}$ to 50000 cd $m^{-2}$, or from 40000 cd $m^{-2}$ to 50000 cd $m^{-2}$; a current efficiency (CE) at 1000 cd/$m^2$ of at least 20 cd $A^{-1}$, at least 22 cd/A, in a range from 20 cd/A to 60 cd/A, from 22 cd/A to 60 cd/A, from 20 cd/A to 50 cd/A, from 22 cd/A to 50 cd/A, from 20

cd/A to 40 cd/A, or from 20 cd/A to 30 cd/A; a power efficiency (PE) at 1000 cd/$m^2$ of at least 10 lm/W, in a range from 10 lm/W to 60 lm/W, from 15 lm/W to 60 lm/W, from 10 lm/W to 50 lm/W, from 15 lm/W to 50 lm/W, from 10 lm/W to 40 lm/W, from 15 lm/W to 40 lm/W, from 10 lm/W to 30 lm/W, from 15 lm/W to 30 lm/W, or from 10 lm/W to 20 lm/W; and/or an external quantum efficiency (EQE) at 1000 cd/$m^2$ of at least 10%, at least 11%, at least 12%, at least 13%, at least 14%, at least 15%, in a range from 10% to 40%, from 10% to 20%, from 10% to 20%, from 11% to 40%, from 11% to 30%, from 11% to 20%, from 12% to 20%, from 12% to 40%, from 12% to 30%, from 13% to 20%, from 13% to 40%, from 13% to 30%, from 14% to 20%, from 14% to 40%, from 14% to 30%, from 15% to 40%, from 15% to 30%, or from 15% to 20%.

Alternatively, the organic light-emitting component can emit light in the NIR region with an L of at least 1000 cd $m^{-2}$, at least 2000 cd $m^{-2}$, at least 3000 cd $m^{-2}$, at least 4000 cd $m^{-2}$, at least 4200 cd $m^{-2}$, at least 4500 cd $m^{-2}$, in a range from 1000 cd $m^{-2}$ to 40000 cd $m^{-2}$, from 2000 cd $m^{-2}$ to 40000 cd $m^{-2}$, from 3000 cd $m^{-2}$ to 40000 cd $m^{-2}$, from 4000 cd $m^{-2}$ to 40000 cd $m^{-2}$, from 4500 cd $m^{-2}$ to 40000 cd $m^{-2}$, from 1000 cd $m^{-2}$ to 30000 cd $m^{-2}$, from 2000 cd $m^{-2}$ to 30000 cd $m^{-2}$, from 3000 cd $m^{-2}$ to 30000 cd $m^{-2}$, from 4000 cd $m^{-2}$ to 30000 cd $m^{-2}$, from 4500 cd $m^{-2}$ to 30000 cd $m^{-2}$, from 1000 cd $m^{-2}$ to 20000 cd $m^{-2}$, from 2000 cd $m^{-2}$ to 20000 cd $m^{-2}$, from 3000 cd $m^{-2}$ to 20000 cd $m^{-2}$, from 4000 cd $m^{-2}$ to 20000 cd $m^{-2}$, from 4500 cd $m^{-2}$ to 20000 cd $m^{-2}$, from 1000 cd $m^{-2}$ to 10000 cd $m^{-2}$, from 2000 cd $m^{-2}$ to 10000 cd $m^{-2}$, from 3000 cd $m^{-2}$ to 10000 cd $m^{-2}$, from 4000 cd $m^{-2}$ to 10000 cd $m^{-2}$, or from 4500 cd $m^{-2}$ to 10000 cd $m^{-2}$; a CE at 1000 cd $m^{-2}$ of at least 0.2 cd $A^{-1}$, at least 0.4 cd $A^{-1}$, at least 0.8 cd $A^{-1}$, in a range from 0.2 cd/A to 10 cd/A, from 0.2 cd/A to 8 cd/A, from 0.2 cd/A to 5 cd/A, from 0.2 cd/A to 3 cd/A, from 0.2 cd/A to 2 cd/A, from 0.4 cd/A to 10 cd/A, from 0.4 cd/A to 8 cd/A, from 0.4 cd/A to 5 cd/A, from 0.4 cd/A to 3 cd/A, from 0.4 cd/A to 2 cd/A, from 0.8 cd/A to 10 cd/A, from 0.8 cd/A to 8 cd/A, from 0.8 cd/A to 5 cd/A, from 0.8 cd/A to 3 cd/A, or from 0.8 cd/A to 2 cd/A; a PE at 1000 cd/$m^2$ of at least 0.1 lm/W, at least 0.2 lm/W, in a range from 0.1 lm/W to 5 lm/W, from 0.1 lm/W to 4 lm/W, from 0.1 lm/W to 3 lm/W, from 0.1 lm/W to 2 lm/W, from 0.1 lm/W to 1 lm/W, from 0.1 lm/W to 0.5 lm/W, from 0.2 lm/W to 5 lm/W, from 0.2 lm/W to 4 lm/W, from 0.2 lm/W to 3 lm/W, from 0.2 lm/W to 2 lm/W, from 0.2 lm/W to 1 lm/W, or from 0.2 lm/W to 0.5 lm/W; and/or an EQE at 1000 cd/$m^2$ of at least 1%, at least 2%, at least 4%, at least 5%, at least 6%, in a range from 1% to 20%, from 2% to 20%, from 4% to 20%, from 5% to 20%, from 5% to 18%, from 1% to 15%, from 2% to 15%, from 4% to 15%, from 5% to 15%, from 1% to 10%, from 2% to 10%, from 4% to 10%, or from 5% to 10%

These organic red/NIR light-emitting components containing the dinuclear platinum(II) complexes disclosed herein can be used in a variety of devices, such as a stationary visual display unit, a mobile visual display unit, an illumination device, a wearable device, or a medical monitoring device.

## BRIEF DESCRIPTION OF THE DRAWINGS

**FIG. 1A** is a graph showing the photoluminescence (PL) spectra of **Pt-R1, Pt-R2, Pt-R3, Pt-R4, Pt-R5,** and **Pt-R6** in PMMA films with doping concentration of 4 wt%. **FIG. 1B** is a graph showing the emission spectra of **Pt-R7** to **Pt-R13** in PMMA films at room temperature. **FIG. 1C** is a graph showing the emission spectra of **Pt-R14** and **Pt-R15** in PMMA films at room temperature.

**FIGs. 2A-2D** are electroluminescence (EL) spectra **(FIG. 2A)** and performance characteristics of devices of **Pt-R1** with doping concentrations of 4-12 wt%, respectively. The performance characteristics of this device include external quantum efficiency (EQE) **(FIG. 2B),** luminance **(FIG. 2C),** and current density (CE) **(FIG. 2D).** The device structure is: ITO/HAT-CN (5 nm)/TAPC (40 nm)/TCTA (10 nm)/TCTA: TPBi: Pt-R1 (20 nm)/TPBi (50 nm)/LiF (1 nm)/Al (100 nm).

**FIGs. 3A-3D** are EL spectra **(FIG. 3A)** and performance characteristics of devices of **Pt-R2** with doping concentration of 4 and 8 wt%, respectively. The performance characteristics of this device include EQE **(FIG. 3B),** luminance **(FIG. 3C),** and CE **(FIG. 3D).** The device structure is: ITO/HAT-CN (5 nm)/TAPC (40 nm)/TCTA (10 nm)/TCTA: TPBi: Pt-R2 (20 nm)/TPBi (50 nm)/LiF (1 nm)/Al (100 nm).

**FIGs. 4A-4D** are EL spectra **(FIG. 4A)** and performance characteristics of a first device fabricated with **Pt-R3** with doping concentration of 4, 8, 12, and 16 wt%, respectively. The performance characteristics of this device include EQE **(FIG. 4B),** luminance **(FIG. 4C),** and CE **(FIG. 4D).** The device structure is: ITO/HAT-CN (5 nm)/TAPC (40 nm)/TCTA (10 nm)/TCTA: TPBi: Pt-R3 (20 nm)/TPBi (50 nm)/LiF (1 nm)/Al (100 nm).

**FIGs. 5A-5D** are EL spectra **(FIG. 5A)** and performance characteristics of a second device fabricated with **Pt-R3** with doping concentration of 1, 2, and 4 wt%, respectively. The performance characteristics of this device include EQE **(FIG. 5B),** luminance **(FIG. 5C),** and CE **(FIG. 5D).** The device structure is: ITO/HAT-CN (10 nm)/FSFA (120 nm)/FSF4A (5 nm)/Pt-R3:DMIC-Cz: DMIC-Trz (30 nm)/ANT-Biz (5 nm)/ANT-Biz:Liq (1:1) (25 nm)/Liq (2 nm)/Al (100 nm).

**FIGs. 6A-6C** are graphs showing the lifetime data of the second device fabricated with **Pt-R3** with doping concentration of 1 wt% **(FIG. 6A),** 2 wt% **(FIG. 6B),** and 4 wt% **(FIG. 6C),** respectively.

**FIGs. 7A-7D** are EL spectra **(FIG. 7A)** and performance characteristics of a first device fabricated with **Pt-R4** with doping concentration of 2, 4, and 8 wt%, respectively. The performance characteristics of this device include EQE

**(FIG. 7B),** luminance **(FIG. 7C),** and CE **(FIG. 7D).** The device structure is: ITO/HAT-CN (5 nm)/TAPC (40 nm)/TCTA (10 nm)/TCTA:TPBi:Pt-R4 (20 nm)/TPBi (50 nm)/LiF (1 nm)/Al (100 nm).

**FIGs. 8A-8D** are EL spectra **(FIG. 8A)** and performance characteristics of a second device fabricated with **Pt-R4** with doping concentration of 2, 4, and 8 wt%, respectively. The performance characteristics of this device include EQE **(FIG. 8B),** luminance **(FIG. 8C),** and CE **(FIG. 8D).** The device structure is: ITO/HAT-CN (10 nm)/BPBPA (120 nm)/EB (5 nm)/Pt-R4:RH (40 nm)/HB (5 nm)/ZADN:Liq (35:65) (35 nm)/Liq (2 nm)/Al (100 nm).

**FIGs. 9A-9C** are graphs showing the lifetime data of the second device fabricated with **Pt-R4** with doping concentration of 2 wt% **(FIG. 9A),** 4 wt% **(FIG. 9B),** and 8 wt% **(FIG. 9C),** respectively.

**FIGs. 10A-10D** are EL spectra **(FIG. 10A)** and performance characteristics of devices fabricated with **Pt-R5** with doping concentration of 2, 6, and 10 wt%, respectively. The performance characteristics of this device include EQE **(FIG. 10B),** luminance **(FIG. 10C),** and CE **(FIG. 10D).** The device structure is: ITO/HAT-CN (10 nm)/BPBPA (40 nm)/EB (5 nm)/Pt-R5:RH (40 nm)/HB (5 nm)/ZADN:Liq (35:65) (35 nm)/Liq (2 nm)/Al (100 nm).

**FIG. 11** is a graph showing the lifetime data of the device fabricated with **Pt-R5** with doping concentration of 6 wt%.

**FIG. 12** shows a non-limiting example of an organic light-emitting diode device, **100,** having a multilayer architecture.

**FIGs. 13A-13D** are EL spectra **(FIG. 13A)** and performance characteristics of devices fabricated with **Pt-R6** with doping concentration of 2, 6, and 10 wt%, respectively. The performance characteristics of this device include EQE **(FIG. 13B),** luminance **(FIG. 13C),** and CE **(FIG. 13D).** The device structure is: ITO/HAT-CN (10 nm)/BPBPA (40 nm)/EB (5 nm)/**Pt-R6**:RH (40 nm)/HB (5 nm)/ZADN:Liq (35:65) (35 nm)/Liq (2 nm)/Al (100 nm).

**FIGs. 14A-14B** are graphs showing the lifetime data of the device fabricated with **Pt-R6** with doping concentration of 2 wt% **(FIG. 14A)** and 10 wt% **(FIG. 14B).**

**FIGs. 15A-15D** are EL spectra **(FIG. 15A)** and performance characteristics of devices fabricated with **Pt-R8** with doping concentration of 2, 6, and 10 wt%, respectively. The performance characteristics of this device include EQE **(FIG. 15B),** luminance **(FIG. 15C),** and CE **(FIG. 15D).** The device structure is: ITO/HAT-CN (10 nm)/BPBPA (40 nm)/EB (5 nm)/**Pt-R8**:RH (40 nm)/HB (5 nm)/ZADN:Liq (35:65) (35 nm)/Liq (2 nm)/Al (100 nm).

**FIG. 16** is a graph showing the lifetime data of the device fabricated with **Pt-R8** with doping concentration of 10 wt%.

**FIGs. 17A-17D** are EL spectra **(FIG. 17A)** and performance characteristics of devices fabricated with **Pt-R11** with doping concentration of 2, 6, and 10 wt%, respectively. The performance characteristics of this device include EQE **(FIG. 17B),** luminance **(FIG. 17C),** and CE **(FIG. 17D).** The device structure is: ITO/HAT-CN (10 nm)/BPBPA (40 nm)/NPB-BC (5 nm)/**Pt-R11**:RH (40 nm)/HB (5 nm)/ZADN:Liq (35:65) (35 nm)/Liq (2 nm)/Al (100 nm).

**FIGs. 18A-18D** are EL spectra **(FIG. 18A)** and performance characteristics of devices fabricated with **Pt-R12** with doping concentration of 2, 6, and 10 wt%, respectively. The performance characteristics of this device include EQE **(FIG. 18B),** luminance **(FIG. 18C),** and CE **(FIG. 18D).** The device structure is: ITO/HAT-CN (10 nm)/BPBPA (40 nm)/NPB-BC (5 nm)/**Pt-R12**:RH (40 nm)/HB (5 nm)/ZADN:Liq (35:65) (35 nm)/Liq (2 nm)/Al (100 nm).

**FIGs. 19A-19D** are EL spectra **(FIG. 19A)** and performance characteristics of devices fabricated with **Pt-R8** and MR-R1. The performance characteristics of this device include EQE **(FIG. 19B),** luminance **(FIG. 19C),** and CE **(FIG. 19D).** The device structure is: ITO/HAT-CN (10 nm)/BPBPA (40 nm)/EB (5 nm)/**Pt-R8**: MR-R1: RH (40 nm)/HB (5 nm)/ZADN:Liq (35:65) (35 nm)/Liq (2 nm)/Al (100 nm).

**FIG. 20** is a graph showing the lifetime data of the device fabricated with **Pt-R8** and MR-R1.

**FIGs. 21A-21C** are ECL spectra **(FIG. 21A) and** performance characteristics of devices fabricated with **Pt-R14** with doping concentration of 2, 4, 6, and 8 wt%, respectively. The performance characteristics of this device include EQE **(FIG. 21B),** luminance **(FIG. 21C, right y-axis),** and CE **(FIG. 21C, left y-axis).** The device structure is: ITO/PEDOT:PSS(40 nm)/PVK(10 nm)/ **Pt-R14**:CBP /DPEPO (10 nm)/TPBi (40 nm)/Liq (2 nm)/Al (100 nm).

**FIG. 22** is a schematic showing the X-ray single crystal structure of **Pt-R10.**

## DETAILED DESCRIPTION OF THE INVENTION

### I. Definitions

It is to be understood that the disclosed compounds, compositions, and methods are not limited to specific synthetic methods, specific analytical techniques, or to particular reagents unless otherwise specified, and, as such, may vary. It is also to be understood that the terminology used herein is for the purpose of describing particular forms and embodiments only and is not intended to be limiting.

"Substituted," as used herein, refers to all permissible substituents of the compounds or functional groups described herein. In the broadest sense, the permissible substituents include acyclic and cyclic, branched and unbranched, carbocyclic and heterocyclic, aromatic and nonaromatic substituents of organic compounds. Illustrative substituents include, but are not limited to, halogens, hydroxyl groups, or any other organic groupings containing any number of carbon atoms, preferably 1-14 carbon atoms, and optionally include one or more heteroatoms such as oxygen, sulfur, or nitrogen grouping in linear, branched, or cyclic structural formats. Representative substituents include a

substituted or unsubstituted alkyl, a substituted or unsubstituted alkenyl, a substituted or unsubstituted alkynyl, a substituted or unsubstituted heterocyclyl, a substituted or unsubstituted phenyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a halogen, a hydroxyl, an alkoxy, a phenoxy, an aroxy, a silyl, a thiol, an alkylthio, a substituted alkylthio, a phenylthio, an arylthio, a cyano, an isocyano, a nitro, a substituted or unsubstituted carbonyl, a carboxyl, an amino, an amido, an oxo, a sulfinyl, a sulfonyl, a sulfonic acid, a phosphonium, a phosphanyl, a phosphoryl, a phosphonyl, an amino acid. Such a substituted or unsubstituted alkyl, a substituted or unsubstituted alkenyl, a substituted or unsubstituted alkynyl, a substituted or unsubstituted heterocyclyl, a substituted or unsubstituted phenyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a halogen, a hydroxyl, an alkoxy, a phenoxy, an aroxy, a silyl, a thiol, an alkylthio, a substituted alkylthio, a phenylthio, an arylthio, a cyano, an isocyano, a nitro, a substituted or unsubstituted carbonyl, a carboxyl, an amino, an amido, an oxo, a sulfinyl, a sulfonyl, a sulfonic acid, a phosphonium, a phosphanyl, a phosphoryl, a phosphonyl, and an amino acid can be further substituted.

Heteroatoms such as nitrogen may have hydrogen substituents and/or any permissible substituents of organic compounds described herein which satisfy the valences of the heteroatoms. It is understood that "substitution" or "substituted" includes the implicit proviso that such substitution is in accordance with permitted valence of the substituted atom and the substituent, and that the substitution results in a stable compound, *i.e.,* a compound that does not spontaneously undergo transformation such as by rearrangement, cyclization, elimination, etc.

"Alkyl," as used herein, refers to the radical of saturated aliphatic groups, including straight-chain alkyl groups, branched-chain alkyl, and cycloalkyl (alicyclic). In some forms, a straight chain or branched chain alkyl has 30 or fewer carbon atoms in its backbone (e.g., $C_1$-$C_{30}$ for straight chains, $C_3$-$C_{30}$ for branched chains), 20 or fewer, 15 or fewer, or 10 or fewer. Alkyl includes methyl, ethyl, n-propyl, isopropyl, n-butyl, isobutyl, t-butyl, pentyl, hexyl, heptyl, octyl, decyl, tetradecyl, hexadecyl, eicosyl, tetracosyl and the like. Likewise, a cycloalkyl is a non-aromatic carbon-based ring composed of at least three carbon atoms, such as a nonaromatic monocyclic or nonaromatic polycyclic ring containing 3-30 carbon atoms, 3-20 carbon atoms, or 3-10 carbon atoms in their ring structure, and have 5, 6 or 7 carbons in the ring structure. Cycloalkyls containing a polycyclic ring system can have two or more non-aromatic rings in which two or more carbons are common to two adjoining rings (i.e., "fused cycloalkyl rings"). Examples of cycloalkyl groups include, but are not limited to, cyclopropyl, cyclobutyl, cyclopentyl, cyclohexyl, cycloheptyl, cyclooctanyl, etc.

"Substituted alkyl" refers to alkyl moieties having one or more substituents replacing a hydrogen on one or more carbons of the hydrocarbon backbone. Such substituents can be any substituents described above, e.g., halogen (such as fluorine, chlorine, bromine, or iodine), hydroxyl, carbonyl (such as a carboxyl, alkoxycarbonyl, formyl, or an acyl), thiocarbonyl (such as a thioester, a thioacetate, or a thioformate), aryl, alkoxyl, aralkyl, phosphonium, phosphanyl, phosphonyl, phosphoryl, phosphate, phosphonate, a phosphinate, amino, amido, amidine, imine, cyano, nitro, azido, oxo, sulfhydryl, thiol, alkylthio, silyl, sulfinyl, sulfate, sulfonate, sulfamoyl, sulfonamido, sulfonyl, heterocyclyl, an aromatic or heteroaromatic moiety. -NRR', wherein R and R' are independently hydrogen, alkyl, or aryl, and wherein the nitrogen atom is optionally quaternized; -SR, wherein R is a phosphonyl, a sulfinyl, a silyl a hydrogen, an alkyl, or an aryl; -CN; $-NO_2$; -COOH; carboxylate; -COR, -COOR, or $-CON(R)_2$, wherein R is hydrogen, alkyl, or aryl; imino, silyl, ether, haloalkyl (such as $-CF_3$, $-CH_2-CF_3$, $-CCl_3$); -CN; $-NCOCOCH_2CH_2$; -NCOCOCHCH; and -NCS; and combinations thereof.

It will be understood by those skilled in the art that the moieties substituted on the hydrocarbon chain can themselves be substituted, if appropriate. For instance, the substituents of a substituted alkyl may include halogen, hydroxy, nitro, thiols, amino, aralkyl, azido, imino, amido, phosphonium, phosphanyl, phosphoryl (including phosphonate and phosphinate), oxo, sulfonyl (including sulfate, sulfonamido, sulfamoyl and sulfonate), and silyl groups, as well as ethers, alkylthios, carbonyls (including ketones, aldehydes, carboxylates, and esters), haloalkyls, -CN and the like. Cycloalkyls can be substituted in the same manner.

Unless the number of carbons is otherwise specified, "lower alkyl" as used herein means an alkyl group, as defined above, but having from one to ten carbons, more preferably from one to six carbon atoms in its backbone structure. Likewise, "lower alkenyl" and "lower alkynyl" have similar chain lengths.

"Heteroalkyl," as used herein, refers to straight or branched chain, or cyclic carbon-containing alkyl radicals, or combinations thereof, containing at least one heteroatom on the carbon backbone. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkyl group" is a cycloalkyl group as defined above where at least one of the carbon atoms of the ring is substituted with a heteroatom such as, but not limited to, nitrogen, oxygen, sulphur, or phosphorus.

The term "alkenyl" as used herein is a hydrocarbon group of from 2 to 24 carbon atoms and structural formula containing at least one carbon-carbon double bond. Alkenyl groups include straight-chain alkenyl groups, branched-chain alkenyl, and cycloalkenyl. A cycloalkenyl is a non-aromatic carbon-based ring composed of at least three carbon atoms and at least one carbon-carbon double bond, such as a nonaromatic monocyclic or nonaromatic polycyclic ring containing 3-30 carbon atoms and at least one carbon-carbon double bond, 3-20 carbon atoms and at least one carbon-carbon

double bond, or 3-10 carbon atoms and at least one carbon-carbon double bond in their ring structure, and have 5, 6 or 7 carbons and at least one carbon-carbon double bond in the ring structure. Cycloalkenyls containing a polycyclic ring system can have two or more non-aromatic rings in which two or more carbons are common to two adjoining rings (i.e., "fused cycloalkenyl rings") and contain at least one carbon-carbon double bond. Asymmetric structures such as (AB) C=C(C'D) are intended to include both the E and Z isomers. This may be presumed in structural formulae herein wherein an asymmetric alkene is present, or it may be explicitly indicated by the bond symbol C. The term "alkenyl" as used throughout the specification, examples, and claims is intended to include both "unsubstituted alkenyls" and "substituted alkenyls," the latter of which refers to alkenyl moieties having one or more substituents replacing a hydrogen on one or more carbons of the hydrocarbon backbone. The term "alkenyl" also includes "heteroalkenyl."

The term "substituted alkenyl" refers to alkenyl moieties having one or more substituents replacing one or more hydrogen atoms on one or more carbons of the hydrocarbon backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, oxo, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof.

"Heteroalkenyl," as used herein, refers to straight or branched chain, or cyclic carbon-containing alkenyl radicals, or combinations thereof, containing at least one heteroatom. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkenyl group" is a cycloalkenyl group where at least one of the carbon atoms of the ring is substituted with a heteroatom such as, but not limited to, nitrogen, oxygen, sulphur, or phosphorus.

The term "alkynyl group" as used herein is a hydrocarbon group of 2 to 24 carbon atoms and a structural formula containing at least one carbon-carbon triple bond. Alkynyl groups include straight-chain alkynyl groups, branched-chain alkynyl, and cycloalkynyl. A cycloalkynyl is a non-aromatic carbon-based ring composed of at least three carbon atoms and at least one carbon-carbon triple bond, such as a nonaromatic monocyclic or nonaromatic polycyclic ring containing 3-30 carbon atoms and at least one carbon-carbon triple bond, 3-20 carbon atoms and at least one carbon-carbon triple bond, or 3-10 carbon atoms and at least one carbon-carbon triple bond in their ring structure, and have 5, 6 or 7 carbons and at least one carbon-carbon triple bond in the ring structure. Cycloalkynyls containing a polycyclic ring system can have two or more non-aromatic rings in which two or more carbons are common to two adjoining rings (i.e., "fused cycloalkynyl rings") and contain at least one carbon-carbon triple bond. Asymmetric structures such as (AB)C≡C(C"D) are intended to include both the E and Z isomers. This may be presumed in structural formulae herein wherein an asymmetric alkyne is present, or it may be explicitly indicated by the bond symbol C. The term "alkynyl" as used throughout the specification, examples, and claims is intended to include both "unsubstituted alkynyls" and "substituted alkynyls," the latter of which refers to alkynyl moieties having one or more substituents replacing a hydrogen on one or more carbons of the hydrocarbon backbone. The term "alkynyl" also includes "heteroalkynyl."

The term "substituted alkynyl" refers to alkynyl moieties having one or more substituents replacing one or more hydrogen atoms on one or more carbons of the hydrocarbon backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof.

"Heteroalkynyl," as used herein, refers to straight or branched chain, or cyclic carbon-containing alkynyl radicals, or combinations thereof, containing at least one heteroatom. Suitable heteroatoms include, but are not limited to, O, N, Si, P and S, wherein the nitrogen, phosphorous and sulfur atoms are optionally oxidized, and the nitrogen heteroatom is optionally quaternized. For example, the term "heterocycloalkynyl group" is a cycloalkynyl group where at least one of the carbon atoms of the ring is substituted with a heteroatom such as, but not limited to, nitrogen, oxygen, sulphur, or phosphorus.

"Aryl," as used herein, refers to $C_4$-$C_{26}$-membered aromatic rings or fused ring systems containing one aromatic ring and optionally one or more non-aromatic rings. Examples of aryl groups are benzene, tetralin, indane, etc.

The term "substituted aryl" refers to an aryl group, wherein one or more hydrogen atoms on one or more aromatic rings are substituted with one or more substituents including, but not limited to, halogen, azide, alkyl, aralkyl, alkenyl, alkynyl, cycloalkyl, hydroxyl, alkoxy, carbonyl (such as a ketone, aldehyde, carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, imino, alkylthio, sulfate, sulfonate, sulfamoyl, sulfoxide, sulfonamido, sulfonyl, heterocyclyl, alkylaryl, haloalkyl (such as $CF_3$, $-CH_2-CF_3$, $-CCl_3$), aryl, heteroaryl, and combinations thereof.

"Heterocyclo" and "heterocyclyl" are used interchangeably, and refer to a cyclic radical attached via a ring carbon or nitrogen atom of a monocyclic ring or polycyclic ring system containing 3-30 ring atoms, 3-20 ring atoms, 3-10 ring atoms, or 5-6 ring atoms, where the polycyclic ring system contains one or more non-aromatic rings and optionally one or more aromatic rings, where at least one non-aromatic ring contains carbon and one to four heteroatoms each selected from the group consisting of non-peroxide oxygen, sulfur, and N(Y) wherein Y is absent or is H, O, $C_1$-$C_{10}$ alkyl, phenyl or benzyl, and optionally containing 1-3 double bonds and optionally substituted with one or more substituents. Heterocyclyl are distinguished from heteroaryl by definition. Heterocycles can be a heterocycloalkyl, a heterocycloalkenyl, a heterocycloalkynyl, etc, such as piperazinyl, piperidinyl, piperidonyl, 4-piperidonyl, dihydrofuro[2,3-*b*]tetrahydrofuran, morpholinyl, piperazinyl, piperidinyl, piperidonyl, 4-piperidonyl, piperonyl, pyranyl, 2*H*-pyrrolyl, 4*H*-quinolizinyl, quinuclidinyl, tetrahydrofuranyl, 6*H*-1,2,5-thiadiazinyl. Heterocyclic groups can optionally be substituted with one or more substituents as defined above for alkyl and aryl.

The term "heteroaryl" refers to $C_3$-$C_{26}$-membered aromatic rings or fused ring systems containing one aromatic ring and one or more non-aromatic rings, in which one or more carbon atoms on the aromatic ring structure have been substituted with a heteroatom. Suitable heteroatoms include, but are not limited to, oxygen, sulfur, and nitrogen. Examples of heteroaryl groups pyrrole, furan, thiophene, imidazole, oxazole, thiazole, triazole, tetrazole, pyrazole, pyridine, pyrazine, pyridazine and pyrimidine, and the like. Examples of heteroaryl rings include, but are not limited to, benzimidazolyl, benzofuranyl, benzothiofuranyl, benzothiophenyl, benzoxazolyl, benzoxazolinyl, benzthiazolyl, benztriazolyl, benztetrazolyl, benzisoxazolyl, benzisothiazolyl, benzimidazolinyl, carbazolyl, 4aH-carbazolyl, carbolinyl, chromanyl, chromenyl, cinnolinyl, decahydroquinolinyl, 2H,6H-1,5,2-dithiazinyl, furanyl, furazanyl, imidazolidinyl, imidazolinyl, imidazolyl, 1H-indazolyl, indolenyl, indolinyl, indolizinyl, indolyl, 3H-indolyl, isatinoyl, isobenzofuranyl, isochromanyl, isoindazolyl, isoindolinyl, isoindolyl, isoquinolinyl, isothiazolyl, isoxazolyl, methylenedioxyphenyl, naphthyridinyl, octahydroisoquinolinyl, 1,2,3-oxadiazolyl, 1,2,4-oxadiazolyl, 1,2,5-oxadiazolyl, 1,3,4-oxadiazolyl, oxazolidinyl, oxazolyl, oxindolyl, pyrimidinyl, phenanthridinyl, phenanthrolinyl, phenazinyl, phenothiazinyl, phenoxathinyl, phenoxazinyl, phthalazinyl, pteridinyl, purinyl, pyrazinyl, pyrazolidinyl, pyrazolinyl, pyrazolyl, pyridazinyl, pyridooxazole, pyridoimidazole, pyridothiazole, pyridinyl, pyridyl, pyrimidinyl, pyrrolidinyl, pyrrolinyl, pyrrolyl, quinazolinyl, quinolinyl, quinoxalinyl, tetrahydroisoquinolinyl, tetrahydroquinolinyl, tetrazolyl, 1,2,3-thiadiazolyl, 1,2,4-thiadiazolyl, 1,2,5-thiadiazolyl, 1,3,4-thiadiazolyl, thianthrenyl, thiazolyl, thienyl, thienothiazolyl, thienooxazolyl, thienoimidazolyl, thiophenyl and xanthenyl. One or more of the rings can be substituted as defined below for "substituted heteroaryl."

The term "substituted heteroaryl" refers to a heteroaryl group in which one or more hydrogen atoms on one or more heteroaromatic rings are substituted with one or more substituents including, but not limited to, halogen, azide, alkyl, aralkyl, alkenyl, alkynyl, cycloalkyl, hydroxyl, alkoxy, carbonyl (such as a ketone, aldehyde, carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, imino, alkylthio, sulfate, sulfonate, sulfamoyl, sulfoxide, sulfonamido, sulfonyl, heterocyclyl, alkylaryl, haloalkyl (such as $CF_3$, $-CH_2-CF_3$, $-CCl_3$), aryl, heteroaryl, and combinations thereof.

The term "polyaryl" refers to a fused ring system that includes two or more aromatic rings and optionally one or more non-aromatic rings. Examples of polyaryl groups are naphthalene, anthracene, phenanthrene, chrysene, pyrene, corannulene, coronene, etc. When a fused ring system containing two or more aromatic rings and optionally one or more non-aromatic rings, in which one or more carbon atoms on one or more aromatic ring structures have been substituted with a heteroatom, the fused ring system can be referred to as a "heteropolyaryl" or "polyheteroaryl". The terms "heteropolyaryl" and "polyheteroaryl" are used interchangeably herein.

The term "substituted polyaryl" refers to a polyaryl in which one or more of the aryls are substituted, with one or more substituents including, but not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (or quarternized amino), amido, amidine, imine, cyano, nitro, azido, sulfhydryl, alkylthio, sulfate, sulfonate, sulfamoyl, sulfoxide, sulfonamido, sulfonyl, heterocyclyl, alkylaryl, haloalkyl, aryl, heteroaryl, and combinations thereof. When a polyheteroaryl is involved, the chemical moiety can be referred to as a "substituted polyheteroaryl."

The term "cyclic ring" or "cyclic group" refers to a substituted or unsubstituted monocyclic ring or a substituted or unsubstituted polycyclic ring (such as those formed from single or fused ring systems), such as a substituted or unsubstituted cycloalkyl, a substituted or unsubstituted cycloalkenyl, a substituted or unsubstituted cycloalkynyl, or a substituted or unsubstituted heterocyclyl, that have from three to 30 carbon atoms, as geometric constraints permit. The substituted cycloalkyls, cycloalkenyls, cycloalkynyls, and heterocyclyls are substituted as defined above for the alkyls, alkenyls, alkynyls, and heterocyclyls, respectively.

The term "aralkyl" as used herein is an aryl group or a heteroaryl group having an alkyl, alkynyl, or alkenyl group as defined above attached to the aromatic group, such as an aryl, a heteroaryl, a polyaryl, or a polyheteroaryl. An example of an aralkyl group is a benzyl group.

The terms "alkoxyl" or "alkoxy," "aroxy" or "aryloxy," generally describe compounds represented by the formula

-$OR^v$, wherein $R^v$ includes, but is not limited to, a substituted or unsubstituted alkyl, a substituted or unsubstituted alkenyl, a substituted or unsubstituted alkynyl, a substituted or unsubstituted cycloalkyl, a substituted or unsubstituted heterocyclyl, a substituted or unsubstituted cycloalkenyl, a substituted or unsubstituted heterocycloalkenyl, a substituted or unsubstituted aryl, a substituted or unsubstituted heteroaryl, a substituted or unsubstituted polyaryl, a substituted or unsubstituted polyheteroaryl, a substituted or unsubstituted arylalkyl, a substituted or unsubstituted heteroalkyl, a substituted or unsubstituted alkylaryl, a substituted or unsubstituted alkylheteroaryl, a substituted or unsubstituted aralkyl, a substituted or unsubstituted carbonyl, a phosphonium, a phosphanyl, a phosphonyl, a sulfinyl, a silyl, a thiol, an amido, and an amino. Exemplary alkoxyl groups include methoxy, ethoxy, propyloxy, tert-butoxy and the like. A "lower alkoxy" group is an alkoxy group containing from one to six carbon atoms. An "ether" is two functional groups covalently linked by an oxygen as defined below. Accordingly, the substituent of an alkyl that renders that alkyl an ether is or resembles an alkoxyl, such as can be represented by one of -O-alkyl, -O-alkenyl, -O-alkynyl, -O-arakyl, -O-aryl, -O-heteroaryl, -O-polyaryl, -O-polyheteroaryl, -O-heterocyclyl, etc.

The term "substituted alkoxy" refers to an alkoxy group having one or more substituents replacing one or more hydrogen atoms on one or more carbons of the alkoxy backbone. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, oxo, sulfate, sulfonate, sulfamoyl, sulfonamido, sulfonyl, heterocyclyl, alkylaryl, haloalkyl, aryl, heteroaryl, and combinations thereof.

The term "ether" as used herein is represented by the formula $A^2OA^1$, where $A^2$ and $A^1$ can be, independently, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl, a substituted or unsubstituted polyaryl, a substituted or unsubstituted polyheteroaryl, a phosphonium, a phosphanyl, a phosphonyl, a sulfinyl, a silyl, a thiol, a substituted or unsubstituted carbonyl, an alkoxy, an amido, or an amino, described above.

The term "polyether" as used herein is represented by the formula:

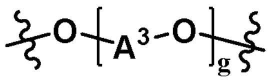

where $A^3$ can be, independently, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl, a substituted or unsubstituted polyaryl, a substituted or unsubstituted polyheteroaryl, a phosphonium, a phosphanyl, a substituted or unsubstituted carbonyl, an alkoxy, an amido, or an amino, described above; g can be a positive integer from 1 to 30.

The term "phenoxy" is art recognized and refers to a compound of the formula -$OR^v$ wherein $R^v$ is $C_6H_5$ (*i.e.,* -O-$C_6H_5$). One of skill in the art recognizes that a phenoxy is a species of the aroxy genus.

The term "substituted phenoxy" refers to a phenoxy group, as defined above, having one or more substituents replacing one or more hydrogen atoms on one or more carbons of the phenyl ring. Such substituents include, but are not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, and combinations thereof.

The terms "aroxy" and "aryloxy," as used interchangeably herein, are represented by -O-aryl or -O-heteroaryl, wherein aryl and heteroaryl are as defined herein.

The terms "substituted aroxy" and "substituted aryloxy," as used interchangeably herein, represent -O-aryl or -O-heteroaryl, having one or more substituents replacing one or more hydrogen atoms on one or more ring atoms of the aryl and heteroaryl, as defined herein. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof.

The term "amino" as used herein includes the group

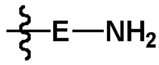

(primary amino),

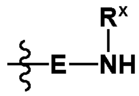

(secondary amino),

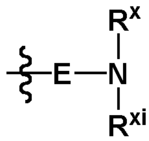

(tertiary amino), and

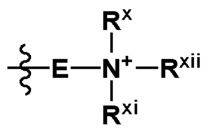

(quaternary amino),
wherein, E is absent, or E is substituted or unsubstituted alkyl, substituted or unsubstituted alkenyl, substituted or unsubstituted alkynyl, substituted or unsubstituted aralkyl, substituted or unsubstituted aryl, substituted or unsubstituted heteroaryl, a substituted or unsubstituted polyaryl, a substituted or unsubstituted polyheteroaryl, substituted or unsubstituted heterocyclyl, wherein independently of E, $R^x$, $R^{xi}$, and $R^{xii}$ each independently represent a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. The term "quaternary amino" also includes the groups where the nitrogen, $R^x$, $R^{xi}$, and $R^{xii}$ with the $N^+$ to which they are attached complete a heterocyclyl or heteroaryl having from 3 to 14 atoms in the ring structure. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The terms "amide" or "amido" are used interchangeably, refer to both "unsubstituted amido" and "substituted amido" and are represented by the general formula:

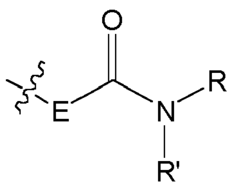

or

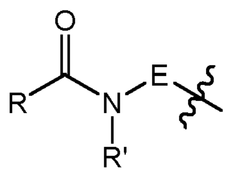

wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted aryl, substituted or unsubstituted heteroaryl, a substituted or unsubstituted polyaryl, a substituted or unsubstituted polyheteroaryl, or a substituted or unsubstituted heterocyclyl, wherein independently of E, R and R' each independently represent a hydrogen, a substituted or unsubstituted alkyl, a substituted or unsubstituted alkenyl, a substituted or unsubstituted alkynyl, a substituted or

unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or R and R' taken together with the N atom to which they are attached complete a heterocycle having from 3 to 14 atoms in the ring structure; R''' represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. In some forms, when E is oxygen, a carbamate is formed. It is understood by those of ordinary skill in the art, that the E groups listed above are divalent (e.g., methylene, ethane-1,2-diyl, ethene-1,2-diyl, 1,4-phenylene, cyclohexane-1,2-diyl).

"Carbonyl," as used herein, is art-recognized and includes such moieties as can be represented by the general formula:

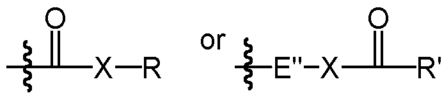

wherein X is a bond, or represents an oxygen or a sulfur, and R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R''$, or a pharmaceutical acceptable salt; E" is absent, or E" is a substituted or unsubstituted alkyl, a substituted or unsubstituted alkenyl, a substituted or unsubstituted alkynyl, a substituted or unsubstituted aralkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl; R' represents a hydrogen, a substituted or unsubstituted alkyl, a substituted or unsubstituted alkenyl, a substituted or unsubstituted alkynyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R''$; R" represents a hydroxyl group, a substituted orunsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphonium, phosphanyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, and combinations thereof. It is understood by those of ordinary skill in the art, that the E" groups listed above are divalent (e.g., methylene, ethane-1,2-diyl, ethene-1,2-diyl, 1,4-phenylene, cyclohexane-1,2-diyl). Where X is oxygen and R is defined as above, the moiety is also referred to as a carboxyl group. When X is oxygen and R is hydrogen, the formula represents a "carboxylic acid." Where X is oxygen and R' is hydrogen, the formula represents a "formate." Where X is oxygen and R or R' is not hydrogen, the formula represents an "ester." In general, where the oxygen atom of the above formula is replaced by a sulfur atom, the formula represents a "thiocarbonyl" group. Where X is sulfur and R or R' is not hydrogen, the formula represents a "thioester." Where X is sulfur and R is hydrogen, the formula represents a "thiocarboxylic acid." Where X is sulfur and R' is hydrogen, the formula represents a "thioformate." Where X is a bond and R is not hydrogen, the above formula represents a "ketone." Where X is a bond and R is hydrogen, the above formula represents an "aldehyde."

The term "phosphanyl" is represented by the formula

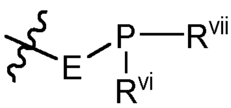

wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted cycloalkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, $R^{vi}$ and $R^{vii}$ each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or $R^{vi}$ and $R^{vii}$ taken together with the P atom to which they are attached complete a heterocycle having from 3 to 14 atoms in the ring structure; $R'''$ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphonium" is represented by the formula

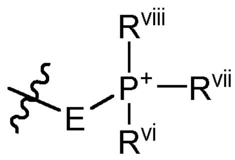

wherein, E is absent, or E is a substituted or unsubstituted alkyl, a substituted or unsubstituted alkenyl, a substituted or unsubstituted alkynyl, a substituted or unsubstituted aralkyl, a substituted or unsubstituted cycloalkyl, a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, $R^{vi}$, $R^{vii}$, and $R^{viii}$ each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or R°’, $R^{vii}$, and $R^{viii}$ taken together with the $P^+$ atom to which they are attached complete a heterocycle having from 3 to 14 atoms in the ring structure; $R'''$ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphonyl" is represented by the formula

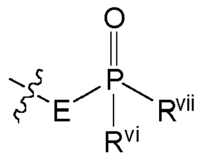

wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, oxygen, alkoxy, aroxy, or substituted alkoxy or substituted aroxy, wherein, independently of E, $R^{vi}$ and $R^{vii}$ are independently a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a sulfinyl, a silyl, a thiol, an amido, an amino, or $-(CH_2)_m-R'''$, or $R^{vi}$ and $R^{vii}$ taken together with the P atom to which they are attached complete a heterocycle having from 3 to 14 atoms in the ring structure; $R'''$ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "phosphoryl" defines a phosphonyl in which E is absent, oxygen, alkoxy, aroxy, substituted alkoxy or substituted aroxy, as defined above, and independently of E, $R^{vi}$ and $R^{vii}$ are independently hydroxyl, alkoxy, aroxy, substituted alkoxy or substituted aroxy, as defined above. When E is oxygen, the phosphoryl cannot be attached to another chemical species, such as to form an oxygen-oxygen bond, or other unstable bonds, as understood by one of ordinary skill in the art. When E, $R^{vi}$ and $R^{vii}$ are substituted, the substituents include, but are not limited to, halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfinyl" is represented by the formula

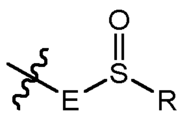

wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted heterocyclyl, a substituted or unsubstituted polyaryl, a substituted or unsubstituted polyheteroaryl, wherein independently of E, R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, a phosphonyl, a silyl, a thiol, an amido, an amino, or $-(CH_2)_m-R'''$, or E and R taken together with the S atom to which they are attached complete a heterocycle having from 3 to 14 atoms in the ring structure; $R'''$ represents

a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonyl" is represented by the formula

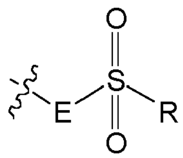

wherein E is absent, or E is a substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted arylalkyl, etc.), a substituted or unsubstituted aryl, a substituted or unsubstituted heteroaryl, a substituted or unsubstituted heterocyclyl, a substituted or unsubstituted polyaryl, a substituted or unsubstituted polyheteroaryl, wherein independently of E, R represents a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R'''$, or E and R taken together with the S atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonic acid" refers to a sulfonyl, as defined above, wherein R is hydroxyl, and E is absent, or E is substituted or unsubstituted cycloalkyl, substituted or unsubstituted heterocyclyl, substituted or unsubstituted alkylaryl, substituted or unsubstituted arylalkyl, substituted or unsubstituted aryl, a substituted or unsubstituted polyaryl, a substituted or unsubstituted polyheteroaryl, or substituted or unsubstituted heteroaryl. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfate" refers to a sulfonyl, as defined above, wherein E is absent, oxygen, alkoxy, aroxy, substituted alkoxy or substituted aroxy, as defined above, and R is independently hydroxyl, alkoxy, aroxy, substituted alkoxy or substituted aroxy, as defined above. When E is oxygen, the sulfate cannot be attached to another chemical species, such as to form an oxygen-oxygen bond, or other unstable bonds, as understood by one of ordinary skill in the art. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a

thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfonate" refers to a sulfonyl, as defined above, wherein E is oxygen, alkoxy, aroxy, substituted alkoxy or substituted aroxy, as defined above, and R is independently hydrogen, substituted or unsubstituted alkyl, substituted or unsubstituted alkenyl, substituted or unsubstituted alkynyl, substituted or unsubstituted amino, substituted or unsubstituted cycloalkyl, substituted or unsubstituted heterocyclyl, substituted or unsubstituted aralkyl, substituted or unsubstituted alkylaryl, substituted or unsubstituted arylalkyl, substituted or unsubstituted aryl, substituted or unsubstituted heteroaryl, a substituted or unsubstituted polyaryl, a substituted or unsubstituted polyheteroaryl, $-(CH_2)_m-R'''$, R‴ represents a hydroxy group, substituted or unsubstituted carbonyl group, an aryl, a cycloalkyl ring, a cycloalkenyl ring, a heterocycle, an amido, an amino, or a polycycle; and m is zero or an integer ranging from 1 to 8. When E is oxygen, sulfonate cannot be attached to another chemical species, such as to form an oxygen-oxygen bond, or other unstable bonds, as understood by one of ordinary skill in the art. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "sulfamoyl" refers to a sulfonamide or sulfonamide represented by the formula

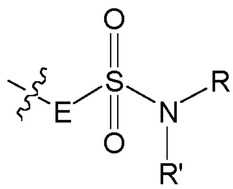

wherein E is absent, or E is substituted or unsubstituted alkyl, a substituted or unsubstituted alkenyl, a substituted or unsubstituted alkynyl, a substituted or unsubstituted aralkyl (e.g., a substituted or unsubstituted alkylaryl, a substituted or unsubstituted cycloalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, wherein independently of E, R and R’ each independently represent a hydrogen, a substituted or unsubstituted alkyl, a substituted or unsubstituted alkenyl, a substituted or unsubstituted alkynyl, a substituted or unsubstituted carbonyl, a substituted or unsubstituted heterocyclyl, a substituted or unsubstituted aralkyl (e.g. a substituted or unsubstituted alkylaryl, a substituted or unsubstituted arylalkyl, etc.), a substituted or unsubstituted aryl, a substituted or unsubstituted heteroaryl, a substituted or unsubstituted polyaryl, a substituted or unsubstituted polyheteroaryl, a substituted or unsubstituted heterocyclyl, a hydroxyl, an alkoxy, a phosphonium, a phosphanyl, an amido, an amino, or $-(CH_2)_m-R'''$, or R and R’ taken together with the N atom to which they are attached complete a heterocycle having from 3 to 14 atoms in the ring structure; R‴ represents a hydroxyl group, a substituted or unsubstituted carbonyl group, a substituted or unsubstituted aryl, a substituted or unsubstituted cycloalkyl, a substituted or unsubstituted cycloalkenyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, an alkoxy, a phosphonium, a phosphanyl, an amido, or an amino; and m is zero or an integer ranging from 1 to 8. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof. It is understood by those of ordinary skill in the art, that the E groups listed above are divalent (e.g., methylene, ethane-1,2-diyl, ethene-1,2-diyl, 1,4-phenylene, cyclohexane-1,2-diyl).

The term "silyl group" as used herein is represented by the formula -SiRR’R," where R, R’, and R" can be, independently, a hydrogen, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl (e.g. a substituted or unsubstituted alkylaryl, a substituted or unsubstituted arylalkyl, etc.), a substituted or unsubstituted polyaryl, a substituted or unsubstituted polyheteroaryl, a substituted or unsubstituted carbonyl, a phosphonium, a phosphanyl, a phosphonyl, a sulfinyl, a thiol, an amido, an amino,

an alkoxy, or an oxo, described above. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof.

The terms "thiol" are used interchangeably and are represented by -SR, where R can be a hydrogen, a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted aralkyl (e.g. a substituted or unsubstituted alkylaryl, a substituted or unsubstituted arylalkyl, etc.), a substituted or unsubstituted polyaryl, a substituted or unsubstituted polyheteroaryl, a substituted or unsubstituted carbonyl, a phosphonium, a phosphanyl, an amido, an amino, an alkoxy, an oxo, a phosphonyl, a sulfinyl, or a silyl, described above. Such substituents can be any substituents described above, e.g., halogen, azide, alkyl, aralkyl, alkenyl, alkynyl, cycloalkyl, hydroxyl, carbonyl (such as a carboxyl, alkoxycarbonyl, formyl, or an acyl), silyl, ether, ester, thiocarbonyl (such as a thioester, a thioacetate, or a thioformate), alkoxyl, phosphoryl, phosphate, phosphonate, phosphinate, amino (e.g. quarternized amino), amido, amidine, imine, cyano, nitro, azido, sulfhydryl, alkylthio, sulfate, sulfonate, sulfamoyl, sulfonamido, sulfonyl, heterocyclyl, alkylaryl, haloalkyl, aryl, heteroaryl, polyaryl, polyheteroaryl, and combinations thereof.

The disclosed compounds and substituent groups, can, independently, possess two or more of the groups listed above. For example, if the compound or substituent group is a straight chain alkyl group, one of the hydrogen atoms of the alkyl group can be substituted with a hydroxyl group, an alkoxy group, etc. Depending upon the groups that are selected, a first group can be incorporated within second group or, alternatively, the first group can be pendant *(i.e.,* attached) to the second group. For example, with the phrase "an alkyl group comprising an ester group," the ester group can be incorporated within the backbone of the alkyl group. Alternatively, the ester can be attached to the backbone of the alkyl group. The nature of the group(s) that is (are) selected will determine if the first group is embedded or attached to the second group.

The compounds and substituents can be substituted, independently, with the substituents described above in the definition of "substituted."

The numerical ranges disclose individually each possible number that such a range could reasonably encompass, as well as any sub-ranges and combinations of sub-ranges encompassed therein. For example, in a given range carbon range of $C_3$-$C_9$, the range also discloses $C_3$, $C_4$, $C_5$, $C_6$, $C_7$, $C_8$, and $C_9$, as well as any subrange between these numbers (for example, $C_4$ -$C_6$), and any possible combination of ranges possible between these values. In yet another example, a given temperature range may be from about 25 °C to 30 °C, where the range also discloses temperatures that can be selected independently from about 25, 26, 27, 28, 29, and 30 °C, as well as any range between these numbers (for example, 26 to 28 °C), and any possible combination of ranges between these values.

Use of the term "about" is intended to describe values either above or below the stated value, which the term "about" modifies, to be within a range of approximately +/-10%. When the term "about" is used before a range of numbers *(i.e.,* about 1-5) or before a series of numbers *(i.e.,* about 1, 2, 3, 4, etc.) it is intended to modify both ends of the range of numbers and/or each of the numbers recited in the entire series, unless specified otherwise.

The disclosed compounds and substituent groups, can, independently, possess two or more of the groups listed above. For example, if the compound or substituent group is a straight chain alkyl group, one of the hydrogen atoms of the alkyl group can be substituted with a hydroxyl group, an alkoxy group, etc. Depending upon the groups that are selected, a first group can be incorporated within second group or, alternatively, the first group can be pendant *(i.e.,* attached) to the second group. For example, with the phrase "an alkyl group comprising an ester group," the ester group can be incorporated within the backbone of the alkyl group. Alternatively, the ester can be attached to the backbone of the alkyl group. The nature of the group(s) that is (are) selected will determine if the first group is embedded or attached to the second group.

The compounds and substituents can be substituted with, independently, with the substituents described above in the definition of "substituted."

## II. Compositions

Described are a class of dinuclear cyclometalated platinum(II) carbene complexes containing 2-oxy-pyridine (N^O) bridging ligands as red or NIR emitters (also referred herein as "dinuclear platinum(II) emitters"). Without being bound to theories, it is believed that the molecular system of the N^O bridging ligands of the disclosed compounds allows strong metal-metal interactions between two platinum(II) metal centers in a paddle-wheel structure, which gives rise to low-energy MMLCT excited states. Additionally, it is believed that the imidazolyl N-heterocyclic carbene ring contributes to the high emission quantum yield of the disclosed binuclear platinum(II) emitters. It is believed that the combination of the 2-oxy-pyridine (N^O) bridging ligands and imidazolyl N-heterocyclic carbene ring allows for stable red/NIR emitters with high emission quantum yield. The disclosed dinuclear platinum(II) emitters show red to deep-red or NIR photoluminescence ($\lambda_{max}$ at 600-1000 nm, such as 612-685 nm) with a high emission quantum yield (i.e. $\Phi_{em} \geq 0.60$ measured in thin films, such as about 0.78 or about 0.97), a short emission lifetime (i.e. $\tau_{em} \leq 2.5$ μs, such as 1.7-1.9 μs), a fast radiative decay rate (i.e. $k_r \geq 4.5\times10^5$ $s^{-1}$, such as about $4.3\times10^5$ $s^{-1}$ or about $5.5\times10^5$ $s^{-1}$), and/or a slow non-radiative decay rate (i.e. $k_{nr} \leq 6\times10^5$ $s^{-1}$, such as $0.16\times10^5$-$6\times10^5$ $s^{-1}$ or $0.16\times10^5$-$1.4\times10^5$ $s^{-1}$), at room temperature.

Organic light-emitting components, such as light-emitting diodes (OLEDs), containing the dinuclear platinum(II) emitters disclosed herein are also described. The Examples below demonstrated that doped OLEDs containing exemplary dinuclear platinum(II) emitters disclosed herein show electroluminescence spanning from red to NIR spectral region ($\lambda_{max}$ at 622-706 nm) with an external quantum efficiencies (EQE) of 9.1-15.8%, at 1000 cd $m^{-2}$.

**A. Dinuclear Platinum(II) Complexes**

The disclosed dinuclear platinum(II) complexes can have the structure of Formula I':

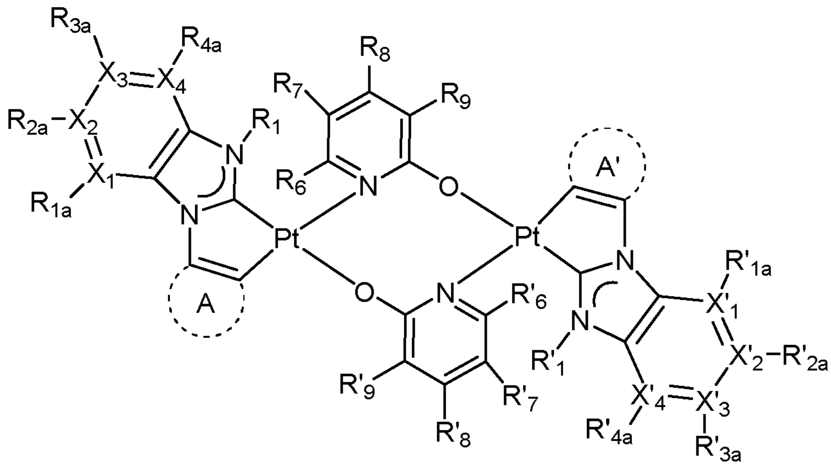

Formula I'

where: (i) the complex can have an overall neutral, negative, or positive charge; (ii) $X_1$-$X_4$ and $X'_1$-$X'_4$ can be independently carbon, nitrogen, sulfur, or oxygen; (iii) $R_{1a}$-$R_{4a}$, $R'_{1a}$-$R'_{4a}$, $R_1$, $R'_1$, $R_6$-$R_9$, and $R'_6$-$R'_9$ can be independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, unsubstituted $C_2$-$C_{20}$ heterocyclyl, borenium cation, phosphonyl, sulfinyl, or sulfonyl, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, fused combinations thereof, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof; (iv) A and A' can be independently a substituted cycloalkyl, an unsubstituted cycloalkyl, a substituted cycloalkenyl, an unsubstituted cycloalkenyl, a substituted cycloalkynyl, an unsubstituted cycloalkynyl, a substituted heterocyclyl, an unsubstituted heterocyclyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, or fused combinations thereof, preferably A and A' are independently a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an

unsubstituted heterocyclyl, or fused combinations thereof; and (v) each substituent can be independently a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a carbonyl, an alkoxy, a halogen, a hydroxyl, a phenoxy, a thiol, an alkylthio, a phenylthio, an arylthio, a cyano, an isocyano, a nitro, a carboxyl, an amino, an amido, an oxo, a silyl, a sulfinyl, a sulfonyl, a sulfonic acid, a phosphonium, a phosphanyl, a phosphoryl, or a phosphonyl.

In some forms, the disclosed binuclear platinum (II) complexes can have the structure of Formula I:

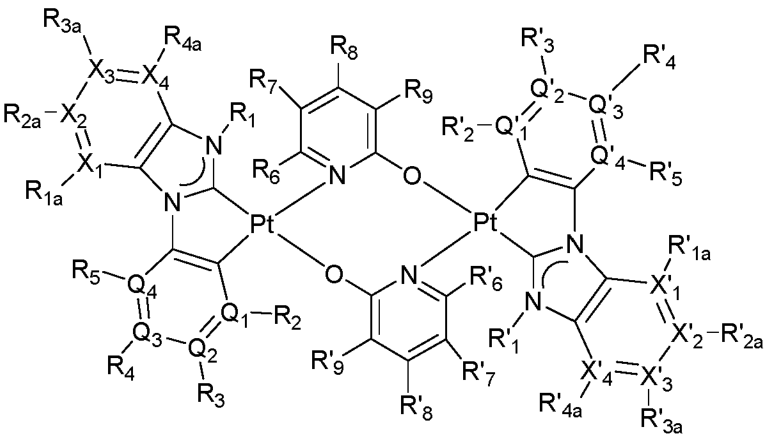

Formula I

where: (i) the complex can have an overall neutral, negative, or positive charge; (ii) $X_1$-$X_4$, $X'_1$-$X'_4$, $R_{1a}$-$R_{4a}$, $R'_{1a}$-$R'_{4a}$, $R_1$, $R'_1$, $R_6$-$R_9$, and $R'_6$-$R'_9$ can be as defined above for Formula I'; (iii) $Q_1$-$Q_4$ and $Q'_1$-$Q'_4$ can be independently carbon, nitrogen, sulfur, or oxygen; (iv) $R_2$-$R_5$ and $R'_2$-$R'_5$ can be independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, unsubstituted $C_2$-$C_{20}$ heterocyclyl, borenium cation, phosphonyl, sulfinyl, or sulfonyl, or $R_2$ and $R_3$ together, $R_3$ and $R_4$ together, $R_4$ and $R_5$ together, $R'_2$ and $R'_3$ together, $R'_3$ and $R'_4$ together, and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, fused combinations thereof, or $R_2$ and $R_3$ together, $R_3$ and $R_4$ together, $R_4$ and $R_5$ together, $R'_2$ and $R'_3$ together, $R'_3$ and $R'_4$ together, and/or $R'_4$ and $R'_5$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof; and (v) each substituent can be as defined above for Formula I'.

In some forms, the disclosed binuclear platinum (II) complexes can have the structure of Formula Ia:

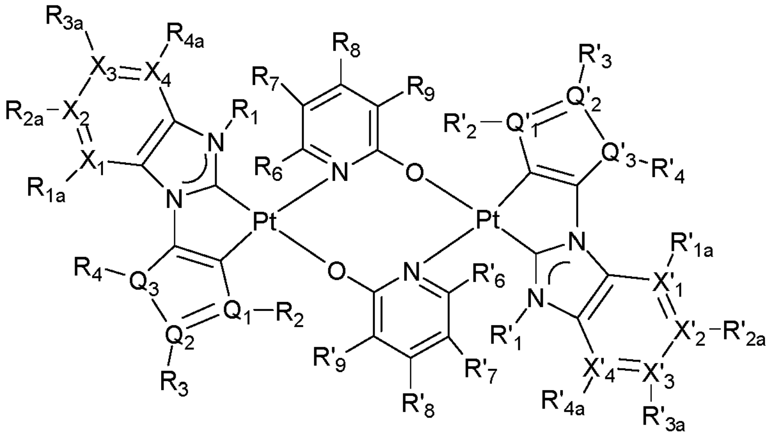

Formula Ia

where: the complex can have an overall neutral, negative, or positive charge; and $X_1$-$X_4$, $X'_1$-$X'_4$, $Q_1$-$Q_3$, $Q'_1$-$Q'_3$, $R_{1a}$-$R_{4a}$, $R'_{1a}$-$R'_{4a}$, $R_1$-$R_4$, $R_6$-$R_9$, $R'_1$-$R'_4$, and $R'_6$-$R'_9$ can be as defined above for Formula I. In some forms of Formula Ia, $Q_1$-$Q_3$ and $Q'_1$-$Q'_3$ can be independently carbon, oxygen, or sulfur.

In some forms, the disclosed dinuclear platinum(II) complexes can have the structure of Formula II:

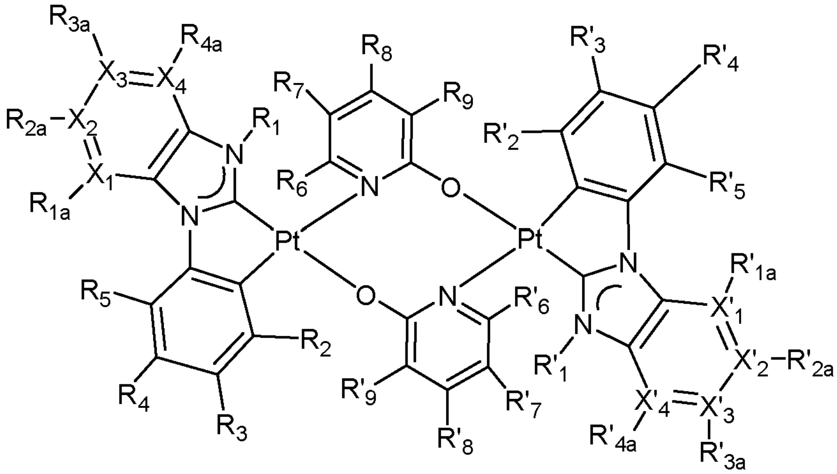

Formula II

where the complex can have an overall neutral, negative, or positive charge; and $X_1$-$X_4$, $X'_1$-$X'_4$, $R_{1a}$-$R_{4a}$, $R'_{1a}$-$R'_{4a}$, $R_1$-$R_9$, $R'_1$-$R'_9$, and the substituents can be as defined above for Formula I.

In some forms, the disclosed binuclear platinum (II) complexes can have the structure of Formula IIa:

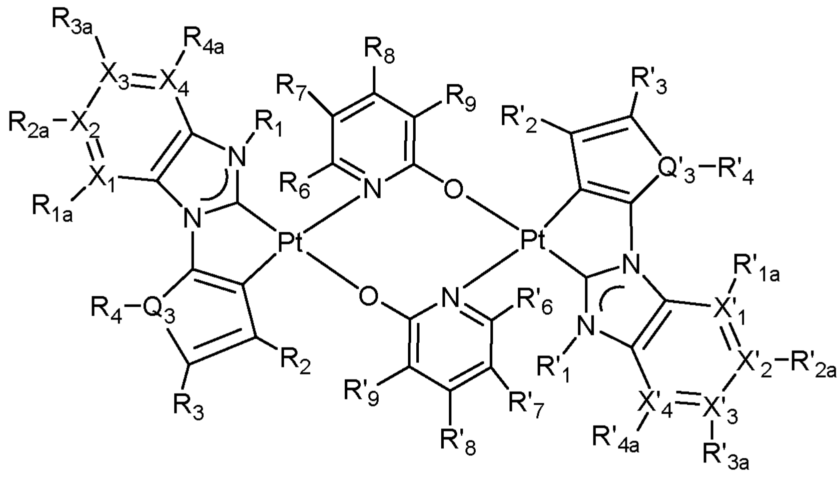

Formula IIa

where: the complex can have an overall neutral, negative, or positive charge; and $X_1$-$X_4$, $X'_1$-$X'_4$, $Q_3$, $Q'_3$, $R_{1a}$-$R_{4a}$, $R'_{1a}$-$R'_{4a}$, $R_1$-$R_4$, $R_6$-$R_9$, $R'_1$-$R'_4$, and $R'_6$-$R'_9$ can be as defined above for Formula I.

In some forms, the disclosed dinuclear platinum(II) complexes can have the structure of Formula III:

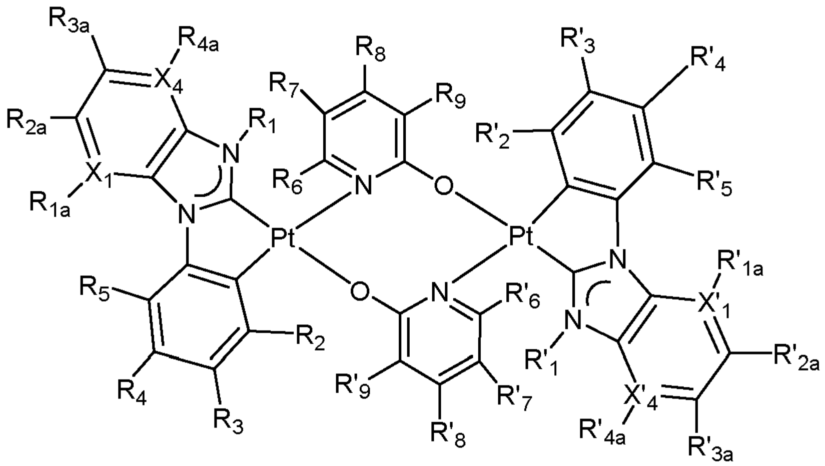

Formula III

where the complex can have an overall neutral, negative, or positive charge; and $X_1$, $X_4$, $X'_1$, $X'_4$ $R_{1a}$-$R_{4a}$, $R'_{1a}$-$R'_{4a}$, $R_1$-$R_9$, $R'_1$-$R'_9$, and the substituents can be as defined above for Formula I.

In some forms, the disclosed dinuclear platinum(II) complexes can have the structure of Formula IIIa:

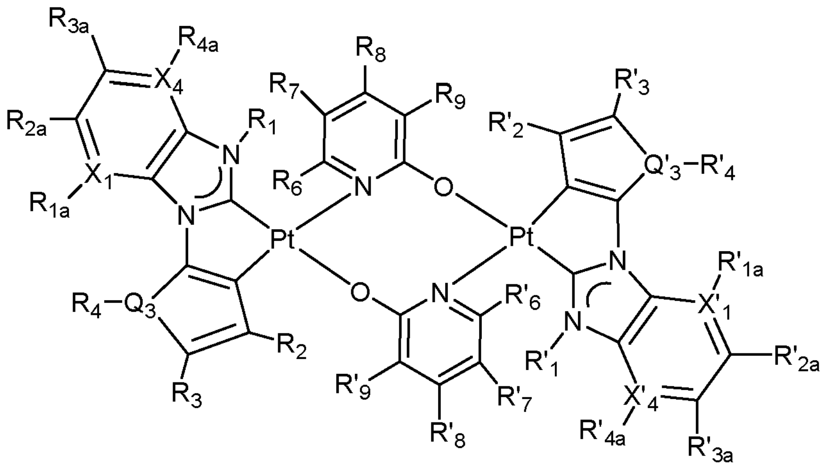

Formula IIIa

where: the complex can have an overall neutral, negative, or positive charge; and $X_1$-$X_4$, $X'_1$-$X'_4$, $Q_3$, $Q'_3$, $R_{1a}$-$R_{4a}$, $R'_{1a}$-$R'_{4a}$, $R_1$-$R_4$, $R_6$-$R_9$, $R'_1$-$R'_4$, and $R'_6$-$R'_9$ can be as defined above for Formula I.

In some forms of Formulae III and/or IIIa, $X_1$, $X_4$, $X'_1$, and $X'_4$ can be carbon. In some forms of Formula III and/or IIIa, $X_1$, $X_4$, $X'_1$, and $X'_4$ can be carbon; and $R_{1a}$-$R_{4a}$ and $R'_{1a}$-$R'_{4a}$ can be as defined above for Formula I, such as independently hydrogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), or alkoxy (e.g., -O-alkyl, -O-aryl, -O-polyaryl, etc.), or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, and/or $R'_{3a}$ and $R'_{4a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl. For example, $X_1$, $X_4$, $X'_1$, and $X'_4$ are carbon; and $R_{1a}$-$R_{4a}$ and $R'_{1a}$-$R'_{4a}$ are as defined above for Formula I, such as independently hydrogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), or alkoxy (e.g., -O-alkyl, -O-aryl, -O-polyaryl, etc.), or $R_{1a}$ and $R_{2a}$ together, $R_{3a}$ and $R_{4a}$ together, $R'_{1a}$ and $R'_{2a}$ together, and/or $R'_{3a}$ and $R'_{4a}$ together, with the atom to which they are attached, form a substituted aryl or unsubstituted aryl.

In some forms of Formulae III and/or IIIa, $X_1$, $X_4$, $X'_1$, and $X'_4$ are nitrogen; and $R_{2a}$ and $R_{3a}$ together and/or $R'_{2a}$ and $R'_{3a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl.

In some forms, the disclosed dinuclear platinum(II) complexes can have the structure of Formula IV:

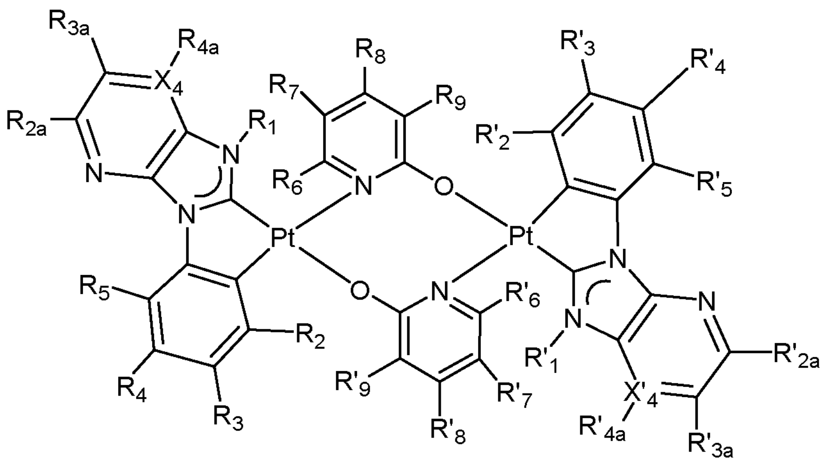

Formula IV

where the complex can have an overall neutral, negative, or positive charge; and $X_4$, $X'_4$ $R_{2a}$-$R_{4a}$, $R'_{2a}$-$R'_{4a}$, $R_1$-$R_9$,

$R'_1$-$R'_9$, and the substituents can be as defined above for Formula I.

In some forms, the disclosed dinuclear platinum(II) complexes can have the structure of Formula IVa:

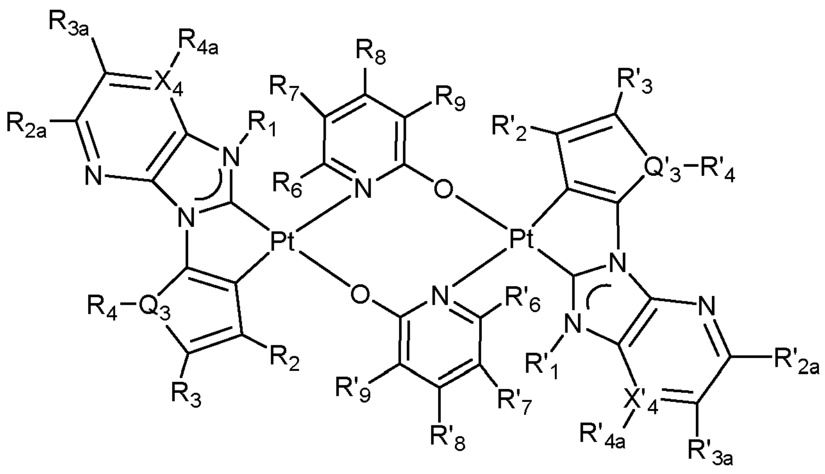

Formula IVa

where: the complex can have an overall neutral, negative, or positive charge; and $X_4$, $X'_4$, $Q_3$, $Q'_3$, $R_{2a}$-$R_{4a}$, $R'_{2a}$-$R'_{4a}$, $R_1$-$R_4$, $R_6$-$R_9$, $R'_1$-$R'_4$, and $R'_6$-$R'_9$ can be as defined above for Formula I.

In some forms of Formulae IV and/or IVa, $R_{2a}$ and $R_{3a}$ together, $R_{3a}$ and $R_{4a}$ together, $R'_{2a}$ and $R'_{3a}$ together, and/or $R'_{3a}$ and $R'_{4a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl.

In some forms of Formula IV, $X_4$ and/or $X'_4$ is nitrogen and $R_{4a}$ and/or $R'_{4a}$ is absent. In some forms of Formula IVa, $X_4$ and/or $X'_4$ is nitrogen and $R_{4a}$ and/or $R'_{4a}$ is absent. In some forms of Formulae IV and/or IVa, $X_4$ and $X'_4$ are nitrogen and $R_{4a}$ and $R'_{4a}$ are absent, and $R_{2a}$, $R_{3a}$, $R'_{2a}$, and $R'_{3a}$ can be hydrogen or $R_{2a}$ and $R_{3a}$ together and/or $R'_{2a}$ and $R'_{3a}$ together, with the atom to which they are attached, form a substituted aryl or unsubstituted aryl.

In some forms of Formulae IV and/or IVa, $X_4$ and/or $X'_4$ is carbon, and $R_{2a}$-$R_{4a}$ and/or $R'_{2a}$-$R'_{4a}$ is as defined above for Formula I, such as independently hydrogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), or alkoxy (e.g., -O-alkyl, -O-aryl, -O-polyaryl, etc.), or $R_{2a}$ and $R_{3a}$ together, $R_{3a}$ and $R_{4a}$ together, $R'_{2a}$ and $R'_{3a}$ together, and/or $R'_{3a}$ and $R'_{4a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl.

In some forms, for any one of Formulae I-IV, $R_4$ and $R_5$ together and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, or an unsubstituted heterocyclyl, such as a substituted aryl, an unsubstituted aryl, a substituted heteroaryl, or an unsubstituted heteroaryl.

In some forms, for any one of Formulae I-IV, $R_3$ and $R_4$ together and/or $R'_3$ and $R'_4$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, or an unsubstituted heterocyclyl, such as a substituted aryl, an unsubstituted aryl, a substituted heteroaryl, or an unsubstituted heteroaryl.

In some forms, for any one of Formulae I-IV, $R_2$ and $R_3$ together and/or $R'_2$ and $R'_3$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, or an unsubstituted heterocyclyl, such as a substituted aryl, an unsubstituted aryl, a substituted heteroaryl, or an unsubstituted heteroaryl.

In some forms, for any one of Formulae I-IV, $R_4$ and $R_5$ together and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, or an unsubstituted heteroaryl. In some forms, for any one of Formulae I-IV, $R_4$ and $R_5$ together and/or $R'_4$ and $R'_5$ together is(are)

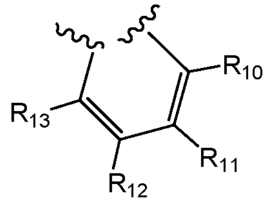
or
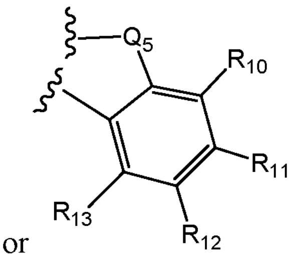
,

wherein $Q_5$ can be $NR_{14}$, $CR_{16}R_{17}$, sulfur, or oxygen; and $R_{10}$-$R_{14}$, $R_{16}$ and $R_{17}$ can be independently absent, hydrogen, substituted alkyl, unsubstituted alkyl (e.g., methyl, ethyl, n-propyl, iso-propyl, n-butyl, iso-butyl, tert-butyl, etc.), substituted alkenyl, unsubstituted alkenyl, substituted alkynyl, unsubstituted alkynyl, substituted aryl (e.g., substituted phenyl), unsubstituted aryl (e.g., unsubstituted phenyl), halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl. In some forms, $Q_5$ can be $NR_{14}$, sulfur, or oxygen; and $R_{10}$-$R_{14}$ can be independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl. In some forms, $Q_5$ can be $CR_{16}R_{17}$; and $R_{16}$ and $R_{17}$ can be independently hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen or unsubstituted alkyl (e.g., methyl, ethyl, n-propyl, iso-propyl, n-butyl, iso-butyl, tert-butyl, etc.). In some forms, $Q_5$ can be oxygen; and $R_{10}$-$R_{14}$ can be hydrogen. In some forms, $Q_5$ can be sulfur; and $R_{10}$-$R_{14}$ can be hydrogen.

In some forms, for any one of Formulae I-IV, $R_3$ and $R_4$ together and/or $R'_3$ and $R'_4$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, or an unsubstituted heteroaryl. In some forms, for any one of Formulae I-IV, $R_3$ and $R_4$ together and/or $R'_3$ and $R'_4$ together is(are)

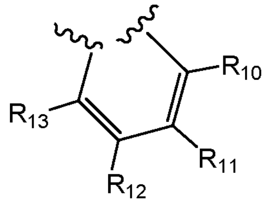
or
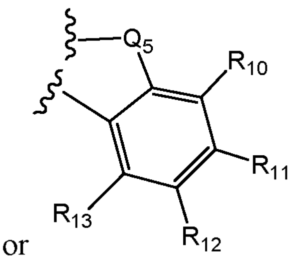
,

wherein $Q_5$ can be $NR_{14}$, $CR_{16}R_{17}$, sulfur, or oxygen; $R_{10}$-$R_{14}$, $R_{16}$ and $R_{17}$ can be independently absent, hydrogen, substituted alkyl, unsubstituted alkyl (e.g., methyl, ethyl, n-propyl, iso-propyl, n-butyl, iso-butyl, tert-butyl, etc.), substituted alkenyl, unsubstituted alkenyl, substituted alkynyl, unsubstituted alkynyl, substituted aryl (e.g., substituted phenyl), unsubstituted aryl (e.g., unsubstituted phenyl), halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl. In some forms, $Q_5$ can be $NR_{14}$, sulfur or oxygen; and $R_{10}$-$R_{14}$ can be independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl. In some forms, $Q_5$ can be $CR_{16}R_{17}$; and $R_{16}$ and $R_{17}$ can be independently hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen or unsubstituted alkyl (e.g., methyl, ethyl, n-propyl, iso-propyl, n-butyl, iso-butyl, tert-butyl, etc.). In some forms, $Q_5$ can be oxygen; and $R_{10}$-$R_{14}$ can be hydrogen. In some forms, $Q_5$ can be sulfur; and $R_{10}$-$R_{14}$ can be

hydrogen.

In some forms, for any one of Formulae I-IV, $R_2$ and $R_3$ together and/or $R'_2$ and $R'_3$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, or an unsubstituted heteroaryl. In some forms, for any one of Formulae I-IV, $R_2$ and $R_3$ together and/or $R'_2$ and $R'_3$ together is(are)

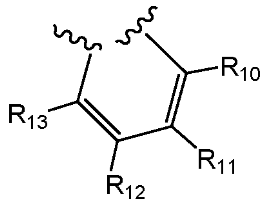
or
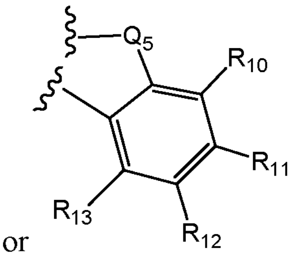
,

wherein $Q_5$ can be $NR_{14}$, $CR_{16}R_{17}$, sulfur, or oxygen; $R_{10}$-$R_{14}$, $R_{16}$ and $R_{17}$ can be independently absent, hydrogen, substituted alkyl, unsubstituted alkyl (e.g., methyl, ethyl, n-propyl, iso-propyl, n-butyl, iso-butyl, tert-butyl, etc.), substituted alkenyl, unsubstituted alkenyl, substituted alkynyl, unsubstituted alkynyl, substituted aryl (e.g., substituted phenyl), unsubstituted aryl (e.g., unsubstituted phenyl), halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl. In some forms, $Q_5$ can be $NR_{14}$, sulfur, or oxygen; and $R_{10}$-$R_{14}$ can be independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl. In some forms, $Q_5$ can be $CR_{16}R_{17}$; and $R_{16}$ and $R_{17}$ can be independently hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen or unsubstituted alkyl (e.g., methyl, ethyl, n-propyl, iso-propyl, n-butyl, iso-butyl, tert-butyl, etc.). In some forms, $Q_5$ can be oxygen; and $R_{10}$-$R_{14}$ can be hydrogen. In some forms, $Q_5$ can be sulfur; and $R_{10}$-$R_{14}$ can be hydrogen.

In some forms, for any one of Formulae I-IV, at least one of $R_2$-$R_5$ and at least one of $R'_2$-$R'_5$, such as one or two of $R_2$-$R_5$ and/or one or two of $R'_2$-$R'_5$, can be independently halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., $-B(Mes)_2$), or phosphonyl (e.g., $-P(=O)(Ph)_2$, $-P(=O)(alkyl)_2$, etc.).

In some forms, for any one of Formulae Ia-IVa, at least one of $R_2$-$R_4$ and at least one of $R'_2$-$R'_4$, such as one of $R_2$-$R_4$ and/or one of $R'_2$-$R'_4$, can be independently halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., - $B(Mes)_2$), phosphonyl (e.g., $-P(=O)(Ph)_2$, $-P(=O)(alkyl)_2$, etc.), and the heteroaryl described above.

In some forms, for any one of Formulae Ia-IVa, $R_2$ and $R_3$ together and/or $R'_2$ and $R'_3$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, or an unsubstituted heterocyclyl, such as a substituted aryl, an unsubstituted aryl, a substituted heteroaryl, or an unsubstituted heteroaryl.

In some forms, for any one of Formulae Ia-IVa, $R_3$ and $R_4$ together and/or $R'_3$ and $R'_4$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, or an unsubstituted heterocyclyl, such as a substituted aryl, an unsubstituted aryl, a substituted heteroaryl, or an unsubstituted heteroaryl.

In some forms, for any one of Formulae Ia-IVa, $R_2$ and $R_3$ together and/or $R'_2$ and $R'_3$ together, with the atom to which they are attached, form a substituted cycloalkyl, an unsubstituted cycloalkyl, a substituted cycloalkenyl, an unsubstituted cycloalkenyl, a substituted aryl, an unsubstituted aryl, a substituted heteroaryl, an unsubstituted heteroaryl, a substituted heterocyclyl, or an unsubstituted heterocyclyl. In some forms, for any one of Formulae Ia-IVa, $R_2$ and $R_3$

together and/or $R'_2$ and $R'_3$ together is(are)

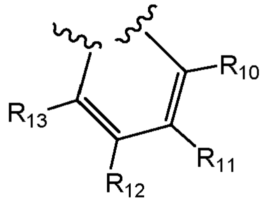

or

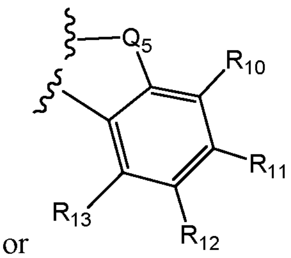

,

wherein $Q_5$ can be $NR_{14}$, $CR_{16}R_{17}$, or sulfur, or oxygen; $R_{10}$-$R_{14}$, $R_{16}$, and $R_{17}$ can be independently absent, hydrogen, substituted alkyl, unsubstituted alkyl (e.g., methyl, ethyl, n-propyl, iso-propyl, n-butyl, iso-butyl, tert-butyl, etc.), substituted alkenyl, unsubstituted alkenyl, substituted alkynyl, unsubstituted alkynyl, substituted aryl (e.g., substituted phenyl), unsubstituted aryl (e.g., unsubstituted phenyl), halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl. In some forms, $Q_5$ can be $NR_{14}$, sulfur, or oxygen; and $R_{10}$-$R_{14}$ can be independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl. In some forms, $Q_5$ can be $CR_{16}R_{17}$; and $R_{16}$ and $R_{17}$ can be independently hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen or unsubstituted alkyl (e.g., methyl, ethyl, n-propyl, iso-propyl, n-butyl, iso-butyl, tert-butyl, etc.). In some forms, $Q_5$ can be oxygen; and $R_{10}$-$R_{14}$ can be hydrogen. In some forms, $Q_5$ can be sulfur; and $R_{10}$-$R_{14}$ can be hydrogen.

In some forms, for any one of Formulae Ia-IVa, $R_3$ and $R_4$ together and/or $R'_3$ and $R'_4$ together, with the atom to which they are attached, form a substituted cycloalkyl, an unsubstituted cycloalkyl, a substituted cycloalkenyl, an unsubstituted cycloalkenyl, a substituted aryl, an unsubstituted aryl, a substituted heteroaryl, an unsubstituted heteroaryl, a substituted heterocyclyl, or an unsubstituted heterocyclyl. In some forms, for any one of Formulae Ia-IVa, $R_3$ and $R_4$ together and/or $R'_3$ and $R'_4$ together is(are)

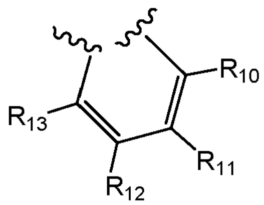

or

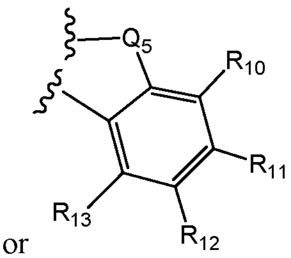

,

wherein $Q_5$ can be $NR_{14}$, $CR_{16}R_{17}$, or sulfur, or oxygen; $R_{10}$-$R_{14}$, $R_{16}$, and $R_{17}$ can be independently absent, hydrogen, substituted alkyl, unsubstituted alkyl (e.g., methyl, ethyl, n-propyl, iso-propyl, n-butyl, iso-butyl, tert-butyl, etc.), substituted alkenyl, unsubstituted alkenyl, substituted alkynyl, unsubstituted alkynyl, substituted aryl (e.g., substituted phenyl), unsubstituted aryl (e.g., unsubstituted phenyl), halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl. In some forms, $Q_5$ can be $NR_{14}$, sulfur, or oxygen; and $R_{10}$-$R_{14}$ can be independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl. In some forms, $Q_5$ can be $CR_{16}R_{17}$; and $R_{16}$ and $R_{17}$ can be independently hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen or unsubstituted alkyl (e.g., methyl, ethyl, n-propyl, iso-propyl, n-butyl, iso-butyl, tert-butyl, etc.). In some forms, $Q_5$ can be oxygen; and $R_{10}$-$R_{14}$ can be hydrogen. In some forms, $Q_5$ can be sulfur; and $R_{10}$-$R_{14}$ can be hydrogen.

In some forms, for any one of Formulae Ia-IVa, $Q_3$ and $Q'_3$ can be sulfur or oxygen. In some forms, for any one of Formulae Ia-IVa, $Q_3$ and $Q'_3$ can be sulfur. In some forms, for any one of Formulae Ia-IVa, $Q_3$ and $Q'_3$ can be oxygen.

In some forms, for any one of Formulae I-IV and Ia-IVa, at least one of $R_6$-$R_9$ and at least one of $R'_6$-$R'_9$, such as

one or two of $R_6$-$R_9$ and/or one or two of $R'_6$-$R'_9$, can be independently halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., $-B(Mes)_2$), phosphonyl (e.g., $-P(=O)(Ph)_2$, $-P(=O)(alkyl)_2$, etc.); or $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or an unsubstituted aryl.

In some forms, for any of Formulae I-IV and Ia-IVa, $X_4$ and $X'_4$ are carbon; $R_{4a}$ and $R'_{4a}$ are independently hydrogen, substituted alkyl, unsubstituted alkyl, substituted alkenyl, unsubstituted alkenyl, substituted alkynyl, unsubstituted alkynyl, substituted aryl, unsubstituted aryl, unsubstituted polyaryl, substituted polyaryl, hydroxyl, amino, amido, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, substituted $C_2$-$C_{20}$ heterocyclyl, or unsubstituted $C_2$-$C_{20}$ heterocyclyl; and the substituents are as defined above for Formula I.

In some forms, for any of Formulae I-IV and Ia-IVa, $X_4$ and $X'_4$ are carbon; $R_{4a}$ and $R'_{4a}$ are independently hydrogen, substituted alkyl, unsubstituted alkyl, substituted aryl, unsubstituted aryl, unsubstituted polyaryl, substituted polyaryl, hydroxyl, unsubstituted heteroaryl, substituted heteroaryl, unsubstituted polyheteroaryl, substituted polyheteroaryl, substituted $C_2$-$C_{20}$ heterocyclyl, or unsubstituted $C_2$-$C_{20}$ heterocyclyl; and the substituents are as defined above for Formula I.

In some forms, for any of Formulae I-IV and Ia-IVa, $X_4$ and $X'_4$ are carbon; and $R_{4a}$ and $R'_{4a}$ are independently hydrogen, unsubstituted alkyl, unsubstituted aryl, unsubstituted polyaryl, hydroxyl, unsubstituted heteroaryl, unsubstituted polyheteroaryl, unsubstituted $C_2$-$C_{20}$ heterocyclyl, or unsubstituted alkylaryl.

In some forms, for any of Formulae I-IV and Ia-IVa, $X_4$ and $X'_4$ are carbon; and $R_{4a}$ and $R'_{4a}$ are hydrogen.

In some forms, for any of Formulae I-IV and Ia-IVa, $X_4$ and $X'_4$ are nitrogen; $R_{4a}$ and $R'_{4a}$ are absent.

In some forms, for any of Formulae I-IV and Ia-IVa, $R_1$-$R_9$ and $R'_1$-$R'_9$ are independently hydrogen, halogen, substituted alkyl, unsubstituted alkyl, substituted aryl, unsubstituted aryl (e.g., unsubstituted phenyl), substituted polyaryl, unsubstituted polyaryl, hydroxyl, unsubstituted heteroaryl, substituted heteroaryl, unsubstituted polyheteroaryl, substituted polyheteroaryl, substituted $C_2$-$C_{20}$ heterocyclyl, unsubstituted $C_2$-$C_{20}$ heterocyclyl, alkoxy, borenium cation, phosphonyl, sulfinyl, or sulfonyl; and the substituents are as defined above for Formula I.

In some forms, for any of Formulae I-IV and Ia-IVa, $R_1$-$R_9$ and $R'_1$-$R'_9$ are independently hydrogen, halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), unsubstituted polyaryl, substituted polyaryl, hydroxyl, unsubstituted heteroaryl, substituted heteroaryl, unsubstituted polyheteroaryl, substituted polyheteroaryl, unsubstituted $C_2$-$C_{20}$ heterocyclyl , substituted $C_1$-$C_{20}$ heterocyclyl, unsubstituted alkylaryl, substituted alkylaryl, alkoxy (e.g., -O-alkyl, -O-aryl, -O-polyaryl, etc.), borenium cation (e.g., $-B(Mes)_2$), phosphonyl (e.g. $-P(=O)(Ph)_2$, $- P(=O)(alkyl)_2$, etc.), sulfinyl (e.g., $-S(=O)(Ph)_2$, $-S(=O)(alkyl)_2$, etc.), or sulfonyl $- S(=O)_2(Ph)_2$, $-S(=O)_2(alkyl)_2$, etc.).

In some forms, for any of Formulae I-IV and Ia-IVa, one or more of $R_1$-$R_9$ and $R'_1$-$R'_9$ can be

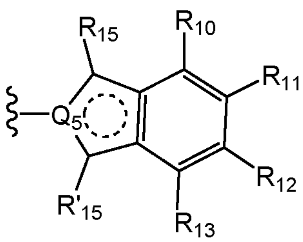

or

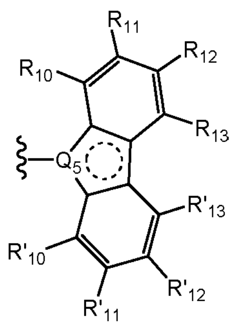

,

where $Q_5$ can be nitrogen or carbon; and $R_{10}$-$R_{13}$, $R_{15}$, $R'_{15}$, and $R'_{10}$-$R'_{13}$ can be independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted

ester, substituted $C_2$-$C_{20}$ heterocyclyl, or unsubstituted $C_2$-$C_{20}$ heterocyclyl. In some forms, $Q_5$ can be nitrogen or carbon; and $R_{10}$-$R_{13}$, $R_{15}$, $R'_{15}$, and $R'_{10}$-$R'_{13}$ can be independently absent, hydrogen, substituted alkyl, unsubstituted alkyl, substituted phenyl group, unsubstituted phenyl, alkoxy, halogen, borenium cation (e.g., -B(Mes)$_2$), phosphonyl, or sulfinyl. In some forms, $Q_5$ can be nitrogen or carbon; and $R_{10}$-$R_{13}$, $R_{15}$, $R'_{15}$, and $R'_{10}$-$R'_{13}$ can be hydrogen, i.e., carbazolyl, fluorenyl, indenyl, or indolyl.

In some forms, for any of Formulae I-IV and Ia-IVa, $R_2$-$R_5$, $R'_2$-$R'_5$, $R_7$, $R_8$, $R'_7$, and $R'_8$ are hydrogen; and $R_1$, $R_6$, $R_9$, $R'_1$, $R'_6$, and/or $R'_9$ are independently hydrogen, halogen, unsubstituted alkyl (e.g., methyl, ethyl, n-propyl, isopropyl, n-butyl, sec-butyl, isobutyl, tert-butyl, etc.), unsubstituted aryl, substituted aryl (e.g., mesitylene or other aryl substituted with one or more alkyls, such as methyl, ethyl, n-propyl, isopropyl, n-butyl, sec-butyl, isobutyl, tert-butyl, etc.), unsubstituted polyaryl, substituted polyaryl, hydroxyl, unsubstituted heteroaryl (e.g., carbazolyl, fluorenyl, indenyl, indolyl, etc.), unsubstituted polyheteroaryl, unsubstituted $C_2$-$C_{20}$ heterocyclyl, unsubstituted alkylaryl, alkoxy (e.g., -O-alkyl such as methoxy, ethoxy, and phenoxy, -O-aryl, -O-polyaryl, etc.), borenium cation (e.g., -B(Mes)$_2$), phosphonyl (e.g. -P(=O)(Ph)$_2$), sulfinyl (e.g., - S(=O)(Ph)$_2$, -S(=O)(alkyl)$_2$, etc.), or sulfonyl -S(=O)$_2$(Ph)$_2$, -S(=O)$_2$(alkyl)$_2$, etc.).

In some forms, for any of Formulae I-IV and Ia-IVa, $R_2$-$R_5$, $R'_2$-$R'_5$, $R_7$, $R_8$, $R'_7$, and R's are hydrogen; and $R_1$, $R_6$, $R_9$, $R'_1$, $R'_6$, and/or $R'_9$ are independently hydrogen, halogen, unsubstituted alkyl, unsubstituted aryl, substituted aryl (e.g., aryl substituted with one or more alkyls, such as methyl, ethyl, n-propyl, isopropyl, n-butyl, sec-butyl, isobutyl, tert-butyl, etc.), unsubstituted polyaryl, substituted polyaryl, hydroxyl, unsubstituted heteroaryl (e.g., carbazolyl, fluorenyl, indenyl, indolyl, etc.), unsubstituted polyheteroaryl, unsubstituted $C_2$-$C_{20}$ heterocyclyl, unsubstituted alkylaryl, alkoxy (e.g., - O-alkyl such as methoxy, ethoxy, and phenoxy, -O-aryl, -O-polyaryl, etc.), borenium cation (e.g., -B(Mes)$_2$), phosphonyl (e.g. -P(=O)(Ph)$_2$), sulfinyl (e.g., -S(=O)(Ph)$_2$, - S(=O)(alkyl)$_2$, etc.), or sulfonyl -S(=O)$_2$(Ph)$_2$, -S(=O)$_2$(alkyl)$_2$, etc.).

In some forms, for any of Formulae I-IV and Ia-IVa, $R_2$-$R_5$, $R'_2$-$R'_5$, $R_7$, $R_8$, $R'_7$, and $R'_8$ are hydrogen; and $R_1$, $R_6$, $R_9$, $R'_1$, $R'_6$, and/or $R'_9$ are independently unsubstituted alkyl, unsubstituted aryl, or substituted aryl (e.g., aryl substituted with one or more alkyls, such as methyl, ethyl, n-propyl, isopropyl, n-butyl, sec-butyl, isobutyl, tert-butyl, etc.).

In some forms, for any of Formulae I-IV and Ia-IVa, the substituents can be independently a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, a substituted or unsubstituted alkylaryl (e.g. benzyl), a carbonyl (e.g. carboxyl, ester, etc.), an alkoxy (e.g. methoxy, ethoxy, aryloxy, benzoether, etc.), a halide, a hydroxyl, or a haloalkyl, or a combination thereof.

For any of Formulae I-IV and Ia-IVa, the alkyl can be a linear alkyl, a branched alkyl, or a cyclic alkyl (either monocyclic or polycyclic). The terms "cyclic alkyl" and "cycloalkyl" are used interchangeably herein. Exemplary alkyl include a linear $C_1$-$C_{30}$ alkyl, a branched $C_4$-$C_{30}$ alkyl, a cyclic $C_3$-$C_{30}$ alkyl, a linear $C_1$-$C_{20}$ alkyl, a branched $C_4$-$C_{20}$ alkyl, a cyclic $C_3$-$C_{20}$ alkyl, a linear $C_1$-$C_{10}$ alkyl, a branched $C_4$-$C_{10}$ alkyl, a cyclic $C_3$-$C_{10}$ alkyl, a linear $C_1$-$C_6$ alkyl, a branched $C_4$-$C_6$ alkyl, a cyclic $C_3$-$C_6$ alkyl, a linear $C_1$-$C_4$ alkyl, cyclic $C_3$-$C_4$ alkyl, such as a linear $C_1$-$C_{10}$, $C_1$-$C_9$, $C_1$-$C_8$, $C_1$-$C_7$, $C_1$-$C_6$, $C_1$-$C_5$, $C_1$-$C_4$, $C_1$-$C_3$, or $C_1$-$C_2$ alkyl group, a branched $C_3$-$C_9$, $C_3$-$C_9$, $C_3$-$C_8$, $C_3$-$C_7$, $C_3$-$C_6$, $C_3$-$C_5$, or $C_3$-$C_4$ alkyl group, or a cyclic $C_3$-$C_9$, $C_3$-$C_9$, $C_3$-$C_8$, $C_3$-$C_7$, $C_3$-$C_6$, $C_3$-$C_5$, or $C_3$-$C_4$ alkyl group. The cyclic alkyl can be a monocyclic or polycyclic alkyl, such as a $C_4$-$C_{30}$, $C_4$-$C_{25}$, $C_4$-$C_{20}$, $C_4$-$C_{18}$, $C_4$-$C_{16}$, $C_4$-$C_{15}$, $C_4$-$C_{14}$, $C_4$-$C_{13}$, $C_4$-$C_{12}$, $C_4$-$C_{10}$, $C_4$-$C_9$, $C_4$-$C_8$, $C_4$-$C_7$, $C_4$-$C_6$, or $C_4$-$C_5$ monocyclic or polycyclic alkyl group.

For any of Formulae I-IV and Ia-IVa, the alkenyl can be a linear alkenyl, a branched alkenyl, or a cyclic alkenyl (either monocyclic or polycyclic). The terms "cyclic alkenyl" and "cycloalkenyl" are used interchangeably herein. Exemplary alkenyl include a linear $C_2$-$C_{30}$ alkenyl, a branched $C_4$-$C_{30}$ alkenyl, a cyclic $C_3$-$C_{30}$ alkenyl, a linear $C_2$-$C_{20}$ alkenyl, a branched $C_4$-$C_{20}$ alkenyl, a cyclic $C_3$-$C_{20}$ alkenyl, a linear $C_2$-$C_{IO}$ alkenyl, a branched $C_4$-$C_{10}$ alkenyl, a cyclic $C_3$-$C_{10}$ alkenyl, a linear $C_2$-$C_6$ alkenyl, a branched $C_4$-$C_6$ alkenyl, a cyclic $C_3$-$C_6$ alkenyl, a linear $C_2$-$C_4$ alkenyl, cyclic $C_3$-$C_4$ alkenyl, such as a linear $C_2$-$C_{IO}$, $C_2$-$C_9$, $C_2$-$C_8$, $C_2$-$C_7$, $C_2$-$C_6$, $C_2$-$C_5$, $C_2$-$C_4$, $C_2$-$C_3$, $C_2$ alkenyl group, a branched $C_3$-$C_9$, $C_3$-$C_9$, $C_3$-$C_8$, $C_3$-$C_7$, $C_3$-$C_6$, $C_3$-$C_5$, $C_3$-$C_4$ alkenyl group, or a cyclic $C_3$-$C_9$, $C_3$-$C_9$, $C_3$-$C_8$, $C_3$-$C_7$, $C_3$-$C_6$, $C_3$-$C_5$, $C_3$-$C_4$ alkenyl group. The cyclic alkenyl can be a monocyclic or polycyclic alkenyl, such as a $C_4$-$C_{30}$, $C_4$-$C_{25}$, $C_4$-$C_{20}$, $C_4$-$C_{18}$, $C_4$-$C_{16}$, $C_4$-$C_{15}$, $C_4$-$C_{14}$, $C_4$-$C_{13}$, $C_4$-$C_{12}$, $C_4$-$C_{10}$, $C_4$-$C_9$, $C_4$-$C_8$, $C_4$-$C_7$, $C_4$-$C_6$, or $C_4$-$C_5$ monocyclic or polycyclic alkenyl group.

For any of Formulae I-IV and Ia-IVa, the alkynyl can be a linear alkynyl, a branched alkynyl, or a cyclic alkynyl (either monocyclic or polycyclic). The terms "cyclic alkynyl" and "cycloalkynyl" are used interchangeably herein. Exemplary alkynyl include a linear $C_2$-$C_{30}$ alkynyl, a branched $C_4$-$C_{30}$ alkynyl, a cyclic $C_3$-$C_{30}$ alkynyl, a linear $C_2$-$C_{20}$ alkynyl, a branched $C_4$-$C_{20}$ alkynyl, a cyclic $C_3$-$C_{20}$ alkynyl, a linear $C_2$-$C_{10}$ alkynyl, a branched $C_4$-$C_{10}$ alkynyl, a cyclic $C_3$-$C_{10}$ alkynyl, a linear $C_2$-$C_6$ alkynyl, a branched $C_4$-$C_6$ alkynyl, a cyclic $C_3$-$C_6$ alkynyl, a linear $C_2$-$C_4$ alkynyl, cyclic $C_3$-$C_4$ alkynyl, such as a linear $C_2$-$C_{10}$, $C_2$-$C_9$, $C_2$-$C_8$, $C_2$-$C_7$, $C_2$-$C_6$, $C_2$-$C_5$, $C_2$-$C_4$, $C_2$-$C_3$, $C_2$ alkynyl group, a branched $C_3$-$C_9$, $C_3$-$C_9$, $C_3$-$C_8$, $C_3$-$C_7$, $C_3$-$C_6$, $C_3$-$C_5$, $C_3$-$C_4$ alkynyl group, or a cyclic $C_3$-$C_9$, $C_3$-$C_9$, $C_3$-$C_8$, $C_3$-$C_7$, $C_3$-$C_6$, $C_3$-$C_5$, $C_3$-$C_4$ alkynyl group. The cyclic alkynyl can be a monocyclic or polycyclic alkynyl, such as a $C_4$-$C_{30}$, $C_4$-$C_{25}$, $C_4$-$C_{20}$, $C_4$-$C_{18}$, $C_4$-$C_{16}$, $C_4$-$C_{15}$, $C_4$-$C_{14}$, $C_4$-$C_{13}$, $C_4$-$C_{12}$, $C_4$-$C_{10}$, $C_4$-$C_9$, $C_4$-$C_8$, $C_4$-$C_7$, $C_4$-$C_6$, or $C_4$-$C_5$ monocyclic or polycyclic alkynyl group.

It is understood that any of the exemplary alkyl, alkenyl, and alkynyl groups can be heteroalkyl, heteroalkenyl, and heteroalkynyl, respectively.

For any of Formulae I-IV and Ia-IVa, the aryl group can be a $C_5$-$C_{30}$ aryl, a $C_5$-$C_{20}$ aryl, a $C_5$-$C_{12}$ aryl, a $C_5$-$C_{11}$ aryl, a $C_5$-$C_9$ aryl, a $C_6$-$C_{20}$ aryl, a $C_6$-$C_{12}$ aryl, a $C_6$-$C_{11}$ aryl, or a $C_6$-$C_9$ aryl. It is understood that the aryl can be a heteroaryl, such as a $C_5$-$C_{30}$ heteroaryl, a $C_5$-$C_{20}$ heteroaryl, a $C_5$-$C_{12}$ heteroaryl, a $C_5$-$C_{11}$ heteroaryl, a $C_5$-$C_9$ heteroaryl, a $C_6$-$C_{30}$ heteroaryl, a $C_6$-$C_{20}$ heteroaryl, a $C_6$-$C_{12}$ heteroaryl, a $C_6$-$C_{11}$ heteroaryl, or a $C_6$-$C_9$ heteroaryl. For any of Formulae I, Ia, II, III, and IV, the polyaryl group can be a $C_{10}$-$C_{30}$ polyaryl, a $C_{10}$-$C_{20}$ polyaryl, a $C_{10}$-$C_{12}$ polyaryl, a $C_{10}$-$C_{11}$ polyaryl, or a $C_{12}$-$C_{20}$ polyaryl. It is understood that the aryl can be a polyheteroaryl, such as a $C_{10}$-$C_{30}$ polyheteroaryl, a $C_{10}$-$C_{20}$ polyheteroaryl, a $C_{10}$-$C_{12}$ polyheteroaryl, a $C_{10}$-$C_{11}$ polyheteroaryl, or a $C_{12}$-$C_{20}$ polyheteroaryl.

In some forms, the dinuclear platinum(II) complex has a structure:

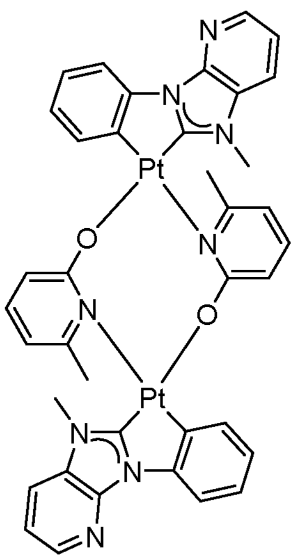

Pt-R1 ,

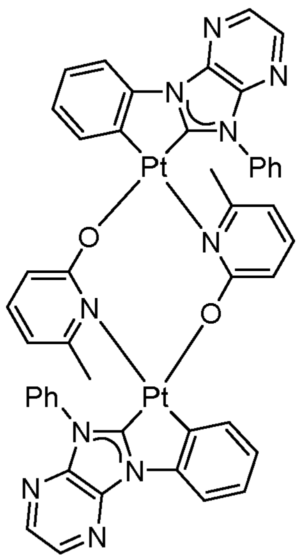

Pt-R2 ,

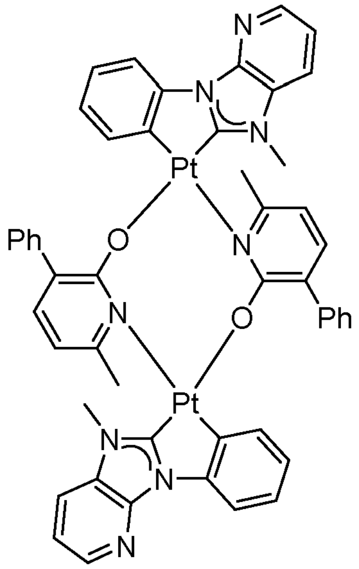

Pt-R3 ,

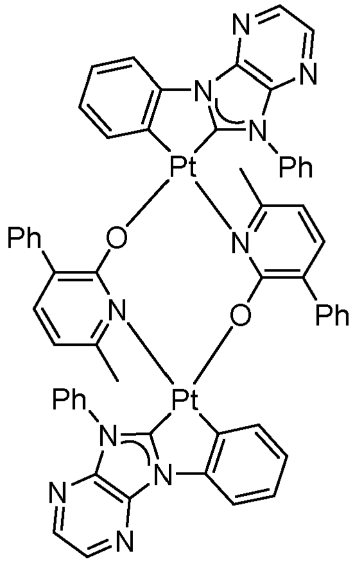

Pt-R4 ,

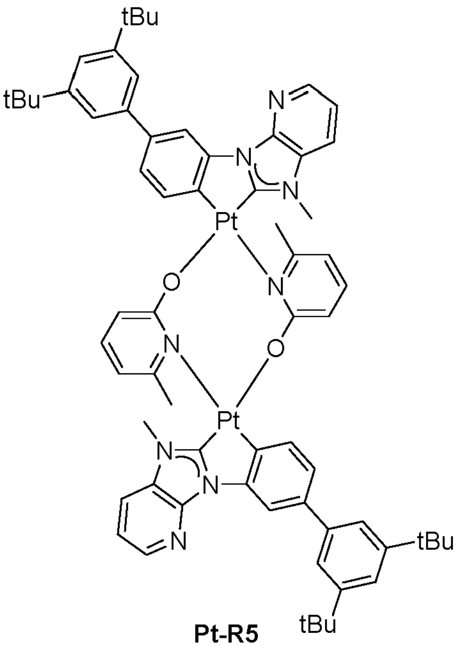

**Pt-R5** ,

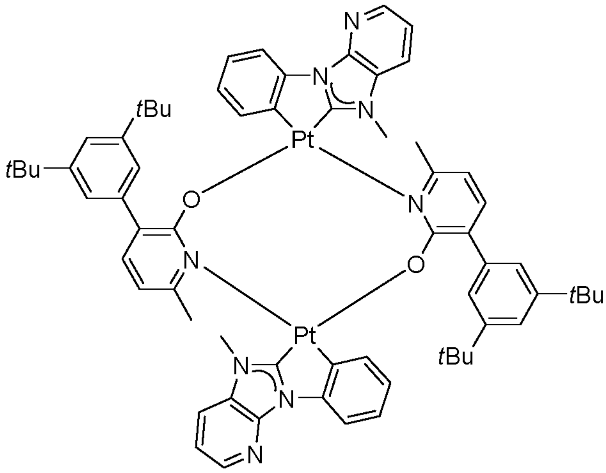

**Pt-R6** ,

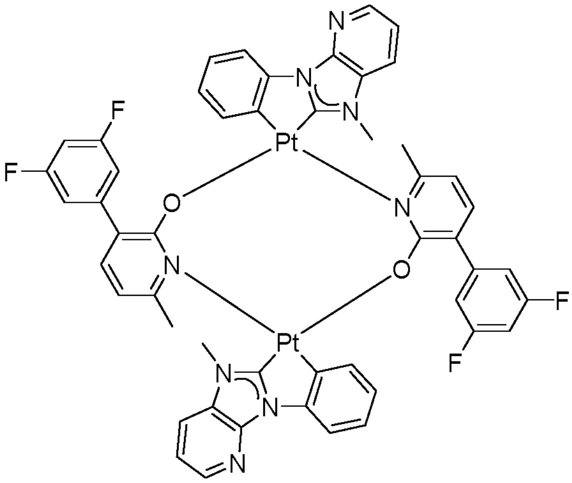

**Pt-R7** ,

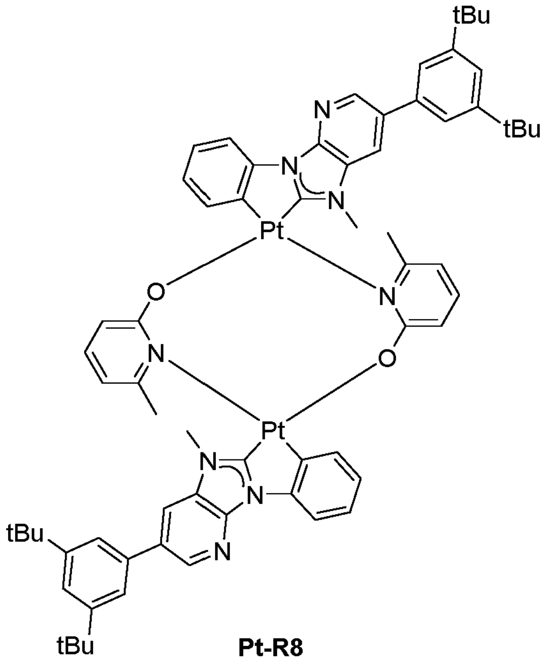

**Pt-R8** ,

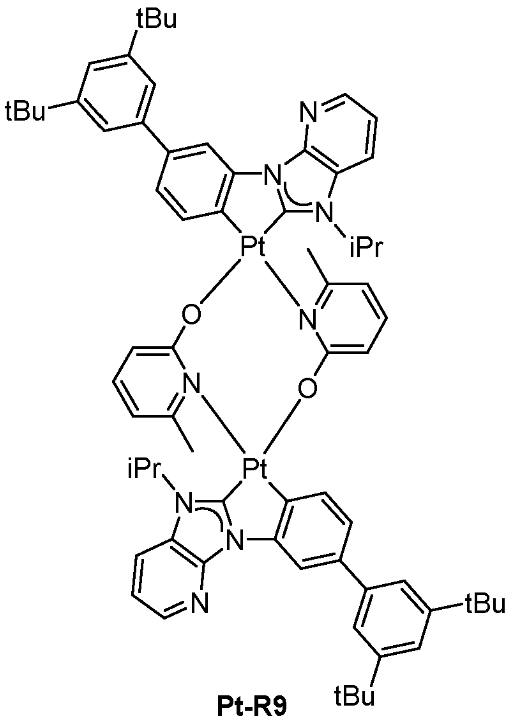

Pt-R9 ,

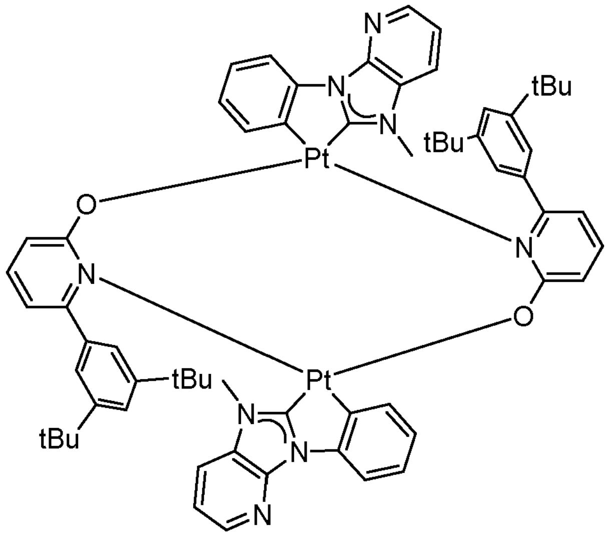

Pt-R10 ,

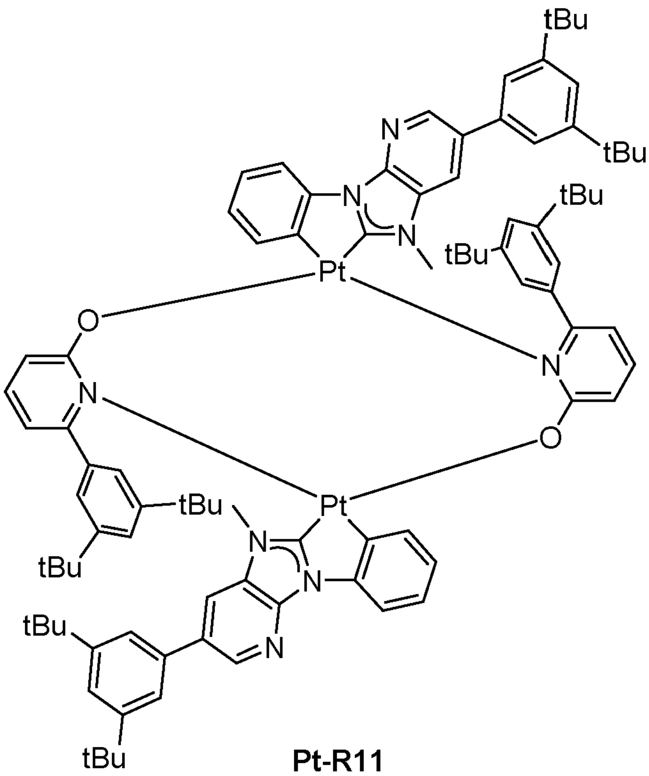

Pt-R11 ,

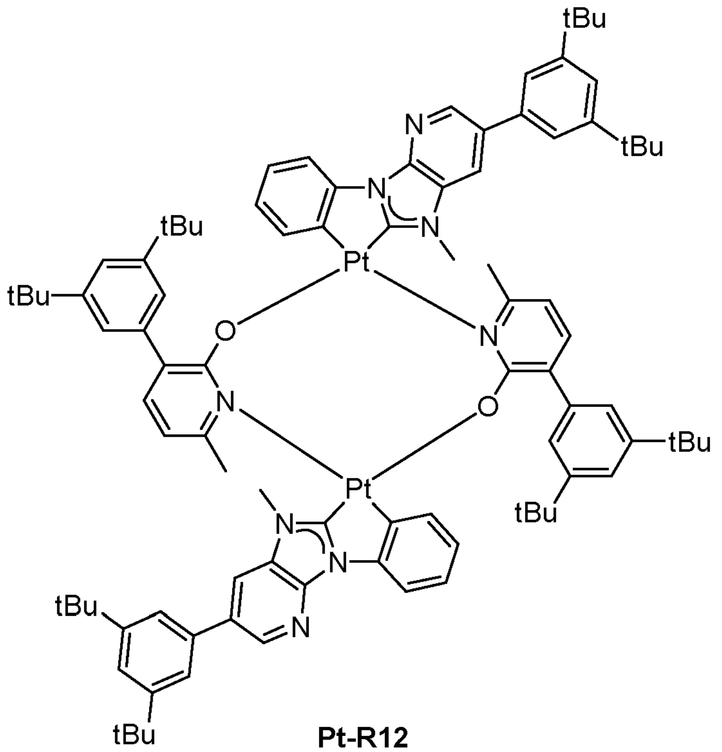

**Pt-R12**

,

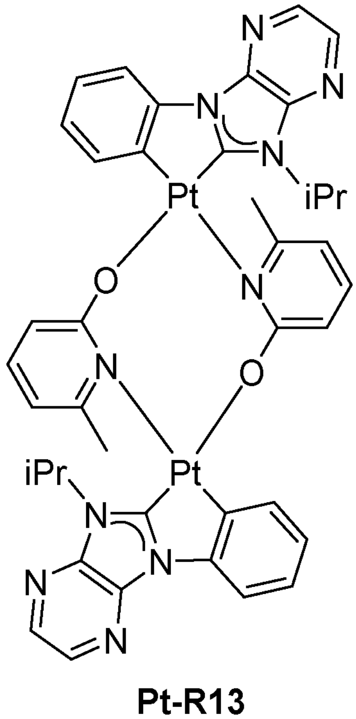

**Pt-R13**

,

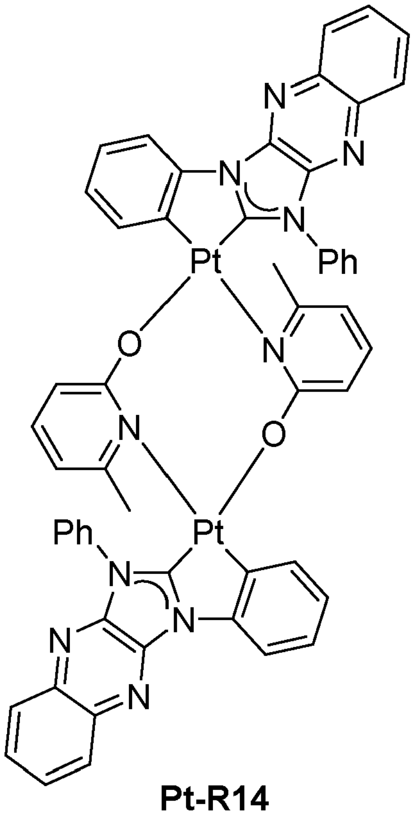

**Pt-R14**

,

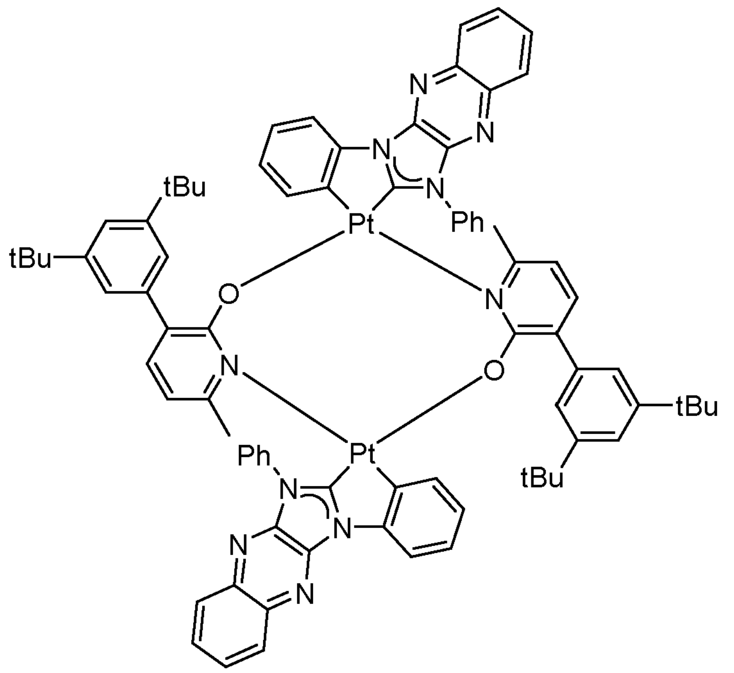

or

**Pt-R15**

.

Additional exemplary dinuclear platinum(II) complexes are shown below.

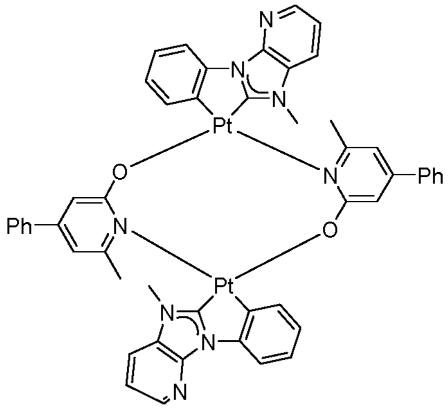

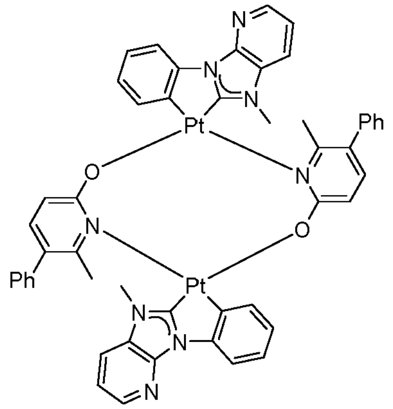

,

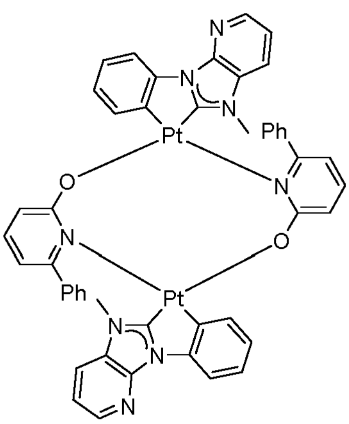

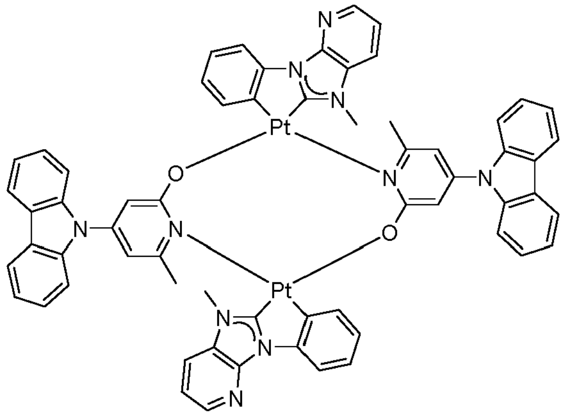

,

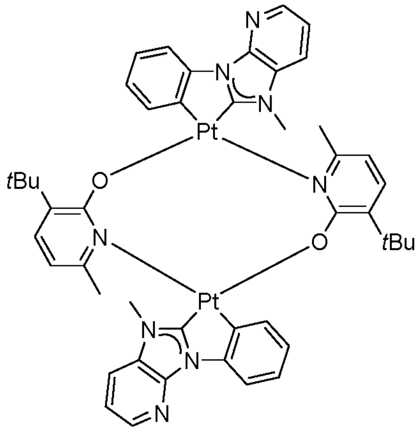

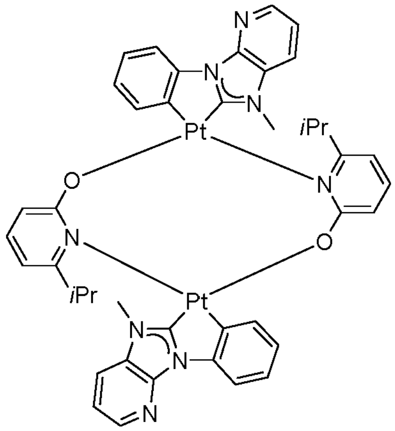

,

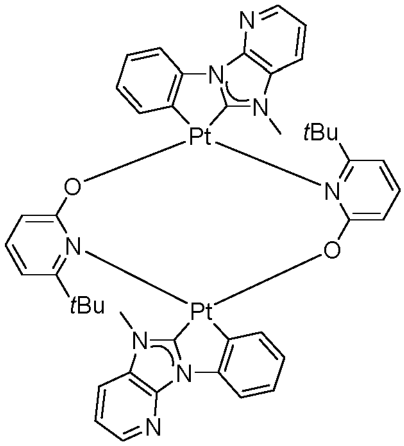

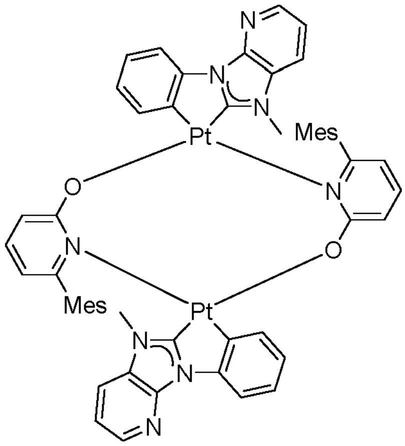

,

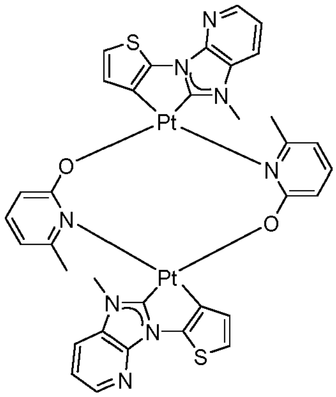

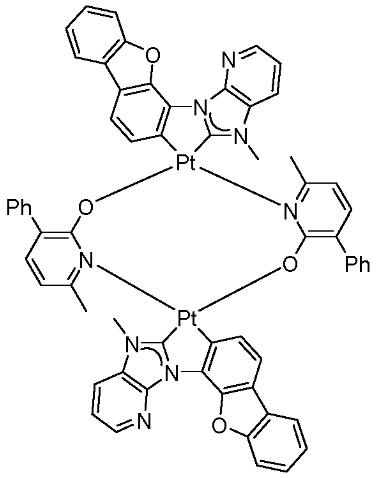

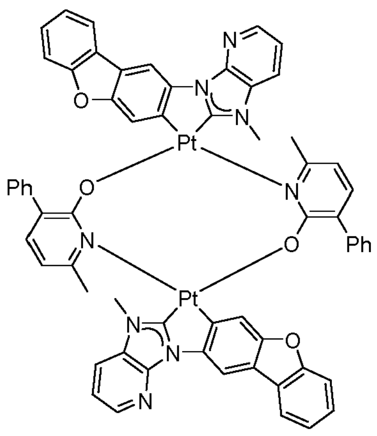

,

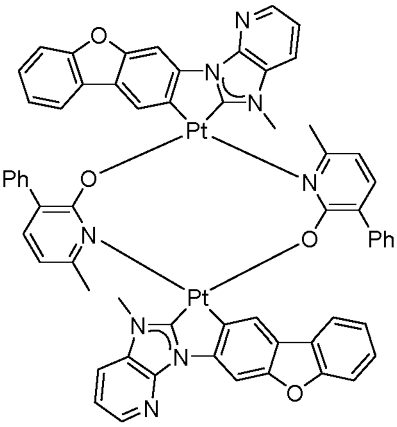

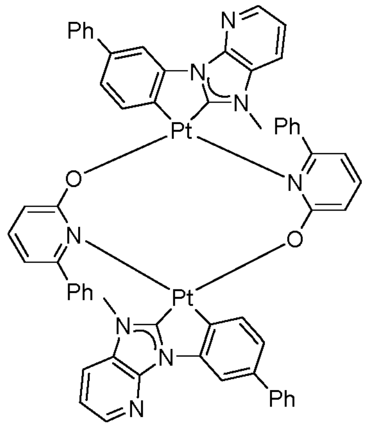

,

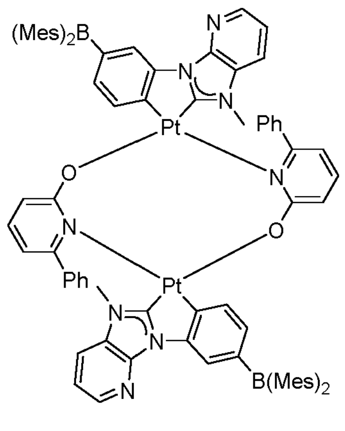

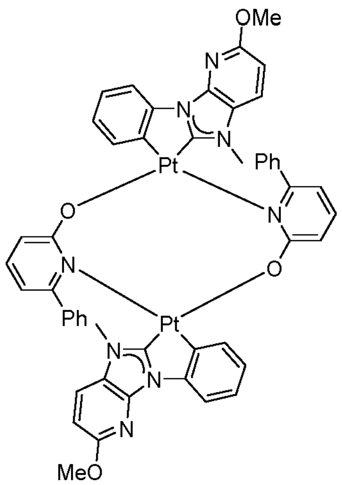

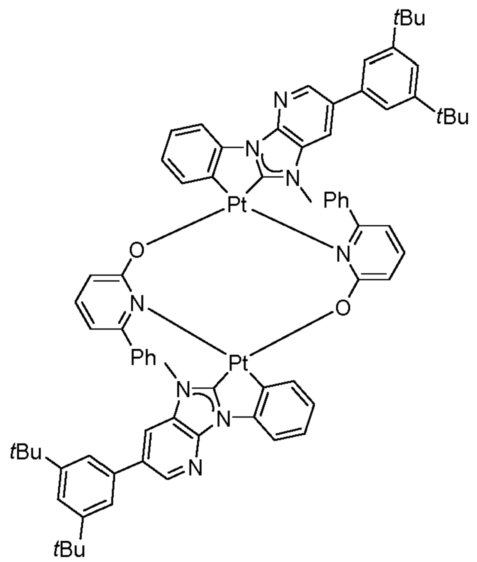

,

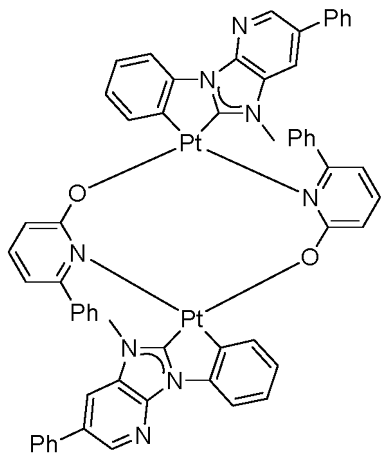

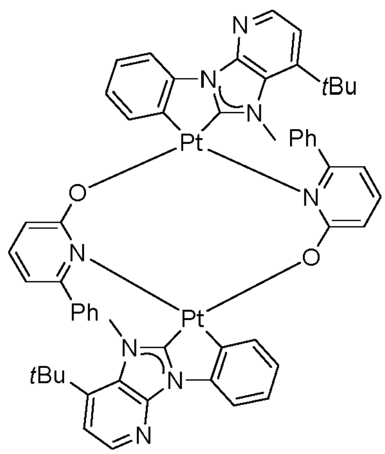

,

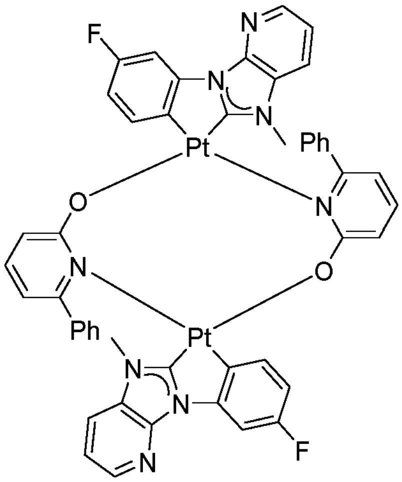

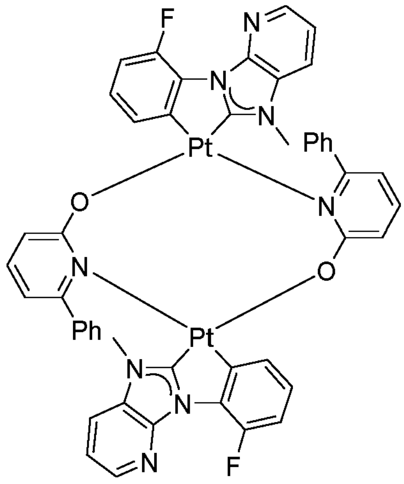

,

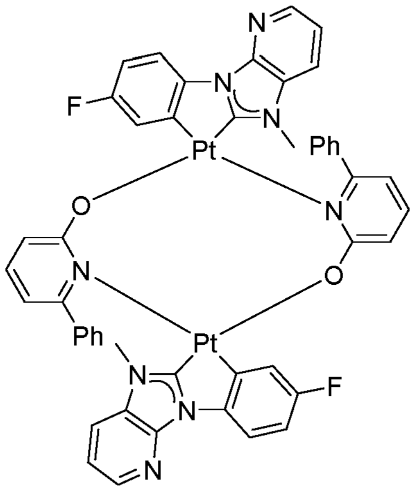

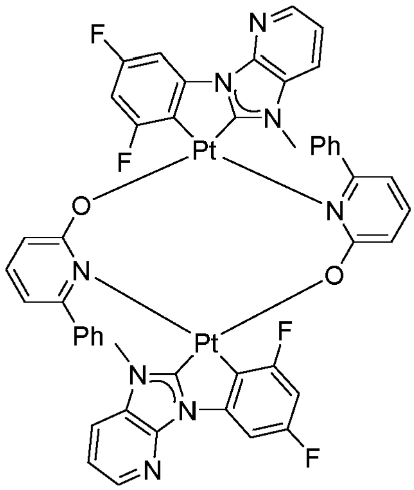

,

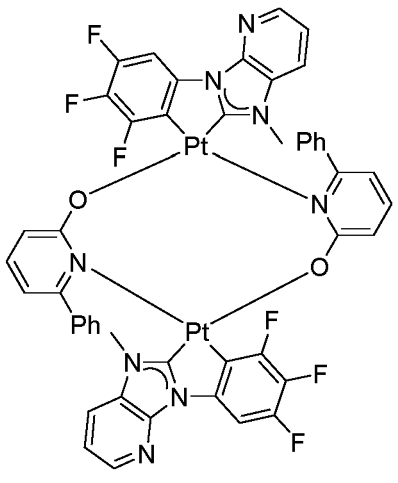

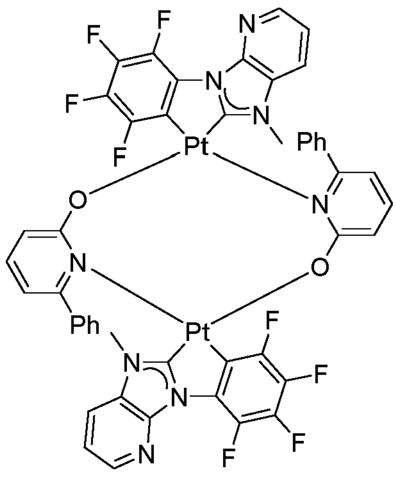

,

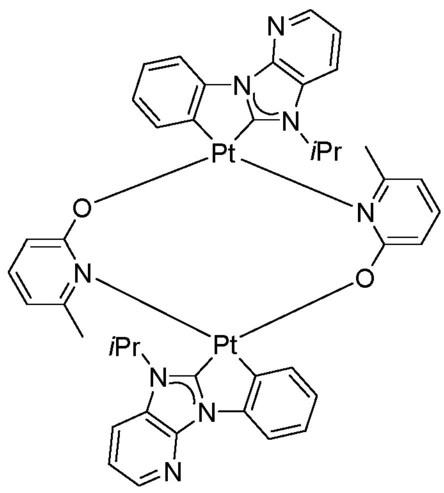

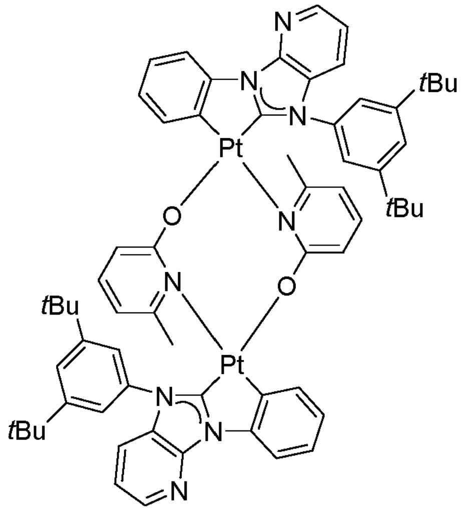

,

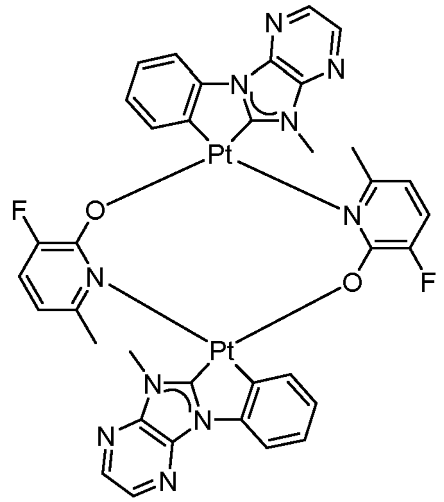

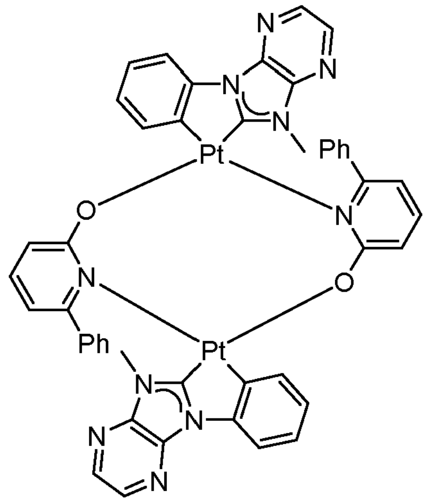

,

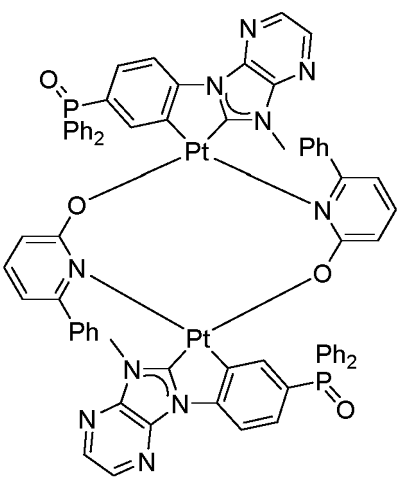

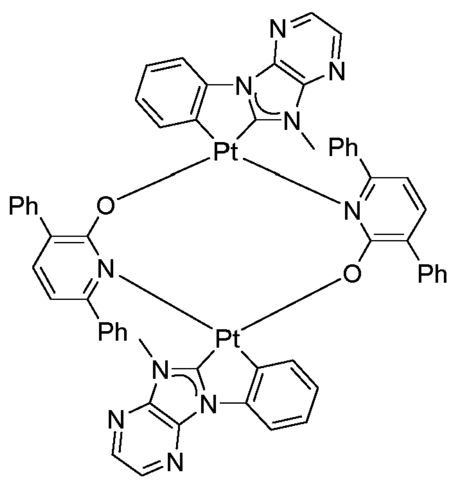

,

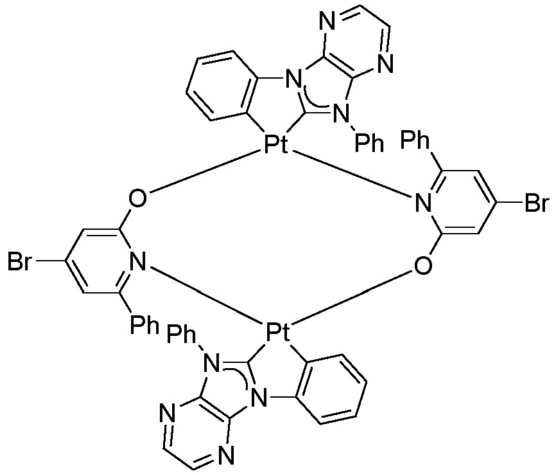

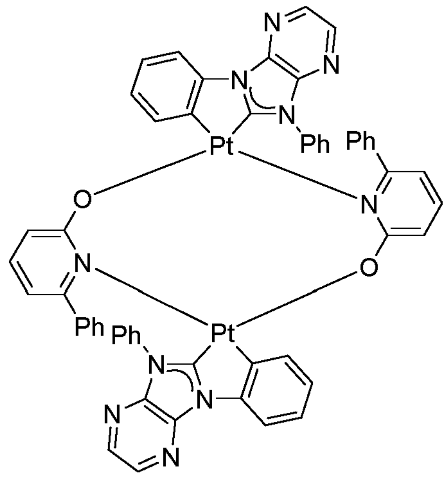

,

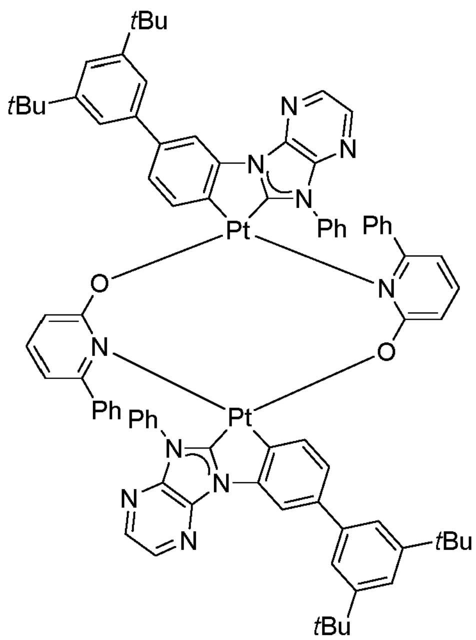

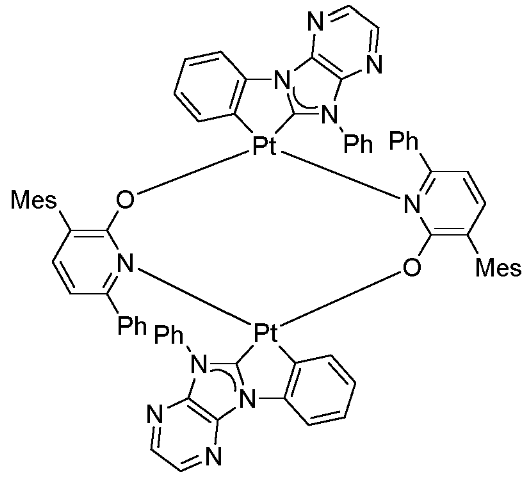

,

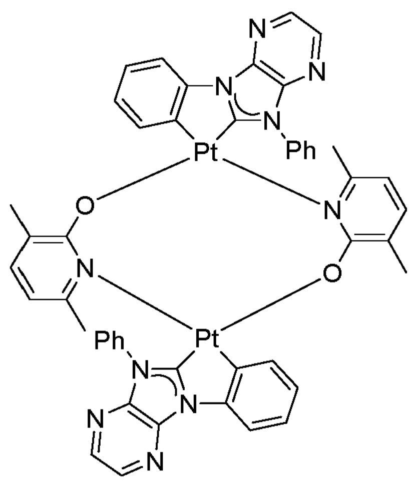

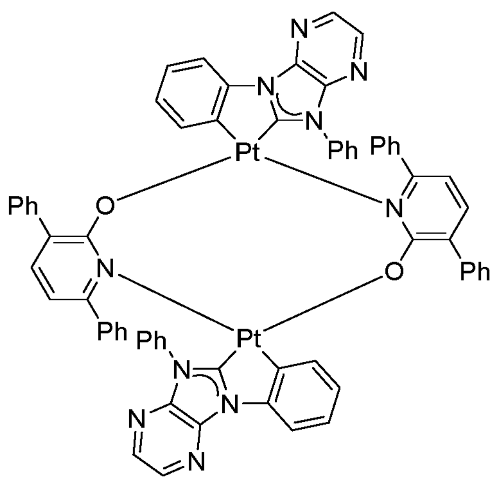

,

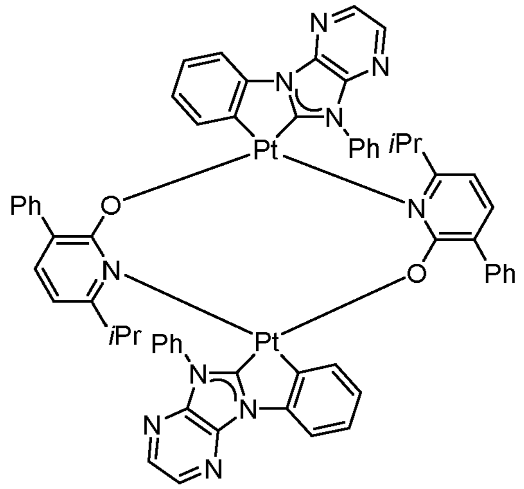

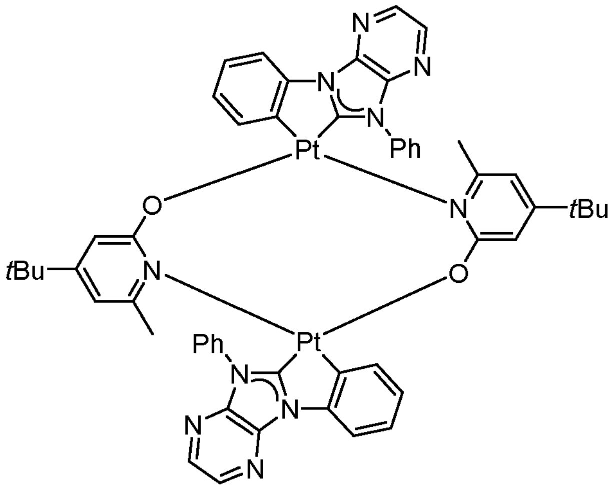

,

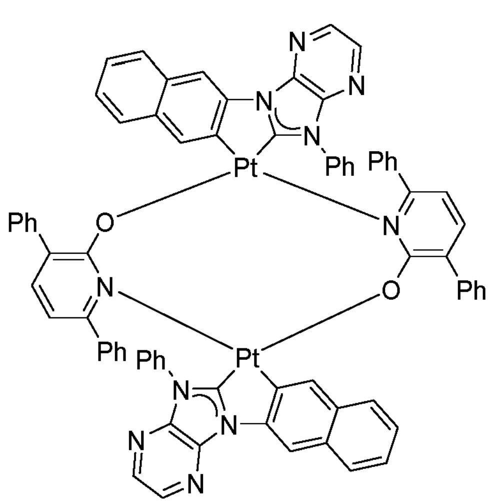

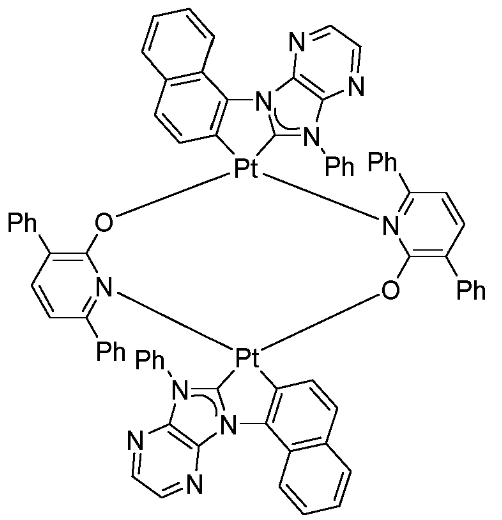

,

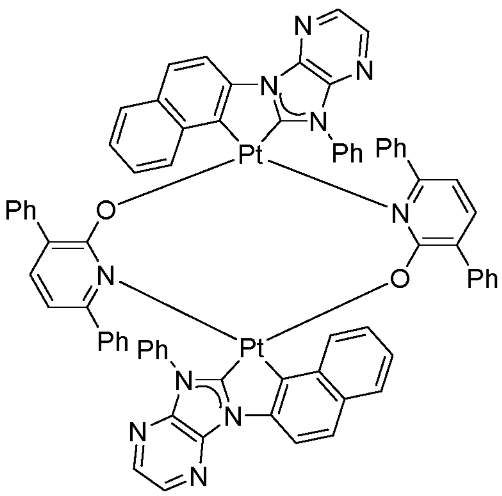

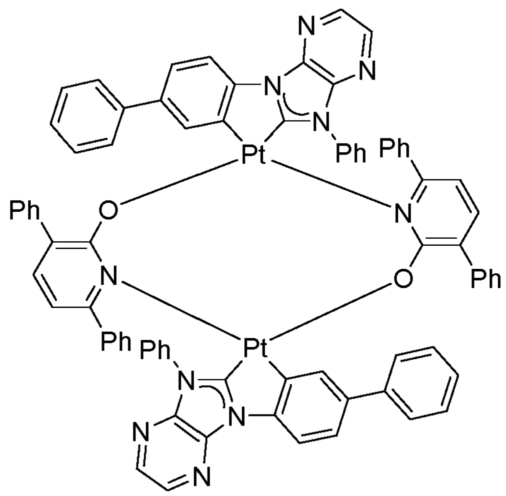

,

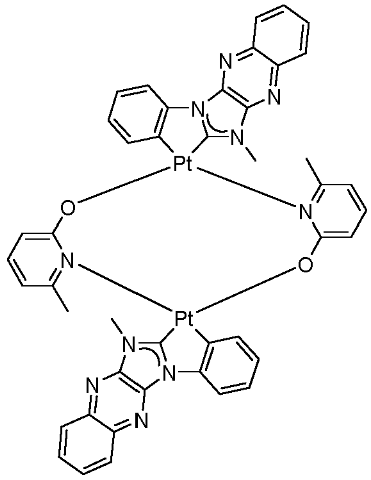
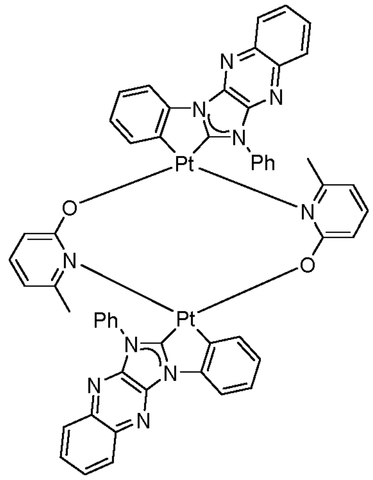
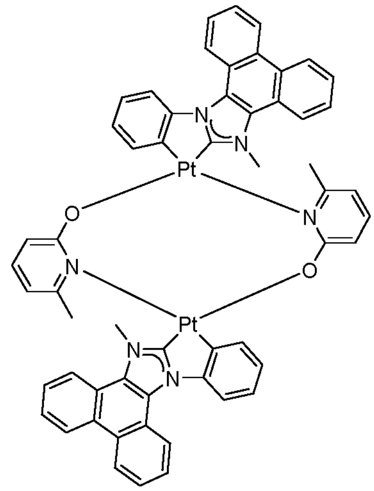
,

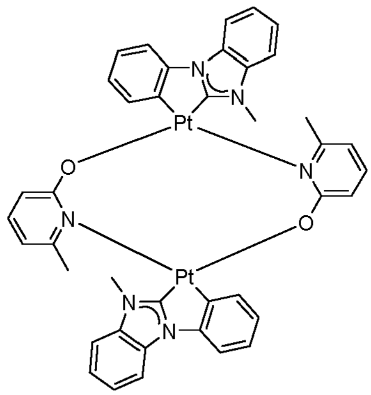
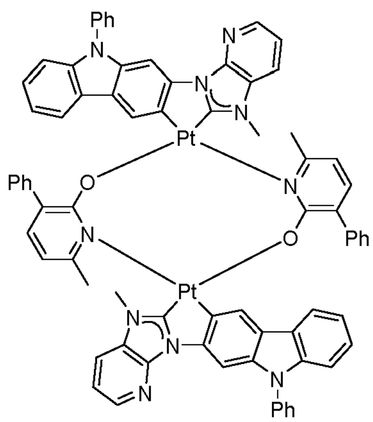
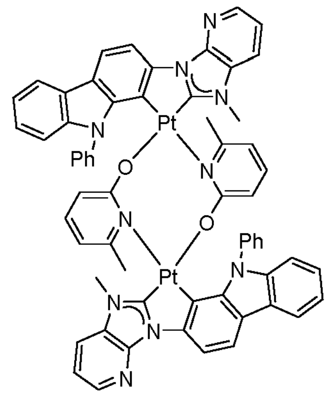
,

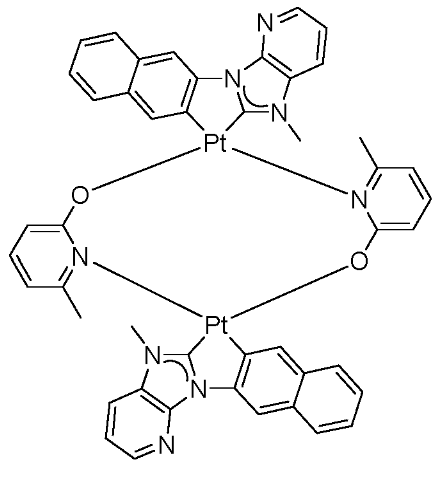
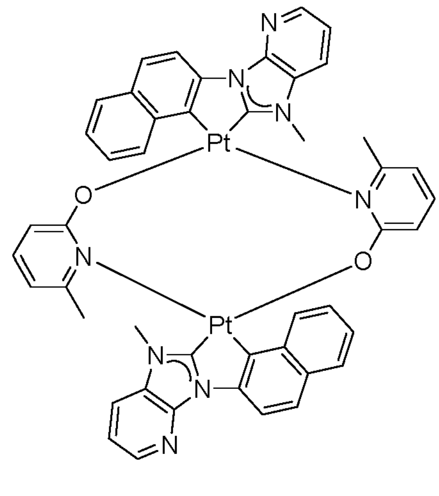
,

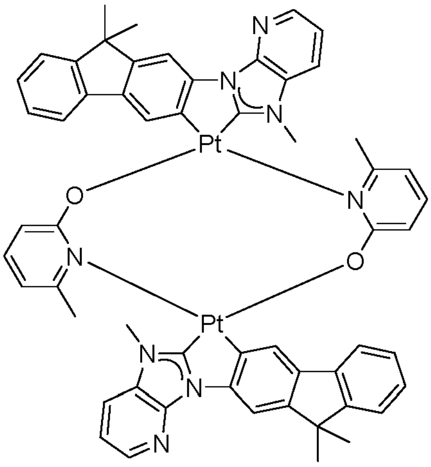

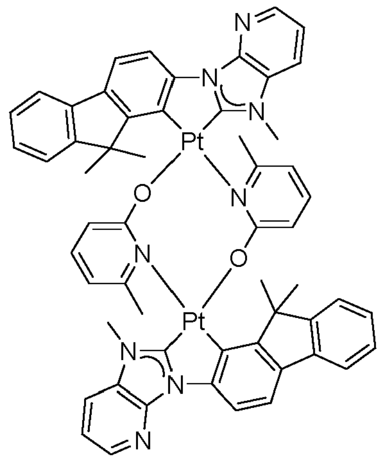

,

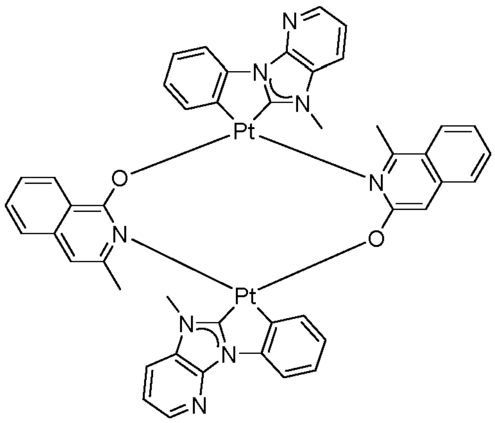

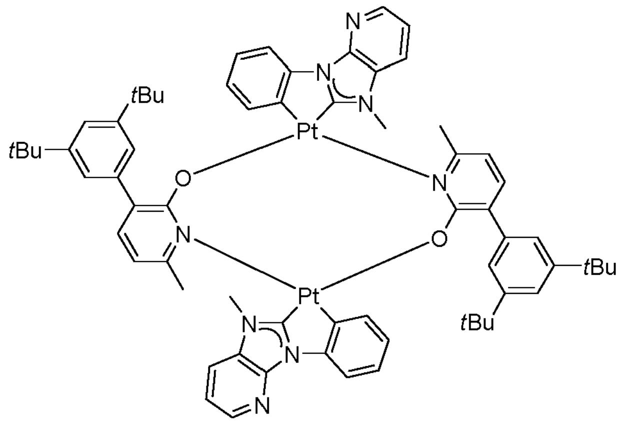

,

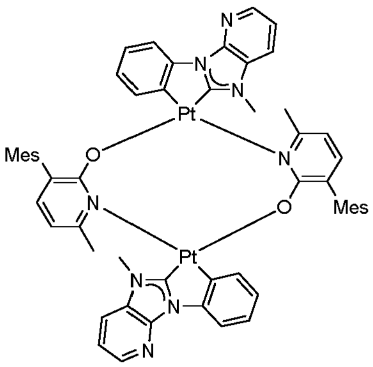

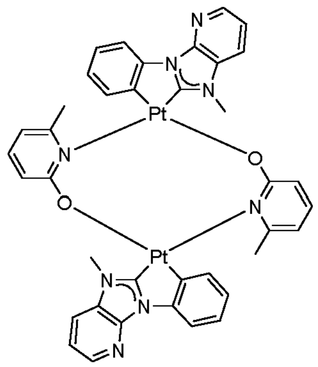

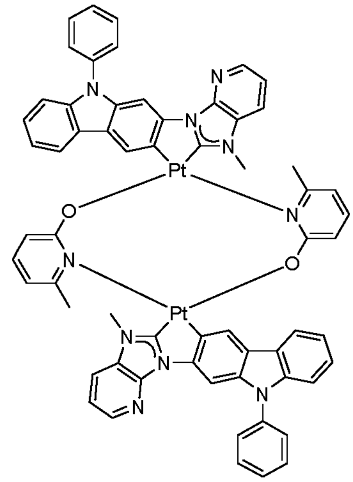

,

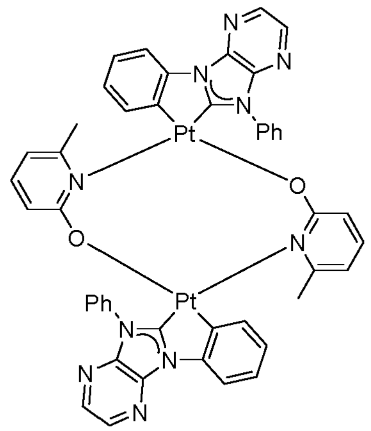

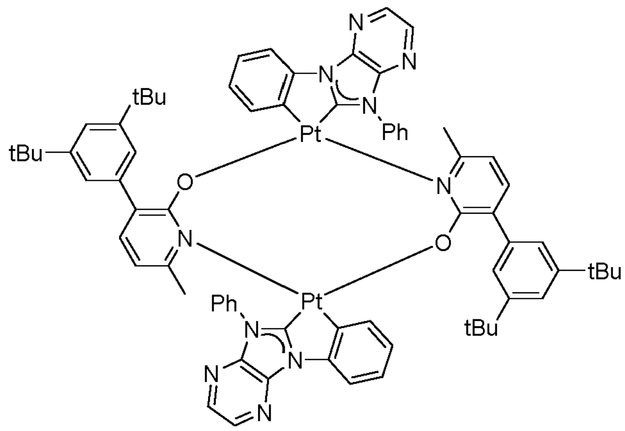

,

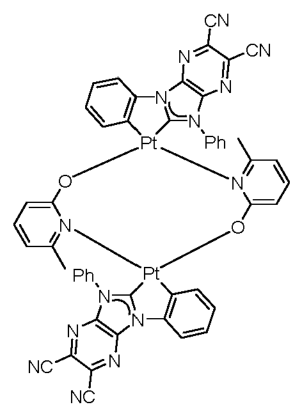

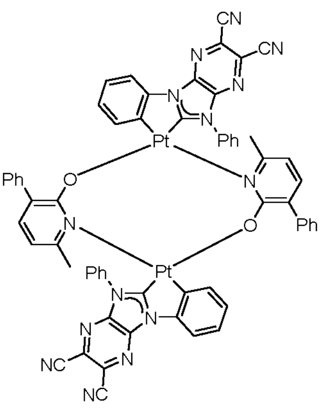

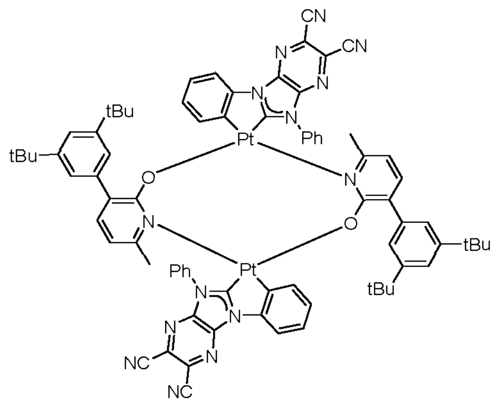

,

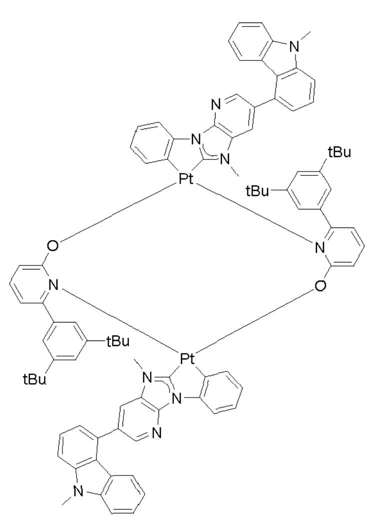

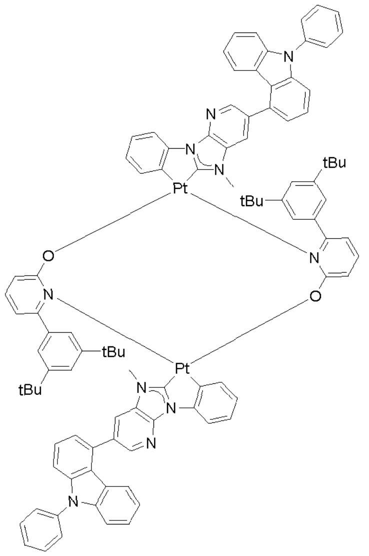

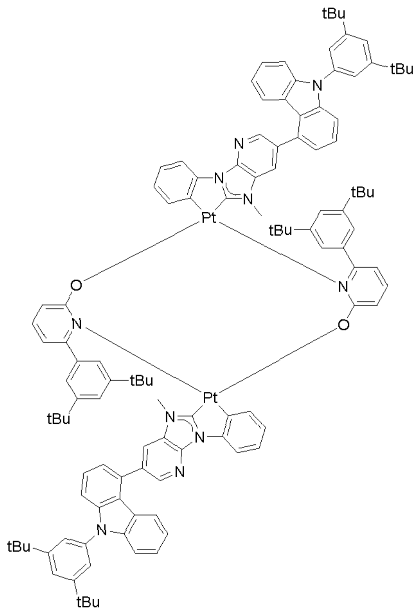

,

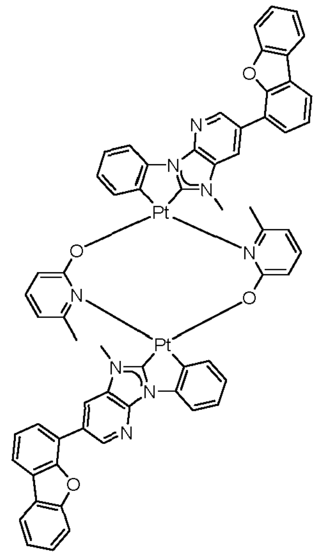

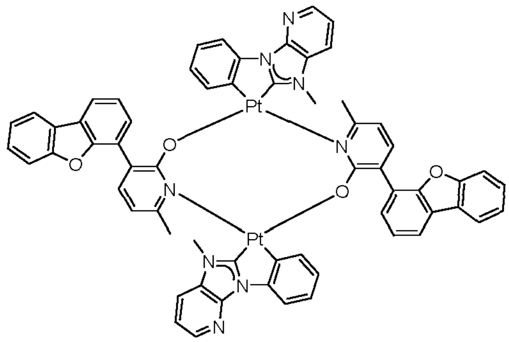

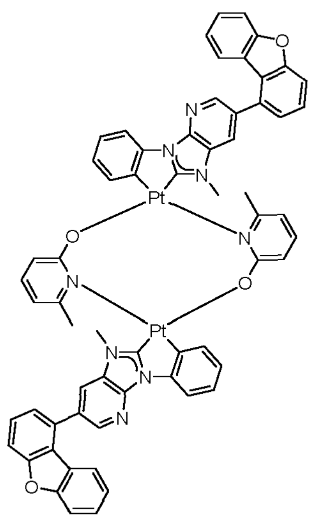

,

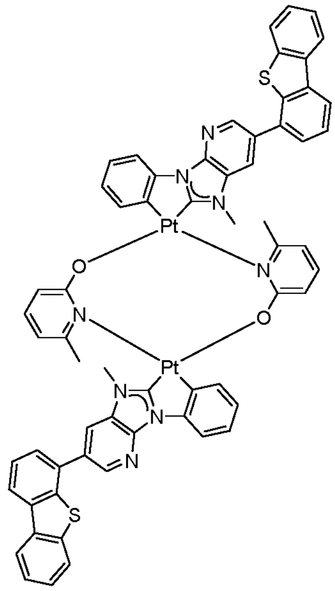

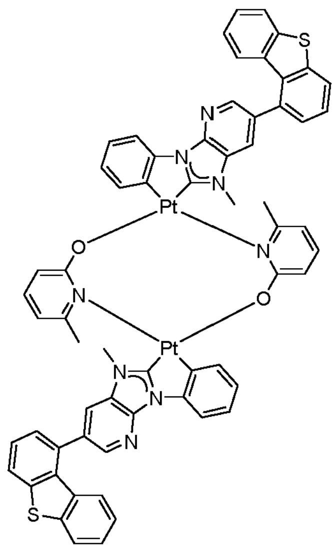

,

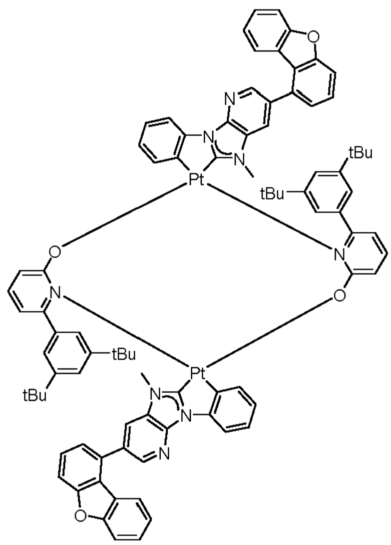

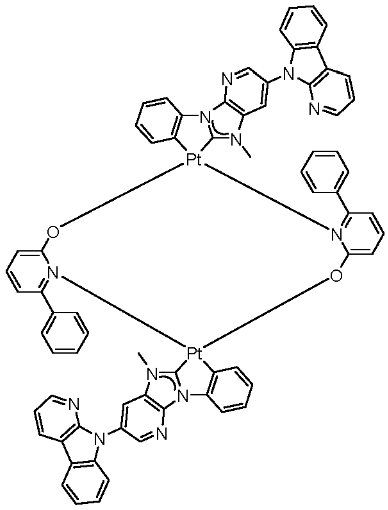

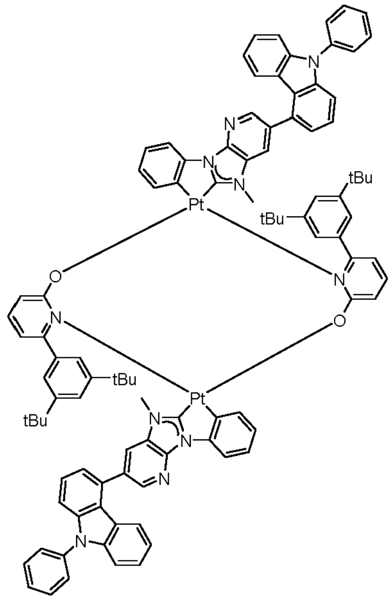

,

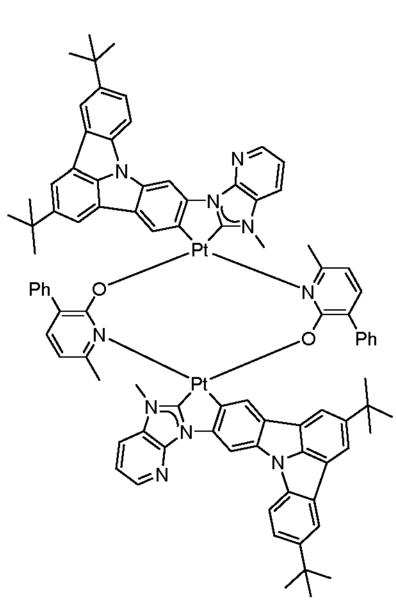

,

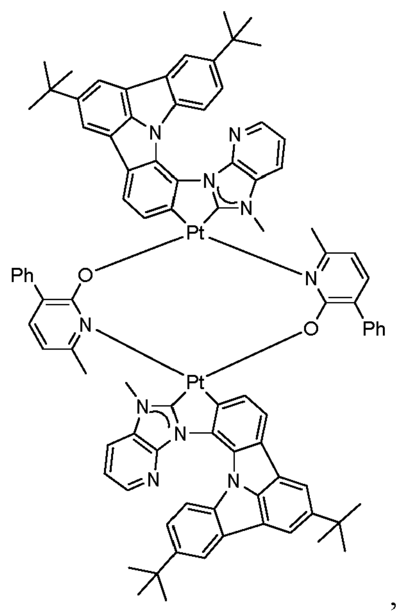

,

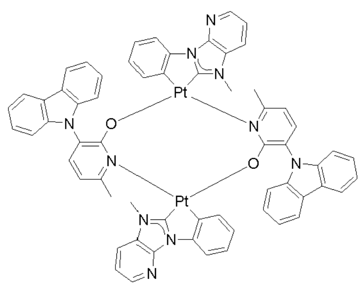

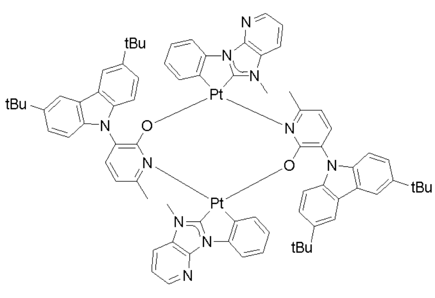

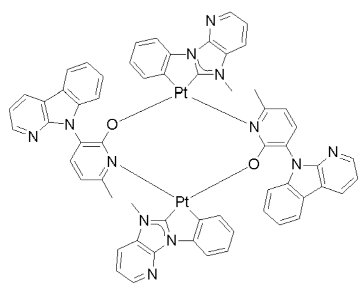

,

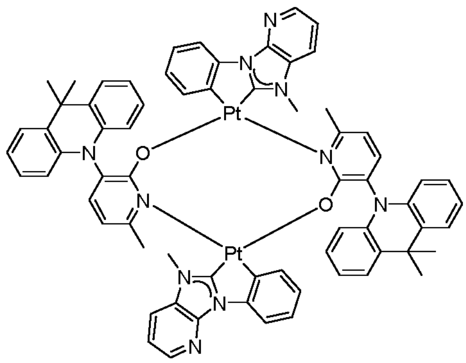

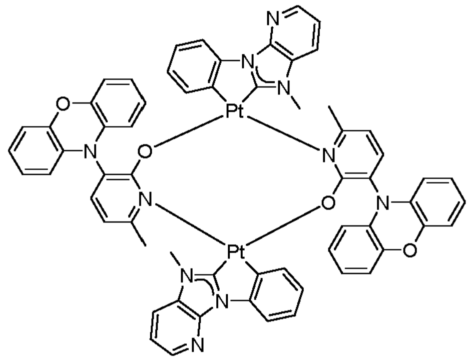

,

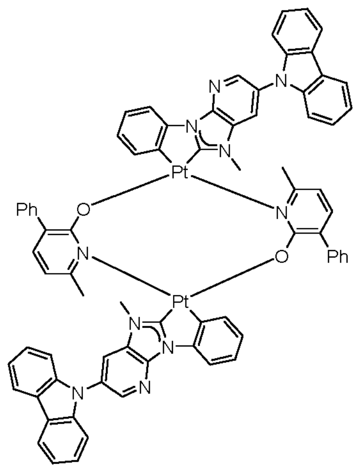

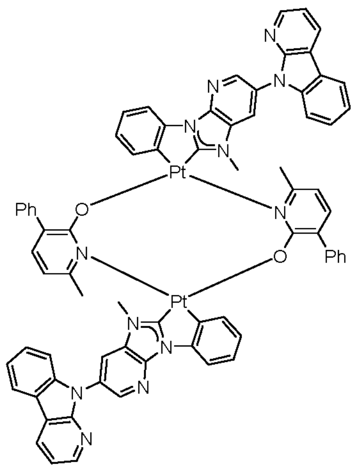

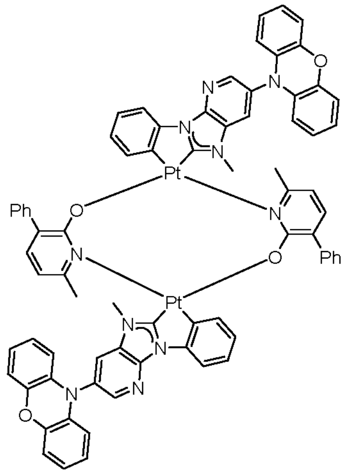

,

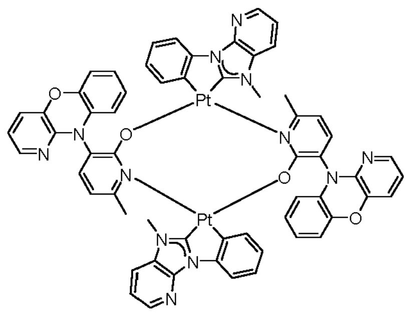

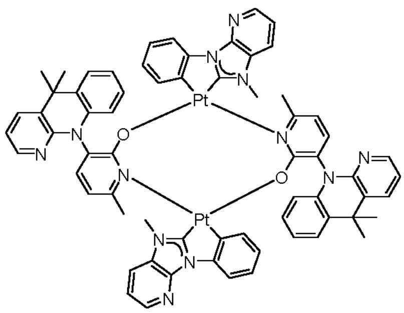

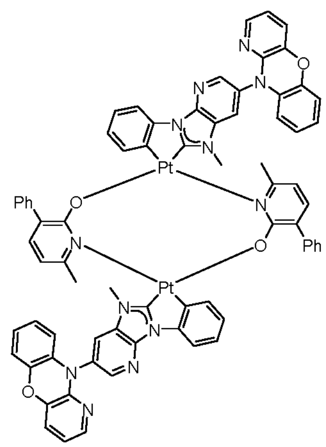

,

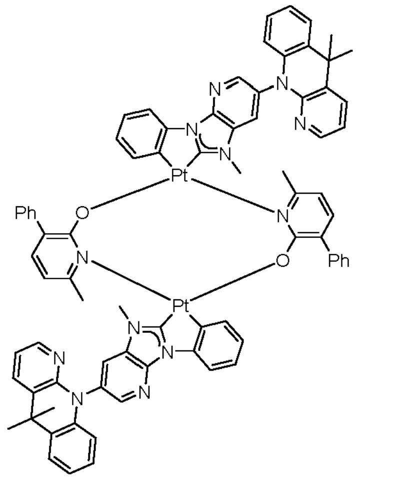 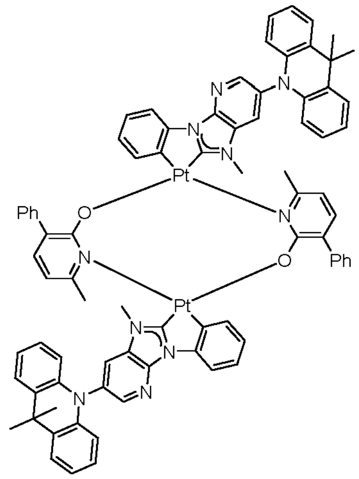 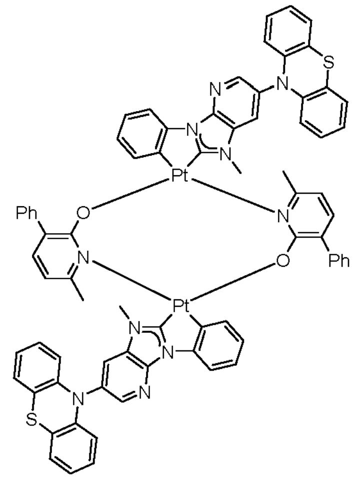,

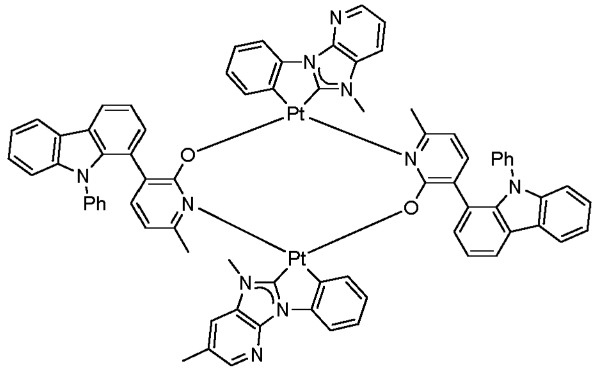 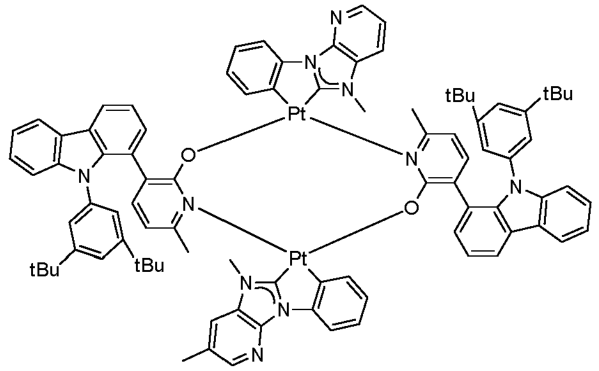,

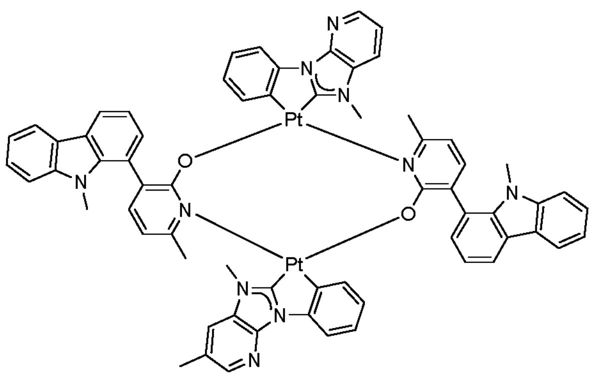 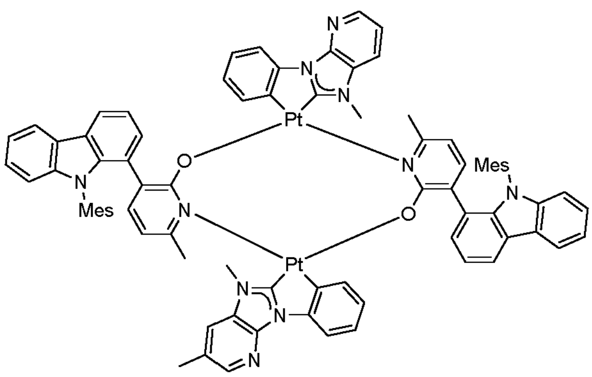.

The photophysical properties of the dinuclear platinum(II) complexes disclosed herein can be evaluated by emission lifetime ("$\tau_{em}$" or "$\tau$"), radiative decay rate ("$k_r$"), non-radiative decay rate, emission quantum yield ("$\Phi_{em}$"), and/or maximum emission wavelength ("$\lambda_{max}$"). Techniques for measuring the $\tau_{em}$, $k_r$, $k_{nr}$, $\Phi_{em}$, and $\lambda_{max}$ of the dinuclear platinum(II) complexes are known. For example, these parameters can be obtained by measuring the emission spectra of a platinum (II) complex. For example, based on the measured emission decay graph, the $\tau_{em}$ of the platinum (II) complex can be obtained as follows: (i) monitor the intensity of emission decay as a function of time using a Quanta Ray GCR 150-10 pulsed Nd:YAG laser system (pulse output: 355 nm), and (ii) determine the $\tau_{em}$ by fitting the exponential decay of formula (1) using Origin software, where $I_0$ is the initial emission intensity, I(t) is the emission intensity at time t, $\tau$ is the emission lifetime, and t is the time.

$$I(t) = I_0 e^{-t/\tau}$$ formula (1)

The $k_r$ of the platinum(II) complex can be obtained using using $k_r = \Phi_{em}/\tau_{em}$. $k_{nr} = (1-\Phi_{em})/\tau_{em}$. The $\Phi_{em}$ values of these Pt complexes can be measured by known methods, such as direct measurements or relative methods. For example, the $\Phi_{em}$ of the disclosed dinuclear platinum(II) complexes in solutions or thin films, can be directly obtained by absolute measurement using Hamamatsu C11347 Quantaurus-QY Absolute PL quantum yield spectrometer (PL stands for photoluminescence). For example, the values for $\Phi_{em}$ are directly given by the software provided with the instrument. The $\lambda_{max}$ of the dinuclear platinum(II) complexes can be directly measured from the emission spectra.

In some forms, the dinuclear platinum(II) complexes of any one of Formulae I-IV and Ia-IVa can have an emission lifetime ($\tau_{em}$) of up to 2.5 $\mu$s, up to 2.0 $\mu$s, up to 1.9 $\mu$s, up to 1.8 $\mu$s, in a range from 0.5 $\mu$s to 2.5 $\mu$s, from 0.8 $\mu$s to 2.5 $\mu$s, from 1.0 $\mu$s to 2.5 $\mu$s, from 0.5 $\mu$s to 2.0 $\mu$s, from 0.8 $\mu$s to 2.0 $\mu$s, from 1.0 $\mu$s to 2.0 $\mu$s, from 0.5 $\mu$s to 1.9 $\mu$s, from 0.8 $\mu$s to 1.9 $\mu$s, from 1.0 $\mu$s to 1.9 $\mu$s, or from 1.2 $\mu$s to 1.9 $\mu$s, such as from 1.7 $\mu$s to 1.9 $\mu$s, in solution or in films at room temperature, such as obtained based on the emission spectra of the dinuclear platinum (II) complexes as described above.

In some forms, the dinuclear platinum(II) complexes of any one of Formulae I-IV and Ia-IVa can have a radiative decay rate ($k_r$) of at least $3.5 \times 10^5$ $s^{-1}$, at least $4.0 \times 10^5$ $s^{-1}$, at least $4.5 \times 10^5$ $s^{-1}$, in a range from $3.5 \times 10^5$ $s^{-1}$ to 10.0 x$10^5$ $s^{-1}$, from $3.5 \times 10^5$ $s^{-1}$ to 8.0 x$10^5$ $s^{-1}$, from $3.5 \times 10^5$ $s^{-1}$ to 6.0 x$10^5$ $s^{-1}$, from $3.5 \times 10^5$ $s^{-1}$ to 5.5 x$10^5$ $s^{-1}$, from $4.0 \times 10^5$ $s^{-1}$ to 10.0 x$10^5$ $s^{-1}$, from $4.0 \times 10^5$ $s^{-1}$ to 8.0 x$10^5$ $s^{-1}$, from $4.0 \times 10^5$ $s^{-1}$ to 6.0 x$10^5$ $s^{-1}$, from $4.0 \times 10^5$ $s^{-1}$ to 5.5 x$10^5$ $s^{-1}$, from $4.2 \times 10^5$ $s^{-1}$ to 10.0 x$10^5$ $s^{-1}$, from $4.2 \times 10^5$ $s^{-1}$ to 8.0 x$10^5$ $s^{-1}$, from $4.2 \times 10^5$ $s^{-1}$ to 6.0 x$10^5$ $s^{-1}$, or from $4.2 \times 10^5$ $s^{-1}$ to 5.5 x$10^5$ $s^{-1}$, such as about $4.3 \times 10^5$ $s^{-1}$ or about 5.5 x$10^5$ $s^{-1}$, in solution or in films at room temperature, such as obtained based on the emission spectra of the dinuclear platinum (II) complexes as described above.

In some forms, the dinuclear platinum(II) complexes of any one of Formulae I-IV and Ia-IVa can have a non-radiative decay rate ($k_{nr}$) of up to $6.0 \times 10^5$ $s^{-1}$, $5.0 \times 10^5$ $s^{-1}$, $4.0 \times 10^5$ $s^{-1}$, $3.0 \times 10^5$ $s^{-1}$, $2.0 \times 10^5$ $s^{-1}$, up to $1.8 \times 10^5$ $s^{-1}$, up to $1.5 \times 10^5$ $s^{-1}$, down to $0.15 \times 10^5$ $s^{-1}$, in a range from $0.15 \times 10^5$ $s^{-1}$ to 6.0 x$10^5$ $s^{-1}$, from $0.15 \times 10^5$ $s^{-1}$ to 5.0 x$10^5$ $s^{-1}$, from $0.15 \times 10^5$ $s^{-1}$ to 4.0 x$10^5$ $s^{-1}$, from $0.15 \times 10^5$ $s^{-1}$ to 3.0 x$10^5$ $s^{-1}$, $0.15 \times 10^5$ $s^{-1}$ to 2.0 x$10^5$ $s^{-1}$, from $0.16 \times 10^5$ $s^{-1}$ to 2.0 x$10^5$ $s^{-1}$, from $0.15 \times 10^5$ $s^{-1}$ to 1.8 x$10^5$ $s^{-1}$, from $0.16 \times 10^5$ $s^{-1}$ to 1.8 x$10^5$ $s^{-1}$, from $0.15 \times 10^5$ $s^{-1}$ to 1.6 x$10^5$ $s^{-1}$, from $0.16 \times 10^5$ $s^{-1}$ to 1.6 x$10^5$ $s^{-1}$, from $0.15 \times 10^5$ $s^{-1}$ to 1.5 x$10^5$ $s^{-1}$, such as from $0.16 \times 10^5$ to $1.4 \times 10^5$ $s^{-1}$, in solution or in films at room temperature, such as obtained based on the emission spectra of the dinuclear platinum (II) complexes as described above.

In some forms, the dinuclear platinum(II) complexes of any one of Formulae I-IV and Ia-IVa can have an emission quantum yield ($\Phi_{em}$) of at least 60%, at least 65%, at least 70%, at least 75%, up to 99%, up to 98%, in a range from 60% to 97%, from 65% to 97%, from 70% to 97%, from 75% to 97%, from 65% to 99%, or from 75% to 99%, such as about 78% or about 97%, in solution or in films at room temperature, such as obtained based on the emission spectra of the dinuclear platinum(II) complexes as described above.

In some forms, the dinuclear platinum(II) complexes of any one of Formulae I-IV and Ia-IVa can have a maximum emission wavelength ($\lambda_{max}$) in a range from 600 nm to 1000 nm, from 600 nm to 900 nm, from 600 nm to 800 nm, from 600 nm to 760 nm, from 600 nm to 700 nm, from 600 nm to 680 nm, from 620 nm to 710 nm, or from 612 nm to 685 nm, obtained based on the emission spectra of the dinuclear platinum(II) complexes as described above. As used herein, near infrared ("Near-IR" or "NIR") $\lambda_{max}$ is in the range of 700 nm to 1000 nm, inclusive. As used herein, red $\lambda_{max}$ is in the range of 600 nm to 700 nm, inclusive. A $\lambda_{max}$ of exactly 700 nm can be considered either red or near infrared. However, in the context of a range of $\lambda_{max}$, whether 700 nm should be considered a near infrared $\lambda_{max}$ or a red $\lambda_{max}$ can be determined by whether 700 nm is the high endpoint or the low endpoint. In the context of a range of $\lambda_{max}$ that spans below and above 700 nm, the range, and the 700 nm point, can be considered to encompass both red $\lambda_{max}$ and near infrared $\lambda_{max}$.

In some forms, the dinuclear platinum(II) complexes of any one of Formulae I-IV and Ia-IVa can have a $\tau_{em}$, a $k_r$, a $k_{nr}$, a $\Phi_{em}$, and/or a $\lambda_{max}$ in any one of the above-described ranges.

Exemplary solutions suitable for measuring the $\tau_{em}$, $k_r$, $k_{nr}$, $\Phi_{em}$, and/or $\lambda_{max}$ of the dinuclear platinum(II) complexes include those that contain an organic solvent. Exemplary organic solvents suitable for use to form the measurement solutions include, but are not limited to, dichloromethane, chloroform, tetrahydrofuran, chlorobenzene, and toluene, and a combination thereof. Optionally, the solutions for measuring the $\tau_{em}$, $k_r$, $k_{nr}$, $\Phi_{em}$, and/or $\lambda_{max}$ of the dinuclear platinum(II) complexes is degassed with an inert gas, such as nitrogen, argon, or helium, or a combination thereof. Optionally, the solutions for measuring the $\tau_{em}$, $k_r$, $k_{nr}$, $\Phi_{em}$, and/or $\lambda_{max}$ of the dinuclear platinum(II) complexes is deoxygenated by the known freeze-pump-thaw method.

Suitable thin films for measuring the $\tau_{em}$, $k_r$, $k_{nr}$, $\Phi_{em}$, and/or $\lambda_{max}$ of the dinuclear platinum(II) complexes include films having a thickness between 10 nm and 5 $\mu$m, inclusive, or between 10 nm and 200 nm, inclusive. The films can also contain organic compounds as hot materials. Exemplary organic compounds that can be used as a host material in the films include, but are not limited to, 1,3-bis(N-carbazolyl)benzene (mCP), 3,3'-di(9H-carbazol-9-yl)-1,1'-biphenyl (mCBP), poly(methyl methacrylate) (PMMA), polystyrene (PS), 2,8-bis(diphenylphosphoryl)dibenzo[b,d]furan (PPF), bis[2-(diphenylphosphino)phenyl]ether oxide (DPEPO).

**B. Devices Containing Dinuclear Platinum(II) Complexes**

Organic light-emitting components, such as light-emitting diodes (OLEDs) or light-emitting electrochemical cell ("LEEC"), containing one or more of the dinuclear platinum(II) complexes are described. In some forms, the organic light-emitting components also contain one or more organic dyes, such as multiple resonance red emitter ("MR-R1"). Other examples of organic light-emitting devices suitable for incorporation of the dinuclear platinum(II) complexes disclosed herein include, but are not limited to, light-emitting electrochemical cells (LEECs). Devices containing one or more OLEDs containing one or more of the dinuclear platinum(II) complexes include, but are not limited to, stationary visual display units, mobile visual display units, and illumination devices, such as smart phones, televisions, monitors, digital cameras, tablet computers, and lighting fixtures that usually operate at room temperatures, wearable devices, and medical monitoring devices.

In some forms, the dinuclear platinum(II) complexes can be incorporated in a light-emitting layer. The light-emitting layer further contains one or more organic dyes, such as MR-R1. When a dye is incorporated in the light-emitting layer, the dinuclear platinum(II) complexes and dye can have any suitable weight ratios, such as 20: 1. In some forms, the one or more dinuclear platinum(II) complexes in the light emitting layer can act as a sensitizer to transfer energy to the organic dye. In some forms, the one or more dinuclear platinum(II) complexes in the light emitting layer can have a higher-lying singlet state than the organic dye.

In some forms, the light-emitting layer can be incorporated in an organic light-emitting component, such as an OLED. Organic light-emitting components can contain one or more light-emitting layers, where each light-emitting layer can contain one or more the disclosed dinuclear platinum(II) complexes. In some forms, the light-emitting layer or each light-emitting layer when two or more light-emitting layers are included in the organic light-emitting component further includes one or more host materials, such as those described above. Typically, the total concentration of the one or more host materials is greater than the total concentration of the one or more dinuclear platinum(II) complexes in the light-emitting layer or each light-emitting layer of the two or more light-emitting layers. The term "total concentration of the one or more dinuclear platinum(II) complexes" refers to the sum of the weight of the one or more dinuclear platinum(II) complexes relative to the sum of the weights of all of the materials used in one light-emitting layer in an organic light-emitting device, such as an OLED. The term "total concentration of the one or more one or more host materials" refers to the sum of the weight of the one or more host materials relative to the sum of the weights of all of the materials used in one light-emitting layer in an organic light-emitting device, such as an OLED.

The organic light-emitting devices can contain a suitable amount of the dinuclear platinum(II) complexes in the light-emitting layer or each light-emitting layer of the two or more light-emitting layers of the device. For example, the total concentration of the one or more dinuclear platinum(II) complexes in the light-emitting layer or each light-emitting layer of the two or more light-emitting layers is up to 50 wt%, up to 40 wt%, up to 30 wt%, up to 20 wt%, at least 1 wt%, in a range from about 1 wt% to about 50 wt%, from about 1 wt% to about 40 wt%, from about 1 wt% to about 30 wt%, from about 1 wt% to about 20 wt%, from about 2 wt% to about 50 wt%, from about 2 wt% to about 40 wt%, from about 2 wt% to about 30 wt%, from about 2 wt% to about 20 wt%, from about 4 wt% to about 50 wt%, from about 4 wt% to about 40 wt%, from about 4 wt% to about 30 wt%, from about 4 wt% to about 20 wt%, from about 1 wt% to about 16 wt%, from about 2 wt% to about 16 wt%, from about 4 wt% to about 16 wt%, such as about 4 wt%, about 8 wt%, or about 12 wt%.

In some forms, the organic light-emitting component, such as an OLED, can further include an anode, a cathode, a hole transport region, and/or an electron transport region. The hole transport region can include a hole injection layer and/or a hole transport layer, and optionally an electron blocking layer. The electron transport region can include an electron transport layer and/or an electron injection layer, and optionally a hole blocking layer. The light-emitting layer can be located in between the anode and the cathode. The hole transport region can be located in between the anode and the light-emitting layer. The electron transport region can be located in between the cathode and the light-emitting layer. The specific components and arrangement of the components in each of the hole transport region and the electron transport region depend on the specific use.

An exemplary OLED containing the disclosed dinuclear platinum(II) complexes is illustrated in Figure 12. As shown in Figure 12, the exemplary OLED 100 includes multiple layers, which are, from bottom to top, a substrate 101, an anode 102, a hole injection layer 103, a hole transport layer 104, an optional electron blocking layer 105, an emission layer 106, an optional hole blocking layer 107, an electron transport layer 108, an electron injection layer 109, and a cathode 110. The emission layer 106 is formed by one or more of the dinuclear platinum(II) complexes disclosed herein. Suitable materials for forming the anode, the hole injection layer, the hole transport layer, the optional electron blocking layer, the optional hole blocking layer, the electron transport layer, the electron injection layer, and the cathode are known in the art, *see,* for example, those described in Hong, et al., Adv. Mater. 2021, 2005630; Lee, et al., InfoMat. 2021, 3, 61-81; and Jou, et al., J. Mater. Chem. C, 2015, 3, 2974-3002. The dimensions of each layer in the OLED, such as the shape, the length, the width, and/or the thickness of each layer can be varied depending on the specific use of the OLED. More specific exemplary OLEDs are described in the Examples below.

These organic light-emitting devices containing the disclosed dinuclear platinum(II) complexes can emit in the

red to NIR regions ($\lambda_{max}$ ranging from 610 nm to 1000 nm) with high efficiency (an $\Phi_{em} \geq 0.60$ measured in thin films, such as about 0.81 or about 0.97; a $\tau_{em} \leq 2.5$ μs, such as 1.7-1.9 μs; a $k_r \geq 3.5\times10^5$ $s^{-1}$, such as about $4.3\times10^5$ $s^{-1}$ or about $5.5\times10^5$ $s^{-1}$; and/or a $k_{nr} \leq 6\times10^5$ $s^{-1}$, such as $0.16\times10^5$-$6\times10^5$ $s^{-1}$ or $0.16\times10^5$-$1.4\times10^5$ $s^{-1}$) at room temperature. The performance of OLEDs containing the disclosed dinuclear platinum(II) complexes can be evaluated using maximum brightness (L), maximum current efficiency (max CE), CE at 1000 cd $m^{-2}$, maximum power efficiency (max PE), PE at 1000 cd $m^{-2}$, maximum external quantum efficiency (max EQE), and/or EQE at 1000 cd $m^{-2}$. Techniques for measuring the brightness, current efficiency, power efficiency, and/or external quantum efficiency are known. For example, maximum brightness is measured at which any increase in voltage does not lead to an increase in brightness (the device may burn out if the voltage is further increased). For example, the EQE, CE, and PE of an electroluminescence device can be obtained by using a Keithley 2400 source-meter and an absolute external quantum efficiency measurement system (C9920-12, Hamamatsu Photonics), where all devices can be encapsulated in a 200-nm-thick $Al_2O_3$ thin film deposited by atomic layer deposition (ALD) in a Kurt J. Lesker SPECTROS ALD system before measurements.

In some forms, OLEDs containing from 4 wt% to 12 wt% of the disclosed dinuclear platinum(II) complexes can emit in the red to deep red region ($\lambda_{max}$ in a range from about 600 nm to about 700 nm) with a maximum brightness (L) of at least 20000 cd $m^{-2}$, at least 25000 cd $m^{-2}$, at least 30000 cd $m^{-2}$, at least 35000 cd $m^{-2}$, at least 40000 cd $m^{-2}$, in a range from 20000 cd $m^{-2}$ to 100000 cd $m^{-2}$, from 25000 cd $m^{-2}$ to 100000 cd $m^{-2}$, from 30000 cd $m^{-2}$ to 100000 cd $m^{-2}$, from 35000 cd $m^{-2}$ to 100000 cd $m^{-2}$, from 40000 cd $m^{-2}$ to 100000 cd $m^{-2}$, from 20000 cd $m^{-2}$ to 80000 cd $m^{-2}$, from 25000 cd $m^{-2}$ to 80000 cd $m^{-2}$, from 30000 cd $m^{-2}$ to 80000 cd $m^{-2}$, from 35000 cd $m^{-2}$ to 80000 cd $m^{-2}$, from 40000 cd $m^{-2}$ to 80000 cd $m^{-2}$, from 20000 cd $m^{-2}$ to 60000 cd $m^{-2}$, from 25000 cd $m^{-2}$ to 60000 cd $m^{-2}$, from 30000 cd $m^{-2}$ to 60000 cd $m^{-2}$, from 35000 cd $m^{-2}$ to 60000 cd $m^{-2}$, from 40000 cd $m^{-2}$ to 60000 cd $m^{-2}$, from 20000 cd $m^{-2}$ to 50000 cd $m^{-2}$, from 25000 cd $m^{-2}$ to 50000 cd $m^{-2}$, from 30000 cd $m^{-2}$ to 50000 cd $m^{-2}$, from 35000 cd $m^{-2}$ to 50000 cd $m^{-2}$, or from 40000 cd $m^{-2}$ to 50000 cd $m^{-2}$.

In some forms, OLEDs containing from 4 wt% to 12 wt% of the disclosed dinuclear platinum(II) complexes can emit in the red to deep red region ($\lambda_{max}$ in a range from about 600 nm to about 700 nm) with a CE at 1000 cd $m^{-2}$ of at least 20 cd/A, at least 22 cd/A, in a range from 20 cd/A to 60 cd/A, from 22 cd/A to 60 cd/A, from 20 cd/A to 50 cd/A, from 22 cd/A to 50 cd/A, from 20 cd/A to 40 cd/A, or from 20 cd/A to 30 cd/A.

In some forms, OLEDs containing from 4 wt% to 12 wt% of the disclosed dinuclear platinum(II) complexes can emit in the red to deep red region ($\lambda_{max}$ in a range from about 600 nm to about 700 nm) with a PE at 1000 cd/$m^2$ of at least 10 lm/W, in a range from 10 lm/W to 60 lm/W, from 15 lm/W to 60 lm/W, from 10 lm/W to 50 lm/W, from 15 lm/W to 50 lm/W, from 10 lm/W to 40 lm/W, from 15 lm/W to 40 lm/W, from 10 lm/W to 30 lm/W, from 15 lm/W to 30 lm/W, or from 10 lm/W to 20 lm/W.

In some forms, OLEDs containing from 4 wt% to 12 wt% of the disclosed dinuclear platinum(II) complexes can emit in the red to deep red region ($\lambda_{max}$ in a range from about 600 nm to about 700 nm) with an EQE at 1000 cd/$m^2$ of at least 10%, at least 11%, at least 12%, at least 13%, at least 14%, at least 15%, in a range from 10% to 40%, from 10% to 20%, from 10% to 20%, from 11% to 40%, from 11% to 30%, from 11% to 20%, from 12% to 20%, from 12% to 40%, from 12% to 30%, from 13% to 20%, from 13% to 40%, from 13% to 30%, from 14% to 20%, from 14% to 40%, from 14% to 30%, from 15% to 40%, from 15% to 30%, or from 15% to 20%.

In some forms, OLEDs containing from 4 wt% to 12 wt% of the disclosed dinuclear platinum(II) complexes can emit in the red to deep red region ($\lambda_{max}$ in a range from about 600 nm to about 700 nm) with a maximum brightness (L), a CE at 1000 cd $m^{-2}$, a PE at 1000 cd/$m^2$, and/or an EQE at 1000 cd/$m^2$ in any of the ranges described above.

In some forms, OLEDs containing from 4 wt% to 12 wt% of the disclosed dinuclear platinum(II) complexes can emit in the NIR region ($\lambda_{max}$ in a range from about 700 nm to about 1000 nm) with a maximum brightness (L) of at least 1000 cd $m^{-2}$, at least 2000 cd $m^{-2}$, at least 3000 cd $m^{-2}$, at least 4000 cd $m^{-2}$, at least 4200 cd $m^{-2}$, at least 4500 cd $m^{-2}$, in a range from 1000 cd $m^{-2}$ to 40000 cd $m^{-2}$, from 1000 cd $m^{-2}$ to 40000 cd $m^{-2}$, from 1000 cd $m^{-2}$ to 40000 cd $m^{-2}$, from 4000 cd $m^{-2}$ to 40000 cd $m^{-2}$, from 4500 cd $m^{-2}$ to 40000 cd $m^{-2}$, from 1000 cd $m^{-2}$ to 30000 cd $m^{-2}$, from 2000 cd $m^{-2}$ to 30000 cd $m^{-2}$, from 3000 cd $m^{-2}$ to 30000 cd $m^{-2}$, from 4000 cd $m^{-2}$ to 30000 cd $m^{-2}$, from 4500 cd $m^{-2}$ to 30000 cd $m^{-2}$, from 1000 cd $m^{-2}$ to 20000 cd $m^{-2}$, from 2000 cd $m^{-2}$ to 20000 cd $m^{-2}$, from 3000 cd $m^{-2}$ to 20000 cd $m^{-2}$, from 4000 cd $m^{-2}$ to 20000 cd $m^{-2}$, from 4500 cd $m^{-2}$ to 20000 cd $m^{-2}$, from 1000 cd $m^{-2}$ to 10000 cd $m^{-2}$, from 2000 cd $m^{-2}$ to 10000 cd $m^{-2}$, from 3000 cd $m^{-2}$ to 10000 cd $m^{-2}$, from 4000 cd $m^{-2}$ to 10000 cd $m^{-2}$, or from 4500 cd $m^{-2}$ to 10000 cd $m^{-2}$.

In some forms, OLEDs containing from 4 wt% to 12 wt% of the disclosed dinuclear platinum(II) complexes can emit in the NIR region ($\lambda_{max}$ in a range from about 700 nm to about 1000 nm) with a CE at 1000 cd $m^{-2}$ of at least 0.2 cd $A^{-1}$, at least 0.4 cd $A^{-1}$, at least 0.8 cd $A^{-1}$, in a range from 0.2 cd/A to 10 cd/A, from 0.4 cd/A to 10 cd/A, from 0.8 cd/A to 10 cd/A, from 0.2 cd/A to 8 cd/A, from 0.4 cd/A to 8 cd/A, from 0.8 cd/A to 8 cd/A, from 0.2 cd/A to 5 cd/A, from 0.4 cd/A to 5 cd/A, from 0.8 cd/A to 5 cd/A, from 0.2 cd/A to 3 cd/A, from 0.4 cd/A to 3 cd/A, from 0.8 cd/A to 3 cd/A, from 0.2 cd/A to 2 cd/A, from 0.4 cd/A to 2 cd/A, or from 0.8 cd/A to 2 cd/A.

In some forms, OLEDs containing from 4 wt% to 12 wt% of the disclosed dinuclear platinum(II) complexes can emit in the NIR region ($\lambda_{max}$ in a range from about 700 nm to about 1000 nm) with a PE at 1000 cd/$m^2$ of at least 0.1 lm/W, at least 0.2 lm/W, in a range from 0.1 lm/W to 5 lm/W, from 0.1 lm/W to 4 lm/W, from 0.1 lm/W to 3 lm/W, from 0.1 lm/W to 2 lm/W, from 0.1 lm/W to 1 lm/W, from 0.1 lm/W to 0.5 lm/W, from 0.2 lm/W to 5 lm/W, from 0.2 lm/W to 4 lm/W, from 0.2 lm/W

to 3 lm/W, from 0.2 lm/W to 2 lm/W, from 0.2 lm/W to 1 lm/W, or from 0.2 lm/W to 0.5 lm/W.

In some forms, OLEDs containing from 4 wt% to 12 wt% of the disclosed dinuclear platinum(II) complexes can emit in the NIR region ($\lambda_{max}$ in a range from about 700 nm to about 1000 nm) with an EQE at 1000 cd/m$^2$ of at least 1%, at least 2%, at least 4%, at least 5%, at least 6%, in a range from 1% to 20%, from 1% to 18%, from 1% to 15%, from 1% to 10%, from 2% to 20%, from 2% to 18%, from 2% to 15%, from 2% to 10%, from 4% to 20%, from 4% to 18%, from 4% to 15%, from 4% to 10%, from 5% to 20%, from 5% to 18%, from 5% to 15%, or from 5% to 10%.

In some forms, OLEDs containing from 4 wt% to 12 wt% of the disclosed dinuclear platinum(II) complexes can emit in the NIR region ($\lambda_{max}$ in a range from about 700 nm to about 1000 nm) with a maximum brightness (L), a CE at 1000 cd m$^{-2}$, a PE at 1000 cd/m$^2$, and/or an EQE at 1000 cd/m$^2$ in any of the ranges described above.

More specific examples of the maximum brightness, current efficiency, power efficiency, and external quantum efficiency of exemplary OLEDs containing exemplary dinuclear platinum(II) complexes disclosed herein are described in the Examples below.

### III. Methods of Making and Reagents therefor

#### A. Dinuclear Platinum (II) Complexes

The dinuclear platinum(II) complexes and the ligands described herein can be synthesized using methods known in the art of organic chemical synthesis. For example, ligands can be purchased from commercial chemical manufacturers or may be prepared according to procedures reported and/or adapted from the literature. In some forms, 2-hydroxy-pyridine ligands described herein and used in the examples below can be readily obtained from commercial chemical manufacturers. Exemplary syntheses of imidazolyl N-heterocyclic carbene ligands are described in the Examples below. The selection of appropriate synthetic conditions, reagents, reaction workup conditions, purification techniques (as needed) are known to those in the field of synthesis. Exemplary and non-limiting syntheses of ligands and dinuclear platinum(II) complexes are discussed in the Examples below.

#### B. Organic light-emitting components

Also described are methods of making organic light-emitting components, such as OLEDs, containing one or more dinuclear platinum(II) complexes described herein. Methods of preparing OLEDs containing one or more dinuclear platinum(II) emitter complexes, as described above, are well-known in the art of organic electronics. Such method of making OLEDs can involve vacuum deposition or solution processing techniques, such as spin-coating and ink-jet printing. The selection of suitable materials (anode, cathode, hole transport layer, electron transport layer, etc.) and fabrication parameters (such as deposition conditions or solvent selections) needed to fabricate OLEDs containing the dinuclear platinum(II) complexes described herein are known in the art. In some forms, preparation of the OLEDs can be via vacuum deposition or solution processing techniques such as spin-coating and ink printing (such as, ink-jet printing or roll-to-roll printing). An exemplary and non-limiting method of making an OLED containing one or more dinuclear platinum(II) complexes described herein is disclosed in the Examples.

### IV. Methods of Using

The dinuclear platinum(II) complexes described herein are emissive in the red to NIR spectral region ($\lambda_{max}$ at 610-1000 nm, such as 612-685 nm), with a high emission quantum yield (i.e. $\Phi_{em} \geq 0.60$ measured in thin films, such as about 0.78 or about 0.97), a short emission lifetime (i.e. $\tau_{em} \leq 2.5$ $\mu$s, such as 1.7-1.9 $\mu$s), a fast radiative decay rate (i.e. $k_r \geq 4.5\times10^5$ s$^{-1}$, such as about $4.3\times10^5$ s$^{-1}$ or about $5.5\times10^5$ s$^{-1}$), and/or a slow non-radiative decay rate (i.e. $k_{nr} \leq 2\times10^5$ s$^{-1}$, such as $0.16\times10^5$-$1.4\times10^5$ s$^{-1}$), at room temperature or other low temperatures, such as at a temperature in the range from 285 K to 300 K. Accordingly, the dinuclear platinum(II) emitters complexes can be incorporated into organic electronic components including, but not limited to, OLEDs or a light-emitting electrochemical cell (LEEC). Such OLEDs can be used in commercial applications such smart phones, televisions, monitors, digital cameras, tablet computers, lighting fixtures that usually operate at room temperatures, a fixed visual display unit, mobile visual display unit, illumination unit, keyboard, clothes, ornaments, garment accessary, wearable devices, medical monitoring devices, wall paper, tablet PC, laptop, advertisement panel, panel display unit, household appliances, and office appliances.

The disclosed compositions and methods can be further understood through the following numbered paragraphs.

Paragraph 1. A dinuclear platinum(II) complex having a structure:

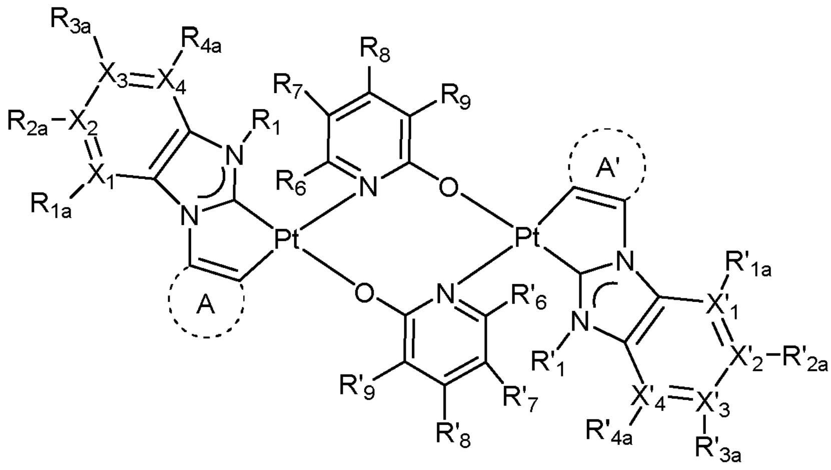

Formula I'

wherein:

(i) the complex is an overall neutral, negative, or positive charge;
(ii) $X_1$-$X_4$ and $X'_1$-$X'_4$ are independently carbon, nitrogen, sulfur, or oxygen;
(iii) $R_{1a}$-$R_{4a}$, $R'_{1a}$-$R'_{4a}$, $R_1$, $R'_1$, $R_6$-$R_9$, and $R'_6$-$R'_9$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, unsubstituted $C_2$-$C_{20}$ heterocyclyl, borenium cation, phosphonyl, sulfinyl, or sulfonyl, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, fused combinations thereof, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof;
(iv) A and A' are independently a substituted cycloalkyl, an unsubstituted cycloalkyl, a substituted cycloalkenyl, an unsubstituted cycloalkenyl, a substituted cycloalkynyl, an unsubstituted cycloalkynyl, a substituted heterocyclyl, an unsubstituted heterocyclyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, or fused combinations thereof; preferably A and A' are independently a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof; and
(v) each substituent is independently a substituted or unsubstituted alkyl, a substituted or unsubstituted alkenyl, a substituted or unsubstituted alkynyl, a substituted or unsubstituted heterocyclyl, a substituted or unsubstituted aryl, a substituted or unsubstituted heteroaryl, a substituted or unsubstituted polyaryl, a substituted or unsubstituted polyheteroaryl, a substituted or unsubstituted aralkyl, a carbonyl, an alkoxy, a halogen, a hydroxyl, a phenoxy, a thiol, an alkylthio, a phenylthio, an arylthio, a cyano, an isocyano, a nitro, a carboxyl, an amino, an amido, an oxo, a silyl, a sulfinyl, a sulfonyl, a sulfonic acid, a phosphonium, a phosphanyl, a phosphoryl, or a phosphonyl.

Paragraph 2. The dinuclear platinum(II) complex of paragraph 1, wherein the dinuclear platinum(II) has a structure:

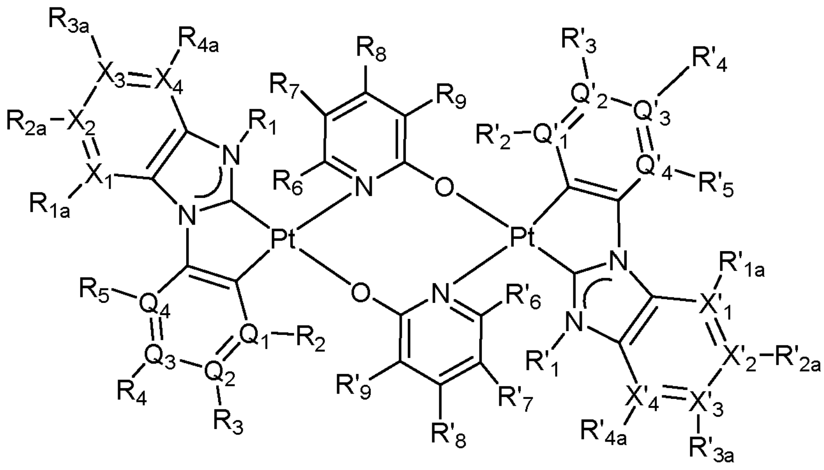

or

Formula I

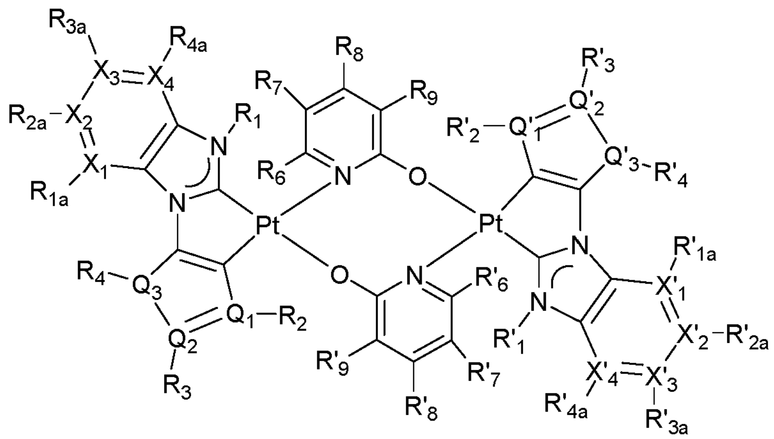

Formula Ia

wherein:

(i) the complex has an overall neutral, negative, or positive charge;
(ii) $Q_1$-$Q_4$ and $Q'_1$-$Q'_4$ are independently carbon, nitrogen, sulfur, or oxygen; and(iii) $R_2$-$R_5$ and $R'_2$-$R'_5$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl, borenium cation, phosphonyl, sulfinyl, or sulfonyl, or $R_2$ and $R_3$ together, $R_3$ and $R_4$ together, $R_4$ and $R_5$ together, $R'_2$ and $R'_3$ together, $R'_3$ and $R'_4$ together, and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, fused combinations thereof, or $R_2$ and $R_3$ together, $R_3$ and $R_4$ together, $R_4$ and $R_5$ together, $R'_2$ and $R'_3$ together, $R'_3$ and $R'_4$ together, and/or $R'_4$ and $R'_5$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof.

Paragraph 3. The complex of paragraph 1 or 2, wherein the complex has a structure:

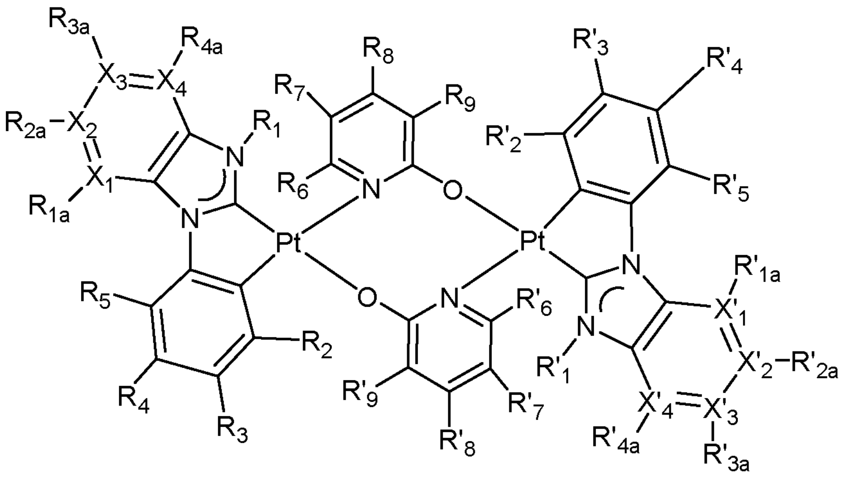

or

Formula II

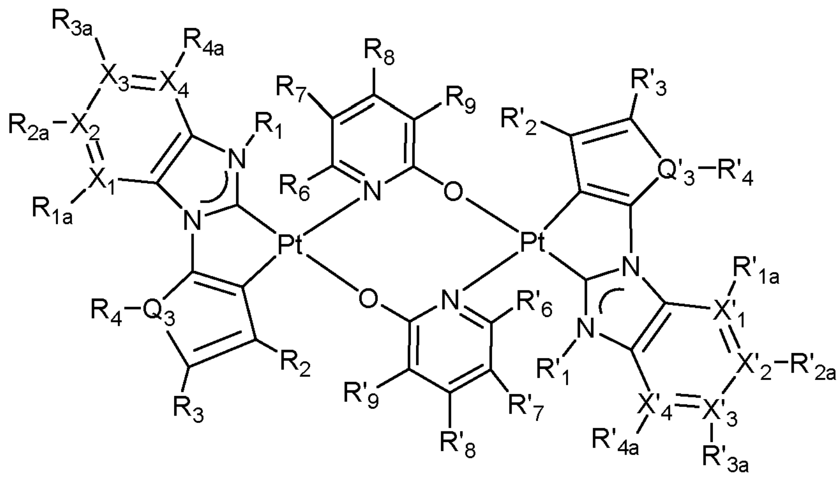

Formula IIa

Paragraph 4. The complex of any one of paragraphs 1-3, wherein the complex has the structure:

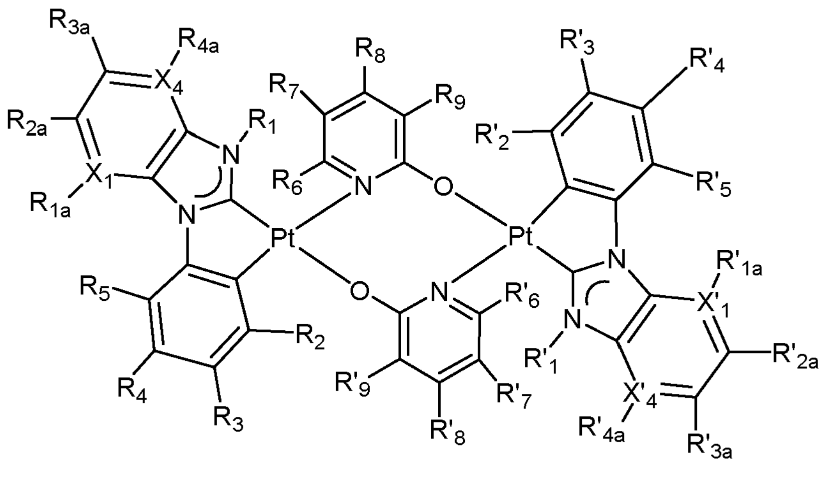

or

Formula III

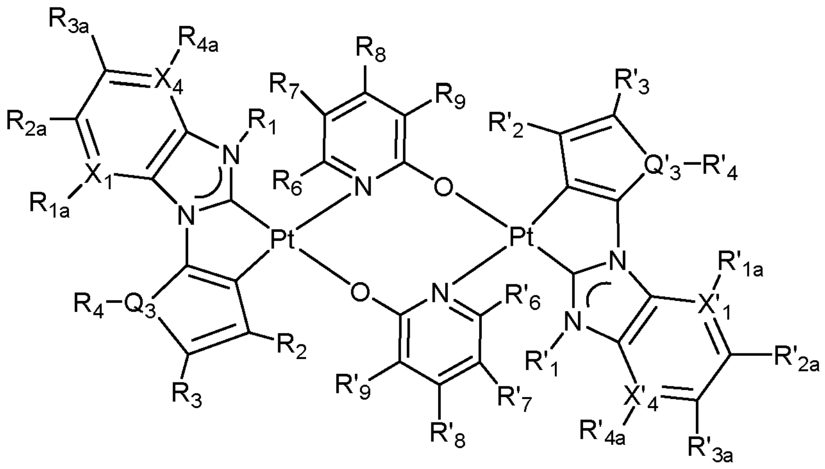

Formula IIIa

Paragraph 5. The complex of any one of paragraphs 1-4, wherein the complex has the structure:

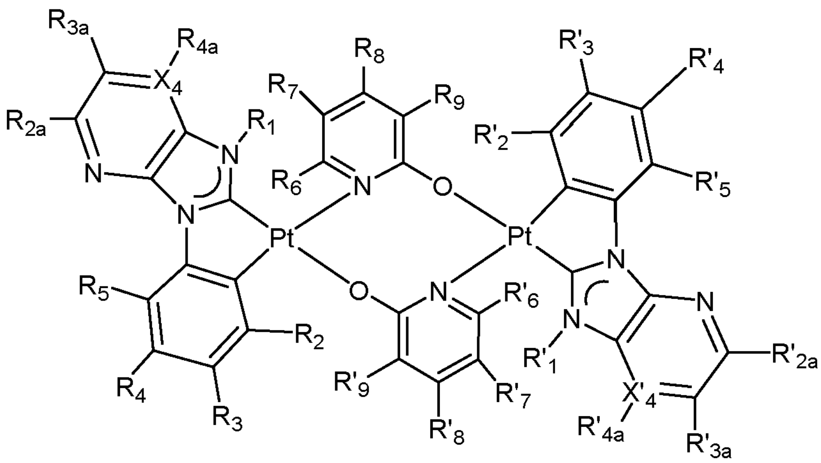

or

Formula IV

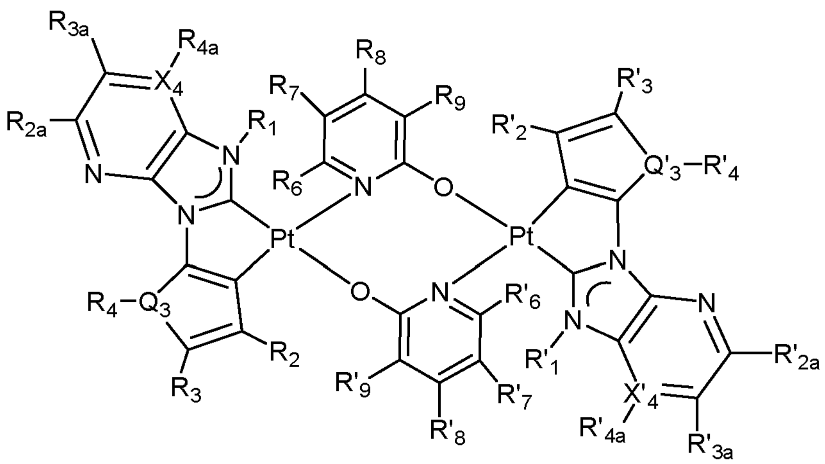

Formula IVa

Paragraph 6. The complex of any one of paragraphs 1-5, wherein $X_4$ and $X'_4$ are carbon; and $R_{4a}$ and $R'_{4a}$ are independently hydrogen, substituted alkyl, unsubstituted alkyl, substituted aryl, unsubstituted aryl, hydroxyl, unsubstituted heteroaryl, substituted heteroaryl, unsubstituted polyaryl, substituted polyaryl, unsubstituted polyheteroaryl, sub-

stituted polyheteroaryl, substituted $C_2$-$C_{20}$ heterocyclyl, or unsubstituted $C_2$-$C_{20}$ heterocyclyl.

Paragraph 7. The complex of paragraph 6, wherein $X_4$ and $X'_4$ are carbon and $R_{4a}$ and $R'_{4a}$ are independently hydrogen, unsubstituted alkyl, unsubstituted aryl, unsubstituted polyaryl, hydroxyl, unsubstituted heteroaryl, unsubstituted polyheteroaryl, unsubstituted $C_2$-$C_{20}$ heterocyclyl, or unsubstituted alkylaryl, such as hydrogen.

Paragraph 8. The complex of any one of paragraphs 1-5, wherein $X_4$ and $X'_4$ are nitrogen; $R_{4a}$ and $R'_{4a}$ are absent, and optionally wherein $R_{2a}$, $R_{3a}$, $R'_{2a}$, and $R'_{3a}$ are independently hydrogen, unsubstituted alkyl (e.g., methyl, ethyl, n-propyl, isopropyl, n-butyl, sec-butyl, isobutyl, tert-butyl, etc.), substituted alkyl, unsubstituted aryl (e.g., unsubstituted phenyl), or alkoxy (e.g., -O-alkyl, -O-aryl, -O-polyaryl, etc.), or $R_{2a}$ and $R_{3a}$ together and/or $R'_{2a}$ and $R'_{3a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl.

Paragraph 9. The complex of any one of paragraphs 1-4, wherein $X_1$-$X_4$ and $X'_1$-$X'_4$ are carbon; and $R_{1a}$-$R_{4a}$ and $R'_{1a}$-$R'_{4a}$ are independently hydrogen, unsubstituted alkyl (e.g., methyl, ethyl, n-propyl, isopropyl, n-butyl, sec-butyl, isobutyl, tert-butyl, etc.), substituted alkyl, unsubstituted aryl (e.g., unsubstituted phenyl), or alkoxy (e.g., - O-alkyl, -O-aryl, -O-polyaryl, etc.), or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, and/or $R'_{3a}$ and $R'_{4a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl, for example, $R_{1a}$ and $R_{2a}$ together, $R_{3a}$ and $R_{4a}$ together, $R'_{1a}$ and $R'_{2a}$ together, and $R'_{3a}$ and $R'_{4a}$ together, with the atom to which they are attached, form a substituted aryl or unsubstituted aryl, or $R_{2a}$ and $R_{3a}$ together and $R'_{2a}$ and $R'_{3a}$ together, with the atom to which they are attached, form a substituted aryl or unsubstituted aryl.

Paragraph 10. The complex of any one of paragraphs 2-9, wherein $R_1$-$R_9$ and $R'_1$-$R'_9$ are independently hydrogen, halogen, unsubstituted alkyl (e.g., methyl, ethyl, n-propyl, isopropyl, n-butyl, sec-butyl, isobutyl, tert-butyl, etc.), substituted alkyl, unsubstituted aryl, substituted aryl (e.g., mesitylene or other aryl substituted with one or more alkyls, such as methyl, ethyl, n-propyl, isopropyl, n-butyl, sec-butyl, isobutyl, tert-butyl, etc.), unsubstituted polyaryl, substituted polyaryl, hydroxyl, unsubstituted heteroaryl, substituted heteroaryl, unsubstituted polyheteroaryl, substituted polyheteroaryl, unsubstituted $C_2$-$C_{20}$ heterocyclyl, substituted $C_2$-$C_{20}$ heterocyclyl, unsubstituted alkylaryl, substituted alkylaryl, alkoxy (e.g., -O-alkyl, -O-aryl, -O-polyaryl, etc.), borenium cation (e.g., $-B(Mes)_2$), phosphonyl (e.g., $-P(=O)(Ph)_2$, - P(=O) $(alkyl)_2$, etc.), or sulfinyl (e.g., $-S(=O)(Ph)_2$, $-S(=O)(alkyl)_2$, etc.), or sulfonyl - $S(=O)_2(Ph)_2$, $-S(=O)_2(alkyl)_2$, etc.), or $R_2$ and $R_3$ together, $R'_2$ and $R'_3$ together, $R_3$ and $R_4$ together, $R'_3$ and $R'_4$ together, $R_4$ and $R_5$ together, $R'_4$ and R's together, $R_6$ and $R_7$ together, $R_7$ and $R_8$ together, $R_8$ and $R_9$ together, $R'_6$ and $R'_7$ together, $R'_7$ and R's together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof.

Paragraph 11. The complex of paragraph 10, wherein one or more of $R_1$-$R_9$ and $R'_1$-$R'_9$ is

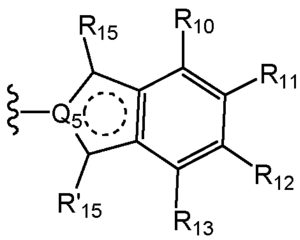

or

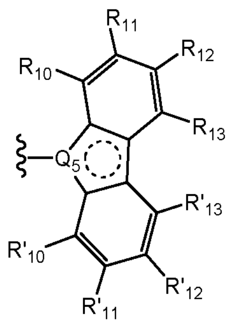

,

wherein $Q_5$ is nitrogen or carbon; and $R_{10}$-$R_{13}$, $R_{15}$, $R'_{15}$, and $R'_{10}$-$R'_{13}$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl, such as hydrogen or unsubstituted alkyl.

Paragraph 12. The complex of paragraph 11, wherein $Q_5$ is nitrogen; and $R_{10}$-$R_{13}$, $R_{15}$, $R'_{15}$, and $R'_{10}$-$R'_{13}$ are independently absent, hydrogen, substituted alkyl, unsubstituted alkyl, substituted phenyl group, unsubstituted phenyl,

alkoxy, halogen, borenium cation (e.g., -B(Mes)$_2$), phosphonyl, or sulfinyl, such as hydrogen.

Paragraph 13. The complex of any one of paragraphs 2-12, wherein: (i) $R_2$ and $R_3$ together and/or $R'_2$ and $R'_3$ together, or (ii) $R_3$ and $R_4$ together and/or $R'_3$ and $R'_4$ together, or (iii) $R_4$ and $R_5$ together and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl.

Paragraph 14. The complex of paragraph 13, wherein: (i) $R_2$ and $R_3$ together and/or $R'_2$ and $R'_3$ together, or (ii) $R_3$ and $R_4$ together and/or $R'_3$ and $R'_4$ together, or (iii) $R_4$ and $R_5$ together and/or $R'_4$ and $R'_5$ together, form

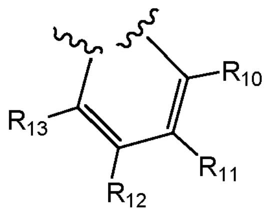

or

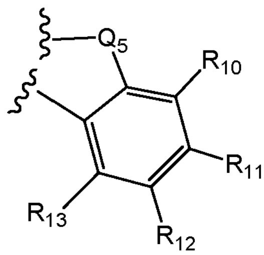

,

wherein $Q_5$ is $NR_{14}$, $CR_{16}R_{17}$, or sulfur, or oxygen; and $R_{10}$-$R_{14}$, $R_{16}$, and $R_{17}$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl, optionally wherein $Q_5$ is $NR_{14}$, $CR_{16}R_{17}$, sulfur, or oxygen, such as oxygen; and $R_{10}$-$R_{14}$, $R_{16}$, and $R_{17}$ are independently absent, hydrogen, substituted alkyl, unsubstituted alkyl, substituted phenyl group, unsubstituted phenyl, alkoxy, halogen, borenium cation (e.g., - B(Mes)$_2$), phosphonyl, or sulfinyl, such as hydrogen.

Paragraph 15. The complex of any one of paragraphs 2-14, wherein $R_6$-$R_9$ and $R'_6$-$R'_9$, are independently hydrogen, halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., -B(Mes)$_2$), phosphonyl (e.g., -P(=O)(Ph)$_2$, - P(=O)(alkyl)$_2$, etc.), substituted heteroaryl, or unsubstituted heteroaryl, or $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl or an unsubstituted aryl, such as a substituted phenyl or unsubstituted phenyl, optionally wherein at least one of $R_6$-$R_9$ and at least one of $R'_6$-$R'_9$ are not hydrogen.

Paragraph 16. The complex of any one of paragraphs 2-15, wherein $Q_3$ and $Q'_3$ of Formulae Ia-IVa are independently sulfur or oxygen.

Paragraph 17. The complex of any one of paragraphs 2-12, 15, and 16, wherein $R_2$, $R_4$, $R_5$, $R'_2$, $R'_4$, $R'_5$, $R_7$, $R_8$, $R'_7$, and $R'_8$ are hydrogen; and $R_1$, $R_3$, $R_6$, $R_9$, $R'_1$, $R'_3$, $R'_6$, and $R'_9$ are independently hydrogen, halogen, unsubstituted alkyl, unsubstituted aryl, substituted aryl (e.g., aryl substituted with one or more alkyls, such as methyl, ethyl, n-propyl, isopropyl, n-butyl, sec-butyl, isobutyl, tert-butyl, etc.), hydroxyl, unsubstituted heteroaryl (e.g., carbazolyl, fluorenyl, indenyl, indolyl, etc.), unsubstituted polyheteroaryl, unsubstituted $C_2$-$C_{20}$ heterocyclyl, unsubstituted alkylaryl, alkoxy (e.g., - O-alkyl such as methoxy, ethoxy, and phenoxy, -O-aryl, -O-polyaryl, etc.), borenium cation (e.g., -B(Mes)$_2$), phosphonyl (e.g. -P(=O)(Ph)$_2$), sulfinyl (e.g., -S(=O)(Ph)$_2$, - S(=O)(alkyl)$_2$, etc.), or sulfonyl -S(=O)$_2$(Ph)$_2$, -S(=O)$_2$(alkyl)$_2$, etc.), such as halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., - B(Mes)$_2$), or phosphonyl (e.g., -P(=O)(Ph)$_2$, -P(=O)(alkyl)$_2$, etc.).

Paragraph 18. The complex of paragraph 17, wherein $R_1$, $R_6$, $R_9$, $R'_1$, $R'_6$, and $R'_9$ are independently unsubstituted alkyl, unsubstituted aryl, or substituted aryl (e.g., phenyl substituted with one or more $C_1$-$C_6$ alkyls).

Paragraph 19. The complex of any one of paragraphs 1-18, wherein the complex has any one of the structures:

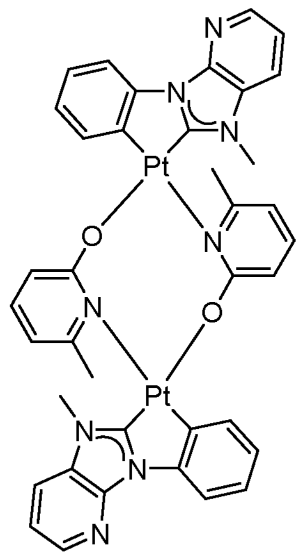

**Pt-R1** ,

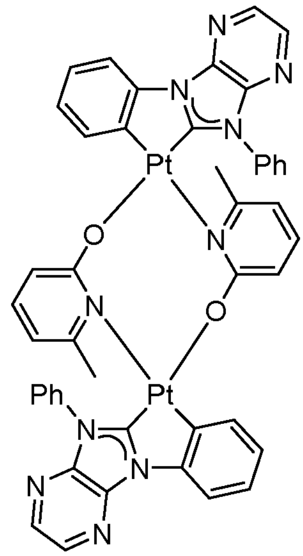

**Pt-R2** ,

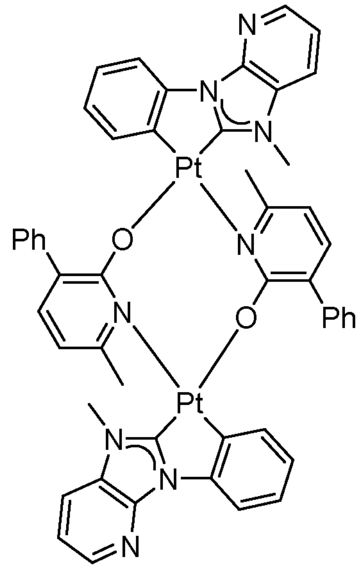

**Pt-R3** ,

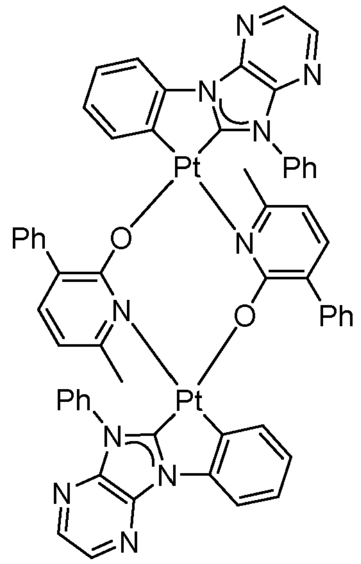

**Pt-R4** ,

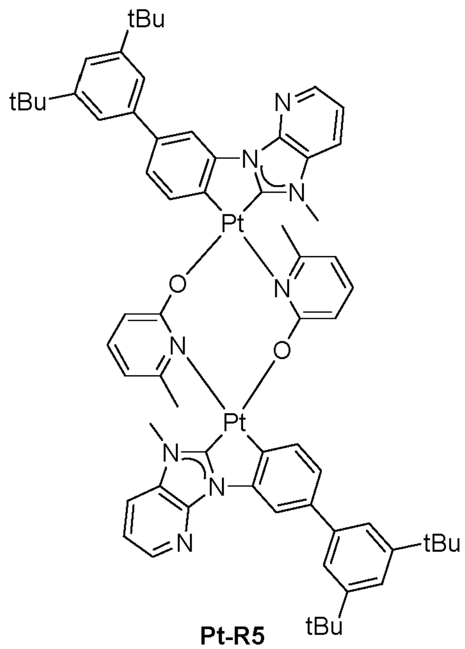

Pt-R5 ,

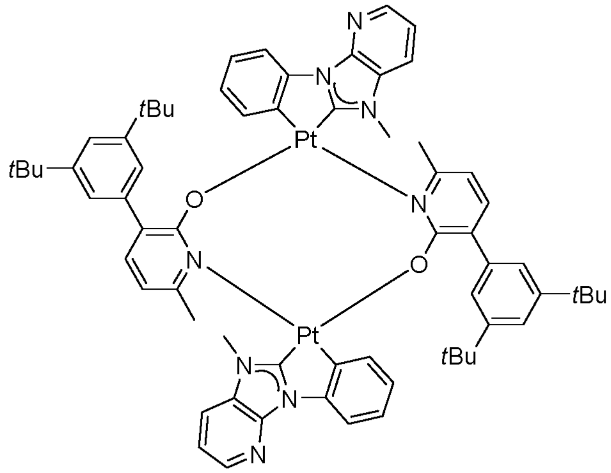

Pt-R6 ,

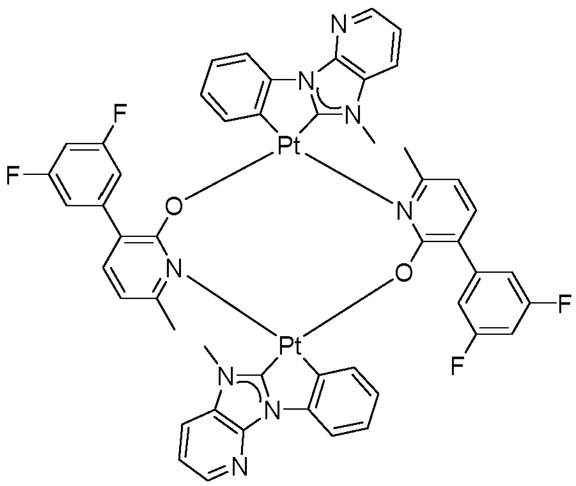

Pt-R7 ,

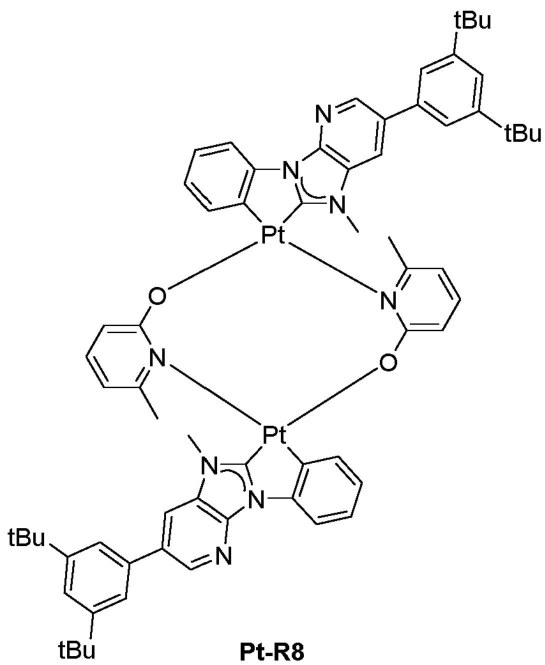

Pt-R8 ,

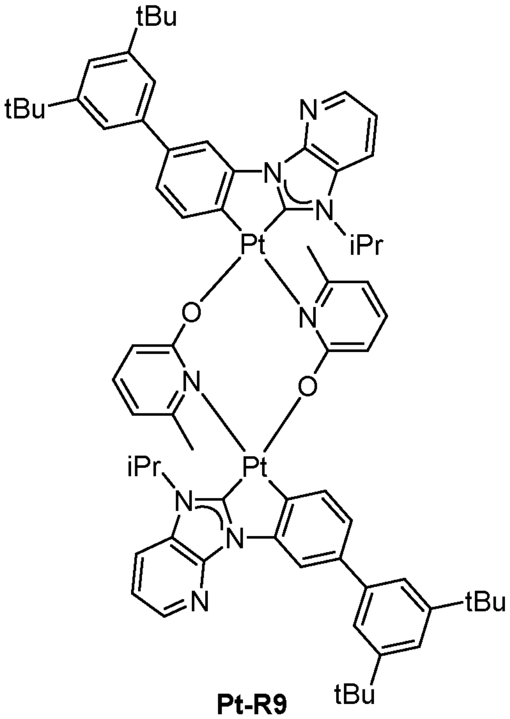

Pt-R9 ,

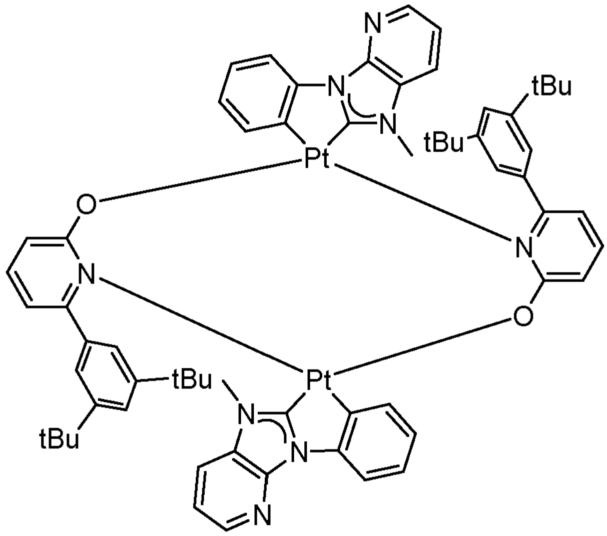

Pt-R10 ,

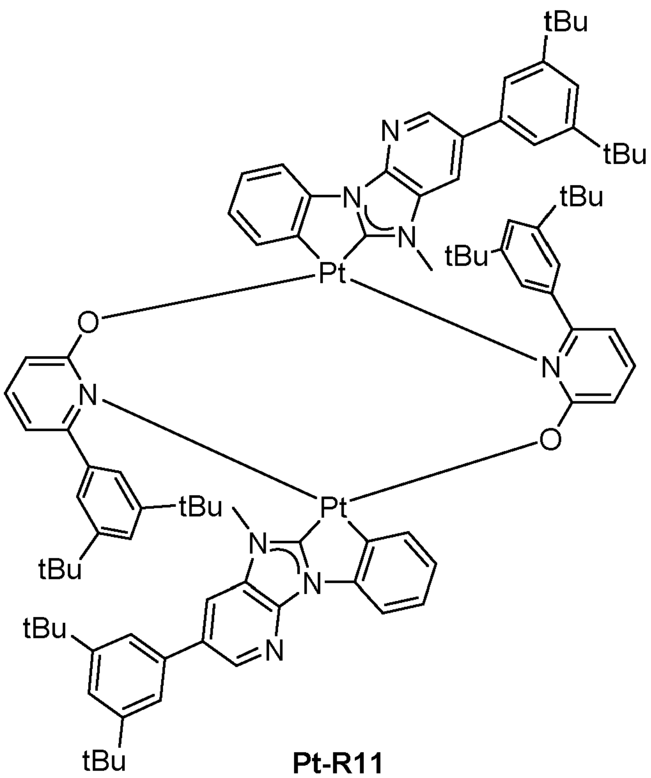

Pt-R11 ,

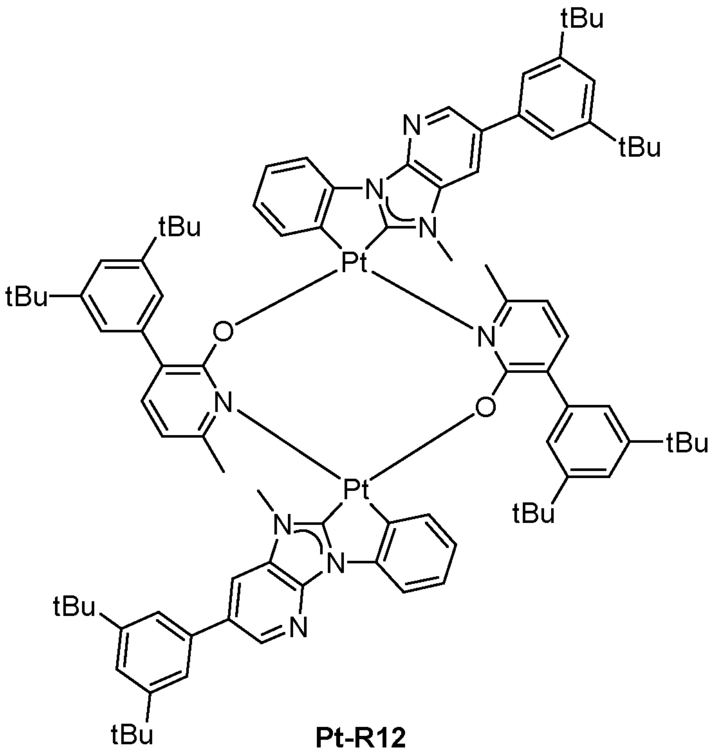

**Pt-R12**

,

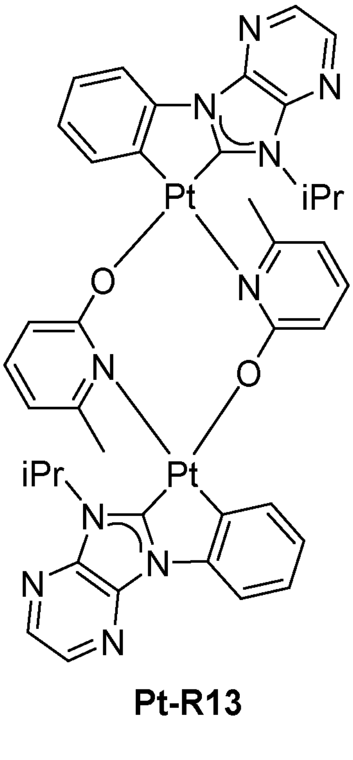

**Pt-R13**

,

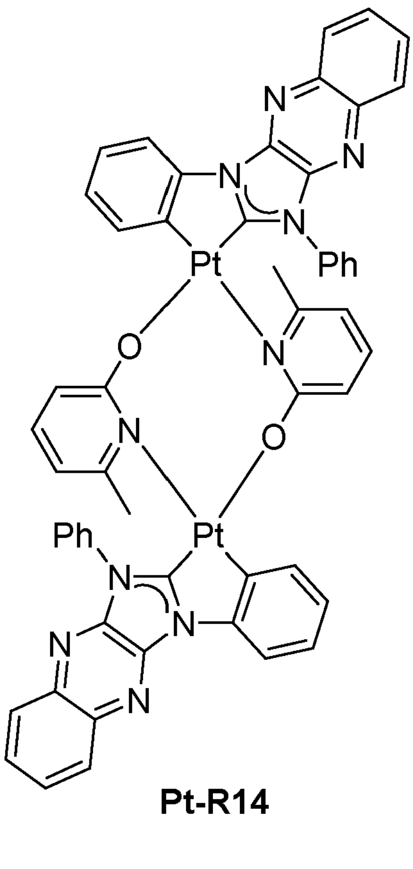

**Pt-R14**

,

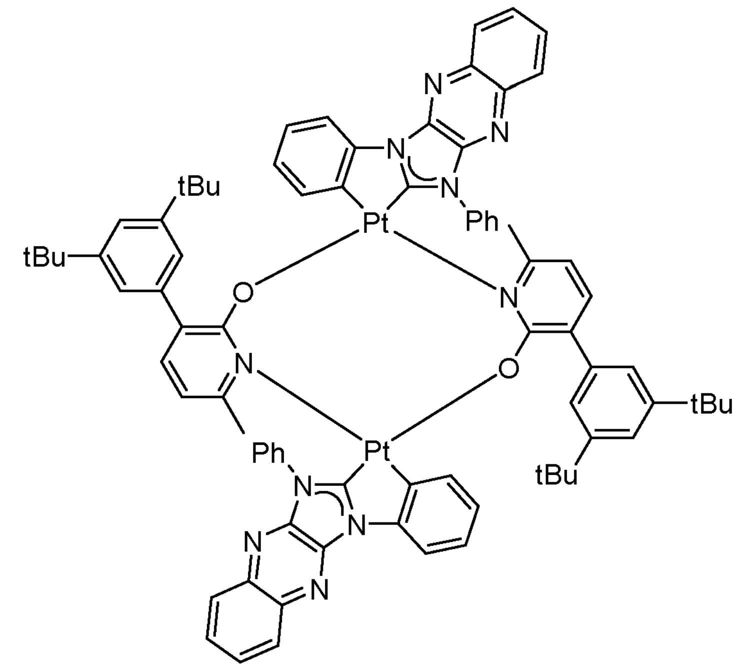

**Pt-R15**

,

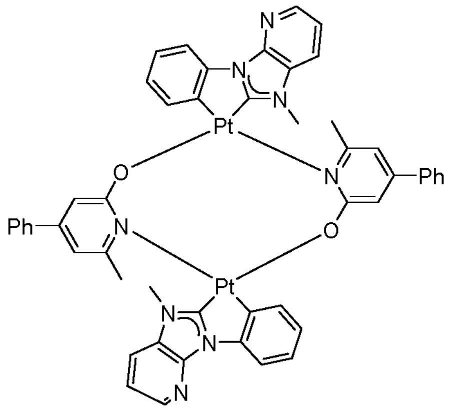

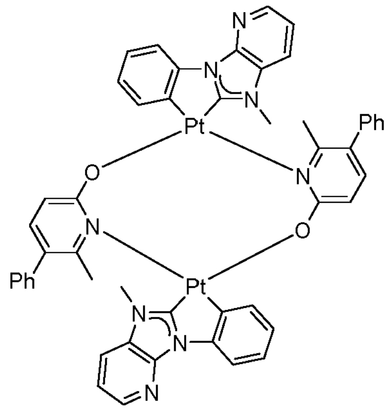

,

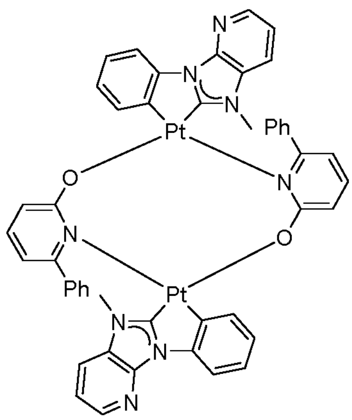

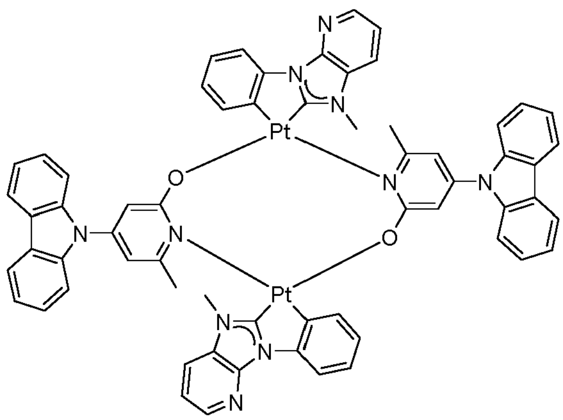

,

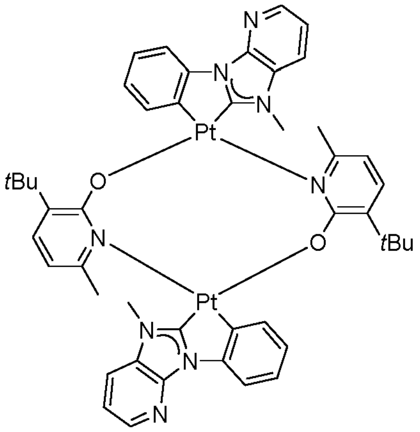

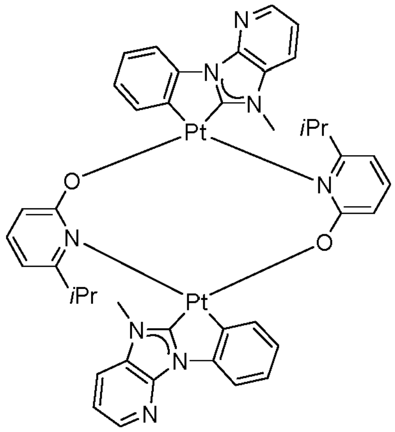

,

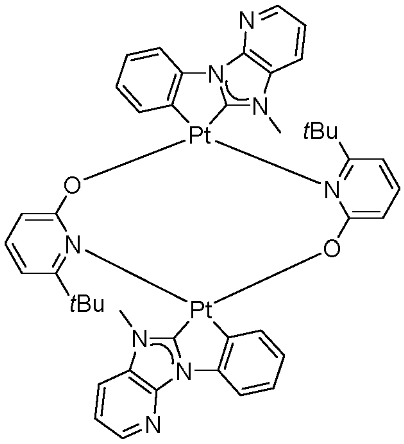

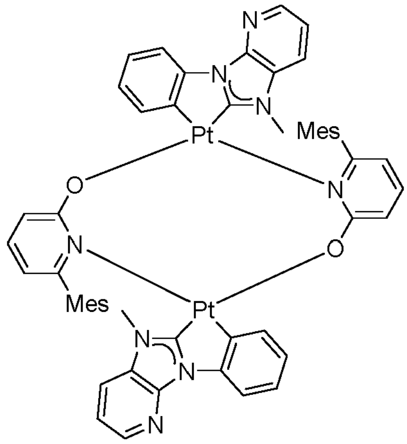

,

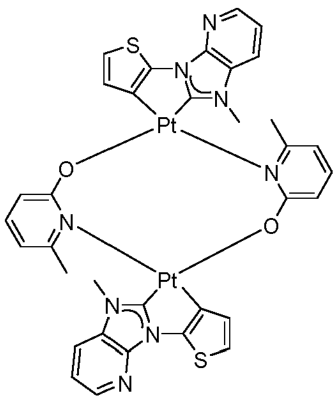

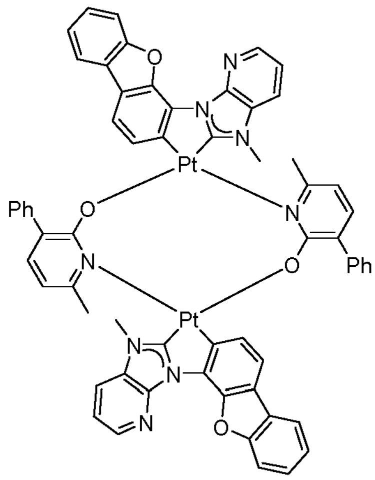

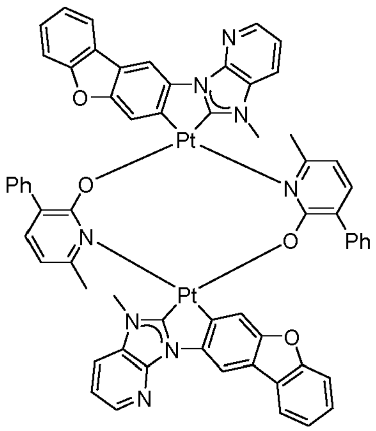

,

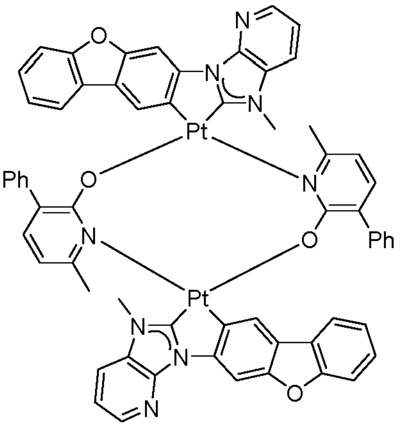

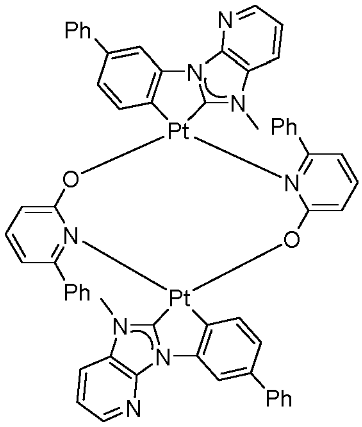

,

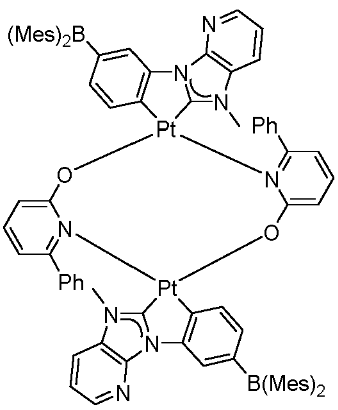

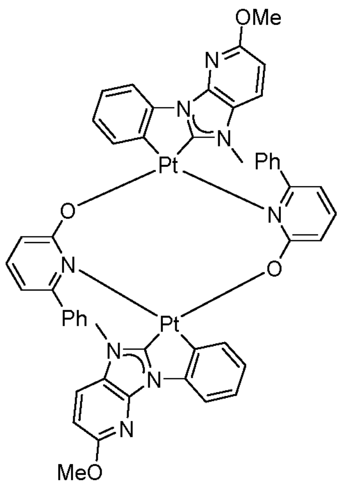

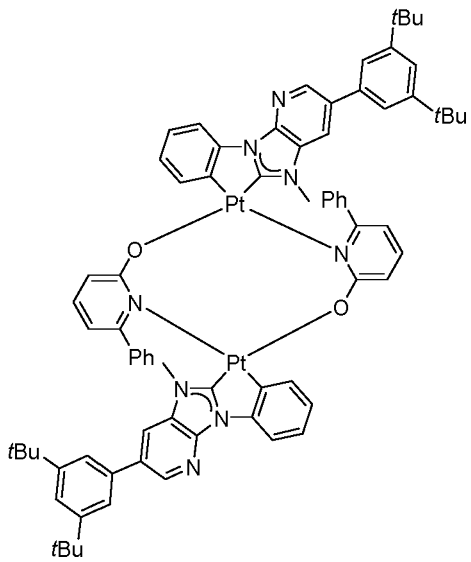

,

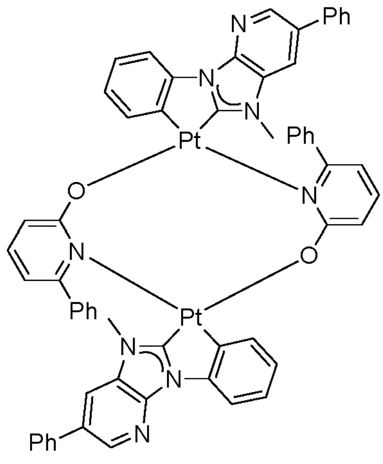

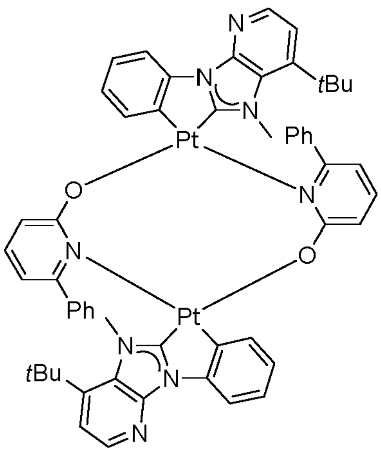

,

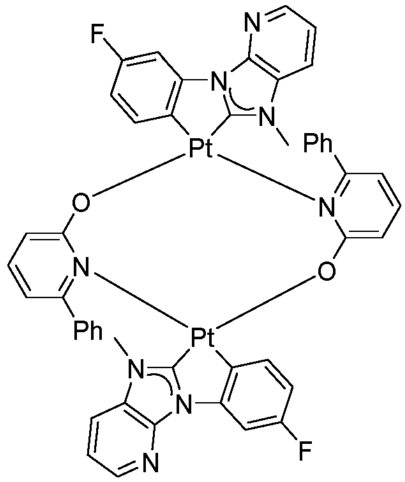

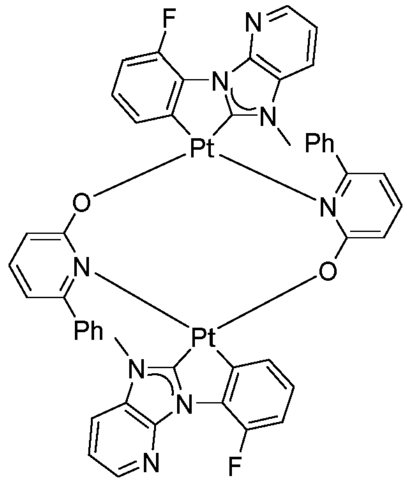

,

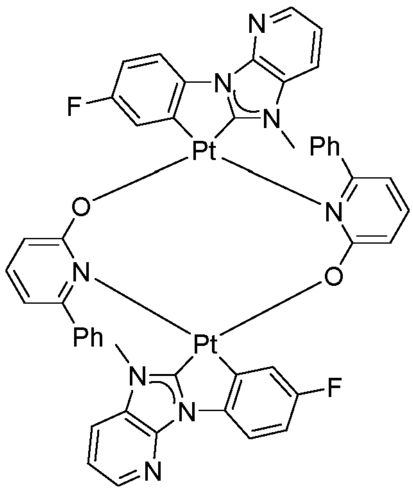

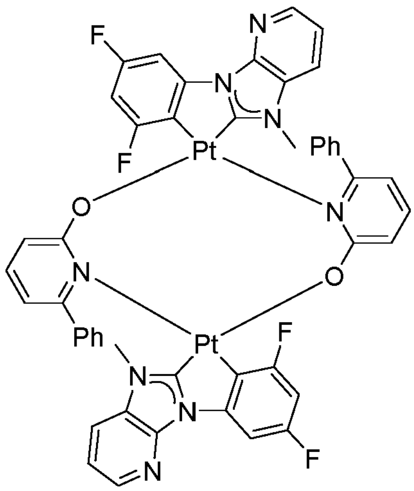

,

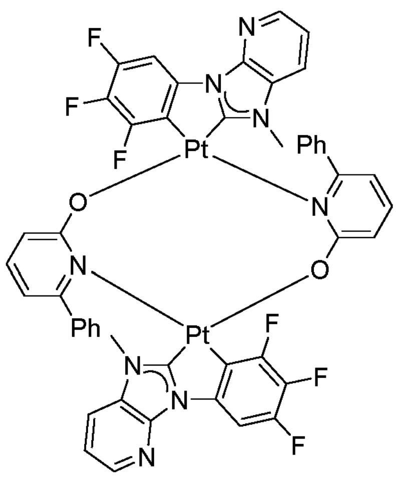

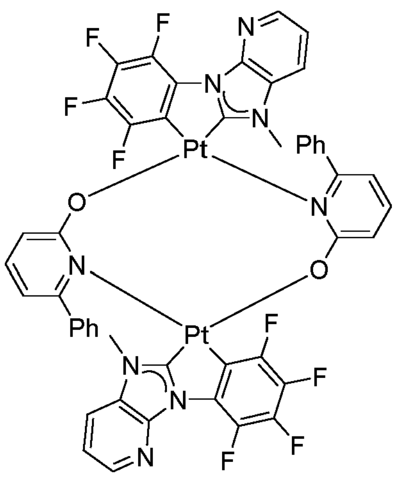

,

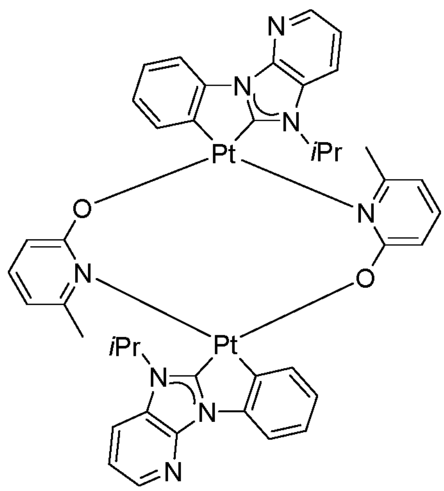

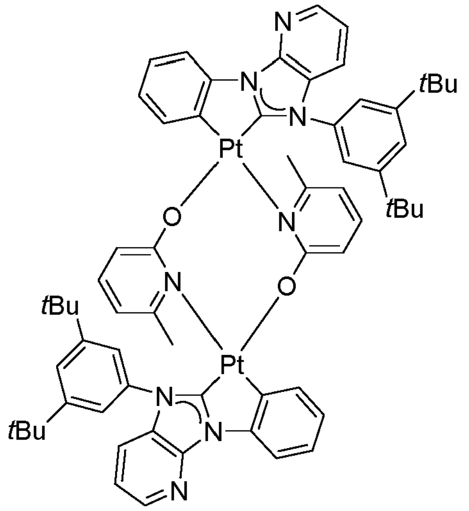

,

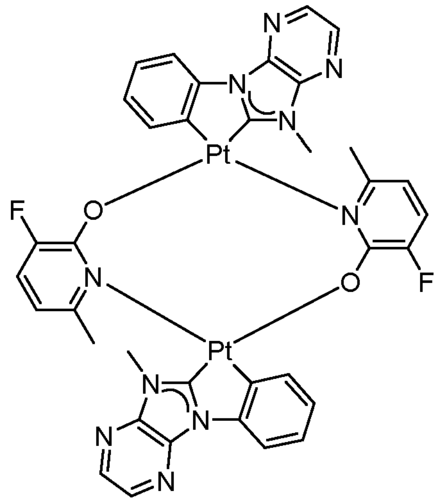

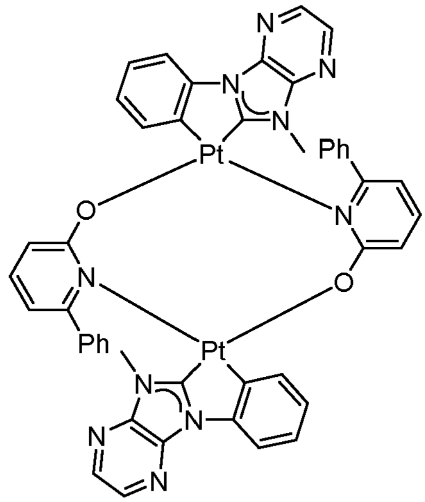

,

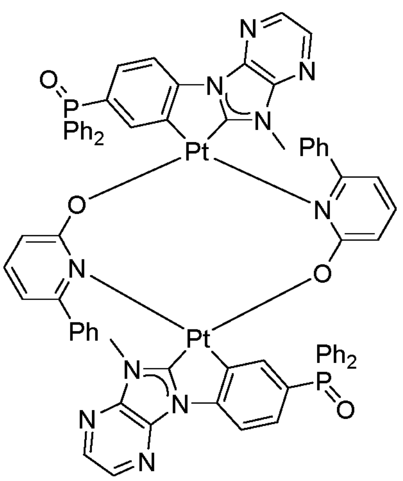

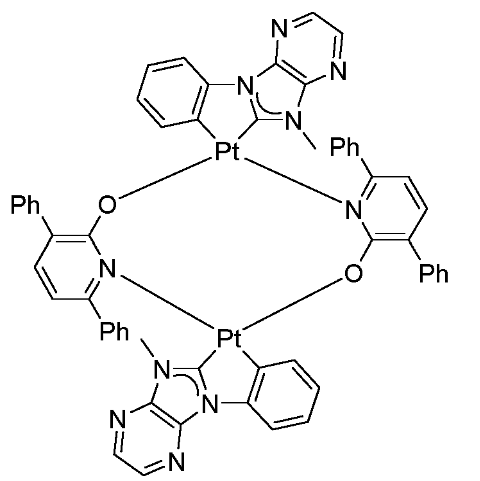

,

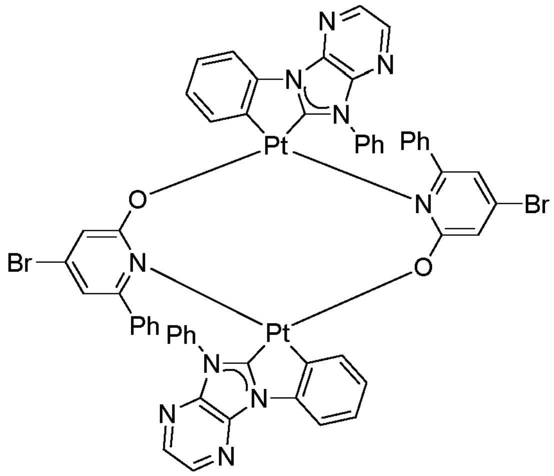

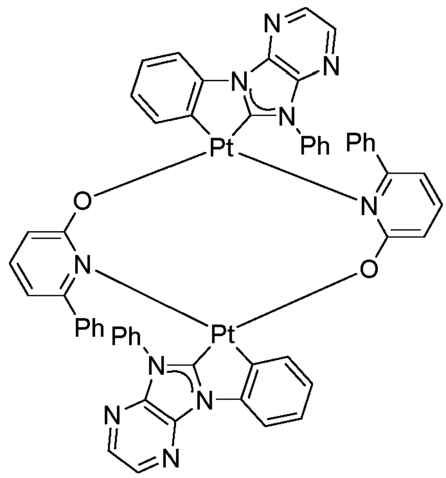

,

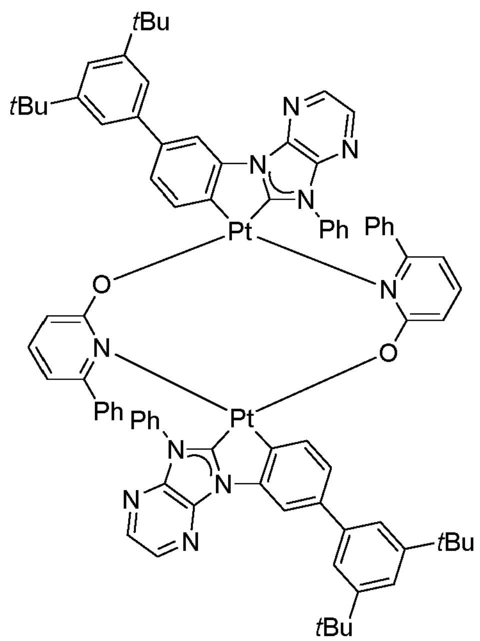

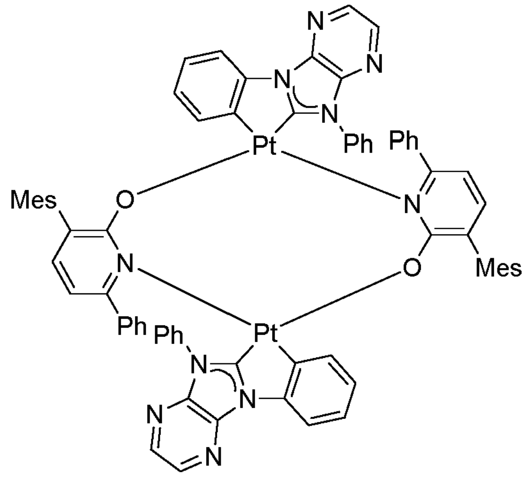

,

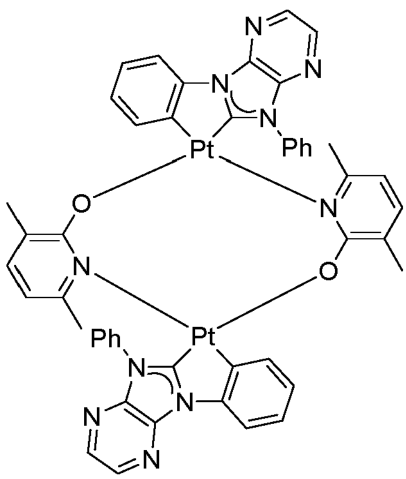

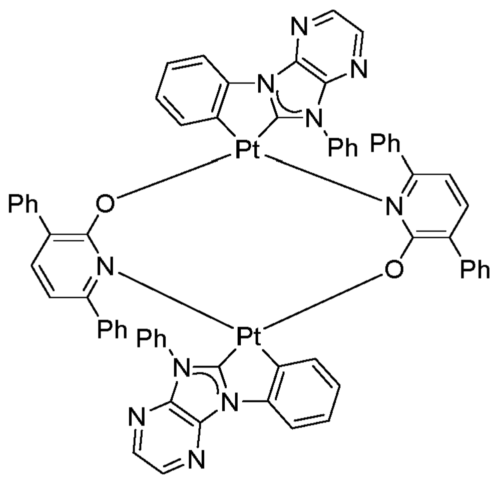

,

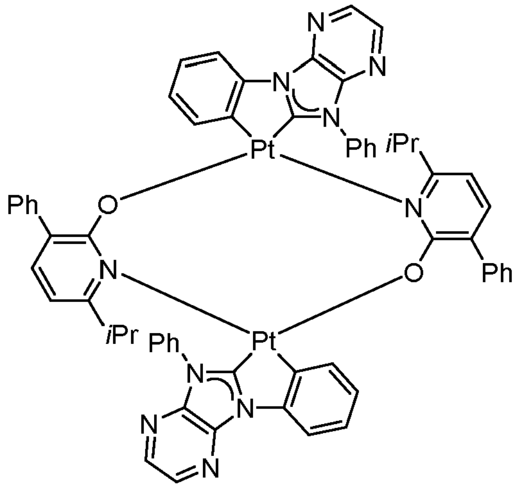

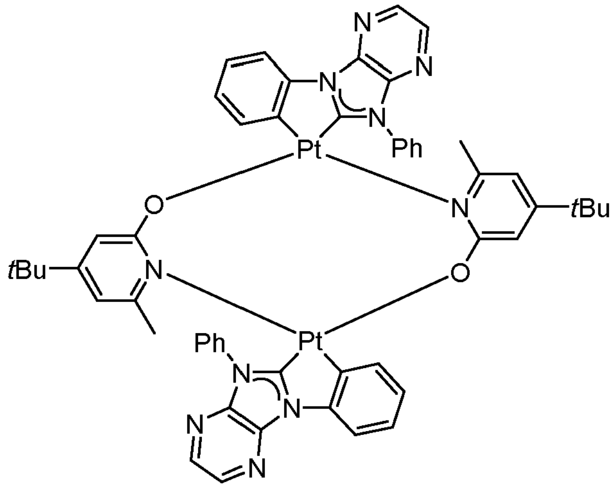

,

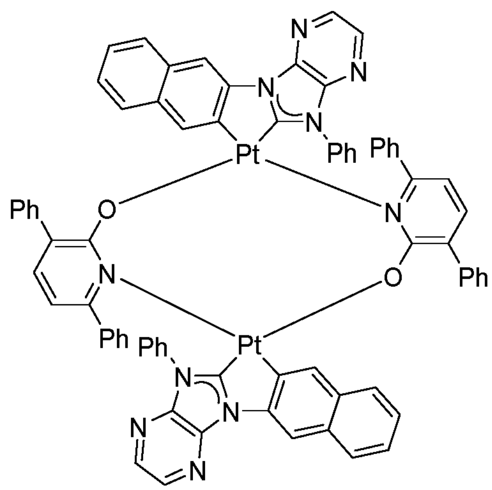

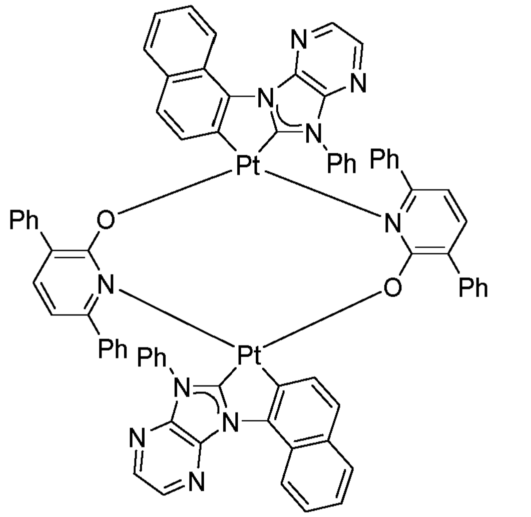

,

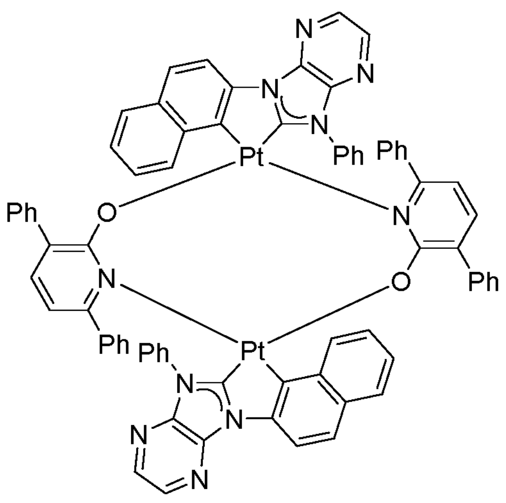

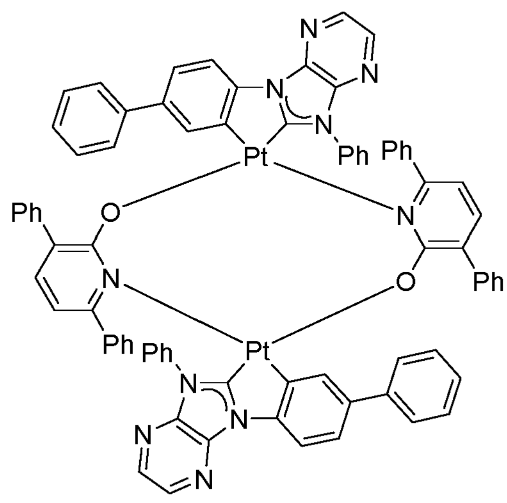

,

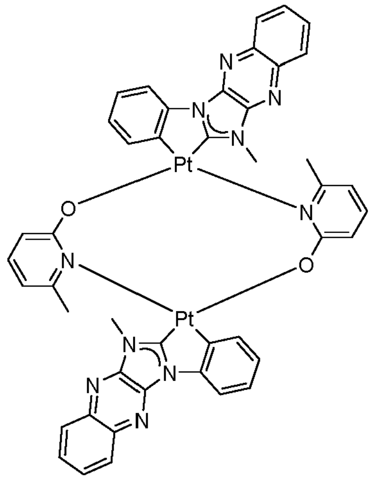
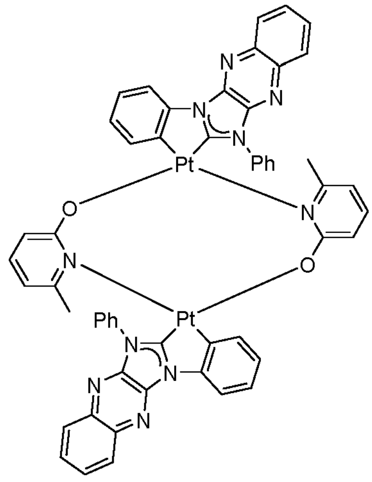
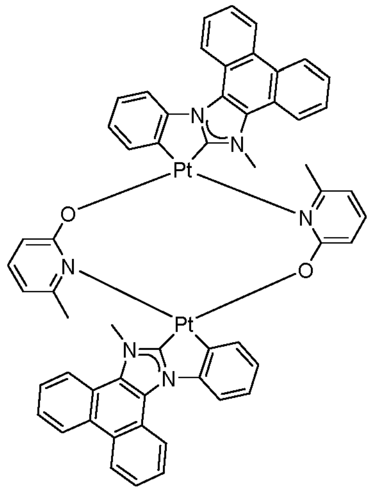

,

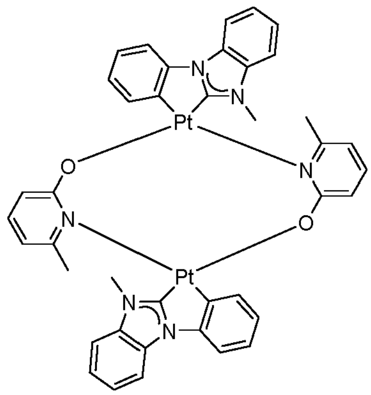
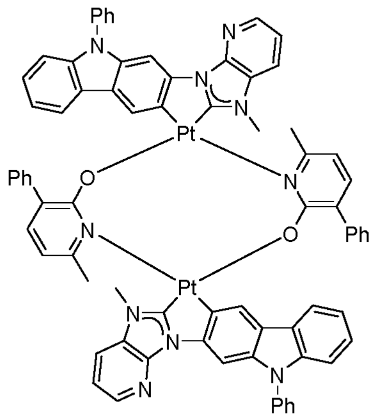
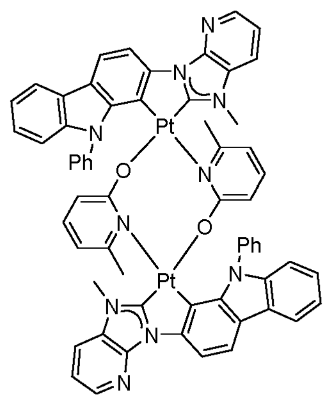

,

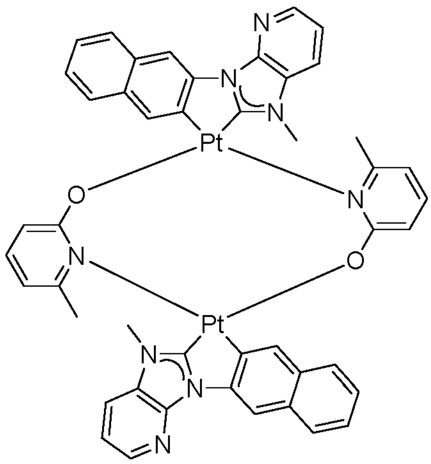
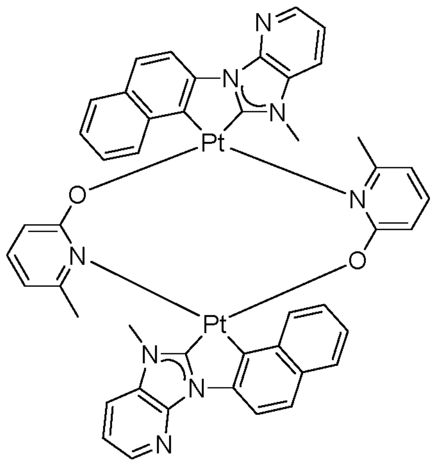

,

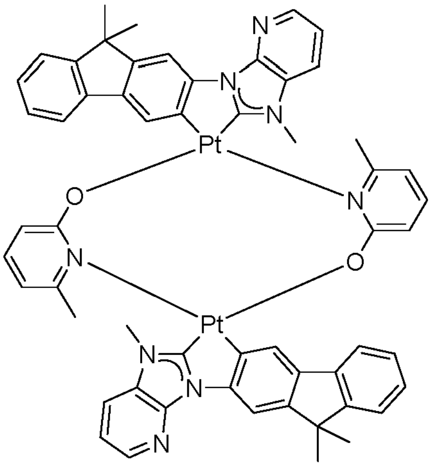

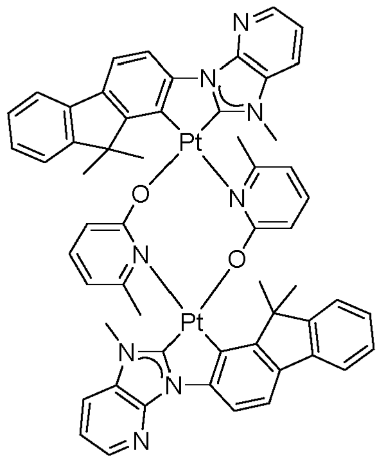

,

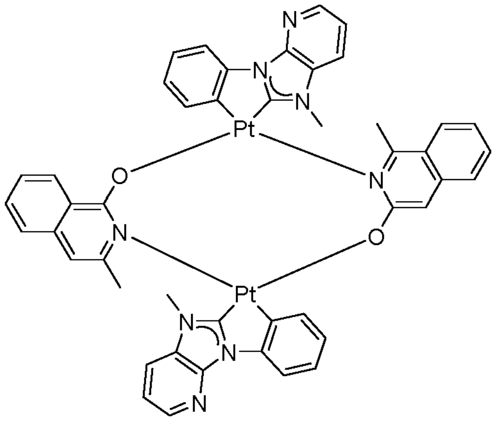

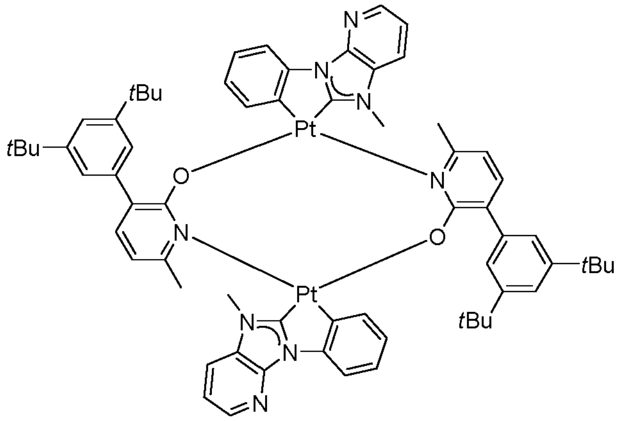

,

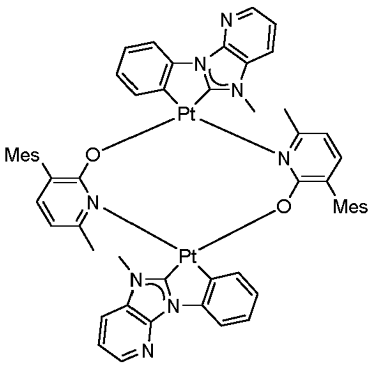

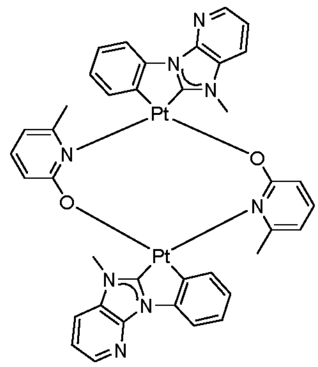

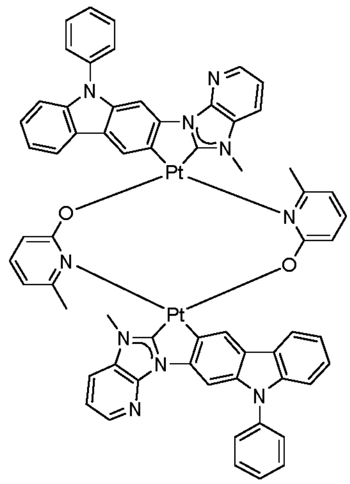

,

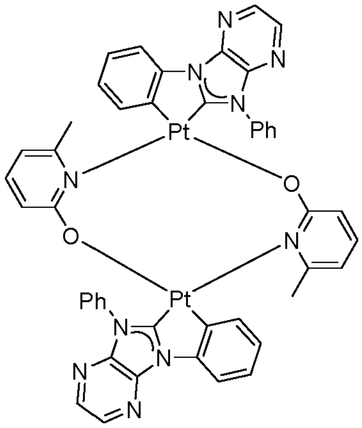

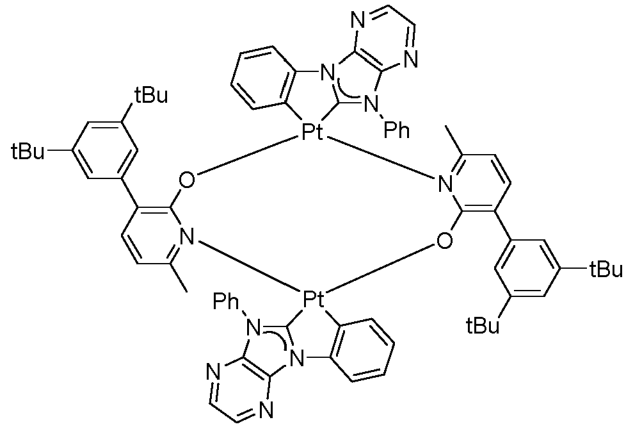

,

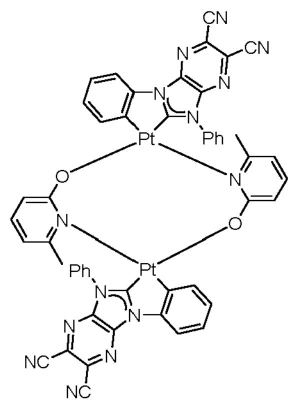

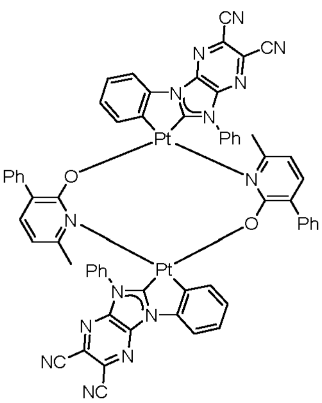

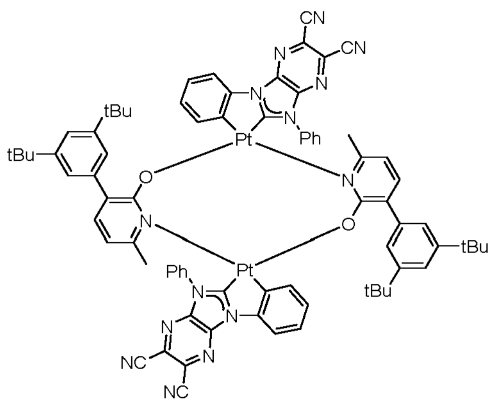

,

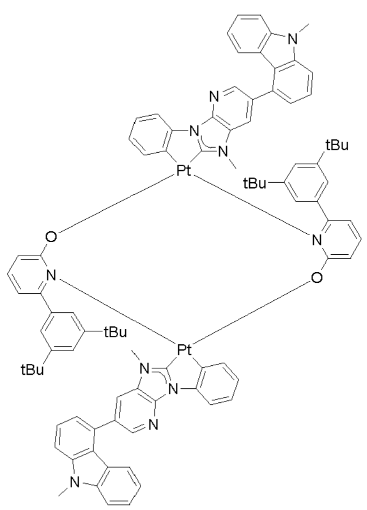

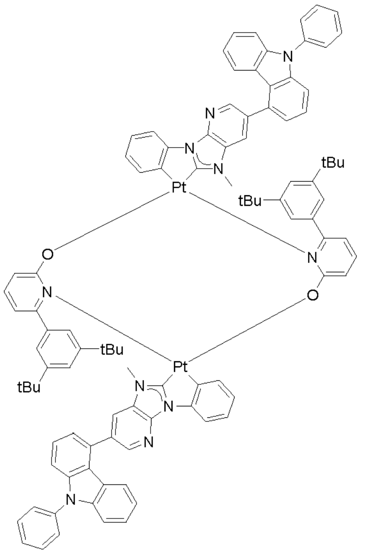

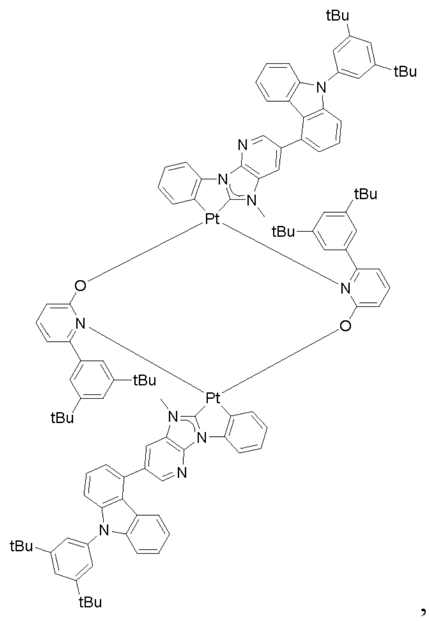

,

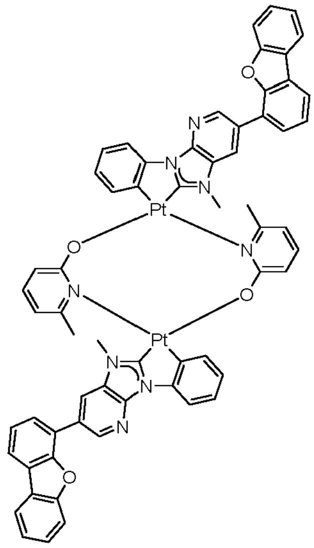

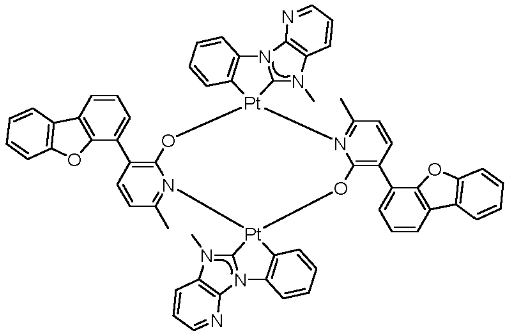

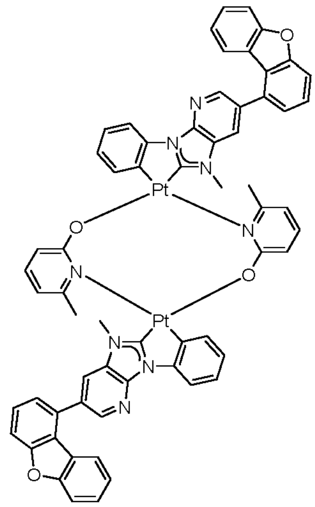

,

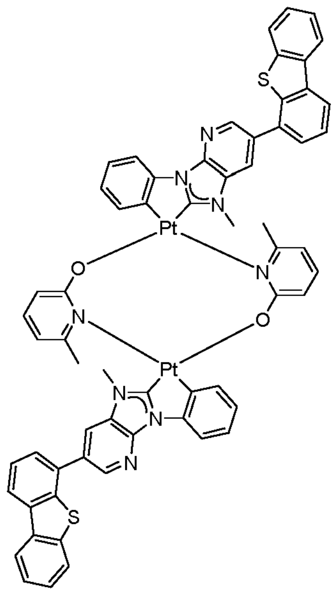

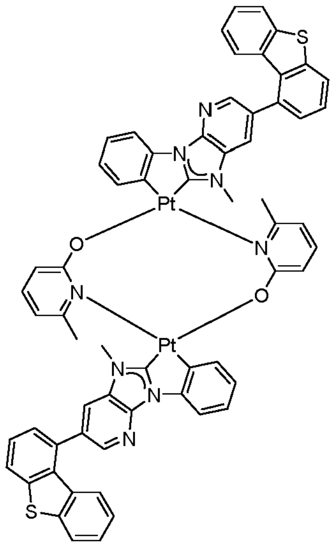

,

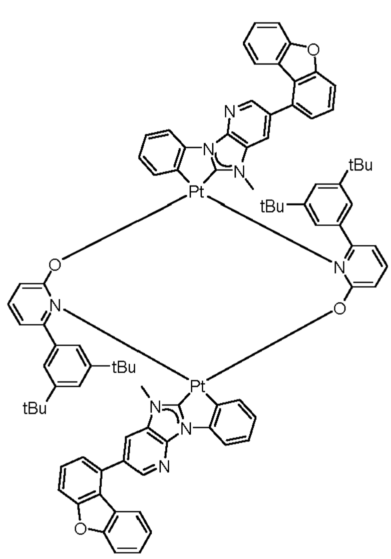
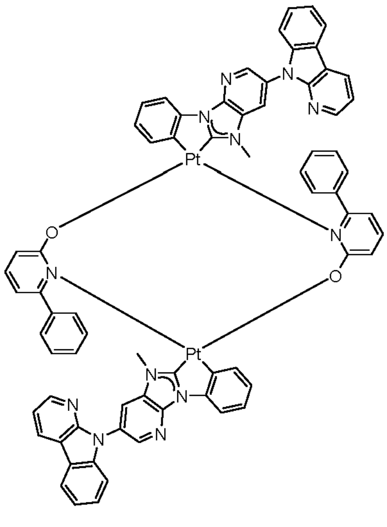
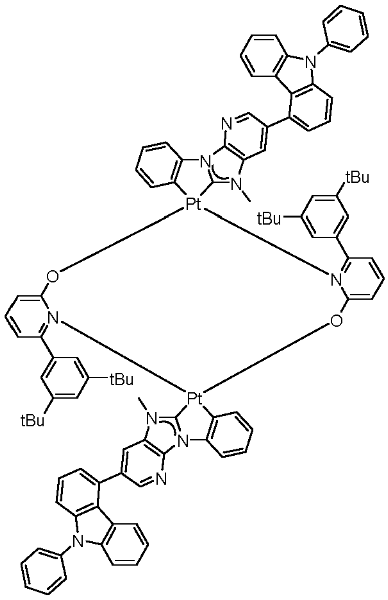
,

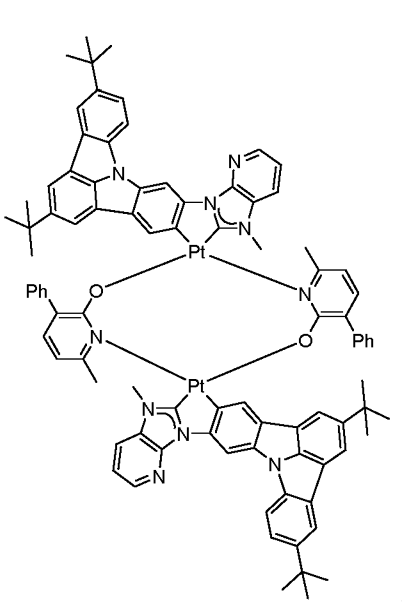
,
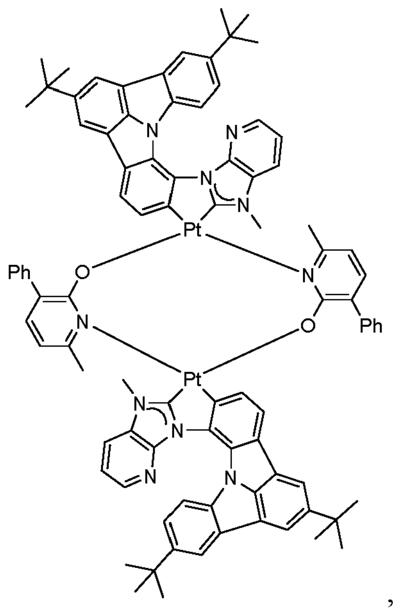
,

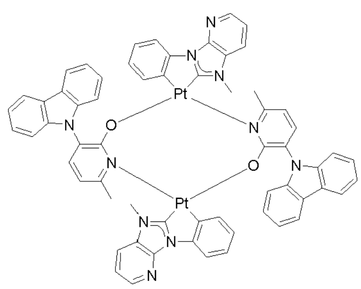
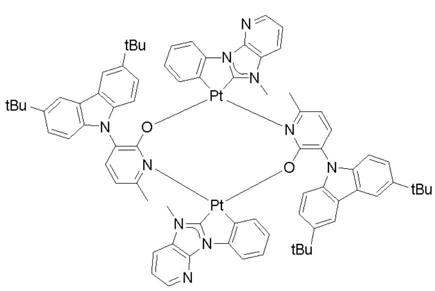
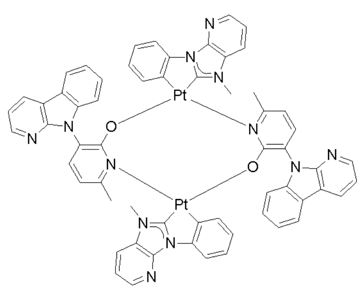
,

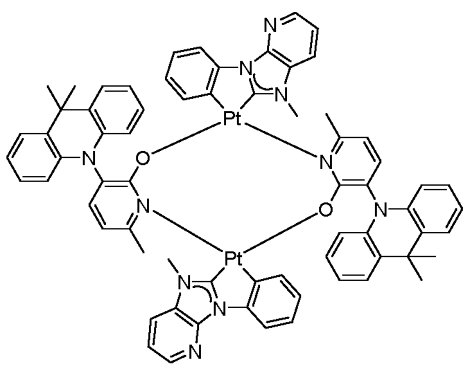

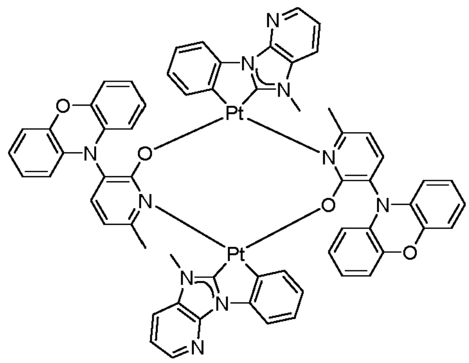

,

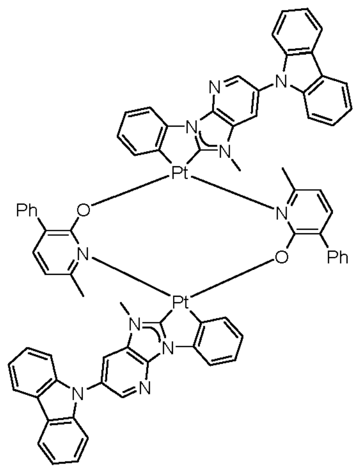

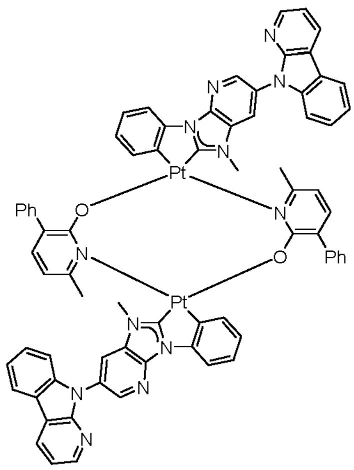

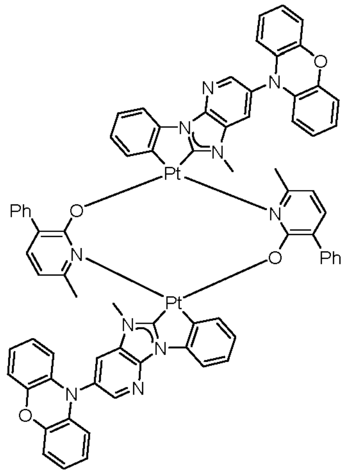

,

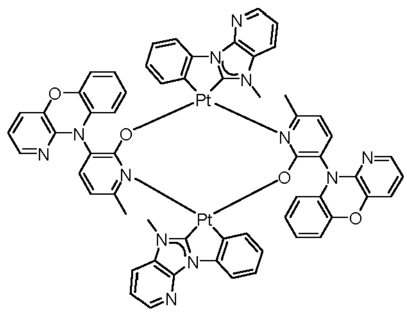

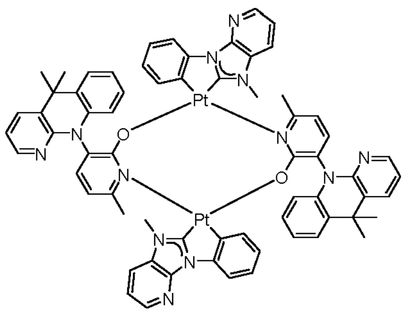

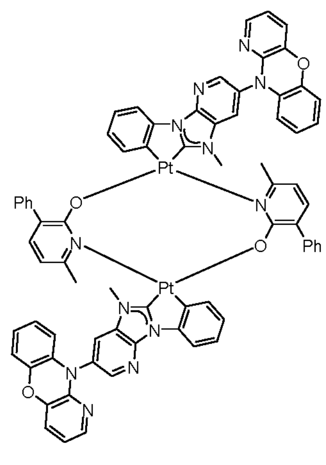

,

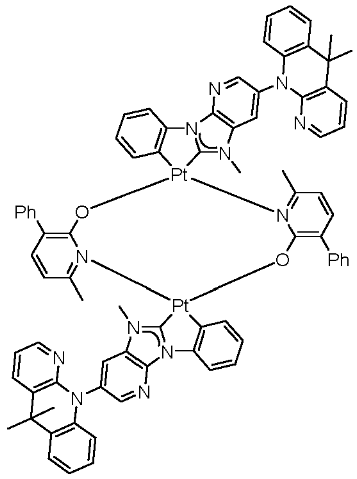

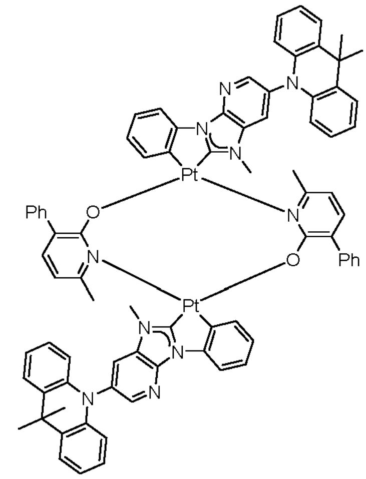

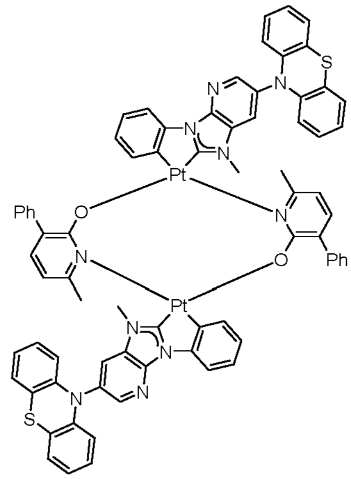

,

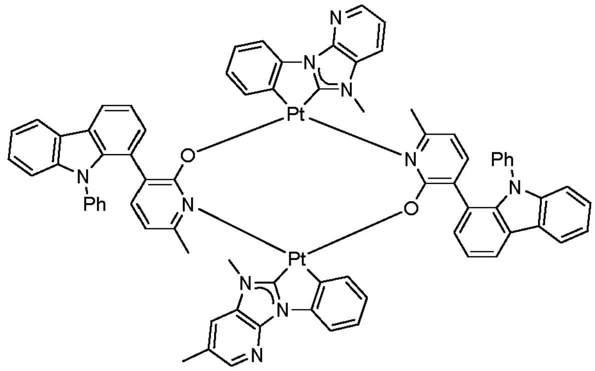

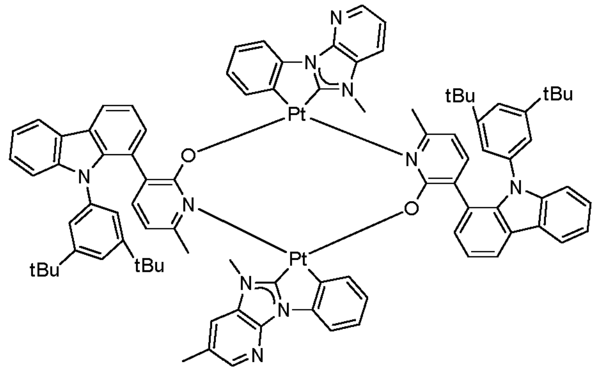

,

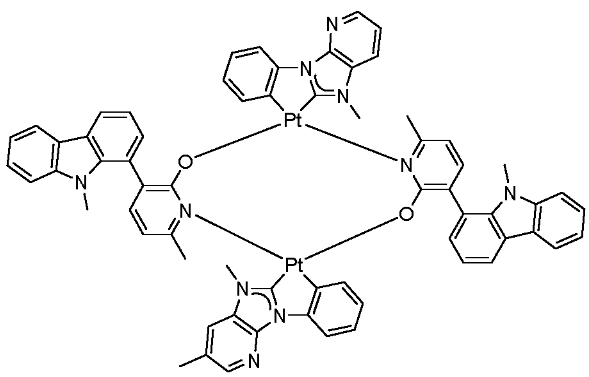

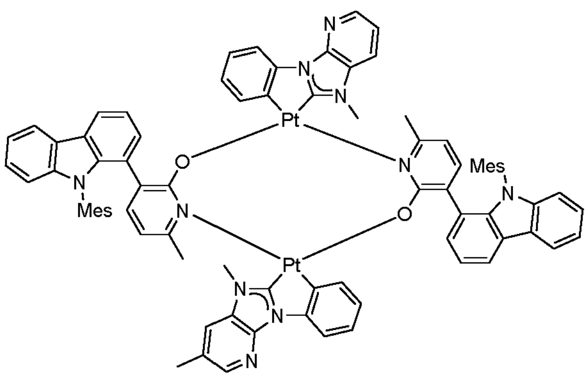

.

Paragraph 20. The complex of any one of paragraphs 1-19, wherein the complex has a maximum emission wavelength ($\lambda_{max}$) in a range from 600 nm to 1000 nm, from 600 nm to 900 nm, from 600 nm to 800 nm, from 600 nm to 700 nm, from 600 nm to 680 nm, from 620 nm to 710 nm, or from 612 nm to 685 nm.

Paragraph 21. The complex of paragraph 20, wherein the complex has an emission lifetime ($\tau_{em}$) of up to 2.5 $\mu$s, up to 2.0 $\mu$s, up to 1.9 $\mu$s, up to 1.8 $\mu$s, in a range from 0.5 $\mu$s to 2.5 $\mu$s, from 0.5 $\mu$s to 2.0 $\mu$s, from 0.8 $\mu$s to 2.0 $\mu$s, from 1.0 $\mu$s to 2.0 $\mu$s, from 0.5 $\mu$s to 1.9 $\mu$s, from 0.8 $\mu$s to 1.9 $\mu$s, from 1.0 $\mu$s to 1.9 $\mu$s, from 1.2 $\mu$s to 1.9 $\mu$s, or from 1.4 $\mu$s to 1.9 $\mu$s; a radiative decay rate ($k_r$) of at least $3.5 \times 10^5\ s^{-1}$, at least $4.0 \times 10^5\ s^{-1}$, at least $4.5 \times 10^5\ s^{-1}$, in a range from $3.5 \times 10^5\ s^{-1}$ to $10.0 \times 10^5\ s^{-1}$, from $3.5 \times 10^5\ s^{-1}$ to $8.0 \times 10^5\ s^{-1}$, from $3.5 \times 10^5\ s^{-1}$ to $6.0 \times 10^5\ s^{-1}$, from $3.5 \times 10^5\ s^{-1}$ to $5.5 \times 10^5\ s^{-1}$, from $4.0 \times 10^5\ s^{-1}$ to $10.0 \times 10^5\ s^{-1}$, from $4.0 \times 10^5\ s^{-1}$ to $8.0 \times 10^5\ s^{-1}$, from $4.0 \times 10^5\ s^{-1}$ to $6.0 \times 10^5\ s^{-1}$, from $4.0 \times 10^5\ s^{-1}$ to $5.5 \times 10^5\ s^{-1}$, from $4.2 \times 10^5\ s^{-1}$ to $10.0 \times 10^5\ s^{-1}$, from $4.2 \times 10^5\ s^{-1}$ to $8.0 \times 10^5\ s^{-1}$, from $4.2 \times 10^5\ s^{-1}$ to $6.0 \times 10^5\ s^{-1}$, from $4.2 \times 10^5\ s^{-1}$ to $5.5 \times 10^5\ s^{-1}$, or from $4.3 \times 10^5\ s^{-1}$ to $5.5 \times 10^5\ s^{-1}$; a non-radiative decay rate ($k_{nr}$) of up to $2.0 \times 10^5\ s^{-1}$, up to $1.8 \times 10^5\ s^{-1}$, up to $1.5 \times 10^5\ s^{-1}$, down to $0.15 \times 10^5\ s^{-1}$, in a range from $0.15 \times 10^5\ s^{-1}$ to $2.0 \times 10^5\ s^{-1}$, from $0.16 \times 10^5\ s^{-1}$ to $2.0 \times 10^5\ s^{-1}$, from $0.15 \times 10^5\ s^{-1}$ to $1.8 \times 10^5\ s^{-1}$, from $0.16 \times 10^5\ s^{-1}$ to $1.8 \times 10^5\ s^{-1}$, from $0.15 \times 10^5\ s^{-1}$ to $1.6 \times 10^5\ s^{-1}$, from $0.16 \times 10^5\ s^{-1}$ to $1.6 \times 10^5\ s^{-1}$, from $0.15 \times 10^5\ s^{-1}$ to $1.5 \times 10^5\ s^{-1}$, or from $0.16 \times 10^5\ s^{-1}$ to $1.4 \times 10^5\ s^{-1}$; and/or an

emission quantum yield ($\Phi_{em}$) of at least 60%, at least 65%, at least 70%, at least 75%, in a range from 60% to 97%, from 65% to 97%, from 70% to 97%, from 75% to 97%, from 75% to 99%, or from 78% to 97%, measured in solution or films, at room temperature.

Paragraph 22. An organic light-emitting component comprising a light-emitting layer or two or more light-emitting layers, wherein the light-emitting layer or each light-emitting layer of the two or more light-emitting layers comprises one or more dinuclear platinum(II) complexes of any one of paragraphs 1 to 21, and optionally wherein the organic light-emitting component emits light in the red, deep red, and/or NIR region(s).

Paragraph 23. The organic light-emitting component of paragraph 22, wherein the light emitting layer or each light-emitting layer of the two or more light-emitting layers further comprises one or more host materials, and wherein the total concentration of the one or more host materials is greater than the total concentration of the one or more complexes in the light-emitting layer or each light-emitting layer of the two or more light-emitting layers.

Paragraph 24. The organic light-emitting component of paragraph 22 or 23, wherein the total concentration of the one or more dinuclear platinum(II) complexes in the light-emitting layer or each light-emitting layer of the two or more light-emitting layers is up to 50 wt%, up to 40 wt%, up to 30 wt%, up to 20 wt%, at least 1 wt%, in a range from about 1 wt% to about 50 wt%, from about 1 wt% to about 40 wt%, from about 1 wt% to about 30 wt%, from about 1 wt% to about 20 wt%, from about 2 wt% to about 50 wt%, from about 2 wt% to about 40 wt%, from about 2 wt% to about 30 wt%, from about 2 wt% to about 20 wt%, from about 4 wt% to about 50 wt%, from about 4 wt% to about 40 wt%, from about 4 wt% to about 30 wt%, from about 4 wt% to about 20 wt%, from about 1 wt% to about 16 wt%, from about 2 wt% to about 16 wt%, from about 4 wt% to about 16 wt%, such as about 4 wt%, about 8 wt%, or about 12 wt%.

Paragraph 25. The organic light-emitting component of any one of paragraphs 22-24 further comprising an anode, a cathode, a hole transport region, and an electron transport region,

wherein the hole transport region comprises a hole injection layer and/or a hole transport layer, and optionally an electron blocking layer,
wherein the electron transport region comprises an electron transport layer and/or an electron injection layer, and optionally a hole blocking layer,
wherein the light emitting layer is located in between the anode and the cathode,
wherein the hole transport region is located in between the anode and the light-emitting layer, and
wherein the electron transport region is located in between the cathode and the light emitting layer.

Paragraph 26. The organic light-emitting component of any one of paragraphs 22-25, wherein the organic light-emitting component emits light in the red to deep red region.

Paragraph 27. The organic light-emitting component of paragraph 26, wherein the organic light-emitting component has a maximum brightness (L) of at least 20000 cd $m^{-2}$, at least 25000 cd $m^{-2}$, at least 30000 cd $m^{-2}$, at least 35000 cd $m^{-2}$, at least 40000 cd $m^{-2}$, in a range from 20000 cd $m^{-2}$ to 100000 cd $m^{-2}$, from 30000 cd $m^{-2}$ to 100000 cd $m^{-2}$, from 20000 cd $m^{-2}$ to 80000 cd $m^{-2}$, from 30000 cd $m^{-2}$ to 80000 cd $m^{-2}$, from 20000 cd $m^{-2}$ to 60000 cd $m^{-2}$, from 30000 cd $m^{-2}$ to 60000 cd $m^{-2}$, from 20000 cd $m^{-2}$ to 50000 cd $m^{-2}$ from 30000 cd $m^{-2}$ to 100000 cd $m^{-2}$, from 20000 cd $m^{-2}$ to 50000 cd $m^{-2}$, from 30000 cd $m^{-2}$ to 50000 cd $m^{-2}$, from 35000 cd $m^{-2}$ to 100000 cd $m^{-2}$, from 40000 cd $m^{-2}$ to 100000 cd $m^{-2}$, from 35000 cd $m^{-2}$ to 80000 cd $m^{-2}$, from 40000 cd $m^{-2}$ to 80000 cd $m^{-2}$, from 35000 cd $m^{-2}$ to 60000 cd $m^{-2}$, from 40000 cd $m^{-2}$ to 60000 cd $m^{-2}$, from 35000 cd $m^{-2}$ to 50000 cd $m^{-2}$, or from 40000 cd $m^{-2}$ to 50000 cd $m^{-2}$; a current efficiency (CE) at 1000 cd/$m^2$ of at least 20 cd $A^{-1}$, at least 22 cd/A, in a range from 20 cd/A to 60 cd/A, from 22 cd/A to 60 cd/A, from 20 cd/A to 50 cd/A, from 22 cd/A to 50 cd/A, from 20 cd/A to 40 cd/A, or from 20 cd/A to 30 cd/A; a power efficiency (PE) at 1000 cd/$m^2$ of at least 10 lm/W, in a range from 10 lm/W to 60 lm/W, from 15 lm/W to 60 lm/W, from 10 lm/W to 50 lm/W, from 15 lm/W to 50 lm/W, from 10 lm/W to 40 lm/W, from 15 lm/W to 40 lm/W, from 10 lm/W to 30 lm/W, from 15 lm/W to 30 lm/W, or from 10 lm/W to 20 lm/W; and/or an external quantum efficiency (EQE) at 1000 cd/$m^2$ of at least 10%, at least 11%, at least 12%, at least 13%, at least 14%, at least 15%, in a range from 10% to 40%, from 10% to 20%, from 10% to 20%, from 11% to 40%, from 11% to 30%, from 11% to 20%, from 12% to 20%, from 12% to 40%, from 12% to 30%, from 13% to 20%, from 13% to 40%, from 13% to 30%, from 14% to 20%, from 14% to 40%, from 14% to 30%, from 15% to 40%, from 15% to 30%, or from 15% to 20%.

Paragraph 28. The organic light-emitting component of any one of paragraphs 22-25, wherein the organic light-emitting component emits light in the NIR region.

Paragraph 29. The organic light-emitting component of paragraph 28, wherein the organic light-emitting component has an L of at least 1000 cd $m^{-2}$, at least 1500 cd $m^{-2}$, at least 2000 cd $m^{-2}$, at least 3000 cd $m^{-2}$, at least 4000 cd $m^{-2}$, at least 4200 cd $m^{-2}$, at least 4500 cd $m^{-2}$, in a range from 1000 cd $m^{-2}$ to 40000 cd $m^{-2}$, from 1500 cd $m^{-2}$ to 40000 cd $m^{-2}$, from 2000 cd $m^{-2}$ to 40000 cd $m^{-2}$, from 3000 cd $m^{-2}$ to 40000 cd $m^{-2}$, from 4000 cd $m^{-2}$ to 40000 cd $m^{-2}$, from 4500 cd $m^{-2}$ to 40000 cd $m^{-2}$, from 1000 cd $m^{-2}$ to 30000 cd $m^{-2}$, from 2000 cd $m^{-2}$ to 30000 cd $m^{-2}$, from 3000 cd $m^{-2}$ to 30000 cd $m^{-2}$, from 4000 cd $m^{-2}$ to 30000 cd $m^{-2}$, from 4500 cd $m^{-2}$ to 30000 cd $m^{-2}$, from 1000 cd $m^{-2}$ to 20000 cd $m^{-2}$, from 2000 cd $m^{-2}$ to 20000 cd $m^{-2}$, from 3000 cd $m^{-2}$ to 20000 cd $m^{-2}$, from 4000 cd $m^{-2}$ to 20000 cd $m^{-2}$, from 4500 cd $m^{-2}$ to

20000 cd $m^{-2}$, from 1000 cd $m^{-2}$ to 10000 cd $m^{-2}$, from 2000 cd $m^{-2}$ to 10000 cd $m^{-2}$, from 3000 cd $m^{-2}$ to 10000 cd $m^{-2}$, from 4000 cd $m^{-2}$ to 10000 cd $m^{-2}$, or from 4500 cd $m^{-2}$ to 10000 cd $m^{-2}$; a CE at 1000 cd $m^{-2}$ of at least 0.2 cd $A^{-1}$, at least 0.4 cd $A^{-1}$, at least 0.8 cd $A^{-1}$, in a range from 0.2 cd/A to 10 cd/A, from 0.2 cd/A to 8 cd/A, from 0.2 cd/A to 5 cd/A, from 0.2 cd/A to 3 cd/A, from 0.2 cd/A to 2 cd/A, from 0.4 cd/A to 10 cd/A, from 0.4 cd/A to 8 cd/A, from 0.4 cd/A to 5 cd/A, from 0.4 cd/A to 3 cd/A, from 0.4 cd/A to 2 cd/A, from 0.8 cd/A to 10 cd/A, from 0.8 cd/A to 8 cd/A, from 0.8 cd/A to 5 cd/A, from 0.8 cd/A to 3 cd/A, or from 0.8 cd/A to 2 cd/A; a PE at 1000 cd/$m^2$ of at least 0.1 lm/W, at least 0.2 lm/W, in a range from 0.1 lm/W to 5 lm/W, from 0.1 lm/W to 4 lm/W, from 0.1 lm/W to 3 lm/W, from 0.1 lm/W to 2 lm/W, from 0.1 lm/W to 1 lm/W, from 0.1 lm/W to 0.5 lm/W, from 0.2 lm/W to 5 lm/W, from 0.2 lm/W to 4 lm/W, from 0.2 lm/W to 3 lm/W, from 0.2 lm/W to 2 lm/W, from 0.2 lm/W to 1 lm/W, or from 0.2 lm/W to 0.5 lm/W; and/or an EQE at 1000 cd/$m^2$ of at least 1%, at least 2%, at least 4%, at least 5%, at least 6%, in a range from 1% to 20%, from 2% to 20%, from 4% to 20%, from 5% to 20%, from 5% to 18%, from 1% to 15%, from 2% to 15%, from 4% to 15%, from 5% to 15%, from 1% to 10%, from 2% to 10%, from 4% to 10%, or from 5% to 10%.

Paragraph 30. The organic light-emitting component of any one of paragraphs 22-29, wherein the organic light-emitting component is an organic light-emitting diode ("OLED") or a light-emitting electrochemical cell ("LEEC").

Paragraph 31. The organic light-emitting component of any one of paragraphs 22-30, wherein the light-emitting layer or each of the light-emitting layer of the two or more light-emitting layers is formed by vacuum-evaporation deposition, spin-coating, ink-printing, or roll-to-roll printing.

Paragraph 32. The organic light-emitting component of any one of paragraphs 22-31, wherein the light emitting layer or each light-emitting layer of the two or more light-emitting layers further comprises an organic dye, and wherein the one or more dinuclear platinum(II) complexes act(s) as a sensitizer to transfer energy to the organic dye.

Paragraph 33. The organic light-emitting component of any one of paragraphs 22-31, wherein the light emitting layer or each light-emitting layer of the two or more light-emitting layers further comprises an organic dye, and wherein the one or more dinuclear platinum(II) complexes have a higher-lying singlet state than the organic dye.

Paragraph 34. A device comprising one or more organic light-emitting components of any one of paragraphs 22-33, wherein the device is a stationary visual display unit, a mobile visual display unit, an illumination device, a wearable device, a phototherapy device, or a medical monitoring device.

## Examples

### Example 1: Synthesis and characterization of dinuclear platinum(II) complexes

The efficient red or NIR emitters are based on the molecular system of dinuclear cyclometalated platinum(II) carbene complexes containing 2-oxy-pyridine (N^O) bridging ligands. Without being bound to theories, it is believed that the use of N^O bridging ligands allow strong metal-metal interactions between two platinum(II) metal centers in a paddle-wheel structure, which give rise to low-energy MMLCT excited states. These dinuclear platinum(II) emitters show red to deep-red ($\lambda_{max}$ at 612-685 nm) or NIR photoluminescence with high emission quantum yields of up to about 0.97 in thin films at room temperature. The emission lifetimes are down to 1.7-1.9 $\mu$s and the radiative decay rates reach high values of about $5.9\times10^5$ $s^{-1}$. Results of the doped OLEDs using the dinuclear platinum(II) emitters demonstrate electroluminescence spanning from red to NIR spectral region ($\lambda_{max}$ at 615-706 nm) with an EQE of 9.1-31.9%, at 1000 cd $m^{-2}$.

### *Materials and Methods*

*Synthesis and characterization of exemplary dinuclear platinum(II) complexes*

**Scheme 1.** Synthesis of exemplary ligands L3, L4, and L5.

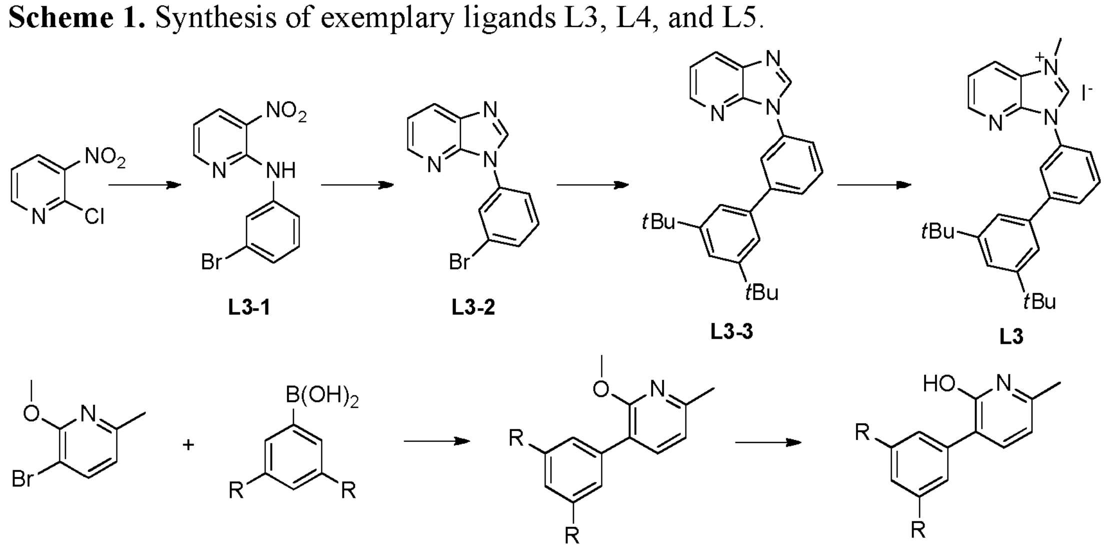

**L4-1**: R = H
**L5-1**: R = *t*Bu
**L6-1**: R = F

**L4**: R = H
**L5**: R = *t*Bu
**L6**: R = F

**Scheme 2.** Synthesis of exemplary dinuclear platinum(II) complexes.

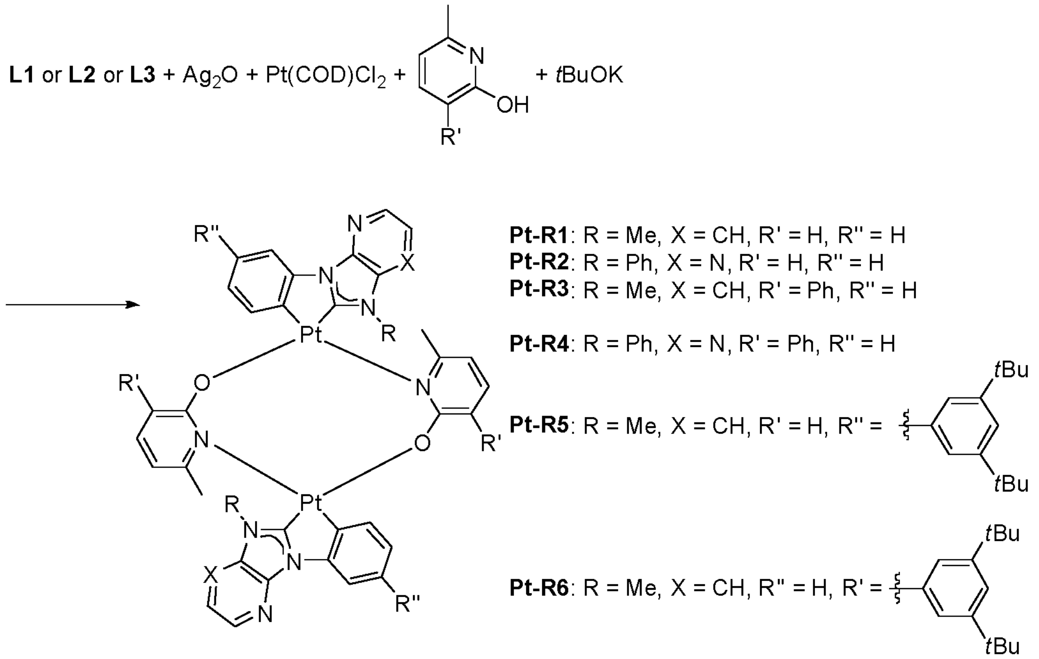


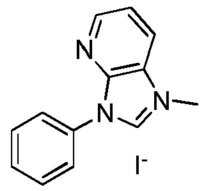

**L1**

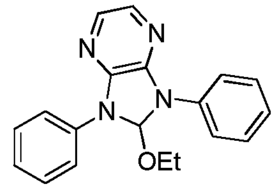

**L2**

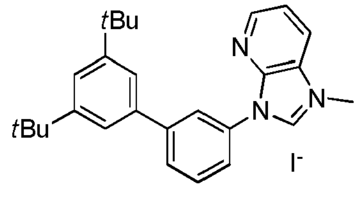

**L3**

The chemical reagents used for synthesis were purchased from commercial sources such as Dieckmann, Tiv Scientific, J & K Scientific, BLDpharm, Bidepharm, Strem Chemicals. They were directly used without further processing. The solvents used for synthesis were purchased from Duksan, RCI Labscan, Scharlau. They were directly used without further processing. $^{1}H$ and $^{13}C$ NMR spectra were recorded on DPX-400 or DPX-500 Bruker FT-NMR spectrometer. The chemical shift of proton or carbon signals are calibrated by the corresponding solvent residual signals. High resolution

mass spectra were measured with Bruker Impact II mass spectrometer.

**L1** and **L2** were synthesized according to reported procedure (Unger, et al., Angew. Chem. Int. Ed. 2010, 49, 10214-10216; Pinter, et al., Chem. Eur. J. 2019, 25, 14495-14499). **L3, L4,** and **L5** were synthesized following the procedures described below and as shown in Scheme 1 above.

N-(3-bromophenyl)-3-nitropyridin-2-amine (L3-1) was synthesized as follows. 3-bromoaniline (1.09 mL, 10.0 mmol) and 2-chloro-3-nitropyridine (1.90 g, 12.0 mmol) were heated in ethylene glycol (10 mL) at 140°C for 24 h. After cooling down to room temperature, the reaction mixture was diluted with ethyl acetate, then washed with water and brine. The organic fraction was dried over anhydrous $Na_2SO_4$ and the crude was concentrated under reduced pressure. The crude product was further purified by flash column chromatography on silica gel using n-hexane/ ethyl acetate (15:1) as eluent to afford the desired compound (L3-1) as orange solid. Yield: 93%. $^1$H NMR (400 MHz, $CD_2Cl_2$): δ 10.07 (s, 1H), 8.51 (t, *J* = 5.9 Hz, 2H), 8.02 (s, 1H), 7.53 (d, *J* = 7.6 Hz, 1H), 7.26 (dt, *J* = 15.7, 7.9 Hz, 2H), 6.90 (dd, *J* = 8.3, 4.6 Hz, 1H).

*3-(3-bromophenyl)-3-H-imidazo[4,5b]pyridine* (L3-2) was synthesized as follows. A mixture of L3-1 (2.73 g, 9.28 mmol), formic acid (23.0 mL, 608 mmol), ammonium chloride (2.59 g, 46.4 mmol) and iron powder (2.48 g, 46.4 mmol) were refluxed in 2-propanol (40 mL) for 48 h. Afterward, the reaction mixture was cooled to room temperature and the solvents were removed under reduced pressure. The residue was extracted with DCM and pass through a short pad of Celite. The organic extract was washed with 5% $NaHCO_3$ and brine, and then dried over anhydrous $Na_2SO_4$. The volatile was removed under reduced pressure. The crude product was further purified by flash column chromatography on silica gel using n-hexane/ ethyl acetate (3:1) as eluent to afford compound (L3-2) as white solid. Yield: 30%. $^1$H NMR (500 MHz, $CDCl_3$): δ 8.49 (dd, *J*= 4.7, 1.2 Hz, 1H), 8.40 (s, 1H), 8.18 (dd, *J* = 8.1, 1.3 Hz, 1H), 8.00 (t, *J*= 1.9 Hz, 1H), 7.77 (dd, *J*= 8.0, 1.2 Hz, 1H), 7.59 (dd, *J*= 8.1, 0.7 Hz, 1H), 7.46 (t, *J* = 8.1 Hz, 1H), 7.35 (dd, *J* = 8.1, 4.8 Hz, 1H).

3-(3',5'-di-tert-butyl-[1,1'-biphenyl]-3-yl)-3H-imidazo[4,5-b]pyridine (L3-3) was synthesized as follows. To a solution mixture of THF/ water (20.0 mL, 3:1), L3-2 (0.548 g, 2.00 mmol), (3,5-di-*tert*-butylphenyl) boronic acid (0.702 g, 3.00 mmol), potassium carbonate (0.829 g, 6.00 mmol) and tetrakis(triphenylphosphine) palladium(0) (0.116 g, 0.100 mmol) were added under argon atmosphere. The reaction mixture was refluxed for 24h. After cooling down to room temperature, the crude product was diluted with ethyl acetate and washed with water three times. The organic fraction was dried over $Na_2SO_4$ and concentrated under reduced pressure. The resulting residue was purified by flash chromatography on silica gel using n-hexane/ethyl acetate (3:1) as eluent to afford compound (L3-3) as white solid. Yield: 79%. $^1$H NMR (400 MHz, $CDCl_3$): δ 8.48 (d, *J* = 4.7 Hz, 1H), 8.42 (s, 1H), 8.19 (dd, *J* = 8.0, 1.1 Hz, 1H), 7.90 (s, 1H), 7.74 (dt, *J* = 7.2, 1.8 Hz, 1H), 7.70 - 7.62 (m, 2H), 7.49 (t, *J* = 1.6 Hz, 1H), 7.45 (d, *J* = 1.6 Hz, 2H), 7.34 (dd, *J* = 8.1, 4.8 Hz, 1H), 1.39 (s, 18H).

3-(3',5'-di-tert-butyl-[1,1'-biphenyl]-3-yl)-1-methyl-3*H*-imidazo[4,5-*b*]pyridin-1-ium iodide **(L3)** was synthesized as follows. L3-3 (0.500 g, 1.30 mmol) and methyl iodide (0.406 mL, 6.52 mmol) were dissolved in THF (10 mL) and stirred at 100°C in a sealed tube for 48 h. The solid was filtered and washed with diethyl ether to afford compound **(L3)** as light beige solid. Yield: 86%. $^1$H NMR (500 MHz, DMSO): δ 10.47 (s, 1H), 8.82 (d, *J* = 4.6 Hz, 1H), 8.72 (d, *J* = 8.4 Hz, 1H), 8.14 (s, 1H), 7.96 (d, *J* = 7.8 Hz, 1H), 7.90 (dd, *J*= 7.7, 5.5 Hz, 2H), 7.81 (d, *J*= 7.8 Hz, 1H), 7.50 (d, *J*= 14.9 Hz, 3H), 4.23 (s, 3H), 1.36 (s, 18H).

L4-1 was synthesized as follows. Phenylboronic acid (0.44 g, 3.60 mmol), $K_2CO_3$ (1.68 g, 12.13 mmol), $Pd(PPh_3)_4$ (0.16 g, 0.14 mmol) and 3-bromo-2-methoxy-6-methylpyridine (0.70 g, 0.35 mmol) was refluxed in 20 mL toluene/$H_2O$/EtOH (12:3:5) for 24 h. After the reaction was cooled to room temperature, all volatiles were removed under reduced pressure. The residue was extracted with DCM/$H_2O$. The organic fraction was dried with $MgSO_4$, filtered and concentrated under reduced pressure. The residue was purified with silica gel column chromatography using EA/hexane as eluent to obtain the product as colorless oil. Yield: quan. $^1$H NMR (300 MHz, $CDCl_3$): δ 7.54 (d, *J* = 7.2 Hz, 2H), 7.50 (d, *J* = 7.4 Hz, 1H), 7.41 (t, *J* = 7.4 Hz, 2H), 7.36 - 7.28 (m, 1H), 6.81 (d, *J* = 7.4 Hz, 1H), 3.96 (s, 3H), 2.49 (s, 3H). HRMS (EI) for $C_{13}H_{13}NO$ $[M]^+$: calcd 199.0997, found 199.0998.

**L4** was synthesized as follows. L4-1 (0.75 g, 3.64 mmol) and $BBr_3$ (17.32 mL, 2M in DCM, 34.64 mmol) were stirred overnight in 20 mL dry DCM at room temperature. Water was added to the reaction mixture and extracted with DCM. The combined organic layers were dried over anhydrous MgSO4, and the volatiles were removed in vacuo. The crude product was washed with MeOH to give the desired product as a beige solid. Yield: 48%. $^1$H NMR (300 MHz, DMSO): δ 11.78 (s, 1H), 7.70 (d, *J* = 7.3 Hz, 2H), 7.55 (d, *J* = 7.1 Hz, 1H), 7.35 (t, *J* = 7.3 Hz, 2H), 7.31 - 7.22 (m, 1H), 6.10 (d, *J* = 6.9 Hz, 1H), 2.20 (s, 3H). HRMS (EI) for $C_{12}H_{11}NO$ $[M]^+$: calcd 185.0841, found 185.0842.

L5-1 was synthesized as follows. (3,5-di-*tert*-butylphenyl)boronic acid (1.81 g, 7.72 mmol), $K_2CO_3$ (3.59 g, 25.98 mmol), $Pd(PPh_3)_4$ (0.17 g, 0.15 mmol) and 3-Bromo-2-methoxy-6-methylpyridine (1.50 g, 7.42 mmol) were refluxed in 30 mL toluene/$H_2O$/EtOH (12:3:5) for 24 h. After the reaction was cooled to room temperature, all volatiles were removed under reduced pressure. The residue was extracted with DCM/$H_2O$. The organic fraction was dried with $MgSO_4$, filtered and concentrated under reduced pressure. The residue was purified with silica gel column chromatography using EA/hexane as eluent to obtain the product as colorless oil. Yield: quan. $^1$H NMR (500 MHz, $CDCl_3$): δ 7.52 (d, *J* = 7.3 Hz, 1H), 7.40 (s, 3H), 6.80 (d, *J* = 7.4 Hz, 1H), 3.96 (s, 3H), 1.36 (s, 18H). HRMS (EI) for $C_{21}H_{29}NO$ $[M]^+$: calcd 311.2249, found 311.2248.

**L5** was synthesized as follows. L5-1 (1.48 g, 2.17 mmol) and $BBr_3$ (10.84 mL, 2M in HCl, 21.69 mmol) were stirred

overnight in 20 mL dry DCM at room temperature. Water was added to the reaction mixture and extracted with DCM. The combined organic layers were dried over anhydrous MgSO4, and the volatiles were removed in vacuo. The crude product was washed with MeOH to give the desired product as a light-yellow solid. Yield: 99%. $^1$H NMR (500 MHz, $CDCl_3$): δ 13.15 (s, 1H), 7.61 (s, 2H), 7.55 (d, *J* = *7.1* Hz, 1H), 7.39 (s, 1H), 6.15 (d, *J* = 7.1 Hz, 1H), 2.39 (s, 3H), 1.36 (s, 18H). HRMS (EI) for $C_{20}H_{28}NO$ $[M]^+$: calcd 297.2093, found 297.2093.

L6-1 was synthesized as follows. (3,5-difluorophenyl)boronic acid (0.41 g, 2.57 mmol), $K_2CO_3$ (1.20 g, 8.66 mmol), $Pd(PPh_3)_4$ (0.11 g, 0.10 mmol), and 3-Bromo-2-methoxy-6-methylpyridine (0.50 g, 2.48 mmol) were refluxed in 20 mL toluene/$H_2O$/EtOH (12:3:5) for 24 h. After the reaction was cooled to room temperature, all volatiles were removed under reduced pressure. The residue was extracted with DCM/$H_2O$. The organic fraction was dried with $MgSO_4$, filtered and concentrated under reduced pressure. The residue was purified with silica gel column chromatography using EA/hexane as eluent to obtain the product as a white solid. Yield: 88%. $^1$H NMR (500 MHz, $CDCl_3$): δ 7.49 (d, *J* = 7.5 Hz, 1H), 7.15 - 7.04 (m, 1H), 6.81 (d, *J* = 7.5 Hz, 1H), 6.76 (tt, *J* = 8.9, 2.2 Hz, 1H), 3.97 (s, 3H), 2.49 (s, 3H). $^{19}$F NMR (471 MHz, $CDCl_3$): δ - 110.69 (t, *J* = 6.9 Hz). HRMS (EI) for $C_{13}H_{11}NF_2O$ $[M]^+$: calcd 235.0809, found 235.0795.

**L6** was synthesized as follows. 3-(3,5-difluorophenyl)-2-methoxy-6-methylpyridine (1.20 g, 5.10 mmol) and $BBr_3$ (25.51 mL, 2M in DCM, 51.01 mmol) were stirred overnight in 20 mL dry DCM at room temperature. Water was added to the reaction mixture and extracted with DCM. The combined organic layers were dried over anhydrous MgSO4, and the volatiles were removed in vacuo. The crude product was washed with MeOH to give the desired product as a light pink solid. Yield: 87%. $^1$H NMR (500 MHz, $CDCl_3$): δ 11.86 (br, 1H), 7.57 (d, *J* = 7.0 Hz, 1H), 7.34 (d, *J* = 6.9 Hz, 2H), 6.76 (tt, *J* = 8.9, 2.1 Hz, 1H), 6.17 (d, *J* = 7.1 Hz, 1H), 2.39 (s, 3H). $^{19}$F NMR (471 MHz, $CDCl_3$): δ -110.63 (t, *J* = 8.1 Hz). HRMS (EI) for $C_{12}H_9NF_2O$ $[M]^+$: calcd 221.0652, found 221.0645.

**L1, L2,** or **L3** (1 eq.) and silver(I) oxide (0.6 eq) were added to a two-neck flask. After addition of dry DMF (1 mL per 0.1 mmol of imidazolium salt), the reaction mixture was stirred under argon atmosphere for 24 hours at 50 °C in the absence of light. Dichloro(1,5-cyclooctadiene)platinum(II) (1 eq.) was then added, and the mixture was stirred for 2 hours at 50 °C, and then for 24 hours at 125 °C. Afterwards, potassium *tert*-butoxide (4.01 eq.) and 2-methyl-6-hydroxypyridine (4.03 eq.) were added and the mixture was stirred for 24 hours at room temperature and then for further 24 hours at 100 °C. After reaction, the mixture was cooled to room temperature, all volatiles were removed under reduced pressure. The crude product was washed with water and purified by flash chromatography on silica gel using DCM/hexane as eluent. **Complexes Pt-R4** to **Pt-R15** were prepared by the same method as **Pt-R1** to **Pt-R3.**

**Pt-R1:** Yield: 24%. $^1$H NMR (500 MHz, $CD_2Cl_2$): δ 8.01 (dd, *J* = 4.9, 1.3 Hz, 2H), 7.69 (dd, *J*= 7.8, 1.1 Hz, 2H), 7.30 - 7.26 (m, 4H), 7.19 - 7.15 (m, 2H), 7.00 (td, *J* = 7.6, 1.2 Hz, 2H), 6.70 (td, *J* = 7.4, 1.3 Hz, 2H), 6.49 (d, *J* = 8.4 Hz, 2H), 6.45 - 6.30 (m, 4H), 3.15 (s, 6H), 2.75 (s, 6H). HRMS (ESI) for $C_{38}H_{33}Pt_2N_8O_2$ $[M+H]^+$: calcd 1023.2022, found 1023.1994.

**Pt-R2:** Yield: 24%. $^1$H NMR (500 MHz, $CD_2Cl_2$): δ 8.29 (d, *J*= 2.8 Hz, 2H), 8.20 (d, *J* = 2.8 Hz, 2H), 7.88 - 7.63 (m, 4H), 7.53 (d, *J* = 6.4 Hz, 2H), 7.30 (s, 2H), 7.19 - 6.98 (m, 6H), 6.73 - 6.67 (m, 2H), 6.58 - 6.53 (m, 2H), 6.12 (t, *J* = 7.3 Hz, 2H), 5.94 (d, *J* = 8.4 Hz, 2H), 5.86 (d, *J* = 7.0 Hz, 2H), 2.53 (s, 6H). HRMS (ESI) for $C_{46}H_{35}Pt_2N_{10}O_2$ $[M+H]^+$: calcd 1149.2240, found 1149.2220.

**Pt-R3:** Yield: 47%. $^1$H NMR (500 MHz, $CD_2Cl_2$): δ 8.01 (dd, J = 4.9, 1.1 Hz, 2H), 7.69 (d, J = 7.4 Hz, 2H), 7.60 (d, J = 7.3 Hz, 4H), 7.41 - 7.35 (m, 6H), 7.30 - 7.25 (m, 4H), 7.18 - 7.15 (m, 2H), 7.02 (t, J = 7.2 Hz, 2H), 6.74 (t, J = 7.4 Hz, 2H), 6.56 (d, J = 6.8 Hz, 2H), 6.38 (d, J = 7.4 Hz, 2H), 3.18 (s, 6H), 2.42 (s, 6H). HRMS (ESI) for $C_{50}H_{41}Pt_2N_8O_2$ $[M+H]^+$: calcd 1175.2648, found 1175.2609.

**Pt-R4:** Yield: 22%. $^1$H NMR (500 MHz, $CD_2Cl_2$) δ 8.30 (d, *J*= 2.7 Hz, 2H), 8.22 (d, *J* = 2.7 Hz, 2H), 8.04 - 7.73 (m, 4H), 7.65 (d, *J* = 7.3 Hz, 2H), 7.50 (d, *J* = 7.8 Hz, 4H), 7.41 - 7.35 (m, 4H), 7.31 - 7.23 (m, 4H), 7.08 (s, br, 4H), 6.99 (d, *J* = 6.4 Hz, 2H), 6.86 (d, *J*= 7.2 Hz, 2H), 6.63 - 6.51 (m, 2H), 6.25 - 6.14 (m, 2H), 5.90 (d, *J* = 7.2 Hz, 2H), 2.03 (s, 7H). HRMS (ESI) for $C_{58}H_{43}Pt_2N_{10}O_2$ $[M+H]^+$: calcd 1301.2866, found 1301.2826.

**Pt-R5:** Yield: 62%. $^1$H NMR (500 MHz, $CD_2Cl_2$): δ 8.12 - 8.00 (m, 4H), 7.49 - 7.39 (m, 6H), 7.34 - 7.24 (m, 4H), 7.20 - 7.13 (m, 2H), 7.01 (d, *J* = 7.7 Hz, 2H), 6.51 (d, *J* = 8.5 Hz, 2H), 6.44 (d, *J* = 7.8 Hz, 2H), 6.39 (d, *J* = 7.0 Hz, 2H), 3.21 (s, 1H), 2.78 (s, 1H), 1.42 (s, 6H).

**Pt-R6:** Yield: 21%. $^1$H NMR (500 MHz, $CD_2Cl_2$): δ 8.00 (d, *J* = 4.8 Hz, 1H), 7.69 (d, *J* = 7.7 Hz, 1H), 7.46 (s, 2H), 7.38 (d, *J* = 7.2 Hz, 1H), 7.35 (s, 1H), 7.29 (d, *J* = 8.0 Hz, 1H), 7.16 (dd, *J* = 7.8, 5.1 Hz, 1H), 7.03 (t, *J* = 7.5 Hz, 1H), 6.76 (t, *J* = 7.4 Hz, 1H), 6.64 (d, *J* = 7.5 Hz, 1H), 6.30 (d, *J* = 7.2 Hz, 1H), 3.20 (s, 3H), 2.30 (s, 3H), 1.36 (s, 18H). HRMS (ESI) for $C_{66}H_{73}Pt_2N_8O_2$ $[M+H]^+$: calcd 1399.5152, found 1399.5085.

**Pt-R7:** Yield: 21%. $^1$H NMR (500 MHz, $CD_2Cl_2$): δ 8.04 (dd, *J* = 4.9, 1.2 Hz, 2H), 7.68 (dd, *J* = 7.7, 1.0 Hz, 2H), 7.43 (d, *J* = 7.4 Hz, 2H), 7.30 (dd, *J* = 8.0, 1.2 Hz, 2H), 7.28 - 7.22 (m, 4H), 7.18 (dd, *J* = 8.0, 4.9 Hz, 2H), 7.01 (td, *J* = 7.6, 1.0 Hz, 2H), 6.79 - 6.68 (m, 4H), 6.54 (dd, *J* = 7.5, 0.9 Hz, 2H), 6.41 (d, *J* = 7.4 Hz, 2H), 3.20 (s, 6H), 2.51 (s, 6H). $^{19}$F NMR (471 MHz, $CD_2Cl_2$): δ -112.24 (t, *J*= 8.3 Hz, 4F).

**Pt-R8:** Yield: 41%. $^1$H NMR (500 MHz, $CD_2Cl_2$) δ = 8.17 (d, *J*=1.8, 2H), 7.87 (m, 2H), 7.56 (t, *J*=1.6, 2H), 7.45 (d, *J*=1.7, 4H), 7.38 (d, *J*=1.8, 2H), 7.29 (dd, *J*=8.4, 7.2, 2H), 7.06 (m, 2H), 6.74 (td, *J*=7.4, 1.1, 2H), 6.51 (d, *J*=8.5, 2H), 6.40 (m, 4H), 3.20 (s, 6H), 2.77 (s, 6H), 1.43 (s, 36H).

**Pt-R9:** Yield: 40%. $^1$H NMR (500 MHz, $CD_2Cl_2$) δ 8.55 (s, 2H), 8.27 (d, *J* = 4.8 Hz, 2H), 7.71 (d, *J*= 8.1 Hz, 2H), 7.40

(d, $J$ = 9.9 Hz, 6H), 7.29 (t, $J$= 7.7 Hz, 2H), 7.07 (dd, $J$ = 7.9, 5.0 Hz, 2H), 6.99 (d, $J$ = 7.8 Hz, 2H), 6.55 (d, $J$ = 8.4 Hz, 2H), 6.35 (d, $J$ = 7.9 Hz, 2H), 6.28 (d, $J$ = 6.9 Hz, 2H), 5.95 (dt, $J$ = 13.6, 6.8 Hz, 2H), 2.64 (s, 6H), 1.54 (s, 6H), 1.38 (s, 36H), 0.64 (d, $J$ = 6.9 Hz, 6H).

**Pt-R10:** Yield: 55%. $^1$H NMR (500 MHz, $CD_2Cl_2$) δ = 8.00 (m, 6H), 7.51 (t, $J$=7.7, 2H), 7.36 (d, $J$=7.5, 3H), 7.28 (s, 2H), 7.14 (d, $J$=8.0, 2H), 7.09 (m, 2H), 6.78 (m, 4H), 6.67 (d, $J$=6.7, 2H), 6.62 (t, J=7.2, 2H), 6.48 (d, $J$=7.1, 2H), 3.17 (s, 6H), 1.28 (s, 36H). An X-ray single crystal structure of **Pt-R10** is shown in **Figure 22.**

**Pt-R11:** Yield: 30%. $^1$H NMR (500 MHz, $CD_2Cl_2$) δ = 8.23 (d, $J$=1.8, 2H), 8.01 (s, 4H), 7.52 (ddd, J=20.4, 8.2, 4.4, 6H), 7.43 (d, $J$=1.7, 4H), 7.30 (s, 2H), 7.26 (d, $J$=1.8, 2H), 6.84 (t, $J$=7.5, 2H), 6.80 (m, 2H), 6.68 (dd, $J$=16.0, 7.4, 4H), 6.54 (d, $J$=7.1, 2H), 3.24 (s, 6H), 1.42 (s, 36H), 1.30 (s, 36H).

**Pt-R12:** Yield: 52%. $^1$H NMR (500 MHz, $CD_2Cl_2$) δ = 8.16 (d, $J$=1.8, 2H), 7.88 (m, 2H), 7.57 (t, J=1.6, 2H), 7.47 (dd, $J$=10.2, 1.8, 8H), 7.40 (dd, J=4.5, 2.7, 4H), 7.36 (t, $J$=1.7, 2H), 7.08 (td, $J$=7.6, 1.1, 2H), 6.79 (td, $J$=7.4, 1.1, 2H), 6.66 (d, J=6.6, 2H), 6.32 (d, $J$=7.3, 2H), 3.26 (s, 6H), 2.31 (s, 6H), 1.44 (s, 36H), 1.37 (s, 36H).

**Pt-R13:** Yield: 10%. $^1$H NMR (500 MHz, $CD_2Cl_2$) δ = 8.19 (dd, J=10.5, 2.8, 4H), 7.97 (d, $J$=7.7, 2H), 7.29 (m, 2H), 6.89 (t, J=7.5, 2H), 6.64 (t, $J$=7.4, 2H), 6.55 (d, J=8.4, 2H), 6.37 (d, $J$=7.5, 2H), 6.30 (d, $J$=6.9, 2H), 5.80 (dt, J=13.6, 6.8, 2H), 2.62 (s, 6H), 1.58 (d, J=6.8, 6H), 0.80 (d, $J$=6.9, 6H).

**Pt-R14:** Yield: 10%. $^1$H NMR (500 MHz, $CD_2Cl_2$) δ = 8.26 (m, 2H), 8.07 (d, J=7.7, 2H), 8.01 (dd, $J$=8.2, 0.9, 2H), 7.86 (m, 4H), 7.79 (m, 2H), 7.62 (d, J=7.3, 2H), 7.34 (s, 2H), 7.16 (t, J=6.8, 6H), 6.74 (m, 2H), 6.30 (t, J=7.5, 2H), 6.00 (d, J=8.4, 2H), 5.92 (t, $J$=7.3, 2H), 5.88 (d, J=7.1, 2H), 2.53 (s, 6H).

**Pt-R15:** Yield: 17%. $^1$H NMR (500 MHz, $CD_2Cl_2$) δ = 8.27 (d, $J$=8.3, 2H), 8.11 (s, 2H), 8.04 (m, 4H), 7.84 (ddd, $J$=22.5, 15.2, 7.4, 6H), 7.38 (s, 6H), 7.33 (s, 2H), 7.16 (s, 2H), 7.01 (s, 4H), 6.92 (d, $J$=7.3, 2H), 6.29 (t, J=7.5, 2H), 6.01 (t, $J$=7.2, 2H), 5.92 (d, J=7.3, 2H), 1.89 (s, 6H), 1.41 (s, 36H).

*Fabrication and Characterization of OLEDs*

Indium-tin-oxide (ITO) coated glass with a sheet resistance of 10 Ω/sq was used as the anode substrate. Before film deposition, patterned ITO substrates were cleaned with detergent, rinsed in de-ionized water, acetone, and isopropanol, and then dried in an oven for 1 h in a cleanroom. The slides were then treated in an ultraviolet-ozone chamber for 5 min. The OLEDs were fabricated in a Kurt J. Lesker SPECTROS vacuum deposition system with a base pressure of $10^{-7}$ mbar. In the vacuum chamber, organic materials were thermally deposited in sequence at a rate of 0.5 Å $s^{-1}$. The doping process in the EMLs was realized using co-deposition technology. Afterward, LiF (1.2 nm) and Al (100 nm) were thermally deposited at rates of 0.02 and 0.2 nm $s^{-1}$, respectively. The film thicknesses were determined in situ with calibrated oscillating quartz-crystal sensors.

Current density-brightness-voltage characteristics, EL spectra, and EQE of EL device were obtained by using a Keithley 2400 source-meter and an absolute external quantum efficiency measurement system (C9920-12, Hamamatsu Photonics). All devices were encapsulated in a 200-nm-thick $Al_2O_3$ thin film deposited by atomic layer deposition (ALD) in a Kurt J. Lesker SPECTROS ALD system before measurements.

***Results***

*Photophysical properties of dinuclear platinum(II) complexes*

The dinuclear platinum(II) complexes **(Pt-R1** to **Pt-R6)** display red to deep-red photoluminescence at 612 and 685 nm with quantum yields of 0.78-0.97 in PMMA films **(Figure 1A).** The short emission lifetimes are down to 1.7-1.9 μs, giving rise to high radiative rate constant ($k_r$) of $4.3 \times 10^5$ $s^{-1}$-$5.5 \times 10^5$ $s^{-1}$ and unprecedented low non-radiative decay rate constant ($k_{nr}$) as low as $0.16 \times 10^5$ $s^{-1}$. The dinuclear Pt(II) complexes **(Pt-R7, Pt-R8, Pt-R9, Pt-R10, Pt-R11, Pt-R12, Pt-R13)** display strong red phosphorescence with emission maxima at 607-641 nm and quantum yield of 0.80-0.95 in PMMA films at room temperature **(Figure 1B).** The emission lifetimes are 1.4-2.1 μs, giving rise to large radiative rate constant of $4.3\text{-}6.4 \times 10^5$ $s^{-1}$. Complexes **Pt-R14** and **Pt-R15** with π-extended conjugation at NHC moiety are near-infrared emissive in PMMA films at room temperature **(Figure 1C),** showing emission maxima at 749-752 nm, quantum yield of 0.42-0.53 and large radiative rate constant of $4.2\text{-}5.3 \times 10^5$ $s^{-1}$. The emission data and related photophysical data are shown in **Table 1.**

**Table 1.** Emission data of **Pt-R1-Pt-R15** at room temperature.

| | **Medium** | **$\lambda_{em}$/ nm** | **FWHM/ nm** | **$\Phi_{em}$#** | **$\tau_{em}$# [μs]** | **$k_r$ /$k_{nr}$ [$\times 10^5$ $s^{-1}$]** |
|---|---|---|---|---|---|---|
| **Pt-R1** | 4 wt% in PMMA | 612 | 85 | 0.91 | 1.7 | 5.4/0.53 |
| **Pt-R2** | 4 wt% in PMMA | 685 | 106 | 0.78 | 1.8 | 4.3/1.2 |
| **Pt-R3** | 4 wt% in PMMA | 612 | 94 | 0.94 | 1.7 | 5.5/0.35 |

(continued)

| | Medium | $\lambda_{em}$/ nm | FWHM/ nm | $\Phi_{em}$# | $\tau_{em}$# [$\mu$s] | $k_r$ /$k_{nr}$ [$\times 10^5$ $s^{-1}$] |
|---|---|---|---|---|---|---|
| **Pt-R4** | 4 wt% in PMMA | 684 | 107 | 0.76 | 1.7 | 4.5/1.4 |
| **Pt-R5** | 4 wt% in PMMA | 618 | 81 | 0.97 | 1.9 | 5.1/0.16 |
| **Pt-R6** | 4 wt% in PMMA | 614 | 85 | 0.87 | 1.8 | 4.8/0.72 |
| **Pt-R7** | 4 wt% in PMMA | 607 | 85 | 0.91 | 1.7 | 5.4/0.53 |
| **Pt-R8** | 4 wt% in PMMA | 621 | 86 | 0.95 | 1.7 | 5.6/0.29 |
| **Pt-R9** | 4 wt% in PMMA | 567 | 105 | 0.79 | 1.8 | 4.4/1.2 |
| **Pt-R10** | 4 wt% in PMMA | 631 | 97 | 0.90 | 2.1 | 4.3/0.48 |
| **Pt-R11** | 4 wt% in PMMA | 641 | 97 | 0.91 | 1.6 | 5.7/0.56 |
| **Pt-R12** | 4 wt% in PMMA | 621 | 78 | 0.90 | 1.4 | 6.4/0.71 |
| **Pt-R13** | 4 wt% in PMMA | 641 | 125 | 0.80 | 1.8 | 4.4/1.1 |
| **Pt-R14** | 4 wt% in PMMA | 749 | 118 | 0.53 | 1.0 | 5.3/4.7 |
| **Pt-R15** | 4 wt% in PMMA | 752 | 123 | 0.42 | 1.0 | 4.2/5.8 |
| #Measured under nitrogen atmosphere. | | | | | | |

*OLED performance*

Vacuum-deposited devices fabricated with **Pt-R1** exhibited red electroluminescence with CIE coordinates of (0.63, 0.37) at doping concentrations of 4-12 wt% **(Figures 2A-2D).** The external quantum efficiency ("EQE") and current efficiency ("CE") of the device doped with 4 wt% **Pt-R1** were 15.7% and 23.4 cd/A, respectively, at 1000 cd $m^{-2}$. The performance data of the device with **Pt-R1** are shown in **Table 2.**

Vacuum-deposited devices fabricated with **Pt-R2** exhibited NIR electroluminescence with $\lambda_{max}$ at 702-706 nm **(Figures 3A-3D).** The EQE of the device doped with 4 wt% **Pt-R2** was 9.1% at 1000 cd $m^{-2}$. The performance data of the device with **Pt-R2** are shown in **Table 3.** The $\lambda_{em}$ of the OLED fabricated with **Pt-R2** red-shifted to above 700 nm compared to the $\lambda_{em}$ of **Pt-R2** measured in a thin film (about 685 nm as shown in **Table 1).** The observed red-shift is mainly due to the different molecular packing of the Pt emitters in different host materials.

Two vacuum-deposited devices fabricated with **Pt-R3** both exhibited red electroluminescence with $\lambda_{max}$ at 615-621 nm (first device: **Figures 4A-4D;** second device: **Figures 5A-5D).** The EQE of the device doped with 4 wt% **Pt-R3** in DMIC-Cz: DMIC-Trz co-host (the second device) was 31.9% at 1000 cd $m^{-2}$. The performance data of the two devices fabricated with **Pt-R3** are shown in **Table 4** and **Table 5,** respectively. The device lifetime data of the second device fabricated with **Pt-R3** are shown in **Figures 6A-6C** and summarized in **Table 6.**

Two vacuum-deposited devices fabricated with **Pt-R4** both exhibited deep red to NIR electroluminescence with $\lambda_{max}$ at 690-698 nm (first device: **Figures 7A-7D;** second device: **Figures 8A-8D).** The EQE of the device doped with 8 wt% **Pt-R4** in TCTA: TPBi co-host (first device) was 13.0% at 1000 cd $m^{-2}$. The performance data of the two devices fabricated with **Pt-R4** are shown in **Table 7** and **Table 8,** respectively. The device lifetime data of the second device fabricated with **Pt-R4** are shown in **Figures 9A-9C** and summarized in **Table 9.**

Vacuum-deposited devices fabricated with **Pt-R5** exhibited red electroluminescence with $\lambda_{max}$ at 615-620 nm **(Figures 10A-10D).** The EQE of the device doped with 6 wt% **Pt-R5** in RH host was 15.6% at 1000 cd $m^{-2}$. The performance data of the devices fabricated with **Pt-R5** are shown in **Table 10.** The device lifetime data of the device fabricated with **Pt-R5** is shown in **Figure 11** and summarized in **Table 11.**

Vacuum-deposited devices fabricated with **Pt-R6** exhibited red electroluminescence **(Figures 13A-13D).** The performance data of the devices fabricated with **Pt-R6** are shown in **Table 12.** The device lifetime data of the device fabricated with **Pt-R6** is shown in **Figures 14A and 14B** and summarized in **Table 13.**

Vacuum-deposited devices fabricated with **Pt-R8** exhibited red electroluminescence **(Figures 15A-15D).** The performance data of the devices fabricated with **Pt-R8** are shown in **Table 14.** The device lifetime data of the device fabricated with **Pt-R8** is shown in **Figure 16** and summarized in **Table 15.**

Vacuum-deposited devices fabricated with **Pt-R11** exhibited red electroluminescence **(Figures 17A-17D).** The performance data of the devices fabricated with **Pt-R11** are shown in **Table 16.**

Vacuum-deposited devices fabricated with **Pt-R12** exhibited red electroluminescence **(Figures 18A-18D).** The performance data of the devices fabricated with **Pt-R12** are shown in **Table 17.**

The operational lifetime $LT_{95}$ of the devices based on these dinuclear Pt emitters is over 21200 hours, which is a new record high for Pt-red OLEDs in the literature. Additionally, red hyperfluorescence OLED was fabricated using **Pt-R8** as sensitizer and MR-R1 as dye. The electroluminescence of the devices fabricated with **Pt-R8** and MR-R1 is shown in **Figures 19A-19D,** and the performance data are shown in **Table 18.** The device lifetime data of the device fabricated with **Pt-R8** and MR-R1is shown in **Figure 20** and summarized in **Table 19.** The device displayed narrowband electroluminescence with FWHM of 57 nm and exceptionally long operational lifetime $LT_{97}$ of about 6600 hours. The solution-processed NIR OLEDs based on **Pt-R14,** displayed maximum EQE up to 6.0% **(Figures 21A-21C,** and **Table 20).**

Further, the vacuum-deposited devices fabricated with **Pt-R2** and **Pt-R5,** respectively, are compared with other platinum(II) red emitters. The performance data are shown in **Table 21.**

**Table 2.** Performance data of vacuum-deposited devices with **Pt-R1***.

| Pt-R1 conc. | L | CE [cd $A^{-1}$] | | PE [lm $W^{-1}$] | | EQE [%] | | CIE [(x, y)] | FWHM [nm] | $\lambda_{max}$ [nm] |
|---|---|---|---|---|---|---|---|---|---|---|
| | [cd $m^{-2}$] | Max | at 1000 cd -2 m | Max | at 1000 cd $m^{-2}$ | Max | at 1000 cd $m^{-2}$ | | | |
| 4 wt% | 41000 | 24.85 | 23.39 | 28.63 | 15.81 | 17.11 | 15.71 | 0.62, 0.38 | 86 | 622 |
| 8 wt% | 37600 | 21.84 | 20.38 | 23.77 | 11.88 | 16.72 | 15.17 | 0.63, 0.37 | 87 | 628 |
| 12 wt% | 35200 | 21 | 20.28 | 21.72 | 11.59 | 16.62 | 15.8 | 0.63, 0.37 | 87 | 628 |

* Device structure (a single layer of light emitting layer containing **Pt-R1):** ITO/HAT-CN (5 nm)/TAPC (40 nm)/TCTA (10 nm)/TCTA: TPBi: **Pt-R1** (20 nm)/TPBi (50 nm)/LiF (1 nm)/Al (100 nm).

**Table 3.** Performance data of vacuum-deposited devices with **Pt-R2*.**

| Pt-R2 conc. | L | CE [cd $A^{-1}$] | | PE [lm $W^{-1}$] | | EQE [%] | | CIE [(x, y)] | FWHM [nm] | $\lambda_{max}$ [nm] |
|---|---|---|---|---|---|---|---|---|---|---|
| | [cd $m^{-2}$] | Max | at 1000 cd $^{-2}$ m | Max | at 1000 cd $m^{-2}$ | Max | at 1000 cd $m^{-2}$ | | | |
| 4 wt% | 4540 | 1.7 | 1.19 | 1.73 | 0.36 | 15.1 | 9.06 | 0.70, 0.30 | 109 | 702 |
| 8 wt% | 2600 | 2 | 0.84 | 1.9 | 0.22 | 14.64 | 6.76 | 0.70, 0.30 | 110 | 706 |

* Device structure (a single layer of light-emitting layer containing **Pt-R2):** ITO/HAT-CN (5 nm)/TAPC (40 nm)/TCTA (10 nm)/TCTA: TPBi: **Pt-R2** (20 nm)/TPBi (50 nm)/LiF (1 nm)/Al (100 nm).

**Table 4.** Performance data of a first vacuum-deposited device with **Pt-R3*.**

| Pt-R3 conc. | L | CE [cd $A^{-1}$] | | PE [lm $W^{-1}$] | | EQE [%] | | CIE [(x, y)] | FWHM [nm] | $\lambda_{max}$ [nm] |
|---|---|---|---|---|---|---|---|---|---|---|
| | [cd $m^{-2}$] | Max | at 1000 cd $m^{-2}$ | Max | at 1000 cd $m^{-2}$ | Max | at 1000 cd $m^{-2}$ | | | |
| 4 wt% | 73100 | 32.3 | 30.2 | 38.7 | 23.7 | 19.6 | 18.3 | 0.61, 0.39 | 83 | 615 |
| 8 wt% | 80600 | 32.5 | 30.7 | 39.1 | 24.1 | 20.3 | 19.2 | 0.61, 0.39 | 83 | 618 |
| 12 wt% | 76600 | 29.9 | 28.3 | 34.4 | 20.9 | 20.2 | 19.2 | 0.62, 0.38 | 83 | 619 |
| 16 wt% | 80200 | 28.5 | 27.8 | 30.9 | 20.6 | 19.6 | 19.1 | 0.62, 0.38 | 83 | 620 |

* Device structure: ITO/HAT-CN (5 nm)/TAPC (40 nm)/TCTA (10 nm)/TCTA: TPBi: **Pt-R3** (20 nm)/TPBi (50 nm)/LiF (1 nm)/Al (100 nm).

**Table 5.** Performance data of a second vacuum-deposited device with **Pt-R3*.**

| Pt-R3 conc. | L | CE [cd $A^{-1}$] | | PE [lm $W^{-1}$] | | EQE [%] | | CIE [(x, y)] | FWHM [nm] | $\lambda_{max}$ [nm] |
|---|---|---|---|---|---|---|---|---|---|---|
| | [cd $m^{-2}$] | Max | at 1000 cd $m^{-2}$ | Max | at 1000 cd $m^{-2}$ | Max | at 1000 cd $m^{-2}$ | | | |
| 1 wt% | 84600 | 37.7 | 37 | 42.7 | 36.2 | 29.2 | 28.6 | 0.62, 0.38 | 77 | 621 |

(continued)

**Table 5.** Performance data of a second vacuum-deposited device with **Pt-R3***.

| Pt-R3 conc. | L | CE [cd $A^{-1}$] | | PE [lm $W^{-1}$] | | EQE [%] | | CIE [(x, y)] | FWHM [nm] | $\lambda_{max}$ [nm] |
|---|---|---|---|---|---|---|---|---|---|---|
| | [cd $m^{-2}$] | Max | at 1000 cd $m^{-2}$ | Max | at 1000 cd $m^{-2}$ | Max | at 1000 cd $m^{-2}$ | | | |
| 2 wt% | 85700 | 37.1 | 36.6 | 46.7 | 32.9 | 29.3 | 28.8 | 0.62, 0.38 | 77 | 620 |
| 4 wt% | 87200 | 40.6 | 39.7 | 51 | 35.8 | 32.7 | 31.9 | 0.62, 0.37 | 77 | 620 |

* Device structure: ITO/HAT-CN (10 nm)/FSFA (120 nm)/FSF4A (5 nm)/**Pt-R3:**DMIC-Cz: DMIC-Trz (30 nm)/ANT-Biz (5 nm)/ANT-Biz:Liq (1:1) (25 nm)/Liq (2 nm)/Al (100 nm).

**Table 6.** Lifetime measurement data for the second OLED containing **Pt-R3***.

| | | | Pt-R3 conc. | $L_0$ (cd $m^{-2}$)** | LT97 (h) | LT95 (h) | | | | |
|---|---|---|---|---|---|---|---|---|---|---|
| | | | 1 wt% | 15000 | 11.8 | 22.7 | | | | |
| | | | 2 wt% | 13000 | 15.7 | 30.4 | | | | |
| | | | 4 wt% | 21000 | 6.27 | 12 | | | | |

* Device structure: ITO/HAT-CN (10 nm)/FSFA (120 nm)/FSF4A (5 nm)/**Pt-R3**:DMIC-Cz: DMIC-Trz (30 nm)/ANT-Biz (5 nm)/ANT-Biz:Liq (1:1) (25 nm)/Liq (2 nm)/Al (100 nm).

** The initial luminance intensity at which LT is measured refers to $L_0$.

**Table 7.** Performance data of a first vacuum-deposited device with **Pt-R4***.

| Pt-R4 conc. | L | CE [cd $A^{-1}$] | | PE [lm $W^{-1}$] | | EQE [%] | | CIE [(x, y)] | FWHM [nm] | $\lambda_{max}$ [nm] |
|---|---|---|---|---|---|---|---|---|---|---|
| | [cd $m^{-2}$] | Max | at 1000 cd $m^{-2}$ | Max | at 1000 cd $m^{-2}$ | Max | at 1000 cd $m^{-2}$ | | | |
| 2 wt% | 10400 | 3.62 | 2.47 | 3.79 | 1.07 | 17 | 11.6 | 0.67, 0.32 | 104 | 690 |
| 4 wt% | 12100 | 3.31 | 2.31 | 3.47 | 0.93 | 17.5 | 12.2 | 0.68, 0.31 | 104 | 694 |
| 8 wt% | 13320 | 2.96 | 2.09 | 3.1 | 0.77 | 18.3 | 13 | 0.69, 0.31 | 104 | 694 |

* Device structure: ITO/HAT-CN (5 nm)/TAPC (40 nm)/TCTA (10 nm)/TCTA: TPBi: Pt-R4 (20 nm)/TPBi (50 nm)/LiF (1 nm)/Al (100 nm).

**Table 8.** Performance data of a second vacuum-deposited device with **Pt-R4***.

| Pt-R4 conc. | L | CE [cd $A^{-1}$] | | PE [lm $W^{-1}$] | | EQE [%] | | CIE [(x, y)] | FWHM [nm] | λmax [nm] |
|---|---|---|---|---|---|---|---|---|---|---|
| | [cd $m^{-2}$] | Max | at 1000 cd $m^{-2}$ | Max | at 1000 cd $m^{-2}$ | Max | at 1000 cd $m^{-2}$ | | | |
| 2 wt% | 25200 | 3.57 | 3.03 | 3.67 | 1.28 | 12.3 | 10.5 | 0.65, 0.34 | 109 | 691 |
| 4 wt% | 22100 | 3.29 | 2.62 | 3.44 | 1.03 | 14.7 | 11.7 | 0.67, 0.32 | 109 | 698 |
| 8 wt% | 21200 | 3.03 | 2.32 | 3.11 | 0.88 | 15 | 11.5 | 0.68, 0.32 | 109 | 698 |

* Device structure: ITO/HAT-CN (10 nm)/BPBPA (120 nm)/EB (5 nm)/**Pt-R4** :RH (40 nm)/HB (5 nm)/ZADN:Liq (35:65) (35 nm)/Liq (2 nm)/Al (100 nm).

**Table 9.** Lifetime measurement data for the second OLED containing **Pt-R4***.

| | | | Pt-R4 conc. | $L_0$ (cd $m^{-2}$)** | LT97 (h) | LT95 (h) | LT90 (h) | | | |
|---|---|---|---|---|---|---|---|---|---|---|
| | | | 2 wt% | 1500 | 1.96 | 4.92 | 18.4 | | | |
| | | | 4 wt% | 1300 | 28.9 | 60.1 | 205 | | | |

(continued)

| **Table 9.** Lifetime measurement data for the second OLED containing **Pt-R4***. | | | | | | | | | | |
|---|---|---|---|---|---|---|---|---|---|---|
| | | | **Pt-R4 conc.** | **$L_0$ (cd $m^{-2}$)**** | **LT97 (h)** | **LT95 (h)** | **LT90 (h)** | | | |
| | | | 8 wt% | 1300 | 58 | 136 | 510 | | | |
| * Device structure: ITO/HAT-CN (10 nm)/BPBPA (120 nm)/EB (5 nm)/**Pt-R4** :RH (40 nm)/HB (5 nm)/ZADN:Liq (35:65) (35 nm)/Liq (2 nm)/Al (100 nm). | | | | | | | | | | |
| ** The initial luminance intensity at which LT is measured refers to $L_0$. | | | | | | | | | | |

| **Table 10.** Performance data of vacuum-deposited device with **Pt-R5***. | | | | | | | | | | |
|---|---|---|---|---|---|---|---|---|---|---|
| **Pt-R5 conc.** | **L** | **CE [cd $A^{-1}$]** | | **PE [lm $W^{-1}$]** | | **EQE [%]** | | **CIE [(x, y)]** | **FWHM [nm]** | **λmax [nm]** |
| | **[cd $m^{-2}$]** | Max | at 1000 cd $m^{-2}$ | Max | at 1000 cd $m^{-2}$ | Max | at 1000 cd $m^{-2}$ | | | |
| 2 wt% | 89300 | 23.7 | 22.2 | 29.2 | 18.7 | 14.2 | 13.3 | 0.60, 0.39 | 87 | 615 |
| 6 wt% | 96200 | 25 | 24.5 | 28.9 | 19.2 | 16 | 15.6 | 0.61, 0.38 | 87 | 620 |
| 10 wt% | 83100 | 21.8 | 21.2 | 24.3 | 15 | 14.4 | 13.9 | 0.62, 0.38 | 87 | 620 |
| * Device structure: ITO/HAT-CN (10 nm)/BPBPA (40 nm)/EB (5 nm)/Pt-R5:RH (40 nm)/HB (5 nm)/ZADN:Liq (35:65) (35 nm)/Liq (2 nm)/Al (100 nm). | | | | | | | | | | |

| **Table 11.** Lifetime measurement data for the OLED containing Pt-R5*. | | | | | | | | | | |
|---|---|---|---|---|---|---|---|---|---|---|
| | | **Conc.** | $L_0$ | **LT@$L_0$** | | **n** | **LT@10 00 cd $m^{-2}$** | | | |
| | | | **[cd $m^{-2}$]** | LT97**[h]** | LT95 **[h]** | | LT97 **[h]** | LT95 **[h]** | | |
| | | 6 wt/wt% | 10500 | 88 | 198 | 1.7 | 4792 | 10781 | | |
| Assume n = 1.7 in $LT(L_1) = LT(L_0)\times(L_0/L_1)^n$ | | | | | | | | | | |
| *Device structure (a single layer of light emitting layer containing **Pt-R5):** ITO/HAT-CN (10 nm)/BPBPA (40 nm)/EB (5 nm)/**Pt-R5**:RH (40 nm)/HB (5 nm)/ ZADN:Liq (35:65) (35 nm)/Liq (2 nm)/Al (100 nm). | | | | | | | | | | |
| ** The initial luminance intensity at which LT is measured refers to $L_0$. | | | | | | | | | | |

| **Table 12.** Performance data of vacuum-deposited devices with **Pt-R6***. | | | | | | | | | | |
|---|---|---|---|---|---|---|---|---|---|---|
| **Pt-R6 conc.** | **L** | **CE [cd $A^{-1}$]** | | **PE [lm $W^{-1}$]** | | **EQE [%]** | | **CIE [(x, y)]** | **FWHM [nm]** | **λmax [nm]** |
| | **[cd $m^{-2}$]** | Max | at 1000 cd $m^{-2}$ | Max | at 1000 cd $m^{-2}$ | Max | at 1000 cd $m^{-2}$ | | | |
| 2 wt% | 102000 | 30 | 28.8 | 35.7 | 26.6 | 18.6 | 17.9 | 0.61, 0.38 | 83 | 620 |
| 6 wt% | 93400 | 24 | 22.9 | 27.9 | 17 | 17 | 16.3 | 0.62, 0.38 | 84 | 621 |
| 10 wt% | 93000 | 24.6 | 23 | 28 | 15.5 | 17.2 | 16.2 | 0.63, 0.37 | 84 | 624 |
| * Device structure (a single layer of light emitting layer containing Pt-R6): ITO/HAT-CN (10 nm)/BPBPA (40 nm)/EB (5 nm)/**Pt-R6**:RH (40 nm)/HB (5 nm)/ZADN:Liq (35:65) (35 nm)/Liq (2 nm)/Al (100 nm). | | | | | | | | | | |

| **Table 13.** Device lifetime measurement for **Pt-R6***. | | | | | | | | | | |
|---|---|---|---|---|---|---|---|---|---|---|
| | | **Conc.** | $L_0$ | **LT@$L_0$** | | **n** | **LT@1000 cd $m^{-2}$** | | | |
| | | | **[cd $m^{-2}$]** | LT97 **[h]** | LT95 **[h]** | | LT97 **[h]** | LT95 **[h]** | | |
| | | 2 wt/wt% | 8000 | 136 | 300 | 1.7 | 4664 | 10289 | | |
| | | 10 wt/wt% | 10500 | 230 | 390 | 1.7 | 12524 | 21237 | | |

(continued)

| Table 13. Device lifetime measurement for **Pt-R6***. | | | | | | | | | | |
|---|---|---|---|---|---|---|---|---|---|---|
| | | **Conc.** | $L_0$ | **LT@$L_0$** | | **n** | **LT@1000 cd $m^{-2}$** | | | |
| | | | **[cd $m^{-2}$]** | LT97 [**h**] | LT95 [**h**] | | LT97 [**h**] | LT95 [**h**] | | |
| Assume n = 1.7 in $LT(L_1) = LT(L_0)\times(L_0/L_1)^n$ | | | | | | | | | | |
| *Device structure (a single layer of light emitting layer containing **Pt-R6):** ITO/HAT-CN (10 nm)/BPBPA (40 nm)/EB (5 nm)/**Pt-R6**:RH (40 nm)/HB (5 nm)/ZADN:Liq (35:65) (35 nm)/Liq (2 nm)/Al (100 nm). | | | | | | | | | | |

| Table 14. Performance data of vacuum-deposited devices with **Pt-R8***. | | | | | | | | | | |
|---|---|---|---|---|---|---|---|---|---|---|
| **Pt-R8 conc.** | **L** | **CE [cd $A^{-1}$]** | | **PE [lm $W^{-1}$]** | | **EQE [%]** | | **CIE [(x, y)]** | **FWHM [nm]** | **λmax [nm]** |
| | **[cd $m^{-2}$]** | Max | at 1000 cd $m^{-2}$ | Max | at 1000 cd $m^{-2}$ | Max | at 1000 cd $m^{-2}$ | | | |
| 2 wt% | 119000 | 32.5 | 29.1 | 40.9 | 25.9 | 21 | 18.9 | 0.61, 0.39 | 91 | 625 |
| 6 wt% | 128000 | 31 | 30.1 | 35.9 | 25.3 | 21.7 | 20.9 | 0.62, 0.38 | 89 | 625 |
| 10 wt% | 136000 | 31.7 | 29.9 | 39.2 | 23.6 | 22.8 | 21.4 | 0.62, 0.38 | 89 | 630 |
| * Device structure (a single layer of light emitting layer containing **Pt-R8):** ITO/HAT-CN (10 nm)/BPBPA (40 nm)/EB (5 nm)/**Pt-R8**:RH (40 nm)/HB (5 nm)/ZADN:Liq (35:65) (35 nm)/Liq (2 nm)/Al (100 nm). | | | | | | | | | | |

| Table 15. Device lifetime measurement for **Pt-R8***. | | | | | | | | | | |
|---|---|---|---|---|---|---|---|---|---|---|
| | | **Conc.** | $L_0$ | **LT@$L_0$** | | **n** | **LT@1000** cd **$m^{-2}$** | | | |
| | | | **[cd $m^{-2}$]** | LT97 [h] | LT95 [h] | | LT97 **[h]** | LT95 **[h]** | | |
| | | 10 wt/wt% | 13000 | 116 | 196 | 1.7 | 9082 | 15345 | | |
| Assume n = 1.7 in $LT(L_1) = LT(L_0)*(L_0/L_1)^n$ | | | | | | | | | | |
| *Device structure (a single layer of light emitting layer containing **Pt-R8):** ITO/HAT-CN (10 nm)/BPBPA (40 nm)/EB (5 nm)/**Pt-R8**:RH (40 nm)/HB (5 nm)/ZADN:Liq (35:65) (35 nm)/Liq (2 nm)/Al (100 nm). | | | | | | | | | | |

| **Table** 16. Performance data of vacuum-deposited devices with **Pt-R11***. | | | | | | | | | | |
|---|---|---|---|---|---|---|---|---|---|---|
| **Pt-R11 conc.** | **L** | **CE [cd $A^{-1}$]** | | **PE [lm $W^{-1}$]** | | **EQE** [%] | | **CIE [(x, y)]** | **FWHM [nm]** | **λmax [nm]** |
| | **[cd $m^{-2}$]** | Max | at 1000 cd $m^{-2}$ | Max | at 1000 cd $m^{-2}$ | Max | at 1000 cd $m^{-2}$ | | | |
| 2 wt% | 69500 | 15.1 | 13.6 | 17.7 | 10.4 | 16.4 | 14.9 | 0.62, 0.37 | 106 | 650 |
| 6 wt% | 66500 | 14.1 | 13.3 | 16.8 | 9.9 | 18.8 | 17.7 | 0.64, 0.35 | 104 | 649 |
| 10 wt% | 51500 | 13.6 | 12.4 | 17.1 | 8.7 | 21 | 19.1 | 0.65, 0.35 | 105 | 652 |
| * Device structure (a single layer of light emitting layer containing Pt-R11): ITO/HAT-CN (10 nm)/BPBPA (40 nm)/NPB-BC (5 nm)/Pt-R11:RH (40 nm)/HB (5 nm)/ZADN:Liq (35:65) (35 nm)/Liq (2 nm)/Al (100 nm). | | | | | | | | | | |

| Table 17. Performance data of vacuum-deposited devices with **Pt-R12***. | | | | | | | | | | |
|---|---|---|---|---|---|---|---|---|---|---|
| **Pt-R12 conc.** | **L** | **CE [cd $A^{-1}$]** | | **PE [lm $W^{-1}$]** | | **EQE [%]** | | **CIE [(x, y)]** | **FWHM [nm]** | **λmax [nm]** |
| | **[cd $m^{-2}$]** | Max | at 1000 cd $m^{-2}$ | Max | at 1000 cd $m^{-2}$ | Max | at 1000 cd $m^{-2}$ | | | |
| 2 wt% | 83300 | 30.4 | 30.1 | 36 | 26.9 | 21.3 | 21.1 | 0.62, 0.38 | 88 | 623 |
| 6 wt% | 104000 | 29.8 | 29.1 | 36 | 22.8 | 22.3 | 21.7 | 0.63, 0.37 | 88 | 626 |

(continued)

| **Table 17.** Performance data of vacuum-deposited devices with **Pt-R12***. | | | | | | | | | | |
|---|---|---|---|---|---|---|---|---|---|---|
| **Pt-R12 conc.** | **L** | **CE [cd $A^{-1}$]** | | **PE [lm $W^{-1}$]** | | **EQE [%]** | | **CIE [(x, y)]** | **FWHM [nm]** | **λmax [nm]** |
| | **[cd $m^{-2}$]** | Max | at 1000 cd $m^{-2}$ | Max | at 1000 cd $m^{-2}$ | Max | at 1000 cd $m^{-2}$ | | | |
| 10 wt% | 89000 | 23.6 | 23.5 | 27.2 | 16.4 | 18.2 | 18 | 0.63, 0.37 | 88 | 626 |
| * Device structure (a single layer of light emitting layer containing **Pt-R12**): ITO/HAT-CN (10 nm)/BPBPA (40 nm)/NPB-BC (5 nm)/Pt-R12:RH (40 nm)/HB (5 nm)/ZADN:Liq (35:65) (35 nm)/Liq (2 nm)/Al (100 nm). | | | | | | | | | | |

| **Table 18.** Performance data of vacuum-deposited hyperfluorescence devices with **Pt-R8** and MR-R1 *. | | | | | | | | | | |
|---|---|---|---|---|---|---|---|---|---|---|
| **Pt-R8: MR-R1** | L | **CE [cd $A^{-1}$]** | | **PE [lm $W^{-1}$]** | | **EQE [%]** | | **CIE** [(x, **y)]** | **FWHM [nm]** | **λmax [nm]** |
| | **[cd $m^{-2}$]** | Max | at 1000 cd $m^{-2}$ | Max | at 1000 cd $m^{-2}$ | Max | at 1000 cd $m^{-2}$ | | | |
| 6:0 wt%/wt% | 110000 | 34 | 32.9 | 50.6 | 25.9 | 23.1 | 22.4 | 0.62, 0.38 | 90 | 620 |
| 06:00.3 wt%/wt% | 99400 | 25.9 | 24.9 | 40.1 | 18.4 | 18 | 17.2 | 0.63, 0.37 | 57 | 611 |
| * Device structure (a single layer of light emitting layer containing **Pt-R8** and MR-R1): ITO/HAT-CN (10 nm)/BPBPA (40 nm)/EB (5 nm)/**Pt-R8:** MR-R1: RH (40 nm)/HB (5 nm)/ZADN:Liq (35:65) (35 nm)/Liq (2 nm)/Al (100 nm). | | | | | | | | | | |

| **Table 19.** Device lifetime measurement for **Pt-R8** and MR-R1*. | | | | | | | | | |
|---|---|---|---|---|---|---|---|---|---|
| | | Conc. of **Pt-R8:** MR-R1 | **$L_0$ [cd $m^{-2}$]** | **$LT_{97}$@$L_0$** | **n** | **$LT_{97}$@1000 cd $m^{-2}$** | | | |
| | | 6:0.3 wt%/wt% | 10000 | 133 | 1.7 | 6666 | | | |
| Assume n = 1.7 in $LT(L_1) = LT(L_0)\times(L_0/L_1)^n$ | | | | | | | | | |
| *Device structure (a single layer of light emitting layer containing **Pt-R8** and MR-R1): ITO/HAT-CN (10 nm)/BPBPA (40 nm)/EB (5 nm)/**Pt-R8**:MR-R1:RH (40 nm)/HB (5 nm)/ZADN:Liq (35:65) (35 nm)/Liq (2 nm)/Al (100 nm). | | | | | | | | | |

| **Table 20.** Performance data of vacuum-deposited NIR-emitting devices with **Pt-R14***. | | | | | | | | | | |
|---|---|---|---|---|---|---|---|---|---|---|
| | **NIR-emitting device** | **Pt-R14 conc.** | **L** | **CE [cd $A^{-1}$]** | **PE [lm W $^{1}$]** | **EQE[%]** | **CIE [(x, y)]** | **FWHM [nm]** | **λmax [nm]** | |
| | | | **[cd $m^{-2}$]** | Max | Max | Max | | | | |
| | Device 1 | 2 wt% | 221 | 0.28 | 0.13 | 6 | 0.62, 0.29 | 127 | 743 | |
| | Device 2 | 4 wt% | 268 | 0.19 | 0.08 | 5.1 | 0.68, 0.29 | 129 | 745 | |
| | Device 3 | 6 wt% | 319 | 0.13 | 0.05 | 3.7 | 0.69, 0.29 | 131 | 746 | |
| | Device 4 | 8 wt% | 342 | 0.15 | 0.06 | 4.8 | 0.70, 0.29 | 130 | 746 | |
| * Device structure (a single layer of light emitting layer containing Pt-R14): ITO/PEDOT:PSS(40 nm)/PVK(10 nm)/ **Pt-R14**:CBP /DPEPO (10 nm)/TPBi (40 nm)/Liq (2 nm)/Al (100 nm). | | | | | | | | | | |

**Table 21.** Comparison with other Pt(II) red emitters

| | **Current data for Pt-R5 (6 wt%)** | **Current data for Pt-R6 (10 wt%)** | **Current data for Pt-R2 (4 wt%) (NIR)** | **Comparative Compound Pt1*** | **Comparative Compound Pt1a** and Pt2a***** |
|---|---|---|---|---|---|
| **kr; knr [$s^{-1}$]** | $5.1\times10^5$ ; $1.6\times10^4$ | $4.8\times10^5$; $7.2\times10^4$ | $4.8\times10^5$; $1.5\times10^5$ | $1.0\times10^5$ ; $1.2\times10^5$ | Pt1a: $3.8\times10^5$; $1.0\times10^5$ |

(continued)

| | Current data for Pt-R5 (6 wt%) | Current data for Pt-R6 (10 wt%) | Current data for Pt-R2 (4 wt%) (NIR) | Comparative Compound Pt1* | Comparative Compound Pt1a** and Pt2a*** |
|---|---|---|---|---|---|
| | | | | | Pt2a (NIR): $3.8\times10^5$; $2.1\times10^5$ |
| **CIE (x,y)** | (0.61, 0.38) | (0.63, 0.37) | (0.70, 0.30) | (0.58, 0.35) | Pt1a: (0.63, 0.37); Pt1a: (0.60, 0.40); Pt2a (NIR): ca. (0.70, 0.30) |
| **Maximum Brightness L [cd/m$^2$]** | 96200 | 93000 | 4540 | 17570 | 75000; 58400; 10500 |
| **CE @1000 cd/m$^2$ (cd/A)** | 24.5 | 23.0 | 1.2 | 19.5 | 28.7; 35.1; NA |
| **PE @1000 cd/m$^2$ [lm/W]** | 19.2 | 15.5 | 0.36 | 20.0 | 15.5; 30.7; NA (max. radiance: 4.2 mW) |
| **EQE @1000 cd/m$^2$ [%]** | 15.6 | 16.2 | 9.1 | 14.5 | 18.7; 18.9; 13.0 |
| **LT** | LT95@1000n its: ca. 10800 h | LT95@1000ni ts: ca. 21200 h | NA | NA | LT95@1000nit s: ca. 9300 h |

* **Pt1:**

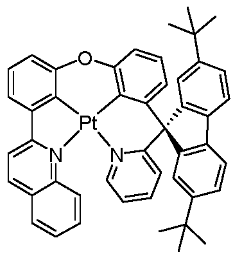

** **Ptla:**

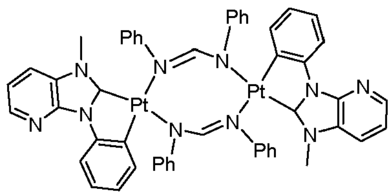

*** **Pt2a:**

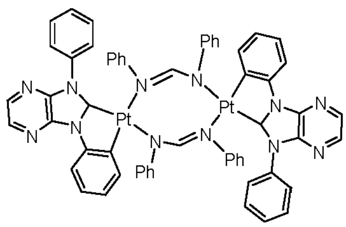

Unless defined otherwise, all technical and scientific terms used herein have the same meanings as commonly understood by one of skill in the art to which the disclosed invention belongs. Further, unless otherwise indicated, use of the expression "wt%" refers to "wt/wt%."

Y. Unger, D. Meyer, O. Molt, C. Schildknecht, I. Münster, G. Wagenblast, T. Strassner, Angew. Chem. Int. Ed. 2010, 49, 10214-10216.

P. Pinter, J. Soellner, T. Strassner, Chem. Eur. J. 2019, 25, 14495-14499.

## Claims

1. A dinuclear platinum(II) complex having a structure:

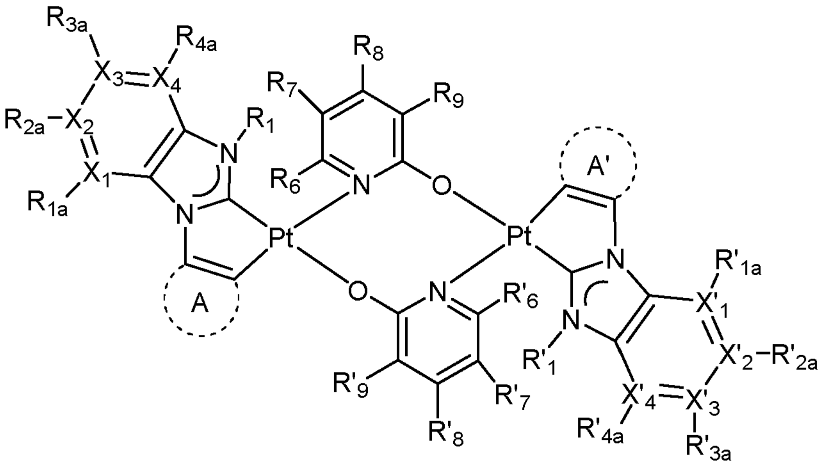

Formula I'

wherein:

(i) the complex is an overall neutral, negative, or positive charge;
(ii) $X_1$-$X_4$ and $X'_1$-$X'_4$ are independently carbon, nitrogen, sulfur, or oxygen;
(iii) $R_{1a}$-$R_{4a}$, $R'_{1a}$-$R'_{4a}$, $R_1$, $R'_1$, $R_6$-$R_9$, and $R'_6$-$R'_9$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, unsubstituted $C_2$-$C_{20}$ heterocyclyl, borenium cation, phosphonyl, sulfinyl, or sulfonyl, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, fused combinations thereof, or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, $R'_{3a}$ and $R'_{4a}$ together, $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof;
(iv) A and A' are independently a substituted cycloalkyl, an unsubstituted cycloalkyl, a substituted cycloalkenyl, an unsubstituted cycloalkenyl, a substituted cycloalkynyl, an unsubstituted cycloalkynyl, a substituted heterocyclyl, an unsubstituted heterocyclyl, a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, or fused combinations thereof; preferably A and A' are independently a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof; and
(v) each substituent is independently a substituted or unsubstituted alkyl, a substituted or unsubstituted alkenyl, a substituted or unsubstituted alkynyl, a substituted or unsubstituted heterocyclyl, a substituted or unsubstituted

aryl, a substituted or unsubstituted heteroaryl, a substituted or unsubstituted polyaryl, a substituted or unsubstituted polyheteroaryl, a substituted or unsubstituted aralkyl, a carbonyl, an alkoxy, a halogen, a hydroxyl, a phenoxy, a thiol, an alkylthio, a phenylthio, an arylthio, a cyano, an isocyano, a nitro, a carboxyl, an amino, an amido, an oxo, a silyl, a sulfinyl, a sulfonyl, a sulfonic acid, a phosphonium, a phosphanyl, a phosphoryl, or a phosphonyl.

**2.** The dinuclear platinum(II) complex of claim 1, wherein the dinuclear platinum(II) has a structure:

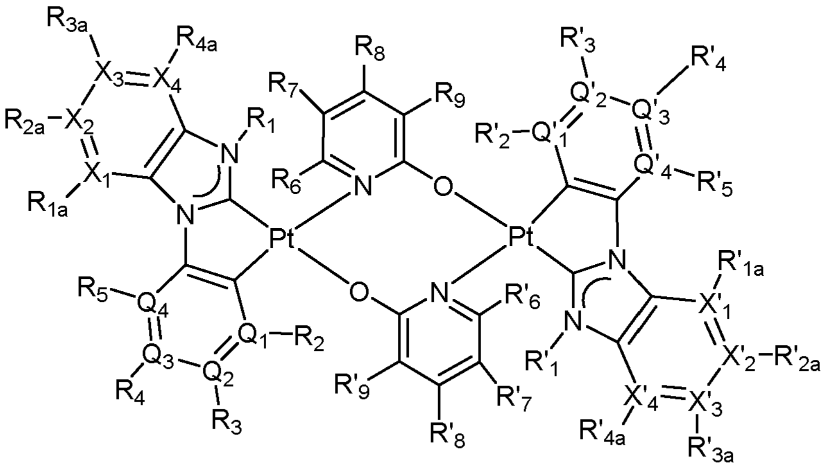

Formula I

or

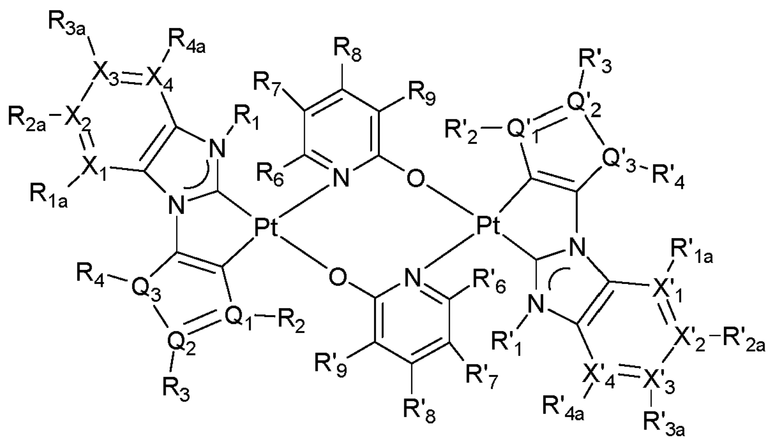

,

Formula Ia

wherein:

(i) the complex has an overall neutral, negative, or positive charge;
(ii) $Q_1$-$Q_4$ and $Q'_1$-$Q'_4$ are independently carbon, nitrogen, sulfur, or oxygen; and
(iii) $R_2$-$R_5$ and $R'_2$-$R'_5$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl, borenium cation, phosphonyl, sulfinyl, or sulfonyl, or $R_2$ and $R_3$ together, $R_3$ and $R_4$ together, $R_4$ and $R_5$ **together,** $R'_2$ and $R'_3$ together, $R'_3$ and $R'_4$ together, and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an

unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, fused combinations thereof, or $R_2$ and $R_3$ together, $R_3$ and $R_4$ together, $R_4$ and $R_8$ together, $R'_2$ and $R'_3$ together, $R'_3$ and $R'_4$ together, and/or $R'_4$ and $R'_5$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof.

**3.** The complex of claim 1, wherein the complex has a structure:

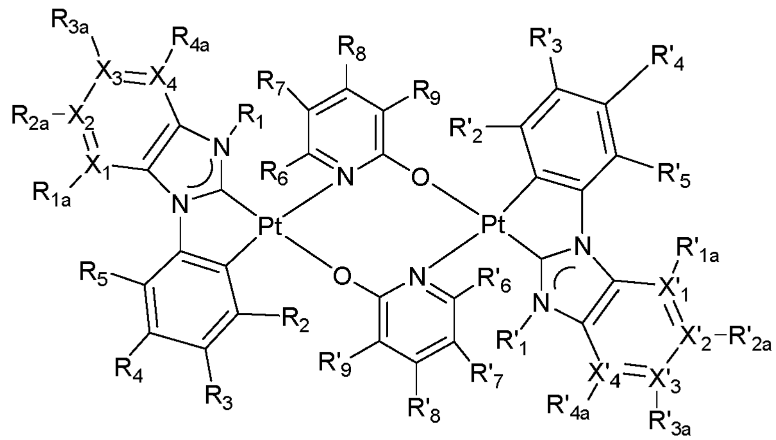

Formula II

or

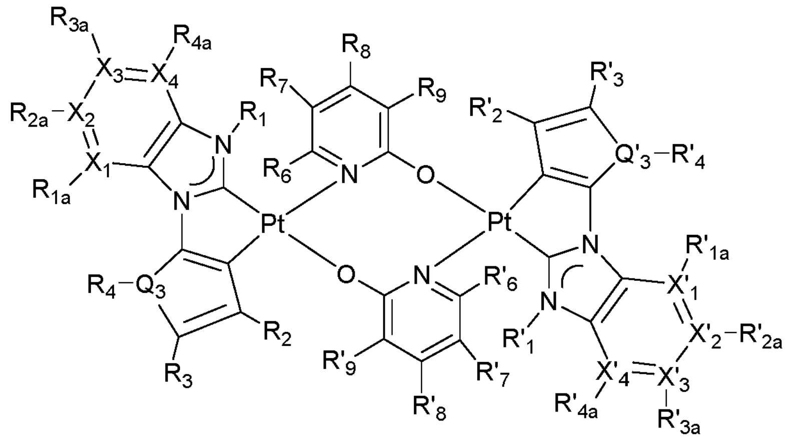

,

Formula IIa

or

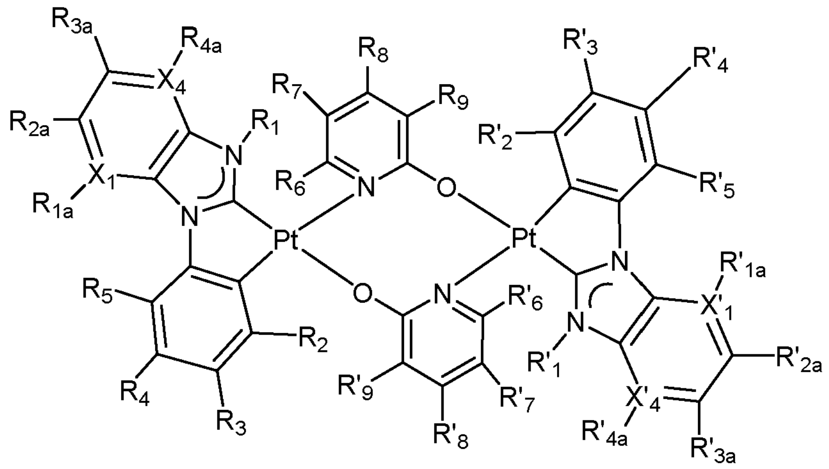

Formula III

or

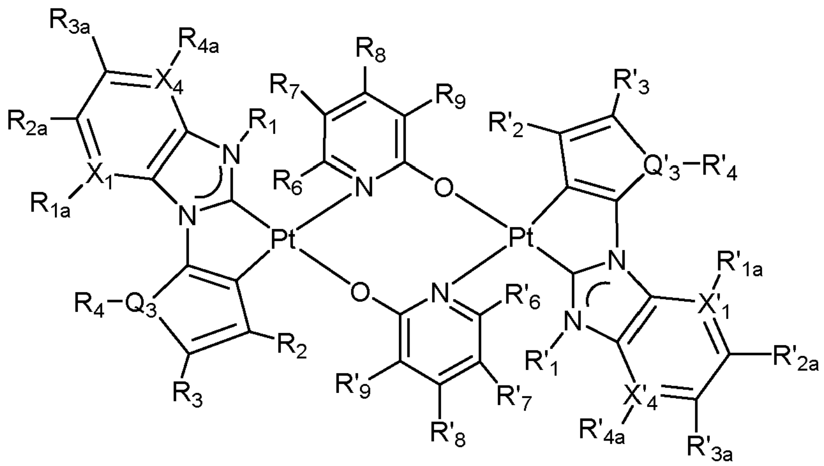

,

Formula IIIa

or

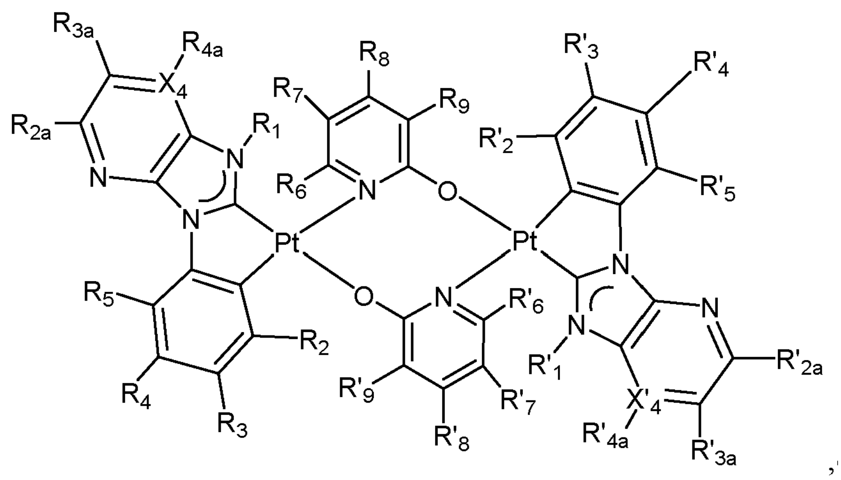

,'

Formula IV

or

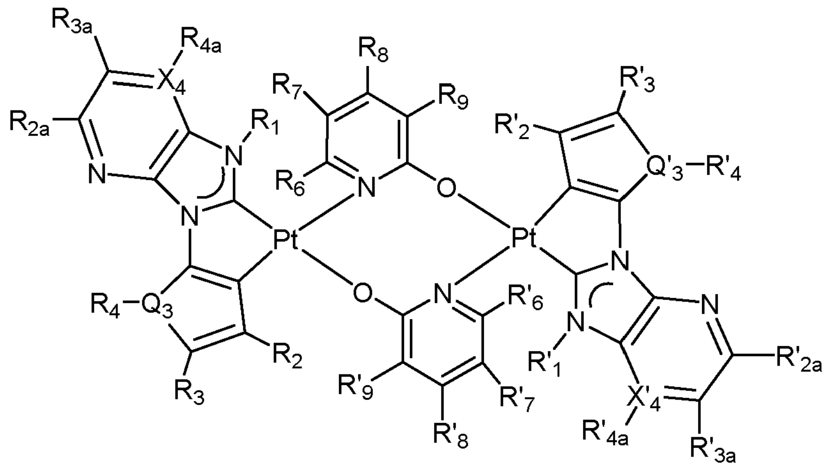

Formula IVa

4. The complex of claim 1, wherein:

(i) $X_4$ and $X'_4$ are carbon; and $R_{4a}$ and $R'_{4a}$ are independently hydrogen, substituted alkyl, unsubstituted alkyl, substituted aryl, unsubstituted aryl, hydroxyl, unsubstituted heteroaryl, substituted heteroaryl, unsubstituted polyaryl, substituted polyaryl, unsubstituted polyheteroaryl, substituted polyheteroaryl, substituted $C_2$-$C_{20}$ heterocyclyl, or unsubstituted $C_2$-$C_{20}$ heterocyclyl, optionally wherein $X_4$ and $X'_4$ are carbon and $R_{4a}$ and $R'_{4a}$ are independently hydrogen, unsubstituted alkyl, unsubstituted aryl, unsubstituted polyaryl, hydroxyl, unsubstituted heteroaryl, unsubstituted polyheteroaryl, unsubstituted $C_2$-$C_{20}$ heterocyclyl, or unsubstituted alkylaryl, such as hydrogen; or

(ii) $X_4$ and $X'_4$ are nitrogen; $R_{4a}$ and $R'_{4a}$ are absent, and optionally wherein $R_{2a}$, $R_{3a}$, $R'_{2a}$, and $R'_{3a}$ are independently hydrogen, unsubstituted alkyl (e.g., methyl, ethyl, n-propyl, isopropyl, n-butyl, sec-butyl, isobutyl, tert-butyl, etc.), substituted alkyl, unsubstituted aryl (e.g., unsubstituted phenyl), or alkoxy (e.g., -O-alkyl, -O-aryl, -O-polyaryl, etc.), or $R_{2a}$ and $R_{3a}$ together and/or $R'_{2a}$ and $R'_3$, together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl; or

(iii)$X_1$-$X_4$ and $X'_1$-$X'_4$ are carbon; and $R_{1a}$-$R_{4a}$ and $R'_{1a}$-$R'_{4a}$ are independently hydrogen, unsubstituted alkyl (e.g., methyl, ethyl, n-propyl, isopropyl, n-butyl, sec-butyl, isobutyl, tert-butyl, etc.), substituted alkyl, unsubstituted aryl (e.g., unsubstituted phenyl), or alkoxy (e.g., -O-alkyl, -O-aryl, -O-polyaryl, etc.), or $R_{1a}$ and $R_{2a}$ together, $R_{2a}$ and $R_{3a}$ together, $R_{3a}$ and $R_{4a}$ together, $R'_{1a}$ and $R'_{2a}$ together, $R'_{2a}$ and $R'_{3a}$ together, and/or $R'_{3a}$ and $R'_{4a}$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof, such as a substituted aryl or unsubstituted aryl, for example, $R_{1a}$ and $R_{2a}$ together, $R_{3a}$ and $R_{4a}$ together, $R'_{1a}$ and $R'_{2a}$ together, and $R'_{3a}$ and $R'_{4a}$ together, with the atom to which they are attached, form a substituted aryl or unsubstituted aryl, or $R_{2a}$ and $R_{3a}$ together and $R'_{2a}$ and $R'_{3a}$ together, with the atom to which they are attached, form a substituted aryl or unsubstituted aryl.

5. The complex of claim 2, wherein $R_1$-$R_9$ and $R'_1$-$R'_9$ are independently hydrogen, halogen, unsubstituted alkyl (e.g., methyl, ethyl, n-propyl, isopropyl, n-butyl, sec-butyl, isobutyl, tert-butyl, etc.), substituted alkyl, unsubstituted aryl, substituted aryl (e.g., mesitylene or other aryl substituted with one or more alkyls, such as methyl, ethyl, n-propyl, isopropyl, n-butyl, sec-butyl, isobutyl, tert-butyl, etc.), unsubstituted polyaryl, substituted polyaryl, hydroxyl, unsubstituted heteroaryl, substituted heteroaryl, unsubstituted polyheteroaryl, substituted polyheteroaryl, unsubstituted $C_2$-$C_{20}$ heterocyclyl, substituted $C_2$-$C_{20}$ heterocyclyl, unsubstituted alkylaryl, substituted alkylaryl, alkoxy (e.g., -O-alkyl, - O-aryl, -O-polyaryl, etc.), borenium cation (e.g., $-B(Mes)_2$), phosphonyl (e.g., $-P(=O)(Ph)_2$, $-P(=O)(alkyl)_2$, etc.), or sulfinyl (e.g., $-S(=O)(Ph)_2$, $-S(=O)(alkyl)_2$, etc.), or sulfonyl - $S(=O)_2(Ph)_2$, $-S(=O)_2(alkyl)_2$, etc.), or $R_2$ and $R_3$ together, $R'_2$ and $R'_3$ together, $R_3$ and $R_4$ together, $R'_3$ and $R'_4$ together, $R_4$ and $R_8$ together, $R'_4$ and $R'_5$ together, $R_6$

and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl, an unsubstituted aryl, a substituted heteroaryl, an unsubstituted heteroaryl, a substituted polyaryl, an unsubstituted polyaryl, a substituted polyheteroaryl, an unsubstituted polyheteroaryl, a substituted heterocyclyl, an unsubstituted heterocyclyl, or fused combinations thereof.

**6.** The complex of claim 5, wherein one or more of $R_1$-$R_9$ and $R'_1$-$R'_9$ is(are)

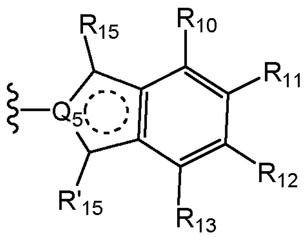

or

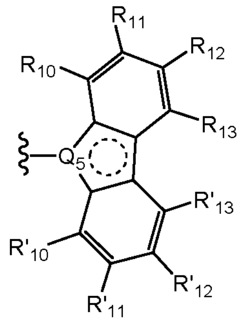

,

wherein $Q_5$ is nitrogen or carbon; and $R_{10}$-$R_{13}$, $R_{15}$, $R'_{15}$, and $R'_{10}$-$R'_{13}$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl, optionally
wherein $Q_5$ is nitrogen; and $R_{10}$-$R_{13}$, $R_{15}$, $R'_{15}$, and $R'_{10}$-$R'_{13}$ are independently absent, hydrogen, substituted alkyl, unsubstituted alkyl, substituted phenyl group, unsubstituted phenyl, alkoxy, halogen, borenium cation (e.g., $-B(Mes)_2$), phosphonyl, or sulfinyl, such as hydrogen.

**7.** The complex of claim 2, wherein: (i) $R_2$ and $R_3$ together and/or $R'_2$ and $R'_3$ together, or (ii) $R_3$ and $R_4$ together and/or $R'_3$ and $R'_4$ together, or (iii) $R_4$ and $R_8$ together and/or $R'_4$ and $R'_5$ together, with the atom to which they are attached, form a substituted cycloalkyl, an unsubstituted cycloalkyl, a substituted cycloalkenyl, an unsubstituted cycloalkenyl, a substituted cycloalkynyl, an unsubstituted cycloalkynyl, a substituted aryl, an unsubstituted aryl, a substituted heteroaryl, an unsubstituted heteroaryl, optionally wherein: (a) $R_2$ and $R_3$ together and/or $R'_2$ and $R'_3$ together, or

(b) $R_3$ and $R_4$ together and/or $R'_3$ and $R'_4$ together, or
(c) $R_4$ and $R_5$ together and/or $R'_4$ and $R'_5$ together, form

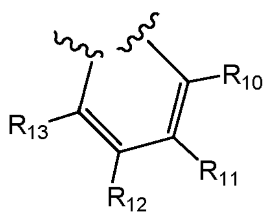

or

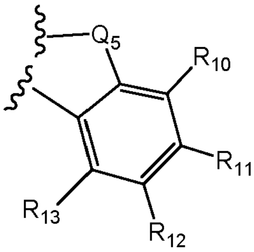

,

wherein $Q_5$ is $NR_{14}$, $CR_{16}R_{17}$, or sulfur, or oxygen; and $R_{10}$-$R_{14}$, $R_{16}$, and $R_{17}$ are independently absent, hydrogen, substituted alkyl, unsubstituted alkyl, substituted alkenyl, unsubstituted alkenyl, substituted alkynyl, unsubstituted alkynyl, substituted aryl, unsubstituted aryl, halogen, hydroxyl, amino, amido, ether, thiol, cyano, nitro, unsubstituted alkoxy, substituted alkoxy, unsubstituted aroxy, substituted aroxy, unsubstituted heteroaryl, substituted heteroaryl, unsubstituted polyheteroaryl, substituted polyheteroaryl, unsubstituted carbonyl, substituted carbonyl, unsubstituted ester, substituted ester, substituted $C_2$-$C_{20}$ heterocyclyl, or unsubstituted $C_2$-$C_{20}$ heterocyclyl, optionally wherein $Q_5$ is $NR_{14}$, $CR_{16}R_{17}$, sulfur, or oxygen, such as oxygen; and $R_{10}$-$R_{14}$, $R_{16}$, and $R_{17}$ are independently absent, hydrogen, substituted alkyl, unsubstituted alkyl, substituted phenyl group, unsubstituted phenyl, alkoxy, halogen, borenium cation (e.g., -$B(Mes)_2$), phosphonyl, or sulfinyl, such as hydrogen or unsubstituted alkyl.

**8.** The complex of claim 2, wherein $R_6$-$R_9$ and $R'_6$-$R'_9$, are independently hydrogen, halogen, unsubstituted alkyl (e.g., methyl, ethyl, n-propyl, isopropyl, n-butyl, sec-butyl, isobutyl, tert-butyl, etc.), substituted alkyl, unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., -B(Mes)2), phosphonyl (e.g., -P(=O)(Ph)2, -P(=O)(alkyl)2, etc.), substituted heteroaryl, or unsubstituted heteroaryl, or $R_6$ and $R_7$ together, $R_7$ and $R_8$ together, $R_8$ and $R_9$ together, $R'_6$ and $R'_7$ together, $R'_7$ and $R'_8$ together, and/or $R'_8$ and $R'_9$ together, with the atom to which they are attached, form a substituted aryl or an unsubstituted aryl, such as a substituted phenyl or unsubstituted phenyl, optionally wherein at least one of $R_6$-$R_9$ and at least one of $R'_6$-$R'_9$ are not hydrogen, and/or wherein $Q_3$ and $Q'_3$ of Formulae Ia-IVa are independently sulfur or oxygen.

**9.** The complex of claim 2, wherein $R_2$, $R_4$, $R_5$, $R'_{2a}$ $R'_4$, $R'_5$, $R_7$, $R_8$, $R'_7$, and $R'_8$ are hydrogen; and $R_1$, $R_3$, $R_6$, $R_9$, $R'_1$, $R'_3$, $R'_6$, and $R'_9$ are independently hydrogen, halogen, unsubstituted alkyl, substituted alkyl, unsubstituted aryl, substituted aryl (e.g., aryl substituted with one or more alkyls, such as methyl, ethyl, n-propyl, isopropyl, n-butyl, sec-butyl, isobutyl, tert-butyl, etc.), hydroxyl, unsubstituted heteroaryl (e.g., carbazolyl, fluorenyl, indenyl, indolyl, etc.), unsubstituted polyheteroaryl, unsubstituted $C_2$-$C_{20}$ heterocyclyl, unsubstituted alkylaryl, alkoxy (e.g., -O-alkyl such as methoxy, ethoxy, and phenoxy, -O-aryl, -O-polyaryl, etc.), borenium cation (e.g., -$B(Mes)_2$), phosphonyl (e.g. -$P(=O)(Ph)_2$), sulfinyl (e.g., -$S(=O)(Ph)_2$, -$S(=O)(alkyl)_2$, etc.), or sulfonyl -$S(=O)_2(Ph)_2$, - $S(=O)_2(alkyl)_2$, etc.), such as halogen, unsubstituted alkyl (e.g., methyl, ethyl, n-propyl, isopropyl, n-butyl, sec-butyl, isobutyl, tert-butyl, etc.), unsubstituted aryl (e.g., unsubstituted phenyl), substituted aryl (e.g., mesitylene or other aryl substituted with one or more alkyls, such as methyl, ethyl, n-propyl, isopropyl, n-butyl, sec-butyl, isobutyl, tert-butyl, etc.), borenium cation (e.g., -$B(Mes)_2$), or phosphonyl (e.g., -$P(=O)(Ph)_2$, - $P(=O)(alkyl)_2$, etc.), optionally wherein $R_1$, $R_6$, $R_9$, $R'_1$, $R'_6$, and $R'_9$ are independently unsubstituted alkyl, unsubstituted aryl, or substituted aryl (e.g., phenyl substituted with one or more $C_1$-$C_6$ alkyls).

**10.** The complex of claim 1, wherein the complex has any one of the structures:

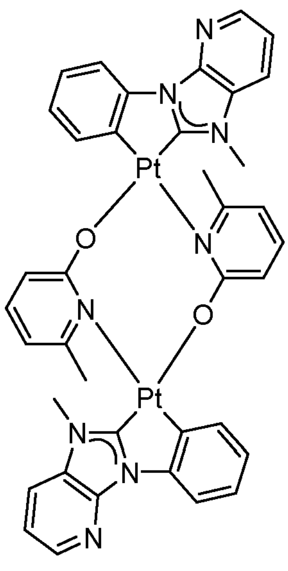

**Pt-R1** ,

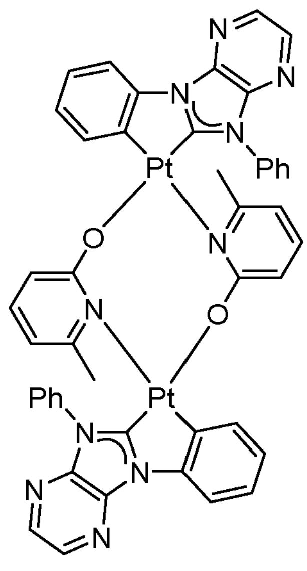

**Pt-R2** ,

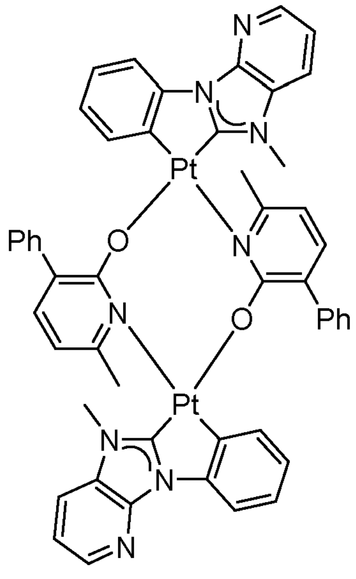

Pt-R3 ,

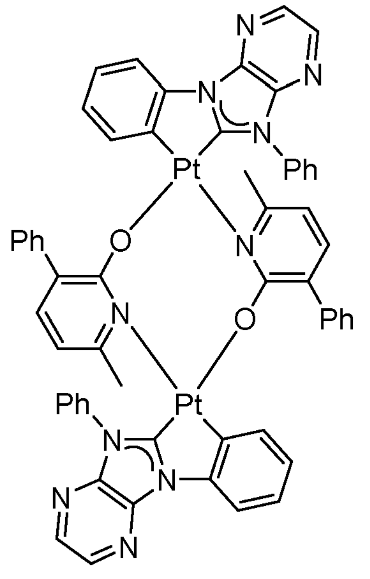

Pt-R4 ,

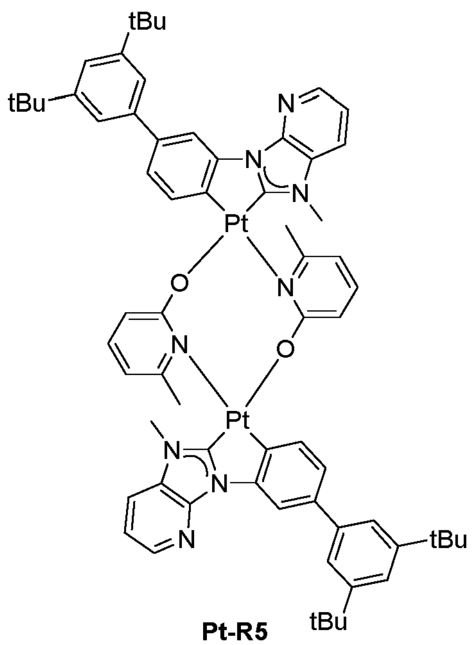

Pt-R5 ,

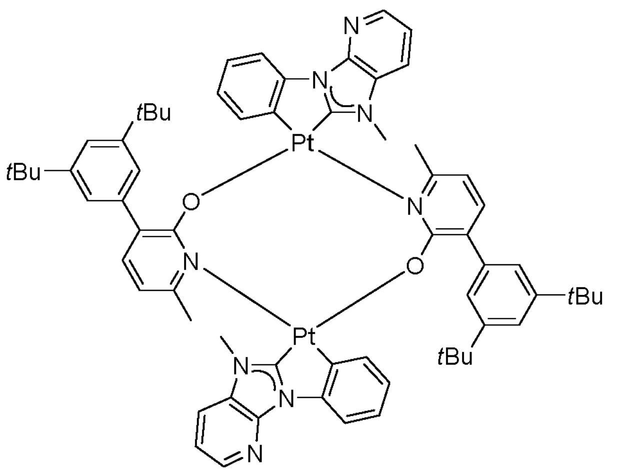

Pt-R6 ,

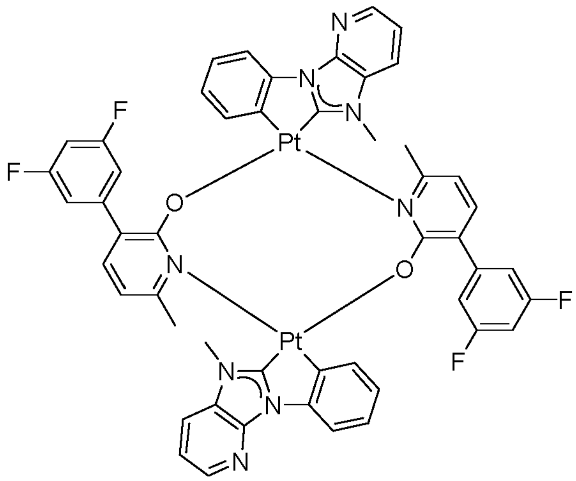

Pt-R7

,

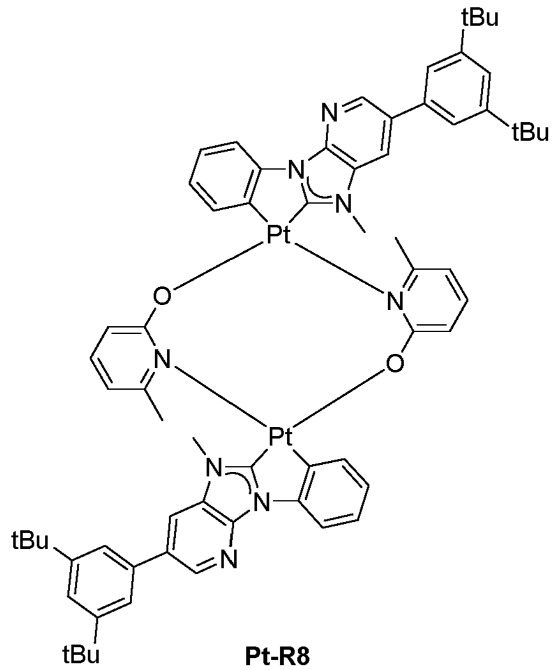

Pt-R8

,

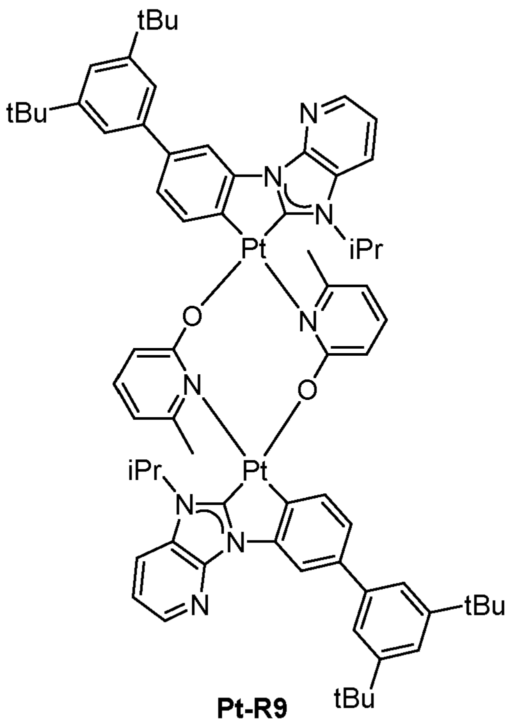

Pt-R9

,

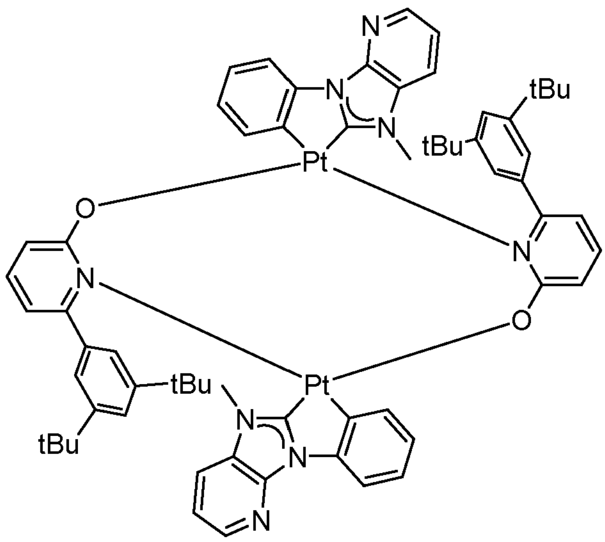

Pt-R10

,

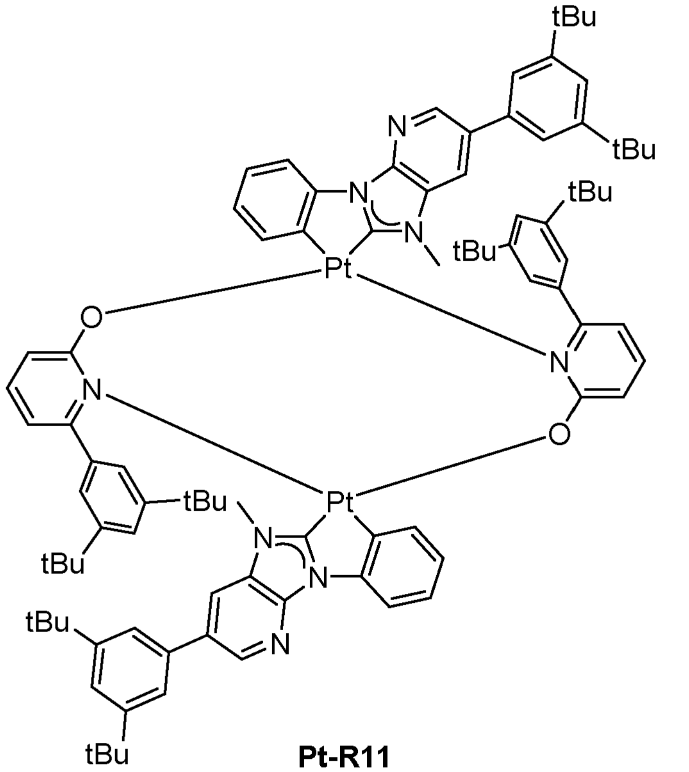

**Pt-R11**

,

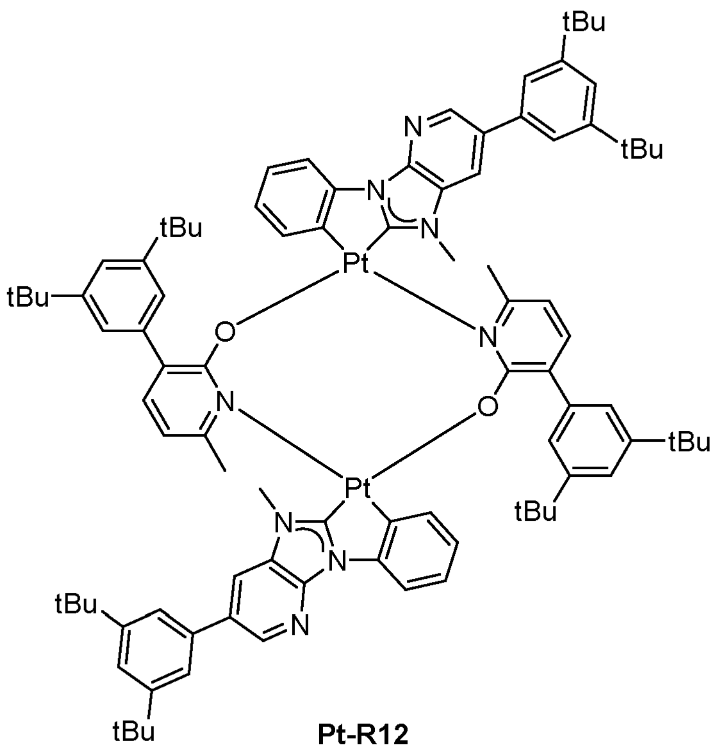

**Pt-R12**

,

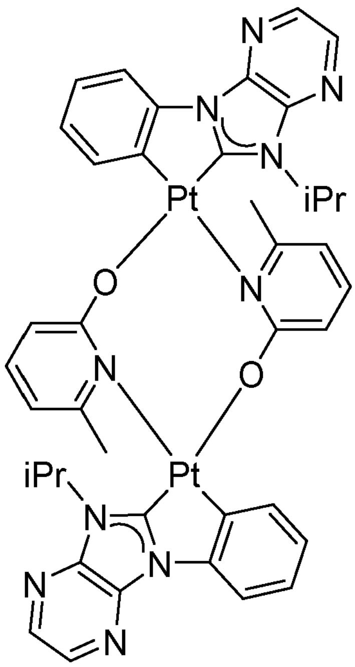

**Pt-R13** ,

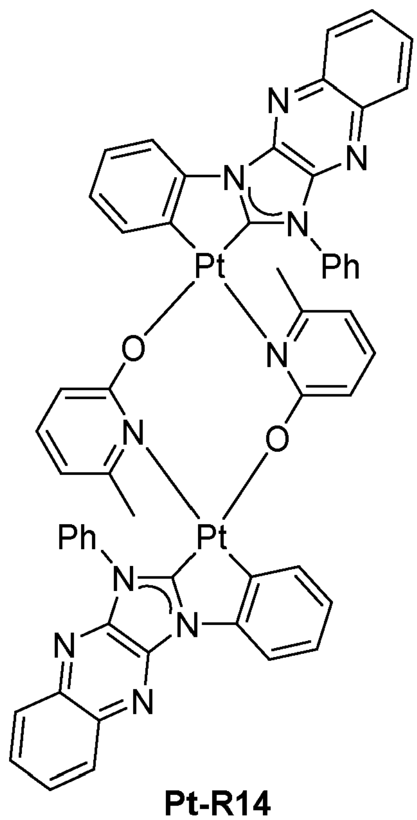

**Pt-R14** ,

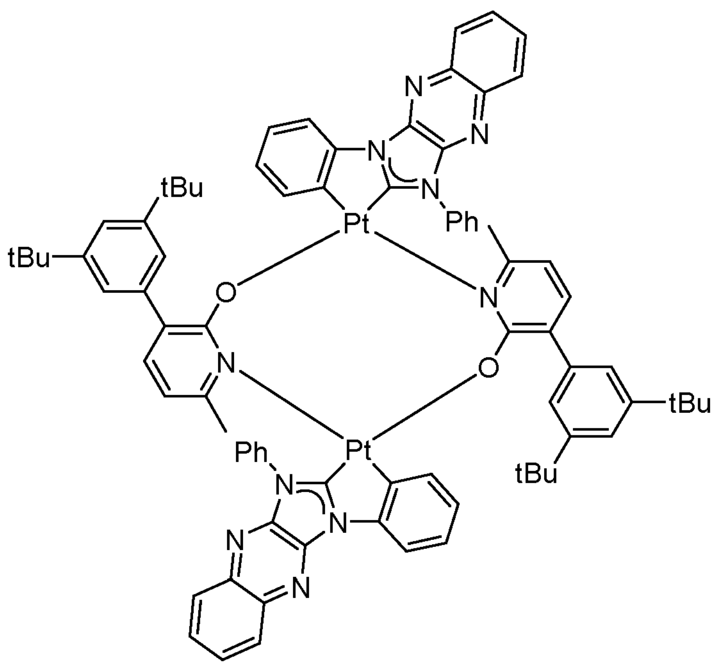

**Pt-R15** ,

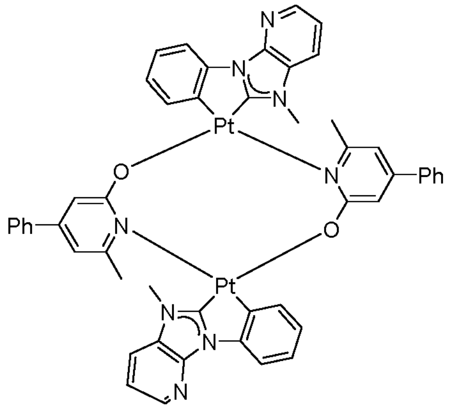

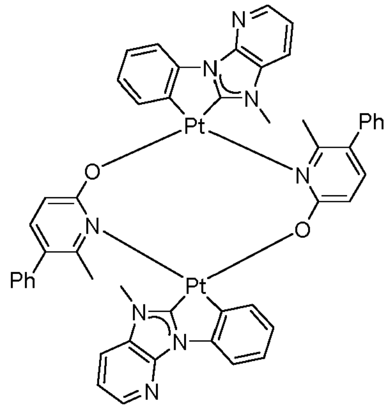

,

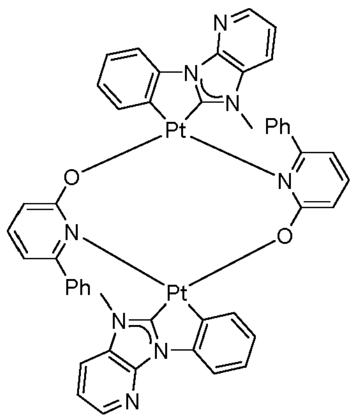

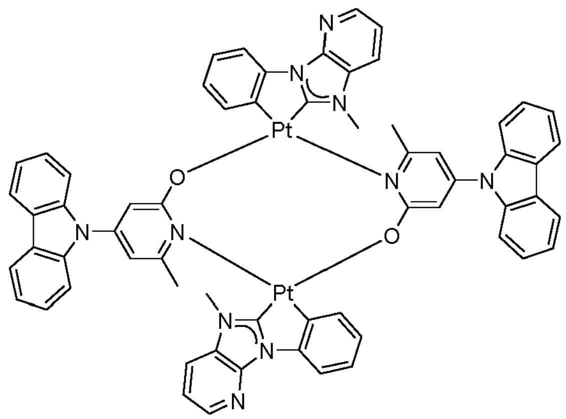

,

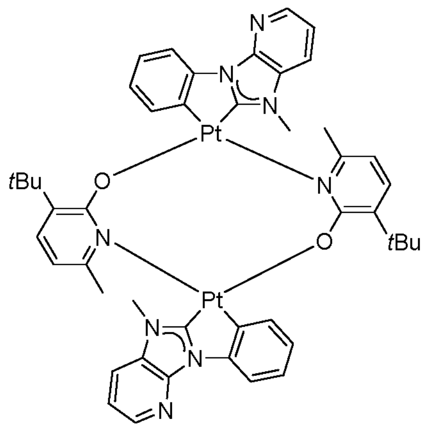

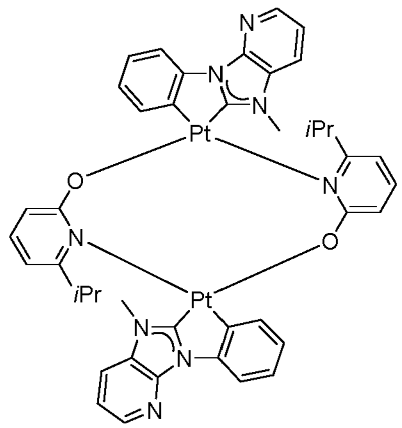

,

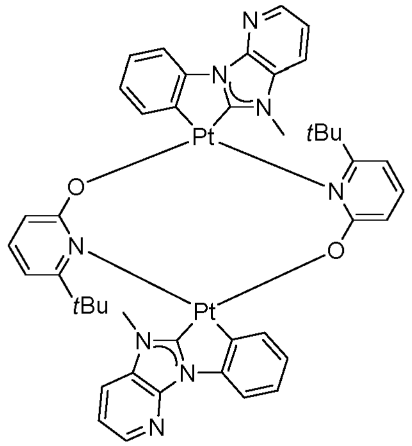

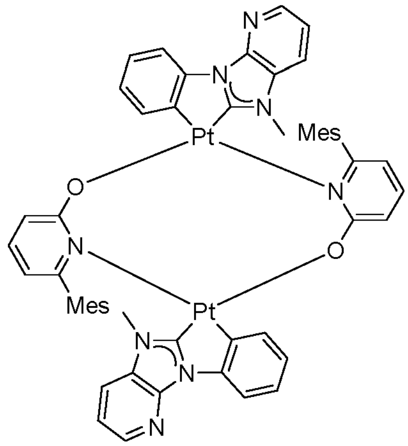

,

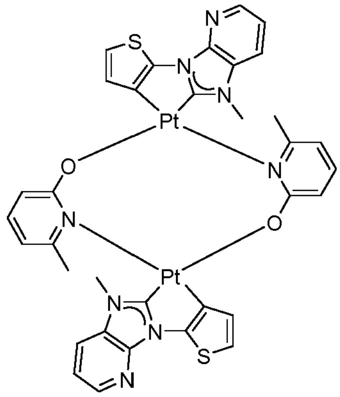

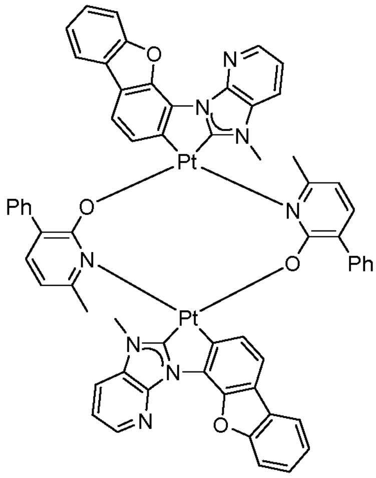

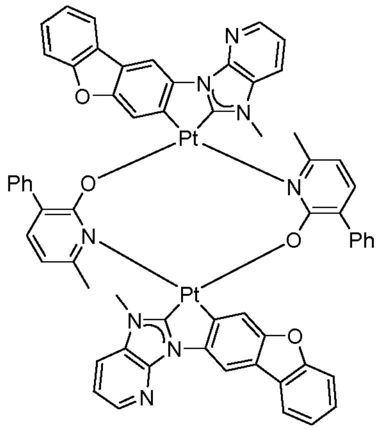

,

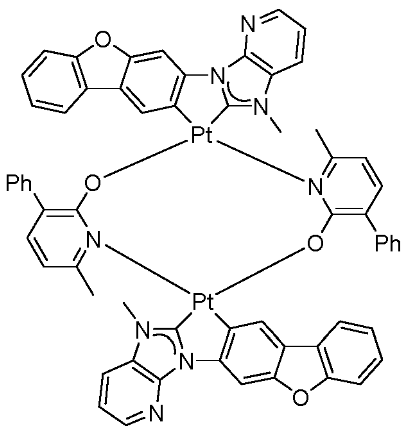

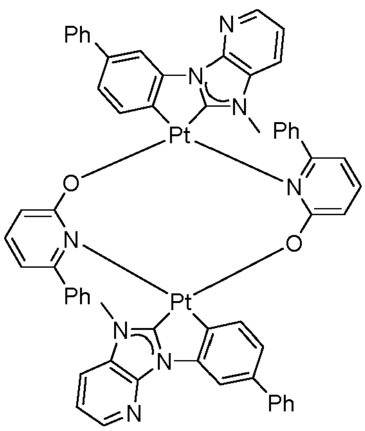

,

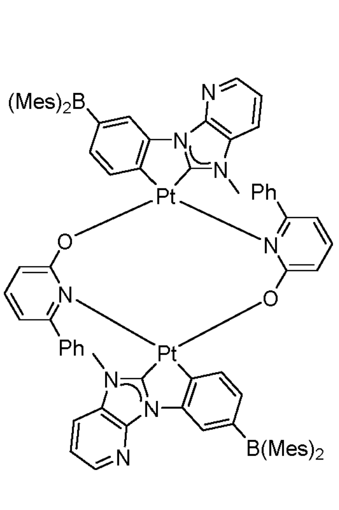
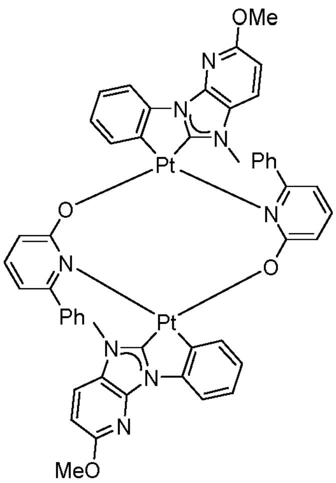
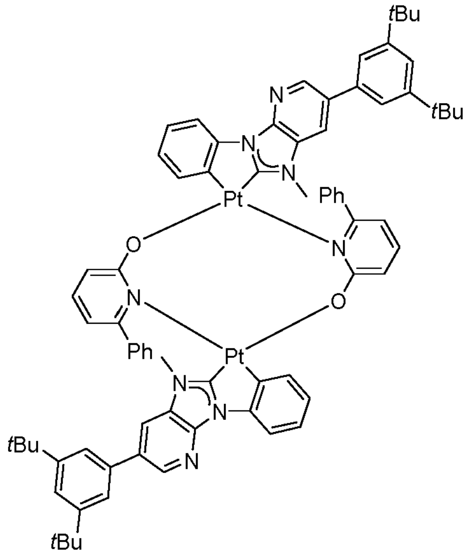

,

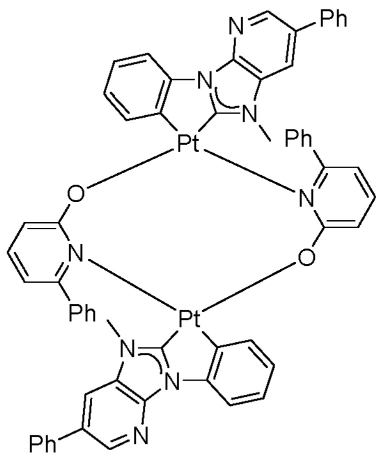
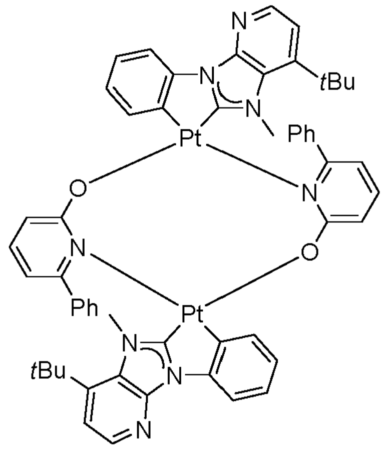

,

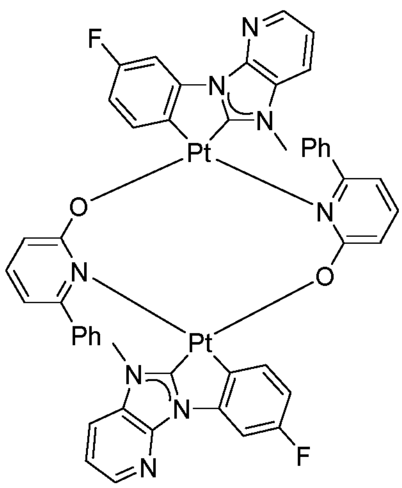
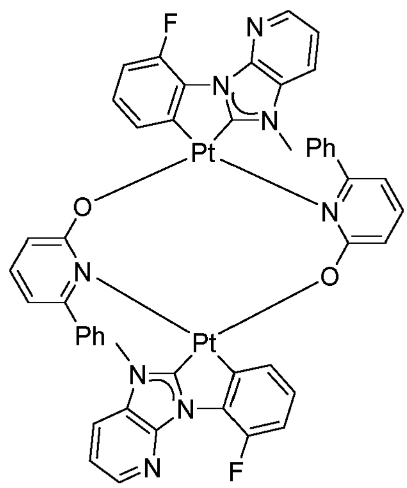

,

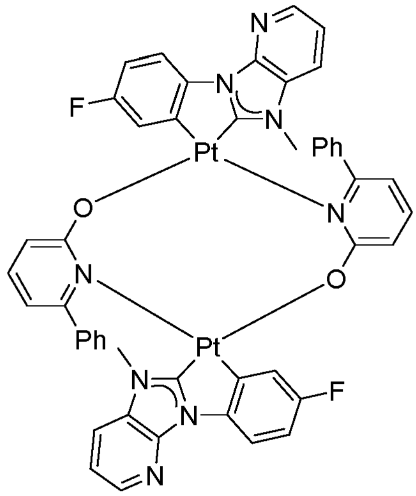
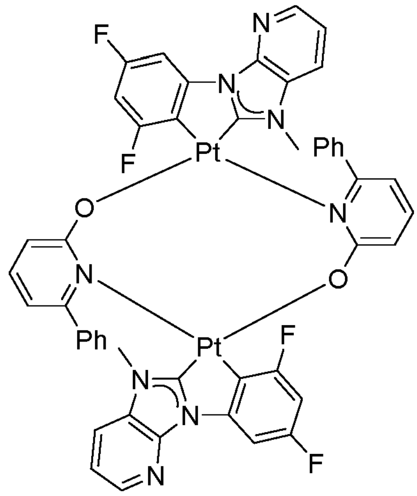

,

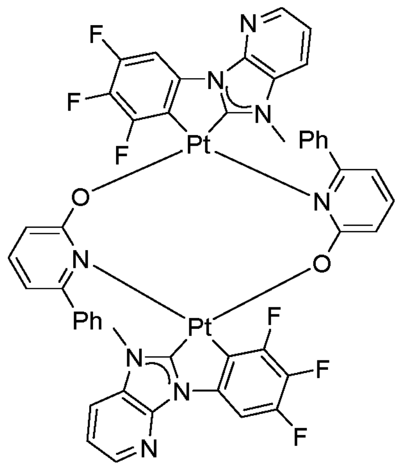
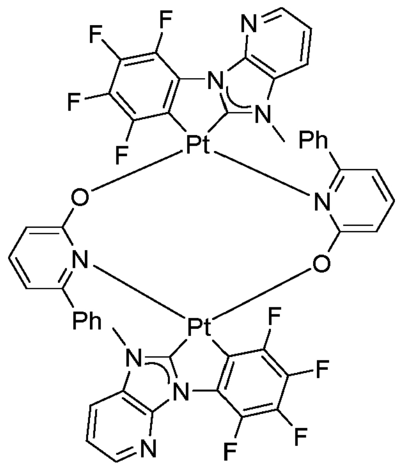

,

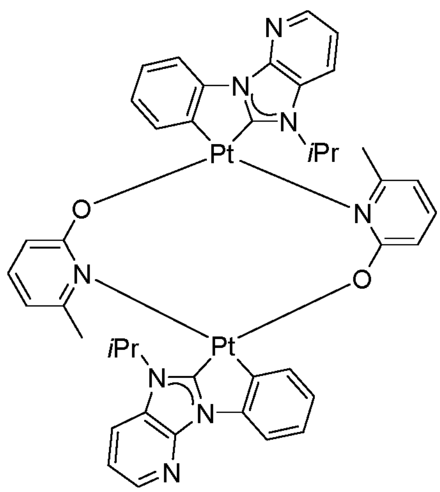
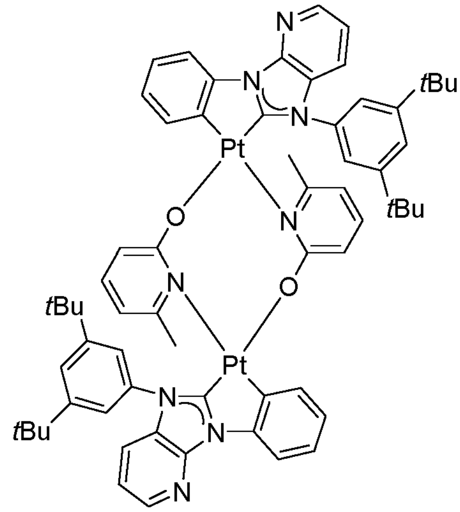

,

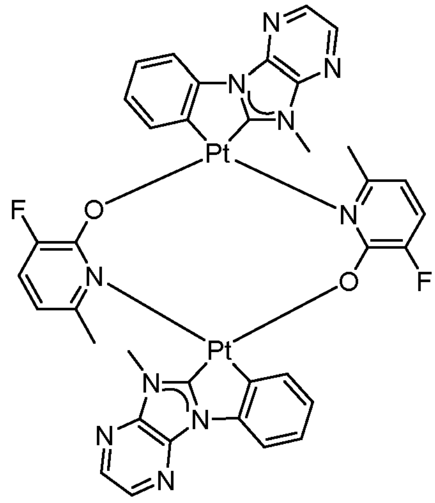

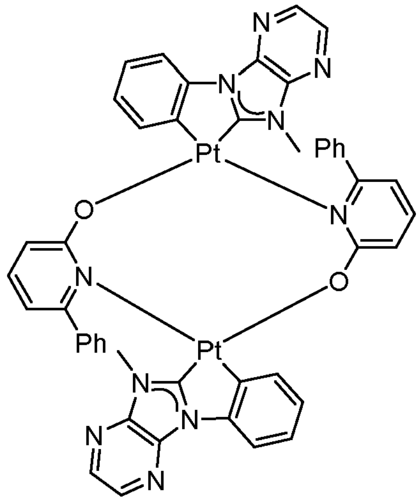

,

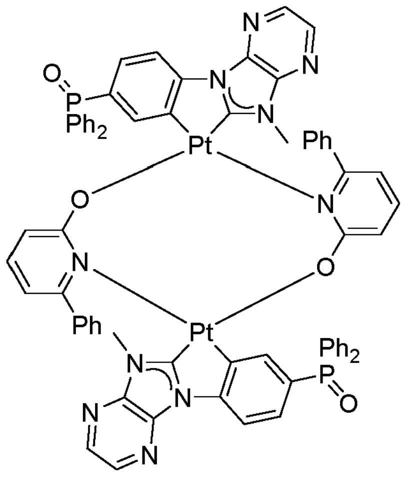

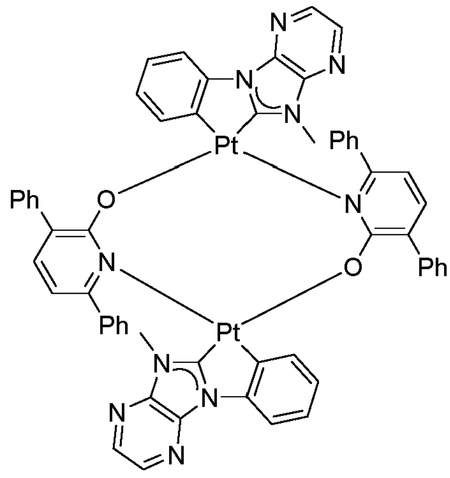

,

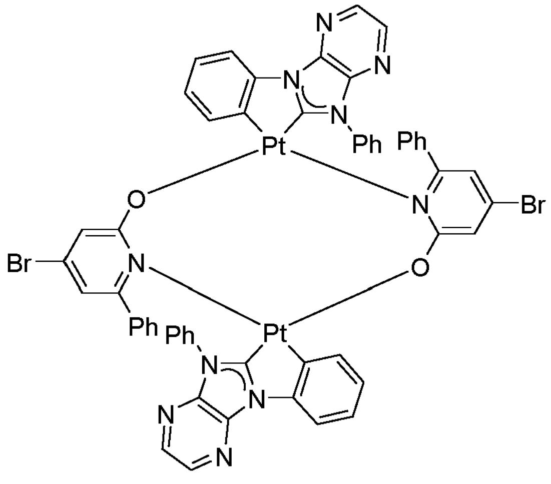

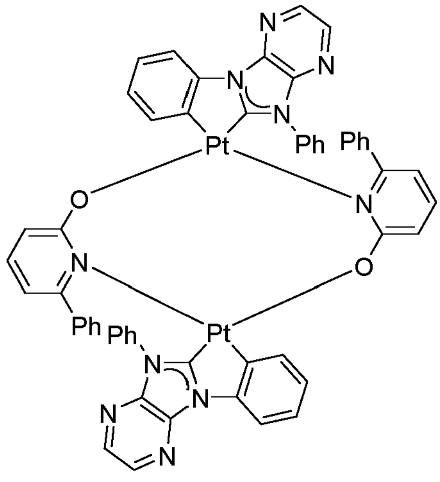

,

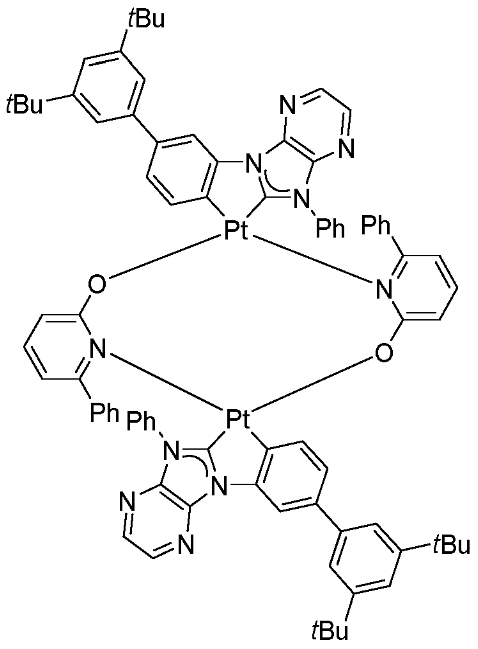

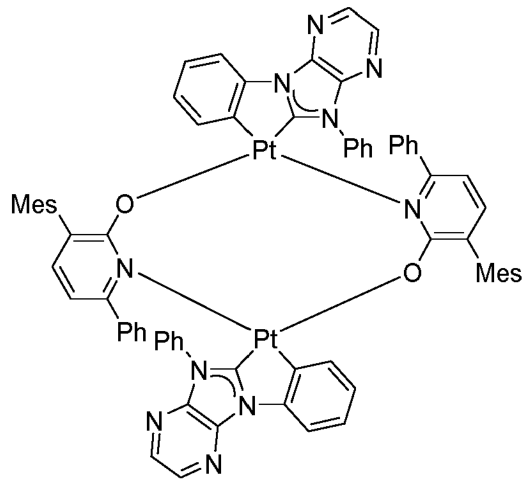

,

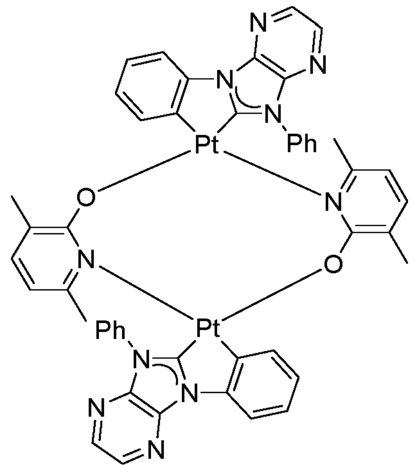

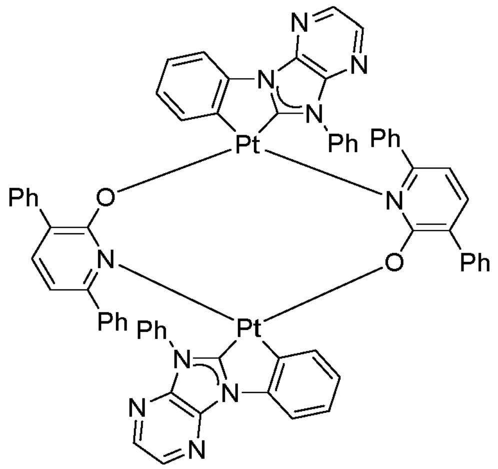

,

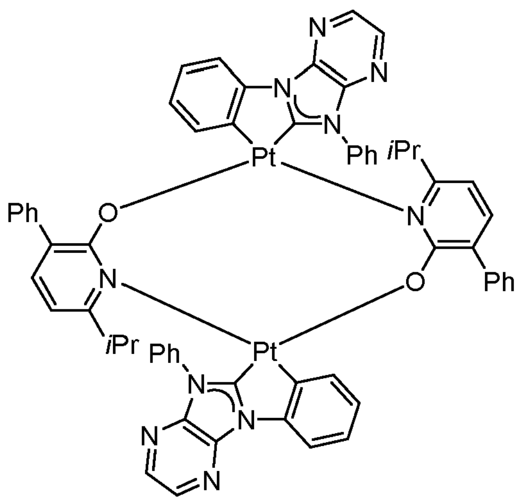

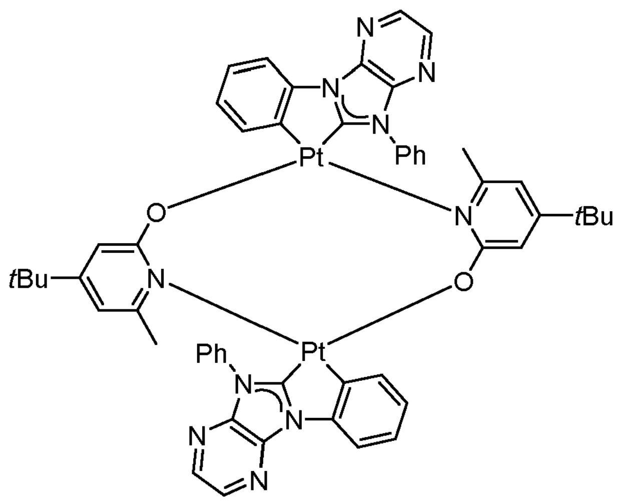

,

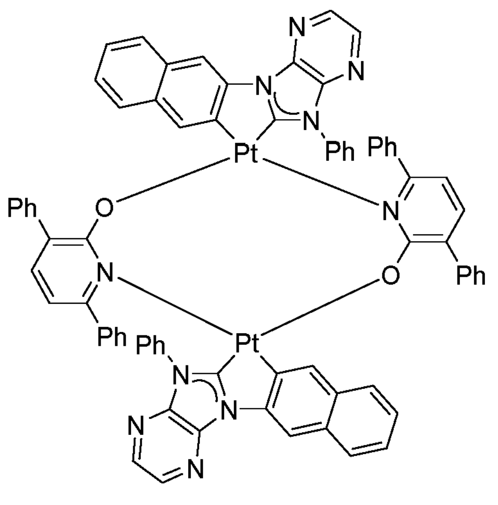

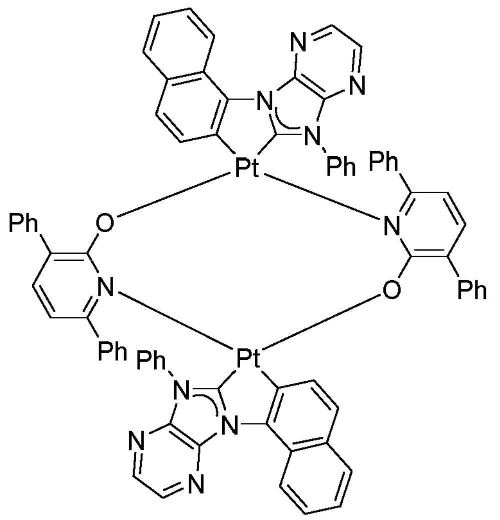

,

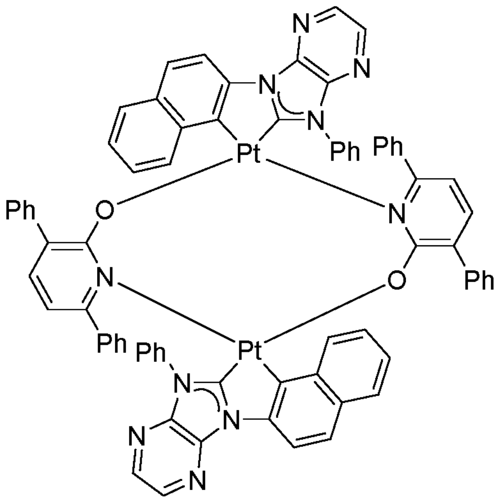

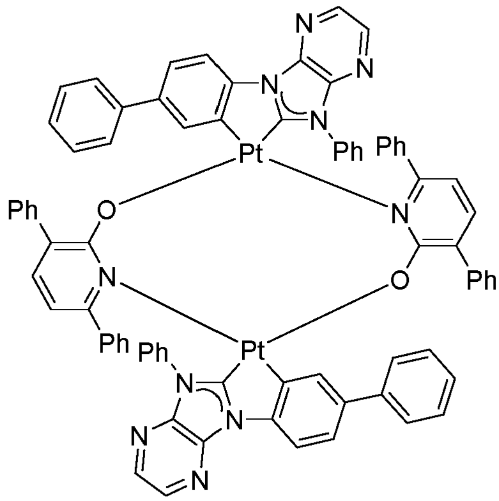

,

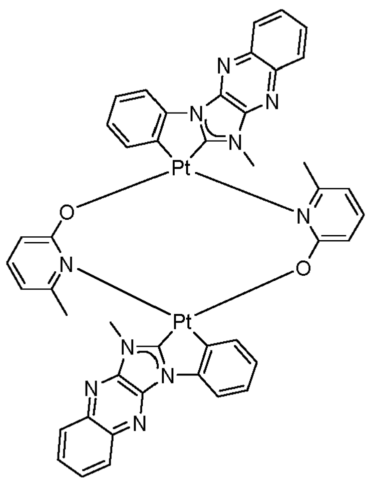

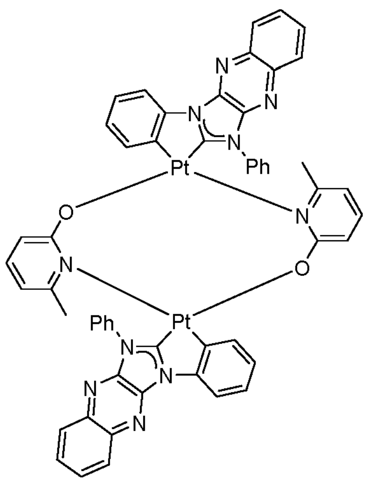

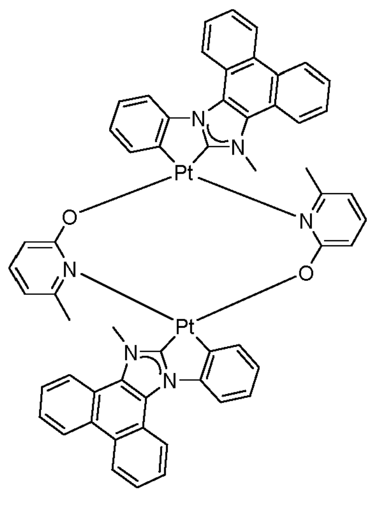

,

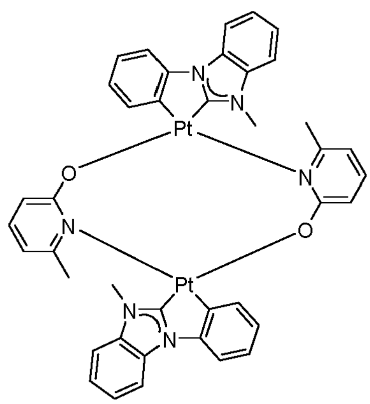
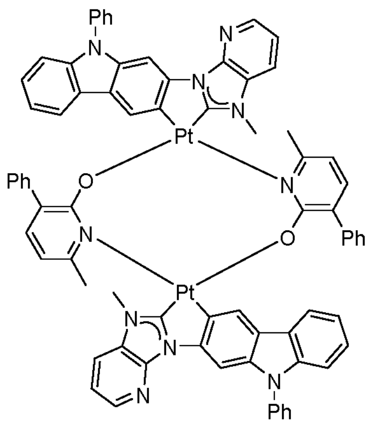
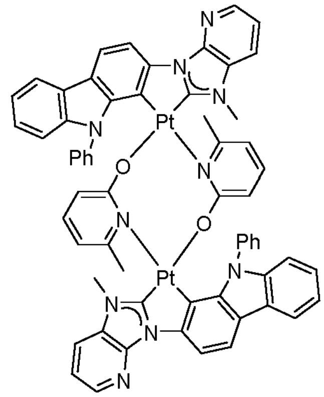

,

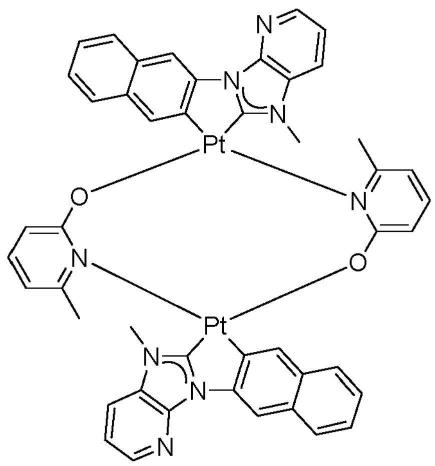
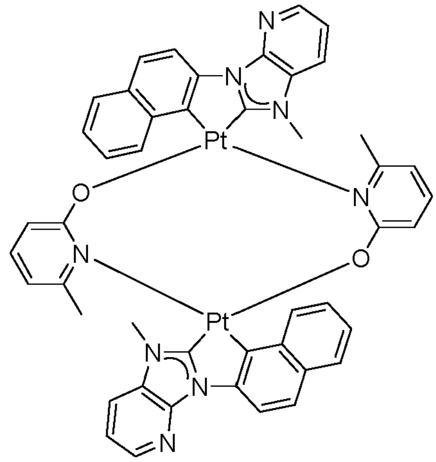

,

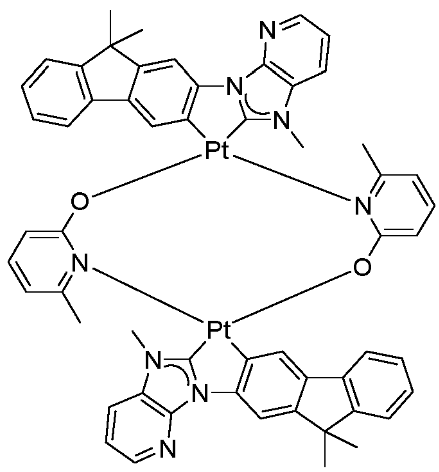
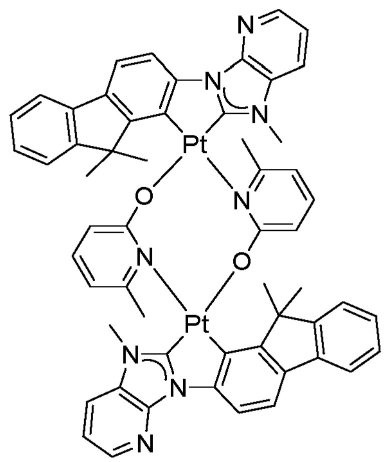

,

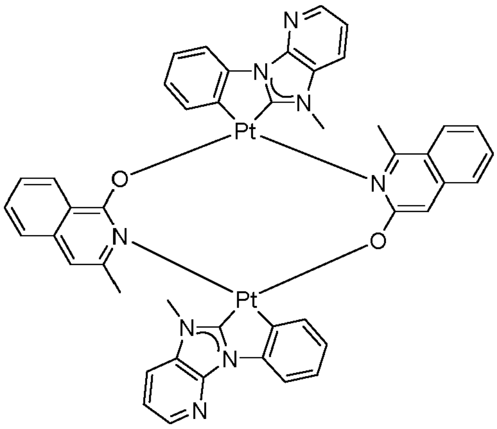 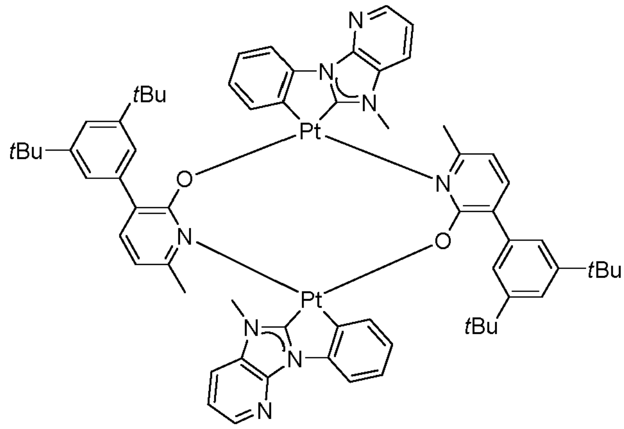

,

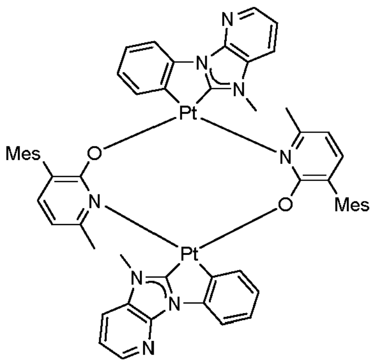 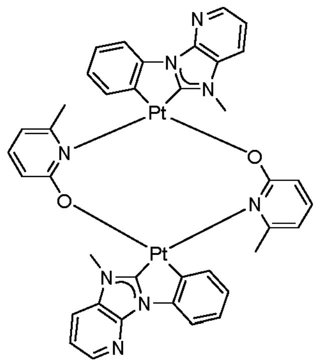 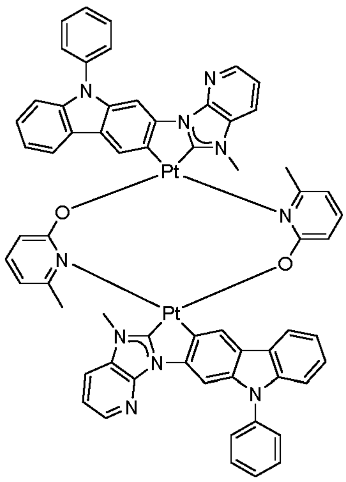

,

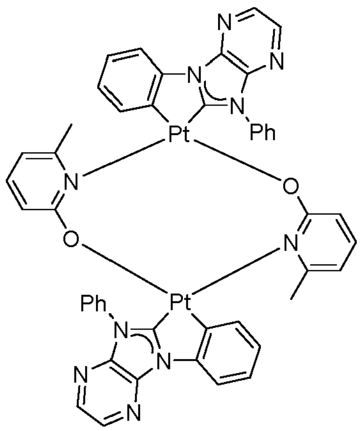 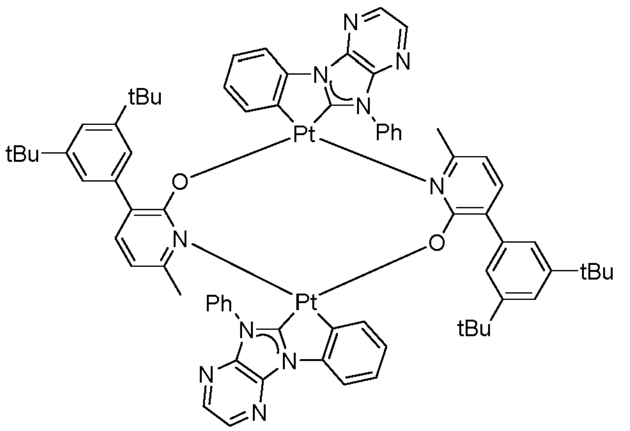

,

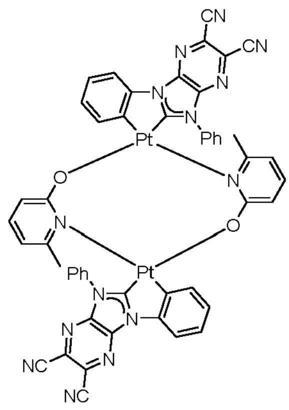
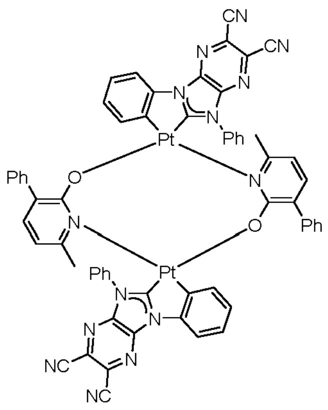
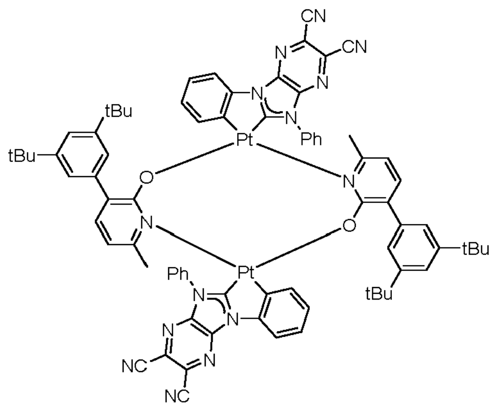

,

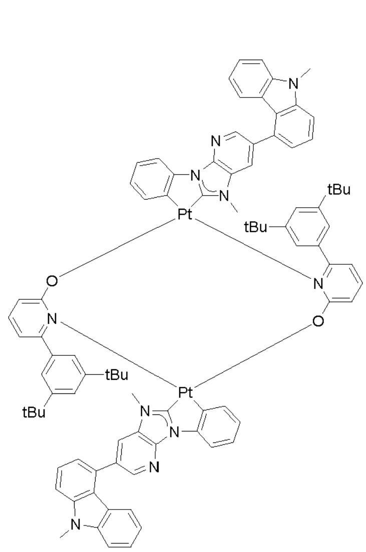
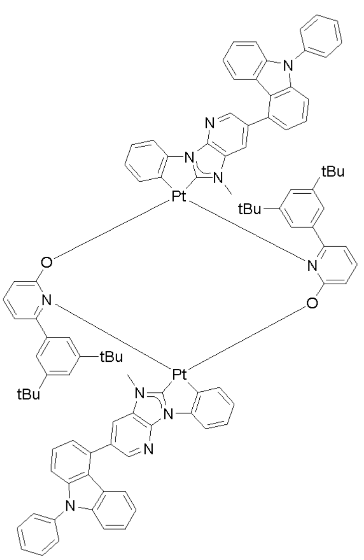
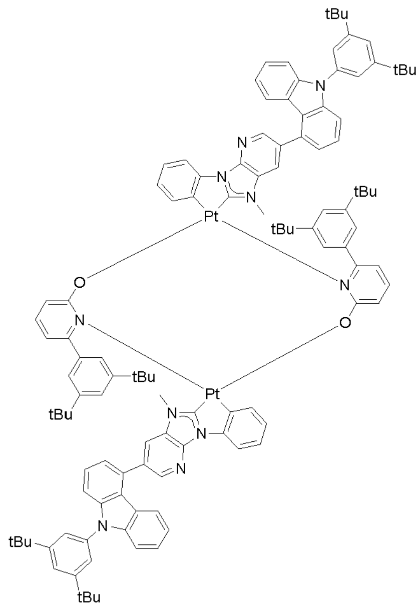

,

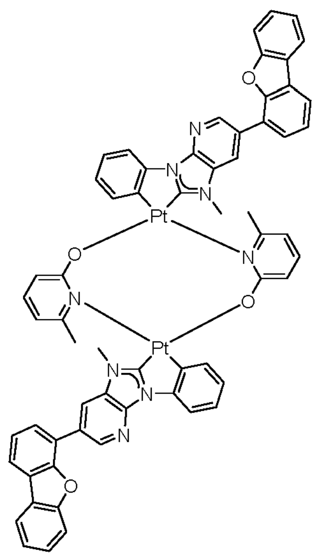
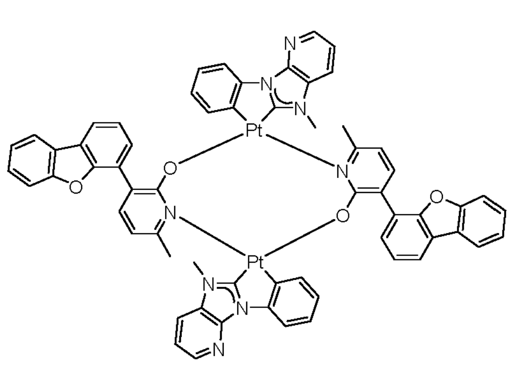
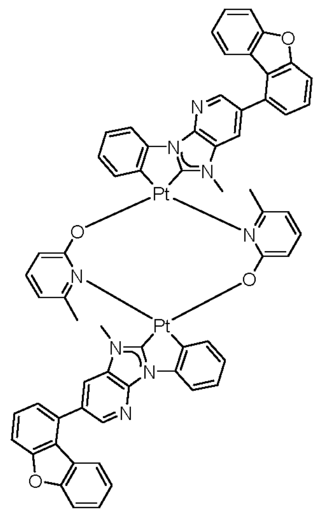

,

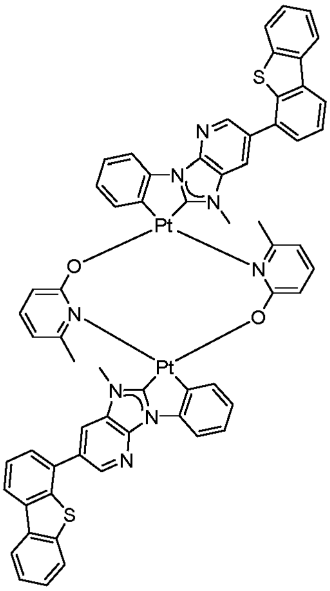
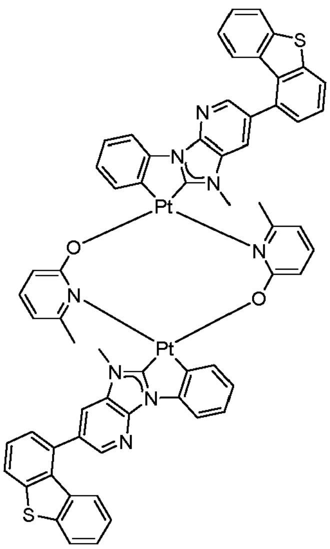

,

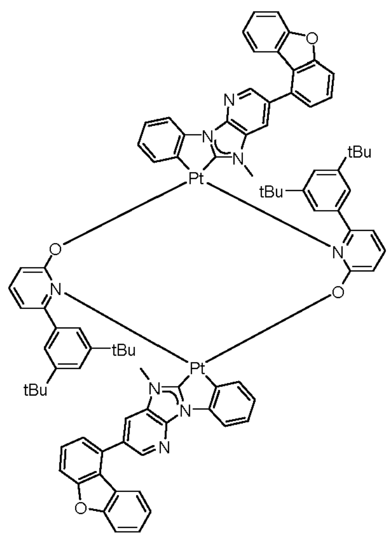
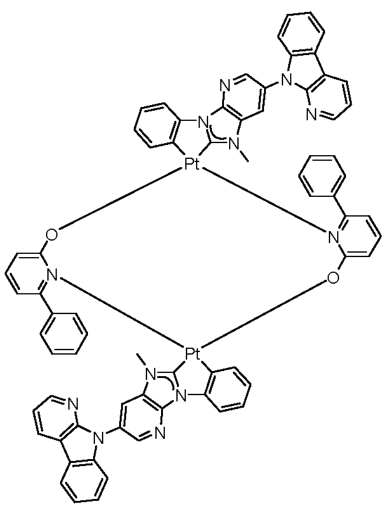
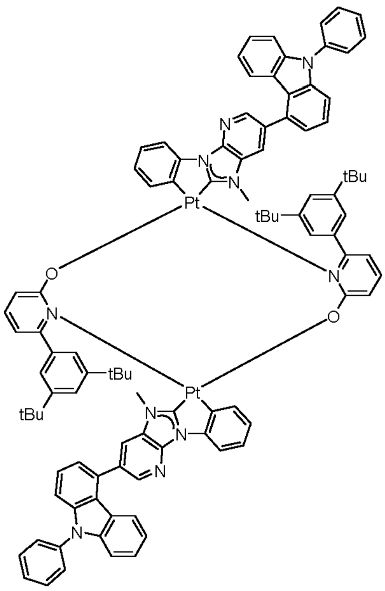

,

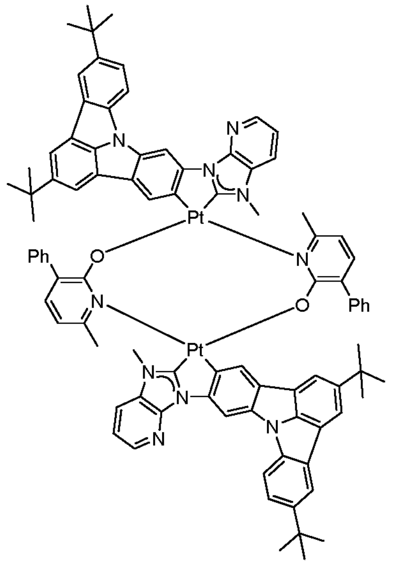

,

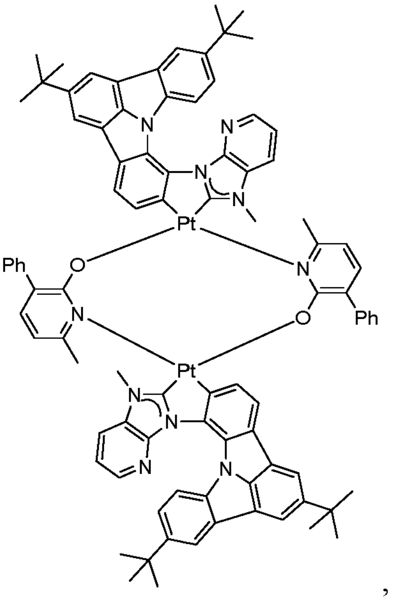

,

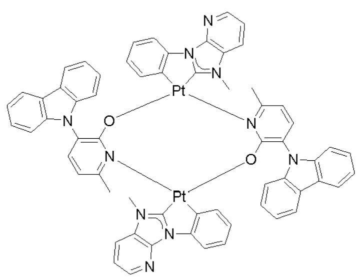

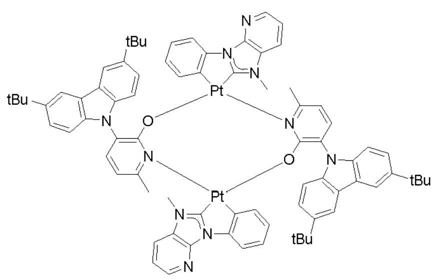

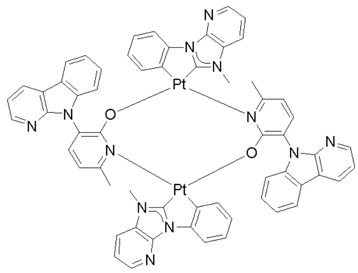

,

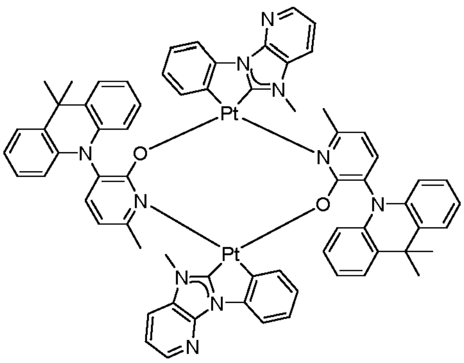

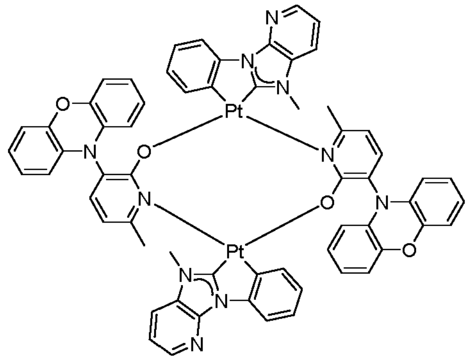

,

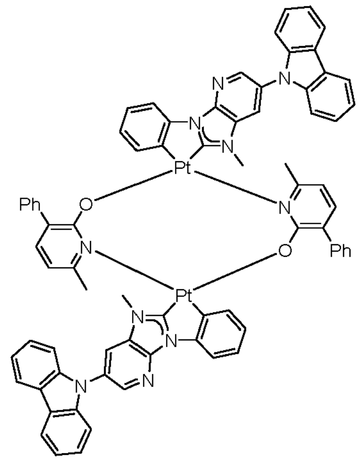 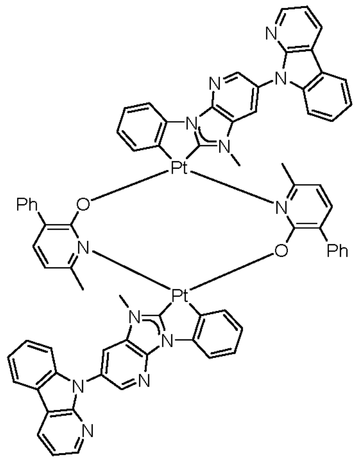 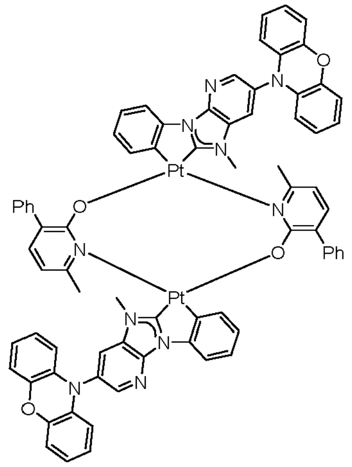

,

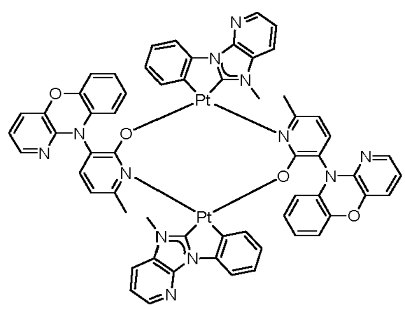 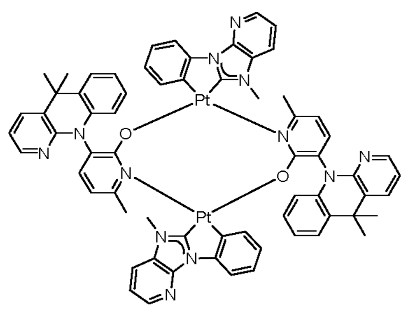 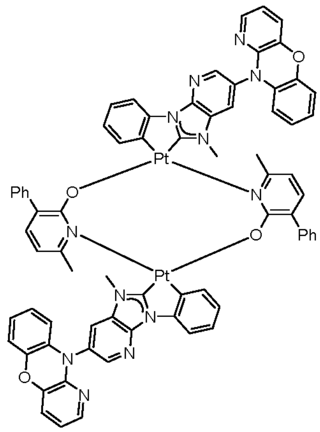

,

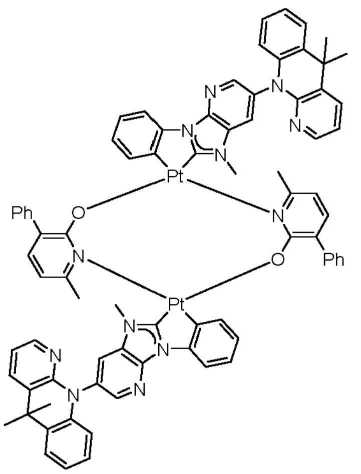 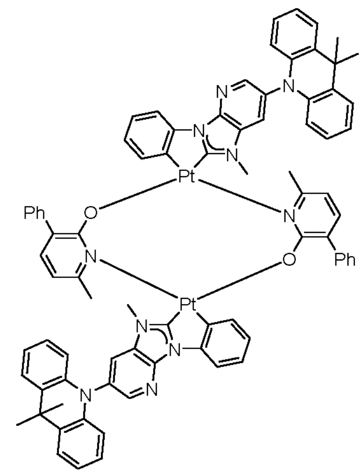 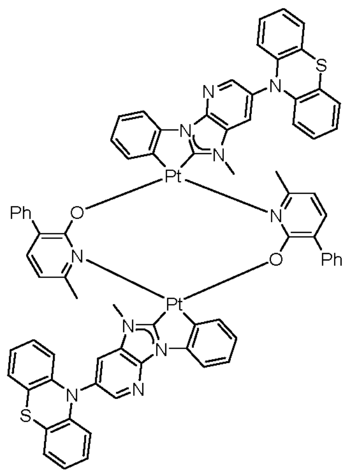

,

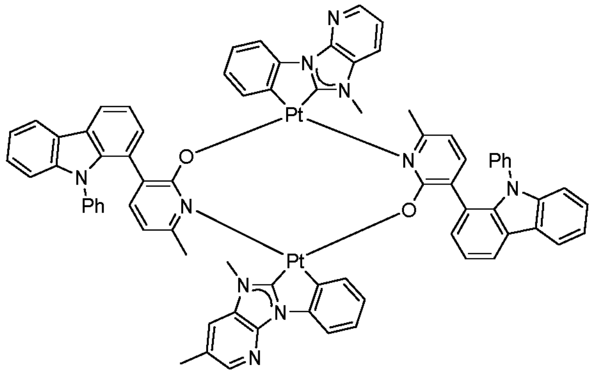

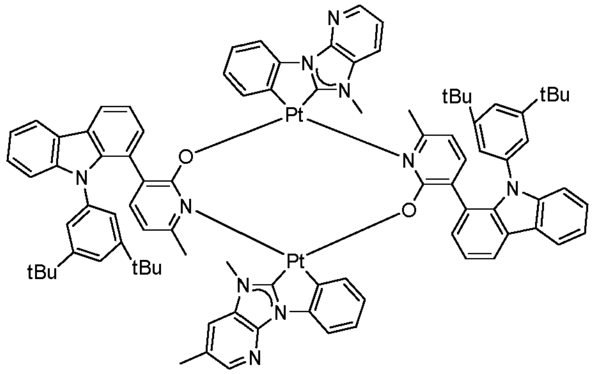

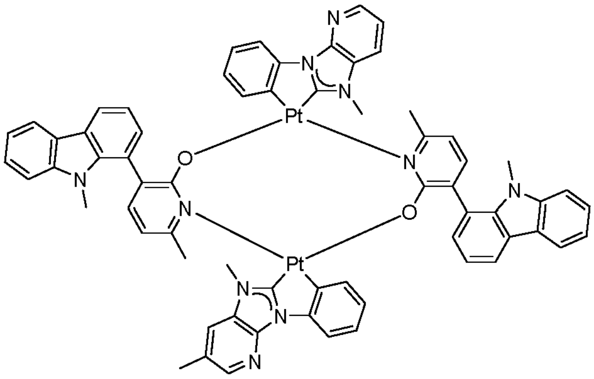

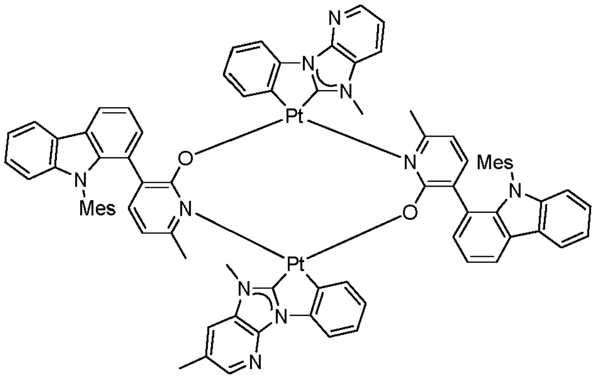

**11.** An organic light-emitting component comprising a light-emitting layer or two or more light-emitting layers, wherein the light-emitting layer or each light-emitting layer of the two or more light-emitting layers comprises one or more dinuclear platinum(II) complexes of claim 1, optionally wherein the organic light-emitting component emits light in the red, deep red, and/or NIR region(s).

**12.** The organic light-emitting component of claim 11, wherein

(i) the light emitting layer or each light-emitting layer of the two or more light-emitting layers further comprises one or more host materials, and wherein the total concentration of the one or more host materials is greater than the total concentration of the one or more complexes in the light-emitting layer or each light-emitting layer of the two or more light-emitting layers, and/or
(ii) the total concentration of the one or more dinuclear platinum(II) complexes in the light-emitting layer or each light-emitting layer of the two or more light-emitting layers is up to 50 wt%, up to 40 wt%, up to 30 wt%, up to 20 wt%, at least 1 wt%, in a range from about 1 wt% to about 50 wt%, from about 1 wt% to about 40 wt%, from about 1 wt% to about 30 wt%, from about 1 wt% to about 20 wt%, from about 2 wt% to about 50 wt%, from about 2 wt% to about 40 wt%, from about 2 wt% to about 30 wt%, from about 2 wt% to about 20 wt%, from about 4 wt% to about 50 wt%, from about 4 wt% to about 40 wt%, from about 4 wt% to about 30 wt%, from about 4 wt% to about 20 wt%, from about 1 wt% to about 16 wt%, from about 2 wt% to about 16 wt%, from about 4 wt% to about 16 wt%, such as about 4 wt%, about 8 wt%, or about 12 wt%, and/or
(iii) the component further comprises an anode, a cathode, a hole transport region, and an electron transport region,

wherein the hole transport region comprises a hole injection layer and/or a hole transport layer, and optionally an electron blocking layer,
wherein the electron transport region comprises an electron transport layer and/or an electron injection layer, and optionally a hole blocking layer,
wherein the light emitting layer is located in between the anode and the cathode,
wherein the hole transport region is located in between the anode and the light-emitting layer, and
wherein the electron transport region is located in between the cathode and the light emitting layer, and/or

(iv) wherein the organic light-emitting component is an organic light-emitting diode ("OLED") or a light-emitting

electrochemical cell ("LEEC"), and/or
(v) wherein the light-emitting layer or each of the light-emitting layer of the two or more light-emitting layers is formed by vacuum-evaporation deposition, spin-coating, ink-printing, or roll-to-roll printing, and/or
(vi)

(a) wherein the light emitting layer or each light-emitting layer of the two or more light-emitting layers further comprises an organic dye, and wherein the one or more dinuclear platinum(II) complexes act(s) as a sensitizer to transfer energy to the organic dye, or
(b) wherein the light emitting layer or each light-emitting layer of the two or more light-emitting layers further comprises an organic dye, and wherein the one or more dinuclear platinum(II) complexes have a higher-lying singlet state than the organic dye.

**13.** A device comprising one or more organic light-emitting components of claim 11, wherein the device is a stationary visual display unit, a mobile visual display unit, an illumination device, a wearable device, a phototherapy device, or a medical monitoring device.

## Patentansprüche

**1.** Dinuklearer Platin(II)-Komplex mit einer Struktur:

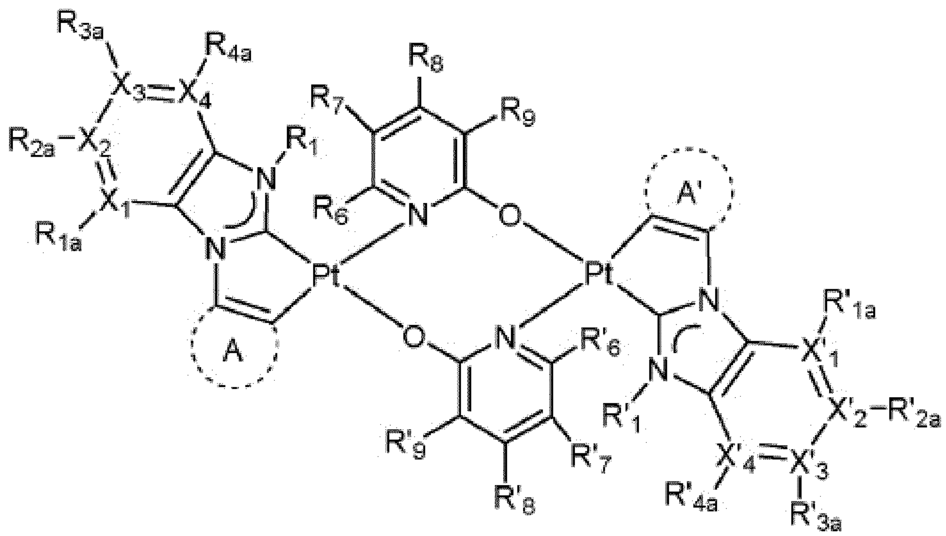

Formel I'

wobei:

(i) der Komplex eine insgesamt neutrale, negative oder positive Ladung ist,
(ii) $X_1$-$X_4$ und $X'_1$-$X'_4$ unabhängig Kohlenstoff, Stickstoff, Schwefel oder Sauerstoff sind;
(iii) $R_{1a}$-$R_{4a}$, $R'_{1a}$-$R'_{4a}$, $R_1$, $R'_1$, $R_6$-$R_9$ und $R'_6$-$R'_9$ unabhängig fehlen, Wasserstoff, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Amino, Amido, Ether, Thiol, Cyano, Nitro, unsubstituiertes Alkoxy, substituiertes Alkoxy, unsubstituiertes Heteroaryl, substituiertes Heteroaryl, unsubstituiertes Polyheteroaryl, substituiertes Polyheteroaryl, unsubstituiertes Carbonyl, substituiertes Carbonyl, unsubstituiertes Ester, substituiertes Ester, substituiertes $C_2$-$C_{20}$-Heterocyclyl, unsubstituiertes $C_2$-$C_{20}$-Heterocyclyl, Boreniumkation, Phosphonyl, Sulfinyl oder Sulfonyl sind, oder $R_{1a}$ und $R_{2a}$ zusammen, $R_{2a}$ und $R_{3a}$ zusammen, $R_{3a}$ und $R_{4a}$ zusammen, $R'_{1a}$ und $R'_{2a}$ zusammen, $R'_{2a}$ und $R'_{3a}$ zusammen, $R'_{3a}$ und $R'_{4a}$ zusammen, $R_6$ und $R_7$ zusammen, $R_7$ und $R_8$ zusammen, $R_8$ und $R_9$ zusammen, $R'_6$ und $R'_7$ zusammen, $R'_7$ und $R'_8$ zusammen und/oder $R'_8$ und $R'_9$ zusammen mit dem Atom, an das sie angehängt sind, ein substituiertes Cycloalkyl, ein unsubstituiertes Cycloalkyl, ein substituiertes Cycloalkenyl, ein unsubstituiertes Cycloalkenyl, ein substituiertes Cycloalkinyl, ein unsubstituiertes Cycloalkinyl, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl, kondensierte Kombinationen davon bilden, oder $R_{1a}$ und $R_{2a}$ zusammen, $R_{2a}$ und $R_{3a}$ zusammen, $R_{3a}$ und $R_{4a}$ zusammen, $R'_{1a}$ und $R'_{2a}$ zusammen, $R'_{2a}$ und $R'_{3a}$ zusammen, $R'_{3a}$ und $R'_{4a}$ zusammen, $R_6$ und $R_7$ zusammen, $R_7$ und $R_8$ zusammen, $R_8$ und $R_9$ zusammen, $R'_6$ und $R'_7$ zusammen, $R'_7$ und $R'_8$ zusammen und/oder $R'_8$ und $R'_9$ zusammen mit dem Atom, an das sie angehängt sind, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl oder kondensierte Kombinationen davon bilden;

(iv) A und A' unabhängig ein substituiertes Cycloalkyl, ein unsubstituiertes Cycloalkyl, ein substituiertes Cycloalkenyl, ein unsubstituiertes Cycloalkenyl, ein substituiertes Cycloalkinyl, ein unsubstituiertes Cycloalkinyl, ein substituiertes Heterocyclyl, ein unsubstituiertes Heterocyclyl, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl oder kondensierte Kombinationen davon sind; bevorzugt A und A' unabhängig ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl oder kondensierte Kombinationen davon sind; und

(v) jeder Substituent unabhängig ein substituiertes oder unsubstituiertes Alkyl, ein substituiertes oder unsubstituiertes Alkenyl, ein substituiertes oder unsubstituiertes Alkinyl, ein substituiertes oder unsubstituiertes Heterocyclyl, ein substituiertes oder unsubstituiertes Aryl, ein substituiertes oder unsubstituiertes Heteroaryl, ein substituiertes oder unsubstituiertes Polyaryl, ein substituiertes oder unsubstituiertes Polyheteroaryl, ein substituiertes oder unsubstituiertes Aralkyl, ein Carbonyl, ein Alkoxy, ein Halogen, ein Hydroxyl, ein Phenoxy, ein Thiol, ein Alkylthio, ein Phenylthio, ein Arylthio, ein Cyano, ein Isocyano, ein Nitro, ein Carboxyl, ein Amino, ein Amido, ein Oxo, ein Silyl, ein Sulfinyl, ein Sulfonyl, eine Sulfonsäure, ein Phosphonium, ein Phosphanyl, ein Phosphoryl oder ein Phosphonyl ist.

**2.** Dinuklearer Platin(II)-Komplex nach Anspruch 1, wobei das dinukleare Platin(II) eine folgende Struktur aufweist:

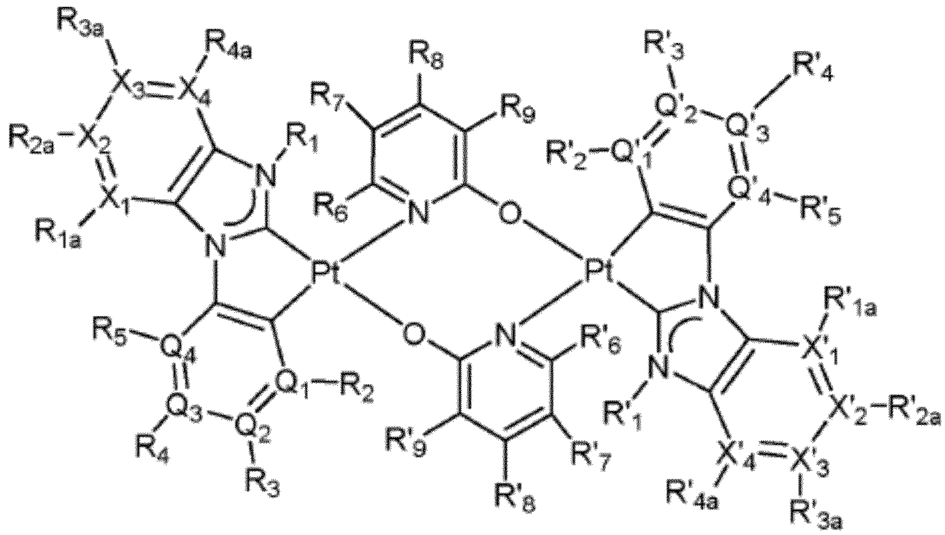

Formel I

oder

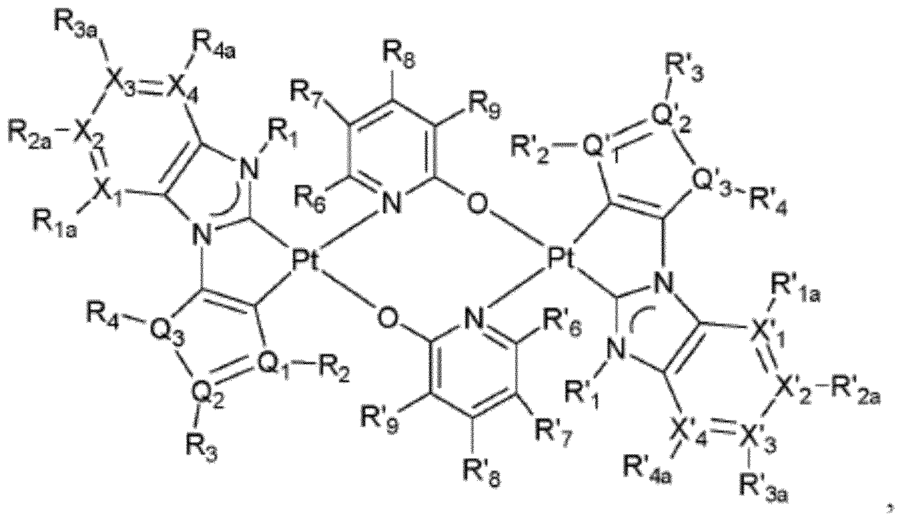

Formel Ia

wobei:

(i) der Komplex eine insgesamt neutrale, negative oder positive Ladung aufweist,
(ii) $Q_1$-$Q_4$ und $Q'_1$-$Q'_4$ unabhängig Kohlenstoff, Stickstoff, Schwefel oder Sauerstoff sind; und
(iii) $R_2$-$R_5$ und $R'_2$-$R'_5$ unabhängig fehlen, Wasserstoff, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Amino, Amido, Ether, Thiol, Cyano, Nitro, unsubstituiertes Alkoxy, substituiertes Alkoxy, unsubstituiertes Heteroaryl, substituiertes Heteroaryl, unsubstituiertes Polyheteroaryl, substituiertes Polyheteroaryl, unsubstituiertes Carbonyl, substituiertes Carbonyl, unsubstituiertes Ester, substituiertes Ester, substituiertes $C_2$-$C_{20}$-Heterocyclyl oder unsubstituiertes $C_2$-$C_{20}$-Heterocyclyl, Boreniumkation, Phosphonyl, Sulfinyl oder Sulfonyl sind, oder $R_2$ und $R_3$ zusammen, $R_3$ und $R_4$ zusammen, $R_4$ und $R_5$ zusammen, $R'_2$ und $R'_3$ zusammen, $R'_3$ und $R'_4$ zusammen und/oder $R'_4$ und $R'_5$ zusammen mit dem Atom, an das sie angehängt sind, ein substituiertes Cycloalkyl, ein unsubstituiertes Cycloalkyl, ein substituiertes Cycloalkenyl, ein unsubstituiertes Cycloalkenyl, ein substituiertes Cycloalkinyl, ein unsubstituiertes Cycloalkinyl, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl, kondensierte Kombinationen davon bilden, oder $R_2$ und $R_3$ zusammen, $R_3$ und $R_4$ zusammen, $R_4$ und $R_5$ zusammen, $R'_2$ und $R'_3$ zusammen, $R'_3$ und $R'_4$ zusammen und/oder $R'_4$ und $R'_5$ zusammen mit dem Atom, an das sie angehängt sind, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl oder kondensierte Kombinationen davon bilden.

**3.** Komplex nach Anspruch 1, wobei der Komplex eine Struktur aufweist:

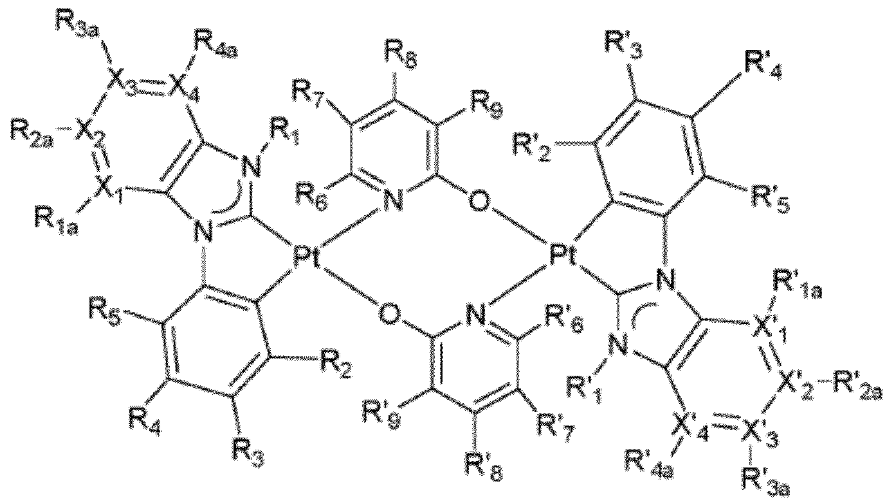

Formel II

oder

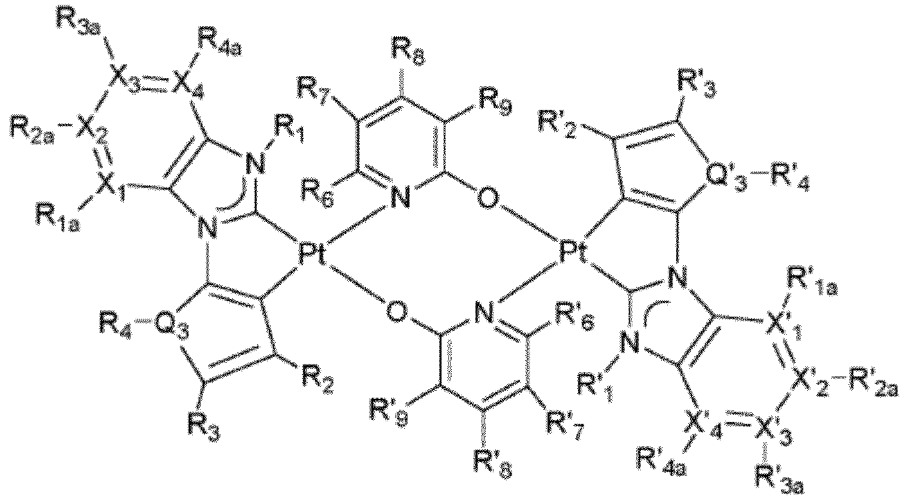

,

oder

Formel IIa

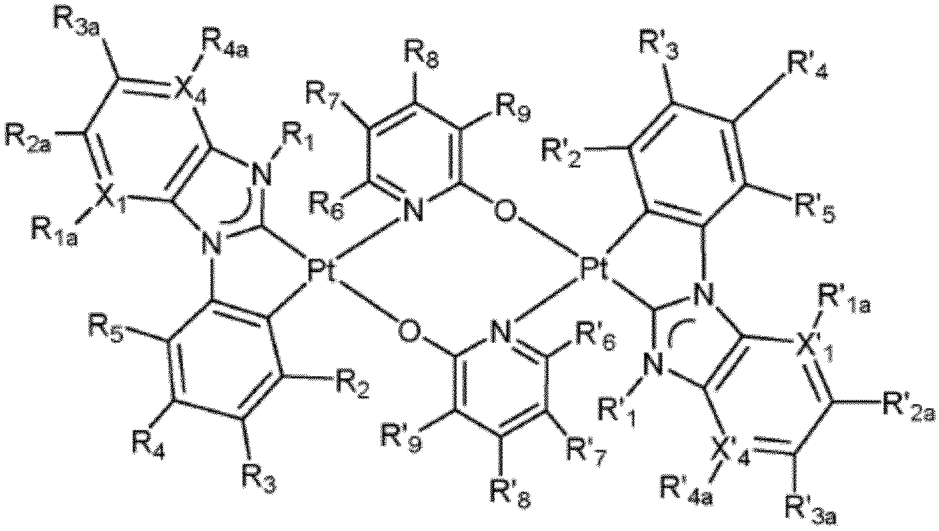

Formel III

oder

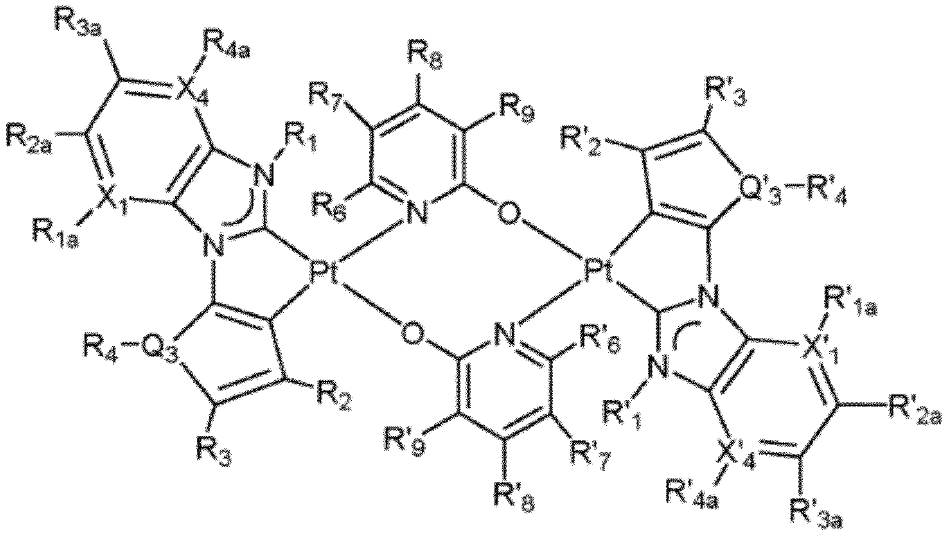

,

Formel IIIa

oder

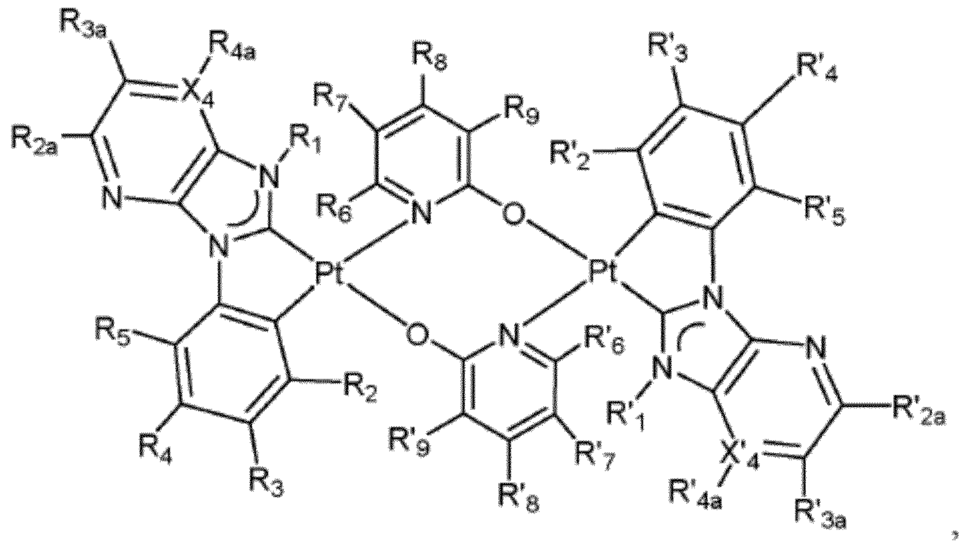

,

Formel IV

oder

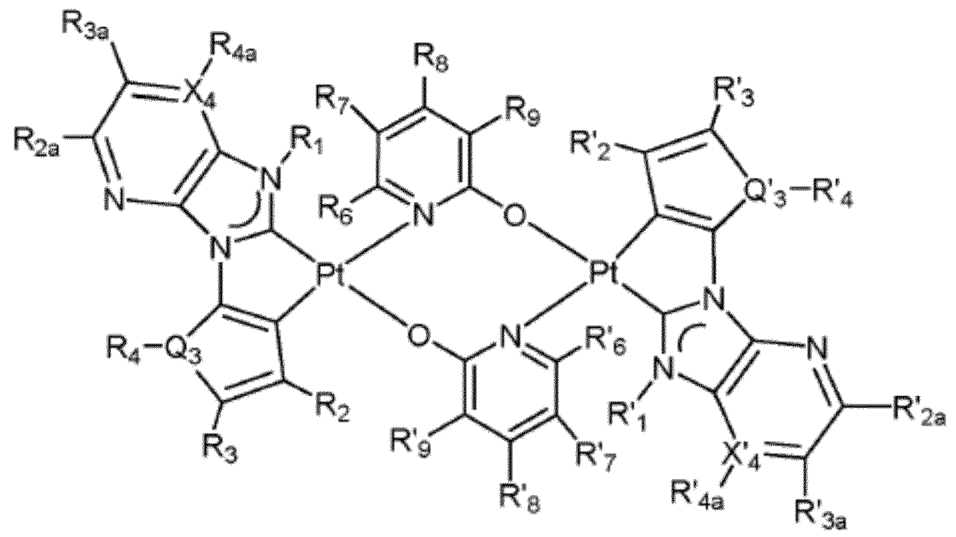

Formel IVa.

**4.** Komplex nach Anspruch 1, wobei:

(i) $X_4$ und $X'_4$ Kohlenstoff sind; und $R_{4a}$ und $R'_{4a}$ unabhängig Wasserstoff, substituiertes Alkyl, unsubstituiertes Alkyl, substituiertes Aryl, unsubstituiertes Aryl, Hydroxyl, unsubstituiertes Heteroaryl, substituiertes Heteroaryl, unsubstituiertes Polyaryl, substituiertes Polyaryl, unsubstituiertes Polyheteroaryl, substituiertes Polyheteroaryl, substituiertes $C_2$-$C_{20}$-Heterocyclyl oder unsubstituiertes $C_2$-$C_{20}$-Heterocyclyl sind, wobei optional $X_4$ und $X'_4$ Kohlenstoff sind und $R_{4a}$ und $R'_{4a}$ unabhängig Wasserstoff, unsubstituiertes Alkyl, unsubstituiertes Aryl, unsubstituiertes Polyaryl, Hydroxyl, unsubstituiertes Heteroaryl, unsubstituiertes Polyheteroaryl, unsubstituiertes $C_2$-$C_{20}$-Heterocyclyl oder unsubstituiertes Alkylaryl wie Wasserstoff sind; oder

(ii) $X_4$ und $X'_4$ Stickstoff sind; $R_{4a}$ und $R'_{4a}$ fehlen, und wobei optional $R_{2a}$, $R_{3a}$, $R'_{2a}$ und $R'_{3a}$ unabhängig Wasserstoff, unsubstituiertes Alkyl (z. B. Methyl, Ethyl, n-Propyl, Isopropyl, n-Butyl, sec-Butyl, Isobutyl, tert-Butyl usw.), substituiertes Alkyl, unsubstituiertes Aryl (z. B. unsubstituiertes Phenyl) oder Alkoxy (z. B. -O-Alkyl, -O-Aryl, -O-Polyaryl usw.) sind, oder $R_{2a}$ und $R_{3a}$ zusammen und/oder $R'_{2a}$ und $R'_{3a}$ zusammen mit dem Atom, an das sie angehängt sind, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl oder kondensierte Kombinationen davon bilden, wie substituiertes Aryl oder unsubstituiertes Aryl; oder
(iii) $X_1$-$X_4$ und $X'_1$-$X'_4$ Kohlenstoff sind; und $R_{1a}$-$R_{4a}$ und $R'_{1a}$-$R'_{4a}$ unabhängig Wasserstoff, unsubstituiertes Alkyl (z. B. Methyl, Ethyl, n-Propyl, Isopropyl, n-Butyl, sec-Butyl, Isobutyl, tert-Butyl, usw.), substituiertes Alkyl, unsubstituiertes Aryl (z. B. unsubstituiertes Phenyl) oder Alkoxy (z. B. -O-Alkyl, -O-Aryl, -O-Polyaryl usw.) sind, oder $R_{1a}$ und $R_{2a}$ zusammen, $R_{2a}$ und $R_{3a}$ zusammen, $R_{3a}$ und $R_{4a}$ zusammen, $R'_{1a}$ und $R'_{2a}$ zusammen, $R'_{2a}$ und $R'_{3a}$ zusammen und/oder $R'_{3a}$ und $R'_{4a}$ zusammen mit dem Atom, an das sie angehängt sind, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl oder kondensierte Kombinationen davon bilden, wie ein substituiertes Aryl oder unsubstituiertes Aryl, zum Beispiel $R_{1a}$ und $R_{2a}$ zusammen, $R_{3a}$ und $R_{4a}$ zusammen, $R'_{1a}$ und $R'_{2a}$ zusammen und $R'_{3a}$ und $R'_{4a}$ zusammen mit dem Atom, an das sie angehängt sind, ein substituiertes Aryl oder unsubstituiertes Aryl bilden, oder $R_{2a}$ und $R_{3a}$ zusammen und $R'_{2a}$ und $R'_{3a}$ zusammen mit dem Atom, an das sie angehängt sind, ein substituiertes Aryl oder unsubstituiertes Aryl bilden.

**5.** Komplex nach Anspruch 2, wobei $R_1$-$R_9$ und $R'_1$-$R'_9$ unabhängig Wasserstoff, Halogen unsubstituiertes Alkyl (z. B. Methyl, Ethyl, n-Propyl, Isopropyl, n-Butyl, sec-Butyl, Isobutyl, tert-Butyl usw.), substituiertes Alkyl, unsubstituiertes Aryl, substituiertes Aryl (z. B. Mesitylen oder anderes Aryl substituiert mit einem oder mehreren Alkylen, wie Methyl, Ethyl, n-Propyl, Isopropyl, n-Butyl, sec-Butyl, Isobutyl, tert-Butyl usw.), unsubstituiertes Polyaryl, substituiertes Polyaryl, Hydroxyl, unsubstituiertes Heteroaryl, substituiertes Heteroaryl, unsubstituiertes Polyheteroaryl, substituiertes Polyheteroaryl, unsubstituiertes $C_2$-$C_{20}$-Heterocyclyl, substituiertes $C_2$-$C_{20}$-Heterocyclyl, unsubstituiertes Alkylaryl, substituiertes Alkylaryl, Alkoxy (z. B. -O-Alkyl, -O-Aryl, -O-Polyaryl usw.), Boreniumkation (z. B. -B(Mes)$_2$), Phosphonyl (z. B. -P(=O)(Ph)$_2$, - P(=O)(Alkyl)$_2$ usw.) oder Sulfinyl (z. B. -S(=O)(Ph)$_2$, -S(=O)(Alkyl)$_2$ usw.) oder Sulfonyl - S(=O)$_2$(Ph)$_2$, -S(=O)$_2$(Alkyl)$_2$ usw.) sind, oder $R_2$ und $R_3$ zusammen, $R'_2$ und $R'_3$ zusammen, $R_3$ und $R_4$ zusammen, $R'_3$ und $R'_4$ zusammen, $R_4$ und $R_5$ zusammen, $R'_4$ und $R'_5$ zusammen, $R_6$ und $R_7$ zusammen, $R_7$ und $R_8$ zusammen, $R_8$ und $R_9$ zusammen, $R'_6$ und $R'_7$ zusammen, $R'_7$ und $R'_8$ zusammen und/oder $R'_8$ und $R'_9$ zusammen mit dem Atom, an das sie angehängt sind, ein substituiertes Aryl, ein unsubstituiertes Aryl, ein substituiertes Heteroaryl, ein unsubstituiertes Heteroaryl, ein substituiertes Polyaryl, ein unsubstituiertes Polyaryl, ein substituiertes Polyheteroaryl, ein unsubstituiertes Polyheteroaryl, ein substituiertes Heterocyclyl, ein unsubstituiertes Heterocyclyl oder kondensierte Kombinationen davon bilden.

**6.** Komplex nach Anspruch 5, wobei eines oder mehrere von $R_1$-$R_9$ und $R'_1$-$R'_9$

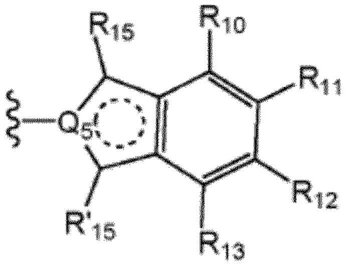

oder

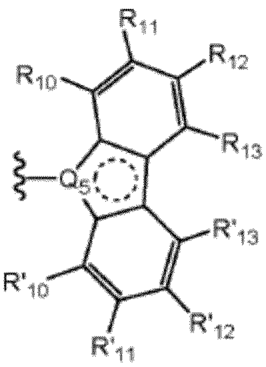

,

ist (sind), wobei $Q_5$ Stickstoff oder Kohlenstoff ist; und $R_{10}$-$R_{13}$, $R_{15}$, $R'_{15}$ und $R'_{10}$-$R'_{13}$ unabhängig fehlen, Wasserstoff, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Amino, Amido, Ether, Thiol, Cyano, Nitro, unsubstituiertes Alkoxy, substituiertes Alkoxy, unsubstituiertes Aroxy, substituiertes Aroxy, unsubstituiertes Heteroaryl, substituiertes Heteroaryl, unsubstituiertes Polyheteroaryl, substituiertes Polyheteroaryl, unsubstituiertes Carbonyl, substituiertes Carbonyl, unsubstituiertes Ester, substituiertes Ester, substituiertes $C_2$-$C_{20}$-Heterocyclyl oder unsubstituiertes $C_2$-$C_{20}$-Heterocyclyl sind, wobei optional
$Q_5$ Stickstoff ist; und $R_{10}$-$R_{13}$, $R_{15}$, $R'_{15}$ und $R'_{10}$-$R'_{13}$ unabhängig fehlen, Wasserstoff, substituiertes Alkyl, unsubstituiertes Alkyl, substituierte Phenylgruppe, unsubstituiertes Phenyl, Alkoxy, Halogen, Boreniumkation (z. B. -B(Mes)$_2$), Phosphonyl oder Sulfinyl wie Wasserstoff sind.

7. Komplex nach Anspruch 2, wobei: (i) $R_2$ und $R_3$ zusammen und/oder $R'_2$ und $R'_3$ zusammen oder (ii) $R_3$ und $R_4$ zusammen und/oder $R'_3$ und $R'_4$ zusammen oder (iii) $R_4$ und $R_5$ zusammen und/oder $R'_4$ und $R'_5$ zusammen mit dem Atom, an das sie angehängt sind, ein substituiertes Cycloalkyl, ein unsubstituiertes Cycloalkyl, ein substituiertes Cycloalkenyl, ein unsubstituiertes Cycloalkenyl, ein substituiertes Cycloalkinyl, ein unsubstituiertes Cycloalkinyl, ein substituiertes Aryl, ein unsubstituiertes Aryl, ein substituiertes Heteroaryl, ein unsubstituiertes Heteroaryl bilden, wobei optional: (a) $R_2$ und $R_3$ zusammen und/oder $R'_2$ und $R'_3$ zusammen, oder

(b) $R_3$ und $R_4$ zusammen und/oder $R'_3$ und $R'_4$ zusammen, oder
(c) $R_4$ und $R_5$ zusammen und/oder $R'_4$ und $R'_5$ zusammen

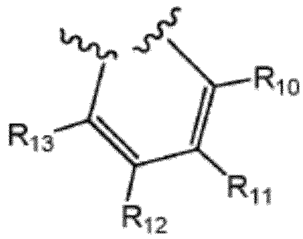

oder

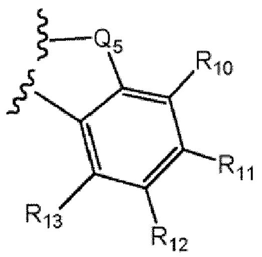

bilden, wobei $Q_5$ $NR_{14}$, $CR_{16}R_{17}$ oder Schwefel oder Sauerstoff ist; und $R_{10}$-$R_{14}$, $R_{16}$, und $R_{17}$ unabhängig fehlen, Wasserstoff, substituiertes Alkyl, unsubstituiertes Alkyl, substituiertes Alkenyl, unsubstituiertes Alkenyl, substituiertes Alkinyl, unsubstituiertes Alkinyl, substituiertes Aryl, unsubstituiertes Aryl, Halogen, Hydroxyl, Amino, Amido, Ether, Thiol, Cyano, Nitro, unsubstituiertes Alkoxy, substituiertes Alkoxy, unsubstituiertes Aroxy, substituiertes Aroxy, unsubstituiertes Heteroaryl, substituiertes Heteroaryl, unsubstituiertes Polyheteroaryl, substituiertes Polyheteroaryl, unsubstituiertes Carbonyl, substituiertes Carbonyl, unsubstituiertes Ester, substituiertes Ester, substituiertes $C_2$-$C_{20}$-Heterocyclyl oder unsubstituiertes $C_2$-$C_{20}$-Heterocyclyl sind, wobei optional $Q_5$ $NR_{14}$, $CR_{16}R_{17}$, Schwefel oder Sauerstoff wie Sauerstoff ist; und $R_{10}$-$R_{14}$, $R_{16}$ und $R_{17}$ unabhängig fehlen, Wasserstoff, substituiertes Alkyl, unsubstituiertes Alkyl, substituierte Phenylgruppe, unsubstituiertes Phenyl, Alkoxy, Halogen, Boreniumkation (z. B. -B(Mes)$_2$), Phosphonyl oder Sulfinyl wie Wasserstoff oder unsubstituiertes Alkyl sind.

8. Komplex nach Anspruch 2, wobei $R_6$-$R_9$ und $R'_6$-$R'_9$, unabhängig Wasserstoff, Halogen, unsubstituiertes Alkyl (z. B. Methyl, Ethyl, n-Propyl, Isopropyl, n-Butyl, sec-Butyl, Isobutyl, tert-Butyl usw.), substituiertes Alkyl, unsubstituiertes Aryl (z. B. unsubstituiertes Phenyl), substituiertes Aryl (z. B. Mesitylen oder anderes Aryl substituiert mit einem oder mehreren Alkylen wie Methyl, Ethyl, n-Propyl, Isopropyl, n-Butyl, sec-Butyl, Isobutyl, tert-Butyl usw.), Boreniumkation (z. B. -B(Mes)2), Phosphonyl (z. B. -P(=O)(Ph)2, -P(=O)(Alkyl)2, usw.), substituiertes Heteroaryl oder unsubstituiertes Heteroaryl sind oder $R_6$ und $R_7$ zusammen, $R_7$ und $R_8$ zusammen, $R_8$ und $R_9$ zusammen, $R'_6$ und $R'_7$ zusammen, $R'_7$ und $R'_3$ zusammen und/oder $R'_8$ und $R'_9$ zusammen mit dem Atom, an das sie angehängt sind, ein substituiertes Aryl oder ein unsubstituiertes Aryl wie ein substituiertes Phenyl oder unsubstituiertes Phenyl bilden, wobei optional zumindest eines von $R_6$-$R_9$ und zumindest eines von $R'_6$-$R'_9$ nicht Wasserstoff sind, und/oder wobei $Q_3$ und $Q'_3$ von Formel Ia-IVa unabhängig Schwefel oder Sauerstoff sind.

9. Komplex nach Anspruch 2, wobei $R_2$, $R_4$, $R_5$, $R'_{2a}$ $R'_4$, $R'_5$, $R_7$, $R_8$, $R'_7$ und $R'_8$ Wasserstoff sind; und $R_1$, $R_3$, $R_6$, $R_9$, $R'_1$, $R'_3$, $R'_6$ und $R'_9$ unabhängig Wasserstoff, Halogen, unsubstituiertes Alkyl, substituiertes Alkyl, unsubstituiertes Aryl, substituiertes Aryl (z. B. Aryl substituiert mit einem oder mehreren Alkylen wie Methyl, Ethyl, n-Propyl, Isopropyl, n-Butyl, sec-Butyl, Isobutyl, tert-Butyl usw.), Hydroxyl, unsubstituiertes Heteroaryl (z. B. Carbazolyl, Fluorenyl, Indenyl, Indolyl usw.), unsubstituiertes Polyheteroaryl, unsubstituiertes $C_2$-$C_{20}$-Heterocyclyl, unsubstituiertes Alky-

laryl, Alkoxy (z. B. -O-Alkyl wie Methoxy, Ethoxy und Phenoxy, -O-Aryl, -O-Polyaryl usw.), Boreniumkation (z. B. -B(Mes)$_2$), Phosphonyl (z. B. - P(=O)(Ph)$_2$), Sulfinyl (z. B. -S(=O)(Ph)$_2$, -S(=O)(Alkyl)$_2$ usw.) oder Sulfonyl -S(=O)$_2$(Ph)$_2$, -S(=O)$_2$(Alkyl)$_2$ usw.) wie Halogen, unsubstituiertes Alkyl (z. B. Methyl, Ethyl, n-Propyl, Isopropyl, n-Butyl, sec-Butyl, Isobutyl, tert-Butyl usw.), unsubstituiertes Aryl (z. B. unsubstituiertes Phenyl), substituiertes Aryl (z. B. Mesitylen oder anderes Aryl substituiert mit einem oder mehreren Alkylen wie Methyl, Ethyl, n-Propyl, Isopropyl, n-Butyl, sec-Butyl, Isobutyl, tert-Butyl usw.), Boreniumkation (z. B. - B(Mes)$_2$) oder Phosphonyl (z. B. -P(=O)(Ph)$_2$, -P(=O)(Alkyl)$_2$ usw.) sind, wobei optional $R_1$, $R_6$, $R_9$, $R'_1$, $R'_6$ und $R'_9$ unabhängig unsubstituiertes Alkyl, unsubstituiertes Aryl oder substituiertes Aryl (z. B. Phenyl substituiert mit einem oder mehreren $C_1$-$C_6$-Alkylen) sind.

**10.** Komplex nach Anspruch 1, wobei der Komplex eine beliebige der folgenden Strukturen aufweist:

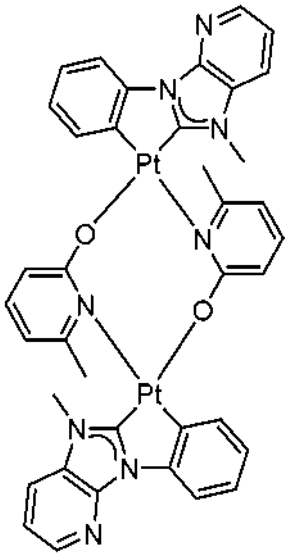

**Pt-R1** ,

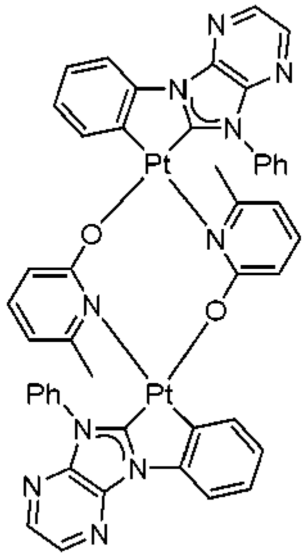

**Pt-R2** ,

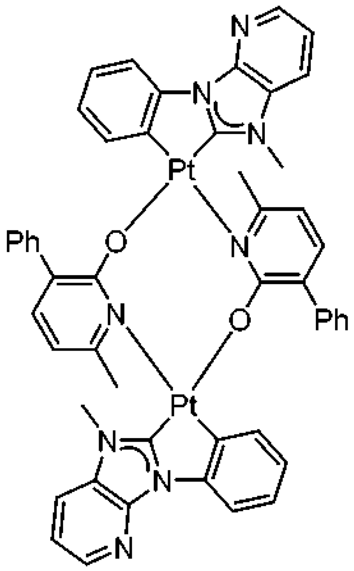

**Pt-R3** ,

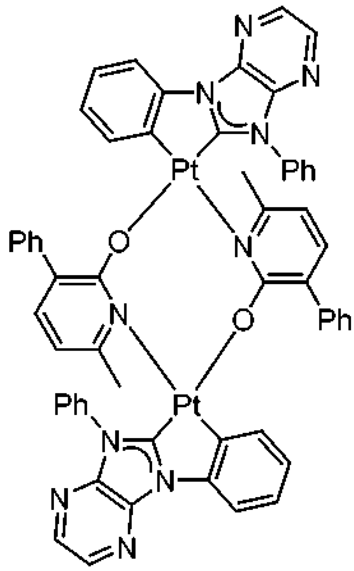

**Pt-R4** ,

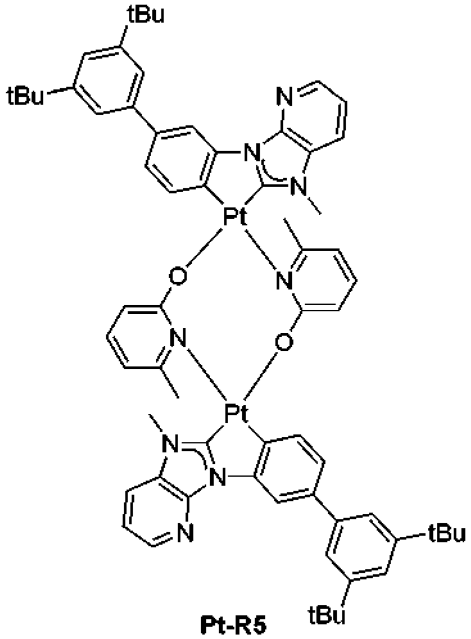

**Pt-R5** ,

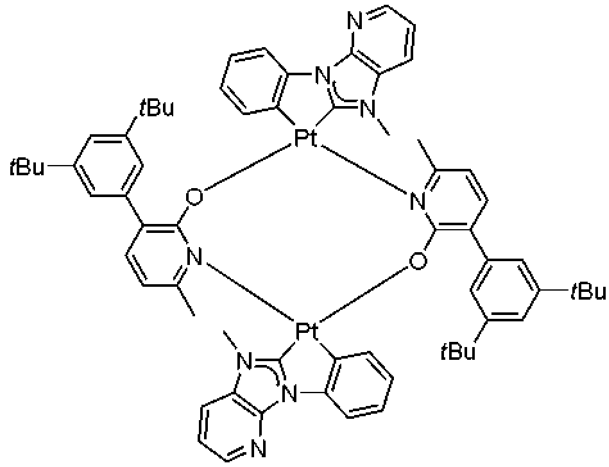

**Pt-R6** ,

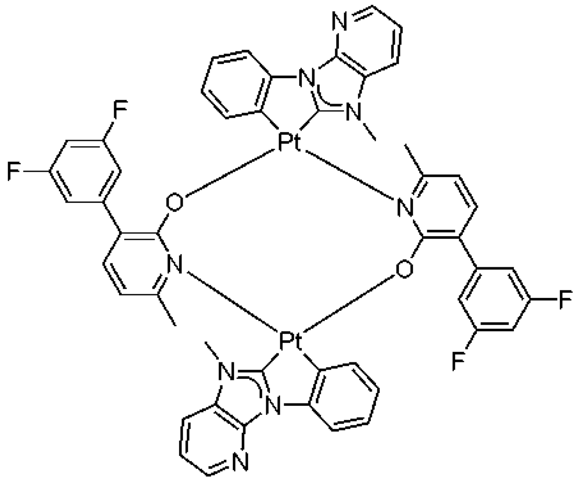

**Pt-R7** ,

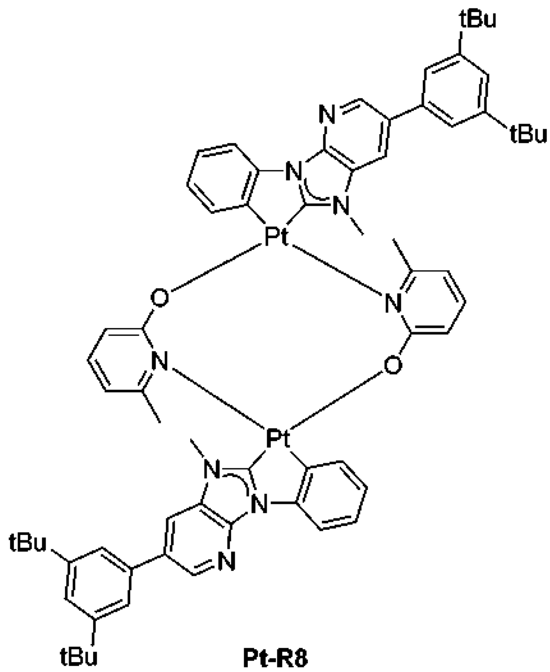

**Pt-R8** ,

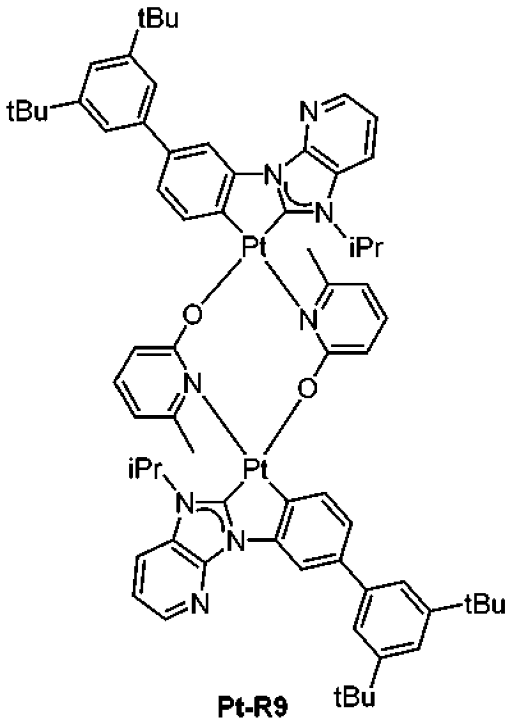

**Pt-R9**,

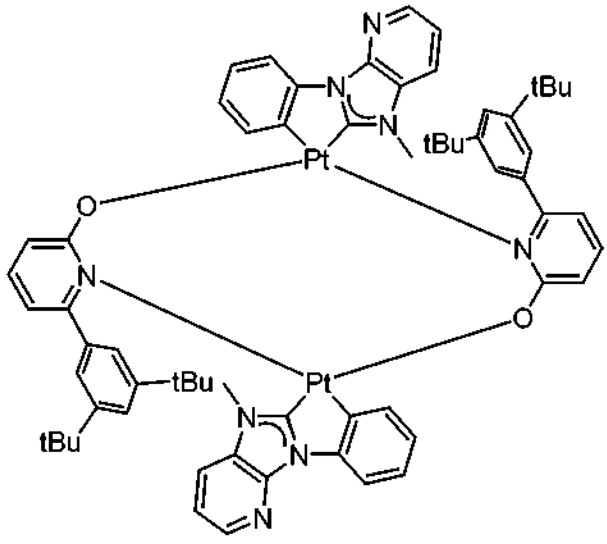

**Pt-R10**,

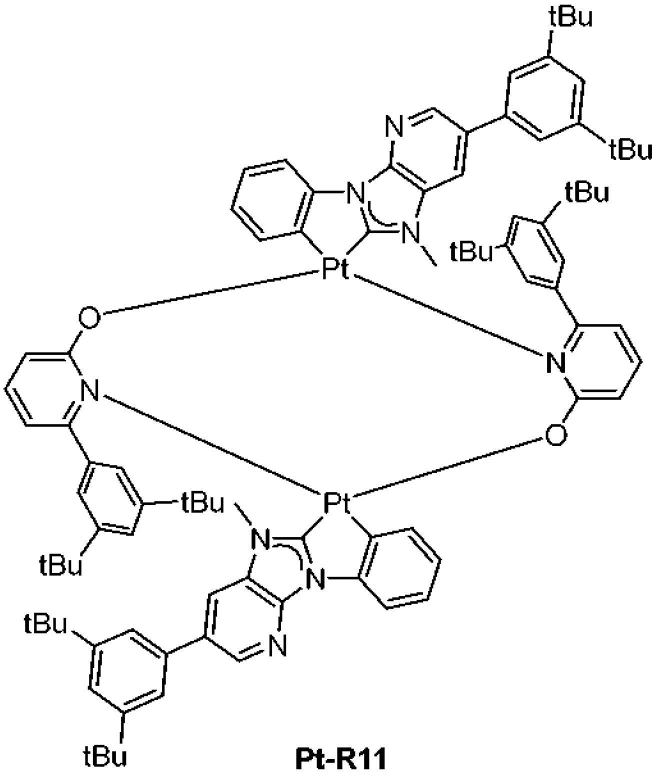

**Pt-R11**,

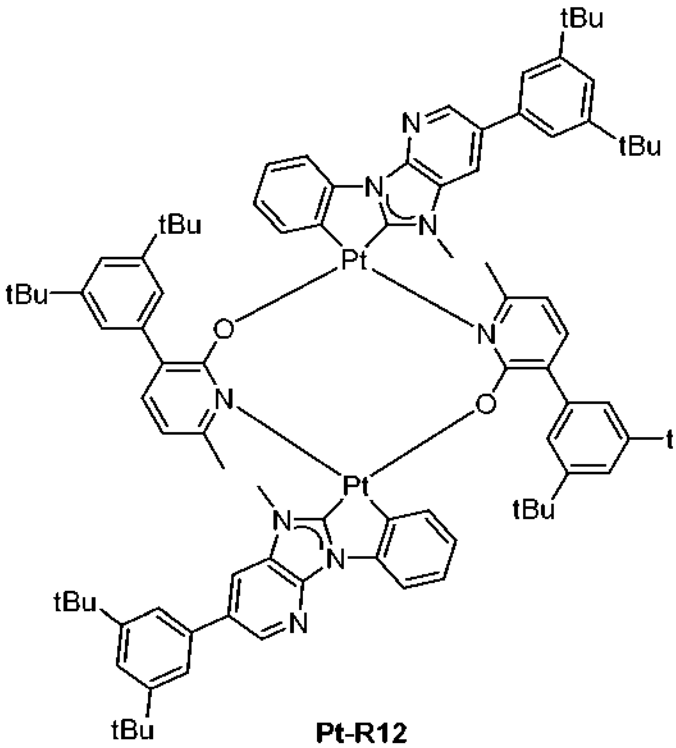

**Pt-R12**

,

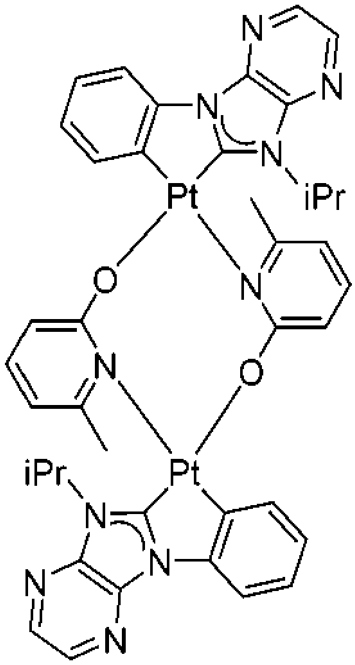

**Pt-R13**

,

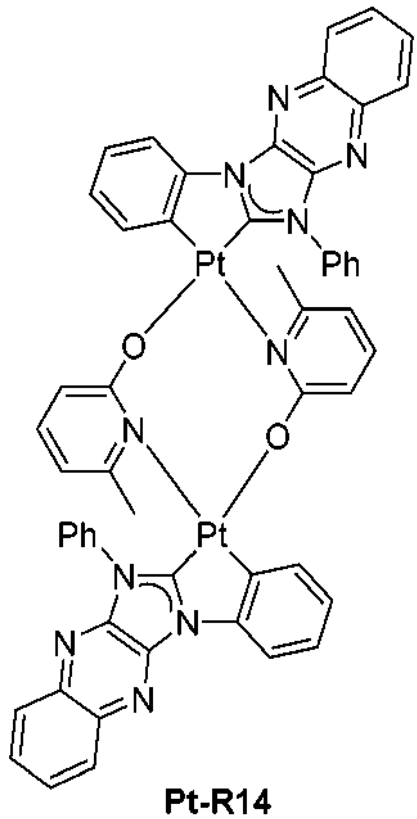

**Pt-R14**

,

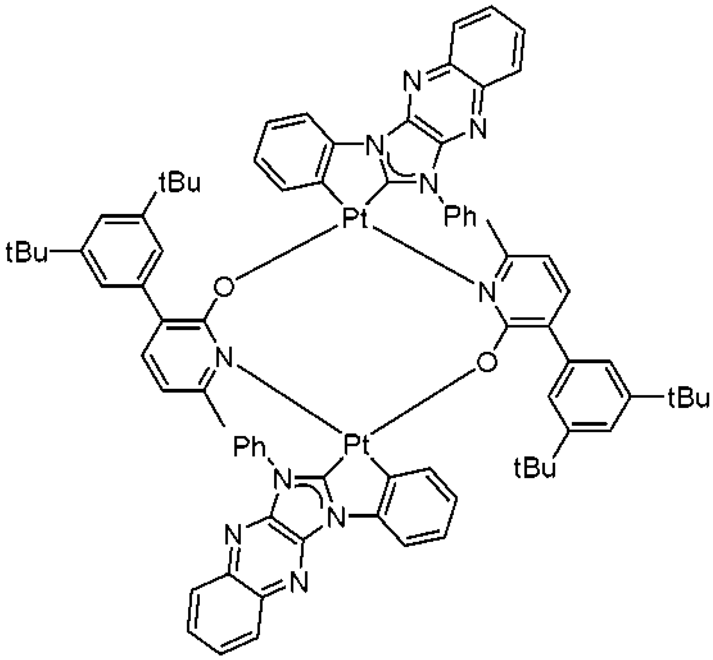

**Pt-R15**

,

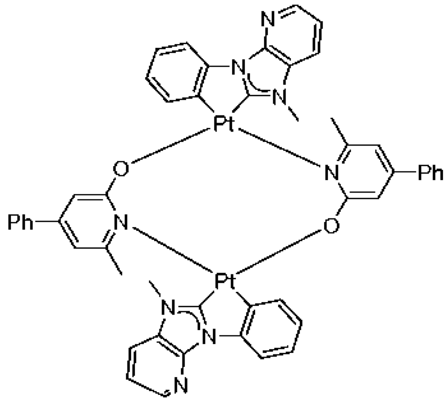

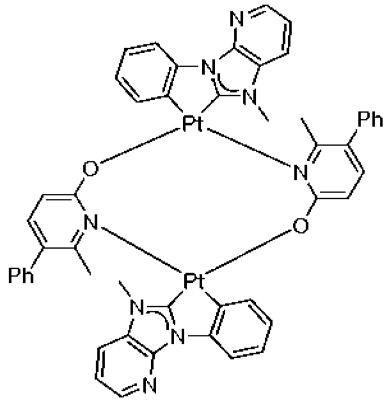

,

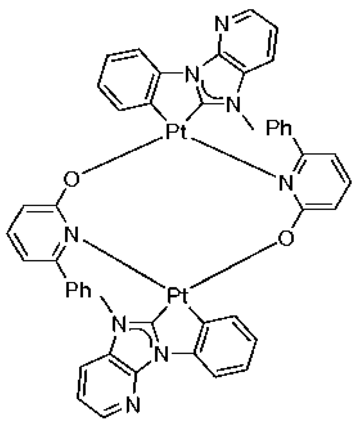

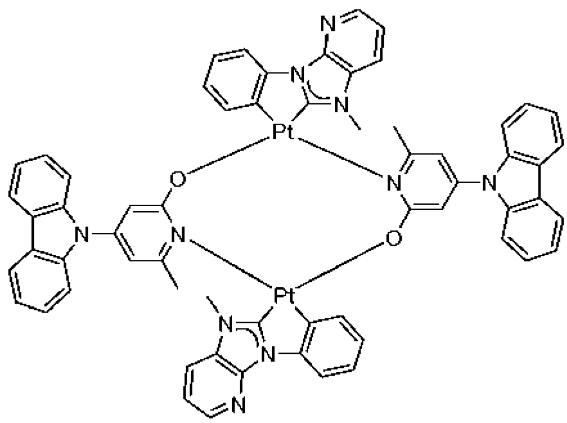

,

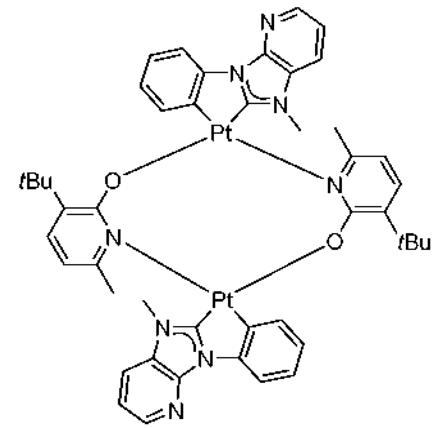
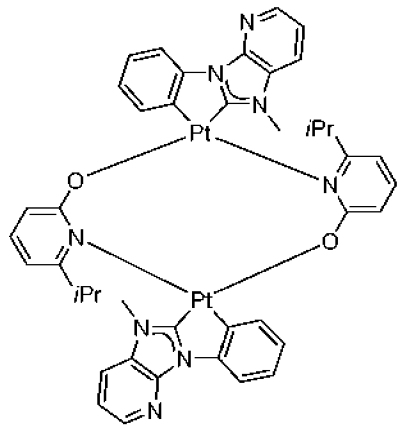

,

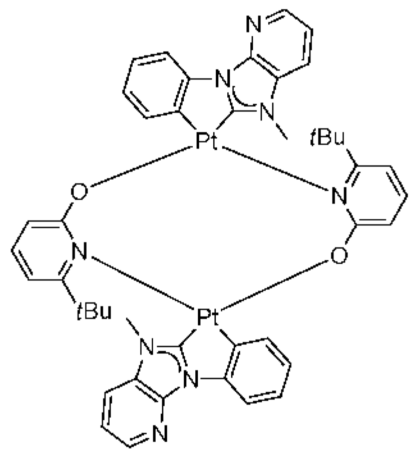
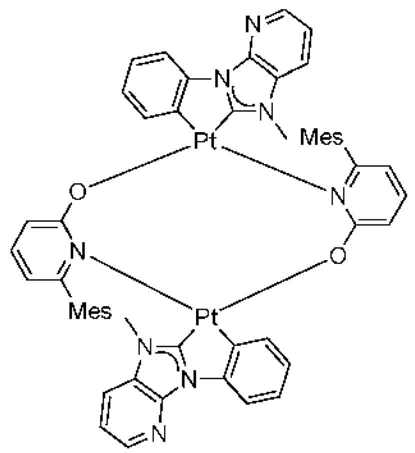

,

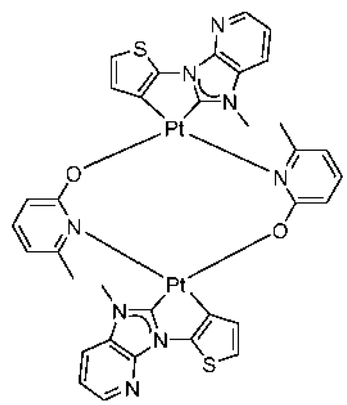
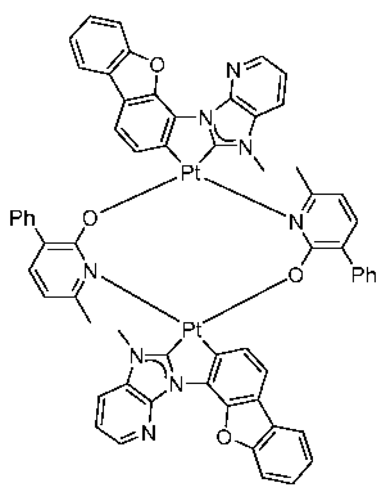
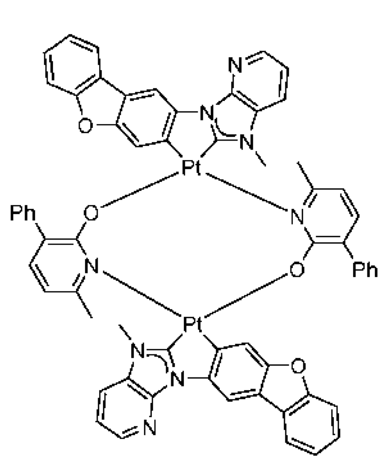

,

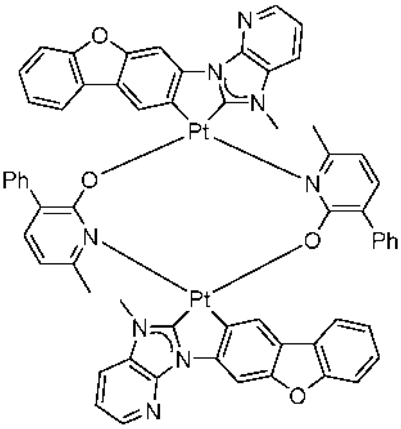

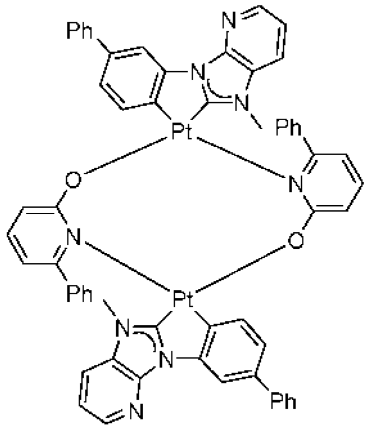

,

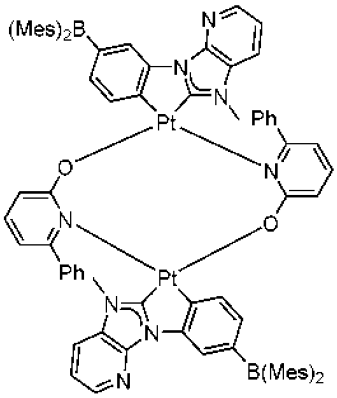

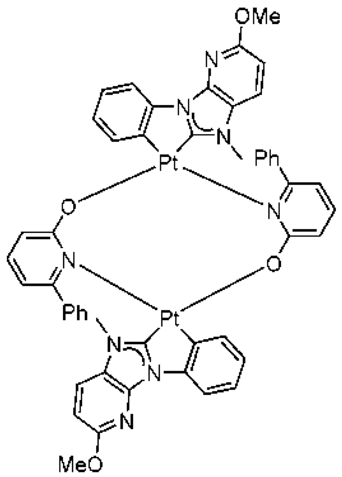

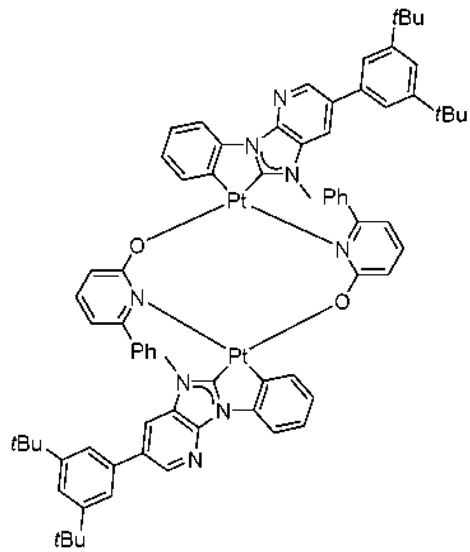

,

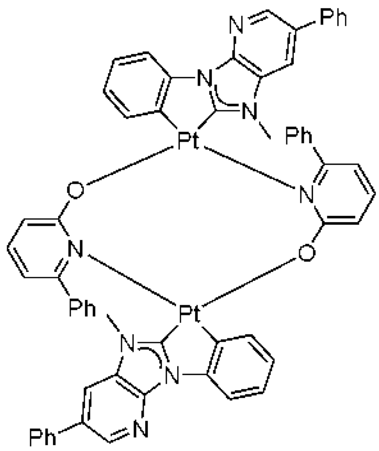

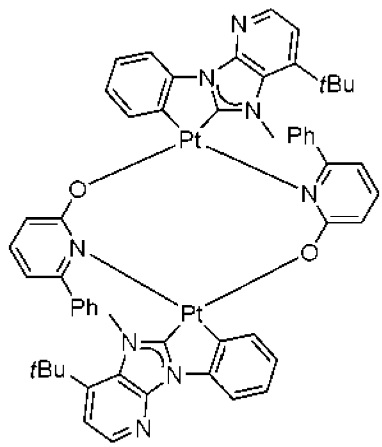

,

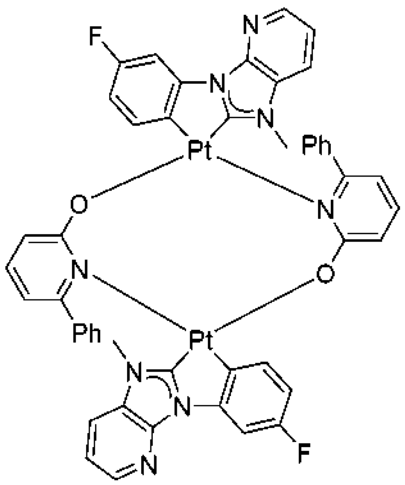

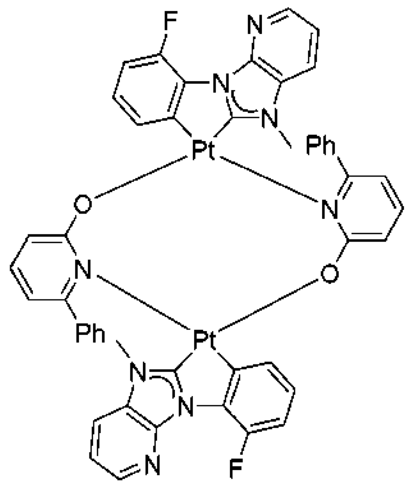

,

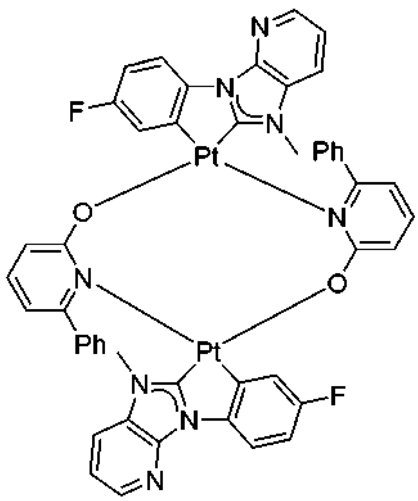

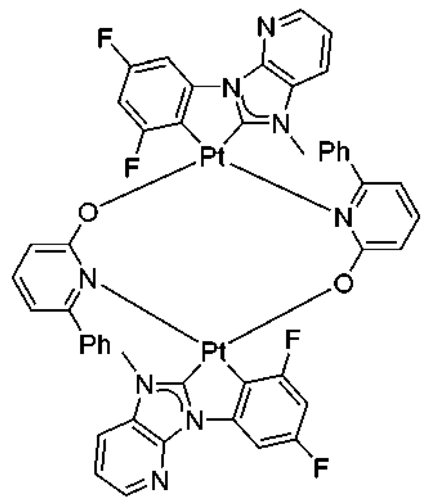

,

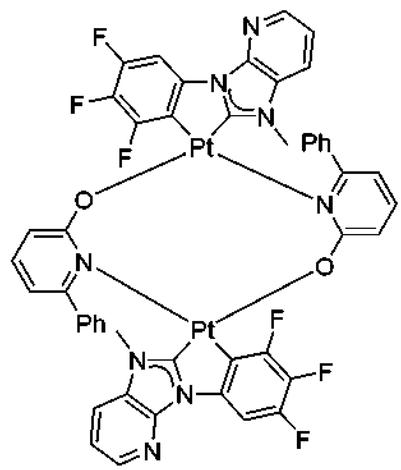

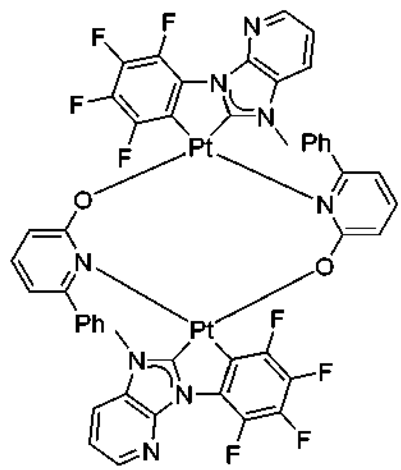

,

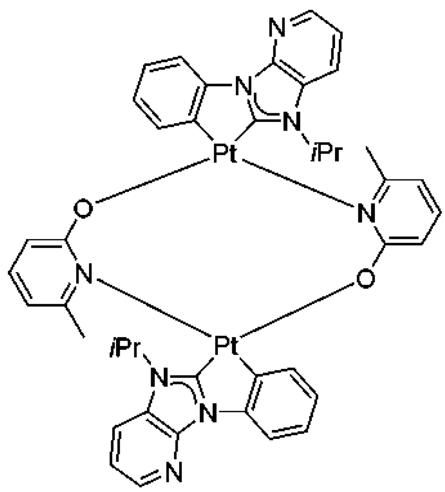

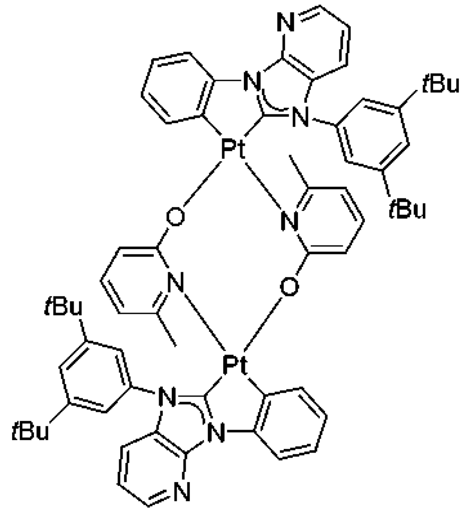

,

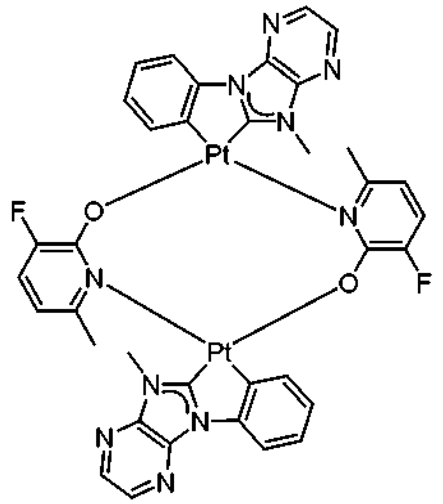

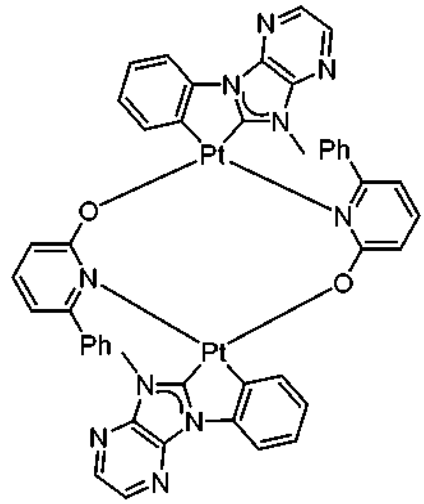

,

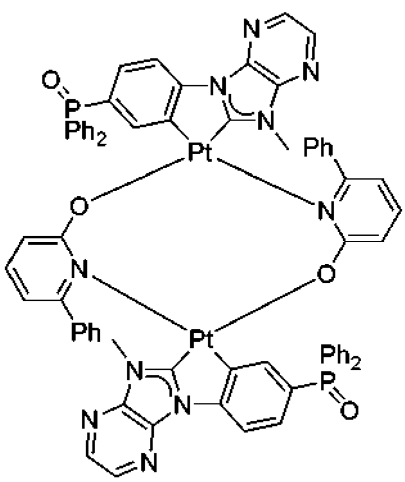

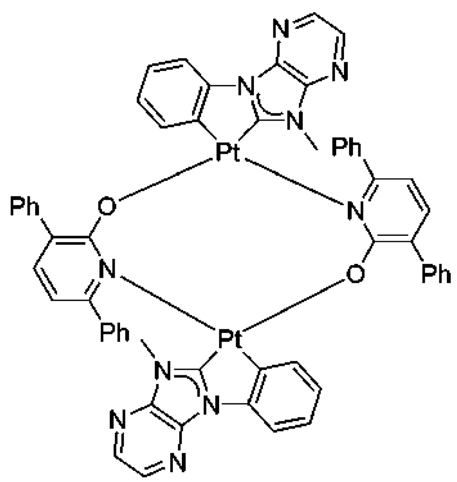

,

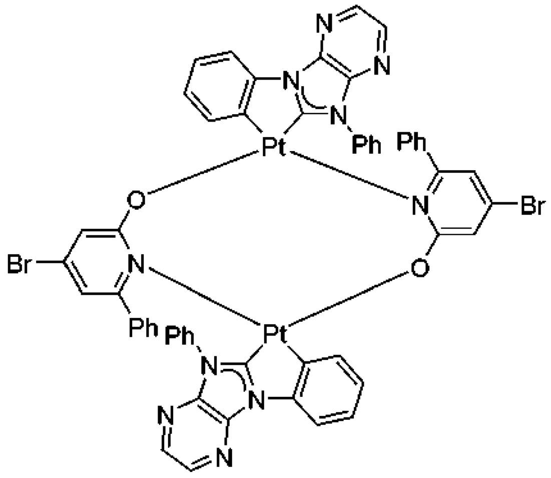

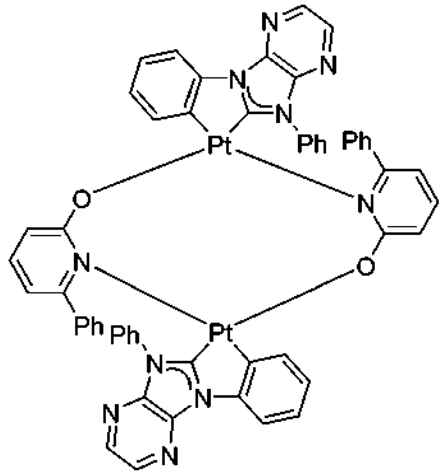

,

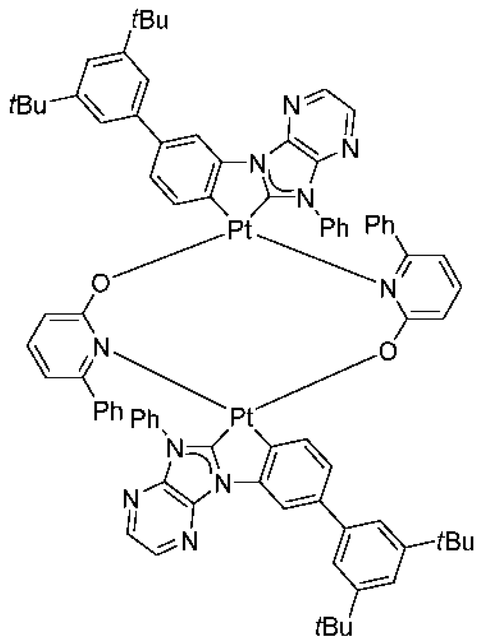

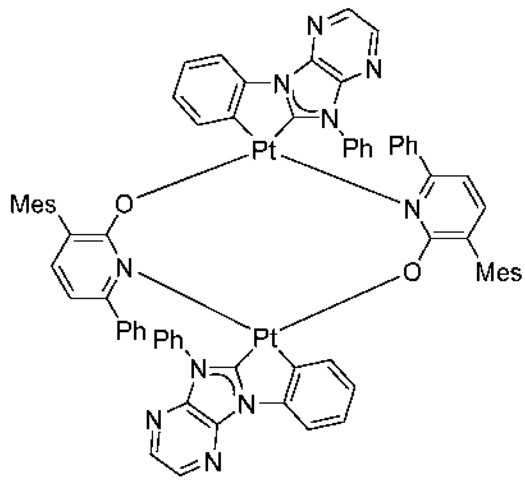

,

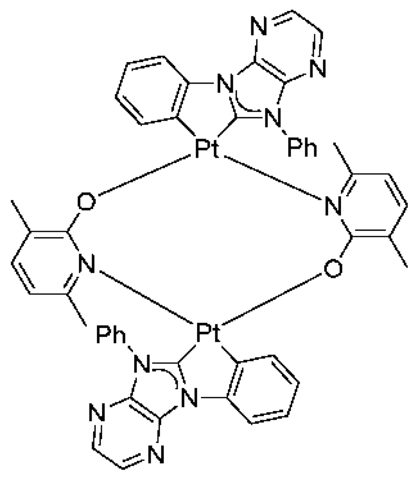

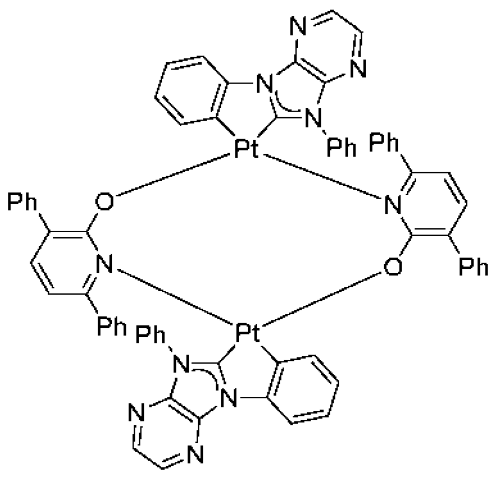

,

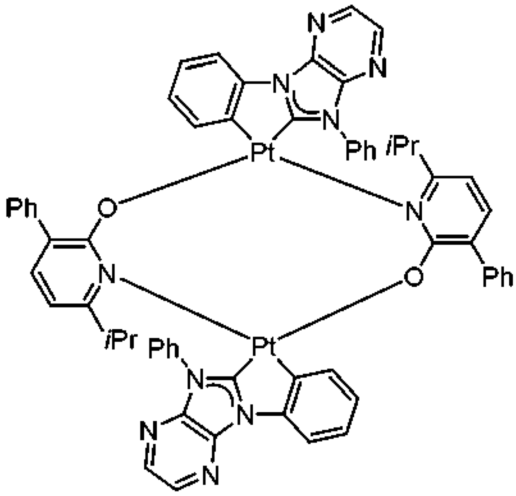

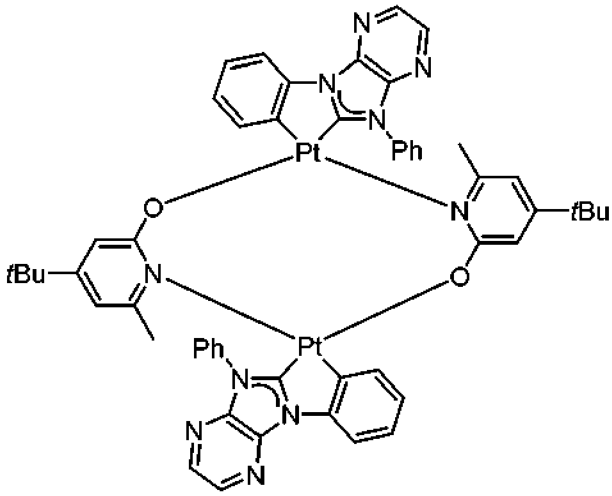

,

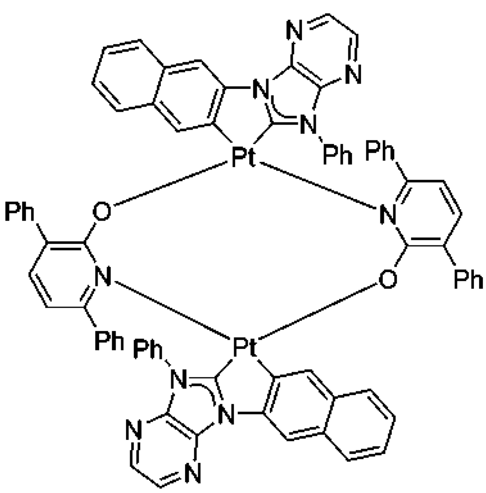

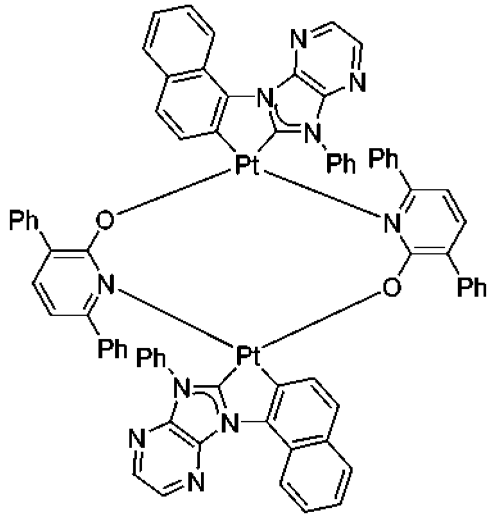

,

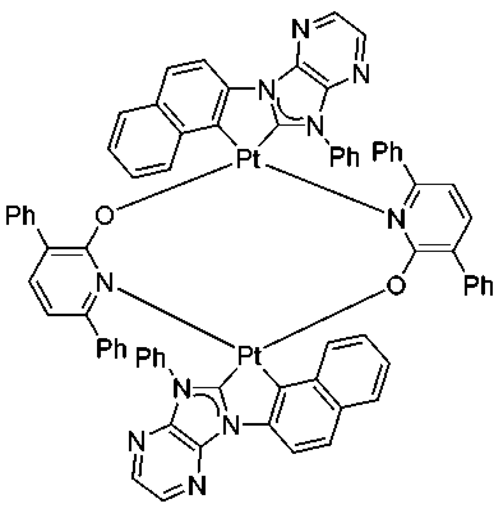

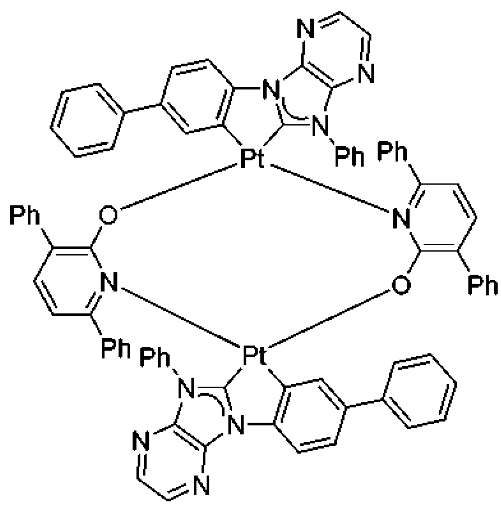

,

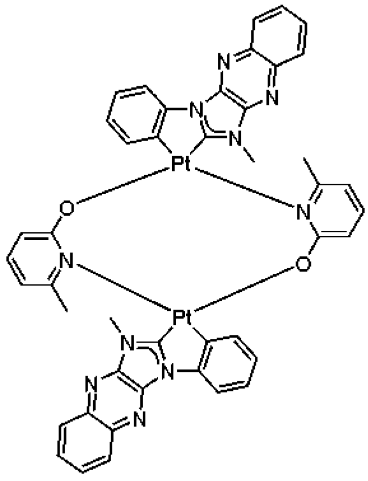

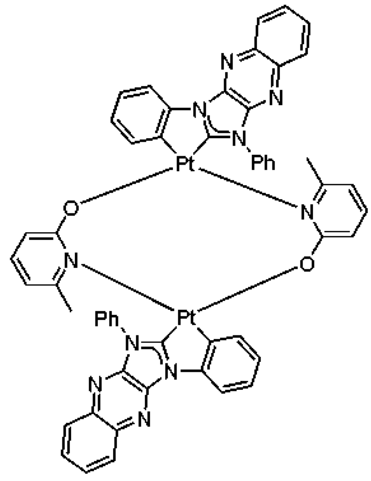

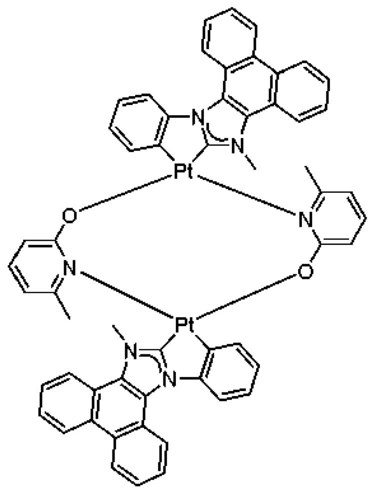

,

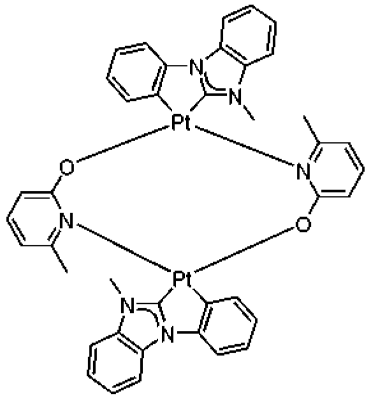

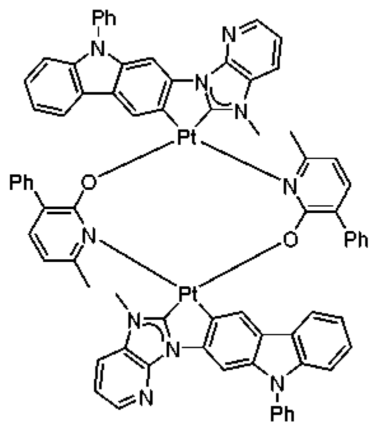

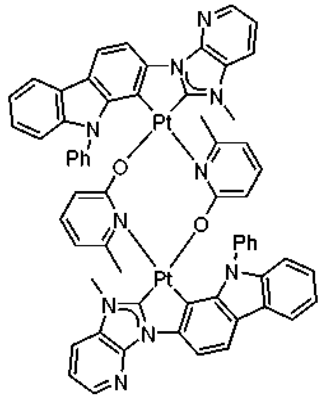

,

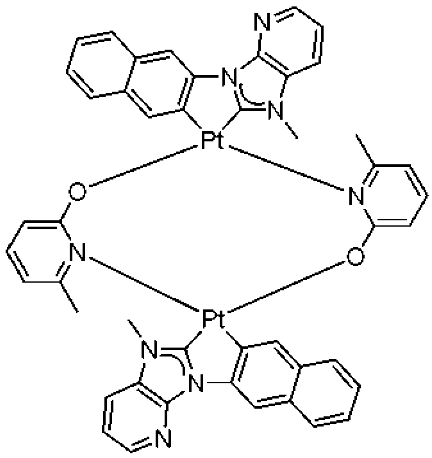

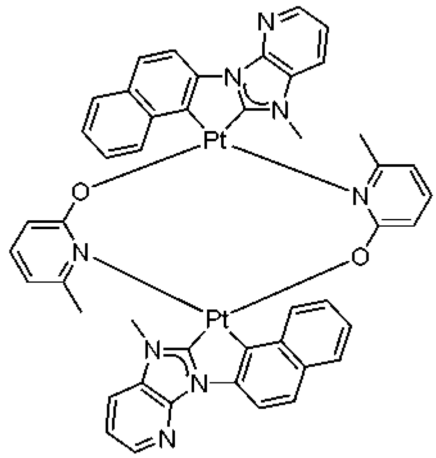

,

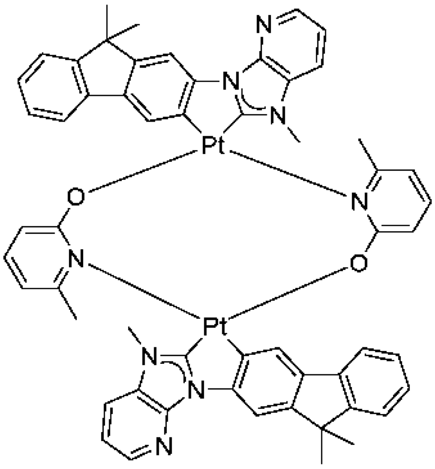

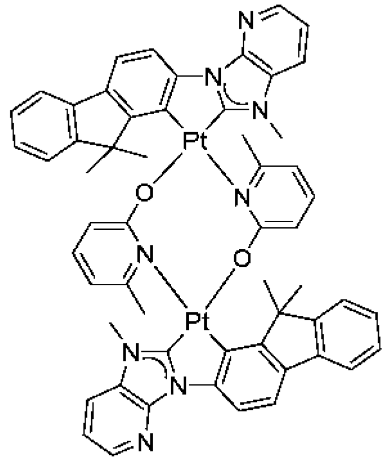

,

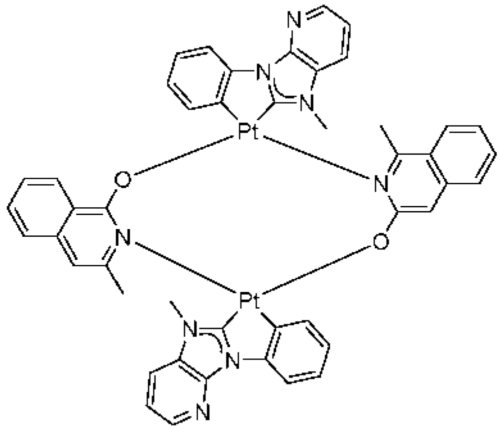

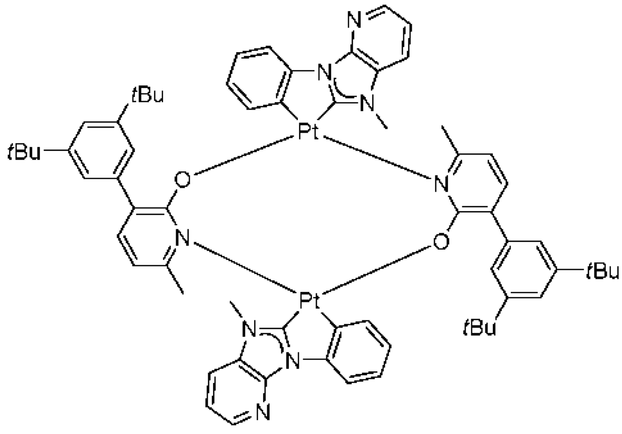

,

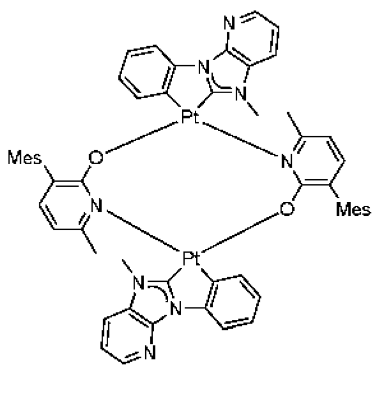

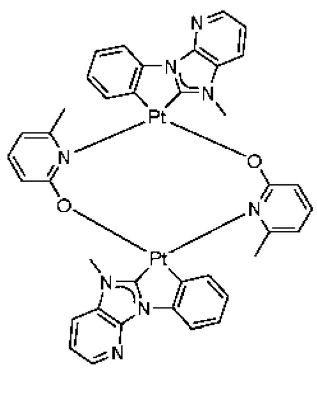

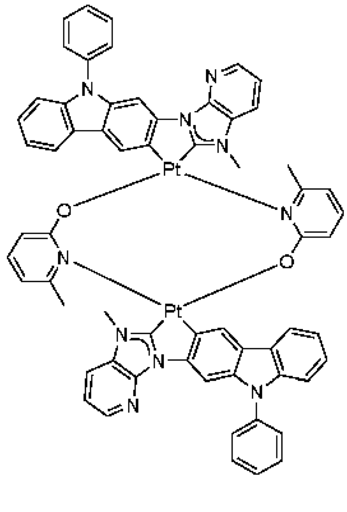

,

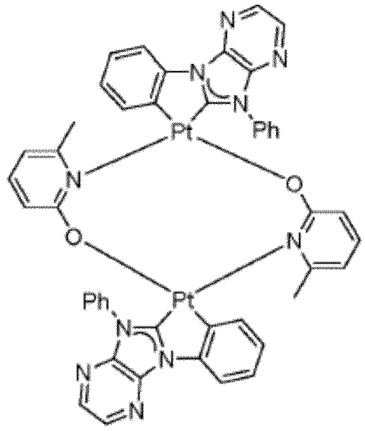

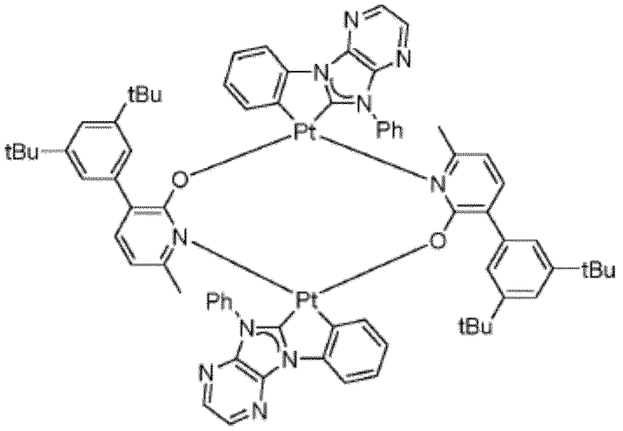

,

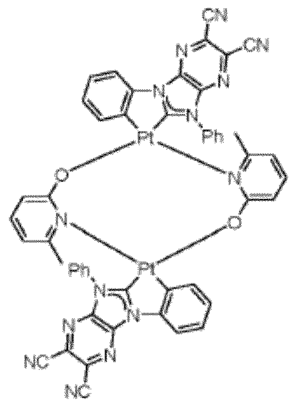

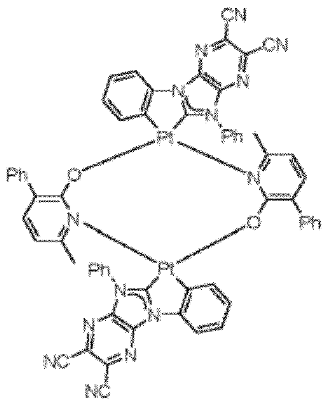

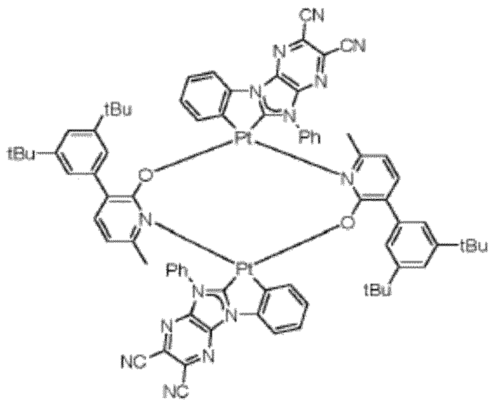

,

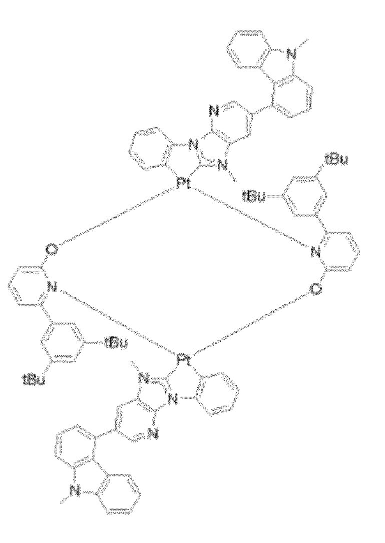

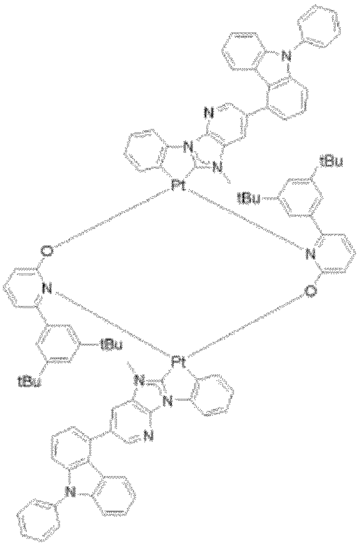

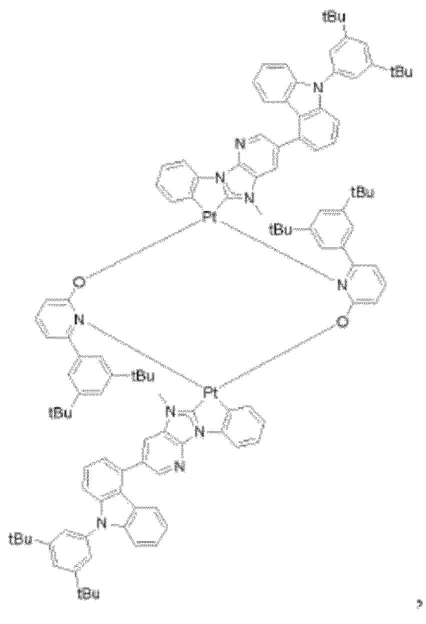

,

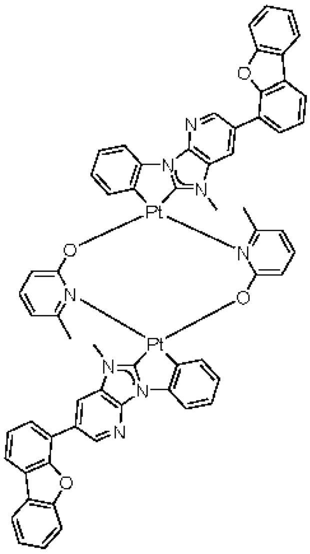

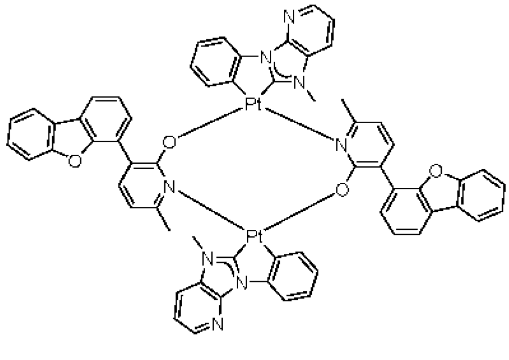

,

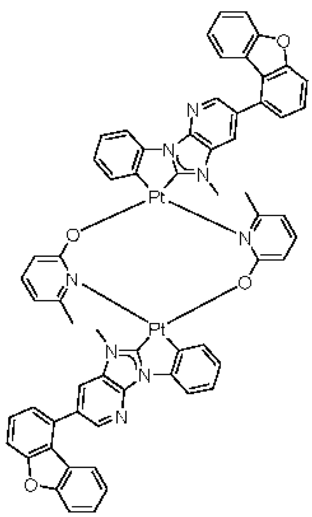

,

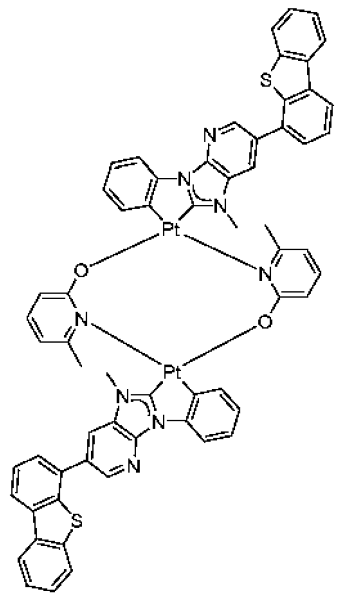

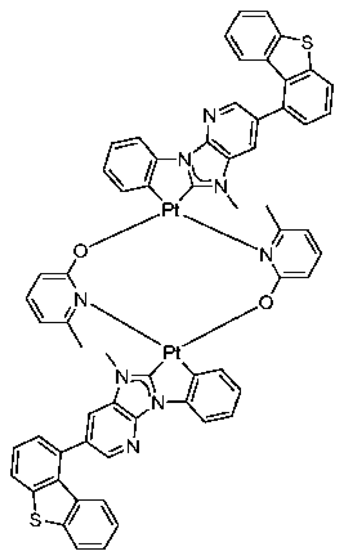

,

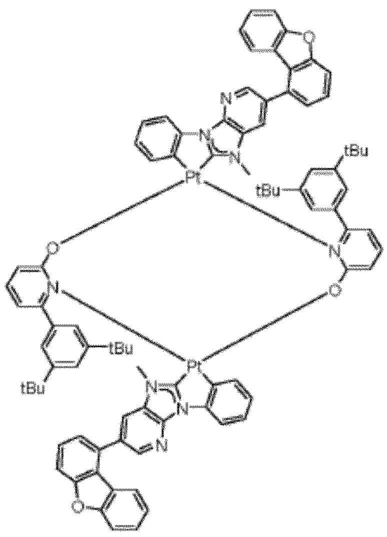
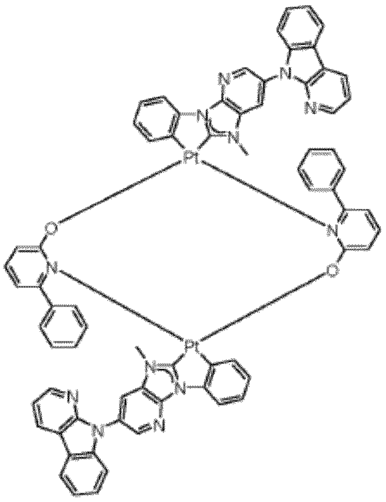
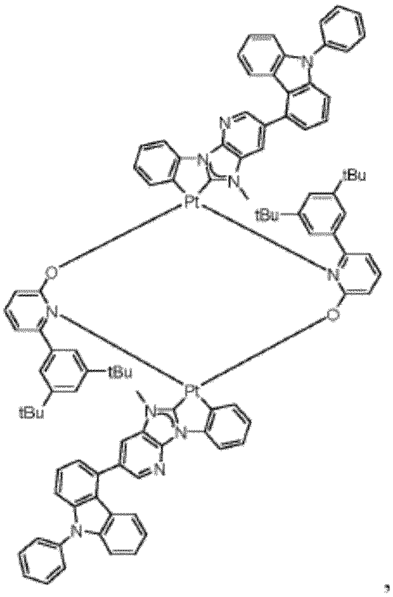
,

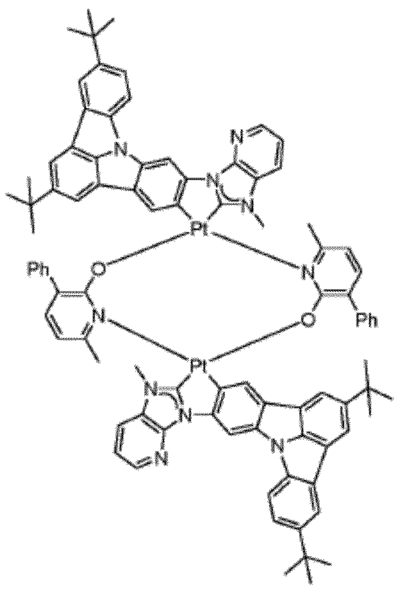
,
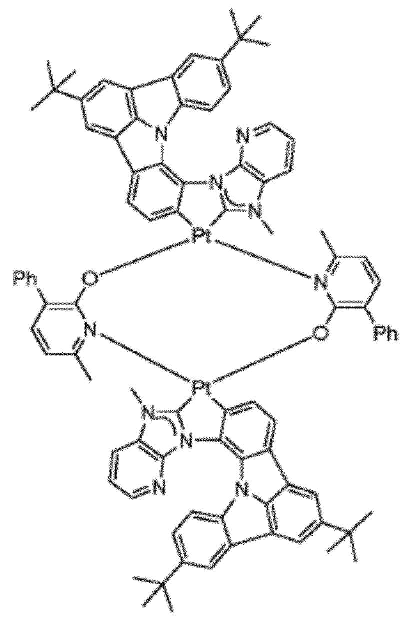
,

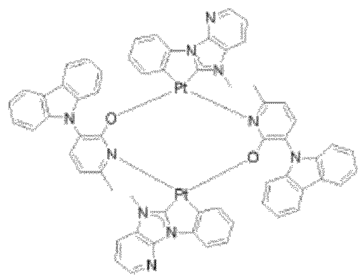
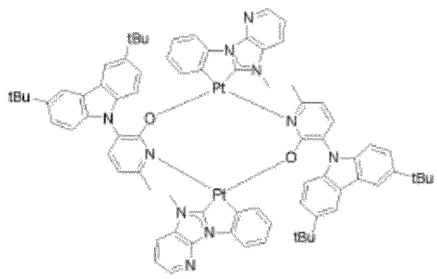
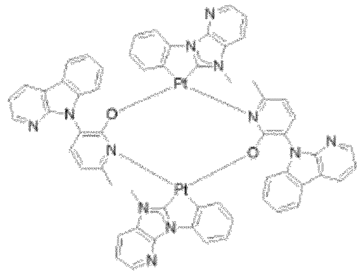
,

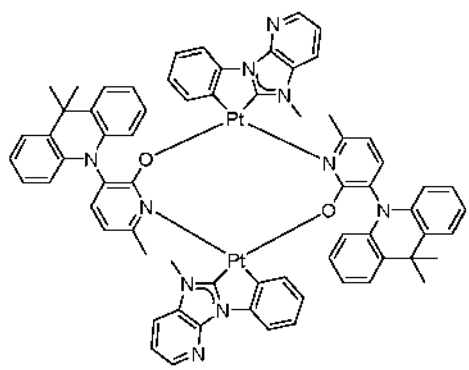

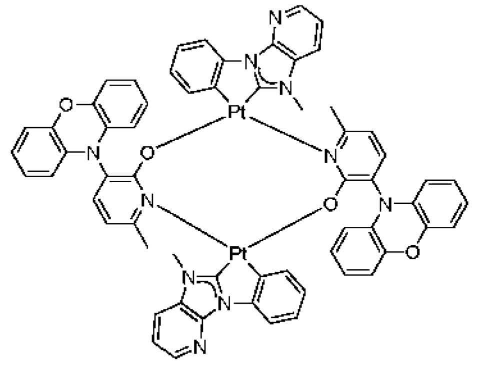

,

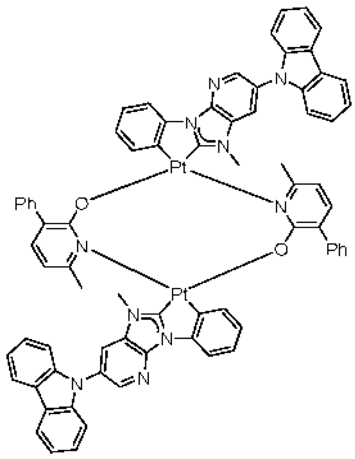

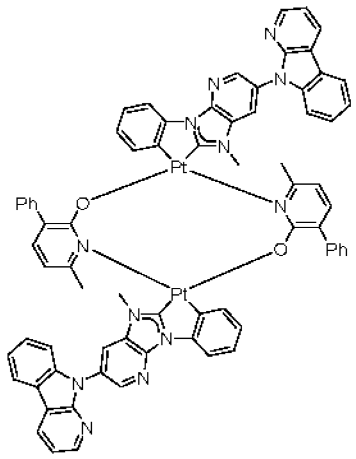

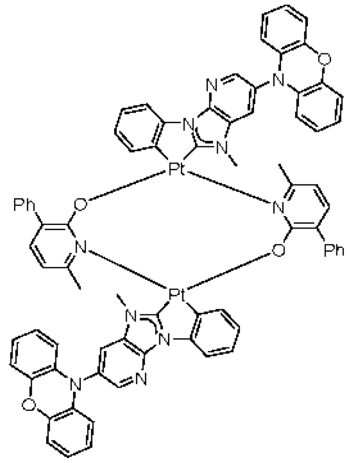

,

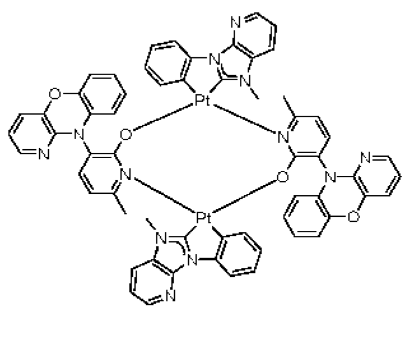

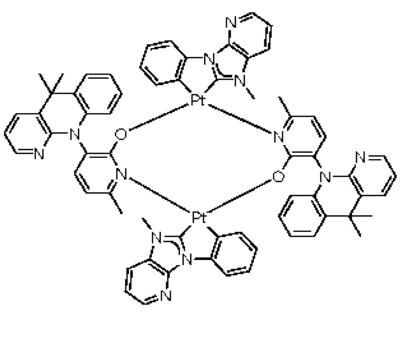

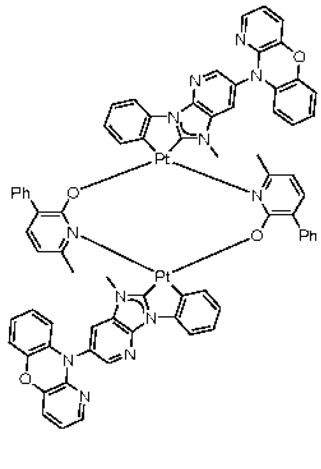

,

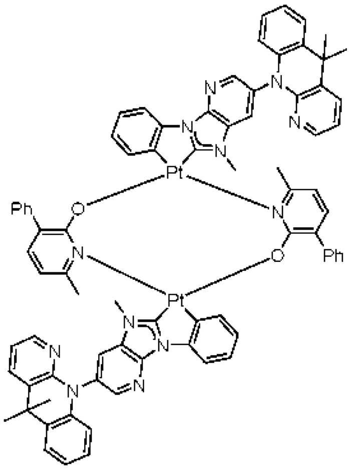
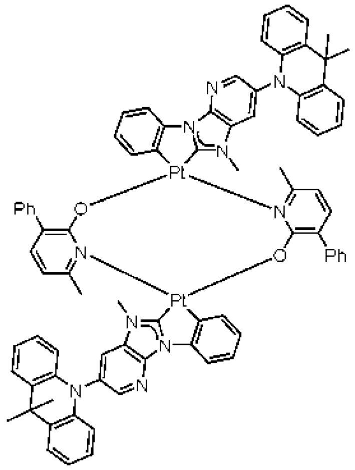
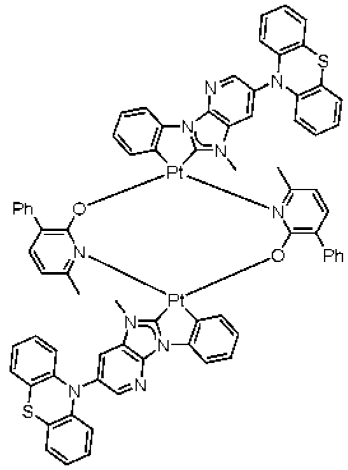
,

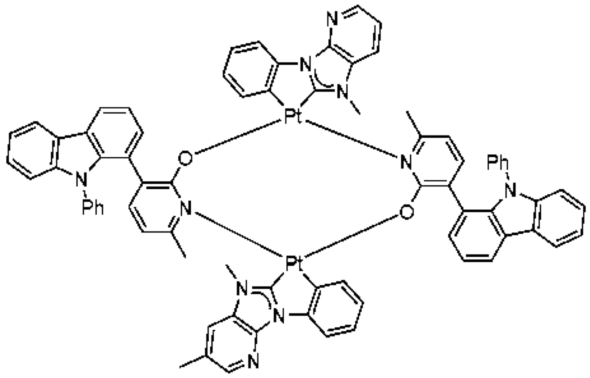
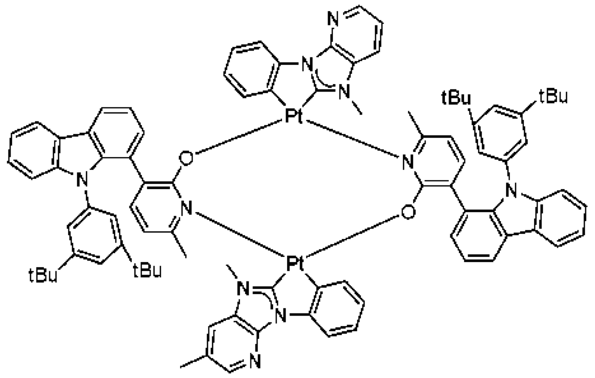
,

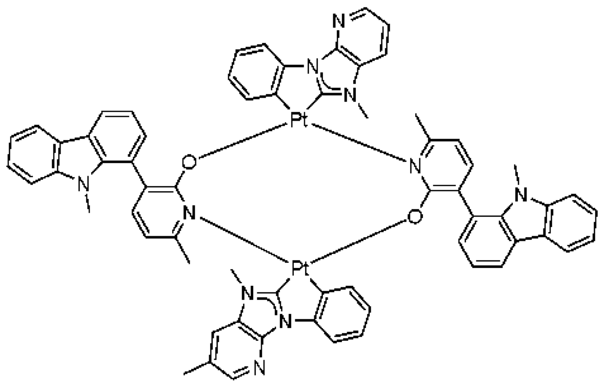
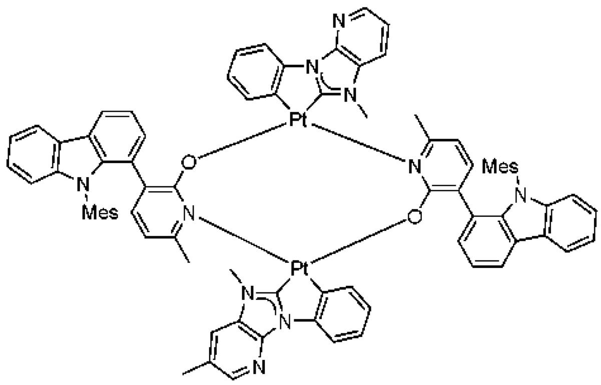

**11.** Organische lichtemittierende Komponente, die eine lichtemittierende Schicht oder zwei oder mehr lichtemittierende Schichten umfasst, wobei die lichtemittierende Schicht oder jede lichtemittierende Schicht von den zwei oder mehr lichtemittierenden Schichten einen oder mehrere dinukleare Platin(II)-Komplexe nach Anspruch 1 umfasst, wobei optional die organische lichtemittierende Komponente Licht in dem roten, tiefroten und/oder NIR-Bereich(en) emittiert.

**12.** Organische lichtemittierende Komponente nach Anspruch 11, wobei

(i) die lichtemittierende Schicht oder jede lichtemittierende Schicht von den zwei oder mehr lichtemittierenden Schichten ferner ein oder mehr Wirtsmaterialien umfasst, und wobei die Gesamtkonzentration von dem einen oder den mehreren Wirtsmaterialien größer als die Gesamtkonzentration von dem einen oder den mehreren Komplexen in der lichtemittierenden Schicht oder jeder lichtemittierenden Schicht von den zwei oder mehr lichtemittierenden Schichten ist, und/oder

(ii) die Gesamtkonzentration von dem einen oder den mehreren dinuklearen Platin(II)-Komplexen in der lichtemittierenden Schicht oder jeder lichtemittierenden Schicht von den zwei oder mehr lichtemittierenden Schichten bis zu 50 Gew.-%, bis zu 40 Gew.-%, bis zu 30 Gew.-%, bis zu 20 Gew.-%, zumindest 1 Gew.-%, in einem Bereich von etwa 1 Gew.-% bis etwa 50 Gew.- %, von etwa 1 Gew.-% bis etwa 40 Gew.-%, von etwa 1 Gew.-% bis etwa 30 Gew.-%, von etwa 1 Gew.-% bis etwa 20 Gew.-%, von etwa 2 Gew.-% bis etwa 50 Gew.-%, von etwa 2 Gew.-% bis etwa 40 Gew.-%, von etwa 2 Gew.-% bis etwa 30 Gew.-%, von etwa 2 Gew.-% bis etwa 20 Gew.- %, von etwa 4 Gew.-% bis etwa 50 Gew.-%, von etwa 4 Gew.-% bis etwa 40 Gew.-%, von etwa 4 Gew.-% bis etwa 30 Gew.-%, von etwa 4 Gew.-% bis etwa 20 Gew.-%, von etwa 1 Gew.-% bis etwa 16 Gew.-%, von etwa 2 Gew.-% bis etwa 16 Gew.-%, von etwa 4 Gew.-% bis etwa 16 Gew.- %, wie etwa 4 Gew.-%, etwa 8 Gew.-% oder etwa 12 Gew.-% ist, und/oder

(iii) die Komponente ferner eine Anode, eine Kathode, einen Lochtransportbereich und einen Elektronentransportbereich umfasst,

wobei der Lochtransportbereich eine Lochinjektionsschicht und/oder eine Lochtransportschicht und optional eine Elektronenblockierschicht umfasst,
wobei der Elektronentransportbereich eine Elektronentransportschicht und/oder eine Elektroneninjektionsschicht und optional eine Lochblockierschicht umfasst,
wobei sich die lichtemittierende Schicht zwischen der Anode und der Kathode befindet,
wobei sich der Lochtransportbereich zwischen der Anode und der lichtemittierenden Schicht befindet, und
wobei sich der Elektronentransportbereich zwischen der Kathode und der lichtemittierenden Schicht befindet, und/oder

(iv) wobei die organische lichtemittierende Komponente eine organische lichtemittierende Diode ("OLED") oder eine lichtemittierende elektrochemische Zelle ("LEEC") ist, und/oder

(v) wobei die lichtemittierende Schicht oder jede von der lichtemittierenden Schicht von den zwei oder mehr lichtemittierenden Schichten durch Vakuumverdampfungsablagerung, Spin-Coating, Tintendruck oder Rolle-zu-Rolle-Druck gebildet ist, und/oder

(vi)

(a) wobei die lichtemittierende Schicht oder jede lichtemittierende Schicht von den zwei oder mehr lichtemittierenden Schichten ferner einen organischen Farbstoff umfasst, und wobei der eine oder die mehreren dinuklearen Platin(II)-Komplexe als Sensibilisator wirkt (wirken), um Energie auf den organischen Farbstoff zu übertragen, oder

(b) wobei die lichtemittierende Schicht oder jede lichtemittierende Schicht von den zwei oder mehr lichtemittierenden Schichten ferner einen organischen Farbstoff umfasst, und wobei der eine oder die mehreren dinuklearen Platin(II)-Komplexe einen höher liegenden Singulett-Zustand als der organische Farbstoff aufweisen.

**13.** Vorrichtung, die eine oder mehrere organische lichtemittierende Komponenten nach Anspruch 11 umfasst, wobei die Vorrichtung eine stationäre visuelle Anzeigeeinheit, eine mobile visuelle Anzeigeeinheit, eine Beleuchtungsvorrichtung, eine tragbare Vorrichtung, eine Phototherapievorrichtung oder eine medizinische Überwachungsvorrichtung ist.

## Revendications

**1.** Complexe dinucléaire de platine(II) comportant une structure :

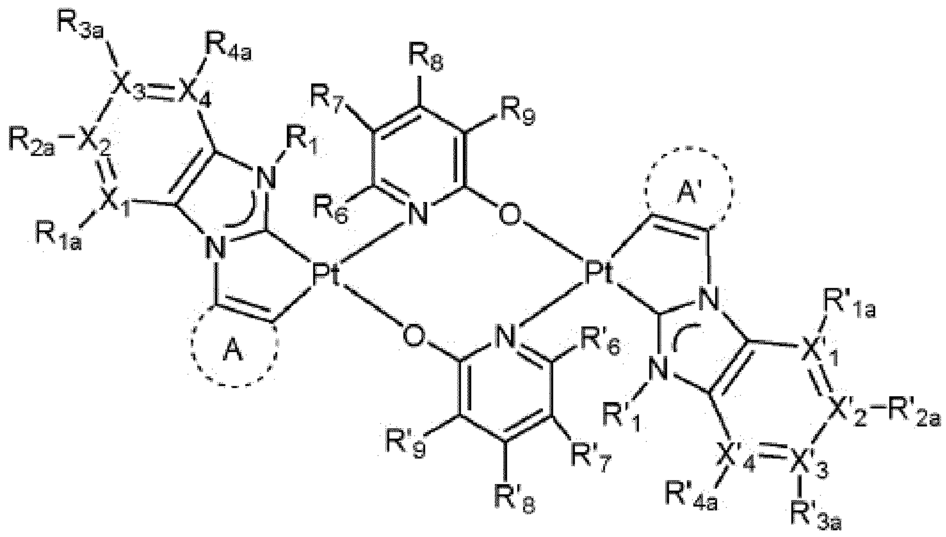

Formule I'

dans lequel :

(i) le complexe est une charge globale neutre, négative ou positive ;
(ii) $X_1$-$X_4$ et $X'_1$-$X'_4$ sont indépendamment carbone, azote, soufre ou oxygène ;
(iii) $R_{1a}$-$R_{4a}$, $R'_{1a}$-$R'_{4a}$, $R_1$, $R'_1$, $R_6$-$R_9$ et $R'_6$-$R'_9$ sont indépendamment absents, hydrogène, alkyle substitué, alkyle non substitué, alcényle substitué, alcényle non substitué, alkynyle substitué, alkynyle non substitué, aryle substitué, aryle non substitué, halogène, hydroxyle, amino, amido, éther, thiol, cyano, nitro, alkoxy non substitué, alkoxy substitué, hétéroaryle non substitué, hétéroaryle substitué, polyhétéroaryle non substitué, polyhétéroaryle substitué, carbonyle non substitué, carbonyle substitué, ester non substitué, ester substitué, $C_2$-$C_{20}$ hétérocyclyle substitué, $C_2$-$C_{20}$ hétérocyclyle non substitué, cation de borénium, phosphonyle, sulfinyle ou sulfonyle, ou $R_{1a}$ et $R_{2a}$ conjointement, $R_{2a}$ et $R_{3a}$ conjointement, $R_{3a}$ et $R_{4a}$ conjointement, $R'_{1a}$ et $R'_{2a}$ conjointement, $R'_{2a}$ et $R'_{3a}$ conjointement, $R'_{3a}$ et $R'_{4a}$ conjointement, $R_6$ et $R_7$ conjointement, $R_7$ et $R_8$ conjointement, $R_8$ et $R_9$ conjointement, $R'_6$ et $R'_7$ conjointement, $R'_7$ et $R'_8$ conjointement, et/ou $R'_8$ et $R'_9$ conjointement avec l'atome auquel ils sont liés, forment un cycloalkyle substitué, un cycloalkyle non substitué, un cycloalcényle substitué, un cycloalcényle non substitué, un cycloalkynyle substitué, un cycloalkynyle non substitué, un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un hétérocyclyle substitué, un hétérocyclyle non substitué, des combinaisons fusionnées de ceux-ci, ou $R_{1a}$ et $R_{2a}$ conjointement, $R_{2a}$ et $R_{3a}$ conjointement, $R_{3a}$ et $R_{4a}$ conjointement, $R'_{1a}$ et $R'_{2a}$ conjointement, $R'_{2a}$ et $R'_{3a}$ conjointement, $R'_{3a}$ et $R'_{4a}$ conjointement, $R_6$ et $R_7$ conjointement, $R_7$ et $R_8$ conjointement, $R_8$ et $R_9$ conjointement, $R'_6$ et $R'_7$ conjointement, $R'_7$ et $R'_8$ conjointement, et/ou $R'_3$ et $R'_9$ conjointement avec l'atome auquel ils sont liés, forment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un hétérocyclyle substitué, un hétérocyclyle non substitué, ou des combinaisons fusionnées de ceux-ci ;
(iv) A et A' sont indépendamment un cycloalkyle substitué, un cycloalkyle non substitué, un cycloalcényle substitué, un cycloalcényle non substitué, un cycloalkynyle substitué, un cycloalkynyle non substitué, un hétérocyclyle substitué, un hétérocyclyle non substitué, un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, ou des combinaisons fusionnées de ceux-ci ; de préférence A et A' sont indépendamment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un hétérocyclyle substitué, un héterocyclyle non substitué, ou des combinaisons fusionnées de ceux-ci ; et
(v) chaque substituant est indépendamment un alkyle substitué ou non substitué, un alcényle substitué ou non substitué, un alkynyle substitué ou non substitué, un hétérocyclyle substitué ou non substitué, un aryle substitué ou non substitué, un hétéroaryle substitué ou non substitué, un polyaryle substitué ou non substitué, un

polyhétéroaryle substitué ou non substitué, un aralkyle substitué ou non substitué, un carbonyle, un alkoxy, un halogène, un hydroxyle, un phénoxy, un thiol, un alkylthio, un phénylthio, un arylthio, un cyano, un isocyano, un nitro, un carboxyle, un amino, un amido, un oxo, un silyle, un sulfinyle, un sulfonyle, un acide sulfonique, un phosphonium, un phosphanyle, un phosphoryle ou un phosphonyle.

**2.** Complexe dinucléaire de platine(II) selon la revendication 1, dans lequel le dinucléaire de platine(II) comporte une structure :

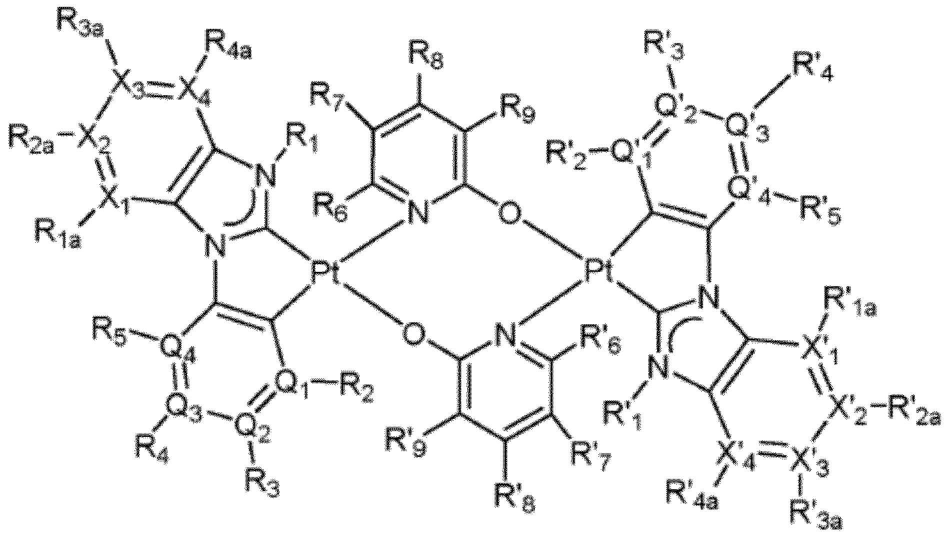

ou

Formule I

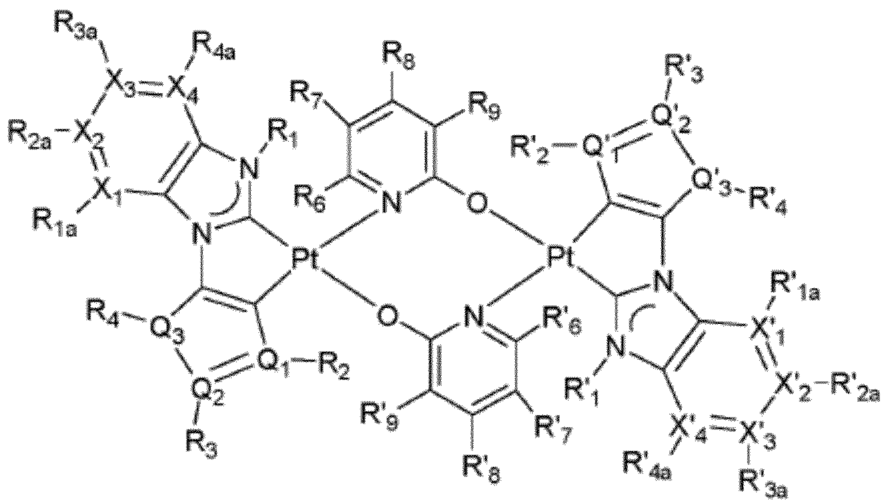

,

Formule Ia

dans lequel :

(i) le complexe comporte une charge globale neutre, négative ou positive ;
(ii) $Q_1$-$Q_4$ et $Q'_1$-$Q'_4$ sont indépendamment carbone, azote, soufre ou oxygène ; et
(iii) $R_2$-$R_5$ et $R'_2$-$R'_5$ sont indépendamment absents, hydrogène, alkyle substitué, alkyle non substitué, alcényle substitué, alcényle non substitué, alkynyle substitué, alkynyle non substitué, aryle substitué, aryle non substitué, halogène, hydroxyle, amino, amido, éther, thiol, cyano, nitro, alkoxy non substitué, alkoxy substitué, hétéroaryle non substitué, hétéroaryle substitué, polyhétéroaryle non substitué, polyhétéroaryle substitué, carbonyle non

substitué, carbonyle substitué, ester non substitué, ester substitué, $C_2$-$C_{20}$ hétérocyclyle substitué ou $C_2$-$C_{20}$ hétérocyclyle non substitué, cation de borénium, phosphonyle, sulfinyle ou sulfonyle, ou $R_2$ et $R_3$ conjointement, $R_3$ et $R_4$ conjointement, $R_4$ et $R_5$ conjointement, $R'_2$ et $R'_3$ conjointement, $R'_3$ et $R'_4$ conjointement, et/ou $R'_4$ et $R'_5$ conjointement avec l'atome auquel ils sont liés, forment un cycloalkyle substitué, un cycloalkyle non substitué, un cycloalcényle substitué, un cycloalcényle non substitué, un cycloalkynyle substitué, un cycloalkynyle non substitué, un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un hétérocyclyle substitué, un hétérocyclyle non substitué, des combinaisons fusionnées de ceux-ci, ou $R_2$ et $R_3$ conjointement, $R_3$ et $R_4$ conjointement, $R_4$ et $R_5$ conjointement, $R'_2$ et $R'_3$ conjointement, $R'_3$ et $R'_4$ conjointement, et/ou $R'_4$ et $R'_5$ conjointement avec l'atome auquel ils sont liés, forment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un hétérocyclyle substitué, un hétérocyclyle non substitué, ou des combinaisons fusionnées de ceux-ci.

**3.** Complexe selon la revendication 1, ledit complexe comportant une structure :

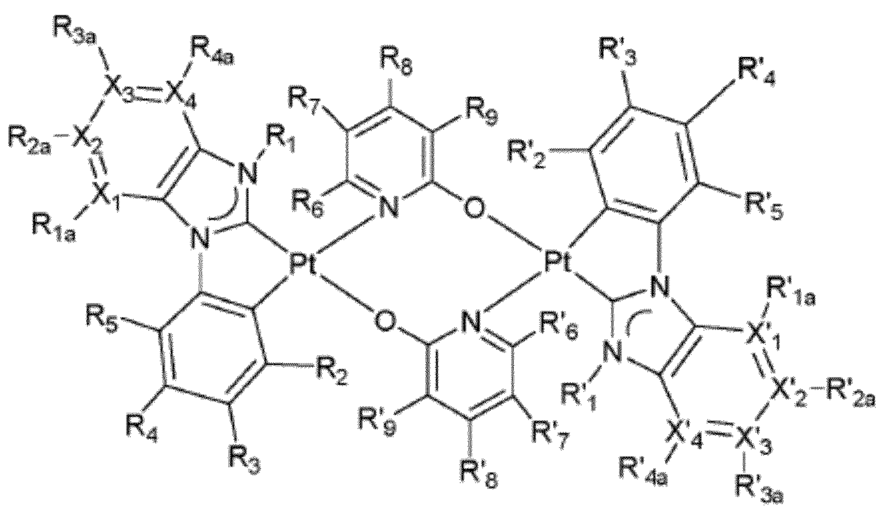

Formule II

ou

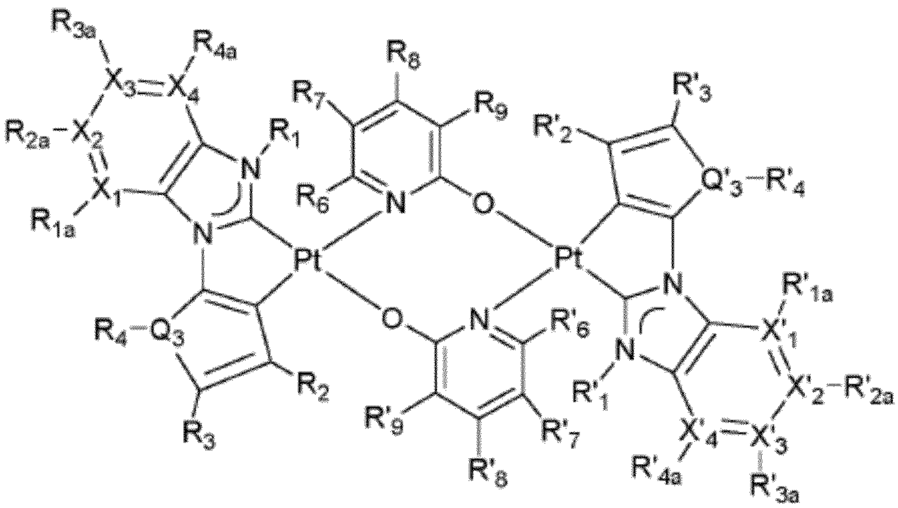

,

Formule IIa

ou

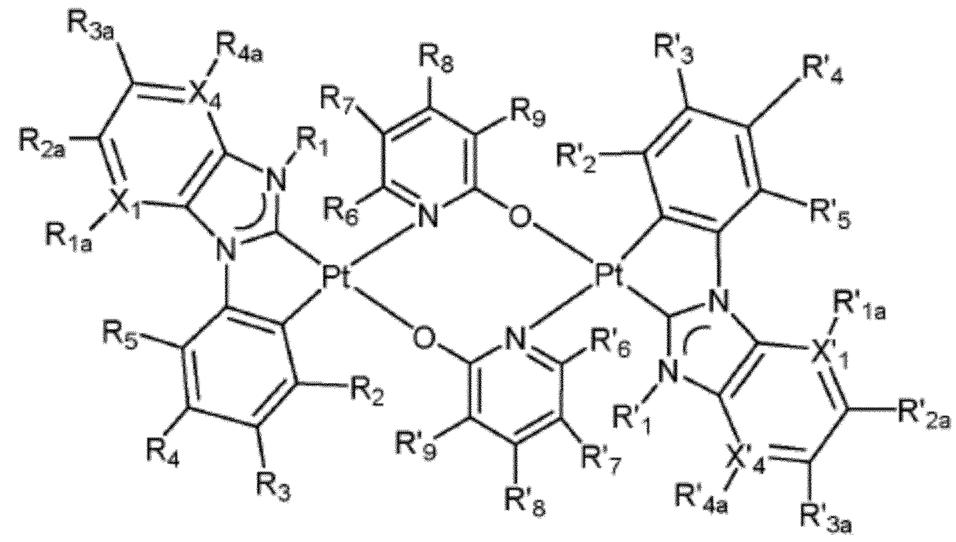

Formule III

ou

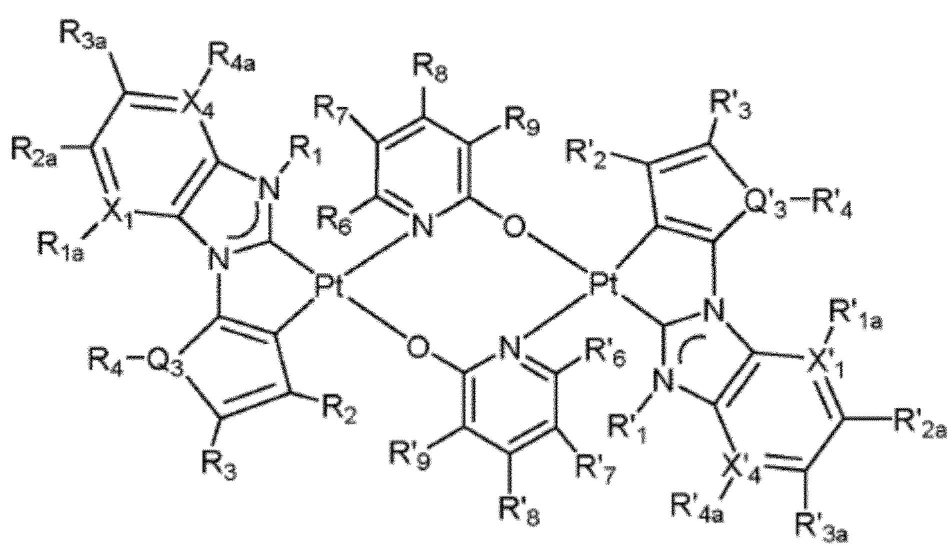

,

Formule IIIa

ou

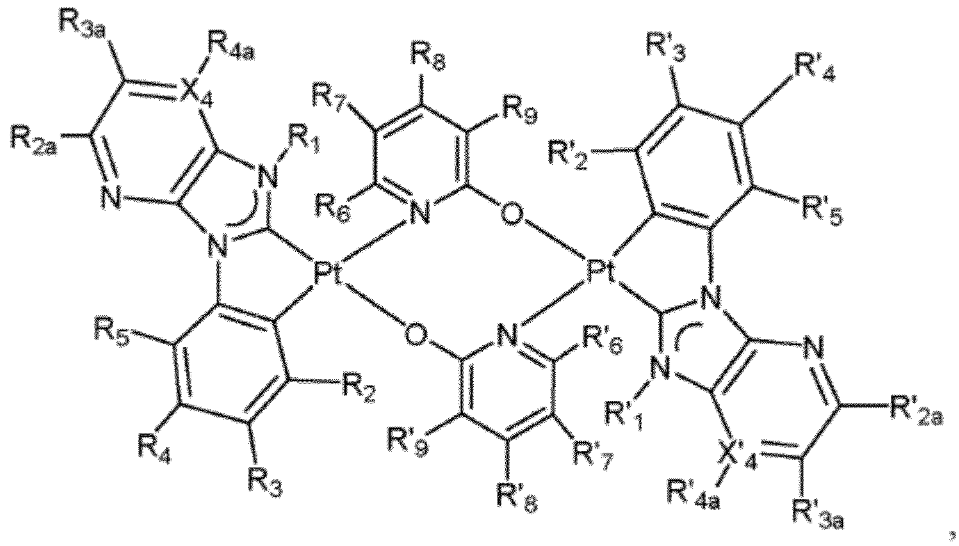

Formule IV

ou

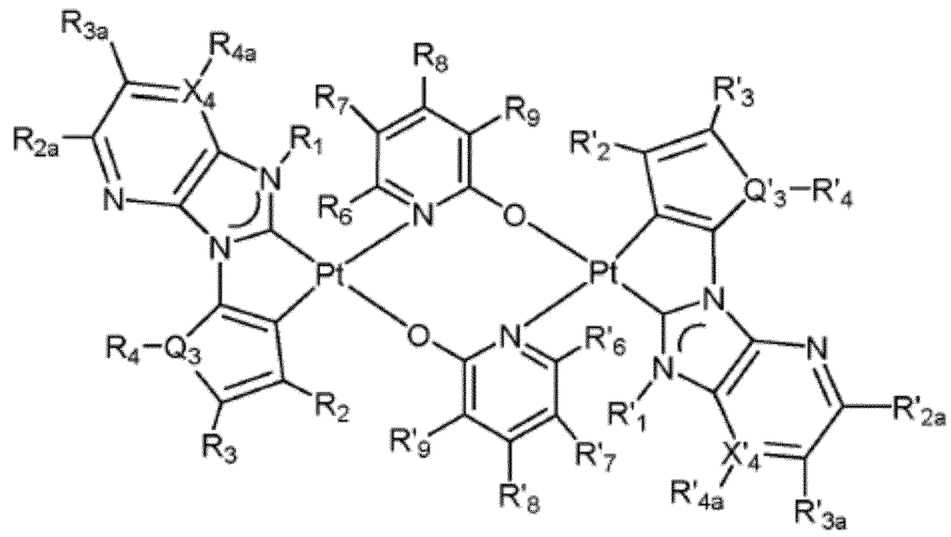

Formule IVa.

**4.** Complexe selon la revendication 1, dans lequel :

(i) $X_4$ et $X'_4$ sont carbone ; et $R_{4a}$ et $R'_{4a}$ sont indépendamment hydrogène, alkyle substitué, alkyle non substitué, aryle substitué, aryle non substitué, hydroxyle, hétéroaryle non substitué, hétéroaryle substitué, polyaryle non substitué, polyaryle substitué, polyhétéroaryle non substitué, polyhétéroaryle substitué, $C_2$-$C_{20}$ hétérocyclyle substitué ou $C_2$-$C_{20}$ hétérocyclyle non substitué, éventuellement dans lequel $X_4$ et $X'_4$ sont carbone et $R_{4a}$ et $R'_{4a}$ sont indépendamment hydrogène, alkyle non substitué, aryle non substitué, polyaryle non substitué, hydroxyle, hétéroaryle non substitué, polyhétéroaryle non substitué, $C_2$-$C_{20}$ hétérocyclyle non substitué ou alkylaryle non substitué, tel que hydrogène ; ou

(ii) $X_4$ et $X'_4$ sont azote ; $R_{4a}$ et $R'_{4a}$ sont absents, et éventuellement dans lequel $R_{2a}$, $R_{3a}$, $R'_{2a}$ et $R'_{3a}$ sont indépendamment hydrogène, alkyle non substitué (par ex., méthyle, éthyle, n-propyle, isopropyle, n-butyle, sec-butyle, isobutyle, tert-butyle, etc.), alkyle substitué, aryle non substitué (par ex., phényle non substitué), ou alkoxy (par ex., -O-alkyle, -O-aryle, -O-polyaryle, etc.), ou $R_{2a}$ et $R_{3a}$ conjointement et/ou $R'_{2a}$ et $R'_{3a}$ conjointement avec l'atome auquel ils sont liés, forment un aryle substitué, un aryle non substitué, un hétéroaryle substitué, un hétéroaryle non substitué, un polyaryle substitué, un polyaryle non substitué, un polyhétéroaryle substitué, un

polyhétéroaryle non substitué, un hétérocyclyle substitué, un hétérocyclyle non substitué, ou des combinaisons fusionnées de ceux-ci, par exemple un aryle substitué ou un aryle non substitué ; ou

(iii) $X_1$-$X_4$ et $X'_1$-$X'_4$ sont carbone ; et $R_{1a}$-$R_{4a}$ et $R'_{1a}$-$R'_{4a}$ sont indépendamment hydrogène, alkyle non substitué (par ex., méthyle, éthyle, n-propyle, isopropyle, n-butyle, sec-butyle, isobutyle, tert-butyle, etc.), alkyle substitué, aryle non substitué (par ex., phényle non substitué), ou alkoxy (par ex., -O-alkyle, -O-aryle, -O-polyaryle, etc.), ou $R_{1a}$ et $R_{2a}$ conjointement, $R_{2a}$ et $R_{3a}$ conjointement, $R_{3a}$ et $R_{4a}$ conjointement, $R'_{1a}$ et $R'_{2a}$ conjointement, $R'_{2a}$ et $R'_{3a}$ conjointement, et/ou $R'_{3a}$ et $R'_{4a}$ conjointement avec l'atome auquel ils sont liés, forment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un hétérocyclyle substitué, un hétérocyclyle non substitué, ou des combinaisons fusionnées de ceux-ci, tel qu'un aryle substitué ou un aryle non substitué, par exemple, $R_{1a}$ et $R_{2a}$ conjointement, $R_{3a}$ and $R_{4a}$ conjointement, $R'_{1a}$ et $R'_{2a}$ conjointement, et $R'_{3a}$ et $R'_{4a}$ conjointement avec l'atome auquel ils sont liés, forment un aryle substitué ou un aryle non substitué, ou $R_{2a}$ et $R_{3a}$ conjointement et $R'_{2a}$ et $R'_{3a}$ conjointement avec l'atome auquel ils sont liés, forment un aryle substitué ou un aryle non substitué.

**5.** Complexe selon la revendication 2, dans lequel $R_1$-$R_9$ et $R'_1$-$R'_9$ sont indépendamment hydrogène, halogène, alkyle non substitué (par ex., méthyle, éthyle, n-propyle, isopropyle, n-butyle, sec-butyle, isobutyle, tert-butyle, etc.), alkyle substitué, aryle non substitué, aryle substitué (par ex., mésitylène ou autre aryle substitué par un ou plusieurs alkyles, par exemple méthyle, éthyle, n-propyle, isopropyle, n-butyle, sec-butyle, isobutyle, tert-butyle, etc.), polyaryle non substitué, polyaryle substitué, hydroxyle, hétéroaryle non substitué, hétéroaryle substitué, polyhétéroaryle non substitué, polyhétéroaryle substitué, $C_2$-$C_{20}$ hétérocyclyle non substitué, $C_2$-$C_{20}$ hétérocyclyle substitué, alkylaryle non substitué, alkylaryle substitué, alkoxy (par ex., -O-alkyle, -O-aryle, -O-polyaryle, etc.), cation de borénium (par ex., $-B(Mes)_2$), phosphonyle (par ex., $-P(=O)(Ph)_2$, $-P(=O)(alkyl)_2$, etc.), ou sulfinyle (par ex., $-S(=O)(Ph)_2$, $-S(=O)(alkyl)_2$, etc.), ou sulfonyle $-S(=O)_2(Ph)_2$, $-S(=O)_2(alkyl)_2$, etc.), ou $R_2$ et $R_3$ conjointement, $R'_2$ et $R'_3$ conjointement, $R_3$ et $R_4$ conjointement, $R'_3$ et $R'_4$ conjointement, $R_4$ et $R_5$ conjointement, $R'_4$ et $R'_5$ conjointement, $R_6$ et $R_7$ conjointement, $R_7$ et $R_8$ conjointement, $R_8$ et $R_9$ conjointement, $R'_6$ et $R'_7$ conjointement, $R'_7$ et $R'_3$ conjointement, et/ou $R'_8$ et $R'_9$ conjointement avec l'atome auquel ils sont liés, forment un aryle substitué, un aryle non substitué, un hétéroaryle substitué, un hétéroaryle non substitué, un polyaryle substitué, un polyaryle non substitué, un polyhétéroaryle substitué, un polyhétéroaryle non substitué, un hétérocyclyle substitué, un hétérocyclyle non substitué, ou des combinaisons fusionnées de ceux-ci.

**6.** Complexe selon la revendication 5, dans lequel un ou plusieurs $R_1$-$R_9$ et $R'_1$-$R'_9$ est (sont)

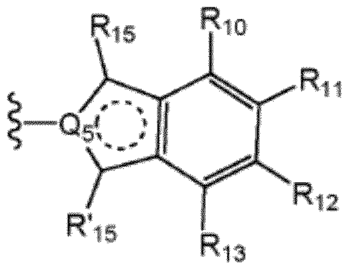

ou

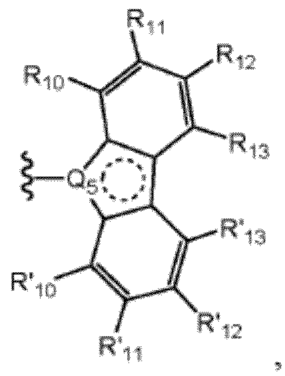

,

dans lequel $Q_5$ est azote ou carbone ; et $R_{10}$-$R_{13}$, $R_{15}$, $R'_{15}$ et $R'_{10}$-$R'_{13}$ sont indépendamment absents, hydrogène, alkyle substitué, alkyle non substitué, alcényle substitué, alcényle non substitué, alkynyle substitué, alkynyle non substitué, aryle substitué, aryle non substitué, halogène, hydroxyle, amino, amido, éther, thiol, cyano, nitro, alkoxy non substitué, alkoxy substitué, aroxy non substitué, aroxy substitué, hétéroaryle non substitué, hétéroaryle substitué, polyhétéroaryle non substitué, polyhétéroaryle substitué, carbonyle non substitué, carbonyle substitué, ester non substitué, ester substitué, $C_2$-$C_{20}$ hétérocyclyle substitué ou $C_2$-$C_{20}$ hétérocyclyle non substitué, éventuellement

dans lequel $Q_5$ est azote ; et $R_{10}$-$R_{13}$, $R_{15}$, $R'_{15}$ et $R'_{10}$-$R'_{13}$ sont indépendamment absents, hydrogène, alkyle substitué, alkyle non substitué, groupe phényle substitué, phényle non substitué, alkoxy, halogène, cation de borénium (par ex., $-B(Mes)_2$), phosphonyle ou sulfinyle, par exemple hydrogène.

7. Complexe selon la revendication 2, dans lequel : (i) $R_2$ et $R_3$ conjointement et/ou $R'_2$ et $R'_3$ conjointement, ou (ii) $R_3$ et $R_4$ conjointement et/ou $R'_3$ et $R'_4$ conjointement, ou (iii) $R_4$ et $R_5$ conjointement et/ou $R'_4$ et $R'_5$ conjointement avec l'atome auquel ils sont liés, forment un cycloalkyle substitué, un cycloalkyle non substitué, un cycloalcényle substitué, un cycloalcényle non substitué, un cycloalkynyle substitué, un cycloalkynyle non substitué, un aryle substitué, un aryle non substitué, un hétéroaryle substitué, un hétéroaryle non substitué, éventuellement dans lequel : (a) $R_2$ et $R_3$ conjointement et/ou $R'_2$ et $R'_3$ conjointement, ou

(b) $R_3$ et $R_4$ conjointement et/ou $R'_3$ et $R'_4$ conjointement, ou
(c) $R_4$ et $R_5$ conjointement et/ou $R'_4$ et $R'_5$ conjointement, forment

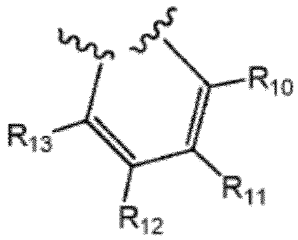

ou

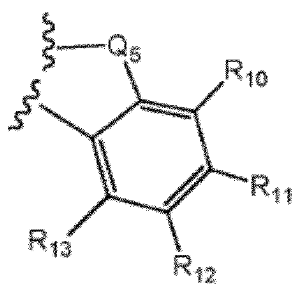

,

dans lequel $Q_5$ est $NR_{14}$, $CR_{16}R_{17}$, ou soufre, ou oxygène ; et $R_{10}$-$R_{14}$, $R_{16}$, et $R_{17}$ sont indépendamment absents, hydrogène, alkyle substitué, alkyle non substitué, alcényle substitué, alcényle non substitué, alkynyle substitué, alkynyle non substitué, aryle substitué, aryle non substitué, halogène, hydroxyle, amino, amido, éther, thiol, cyano, nitro, alkoxy non substitué, alkoxy substitué, aroxy non substitué, aroxy substitué, hétéroaryle non substitué, hétéroaryle substitué, polyhétéroaryle non substitué, polyhétéroaryle substitué, carbonyle non substitué, carbonyle substitué, ester non substitué, ester substitué, $C_2$-$C_{20}$ hétérocyclyle substitué, ou $C_2$-$C_{20}$ hétérocyclyle non substitué, éventuellement dans lequel $Q_5$ est $NR_{14}$, $CR_{16}R_{17}$, soufre ou oxygène, par exemple oxygène ; et $R_{10}$-$R_{14}$, $R_{16}$ et $R_{17}$ sont indépendamment absents, hydrogène, alkyle substitué, alkyle non substitué, groupe phényle substitué, phényle non substitué, alkoxy, halogène, cation de borénium (par ex., -$B(Mes)_2$), phosphonyle ou sulfinyle, par exemple hydrogène ou alkyle non substitué.

8. Complexe selon la revendication 2, dans lequel $R_6$-$R_9$ et $R'_6$-$R'_9$ sont indépendamment hydrogène, halogène, alkyle non substitué (par ex., méthyle, éthyle, n-propyle, isopropyle, n-butyle, sec-butyle, isobutyle, tert-butyle, etc.), alkyle substitué, aryle non substitué (par ex., phényle non substitué), aryle substitué (par ex., mésitylène ou autre aryle substitué par un ou plusieurs alkyles, par exemple méthyle, éthyle, n-propyle, isopropyle, n-butyle, sec-butyle, isobutyle, tert-butyle, etc.), cation de borénium (par ex., -B(Mes)2), phosphonyle (par ex., - P(=O)(Ph)2, -P(=O)(alkyl) 2, etc.), hétéroaryle substitué ou hétéroaryle non substitué, ou $R_6$ et $R_7$ conjointement, $R_7$ et $R_8$ conjointement, $R_8$ et $R_9$ conjointement, $R'_6$ et $R'_7$ conjointement, $R'_7$ et $R'_8$ conjointement, et/ou $R'_8$ et $R'_9$ conjointement avec l'atome auquel ils sont liés, forment un aryle substitué ou un aryle non substitué, tel qu'un phényle substitué ou phényle non substitué, éventuellement au moins un de $R_6$-$R_9$ et au moins un de $R'_6$-$R'_9$ ne sont pas hydrogène, et/ou dans lequel $Q_3$ et $Q'_3$ représentés par les Formules Ia-IVa sont indépendamment soufre ou oxygène.

9. Complexe selon la revendication 2, dans lequel $R_2$, $R_4$, $R_5$, $R'_{2a}$ $R'_4$, $R'_5$, $R_7$, $R_8$, $R'_7$ et $R'_8$ sont hydrogène ; et $R_1$, $R_3$, $R_6$, $R_9$, $R'_1$, $R'_3$, $R'_6$ et $R'_9$ sont indépendamment hydrogène, halogène, alkyle non substitué, alkyle substitué, aryle non substitué, aryle substitué (par ex., aryle substitué par un ou plusieurs alkyles, tels que méthyle, éthyle, n-propyle, isopropyle, n-butyle, sec-butyle, isobutyle, tert-butyle, etc.), hydroxyle, hétéroaryle non substitué (par ex., carbazolyle, fluorényle, indényle, indolyle, etc.), polyhétéroaryle non substitué, $C_2$-$C_{20}$ hétérocyclyle non substitué, alkylaryle

non substitué, alkoxy (par ex., -O-alkyle par exemple méthoxy, éthoxy et phénoxy, -O-aryle, -O-polyaryle, etc.), cation de borénium (par ex., -B(Mes)$_2$), phosphonyle (par ex. - P(=O)(Ph)$_2$), sulfinyle (par ex., -S(=O)(Ph)$_2$, -S(=O)(alkyl)$_2$, etc.) ou sulfonyle -S(=O)$_2$(Ph)$_2$, - S(=O)$_2$(alkyl)$_2$, etc.), par exemple halogène, alkyle non substitué (par ex., méthyle, éthyle, n-propyle, isopropyle, n-butyle, sec-butyle, isobutyle, tert-butyle, etc.), aryle non substitué (par ex., phényle non substitué), aryle substitué (par ex., mésitylène ou autre aryle substitué par un ou plusieurs alkyles, par exemple méthyle, éthyle, n-propyle, isopropyle, n-butyle, sec-butyle, isobutyle, tert-butyle, etc.), cation de borénium (par ex., -B(Mes)$_2$), ou phosphonyle (par ex., - P(=O)(Ph)$_2$, -P(=O)(alkyl)$_2$, etc.), éventuellement dans lequel $R_1$, $R_6$, $R_9$, $R'_1$, $R'_6$ et $R'_9$ sont indépendamment alkyle non substitué, aryle non substitué ou aryle substitué (par ex., phényle substitué par un ou plusieurs $C_1$-$C_6$ alkyles).

**10.** Complexe selon la revendication 1, ledit complexe comportant l'une des structures suivantes :

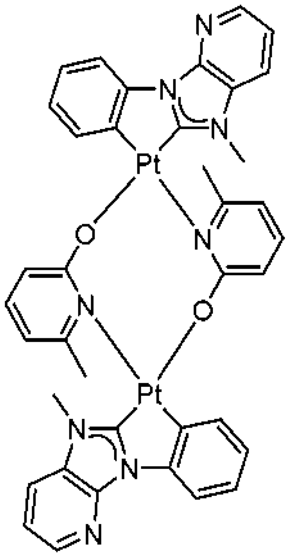

**Pt-R1** ,

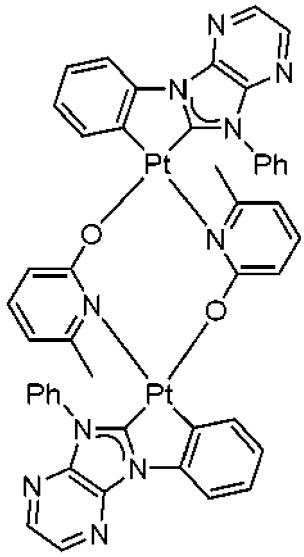

**Pt-R2** ,

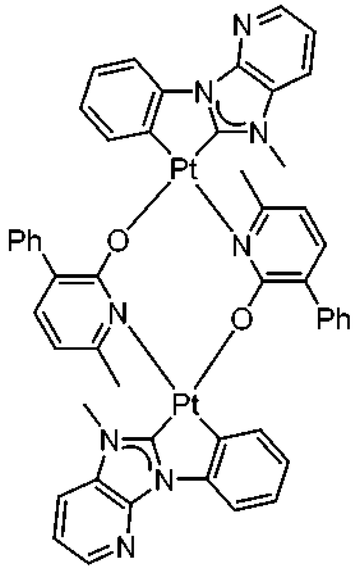

**Pt-R3** ,

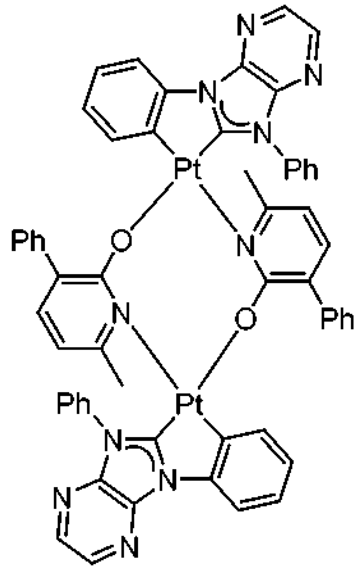

**Pt-R4** ,

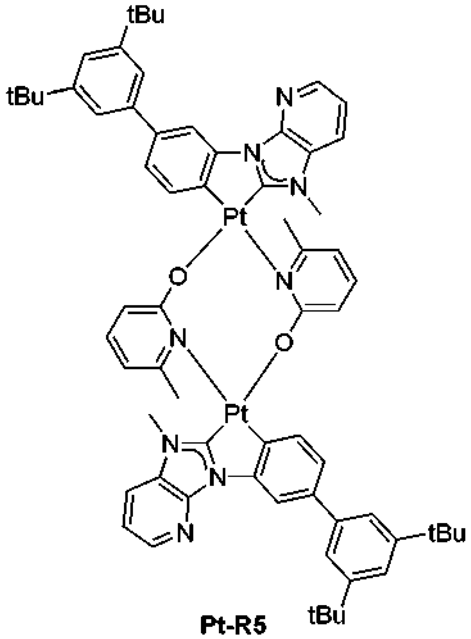

Pt-R5 ,

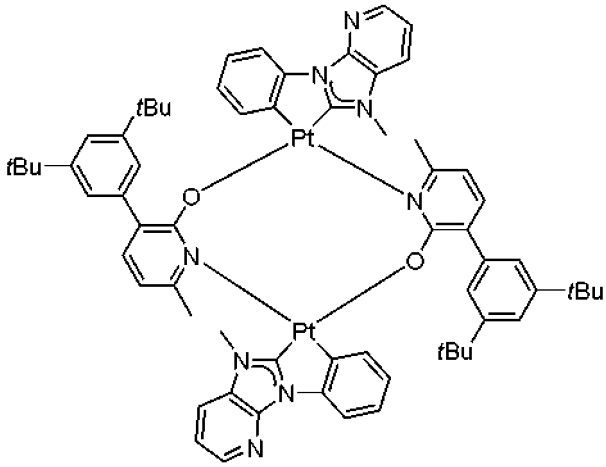

Pt-R6 ,

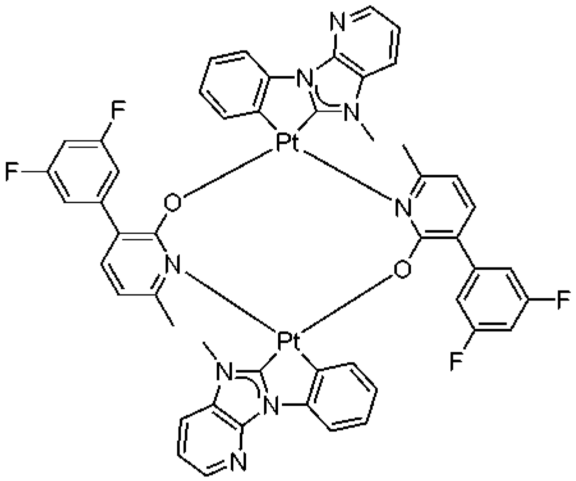

Pt-R7 ,

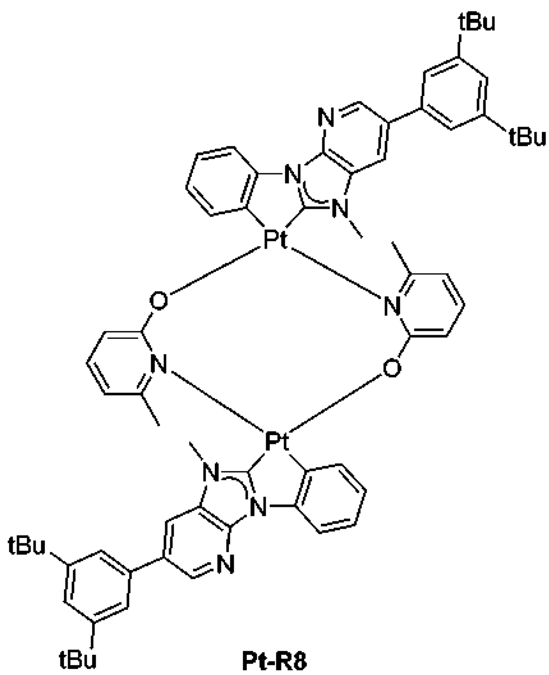

Pt-R8 ,

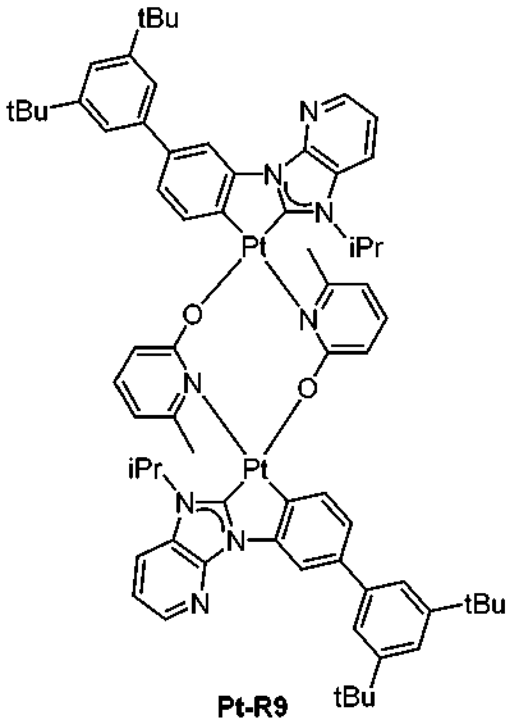

Pt-R9 ,

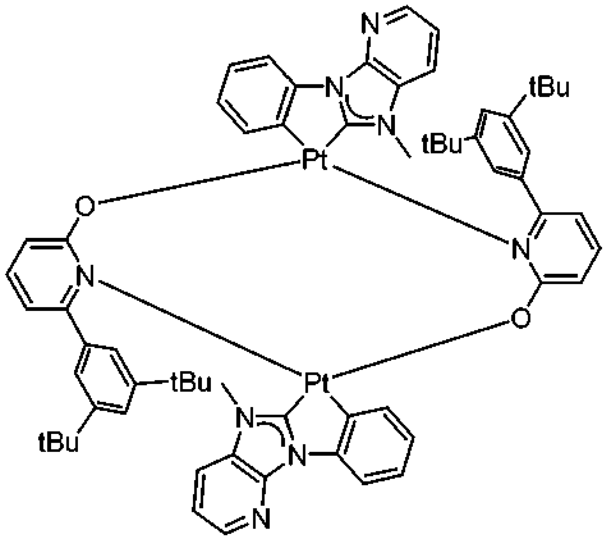

Pt-R10 ,

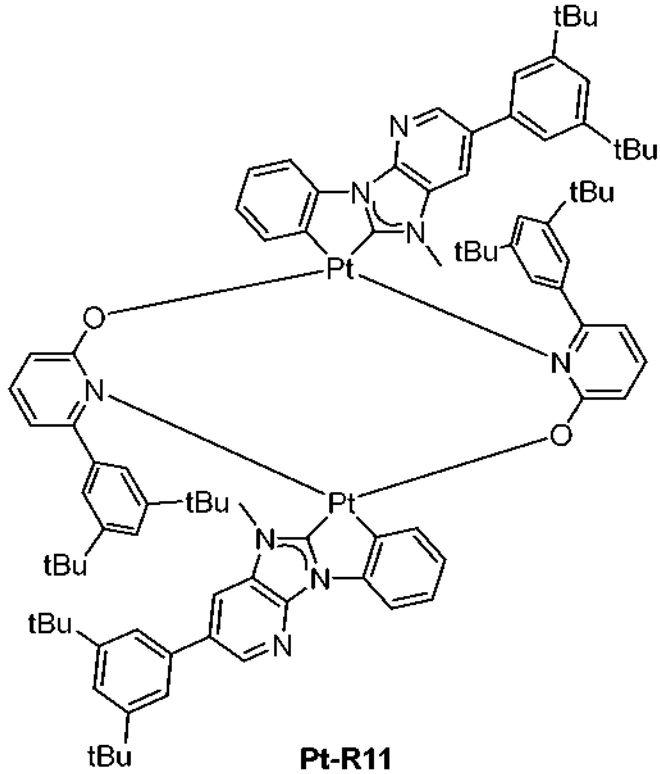

Pt-R11 ,

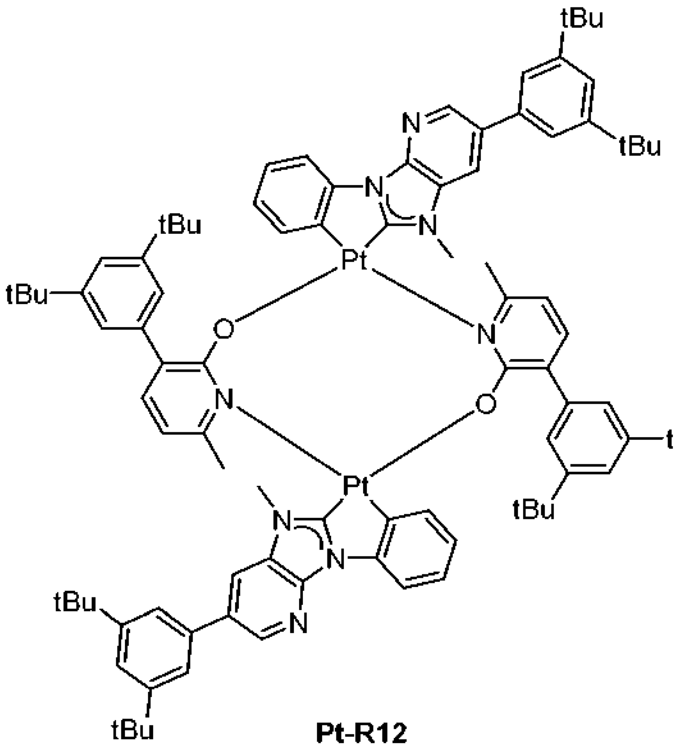

**Pt-R12**

,

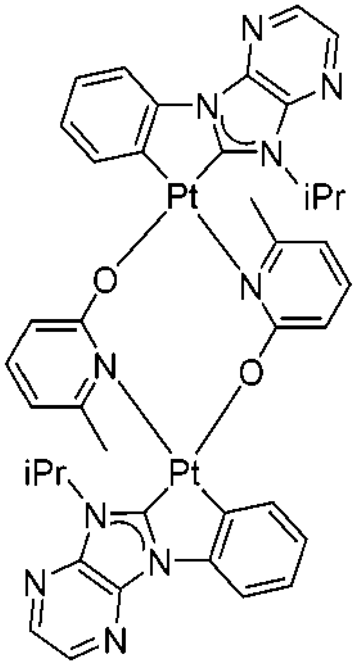

**Pt-R13**

,

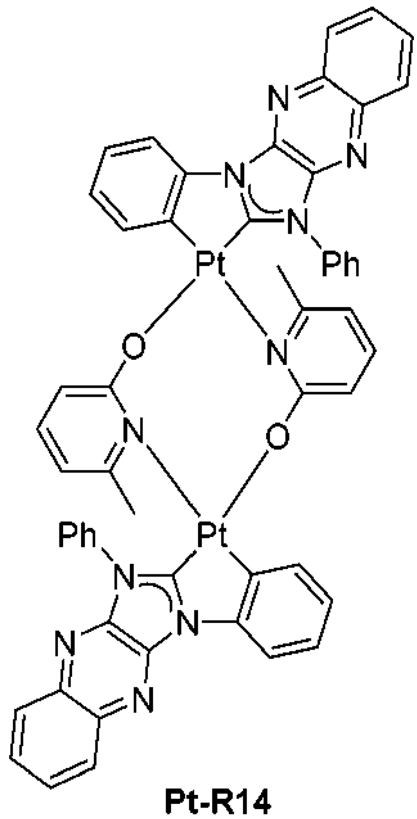

**Pt-R14**

,

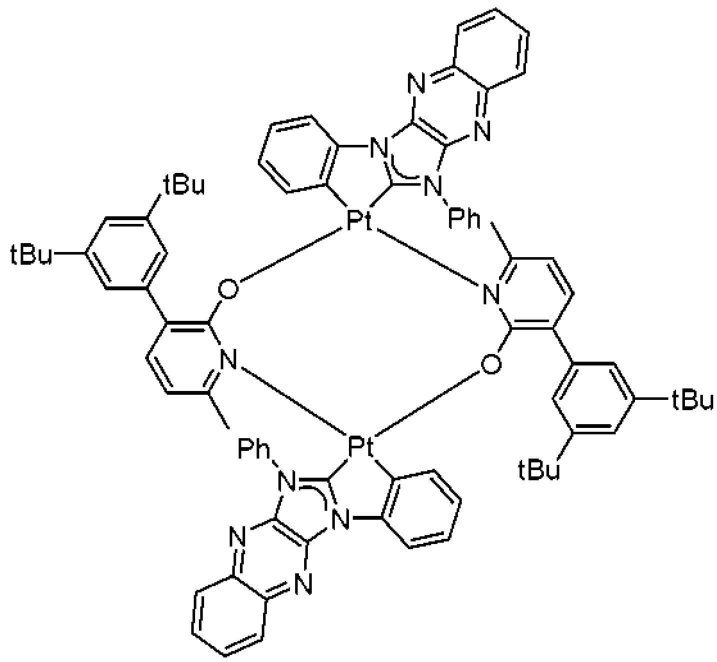

**Pt-R15**

,

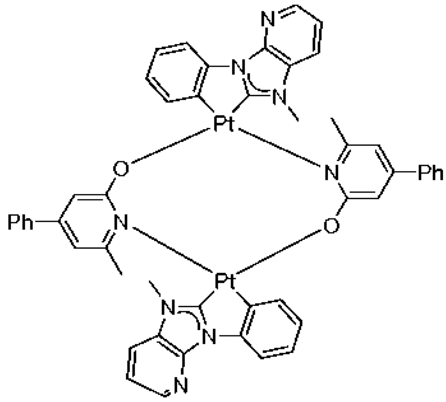

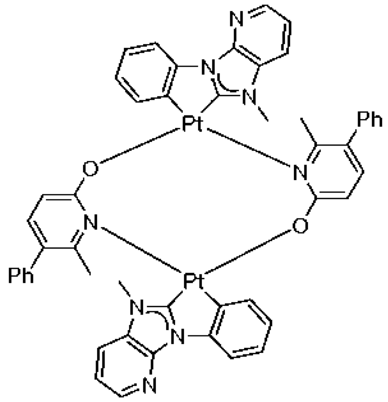

,

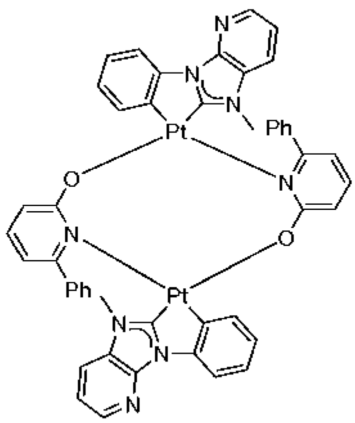

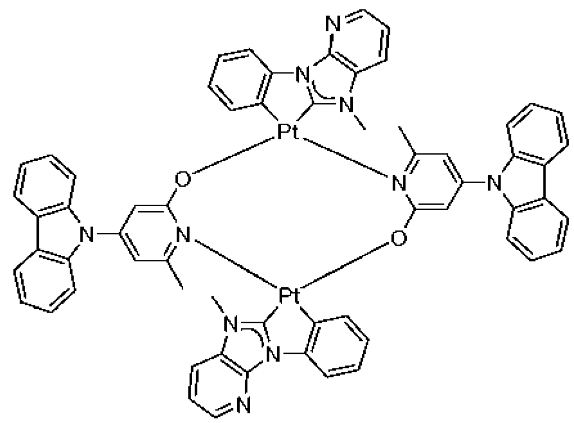

,

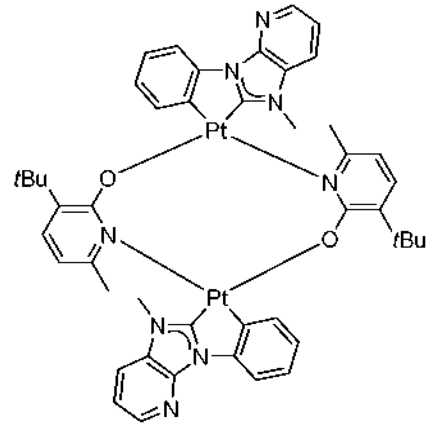

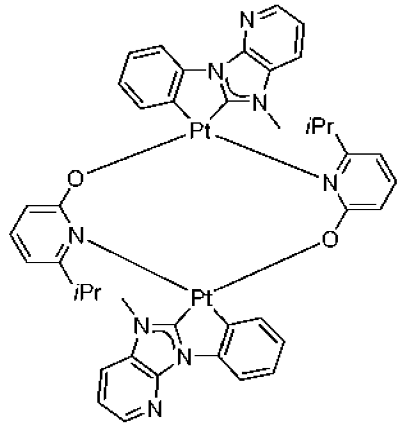

,

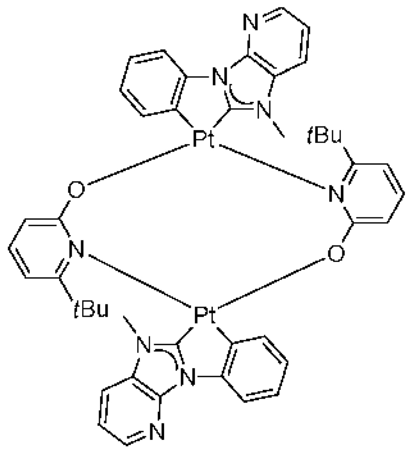

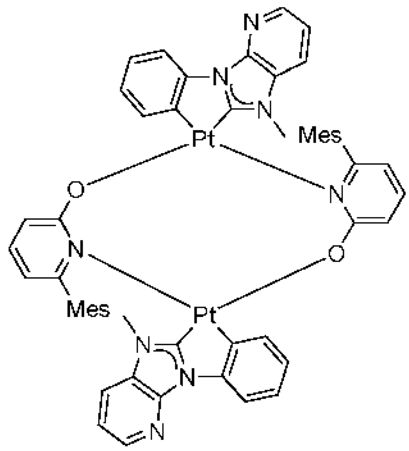

,

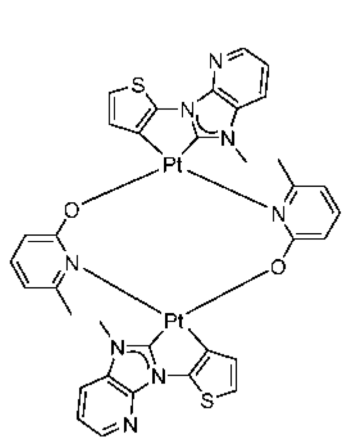

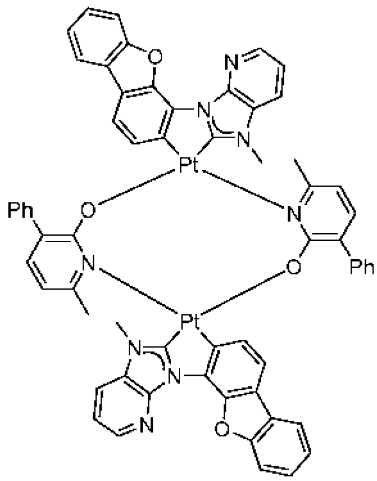

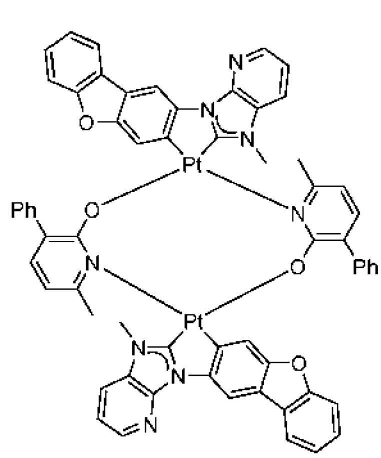

,

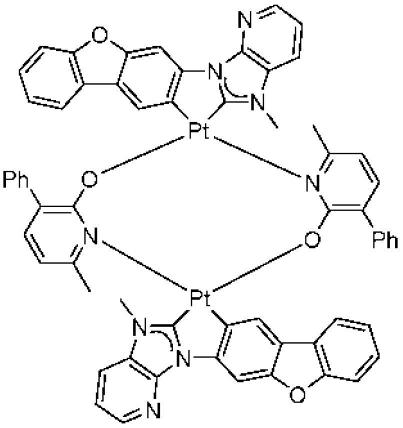

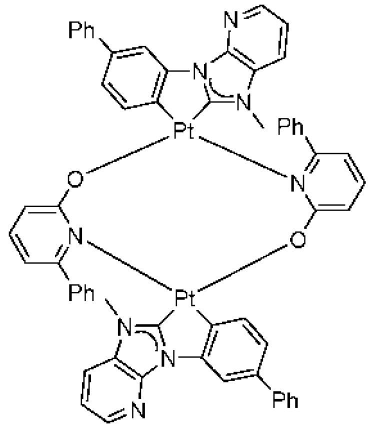

,

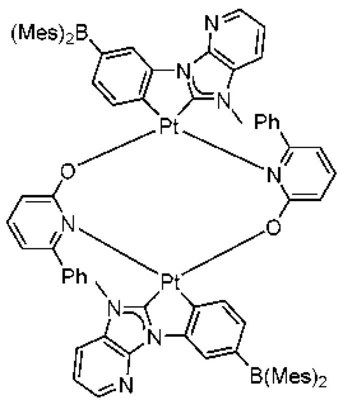

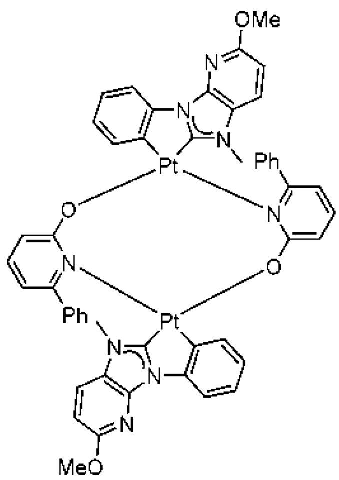

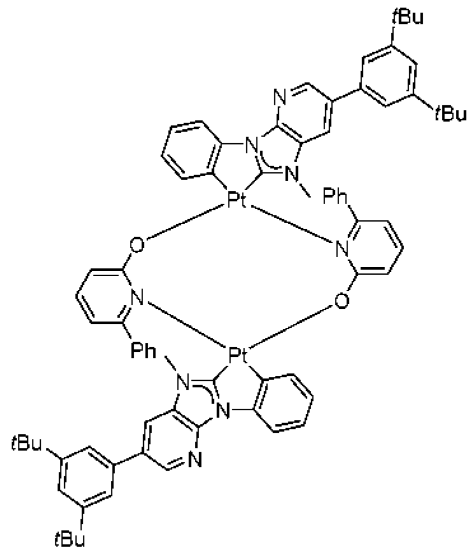

,

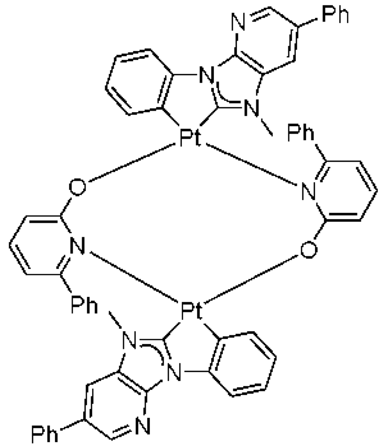

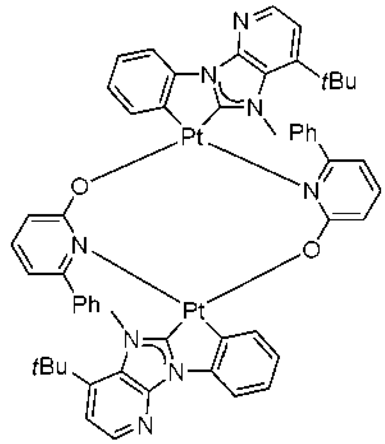

,

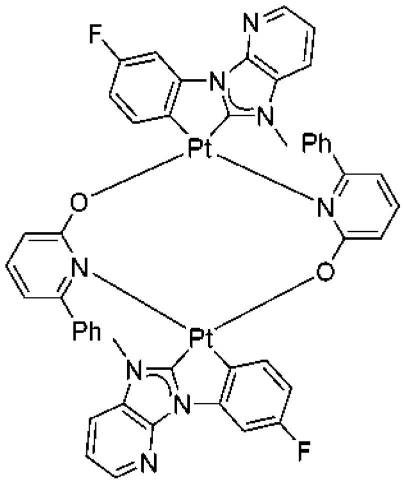
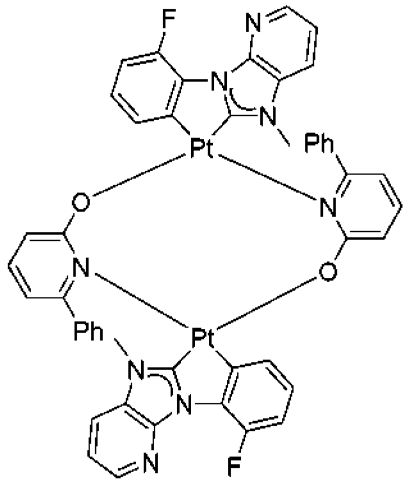

,

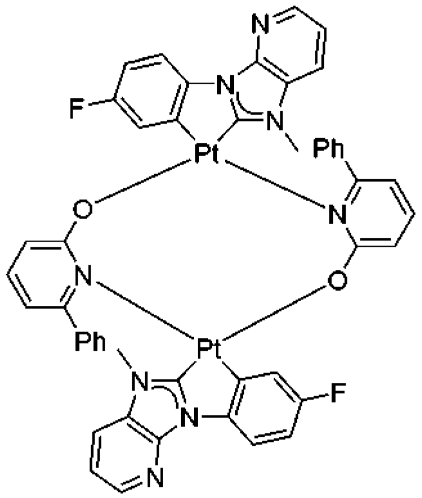
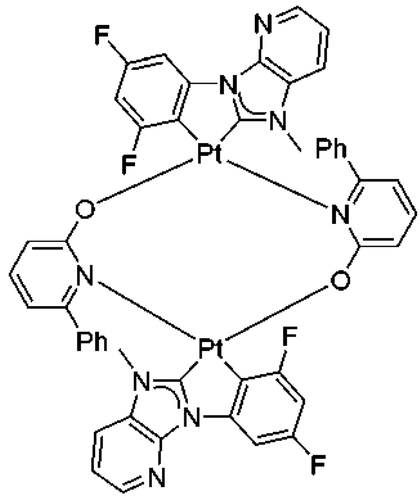

,

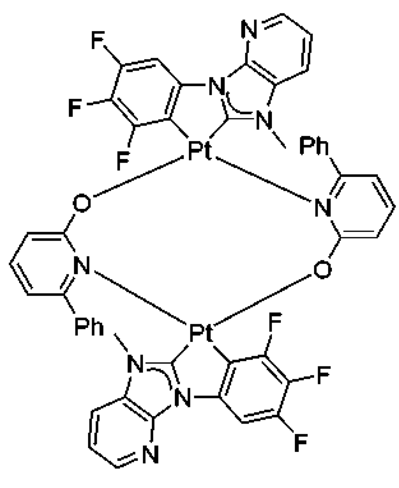
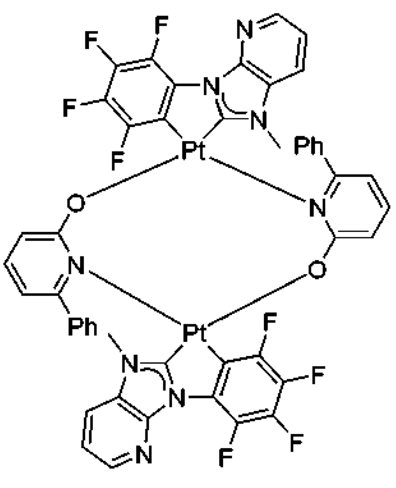

,

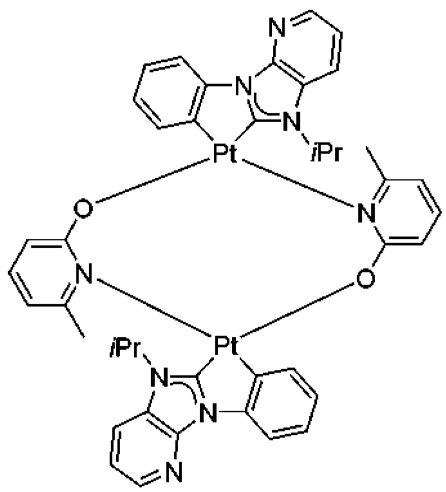

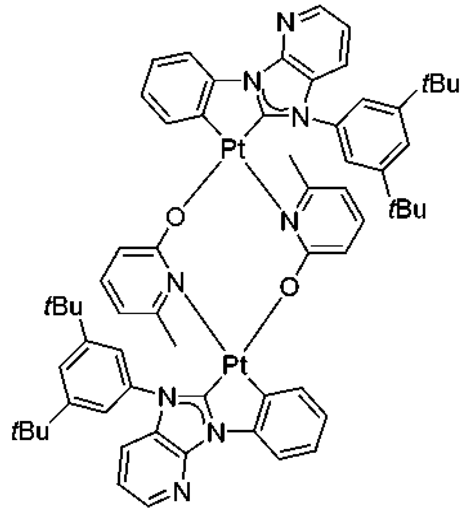

,

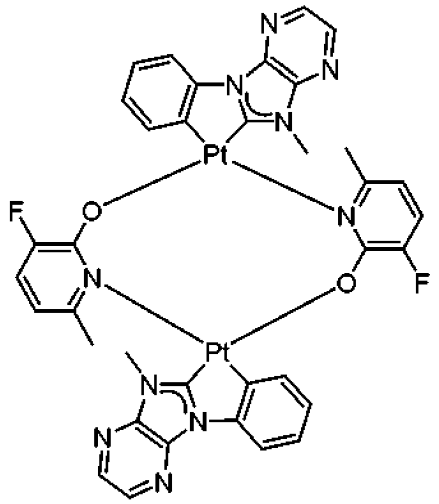

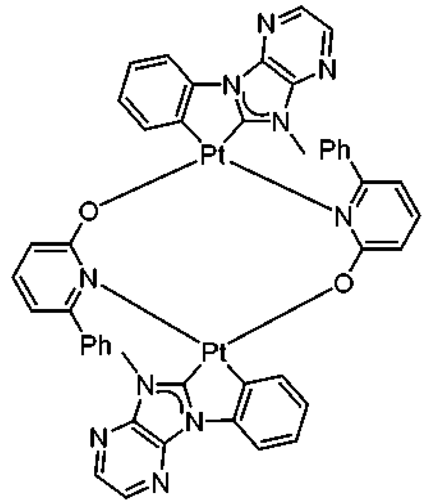

,

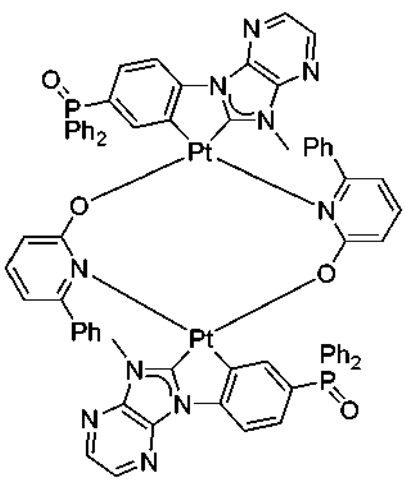

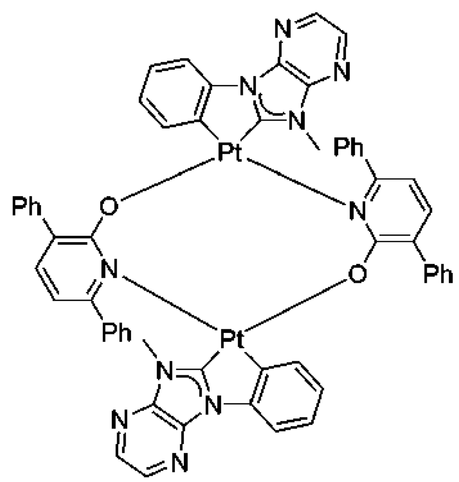

,

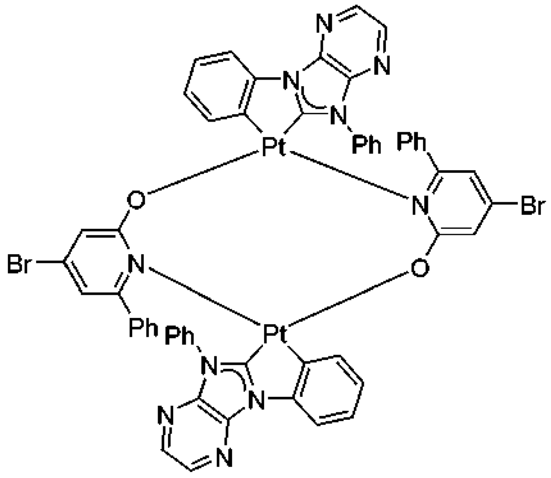

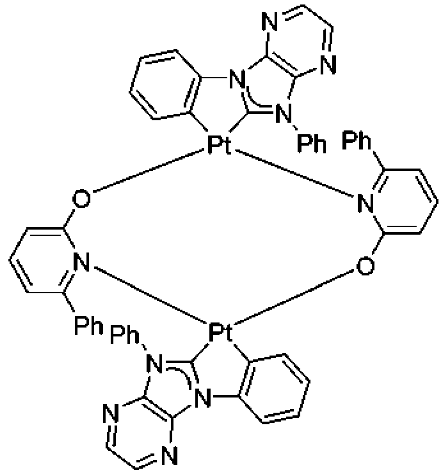

,

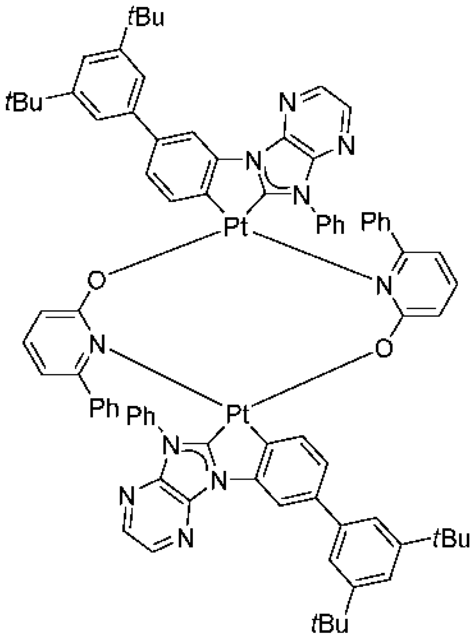

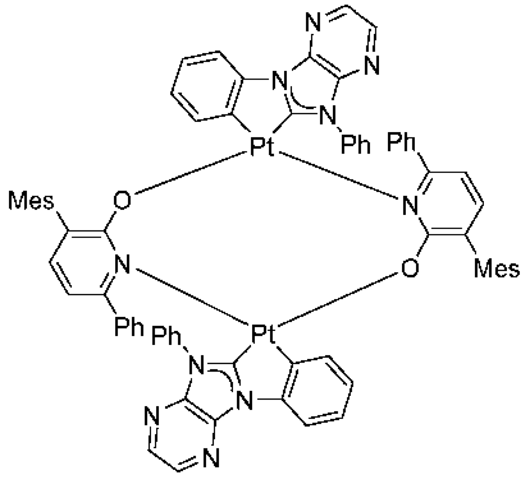

,

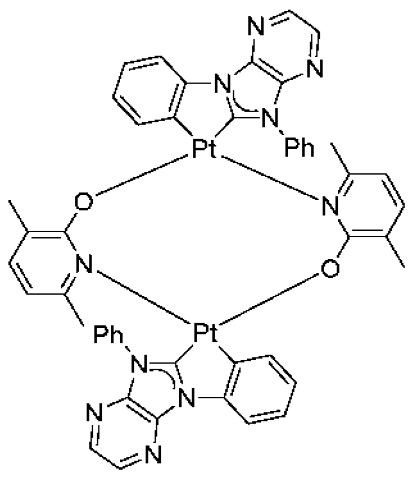

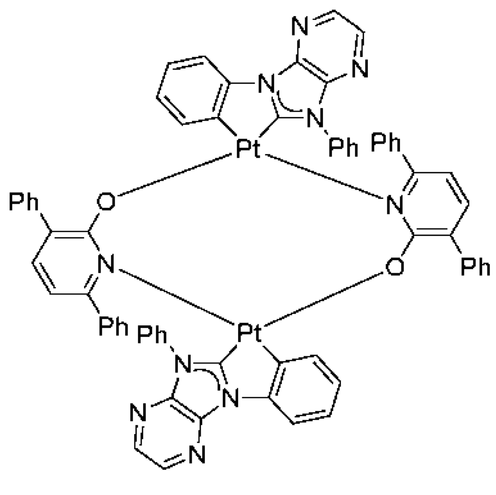

,

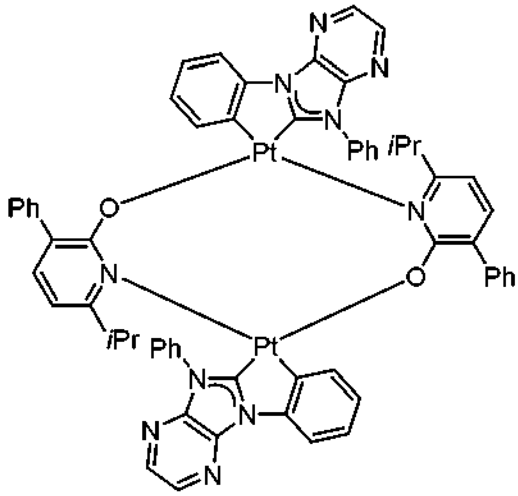
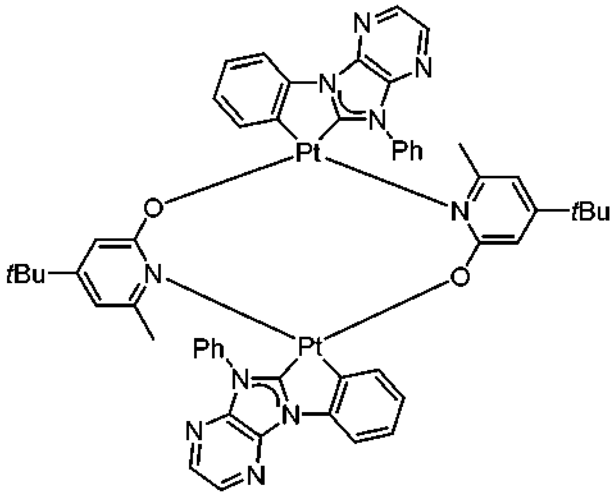
,

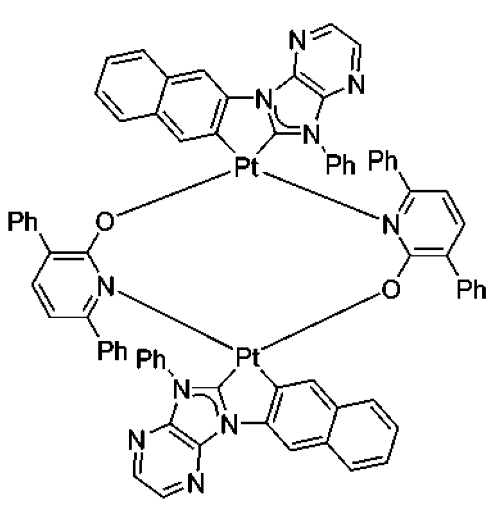
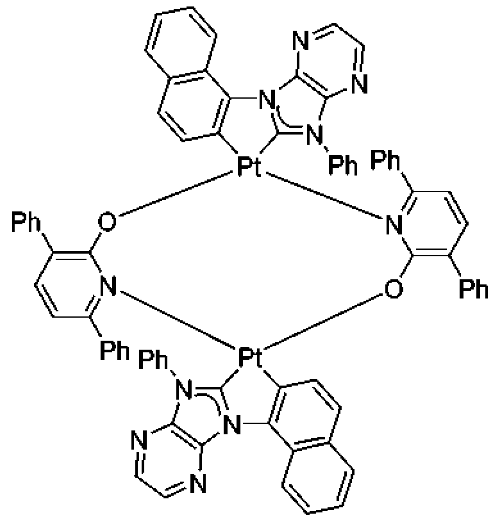
,

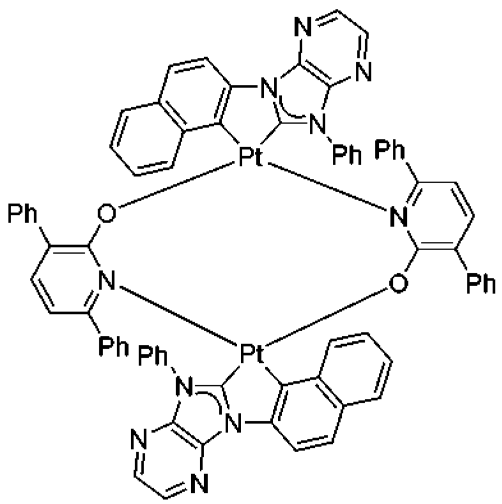
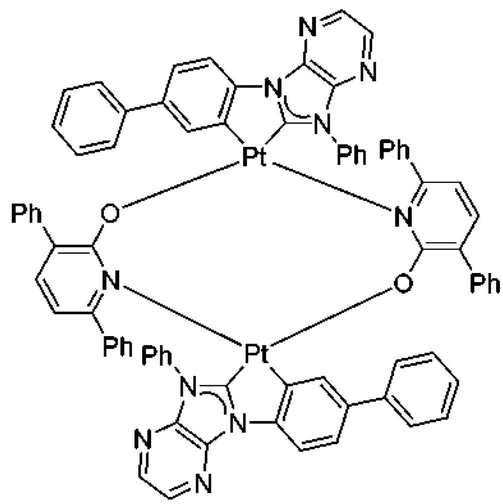
,

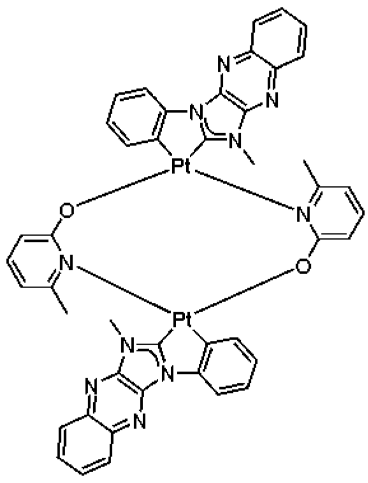
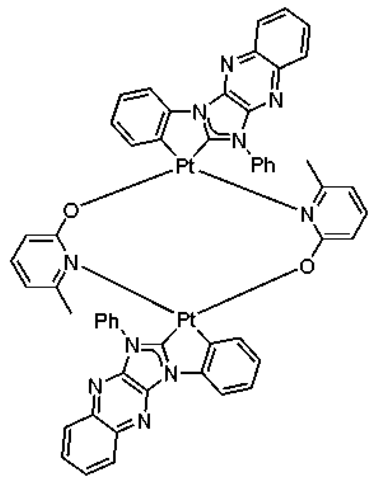
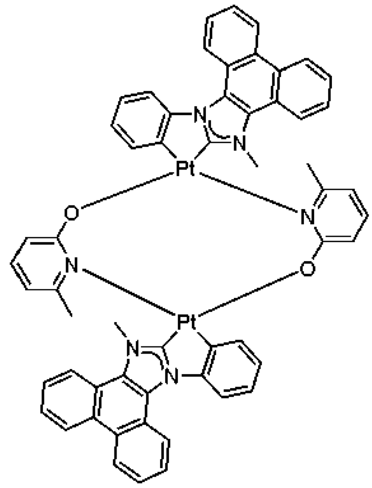

,

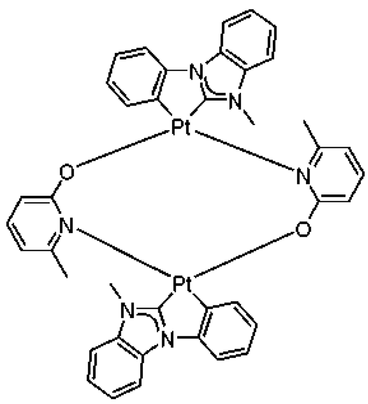
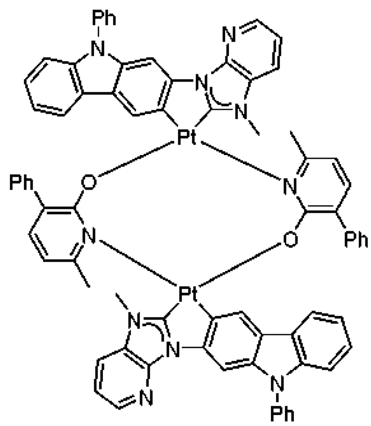
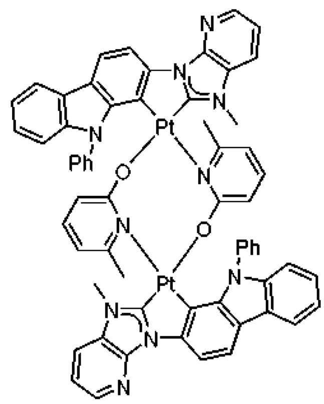

,

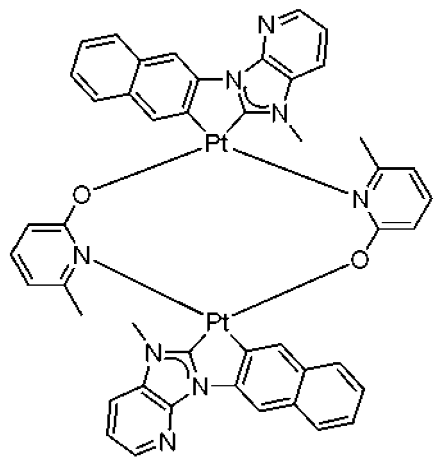
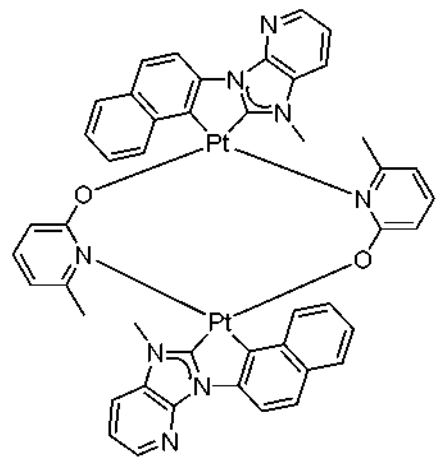

,

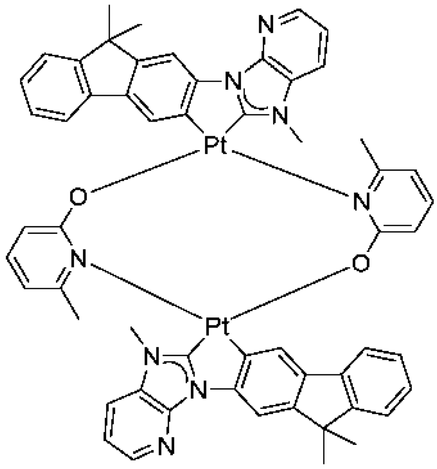

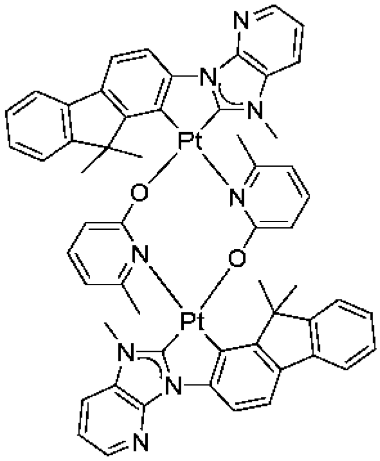

,

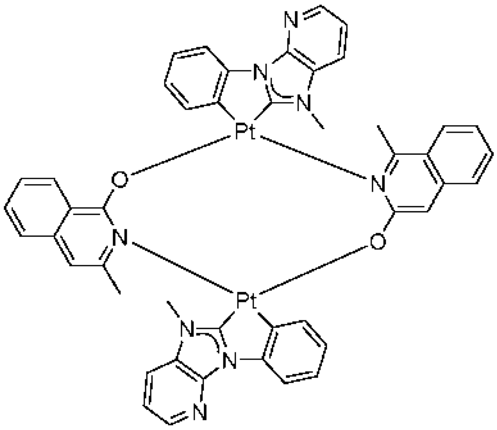

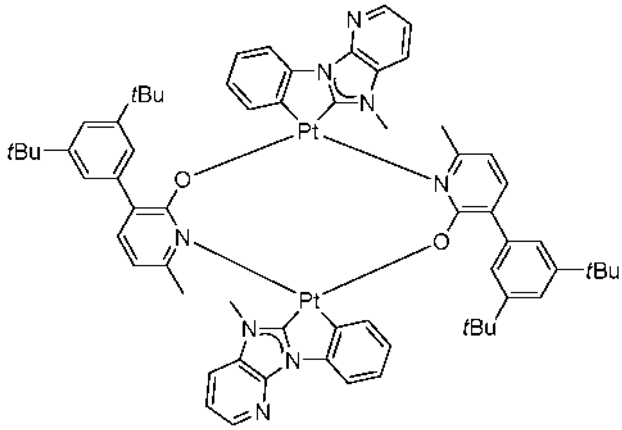

,

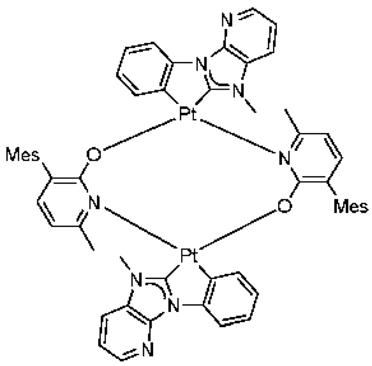

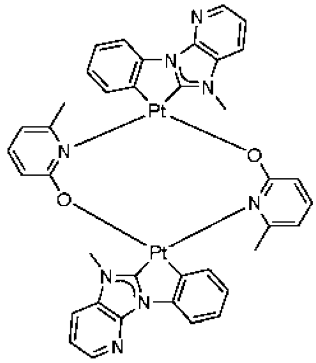

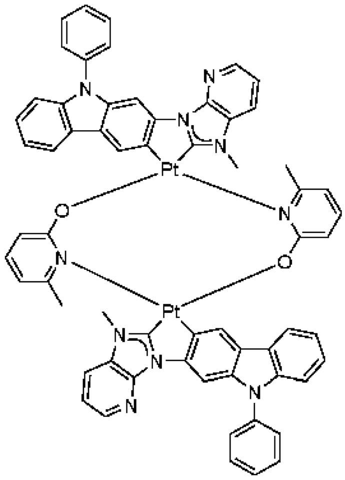

,

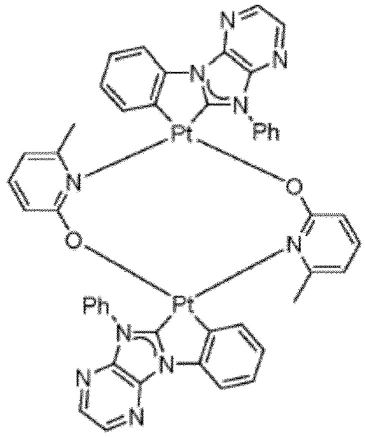

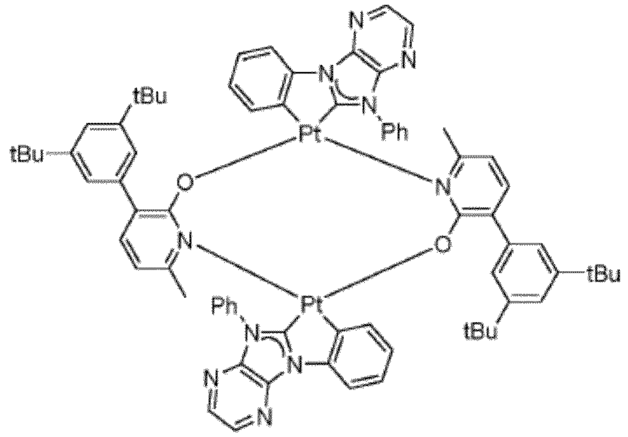

,

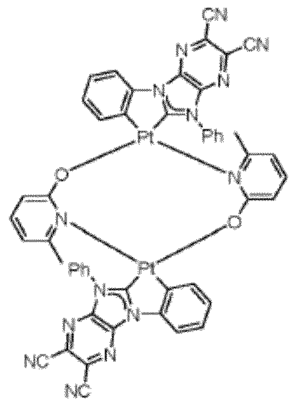

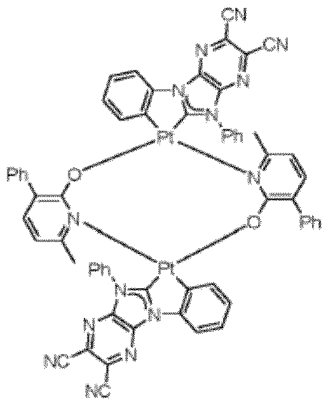

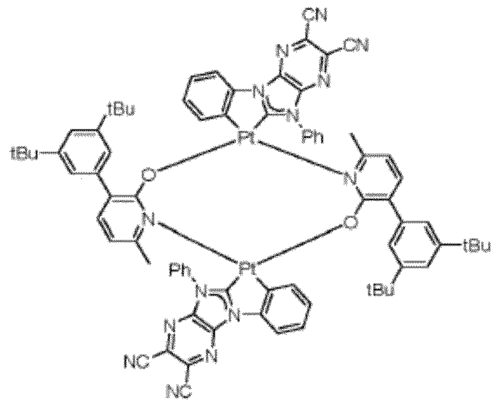

,

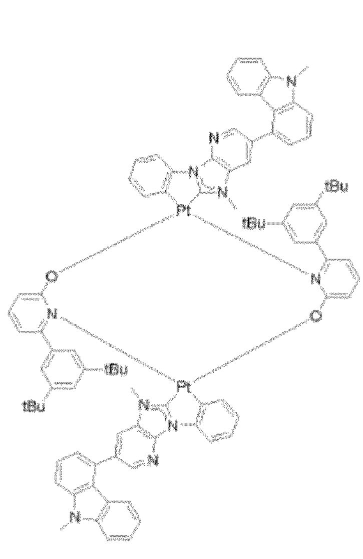

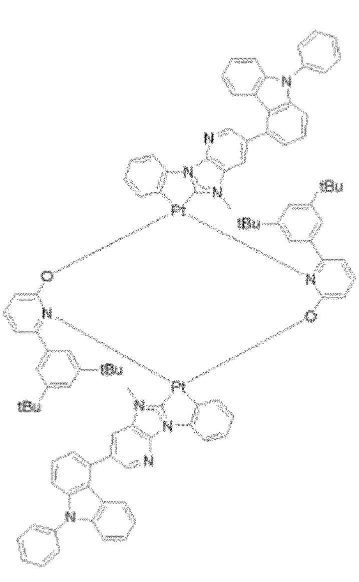

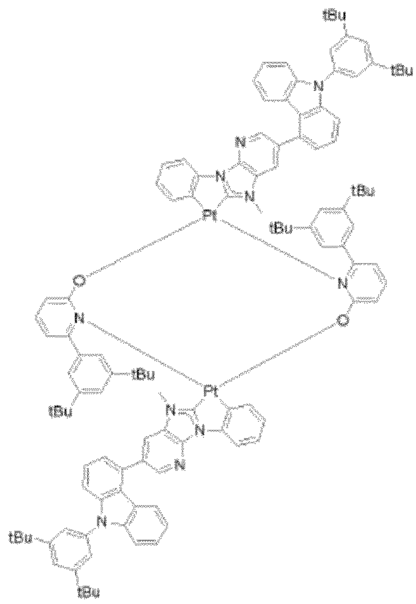

,

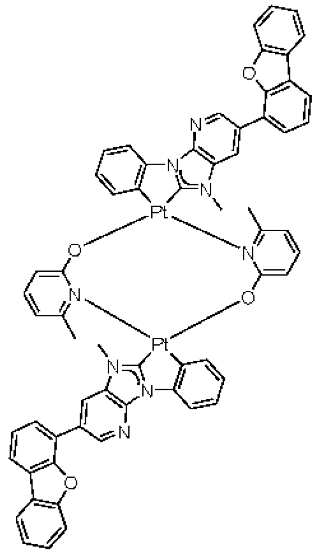

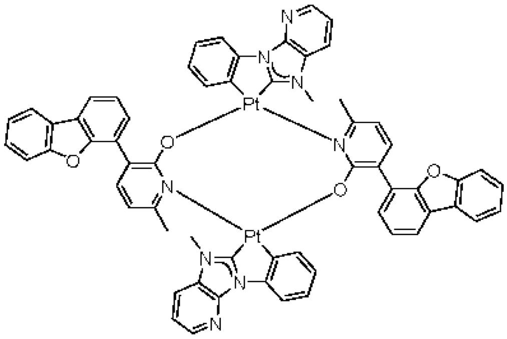

,

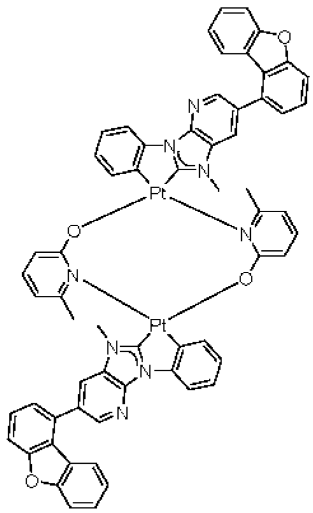

,

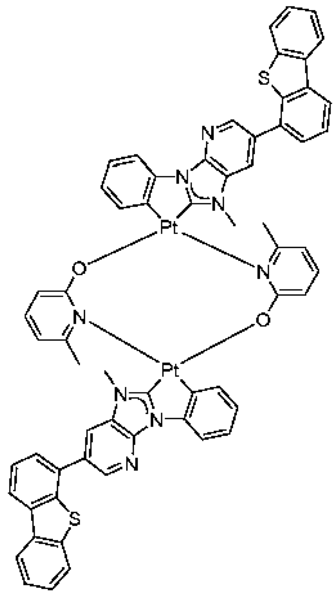

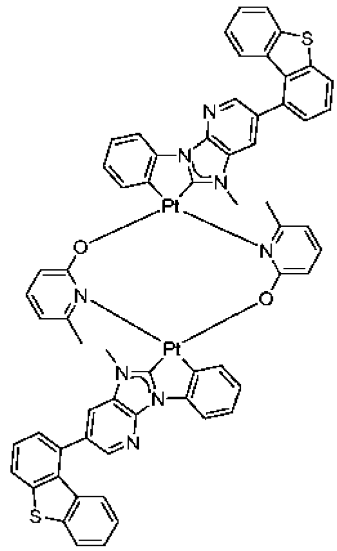

,

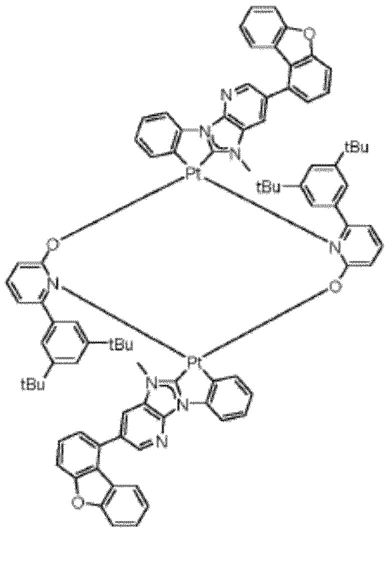
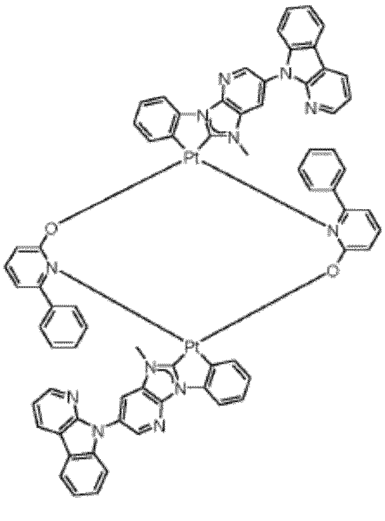
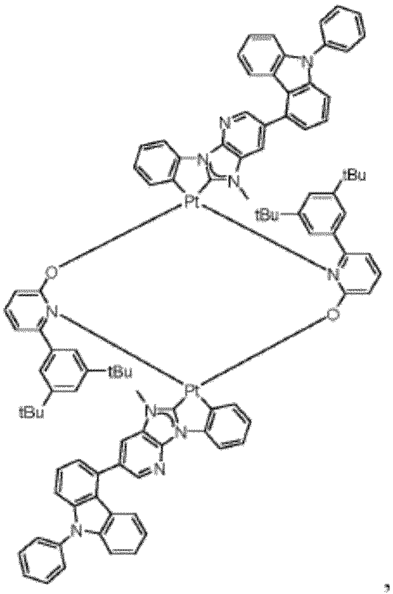
,

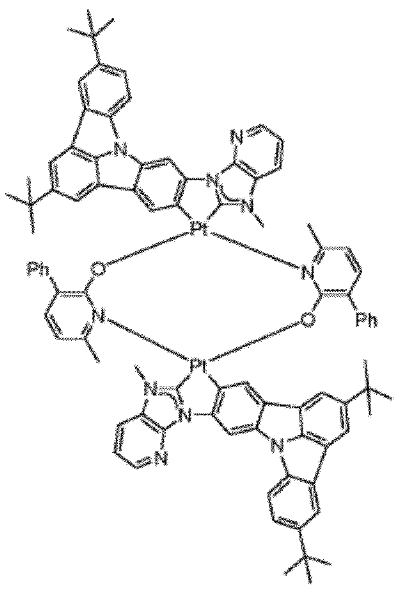
,
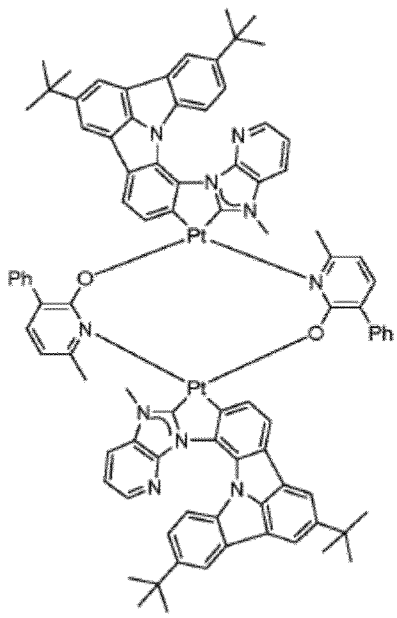
,

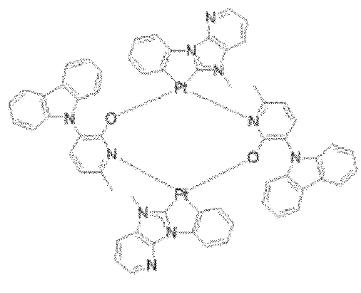
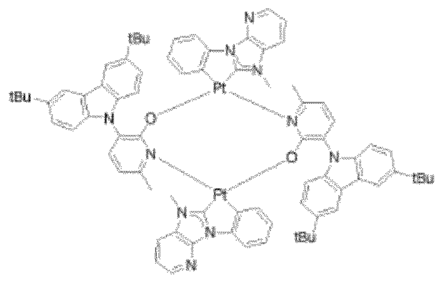
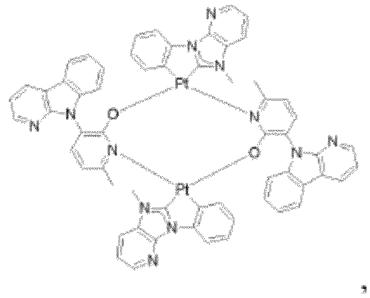
,

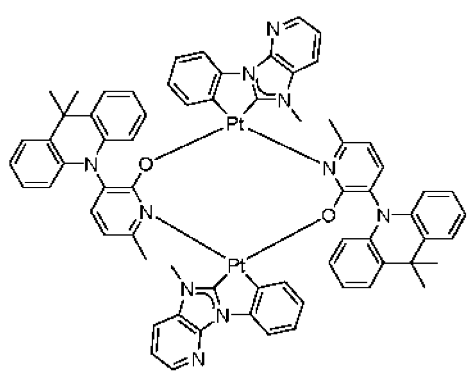

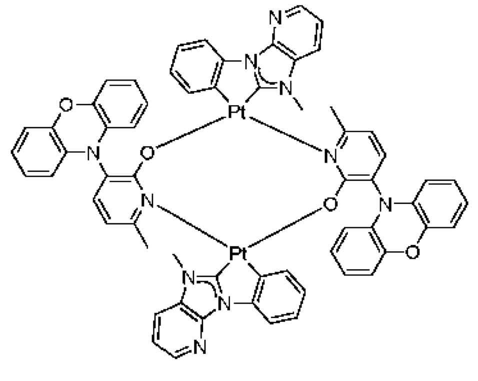

,

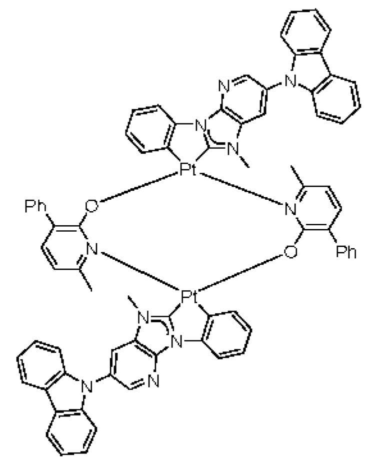

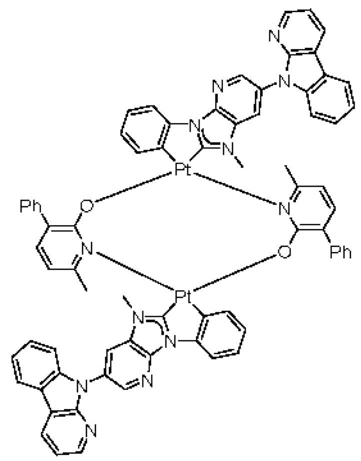

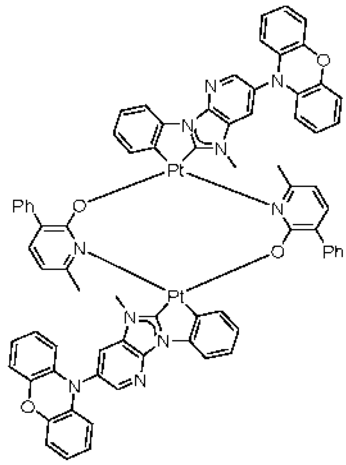

,

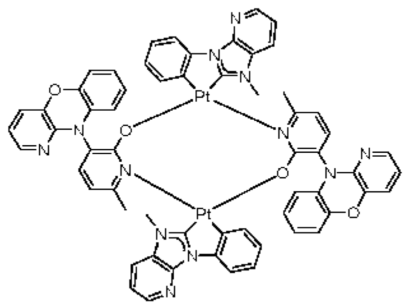

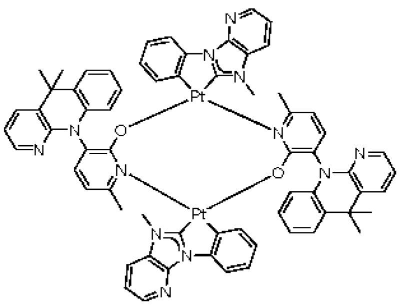

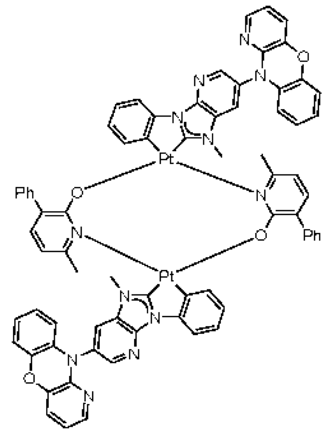

,

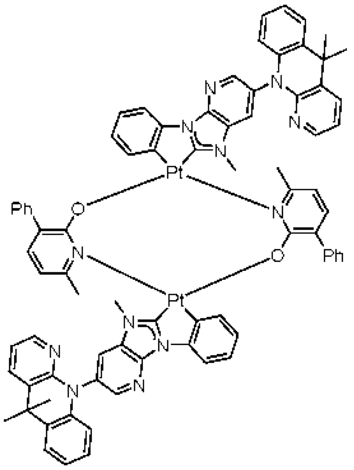
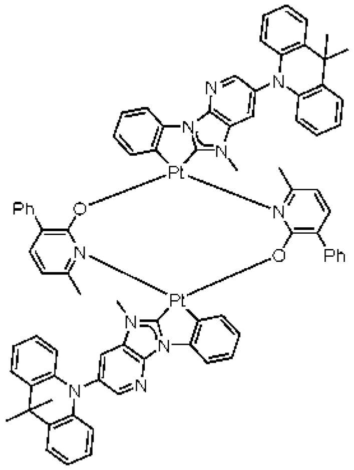
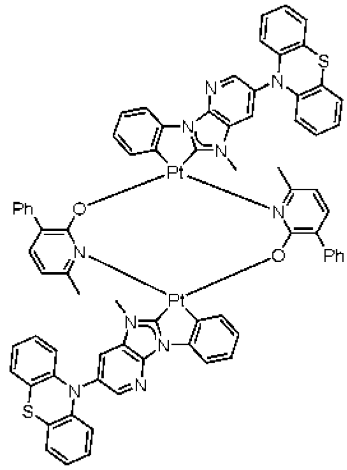
,

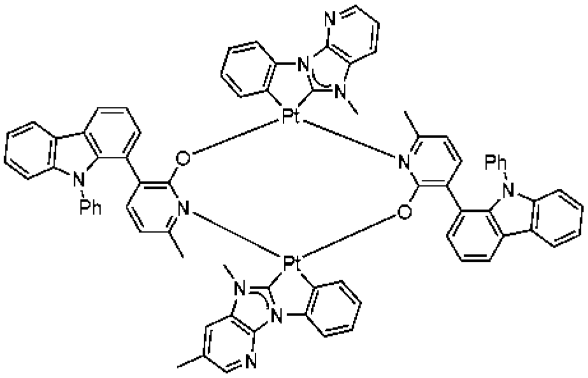
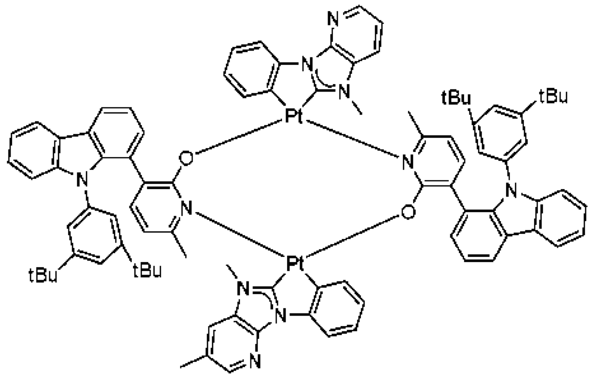
,

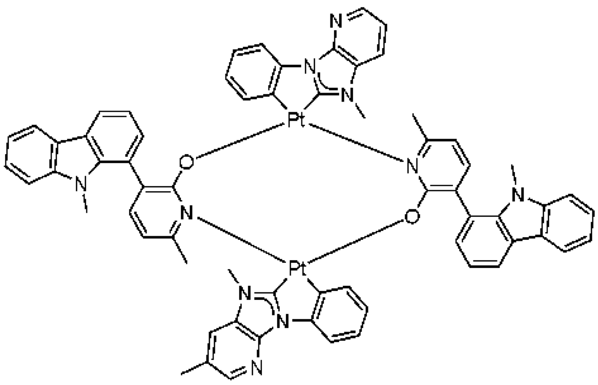
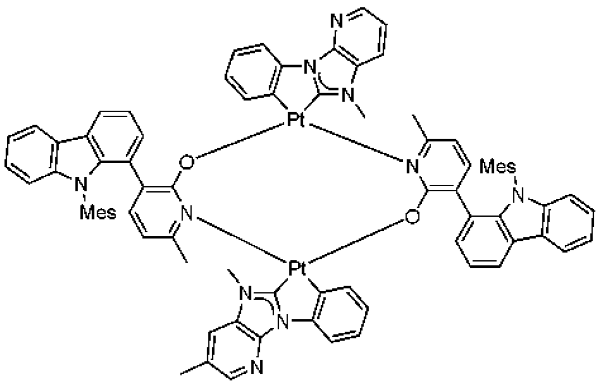

**11.** Composant électroluminescent organique comprenant une couche électroluminescente ou deux couches électroluminescentes ou plus, dans lequel la couche électroluminescente ou chaque couche électroluminescente des deux couches électroluminescentes ou plus comprend un ou plusieurs complexes dinucléaires de platine(II) selon la revendication 1, éventuellement ledit composant électroluminescent organique émettant de la lumière dans la ou les régions rouge, rouge profond et/ou NIR.

**12.** Composant électroluminescent organique selon la revendication 11, dans lequel

(i) la couche électroluminescente ou chacune des deux couches électroluminescentes ou plus comprend en outre un ou plusieurs matériaux hôtes, et dans lequel la concentration totale du ou des matériaux hôtes est supérieure à la concentration totale du ou des complexes dans la couche électroluminescente ou chaque couche électroluminescente des deux couches électroluminescentes ou plus, et/ou
(ii) la concentration totale du ou des complexes dinucléaires de platine(II) dans la couche électroluminescente ou

chaque couche électroluminescente des deux couches électroluminescentes ou plus est jusqu'à 50 % en poids, jusqu'à 40 % en poids, jusqu'à 30 % en poids, jusqu'à 20 % en poids, au moins 1 % en poids, dans une plage d'environ 1 % en poids à environ 50 % en poids, d'environ 1 % en poids à environ 40 % en poids, d'environ 1 % en poids à environ 30 % en poids, d'environ 1 % en poids à environ 20 % en poids, d'environ 2 % en poids à environ 50 % en poids, d'environ 2 % en poids à environ 40 % en poids, d'environ 2 % en poids à environ 30 % en poids, d'environ 2 % en poids à environ 20 % en poids, d'environ 4 % en poids à environ 50 % en poids, d'environ 4 % en poids à environ 40 % en poids, d'environ 4 % en poids à environ 30 % en poids, d'environ 4 % en poids à environ 20 % en poids, d'environ 1 % en poids à environ 16 % en poids, d'environ 2 % en poids à environ 16 % en poids, d'environ 4 % en poids à environ 16 % en poids, tel que environ 4 % en poids, environ 8 % en poids ou environ 12 % en poids, et/ou
(iii) le composant comprend en outre une anode, une cathode, une région de transport de trous et une région de transport d'électrons,

ladite région de transport de trous comprenant une couche d'injection de trous et/ou une couche de transport de trous, et éventuellement une couche de blocage d'électrons,
ladite région de transport d'électrons comprenant une couche de transport d'électrons et/ou une couche d'injection d'électrons, et éventuellement une couche de blocage de trous,
ladite couche électroluminescente étant située entre l'anode et la cathode,
ladite région de transport de trous étant située entre l'anode et la couche électroluminescente, et
ladite région de transport d'électrons étant située entre la cathode et la couche électroluminescente, et/ou

(iv) dans lequel le composant électroluminescent organique est une diode électroluminescente organique (« OLED ») ou une cellule électrochimique électroluminescente (« LEEC »), et/ou
(v) dans lequel la couche électroluminescente ou chaque couche électroluminescente des deux couches électroluminescents ou plus est formée par enduction par évaporation sous vide, enduction par centrifugation, impression à l'encre ou impression roll-to-roll, et/ou
(vi)

(a) dans lequel la couche électroluminescente ou chaque couche électroluminescente des deux couches électroluminescentes ou plus comprend en outre un colorant organique, et dans lequel le ou les complexes dinucléaires de platine (II) agissent comme un sensibilisateur pour transférer l'énergie au colorant organique, ou
(b) dans lequel la couche électroluminescente ou chaque couche électroluminescente des deux couches électroluminescentes ou plus comprend en outre un colorant organique, et dans lequel le ou les complexes dinucléaires de platine (II) comportent un état singulet plus élevé que le colorant organique.

**13.** Dispositif comprenant un ou plusieurs composants électroluminescents selon la revendication 11, ledit dispositif étant une unité de visualisation fixe, une unité de visualisation mobile, un dispositif d'éclairage, un dispositif portable, un dispositif de photothérapie ou un dispositif de surveillance médicale.

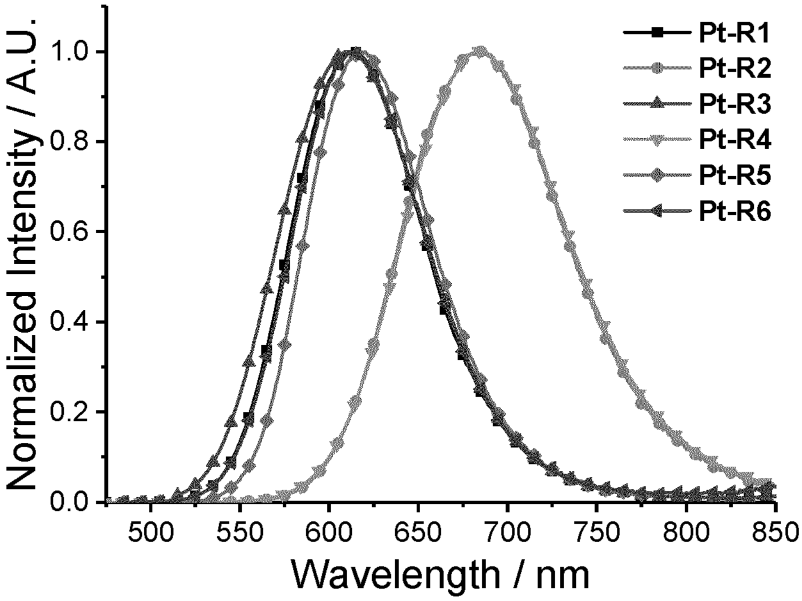
Normalized Intensity / A.U.
1.0
0.8
0.6
0.4
0.2
0.0
500
550
600
650
700
750
800
850
Wavelength / nm
Pt-R1
Pt-R2
Pt-R3
Pt-R4
Pt-R5
Pt-R6

FIG. 1A

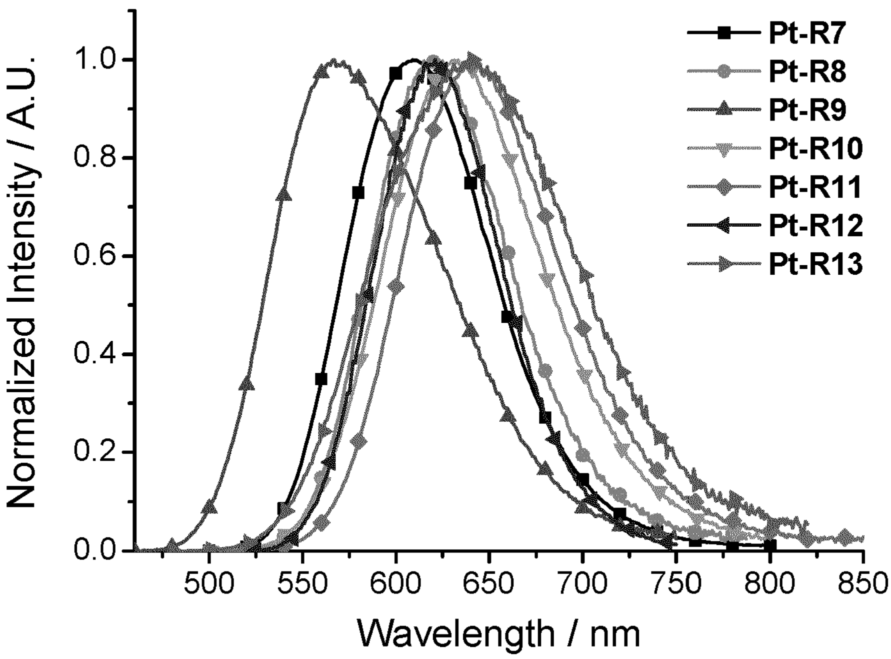
Normalized Intensity / A.U.
1.0
0.8
0.6
0.4
0.2
0.0
500
550
600
650
700
750
800
850
Wavelength / nm
Pt-R7
Pt-R8
Pt-R9
Pt-R10
Pt-R11
Pt-R12
Pt-R13

FIG. 1B

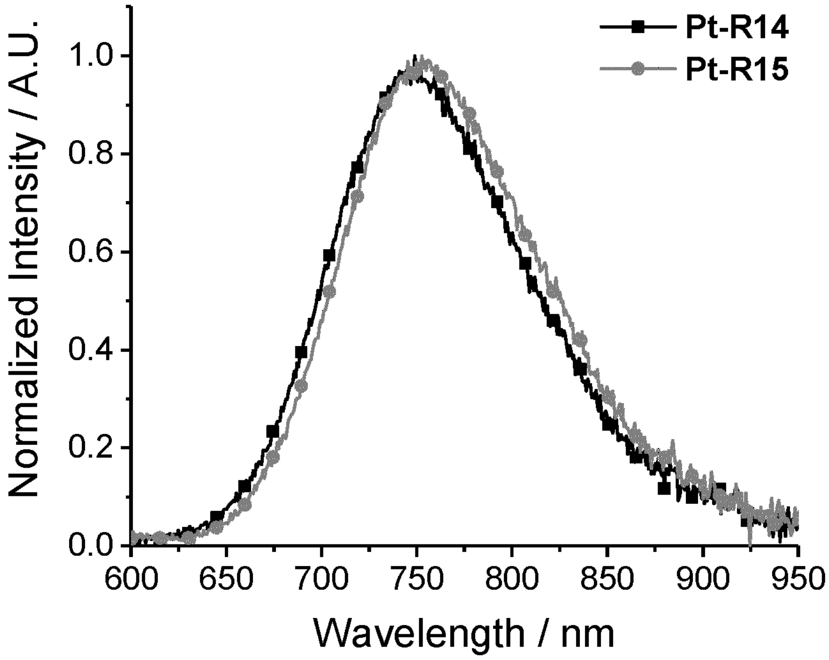


FIG. 1C

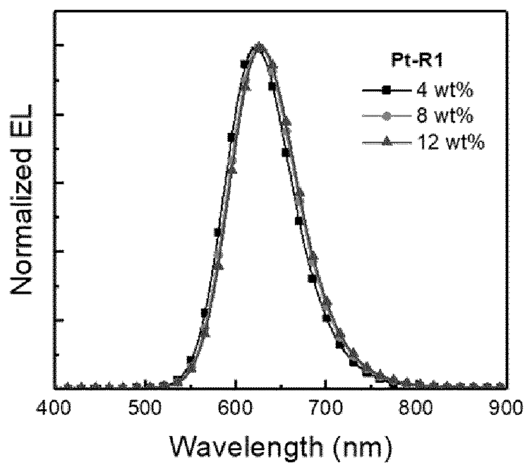


FIG. 2A

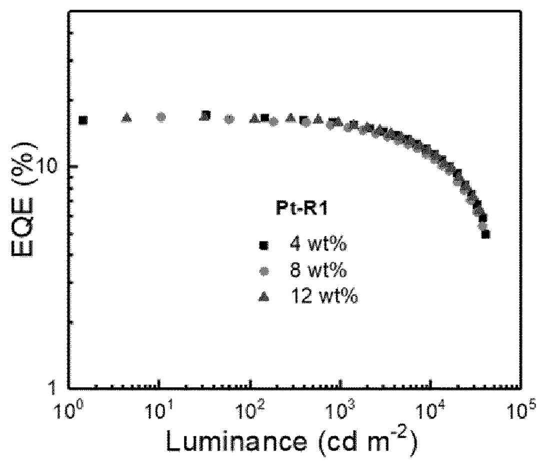


FIG. 2B

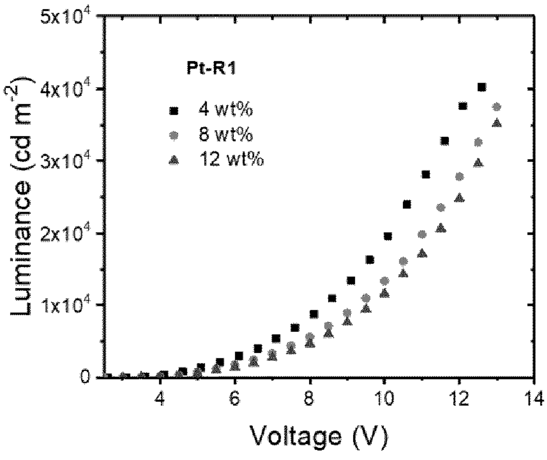


FIG. 2C

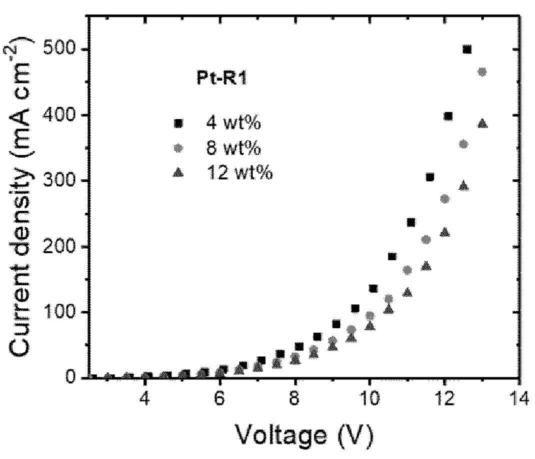


FIG. 2D

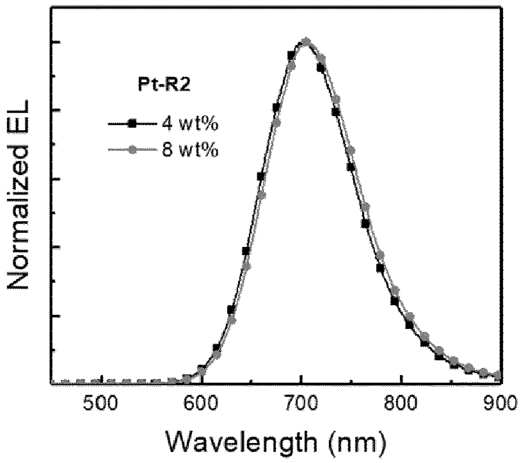


FIG. 3A

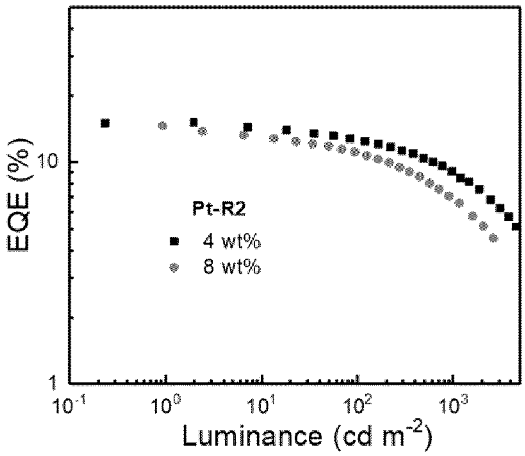


FIG. 3B

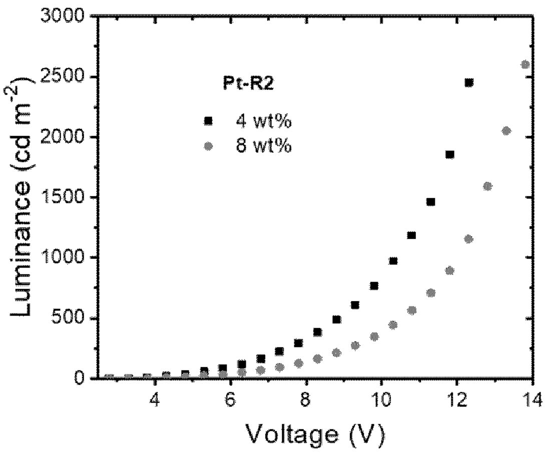


FIG. 3C

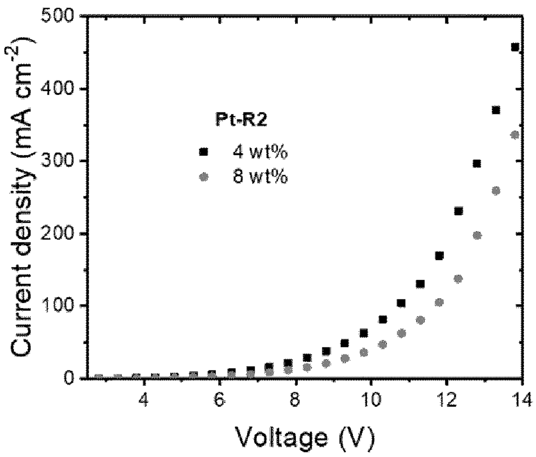


FIG. 3D

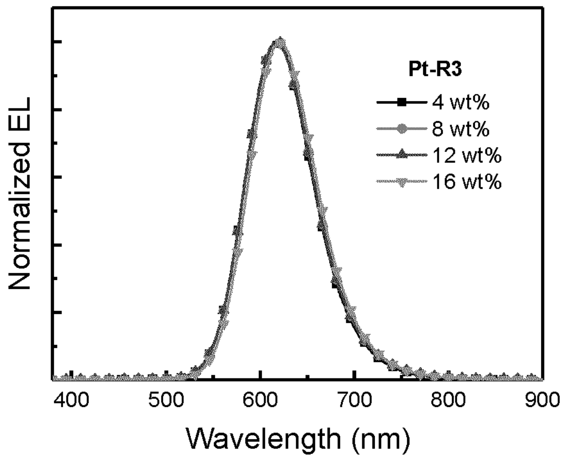


FIG. 4A

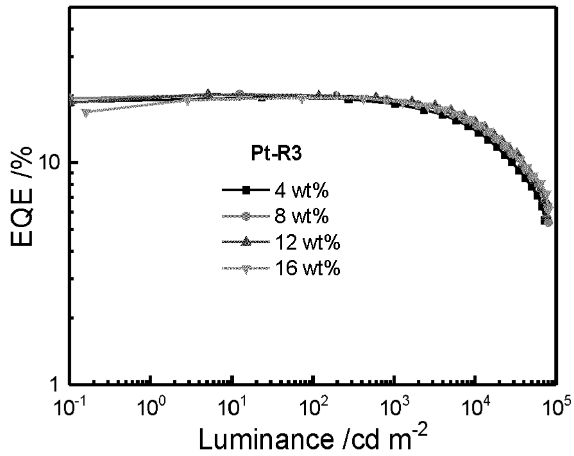


FIG. 4B

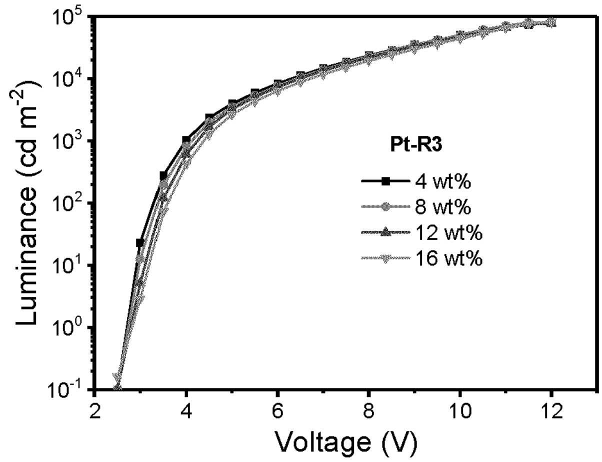


FIG. 4C

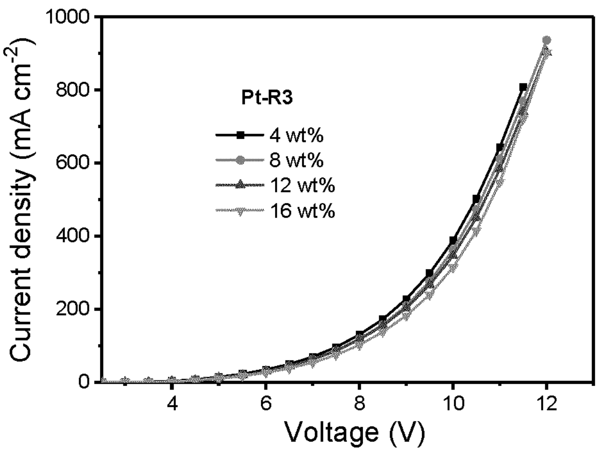


FIG. 4D

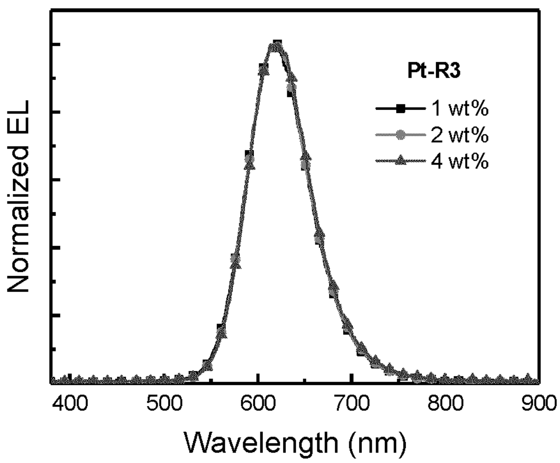


FIG. 5A

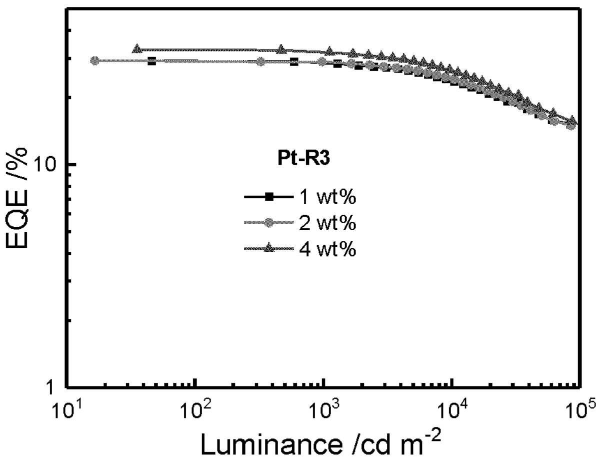


FIG. 5B

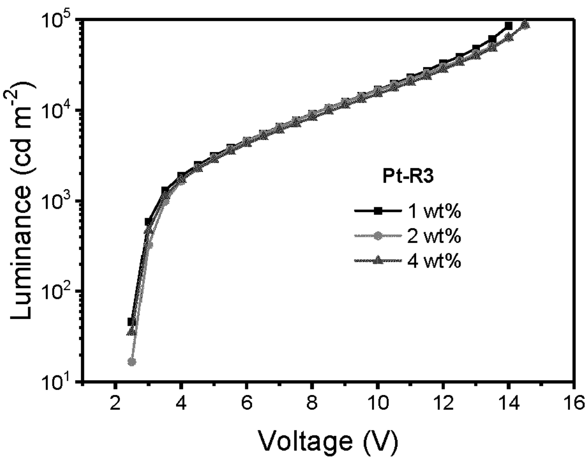


FIG. 5C

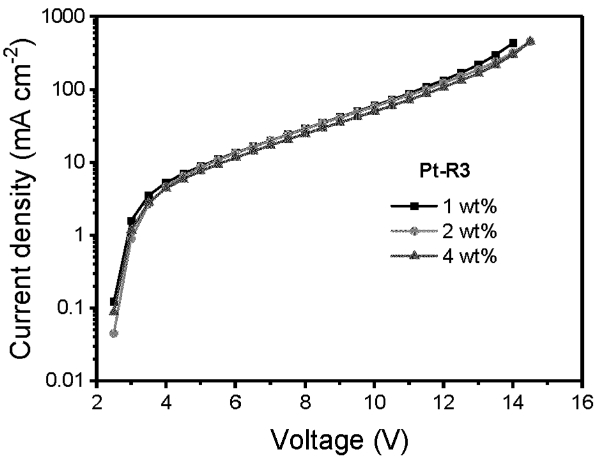


FIG. 5D

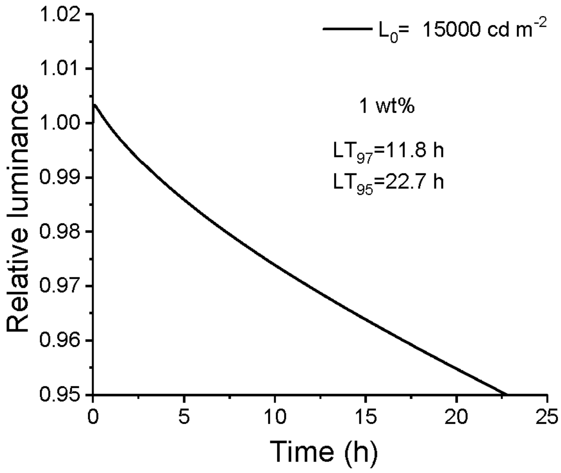


FIG. 6A

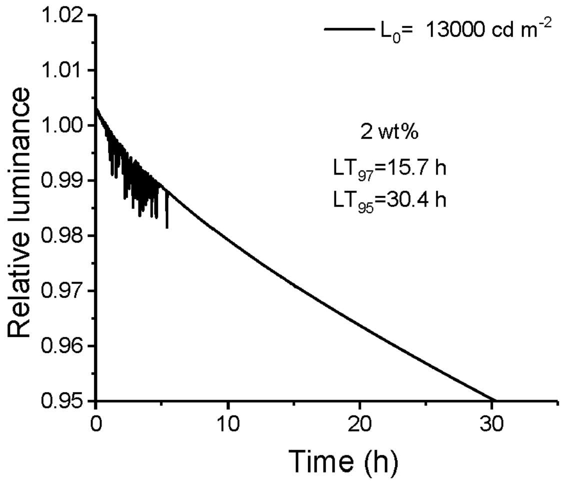


FIG. 6B

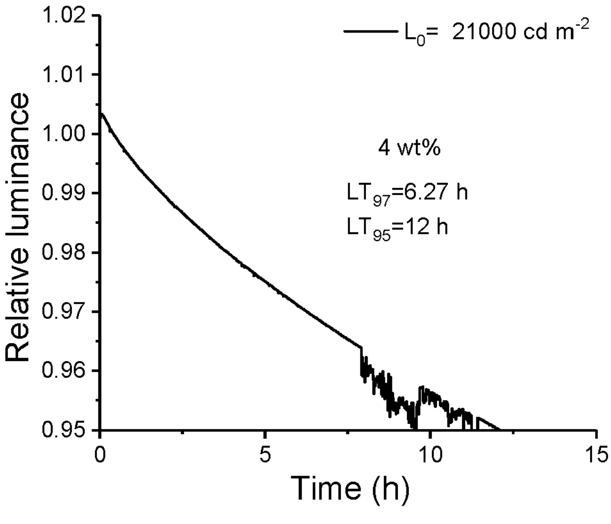


FIG. 6C

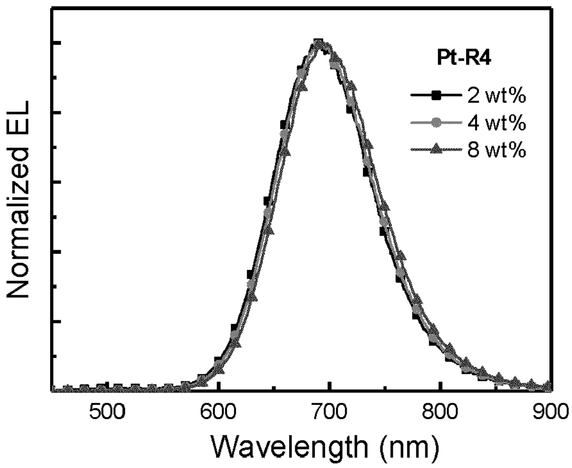


FIG. 7A

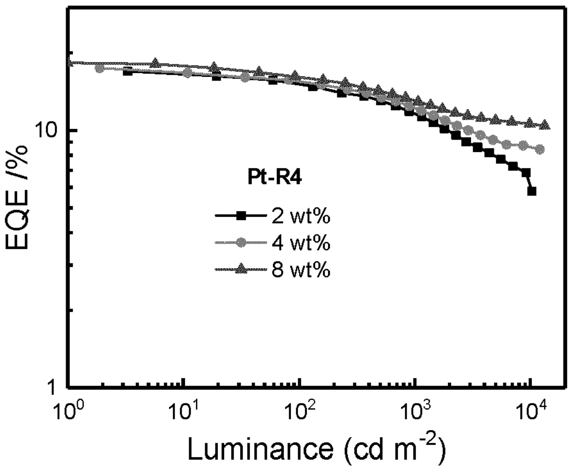


FIG. 7B

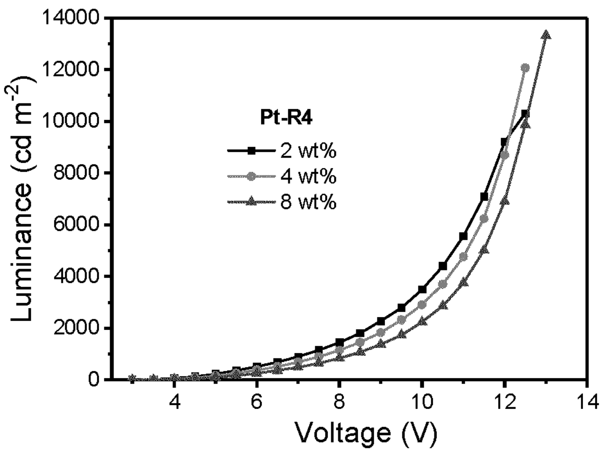


FIG. 7C

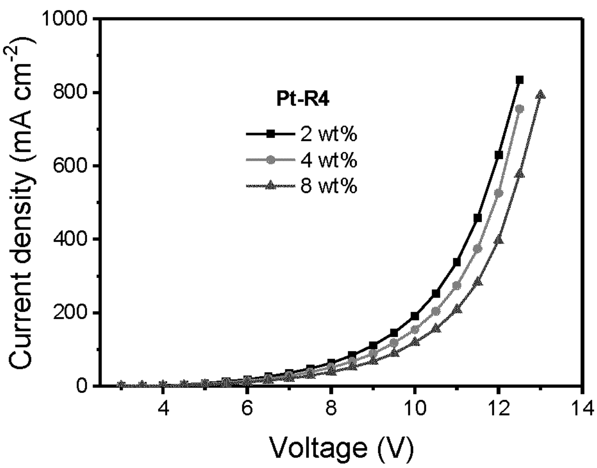


FIG. 7D

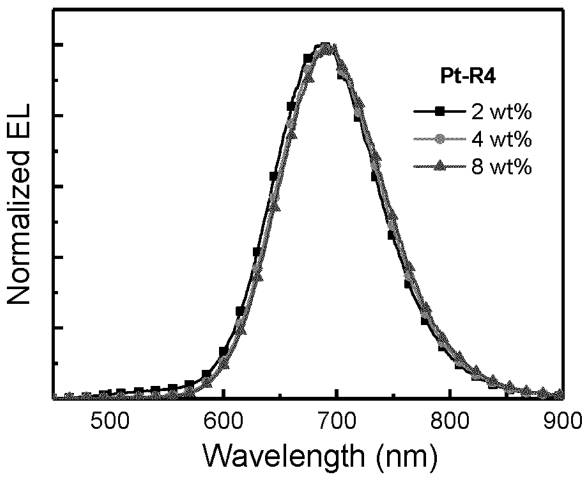


FIG. 8A

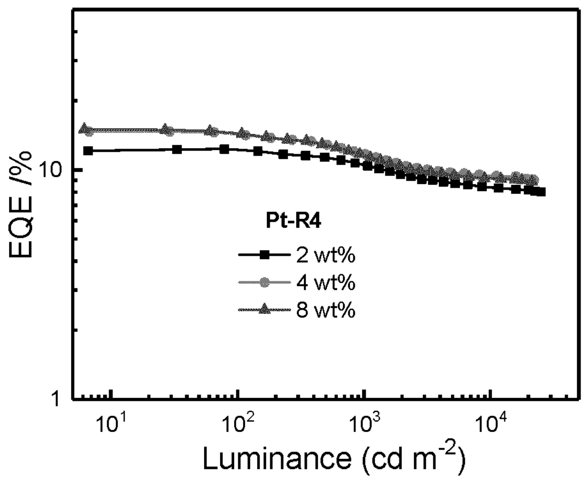


FIG. 8B

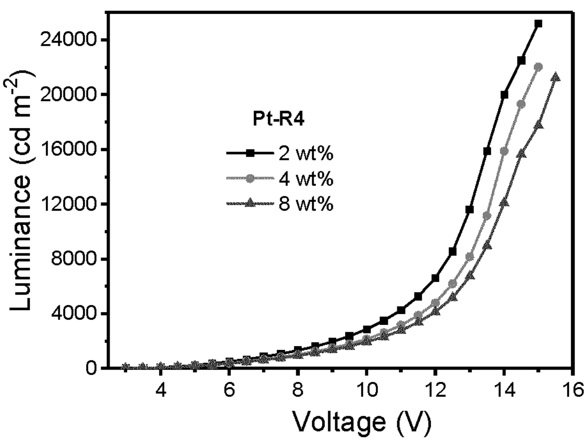


FIG. 8C

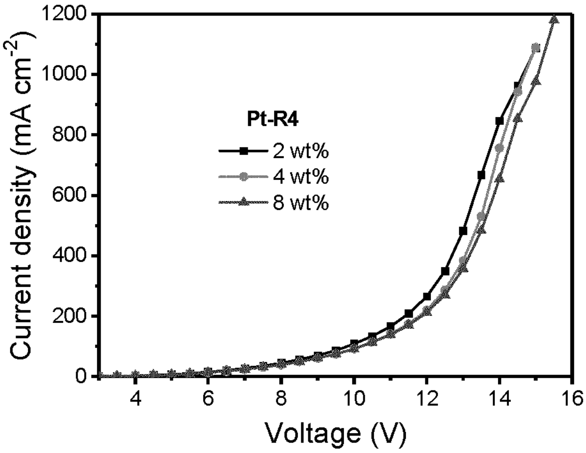


FIG. 8D

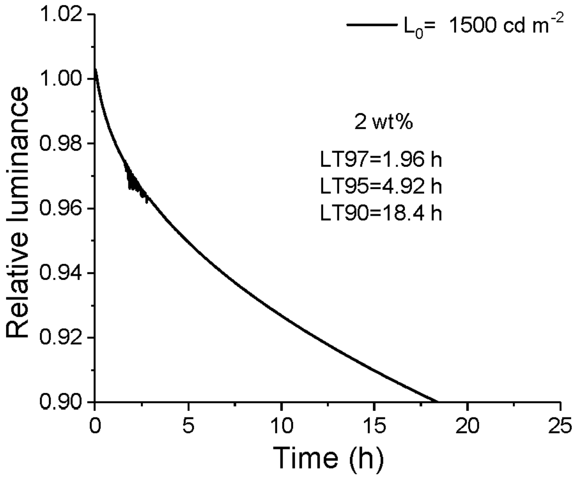


FIG. 9A

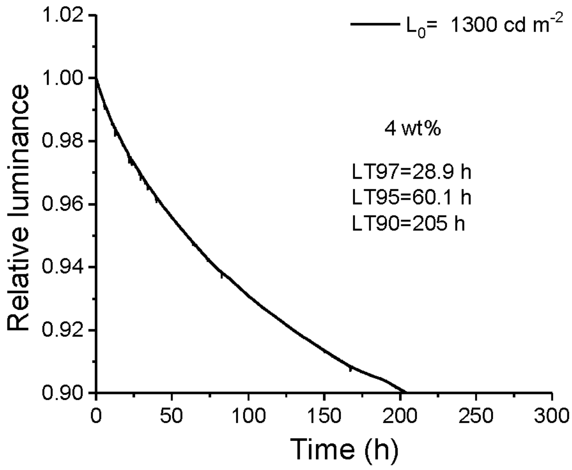


FIG. 9B

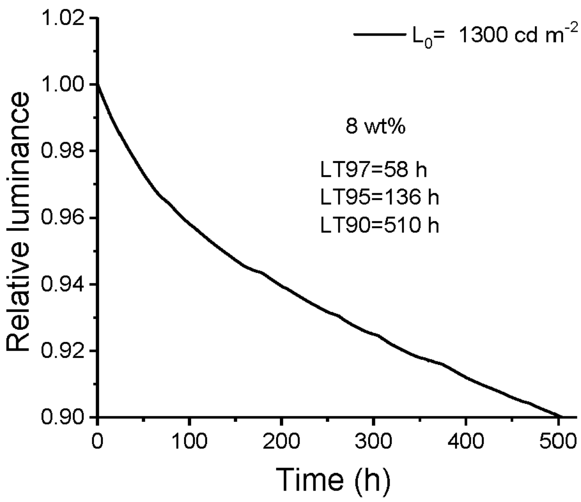


FIG. 9C

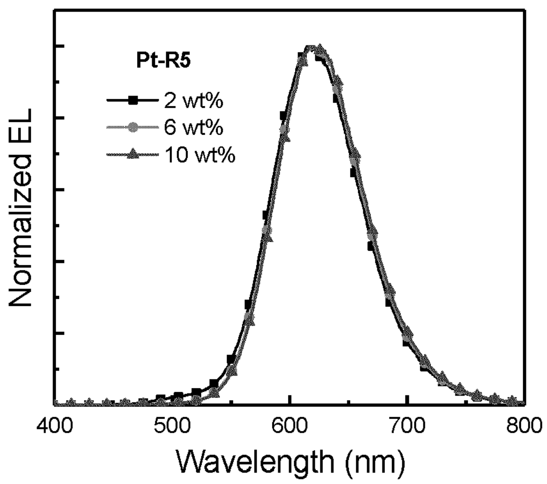


FIG. 10A

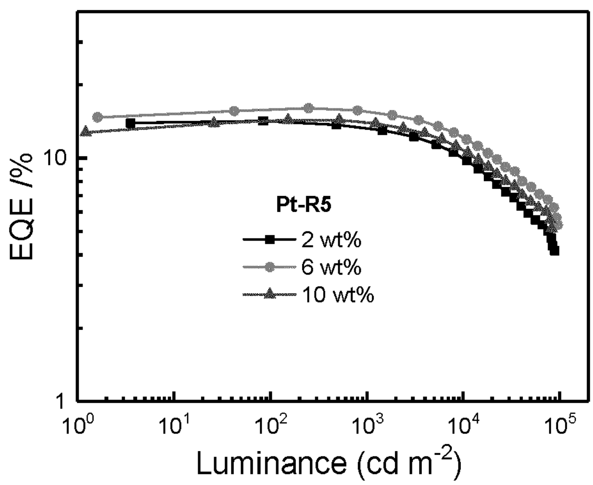


FIG. 10B

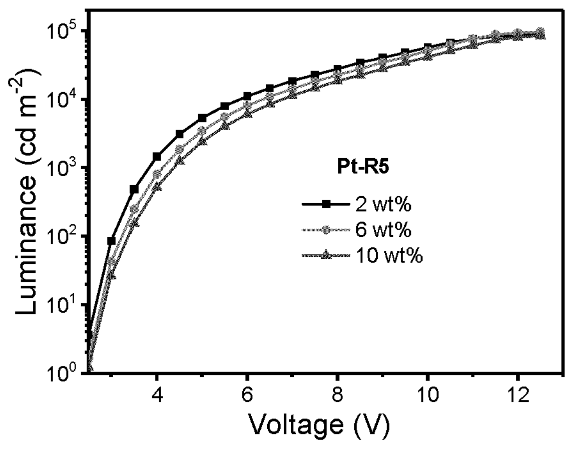


FIG. 10C

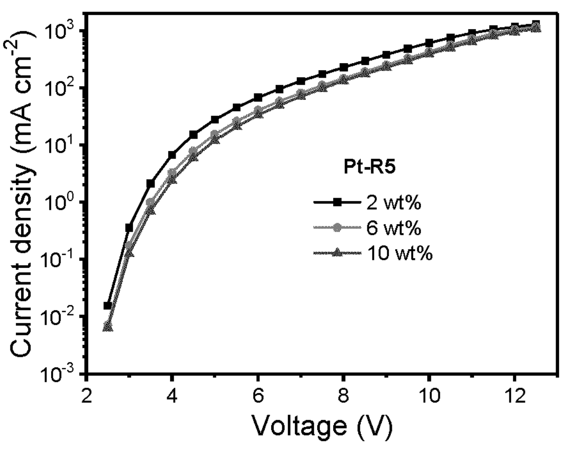


FIG. 10D

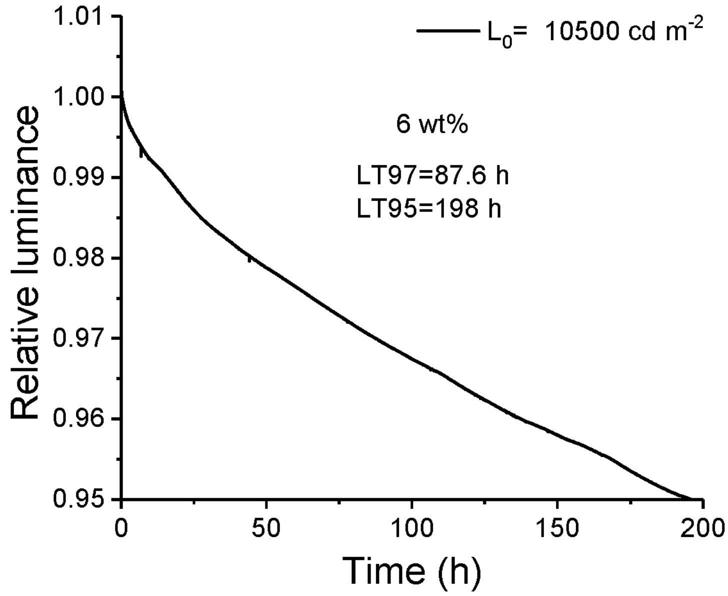

1.01
1.00
0.99
0.98
0.97
0.96
0.95
Relative luminance
0
50
100
150
200
Time (h)
$L_0$= 10500 cd $m^{-2}$
6 wt%
LT97=87.6 h
LT95=198 h


FIG. 11

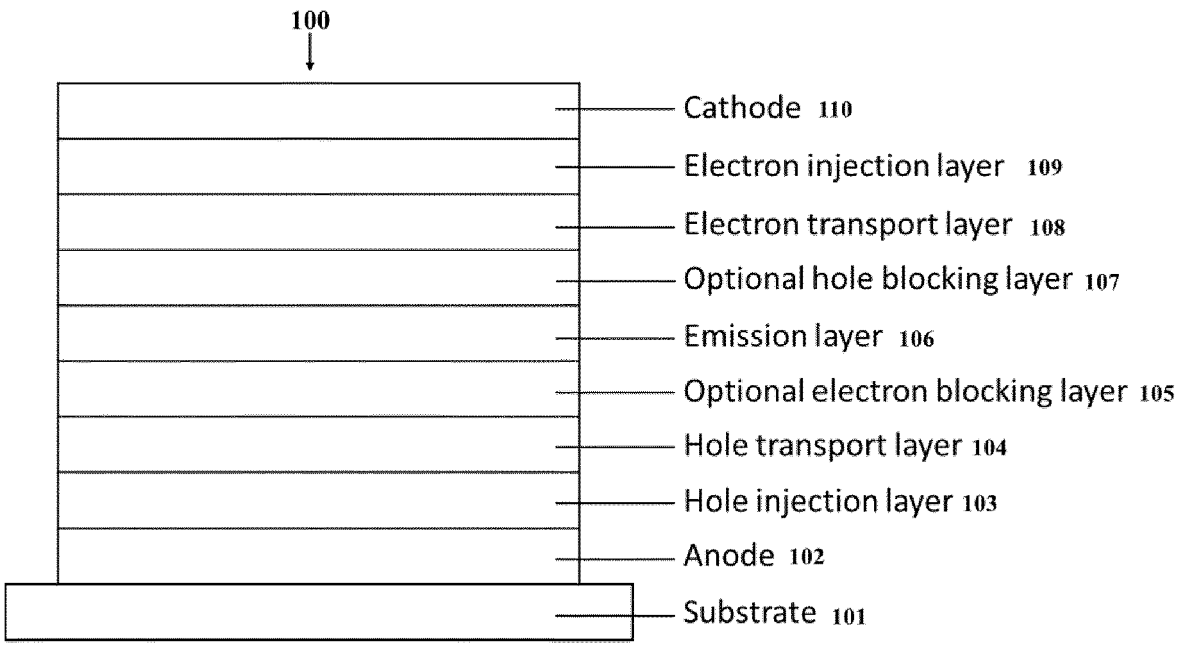

100
Cathode 110
Electron injection layer 109
Electron transport layer 108
Optional hole blocking layer 107
Emission layer 106
Optional electron blocking layer 105
Hole transport layer 104
Hole injection layer 103
Anode 102
Substrate 101


FIG. 12

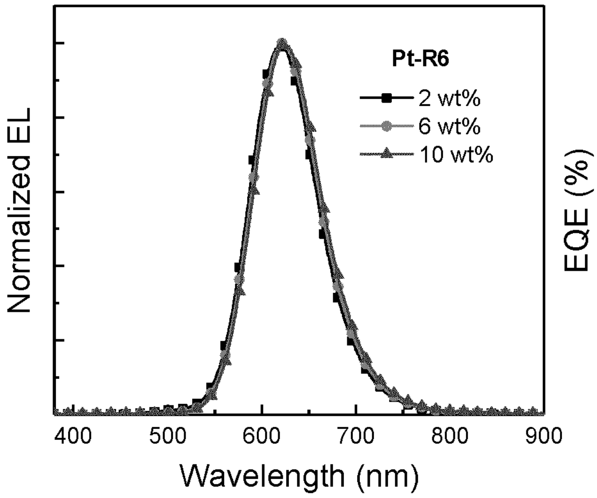


FIG. 13A

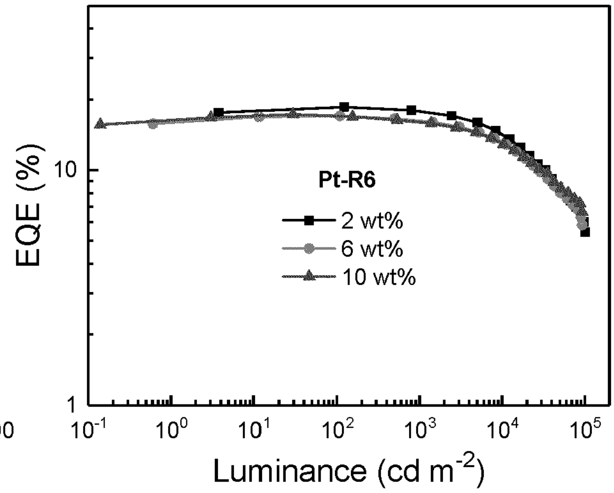


FIG. 13B

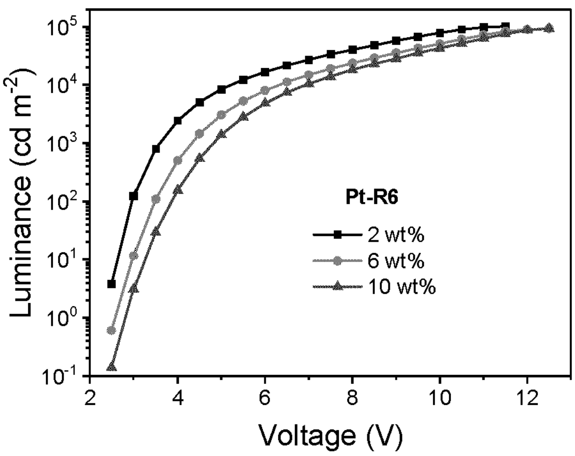


FIG. 13C

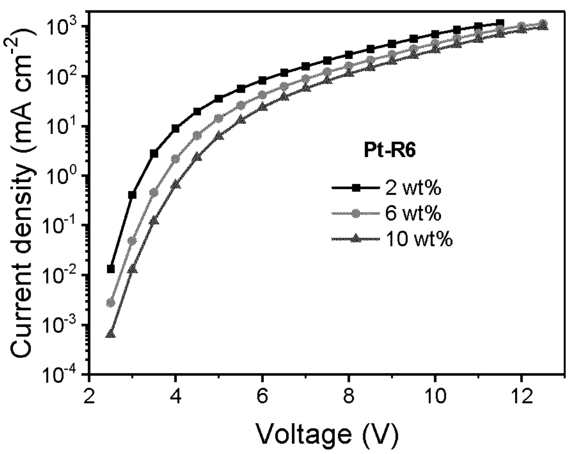


FIG. 13D

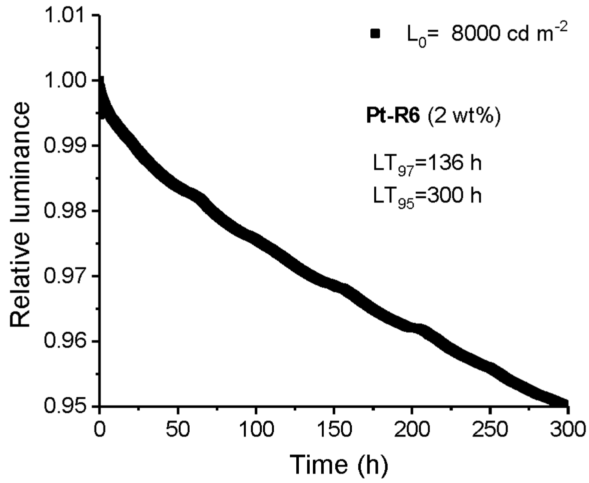


FIG. 14A

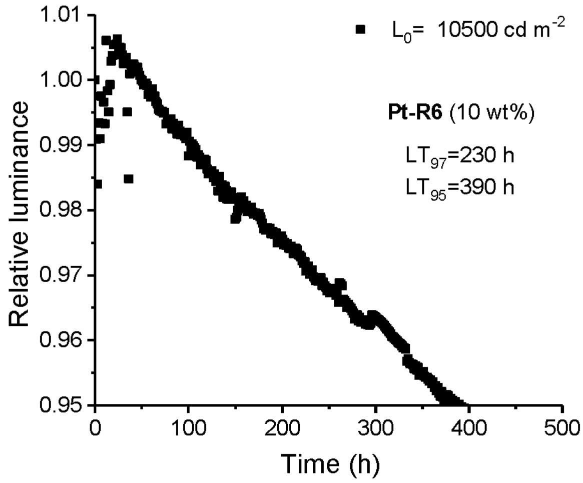


FIG. 14B

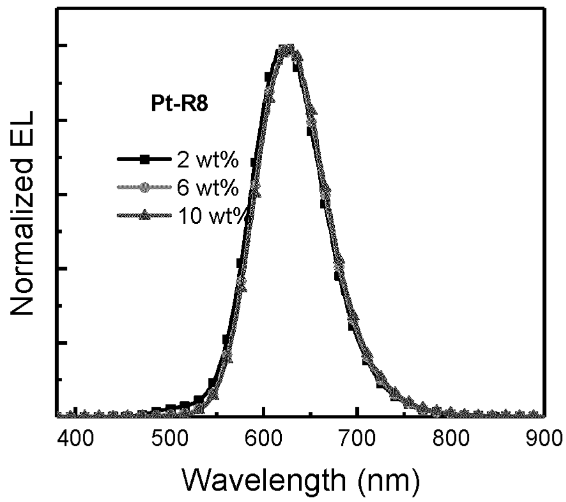


FIG. 15A

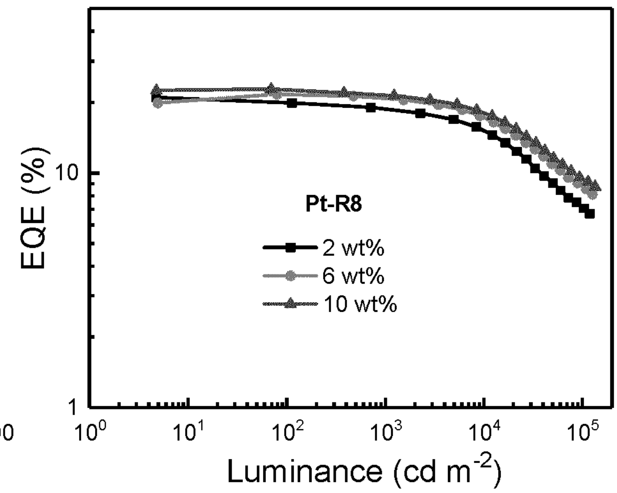


FIG. 15B

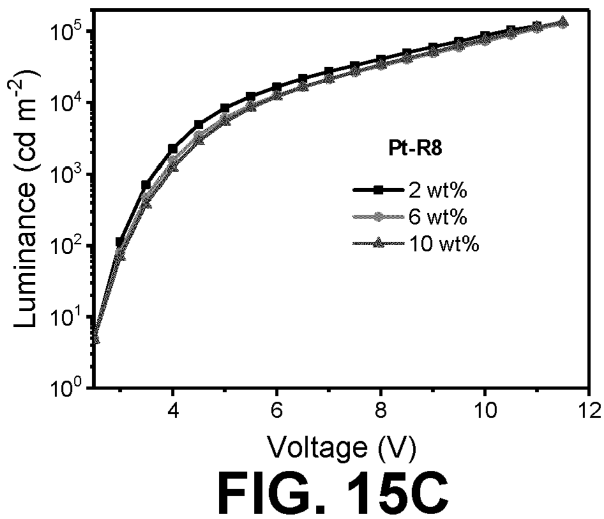


FIG. 15C

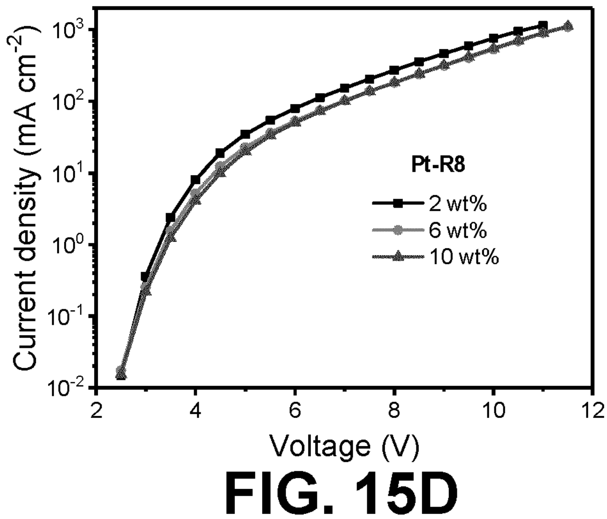


FIG. 15D

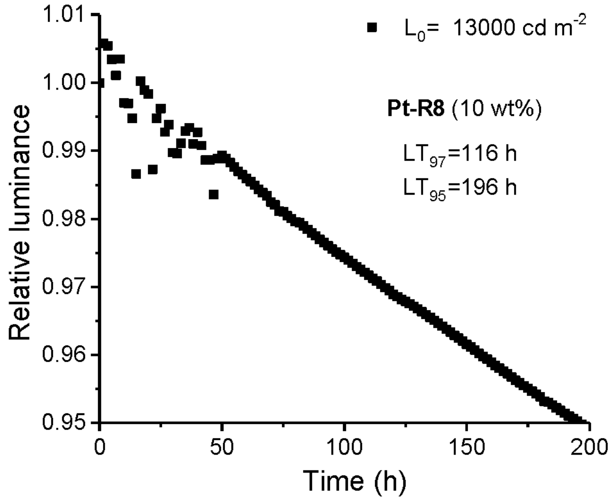


FIG. 16

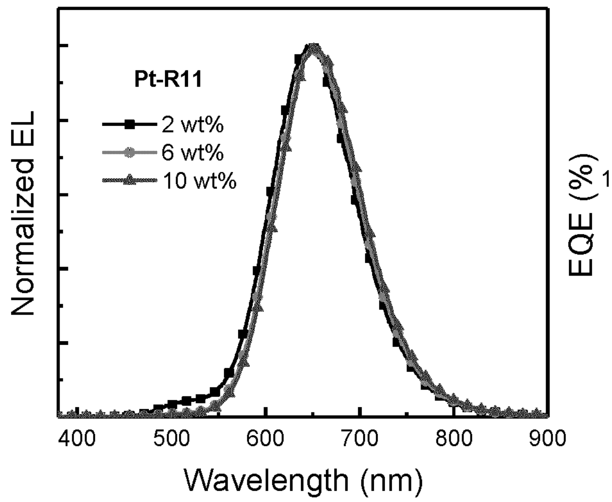


FIG. 17A

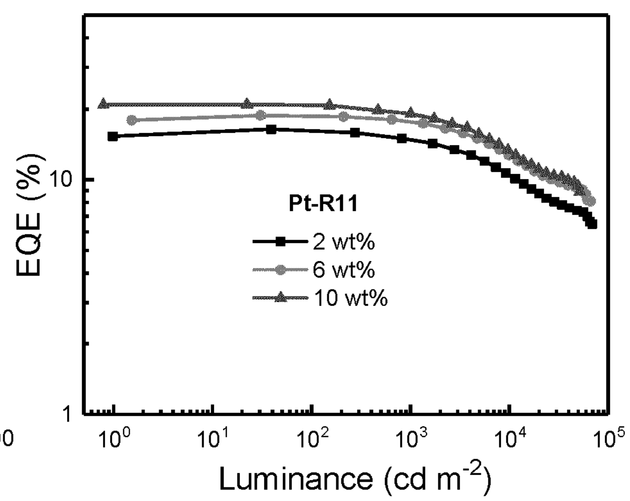


FIG. 17B

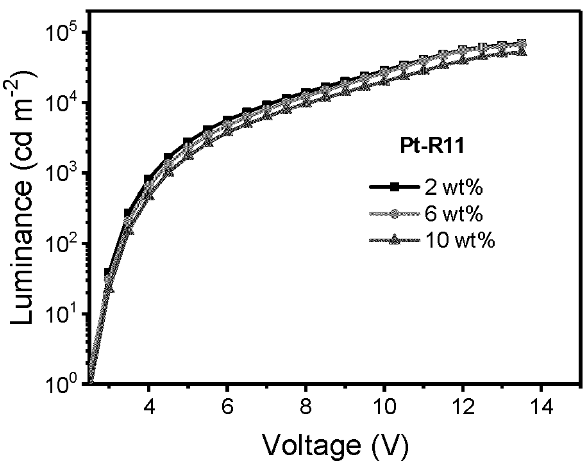


FIG. 17C

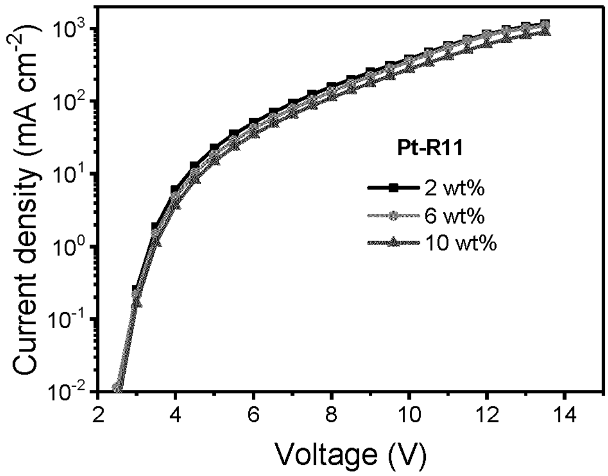


FIG. 17D

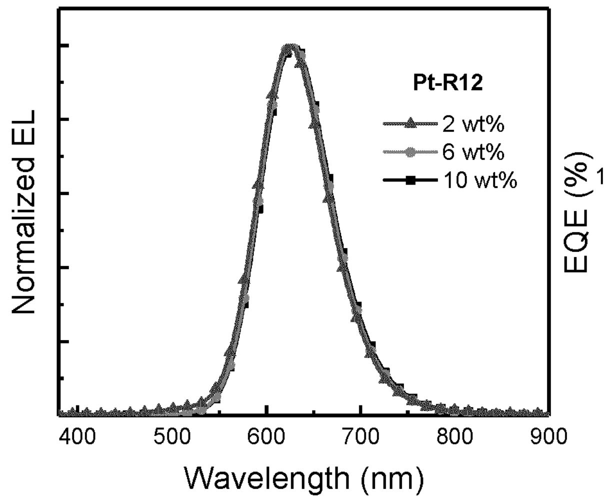


FIG. 18A

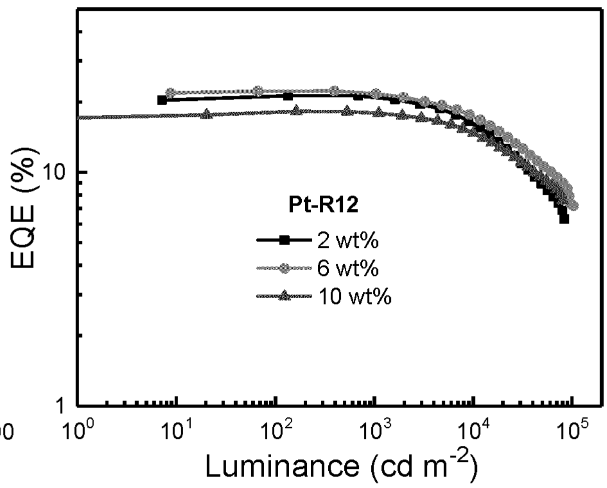


FIG. 18B

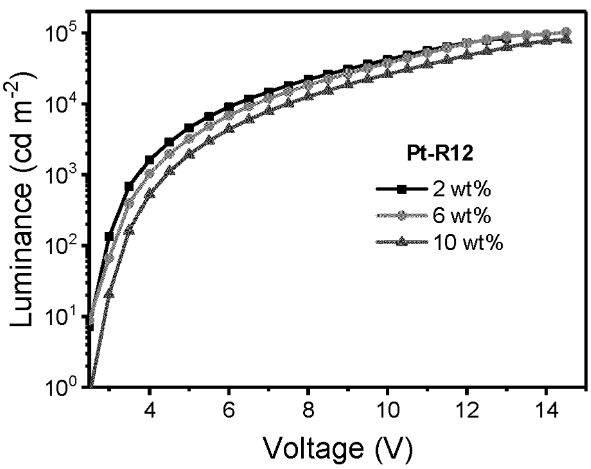


FIG. 18C

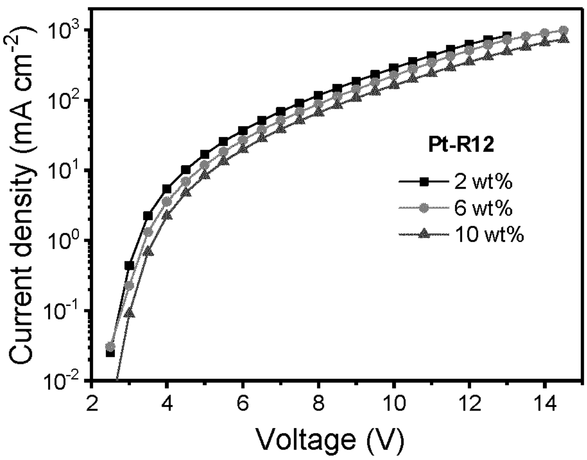


FIG. 18D

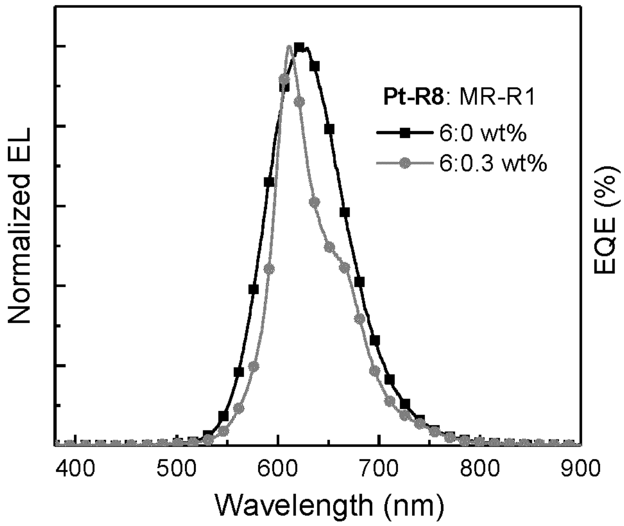


FIG. 19A

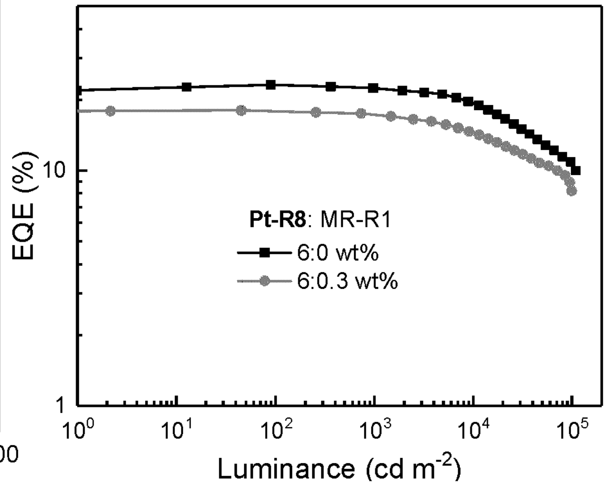


FIG. 19B

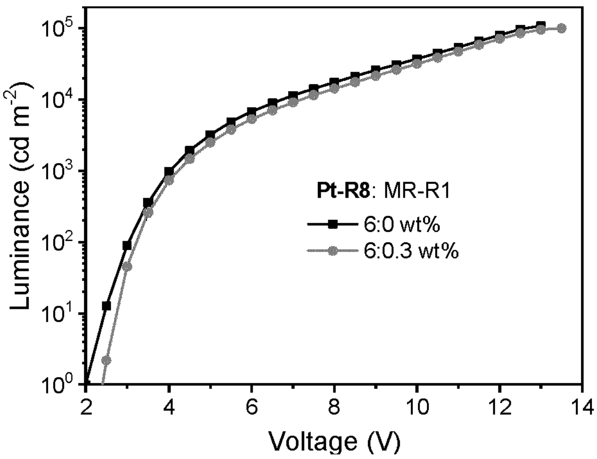


FIG. 19C

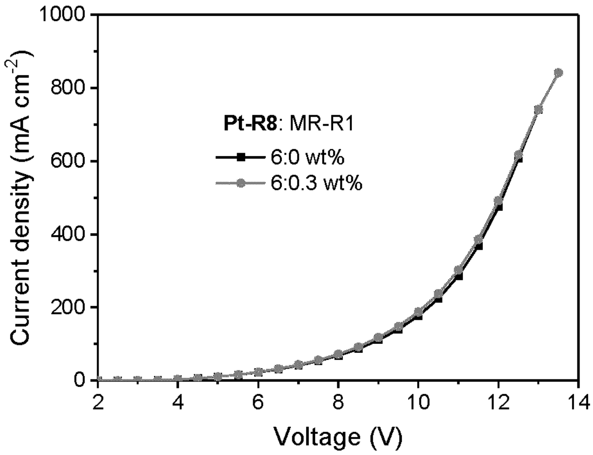


FIG. 19D

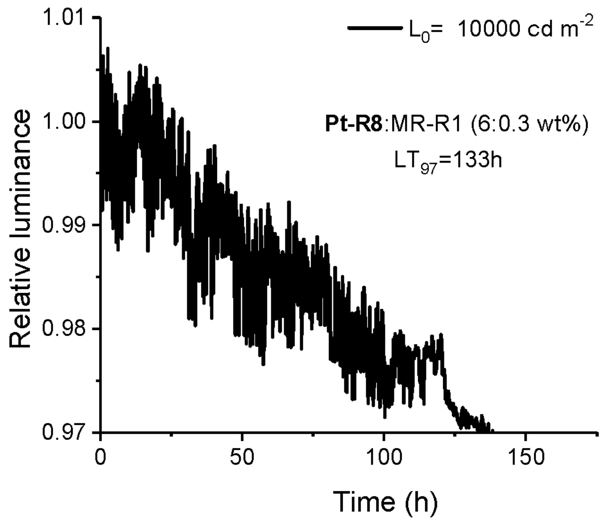


FIG. 20

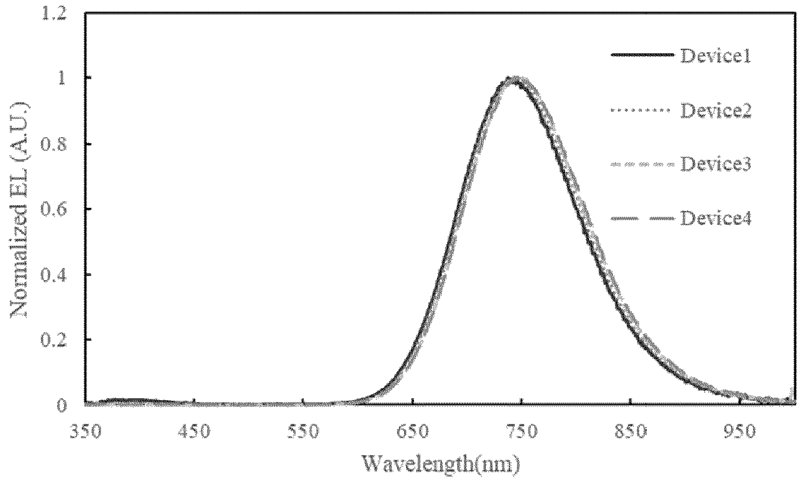


FIG. 21A

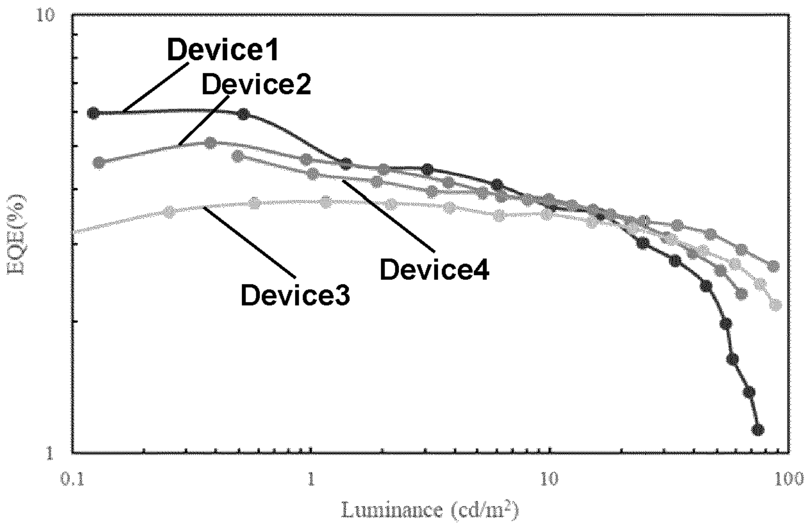


FIG. 21B

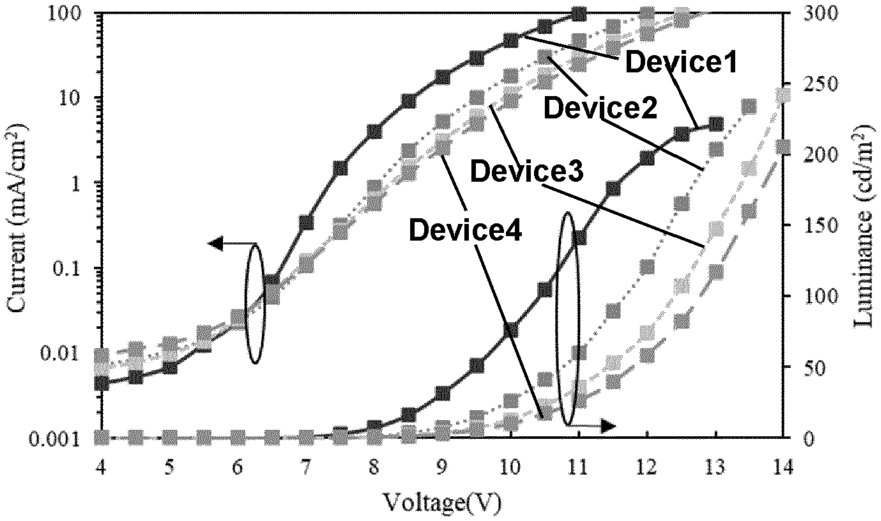


FIG. 21C

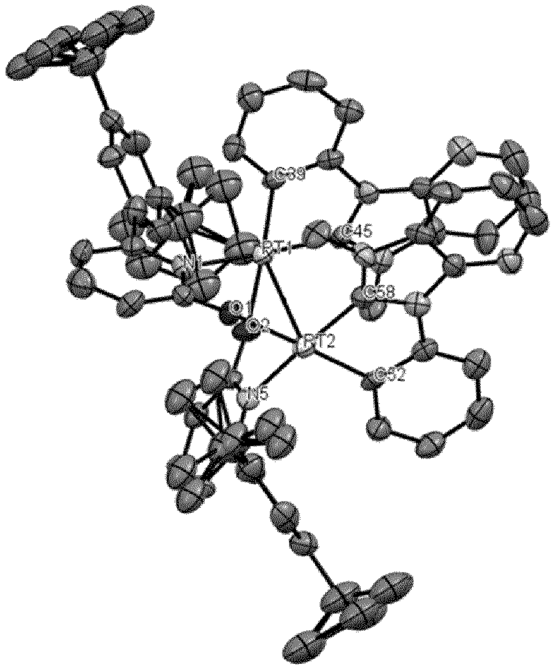

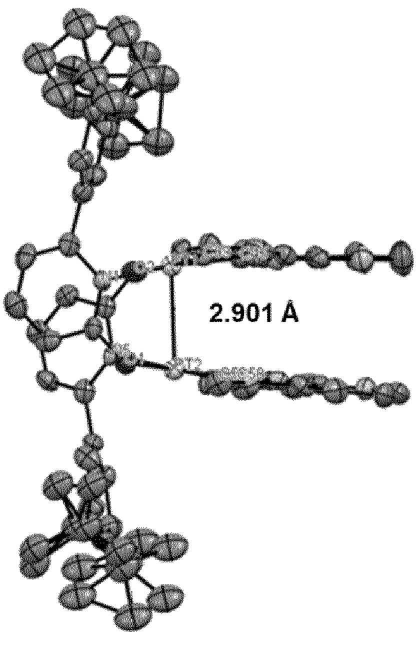


FIG. 22A FIG. 22B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 63398029
- WO 201607916 A

### Non-patent literature cited in the description


- **HONG et al.** *Adv. Mater.*, 2021, 2005630
- **LEE et al.** *InfoMat.*, 2021, vol. 3, 61-81
- **JOU et al.** *J. Mater. Chem. C*, 2015, vol. 3, 2974-3002
- **UNGER et al.** *Angew. Chem. Int. Ed.*, 2010, vol. 49, 10214-10216
- **PINTER et al.** *Chem. Eur. J.*, 2019, vol. 25, 14495-14499
- **Y. UNGER** ; **D. MEYER** ; **O. MOLT** ; **C. SCHILDKNECHT** ; **I. MÜNSTER** ; **G. WAGENBLAST** ; **T. STRASSNER**. *Angew. Chem. Int. Ed.*, 2010, vol. 49, 10214-10216
- **P. PINTER** ; **J. SOELLNER** ; **T. STRASSNER**. *Chem. Eur. J.*, 2019, vol. 25, 14495-14499